# EUROPEAN PATENT SPECIFICATION

(11) **EP 4 270 508 B1**
(45) Date of publication and mention of the grant of the patent: **28.10.2026**
(21) Application number: 22796221.4
(22) Date of filing: 29.04.2022
(51) Int. Cl.: H10K 85/60, H10K 50/11, H10K 101/10, H10K 85/30

(54) **ORGANIC LIGHT EMITTING DEVICE**
ORGANISCHE LICHTEMITTIERENDE VORRICHTUNG
DISPOSITIF ÉLECTROLUMINESCENT ORGANIQUE

(30) Priority: 30.04.2021 KR 20210056811
(43) Date of publication of application: 01.11.2023
(73) Proprietor: LG Chem, Ltd., Seoul 07336 (KR)
(72) Inventor: PARK, Seulchan, Daejeon 34122 (KR); SUH, Sang Duk, Daejeon 34122 (KR); JUNG, Min Woo, Daejeon 34122 (KR); LEE, Jungha, Daejeon 34122 (KR); HAN, Su Jin, Daejeon 34122 (KR); HWANG, Sunghyun, Daejeon 34122 (KR); LEE, Dong Hoon, Daejeon 34122 (KR)
(74) Representative: Hoffmann Eitle
(86) International application number: PCT/KR2022/006205
(87) International publication number: WO 2022/231389

(56) References cited:
- EP-A1- 3 547 385
- WO-A1-2020/171530
- WO-A1-2020/171531
- WO-A1-2021/029616
- KR-A- 20160 122 889
- KR-A- 20160 124 405
- KR-A- 20170 073 245
- KR-A- 20200 125 080
- KR-A- 20210 018 127
- KR-A- 20210 018 127

## Description

### [TECHNICAL FIELD]

### CROSS-REFERENCE TO RELATED APPLICATION(S)

This application claims the benefit of Korean Patent Application No. 10-2021-0056811 filed on April 30, 2021 and Korean Patent Application No. 10-2022-0053538 filed on April 29, 2022 in the Korean Intellectual Property Office.

The present disclosure relates to an organic light emitting device.

### [BACKGROUND ART]

In general, an organic light emitting phenomenon refers to a phenomenon where electric energy is converted into light energy by using an organic material. The organic light emitting device using the organic light emitting phenomenon has characteristics such as a wide viewing angle, an excellent contrast, a fast response time, an excellent luminance, driving voltage and response speed, and thus many studies have proceeded.

The organic light emitting device generally has a structure which comprises an anode, a cathode, and an organic material layer interposed between the anode and the cathode. The organic material layer frequently has a multilayered structure that comprises different materials in order to enhance efficiency and stability of the organic light emitting device, and for example, the organic material layer may be formed of a hole injection layer, a hole transport layer, a light emitting layer, an electron transport layer, an electron injection layer and the like. In the structure of the organic light emitting device, if a voltage is applied between two electrodes, the holes are injected from an anode into the organic material layer and the electrons are injected from the cathode into the organic material layer, and when the injected holes and electrons meet each other, an exciton is formed, and light is emitted when the exciton falls to a ground state again.

There is a continuing need for the development of a new material for an organic material used in the organic light emitting device as described above.

### [Prior Art Literature]

Patent Literature 1: Korean Unexamined Patent Publication No. 10-2000-0051826
Patent Literature 2: KR20210018127A
Patent Literature 3: WO2020/171531A1

### [DETAILED DESCRIPTION OF THE INVENTION]

### [Technical Problem]

It is an object of the present disclosure to provide an organic light emitting device having improved driving voltage, efficiency and lifetime.

### [Technical Solution]

In order to achieve the above object, according to the present disclosure, there is provided an organic light emitting device comprising:
an anode; a cathode; and a light emitting layer interposed between the anode and the cathode,
wherein the light emitting layer includes a compound represented by the following Chemical Formula 1 and a compound represented by the following Chemical Formula 2. 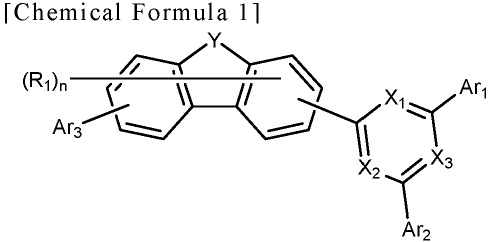
wherein, in Chemical Formula 1,
Y is O or S,
X₁ to X₃ are each independently CH or N, provided that at least one of X₁ to X₃ is N,
Ar₁ and Ar₂ are each independently a substituted or unsubstituted C₆₋₆₀ aryl; or a substituted or unsubstituted C₂₋₆₀ heteroaryl containing any one or more selected from the group consisting of N, O and S,
Ar₃ is a substituted or unsubstituted C₆₋₆₀ aryl,
n is an integer from 1 to 6, and
each R₁ is independently hydrogen; or deuterium; 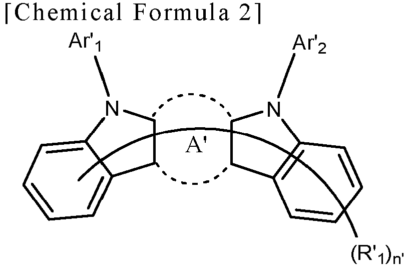
wherein, in Chemical Formula 2,
A' is a benzene ring fused with two adjacent pentagonal rings,
n' is an integer from 1 to 10,
R'₁ is hydrogen; deuterium; a substituted or unsubstituted C₆₋₆₀ aryl; or a substituted or unsubstituted C₂₋₆₀ heteroaryl containing any one or more selected from the group consisting of N, O and S, and
Ar'₁ and Ar'₂ are each independently a substituted or unsubstituted C₆₋₆₀ aryl; or a substituted or unsubstituted C₂₋₆₀ heteroaryl containing any one or more heteroatoms selected from the group consisting of N, O and S,
provided that at least one of R'₁ is deuterium; and/or at least one of Ar'₁ and Ar'₂ is substituted with at least one deuterium.

### [Advantageous Effects]

The above-mentioned organic light emitting device is excellent in driving voltage, efficiency and lifetime.

### [BRIEF DESCRIPTION OF THE DRAWINGS]

FIG. 1 shows an example of an organic light emitting device comprising a substrate 1, an anode 2, a light emitting layer 3, and a cathode 4.
FIG. 2 shows an example of an organic light emitting device comprising a substrate 1, an anode 2, a hole injection layer 5, a hole transport layer 6, a light emitting layer 3, an electron transport layer 7, an electron injection layer 8 and a cathode 4.
FIG. 3 shows an example of an organic light emitting device comprising a substrate 1, an anode 2, a hole injection layer 5, a hole transport layer 6, an electron blocking layer 9, a light emitting layer 3, a hole blocking layer 10, an electron transport layer 7, an electron injection layer 8 and a cathode 4.

### [DETAILED DESCRIPTION OF THE EMBODIMENTS]

Hereinafter, embodiments of the present disclosure will be described in more detail to facilitate understanding of the invention.

As used herein, the notation 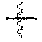 or means a bond linked to another substituent group.

As used herein, the term "substituted or unsubstituted" means being unsubstituted or substituted with one or more substituents selected from the group consisting of deuterium; a halogen group; a nitrile group; a nitro group; a hydroxy group; a carbonyl group; an ester group; an imide group; an amino group; a phosphine oxide group; an alkoxy group; an aryloxy group; an alkylthioxy group; an arylthioxy group; an alkylsulfoxy group; an arylsulfoxy group; a silyl group; a boron group; an alkyl group; a cycloalkyl group; an alkenyl group; an aryl group; an aralkyl group; an aralkenyl group; an alkylaryl group; an alkylamine group; an aralkylamine group; a heteroarylamine group; an arylamine group; an arylphosphine group; and a heterocyclic group containing at least one of N, O and S atoms, or being unsubstituted or substituted with a substituent to which two or more substituents of the above-exemplified substituents are connected. For example, "a substituent in which two or more substituents are connected" may be a biphenyl group. Namely, a biphenyl group may be an aryl group, or it may be interpreted as a substituent in which two phenyl groups are connected.

In the present disclosure, the carbon number of a carbonyl group is not particularly limited, but is preferably 1 to 40. Specifically, the carbonyl group may be a group having the following structural formulas, but is not limited thereto.

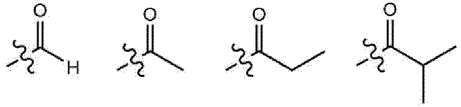

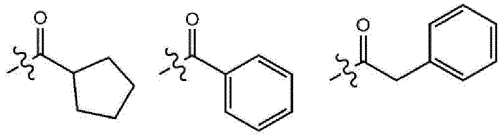

In the present disclosure, an ester group may have a structure in which oxygen of the ester group may be substituted by a straight-chain, branched-chain, or cyclic alkyl group having 1 to 25 carbon atoms, or an aryl group having 6 to 25 carbon atoms. Specifically, the ester group may be a group having the following structural formulas, but is not limited thereto.

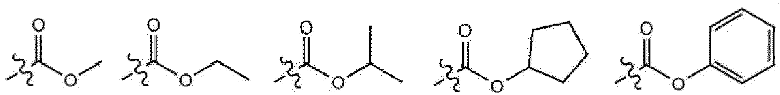

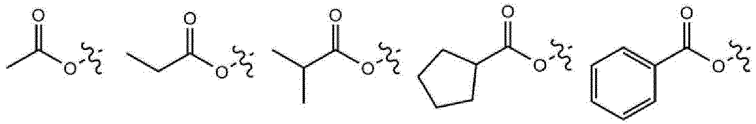

In the present disclosure, the carbon number of an imide group is not particularly limited, but is preferably 1 to 25. Specifically, the imide group may be a group having the following structural formulas, but is not limited thereto.

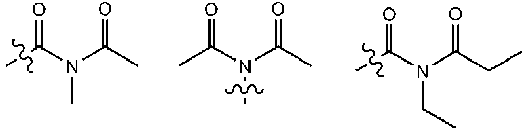

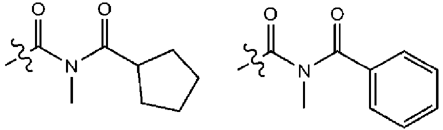

In the present disclosure, a silyl group specifically includes a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group and the like, but is not limited thereto.

In the present disclosure, a boron group specifically includes a trimethylboron group, a triethylboron group, a t-butyldimethylboron group, a triphenylboron group, and a phenylboron group, but is not limited thereto.

In the present disclosure, examples of a halogen group include fluorine, chlorine, bromine, or iodine.

In the present disclosure, the alkyl group may be straight-chain or branched-chain, and the carbon number thereof is not particularly limited, but is preferably 1 to 40. According to one embodiment, the carbon number of the alkyl group is 1 to 20. According to another embodiment, the carbon number of the alkyl group is 1 to 10. According to another embodiment, the carbon number of the alkyl group is 1 to 6. Specific examples of the alkyl group include methyl, ethyl, propyl, n-propyl, isopropyl, butyl, n-butyl, isobutyl, tert-butyl, sec-butyl, 1-methyl-butyl, 1-ethyl-butyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohexylmethyl, octyl, n-octyl, tert-octyl, 1-methylheptyl, 2-ethylhexyl, 2-propylpentyl, n-nonyl, 2,2-dimethylheptyl, 1-ethyl-propyl, 1,1-dimethyl-propyl, isohexyl, 4-methylhexyl, 5-methylhexyl, and the like, but are not limited thereto.

In the present disclosure, the alkenyl group may be straight-chain or branched-chain, and the carbon number thereof is not particularly limited, but is preferably 2 to 40. According to one embodiment, the carbon number of the alkenyl group is 2 to 20. According to another embodiment, the carbon number of the alkenyl group is 2 to 10. According to still another embodiment, the carbon number of the alkenyl group is 2 to 6. Specific examples thereof include vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, a stilbenyl group, a styrenyl group, and the like, but are not limited thereto.

In the present disclosure, a cycloalkyl group is not particularly limited, but the carbon number thereof is preferably 3 to 60. According to one embodiment, the carbon number of the cycloalkyl group is 3 to 30. According to another embodiment, the carbon number of the cycloalkyl group is 3 to 20. According to still another embodiment, the carbon number of the cycloalkyl group is 3 to 6. Specific examples thereof include cyclopropyl, cyclobutyl, cyclopentyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, cyclooctyl, and the like, but are not limited thereto.

**In** the present disclosure, an aryl group is not particularly limited, but the carbon number thereof is preferably 6 to 60, and it may be a monocyclic aryl group or a polycyclic aryl group. According to one embodiment, the carbon number of the aryl group is 6 to 30. According to one embodiment, the carbon number of the aryl group is 6 to 20. The aryl group may be a phenyl group, a biphenyl group, a terphenyl group or the like as the monocyclic aryl group, but is not limited thereto. The polycyclic aryl group includes a naphthyl group, an anthracenyl group, a phenanthrenyl group, a pyrenyl group, a perylenyl group, a chrysenyl group, or the like, but is not limited thereto.

In the present disclosure, the fluorenyl group may be substituted, and two substituents may be linked with each other to form a spiro structure. In the case where the fluorenyl group is substituted, 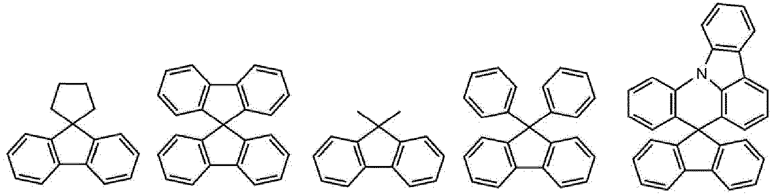 and the like can be formed. However, the structure is not limited thereto.

In the present disclosure, a heterocyclic group is a heterocyclic group containing one or more of O, N, Si and S as a heteroatom, and the carbon number thereof is not particularly limited, but is preferably 2 to 60. Examples of the heterocyclic group include a thiophene group, a furan group, a pyrrole group, an imidazole group, a thiazole group, an oxazol group, an oxadiazol group, a triazol group, a pyridyl group, a bipyridyl group, a pyrimidyl group, a triazine group, an acridyl group, a pyridazine group, a pyrazinyl group, a quinolinyl group, a quinazoline group, a quinoxalinyl group, a phthalazinyl group, a pyridopyrimidinyl group, a pyridopyrazinyl group, a pyrazinopyrazinyl group, an isoquinoline group, an indole group, a carbazole group, a benzoxazole group, a benzoimidazole group, a benzothiazol group, a benzocarbazole group, a benzothiophene group, a dibenzothiophene group, a benzofuranyl group, a phenanthroline group, an isoxazolyl group, a thiadiazolyl group, a phenothiazinyl group, a dibenzofuranyl group, and the like, but are not limited thereto.

In the present disclosure, the aryl group in the aralkyl group, the aralkenyl group, the alkylaryl group and the arylamine group is the same as the aforementioned examples of the aryl group. In the present disclosure, the alkyl group in the aralkyl group, the alkylaryl group and the alkylamine group is the same as the aforementioned examples of the alkyl group. In the present disclosure, the heteroaryl in the heteroarylamine can be applied to the aforementioned description of the heterocyclic group. In the present disclosure, the alkenyl group in the aralkenyl group is the same as the aforementioned examples of the alkenyl group. In the present disclosure, the aforementioned description of the aryl group may be applied except that the arylene is a divalent group. In the present disclosure, the aforementioned description of the heterocyclic group can be applied except that the heteroarylene is a divalent group. In the present disclosure, the aforementioned description of the aryl group or cycloalkyl group can be applied except that the hydrocarbon ring is not a monovalent group but formed by combining two substituent groups. In the present disclosure, the aforementioned description of the heterocyclic group can be applied, except that the heterocycle is not a monovalent group but formed by combining two substituent groups.

Hereinafter, the present disclosure will be described in detail for each configuration.

### Anode and Cathode

An anode and a cathode used in the present disclosure mean electrodes used in an organic light emitting device.

As the anode material, generally, a material having a large work function is preferably used so that holes can be smoothly injected into the organic material layer. Specific examples of the anode material include metals such as vanadium, chrome, copper, zinc, and gold, or an alloy thereof; metal oxides such as zinc oxides, indium oxides, indium tin oxides (ITO), and indium zinc oxides (IZO); a combination of metals and oxides, such as ZnO:Al or SNO₂:Sb; conductive polymers such as poly(3-methylthiophene), poly[3,4-(ethylene-1,2-dioxy)thiophene](PEDOT), polypyrrole, and polyaniline, and the like, but are not limited thereto.

As the cathode material, generally, a material having a small work function is preferably used so that electrons can be easily injected into the organic material layer. Specific examples of the cathode material include metals such as magnesium, calcium, sodium, potassium, titanium, indium, yttrium, lithium, gadolinium, aluminum, silver, tin, and lead, or an alloy thereof; a multilayered structure material such as LiF/Al or LiO₂/Al, and the like, but are not limited thereto.

### Light Emitting Layer

The light emitting layer used in the present disclosure is a layer that can emit light in the visible light region by combining holes and electrons transported from the anode and the cathode. Generally, the light emitting layer includes a host material and a dopant material, and in the present disclosure, the compound represented by Chemical Formula 1 and the compound represented by Chemical Formula 2 are included as a host

In Chemical Formula 1, at least one of X₁ to X₃ are N, and preferably, at least two are N. In one embodiment, X₁ to X₃ are all N.

Preferably, Ar₁ and Ar₂ are each independently a substituted or unsubstituted C₆₋₂₀ aryl; or a substituted or unsubstituted C₂₋₂₀ heteroaryl containing any one or more selected from the group consisting of N, O and S. Each of the Ar₁ and Ar₂ may be substituted with one or more deuteriums.

Preferably, Ar₁ and Ar₂ are each independently phenyl; phenyl substituted with 5 deuteriums; biphenylyl; biphenylyl substituted with 5 deuteriums; terphenylyl; phenanthrenyl; carbazolyl; carbazolyl substituted with 6 deuteriums; dibenzofuranyl; dibenzothiophenyl; or triphenylenyl.

Preferably, Ar₃ is a substituted or unsubstituted C₆₋₂₅ aryl. The Ar₃ may be substituted with one or more deuterium.

Preferably, Ar₃ is phenyl; phenyl substituted with 5 deuteriums; biphenylyl; biphenylyl substituted with 5 deuteriums; terphenylyl; terphenylyl substituted with 5 deuteriums; terphenylyl substituted with one phenyl; naphthyl; naphthylphenyl; phenanthrenyl; triphenylenyl; triphenylenyl substituted with 9 deuteriums; triphenylenylphenyl; 9,9-dimethylfluorenyl; or 9,9'-spirobifluorenyl.

Each R₁ is independently hydrogen or deuterium.

In one embodiment, Y is O or S, at least two of X₁ to X₃ are N, each R₁ is independently hydrogen or deuterium, Ar₁ and Ar₂ are each independently phenyl; phenyl substituted with 5 deuteriums; biphenylyl; biphenylyl substituted with 5 deuteriums; terphenylyl; phenanthrenyl; carbazolyl; carbazolyl substituted with 6 deuteriums; dibenzofuranyl; or dibenzothiophenyl; triphenylenyl, and Ar₃ is a C₆₋₂₅ aryl unsubstituted or substituted with deuterium.

In one embodiment, Y is O or S, at least two of X₁ to X₃ are N, each R₁ is independently hydrogen or deuterium, Ar₁ and Ar₂ are each independently a C₆₋₂₀ aryl substituted or unsubstituted with deuterium; or a substituted or unsubstituted C₂₋₂₀ heteroaryl containing any one or more selected from the group consisting of N, O and S, Ar₃ is phenyl; phenyl substituted with 5 deuteriums; biphenylyl; biphenylyl substituted with 5 deuteriums; terphenylyl; terphenylyl substituted with 5 deuteriums; terphenylyl substituted with one phenyl; naphthyl; naphthylphenyl; phenanthrenyl; triphenylenyl; triphenylenyl substituted with 9 deuteriums; triphenylenylphenyl; 9,9-dimethylfluorenyl; or 9,9'-spirobifluorenyl.

In one embodiment, Y is O or S, at least two of X₁ to X₃ are N, each R₁ is independently hydrogen or deuterium, Ar₁ and Ar₂ are each independently phenyl; phenyl substituted with 5 deuteriums; biphenylyl; biphenylyl substituted with 5 deuteriums; terphenylyl; phenanthrenyl; carbazolyl; carbazolyl substituted with 6 deuteriums; dibenzofuranyl; or dibenzothiophenyl; triphenylenyl, Ar₃ is phenyl; phenyl substituted with 5 deuteriums; biphenylyl; biphenylyl substituted with 5 deuteriums; terphenylyl; terphenylyl substituted with 5 deuteriums; terphenylyl substituted with one phenyl; naphthyl; naphthylphenyl; phenanthrenyl; triphenylenyl; triphenylenyl substituted with 9 deuteriums; triphenylenylphenyl; 9,9-dimethylfluorenyl; or 9,9'-spirobifluorenyl.

In one embodiment, Y is O or S, X₁ to X₃ are all N, each R₁ is independently hydrogen or deuterium, Ar₁ and Ar₂ are each independently phenyl; phenyl substituted with 5 deuteriums; biphenylyl; biphenylyl substituted with 5 deuteriums; terphenylyl; phenanthrenyl; carbazolyl; carbazolyl substituted with 6 deuteriums; dibenzofuranyl; or dibenzothiophenyl; triphenylenyl, Ar₃ is phenyl; phenyl substituted with 5 deuteriums; biphenylyl; biphenylyl substituted with 5 deuteriums; terphenylyl; terphenylyl substituted with 5 deuteriums; terphenylyl substituted with one phenyl; naphthyl; naphthylphenyl; phenanthrenyl; triphenylenyl; triphenylenyl substituted with 9 deuteriums; triphenylenylphenyl; 9,9-dimethylfluorenyl; or 9,9'-spirobifluorenyl.

Representative examples of the compound represented by Chemical Formula 1 are as follows:

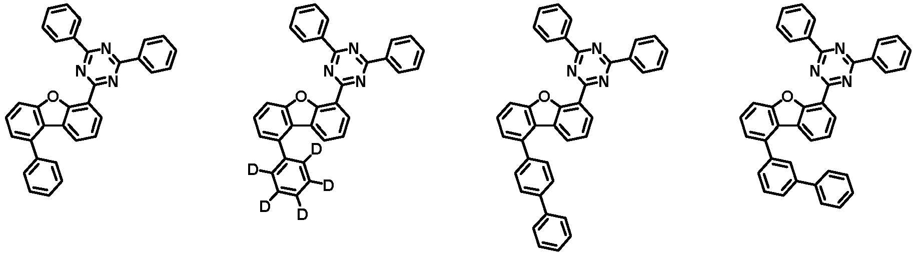

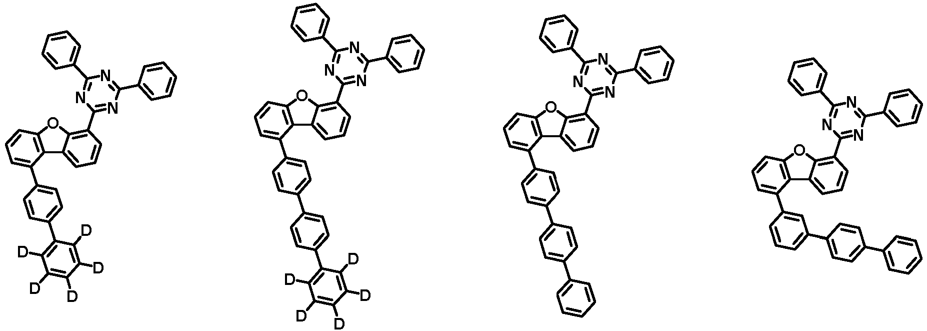

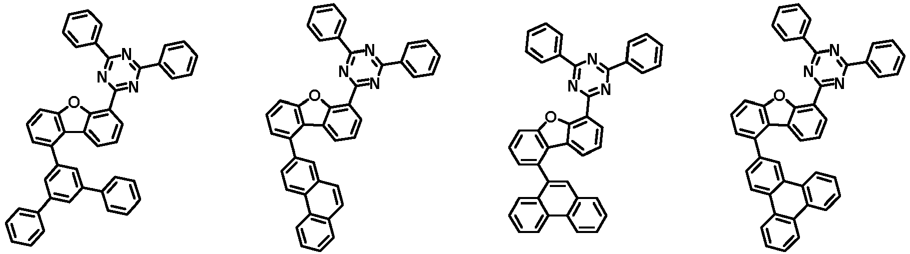

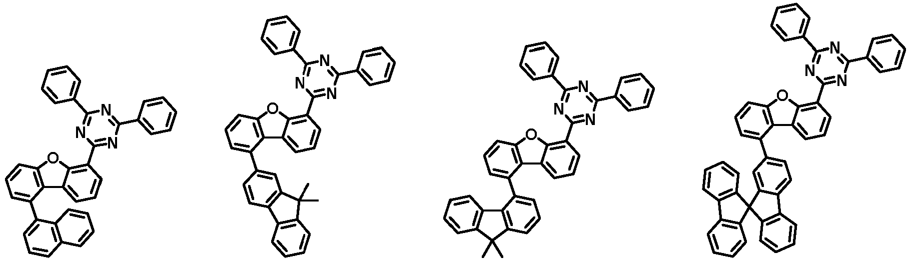

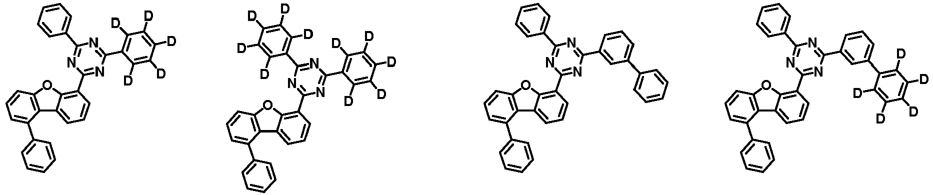

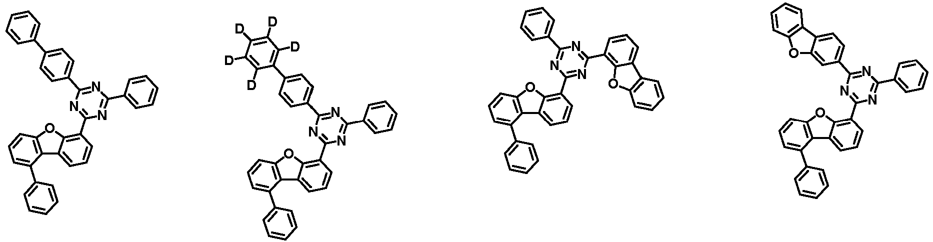

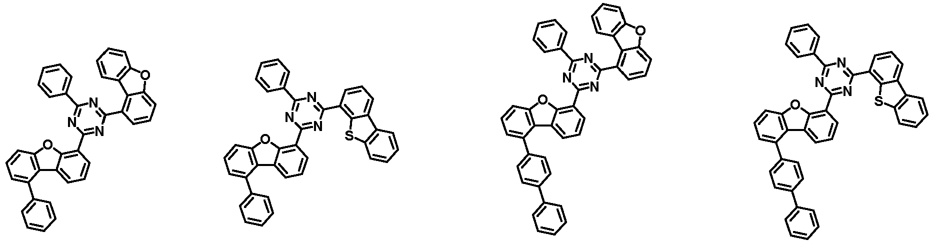

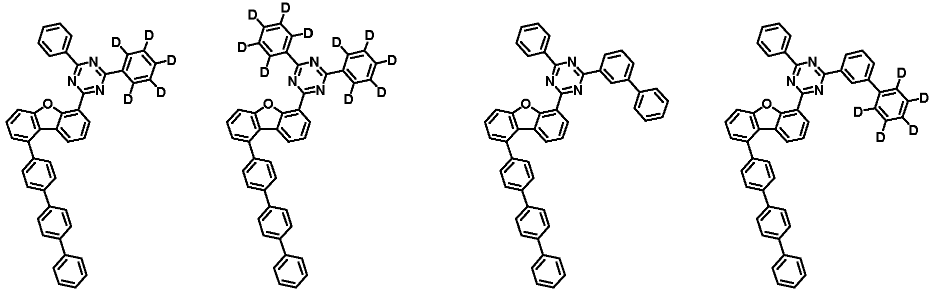

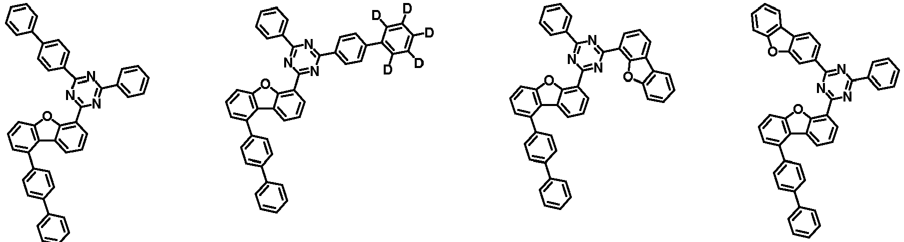

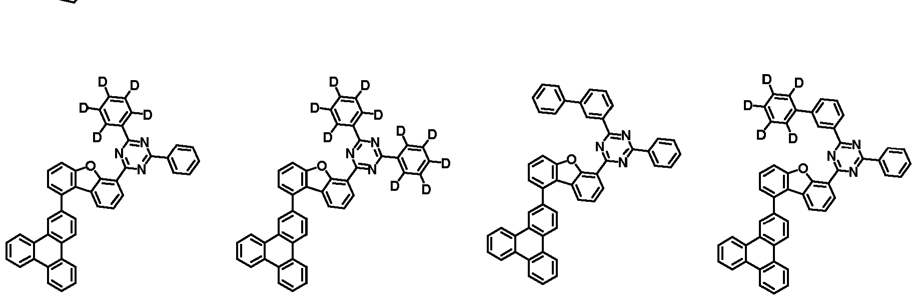

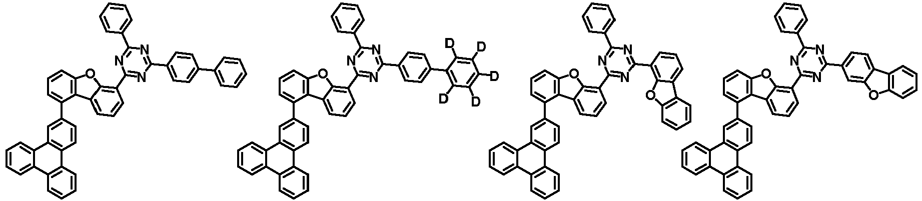

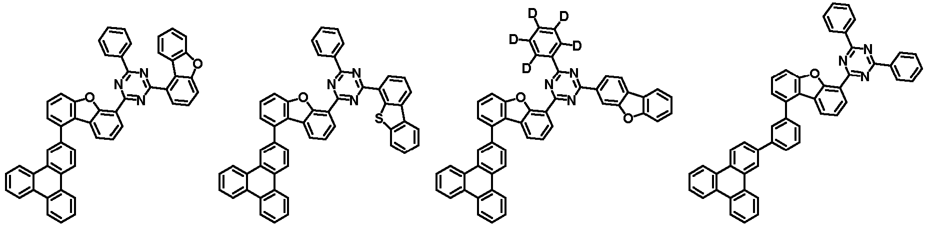

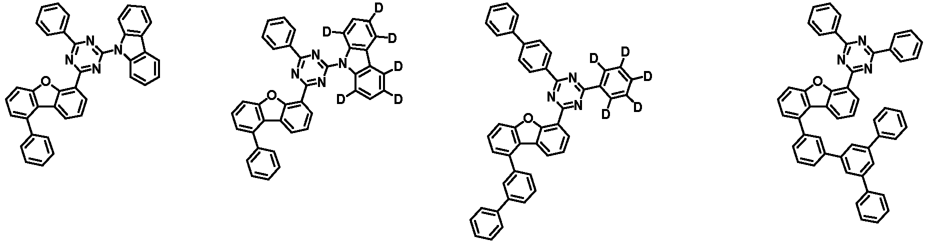

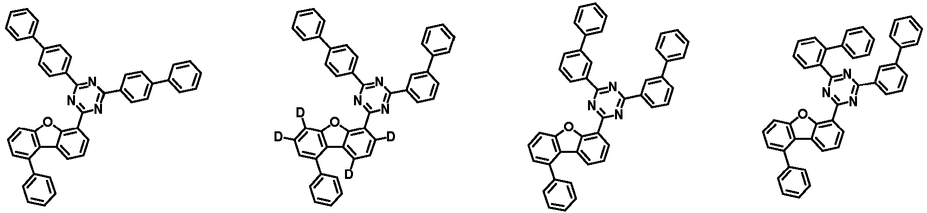

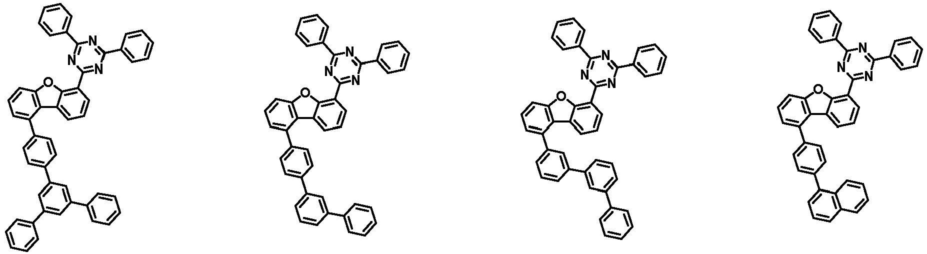

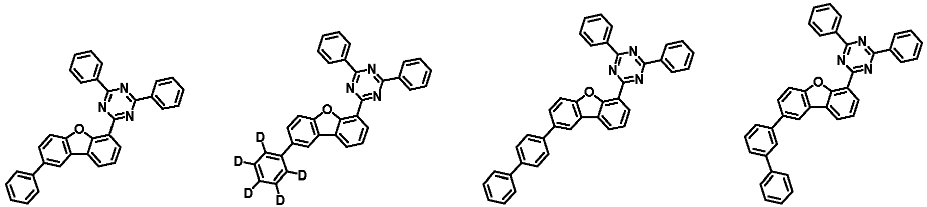

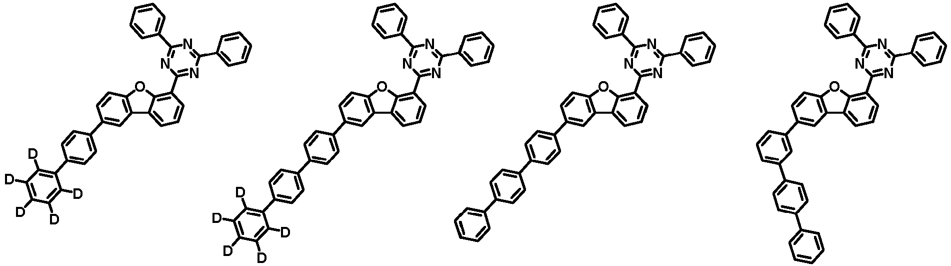

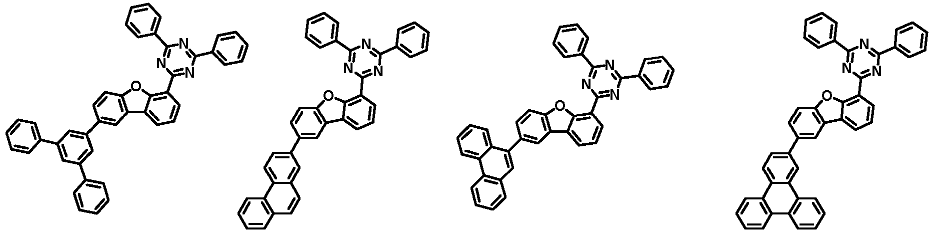

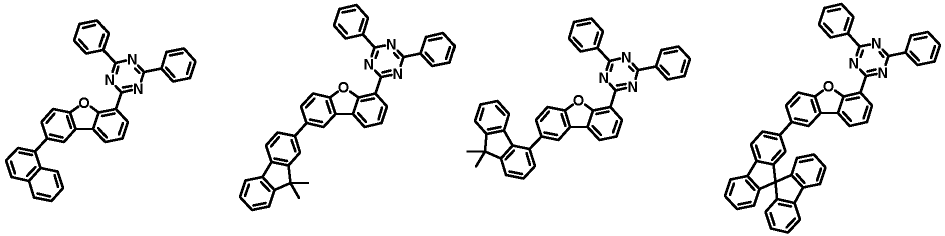

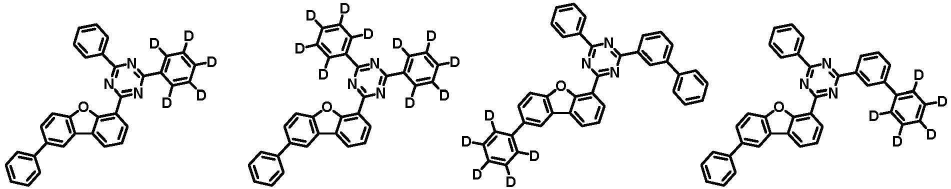

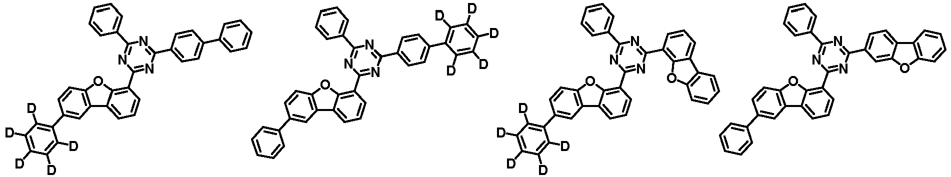

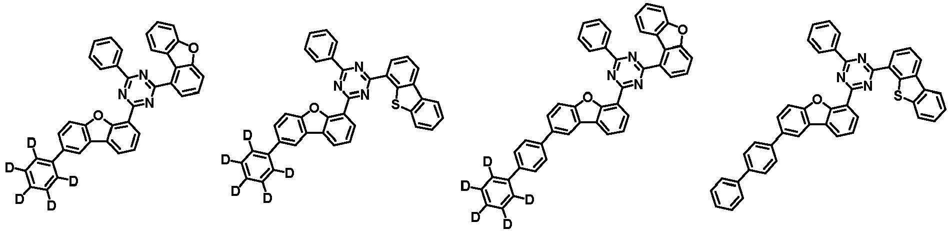

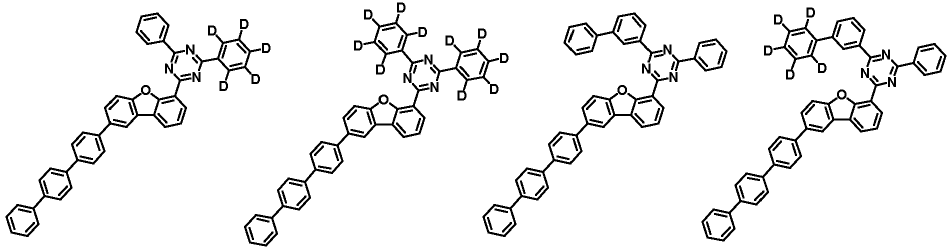

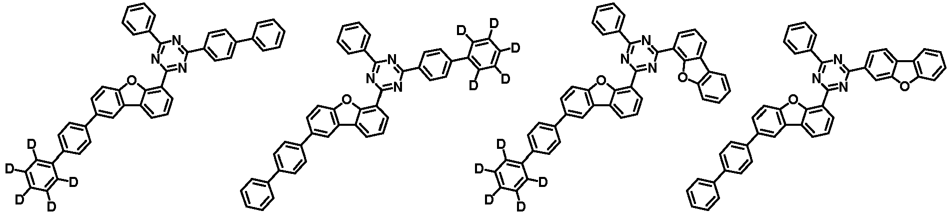

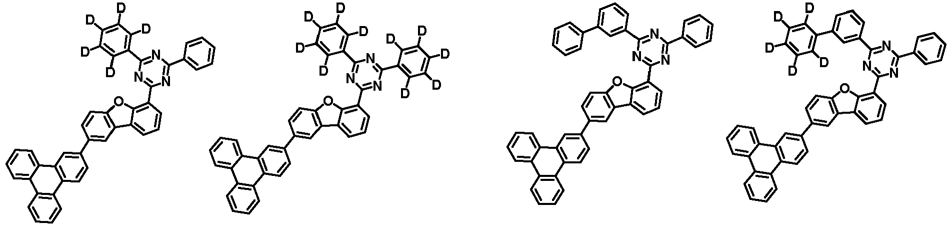

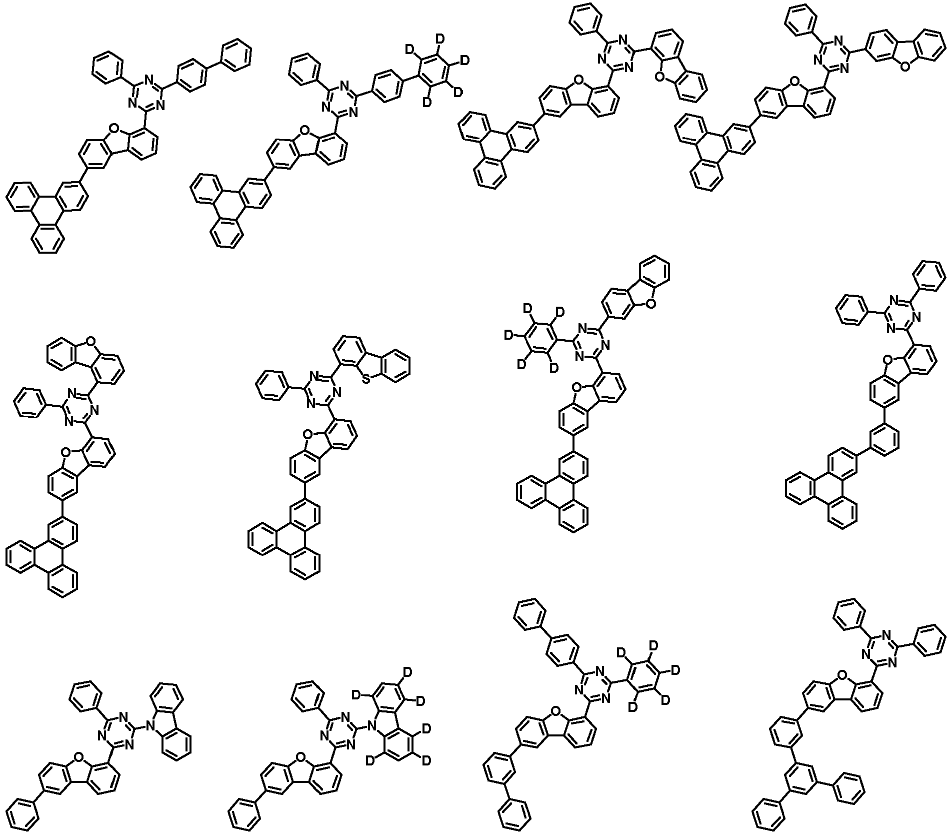

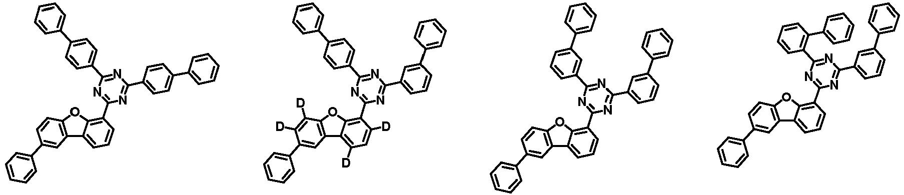

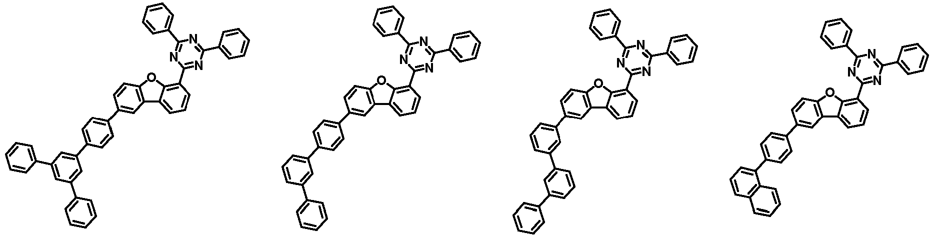

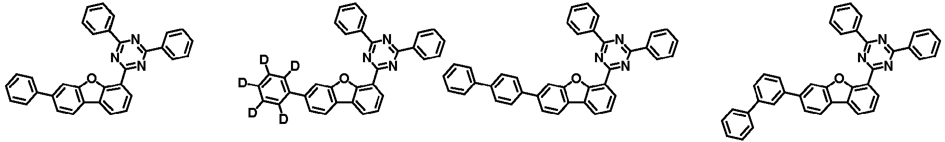

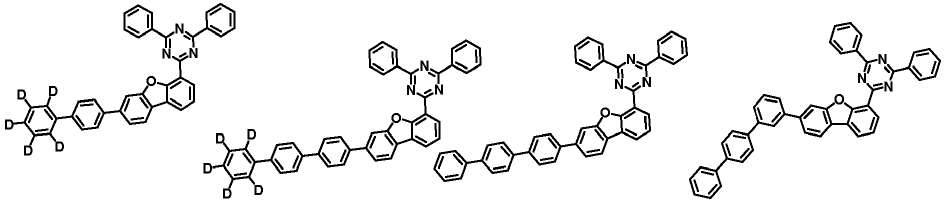

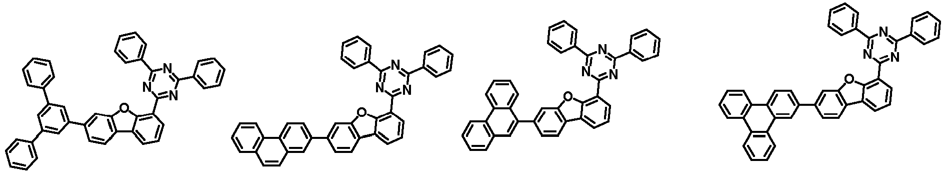

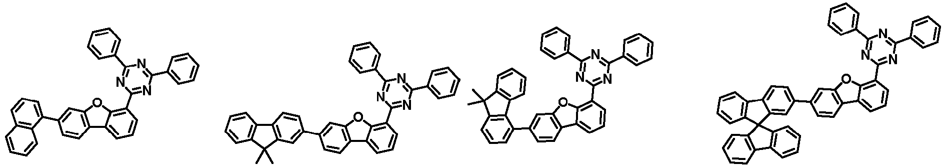

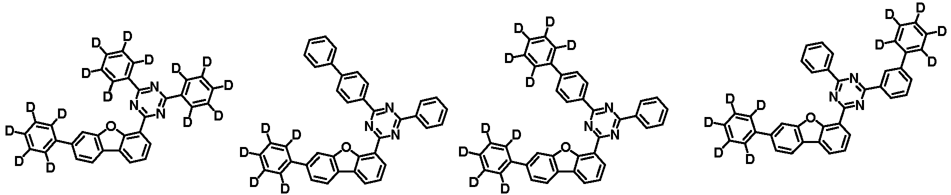

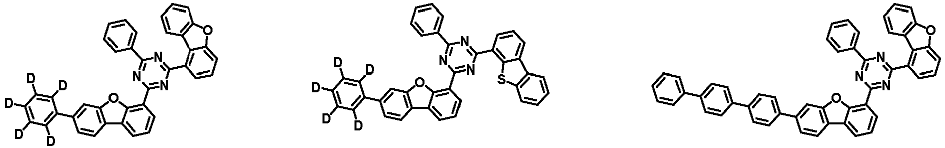

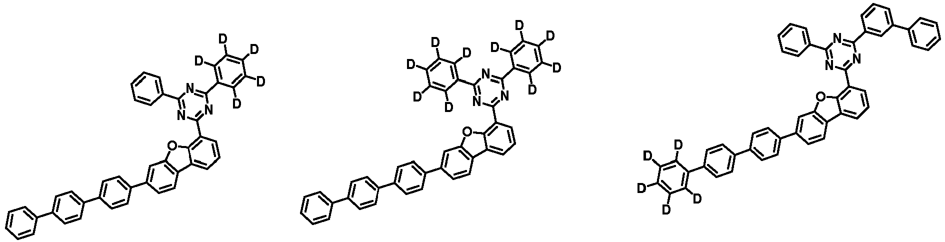

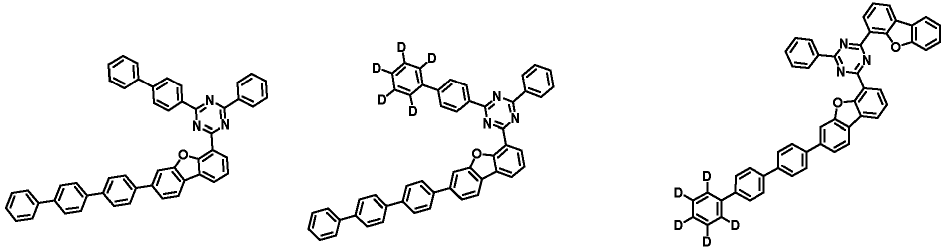

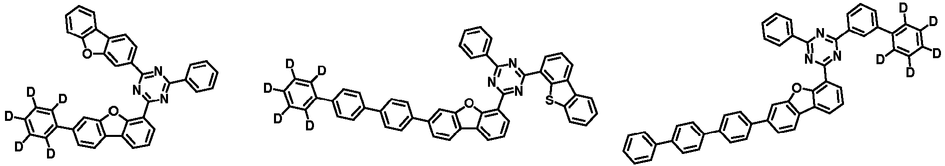

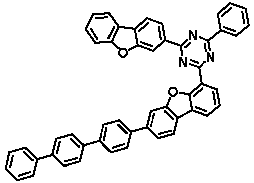

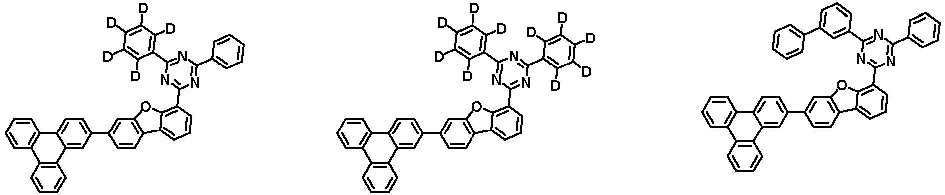

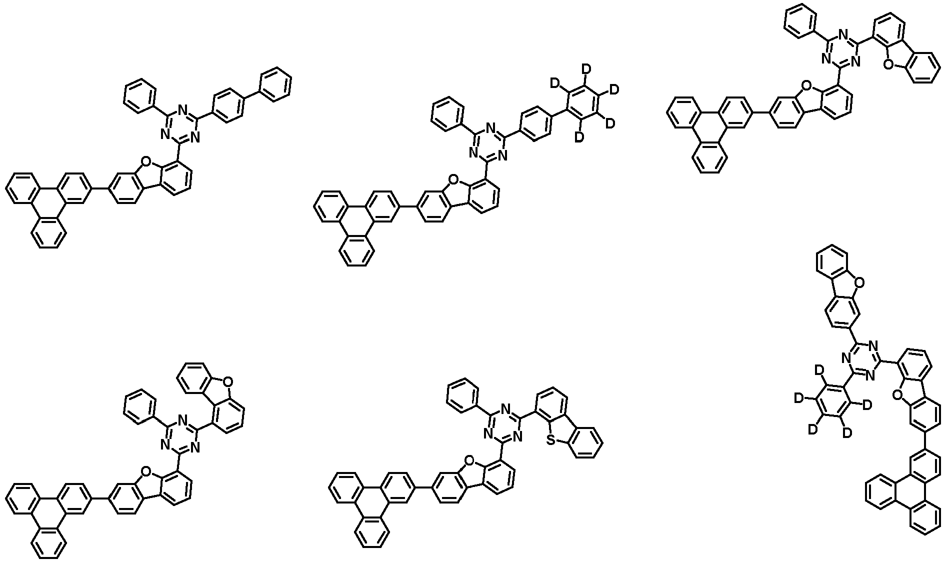

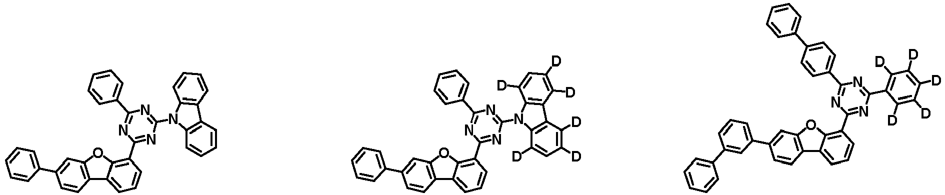

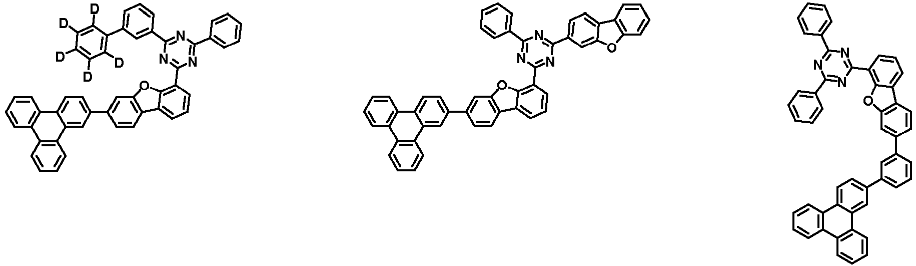

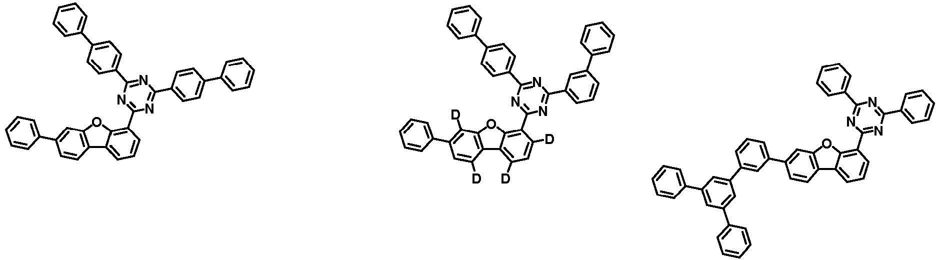

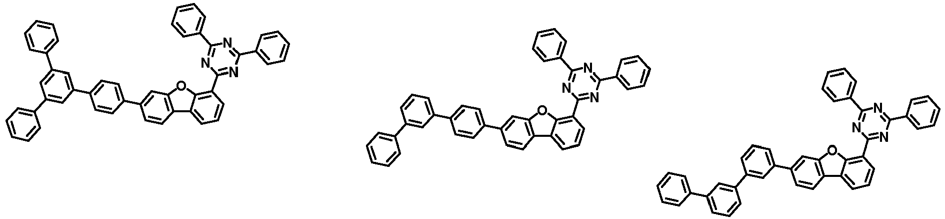

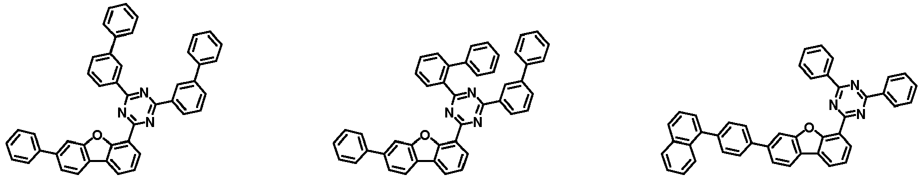

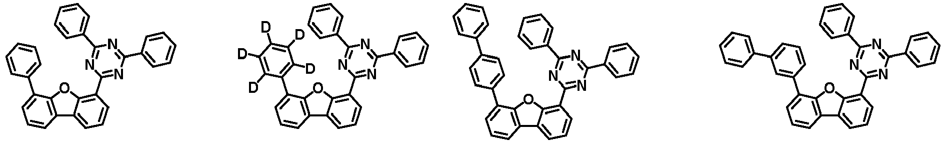

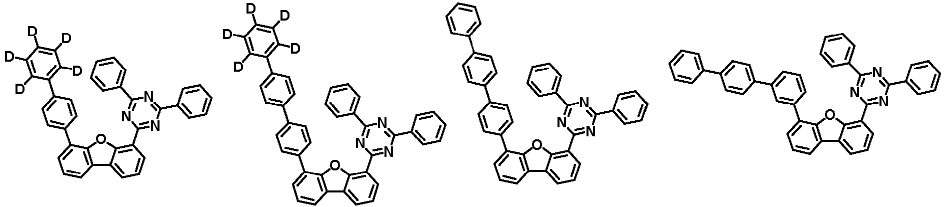

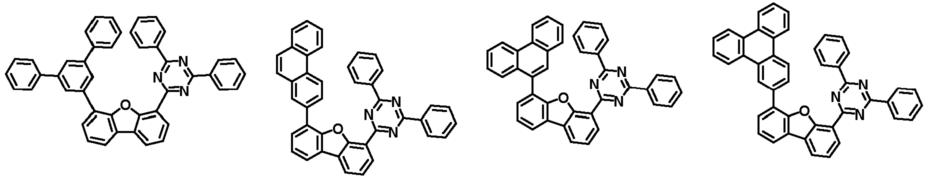

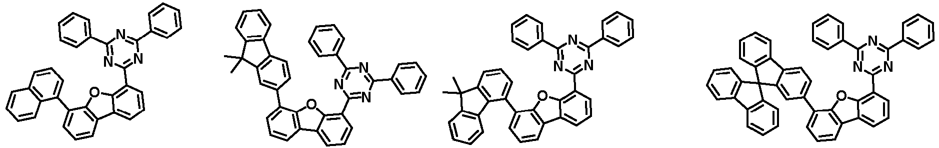

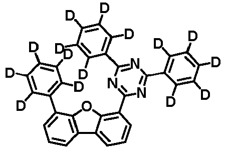

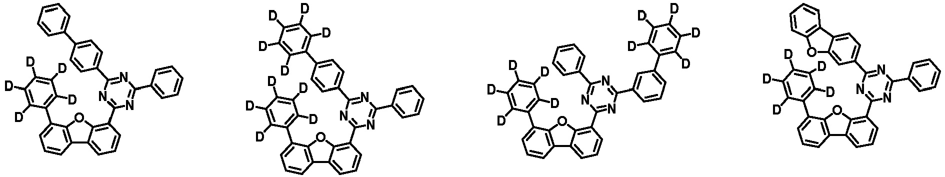

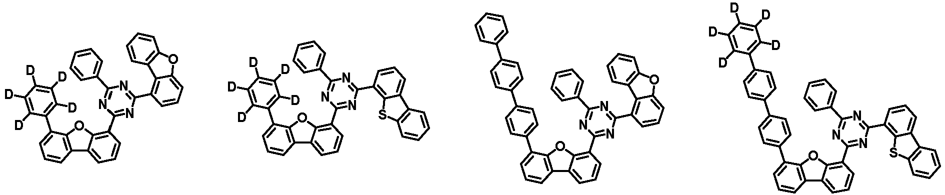

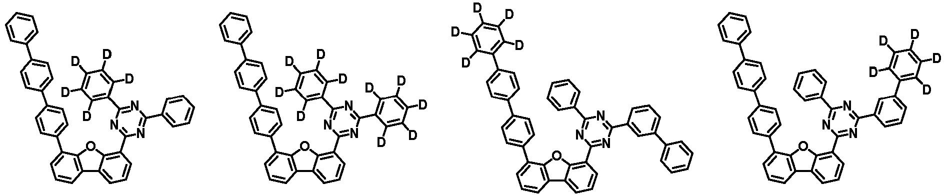

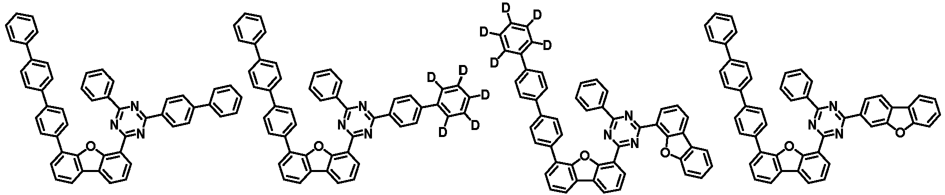

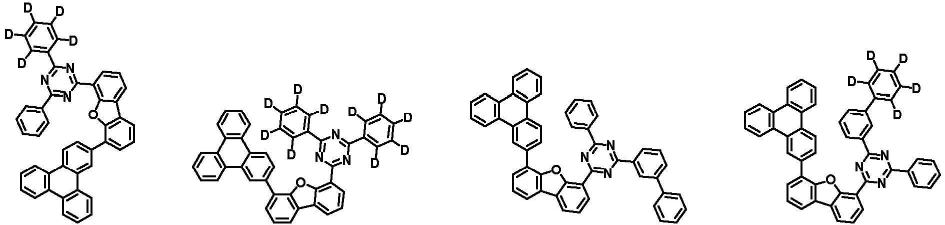

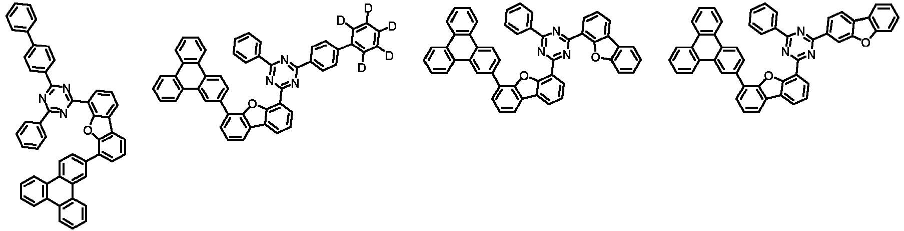

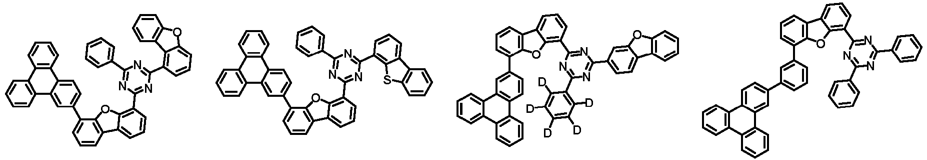

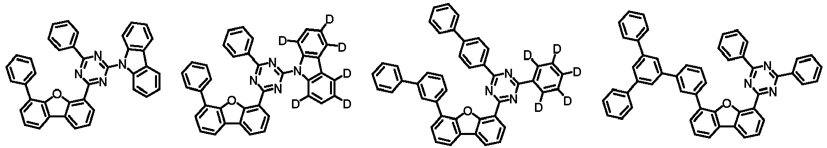

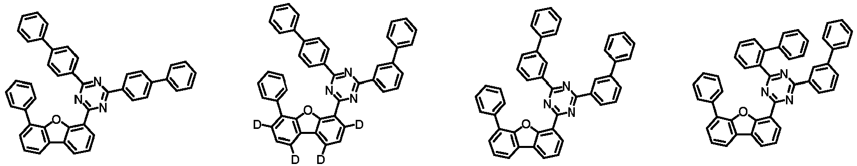

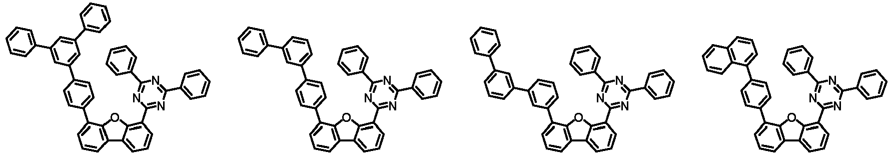

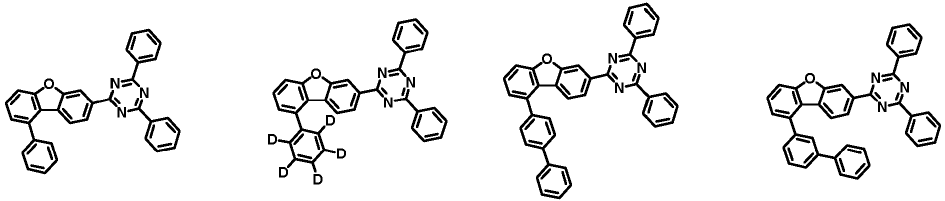

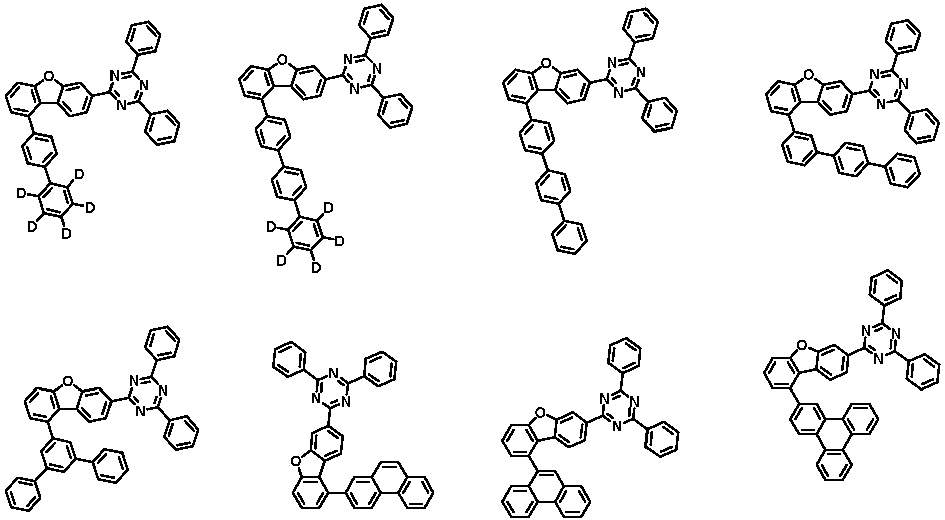

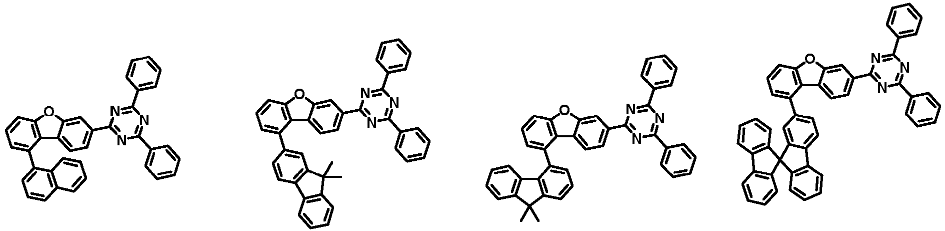

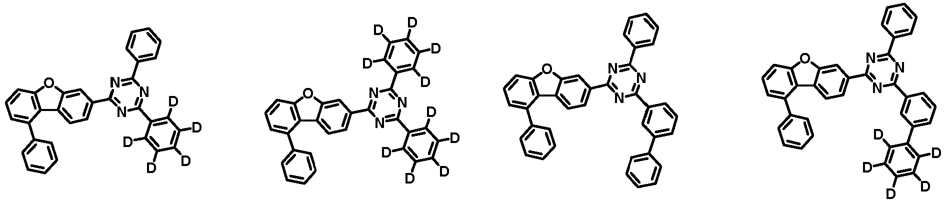

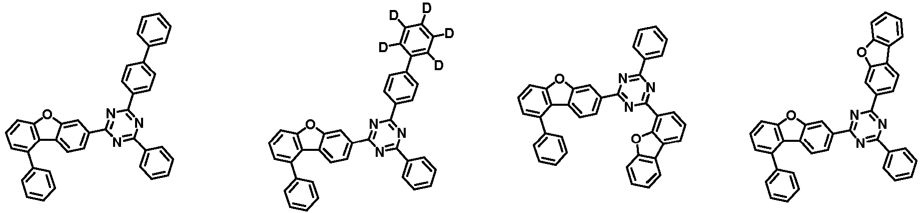

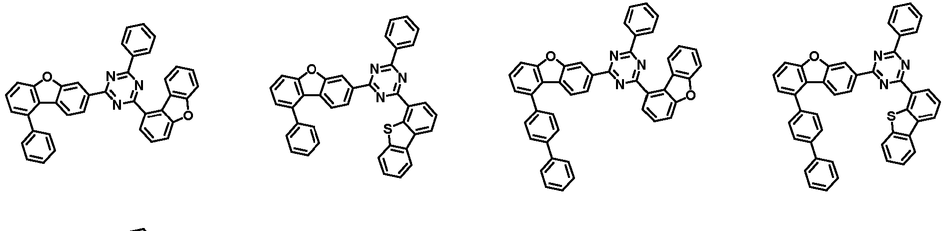

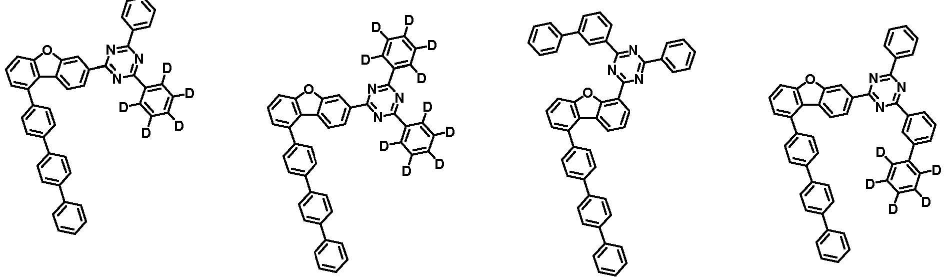

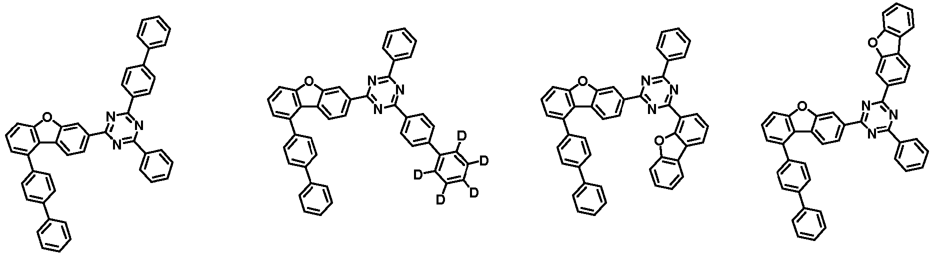

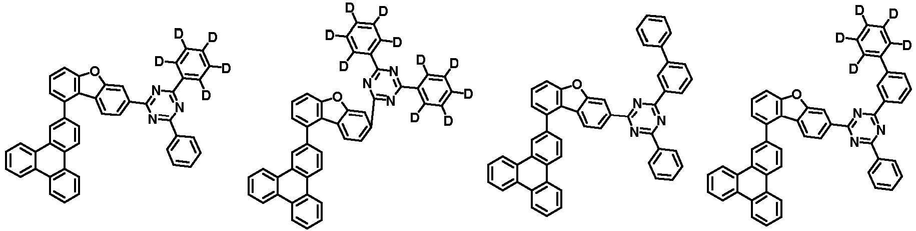

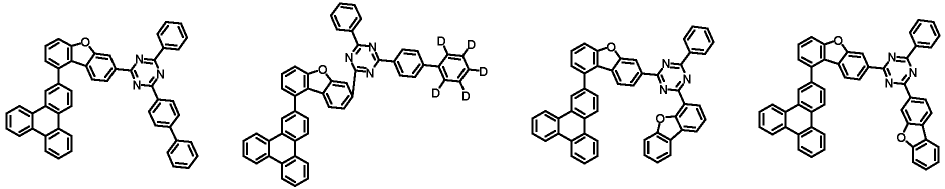

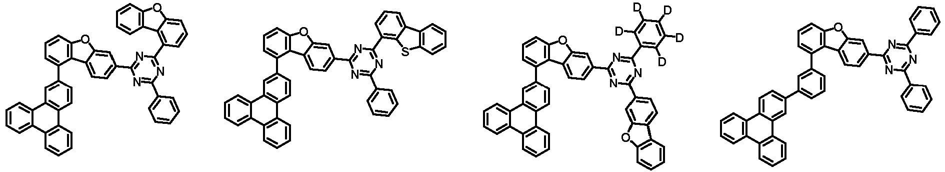

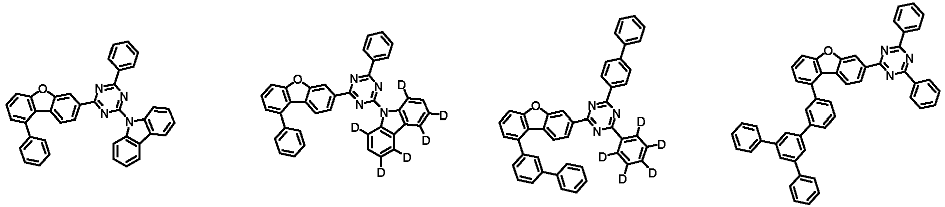

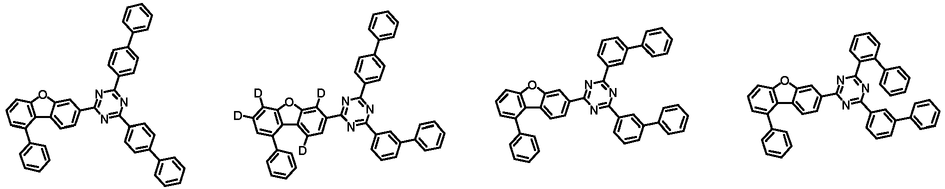

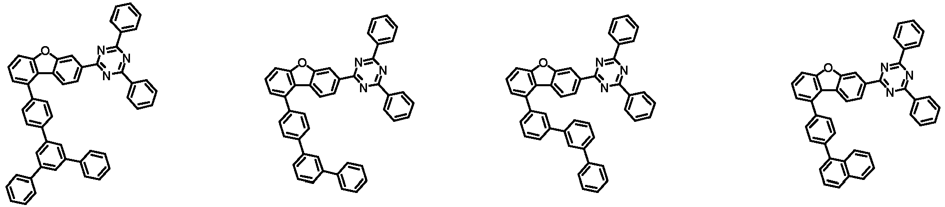

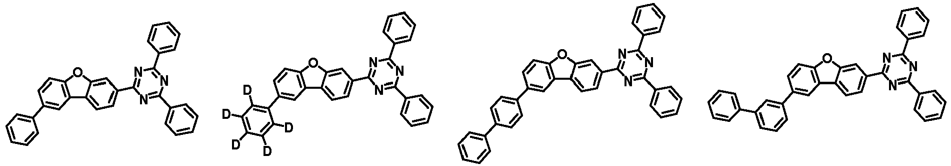

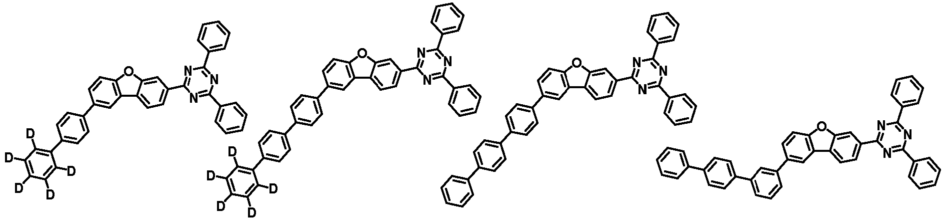

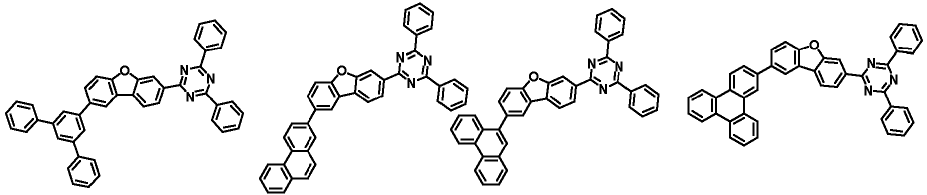

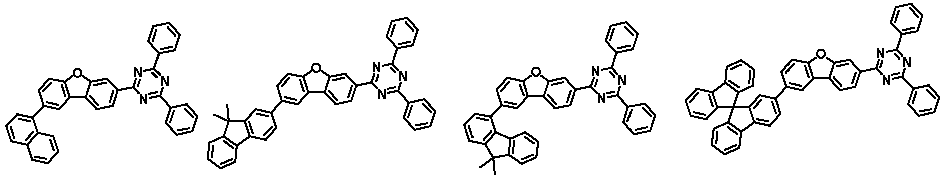

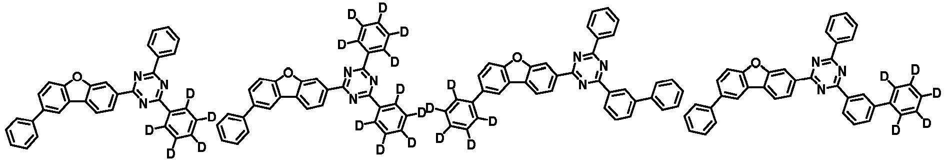

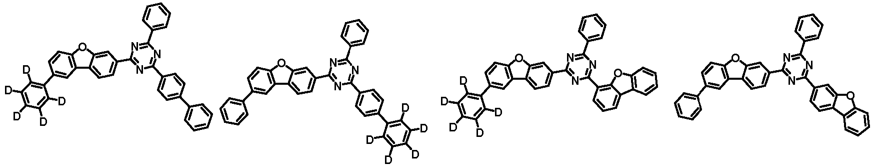

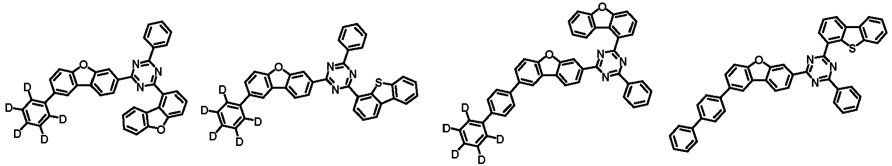

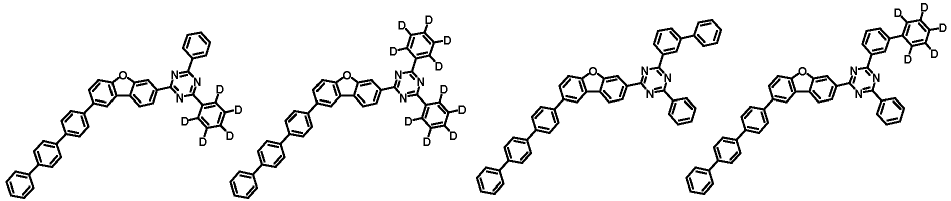

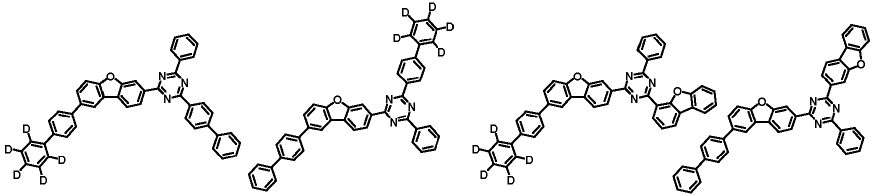

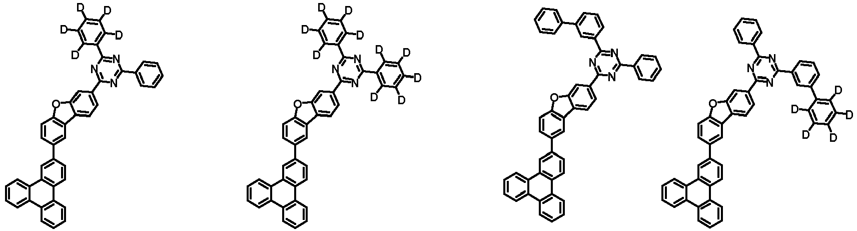

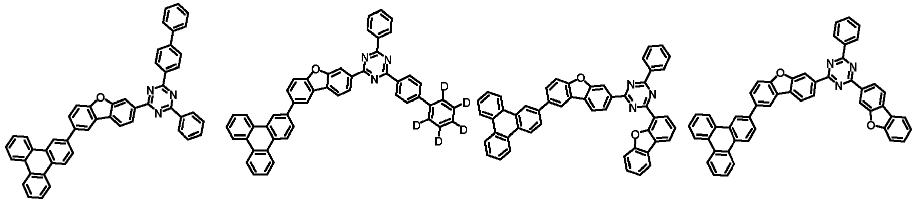

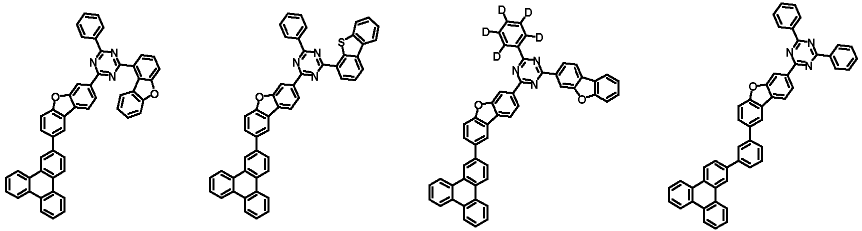

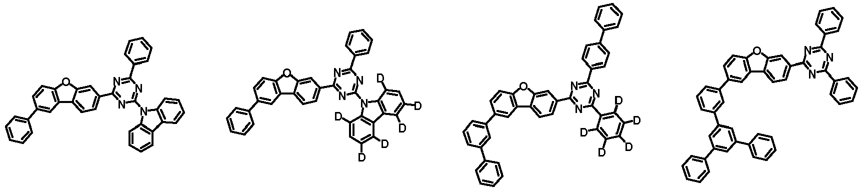

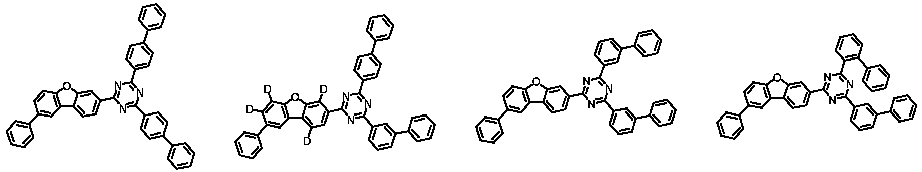

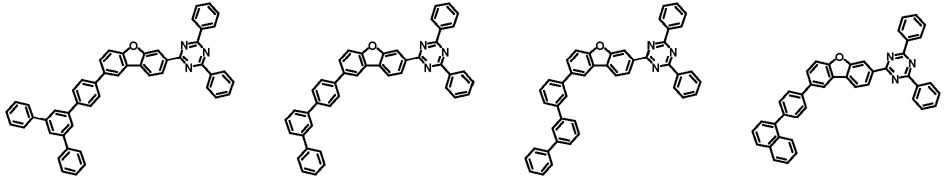

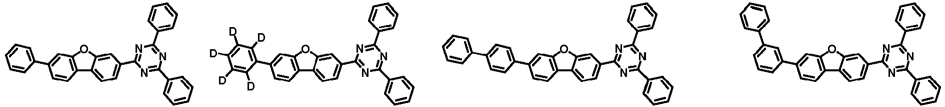

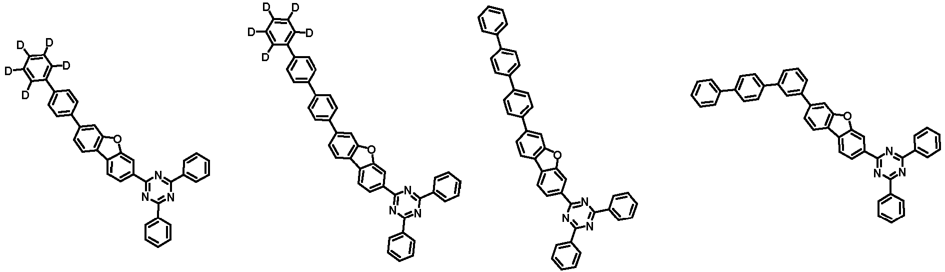

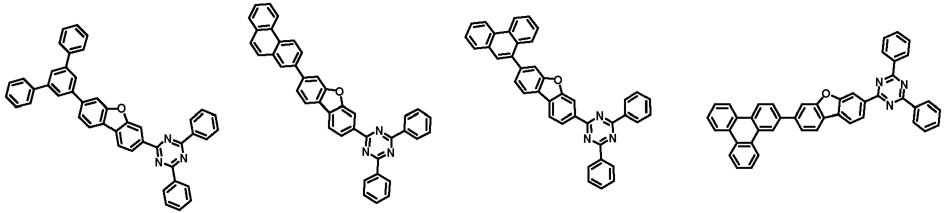

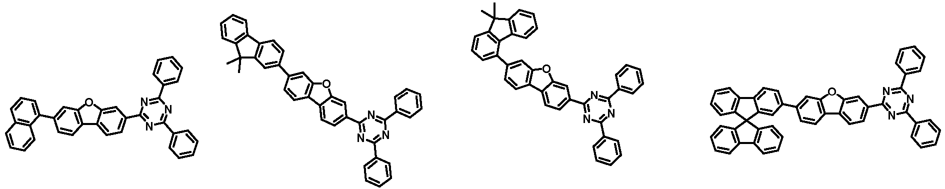

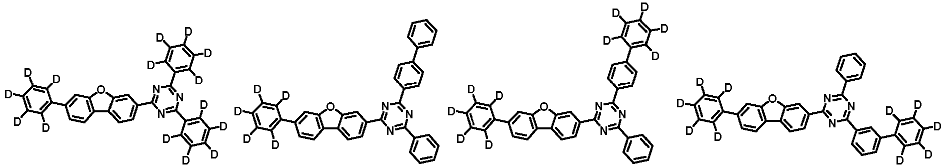

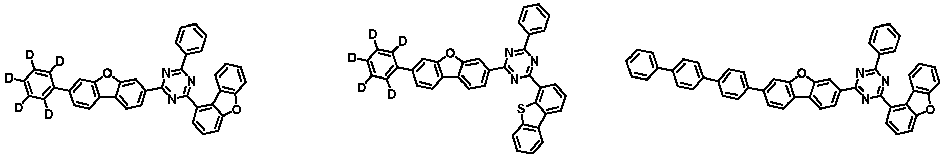

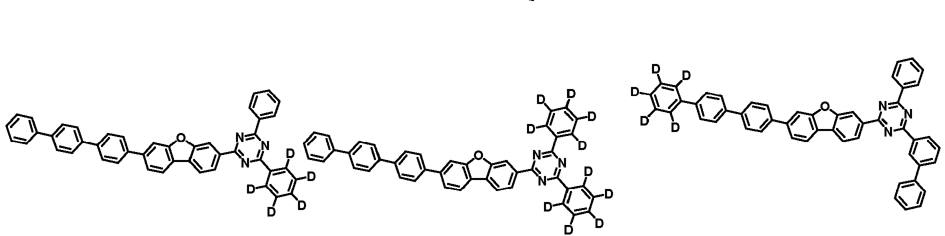

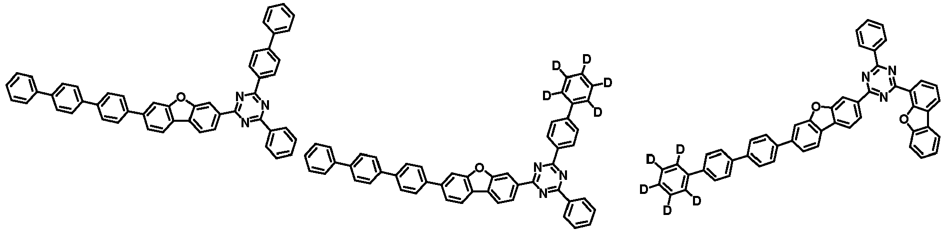

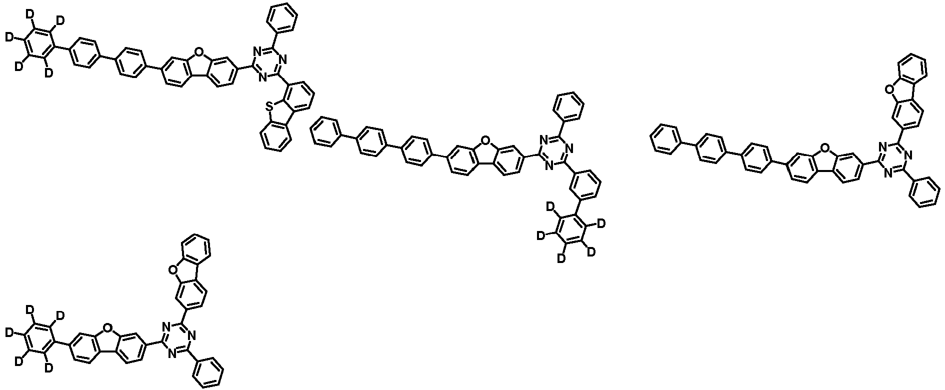

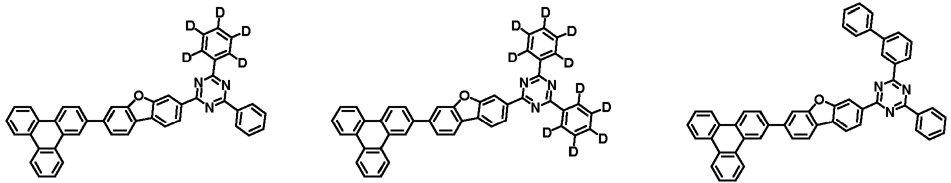

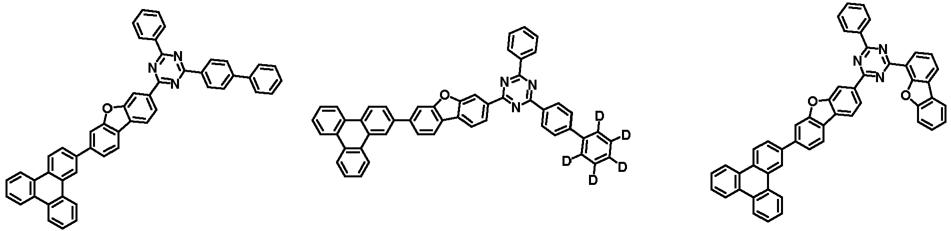

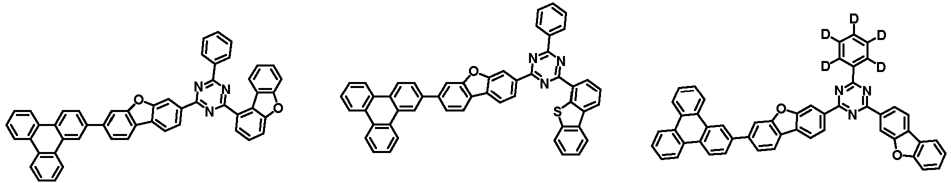

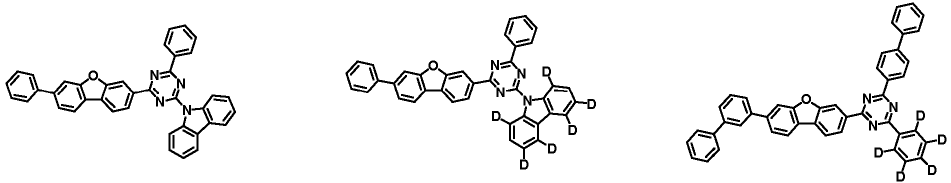

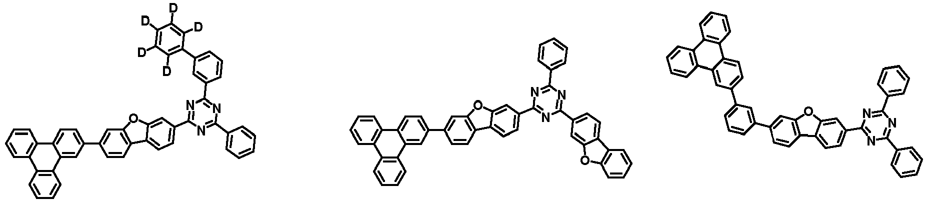

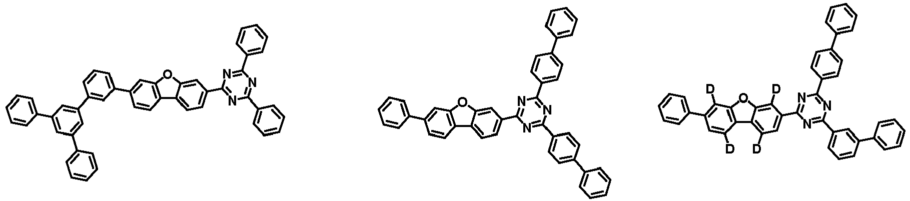

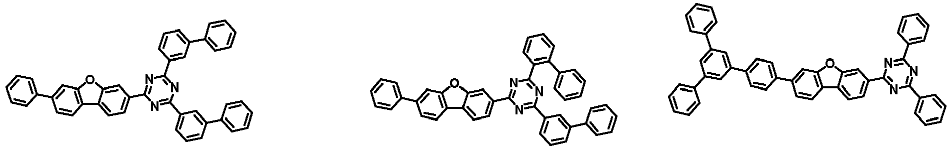

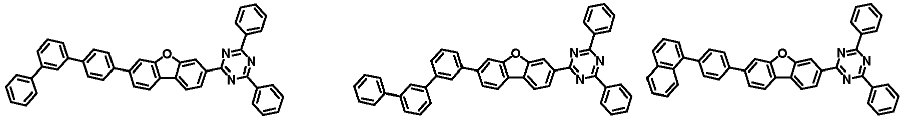

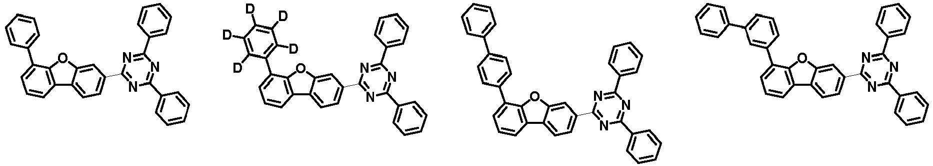

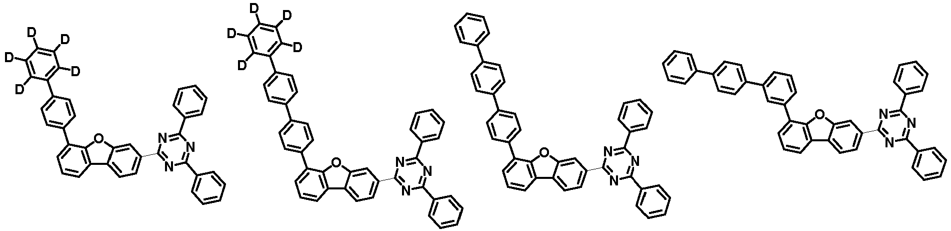

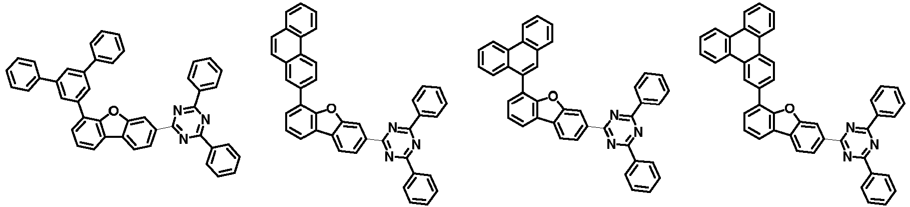

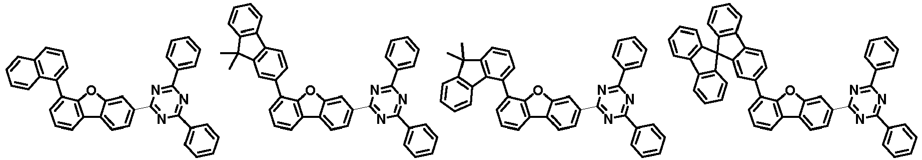

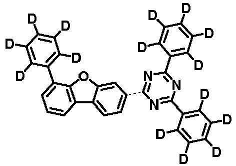

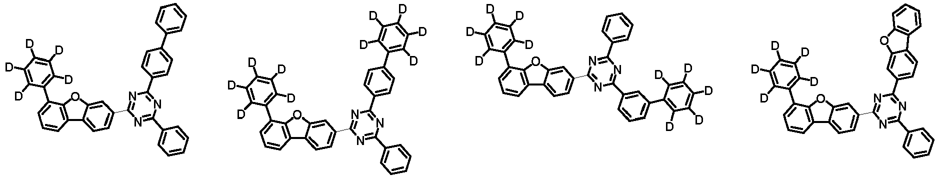

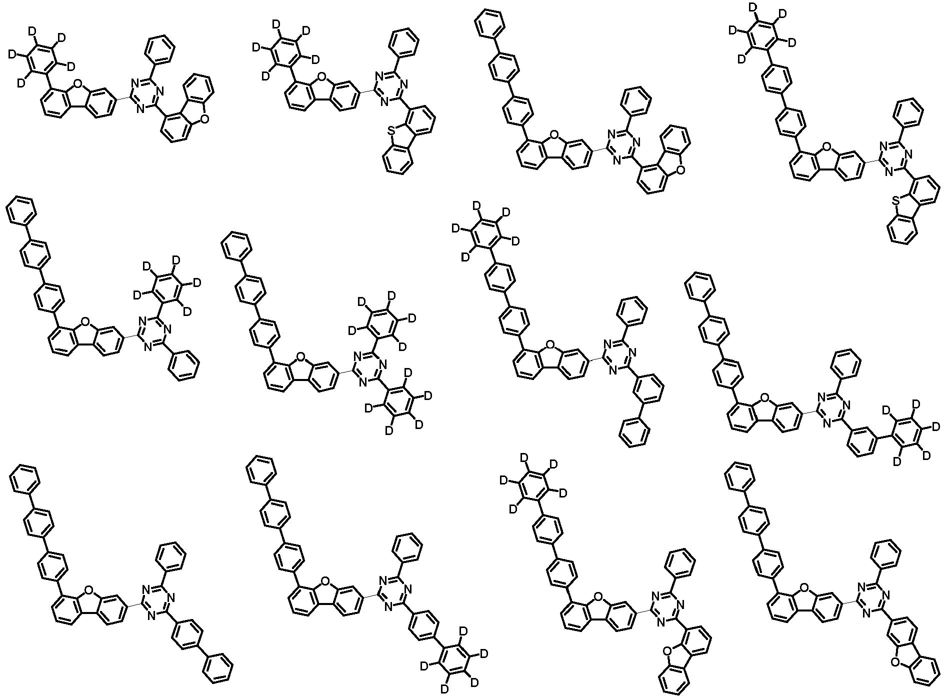

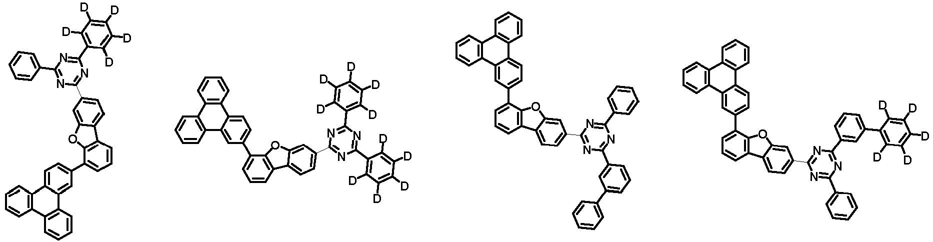

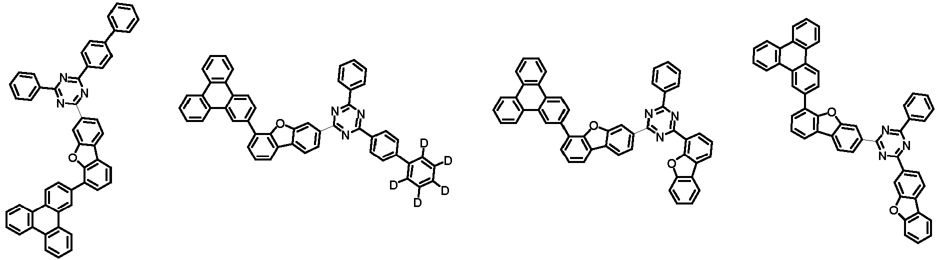

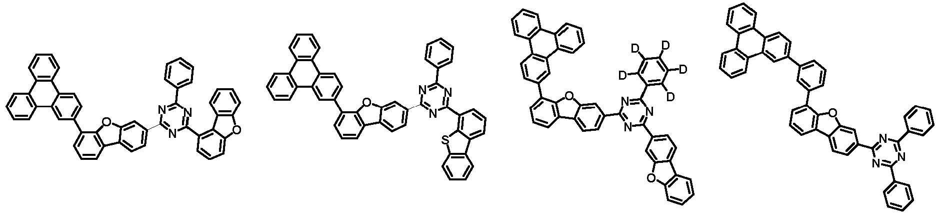

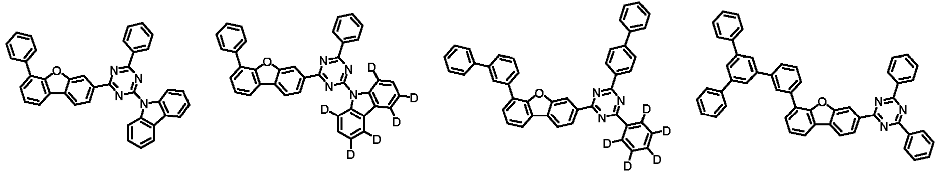

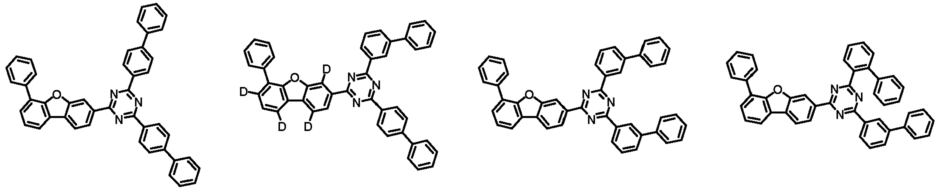

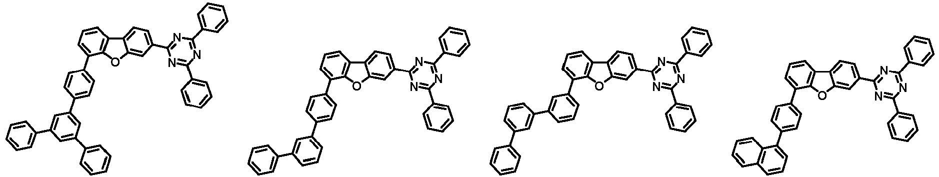

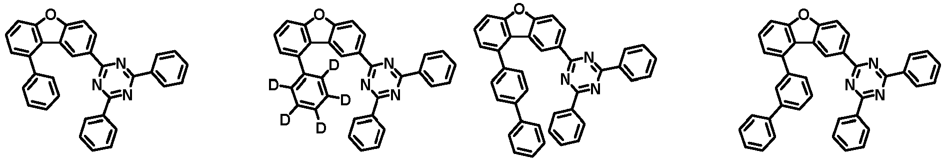

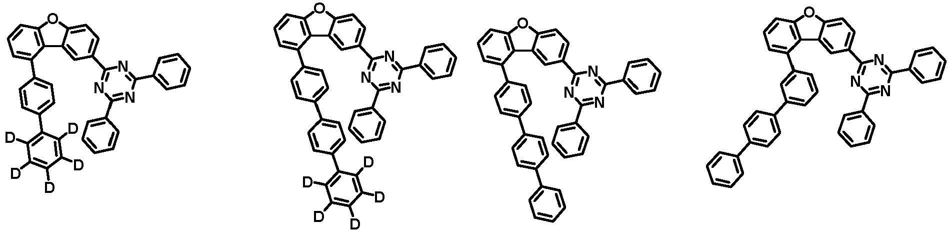

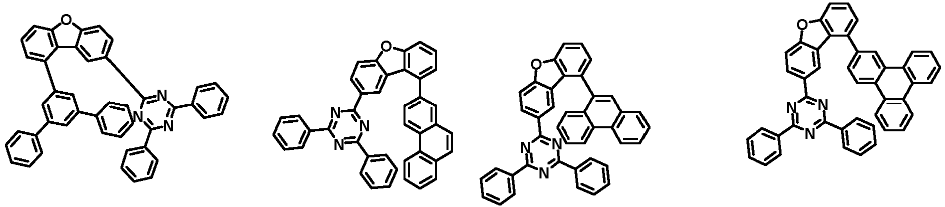

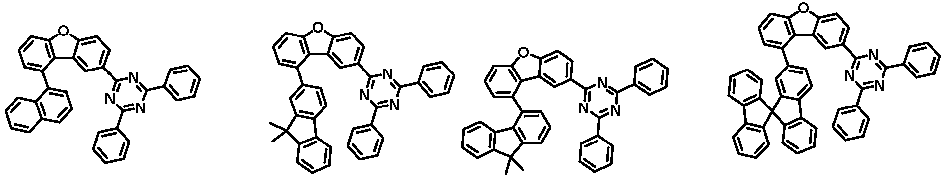

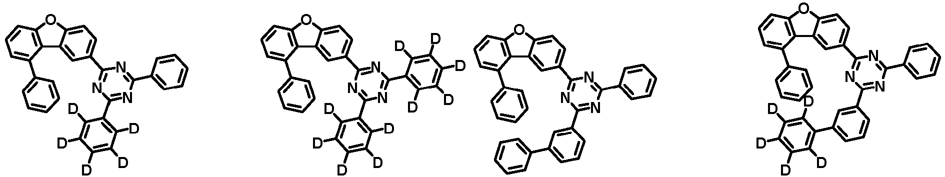

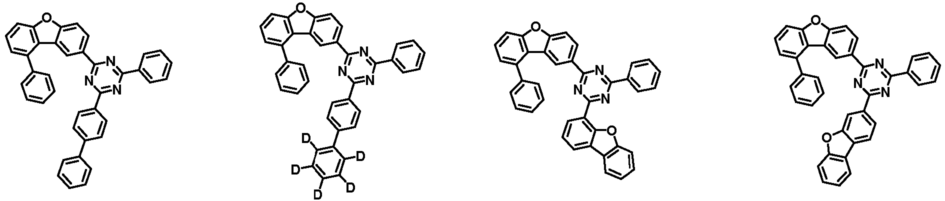

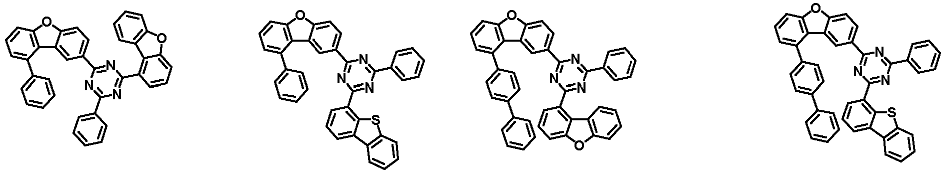

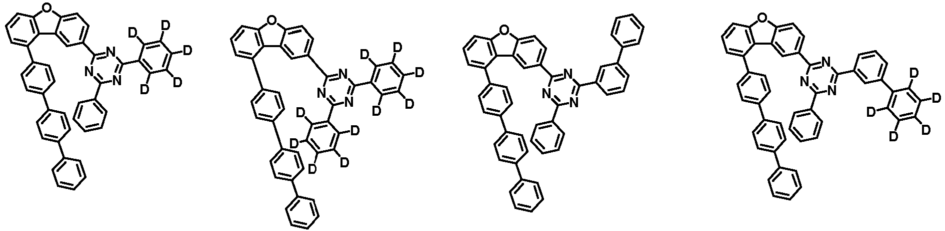

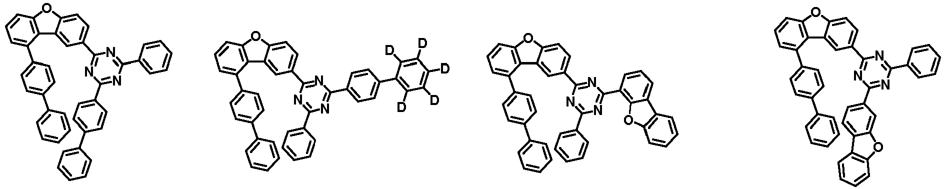

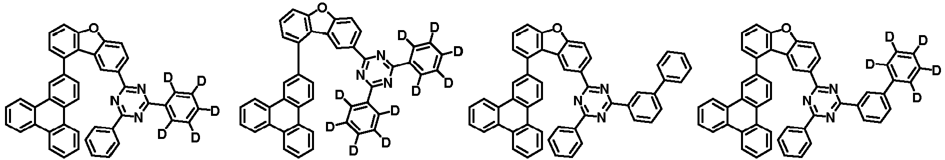

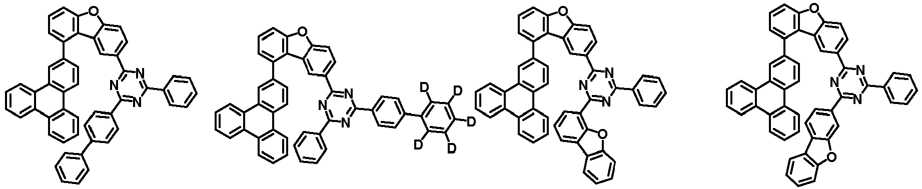

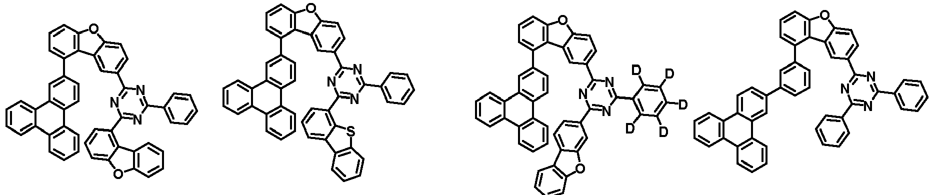

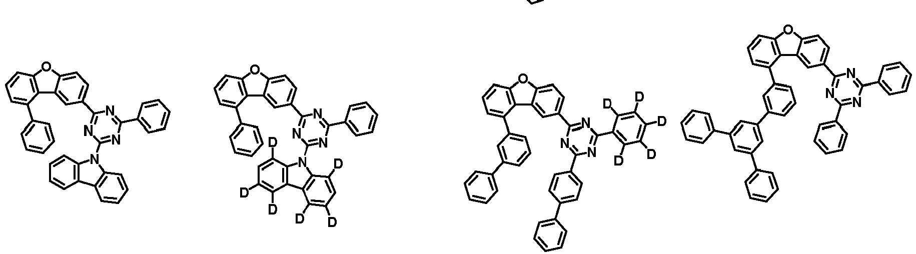

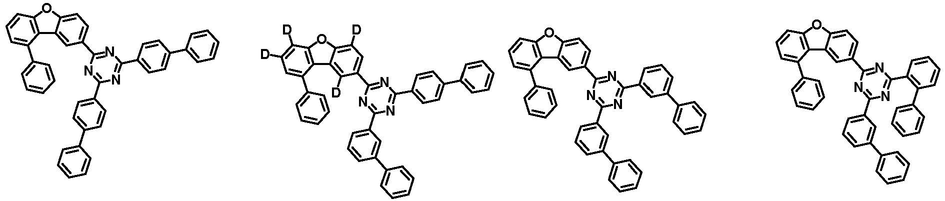

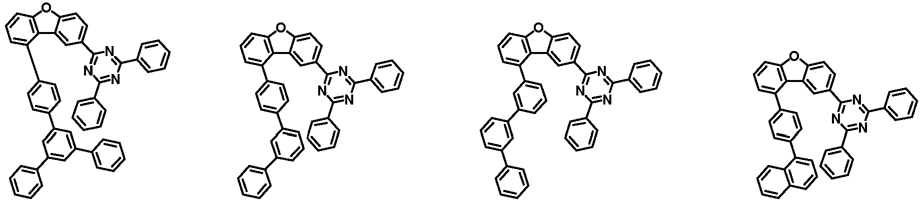

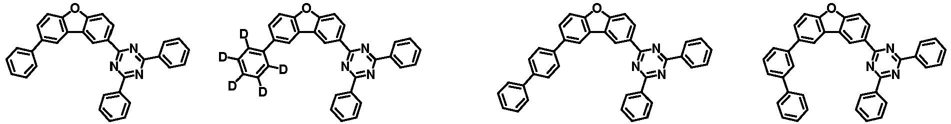

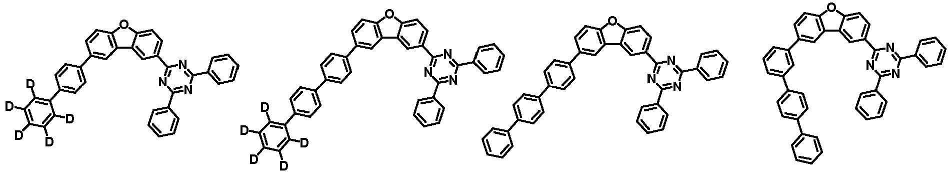

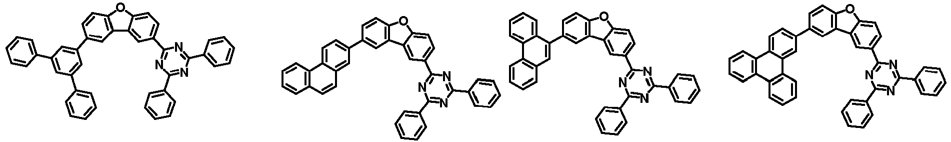

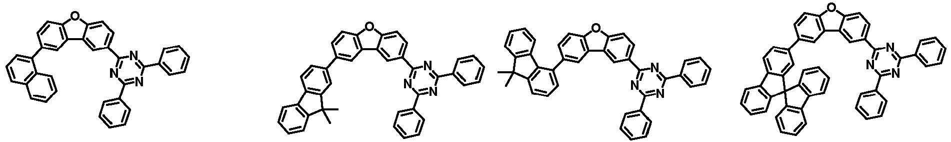

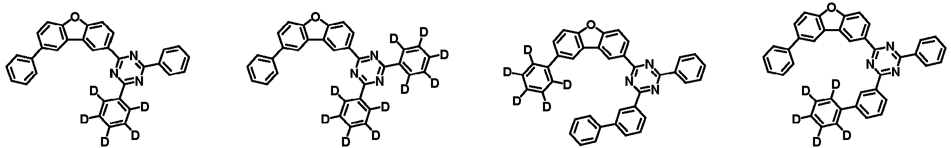

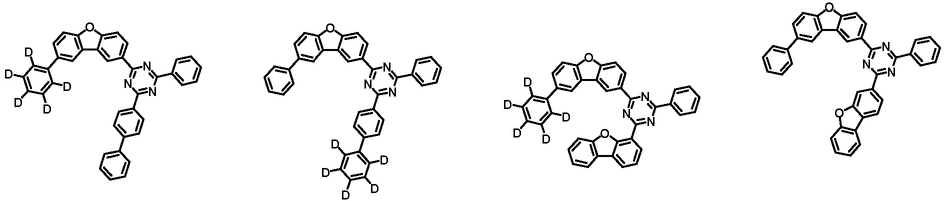

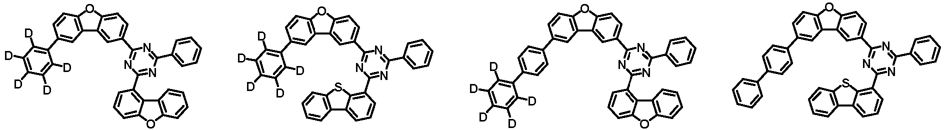

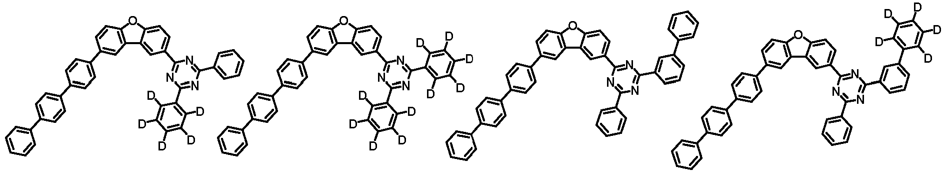

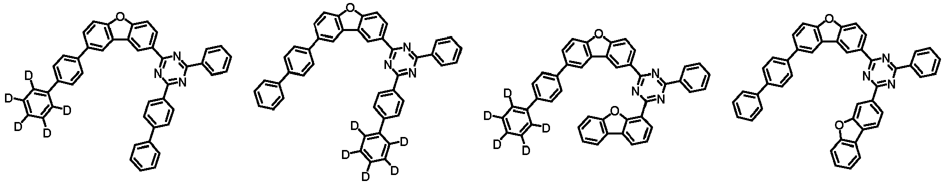

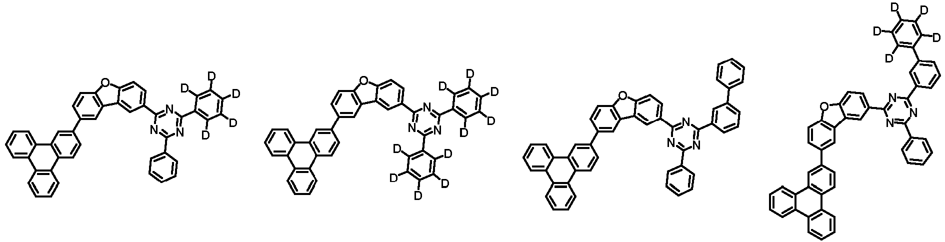

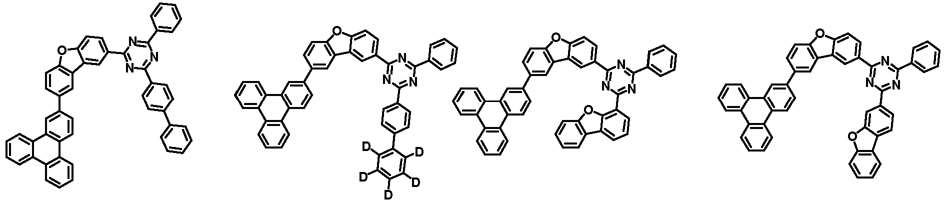

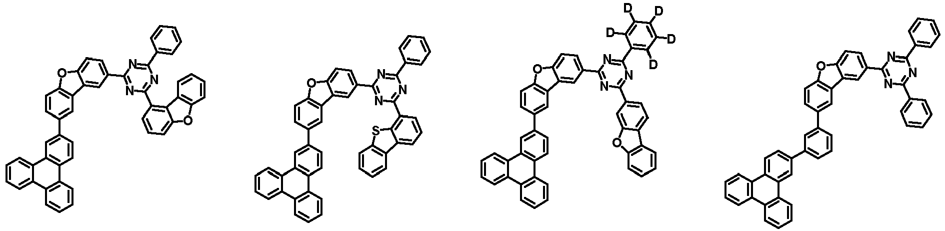

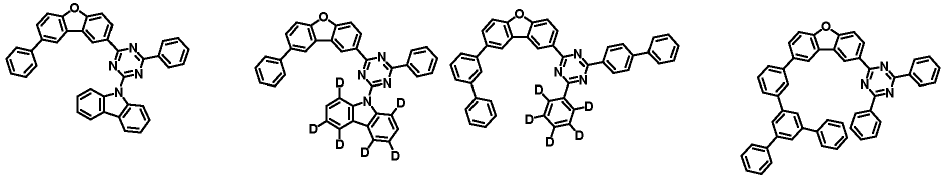

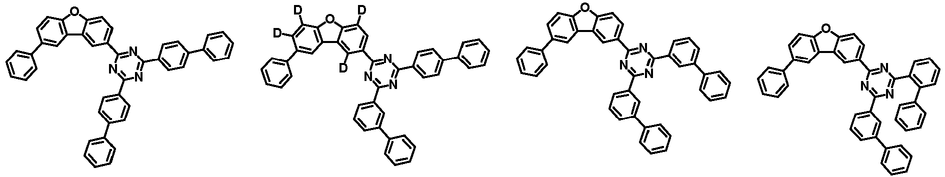

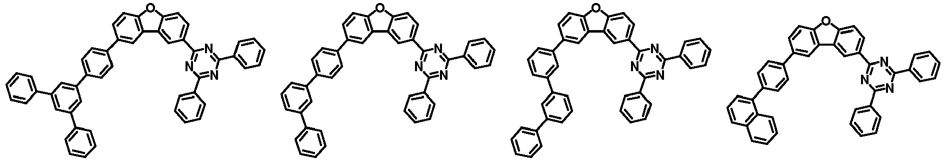

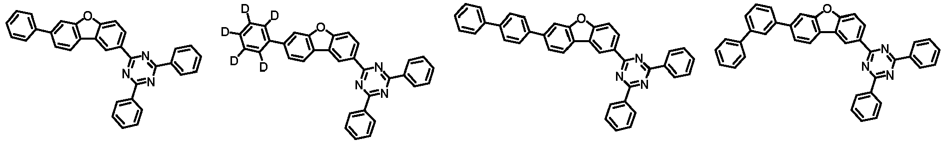

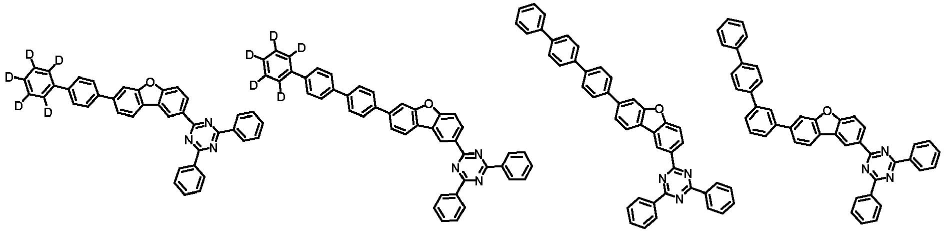

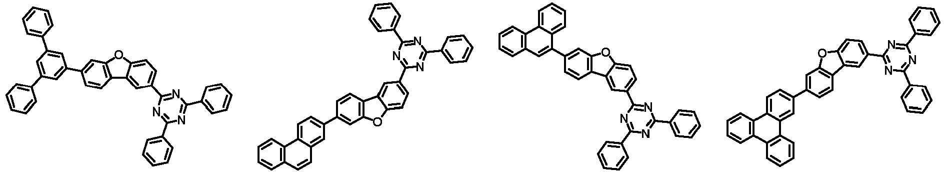

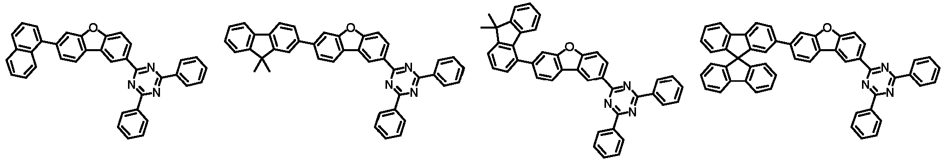

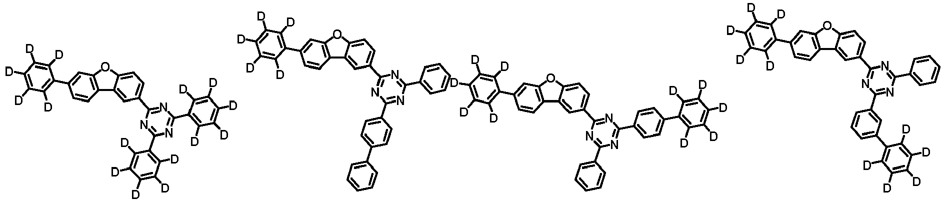

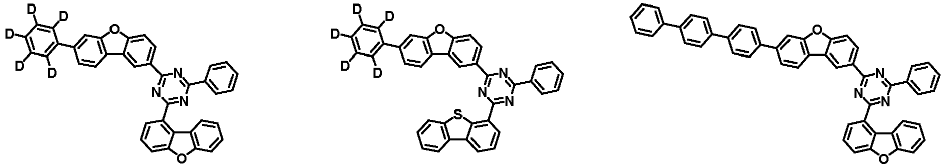

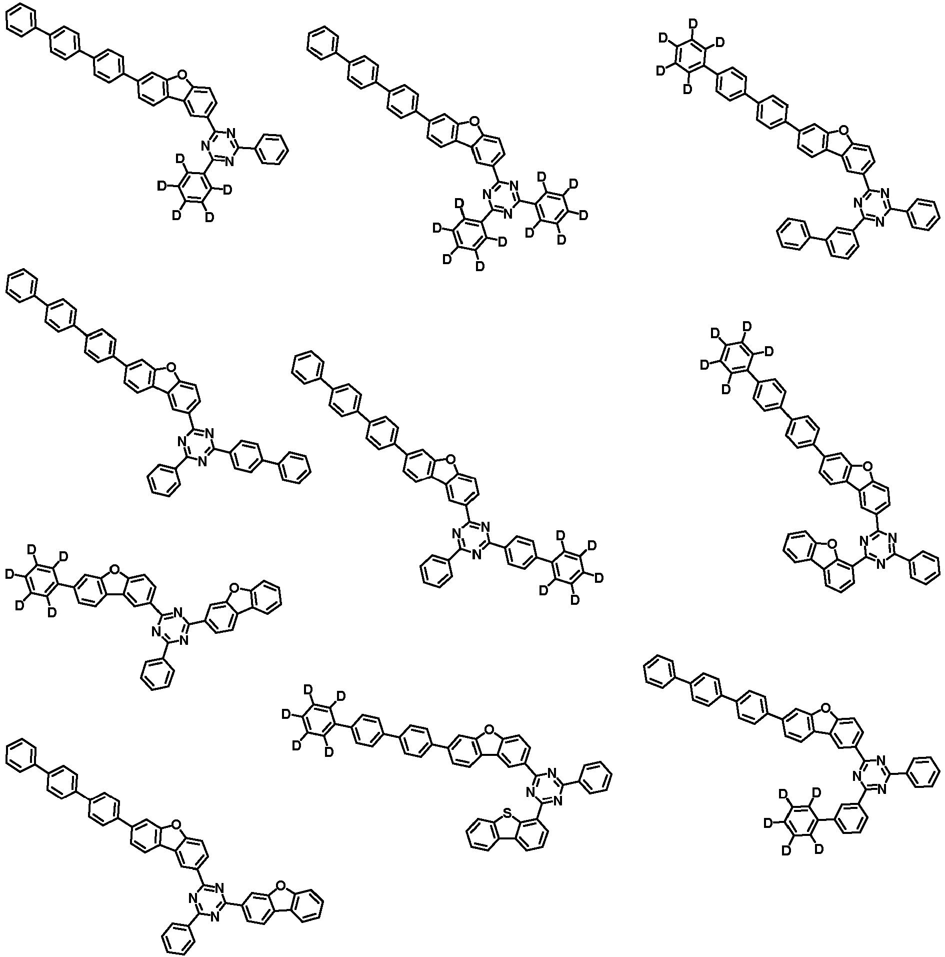

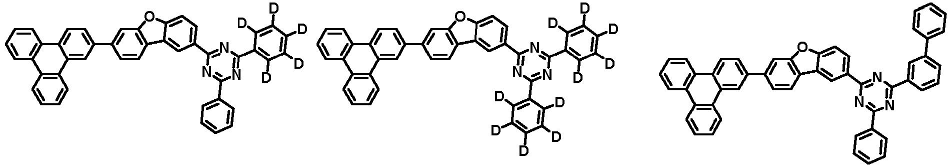

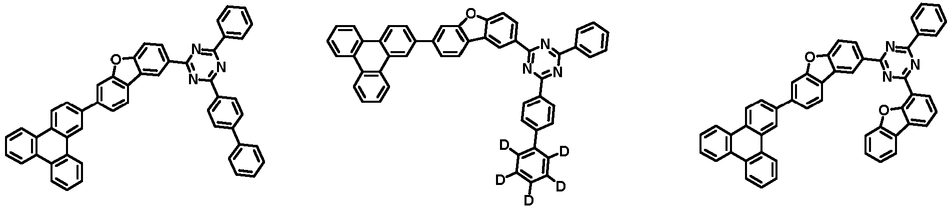

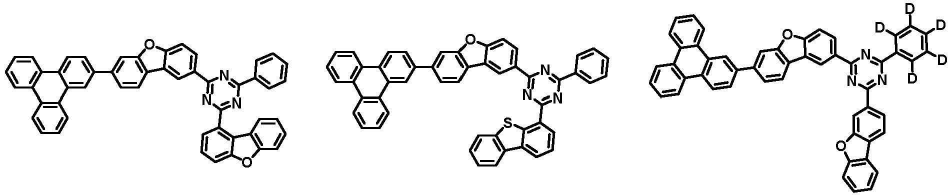

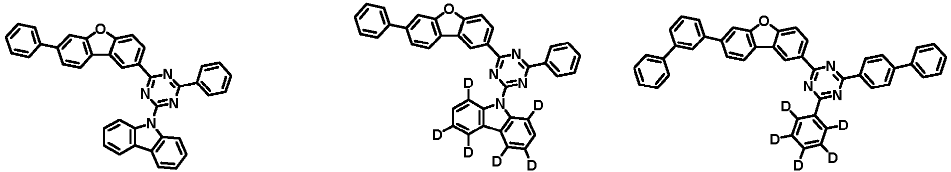

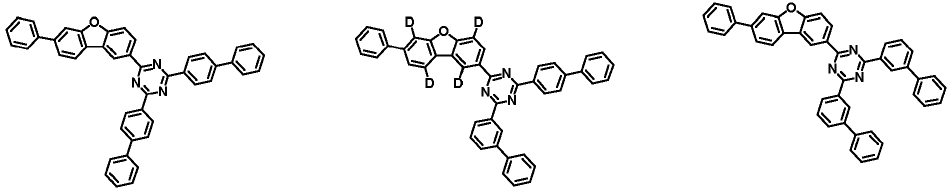

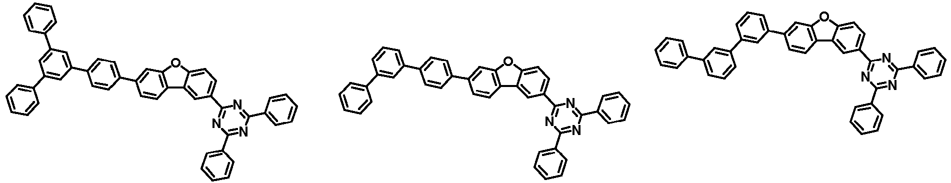

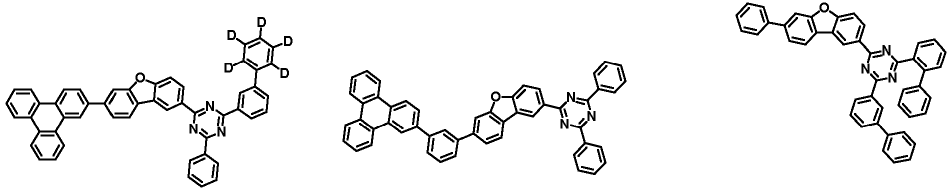

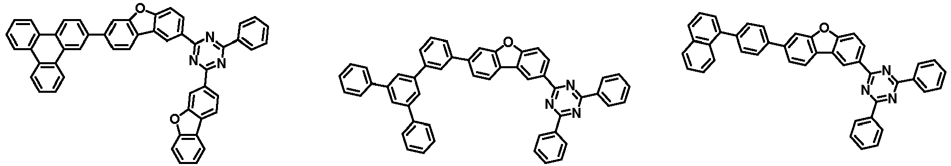

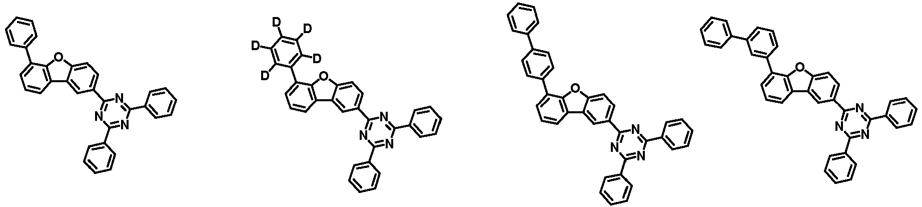

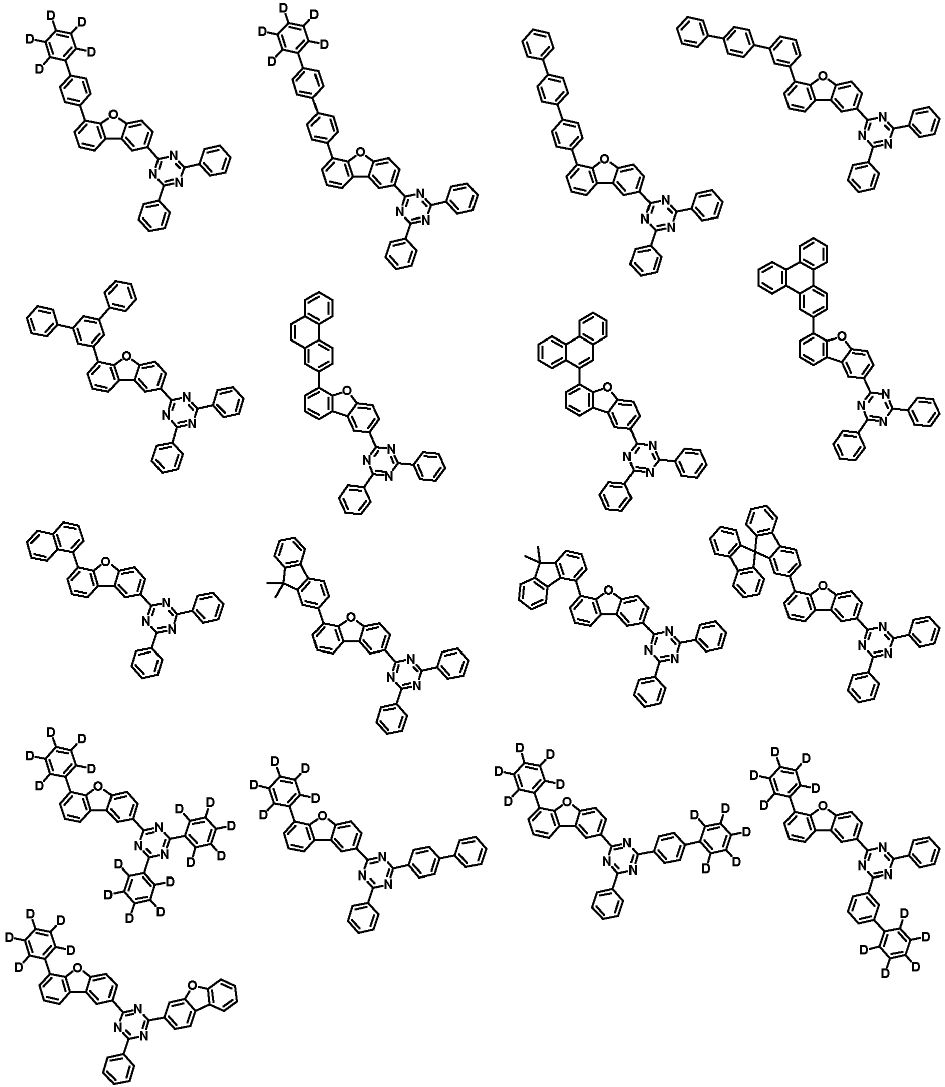

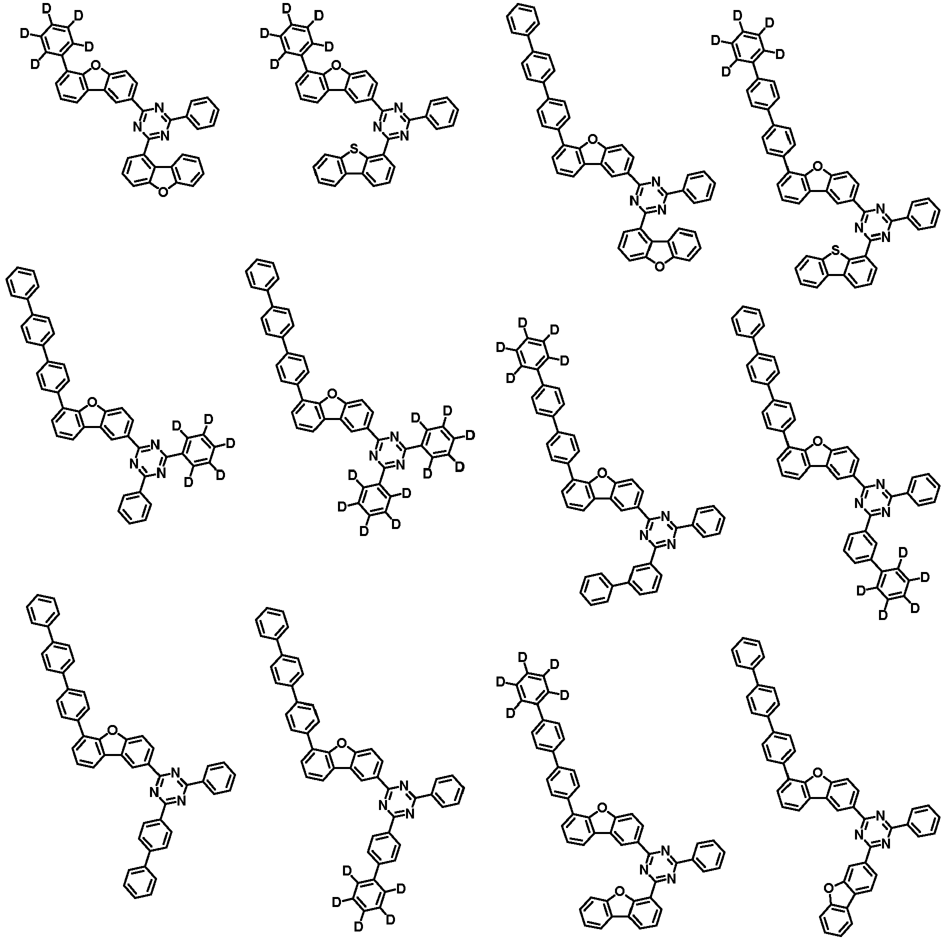

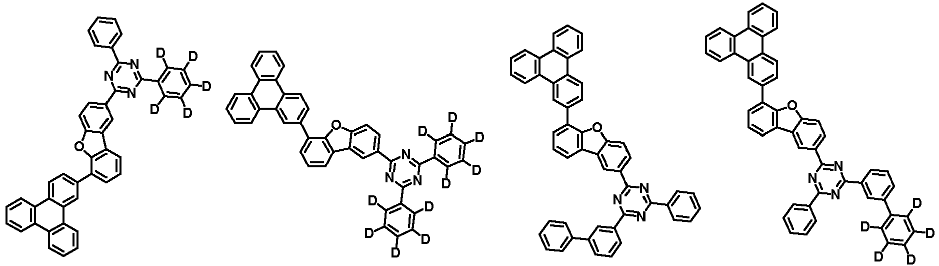

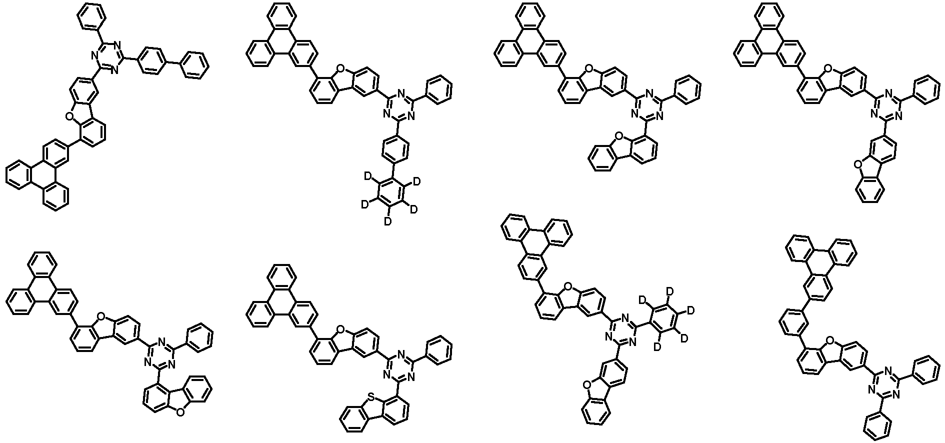

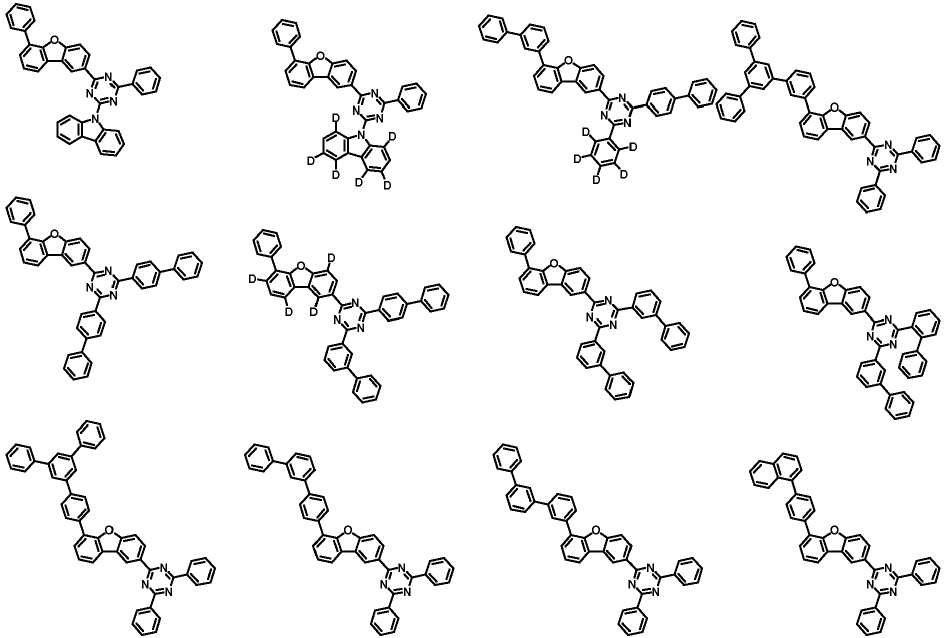

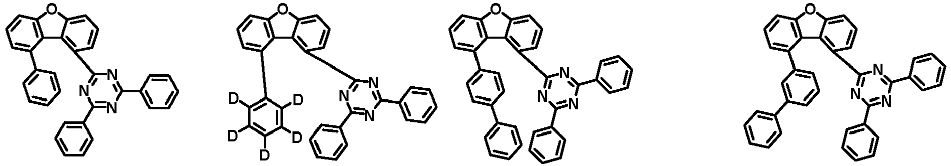

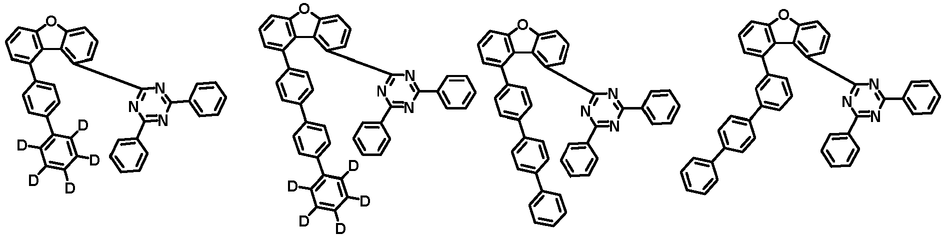

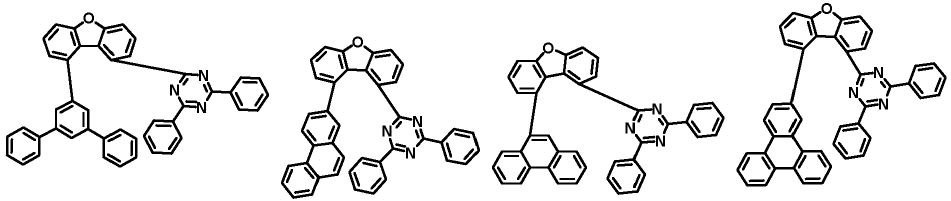

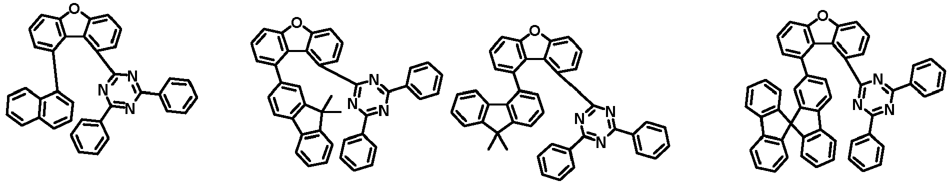

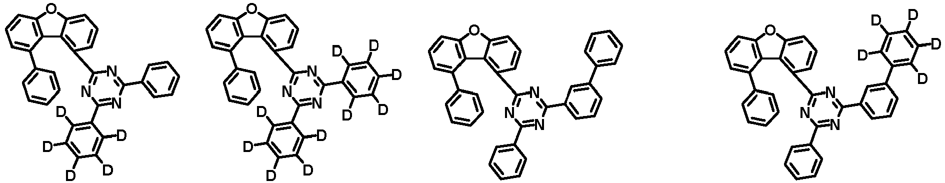

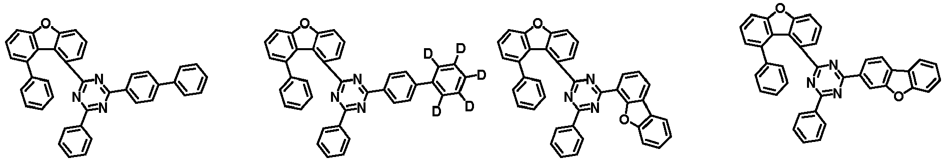

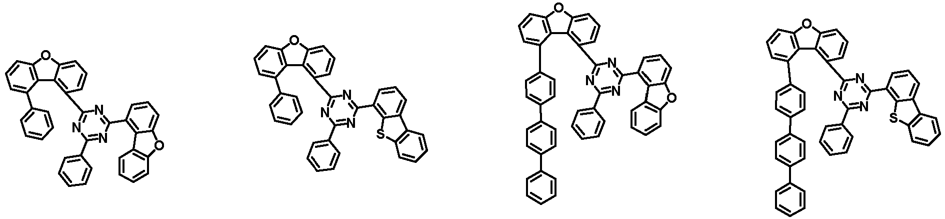

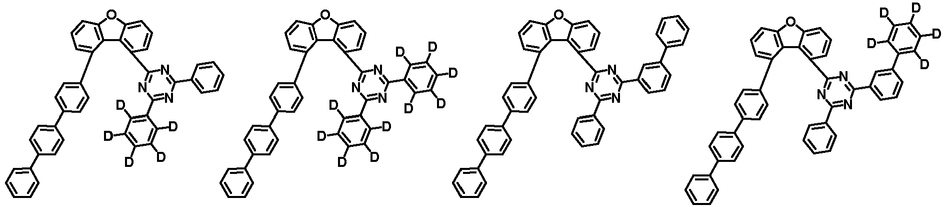

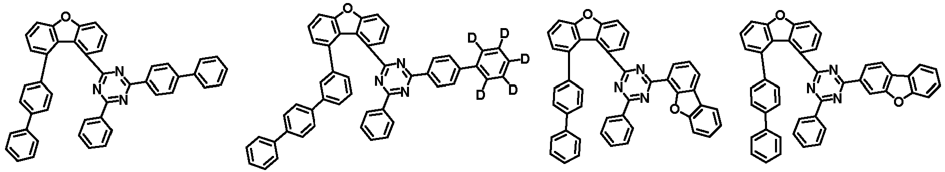

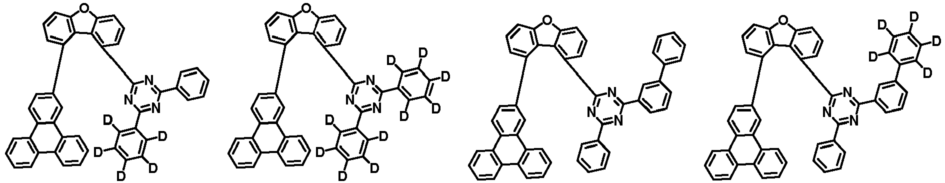

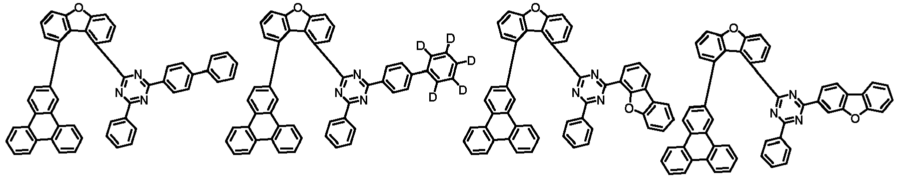

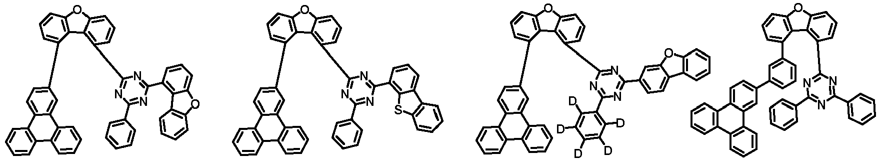

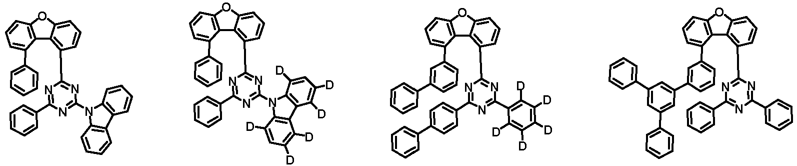

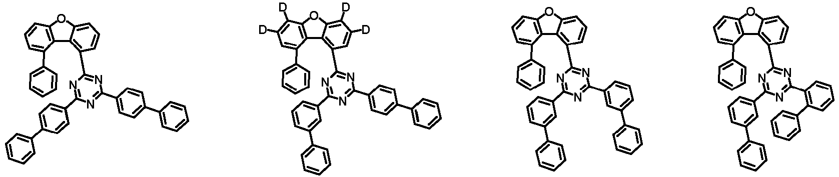

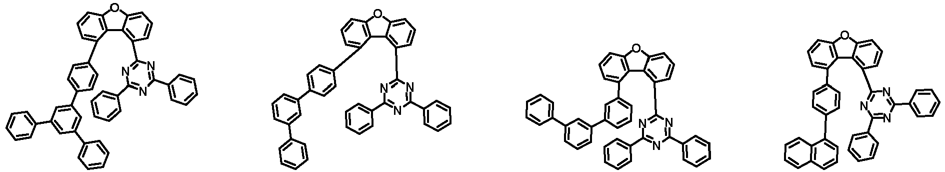

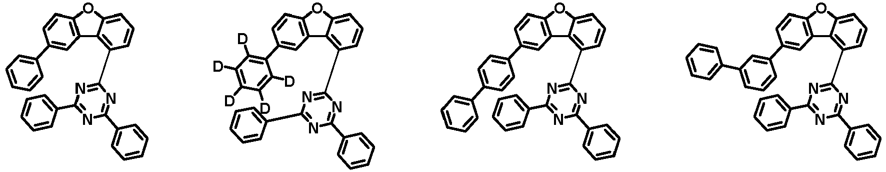

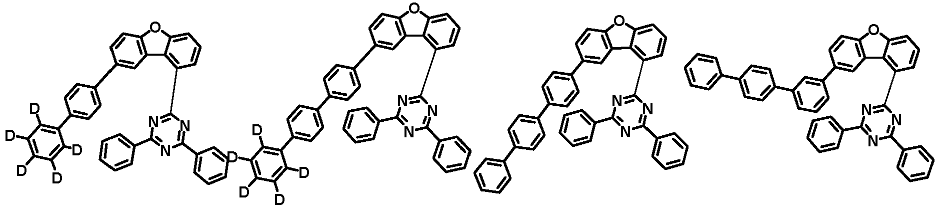

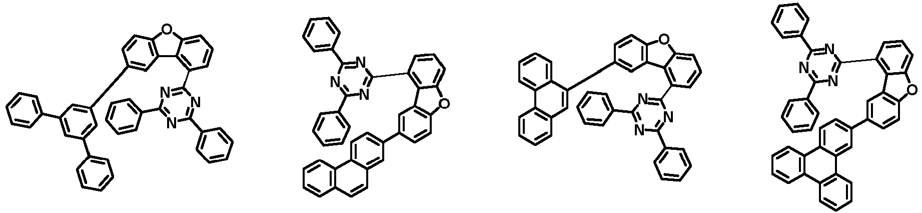

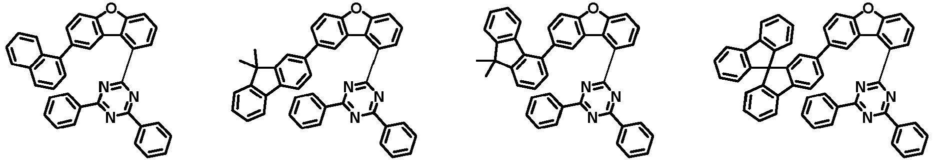

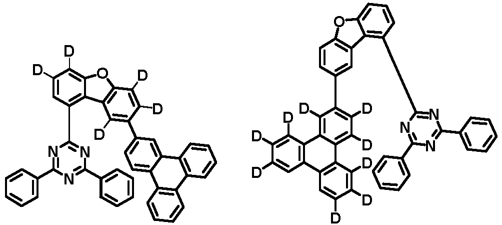

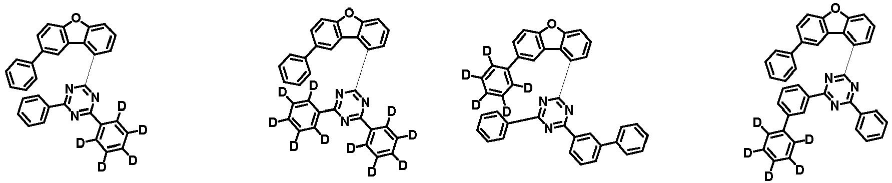

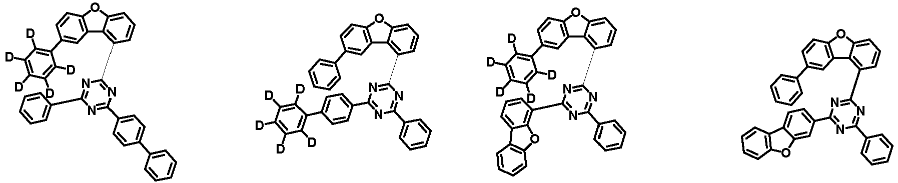

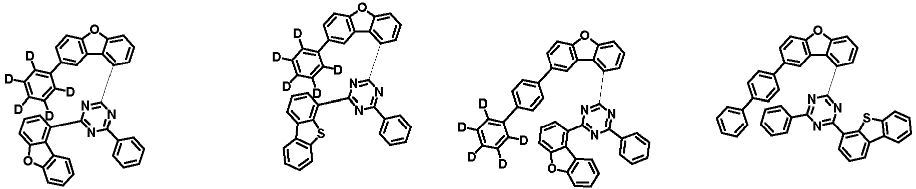

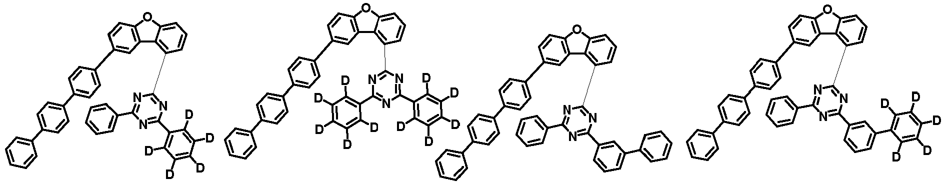

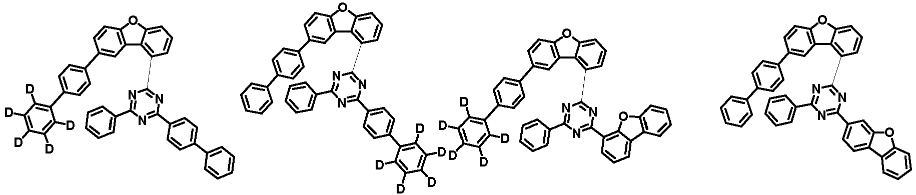

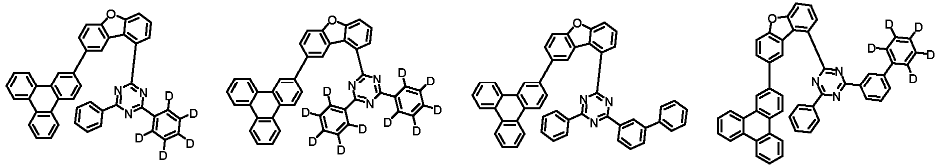

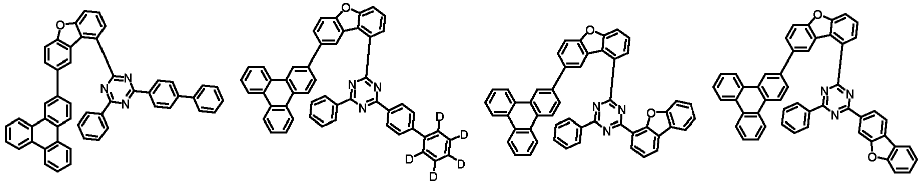

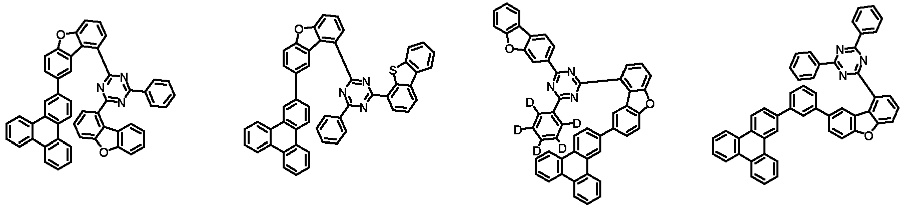

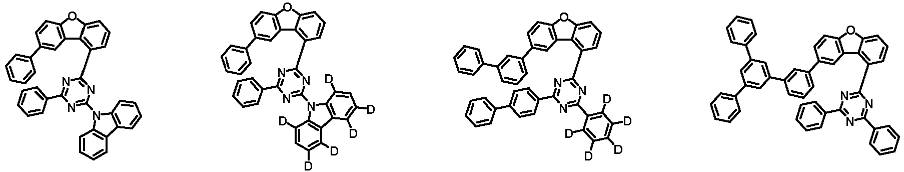

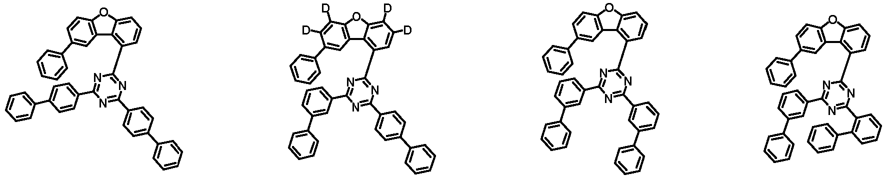

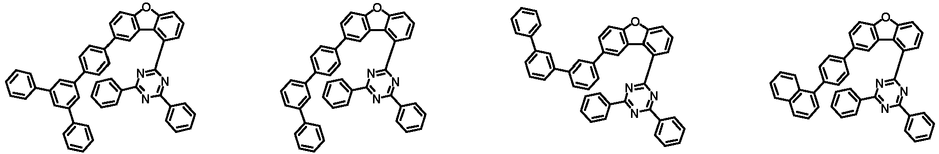

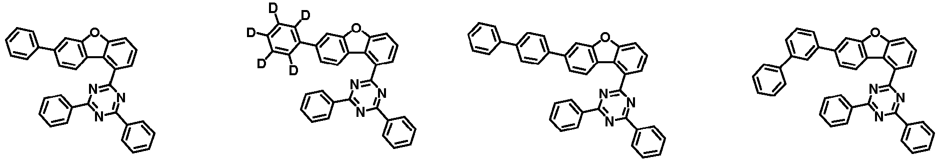

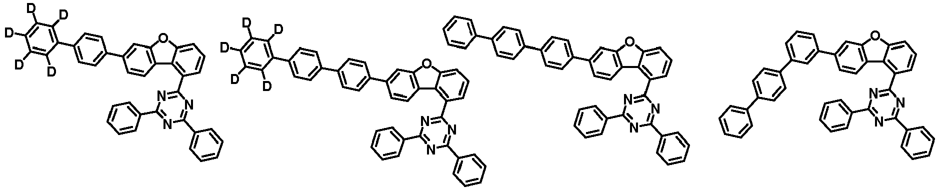

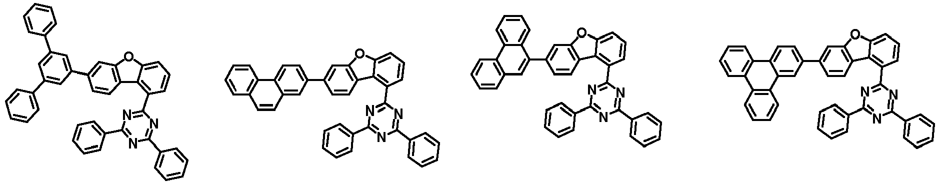

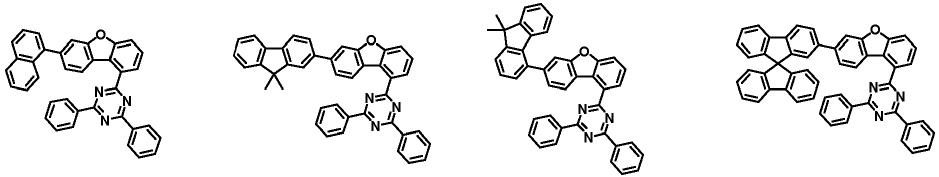

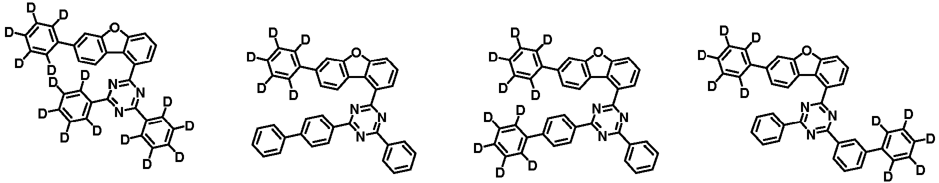

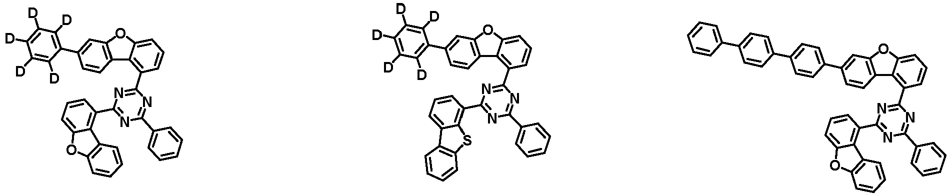

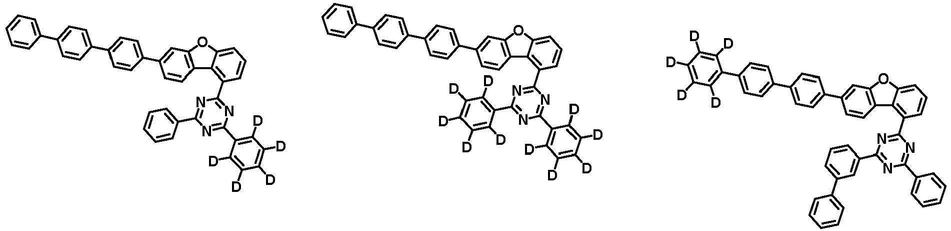

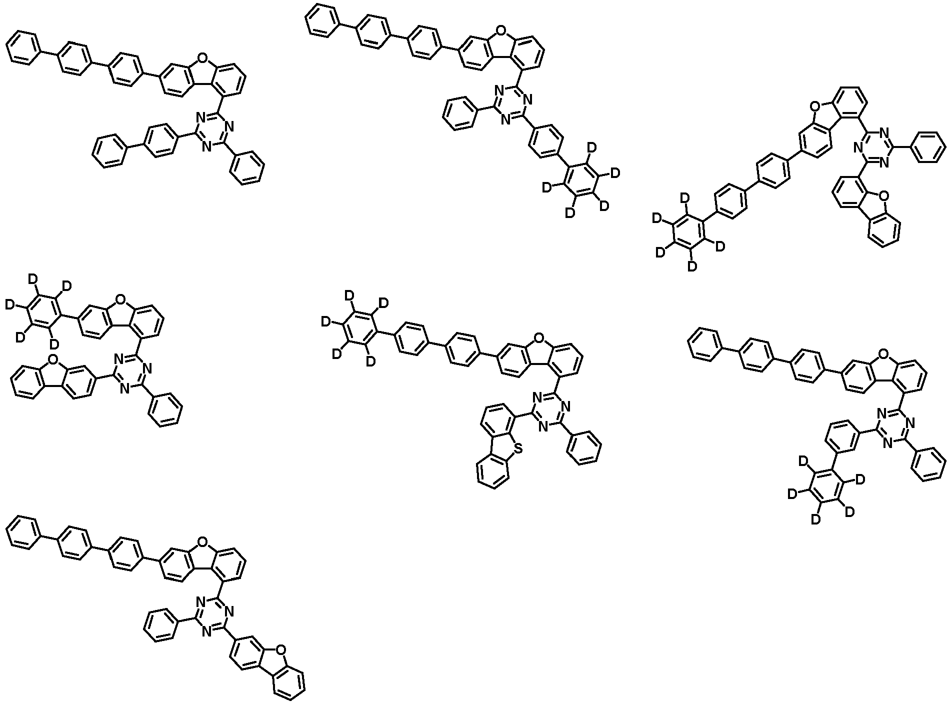

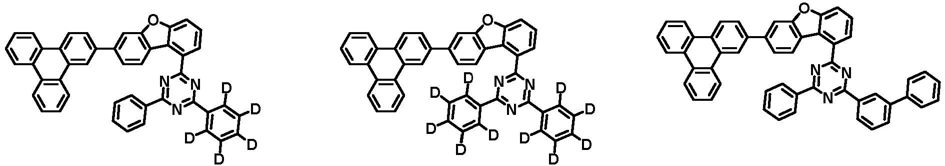

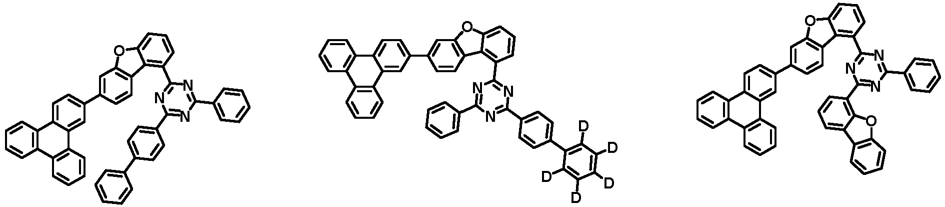

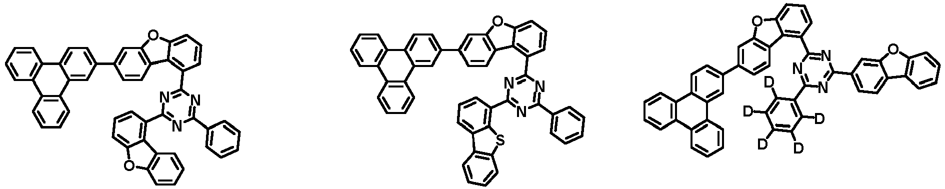

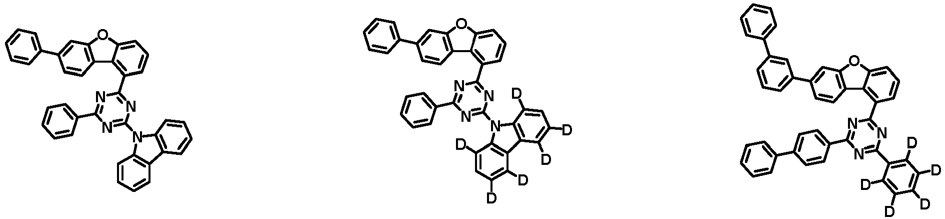

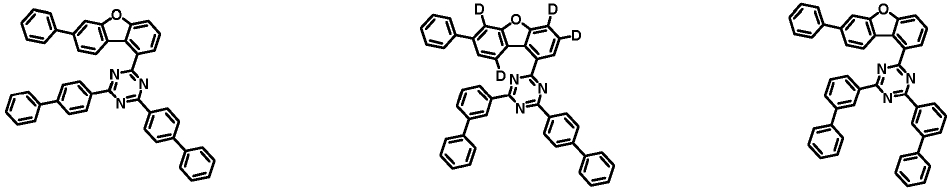

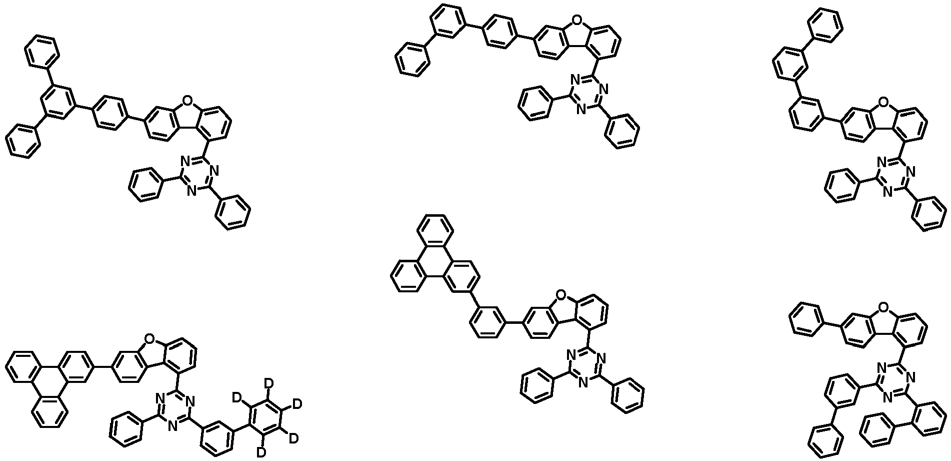

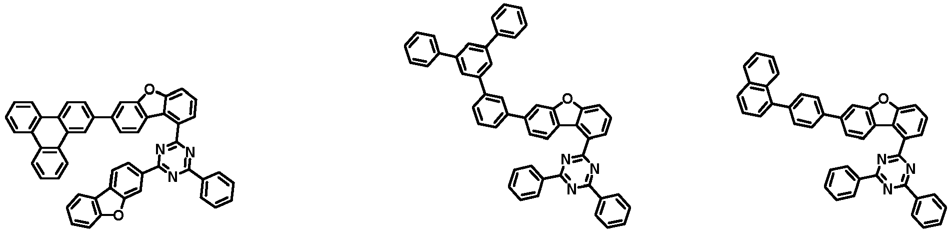

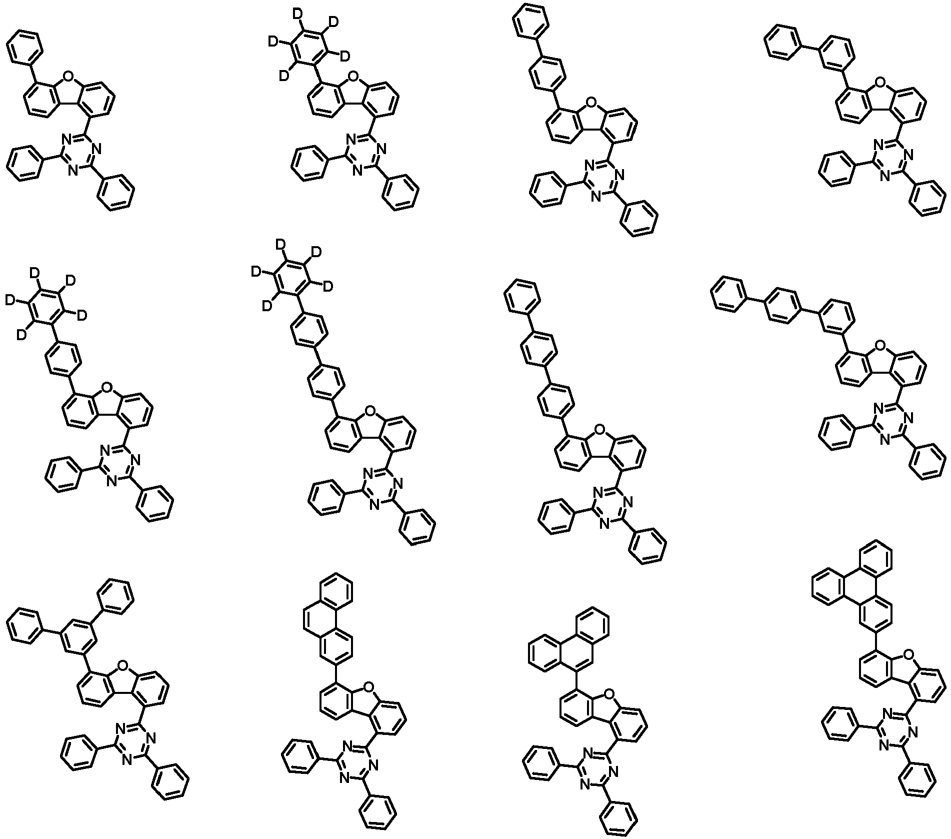

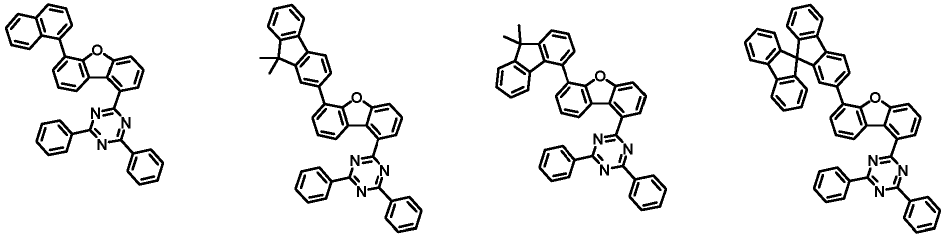

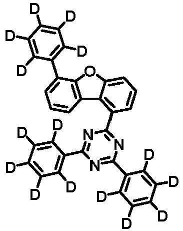

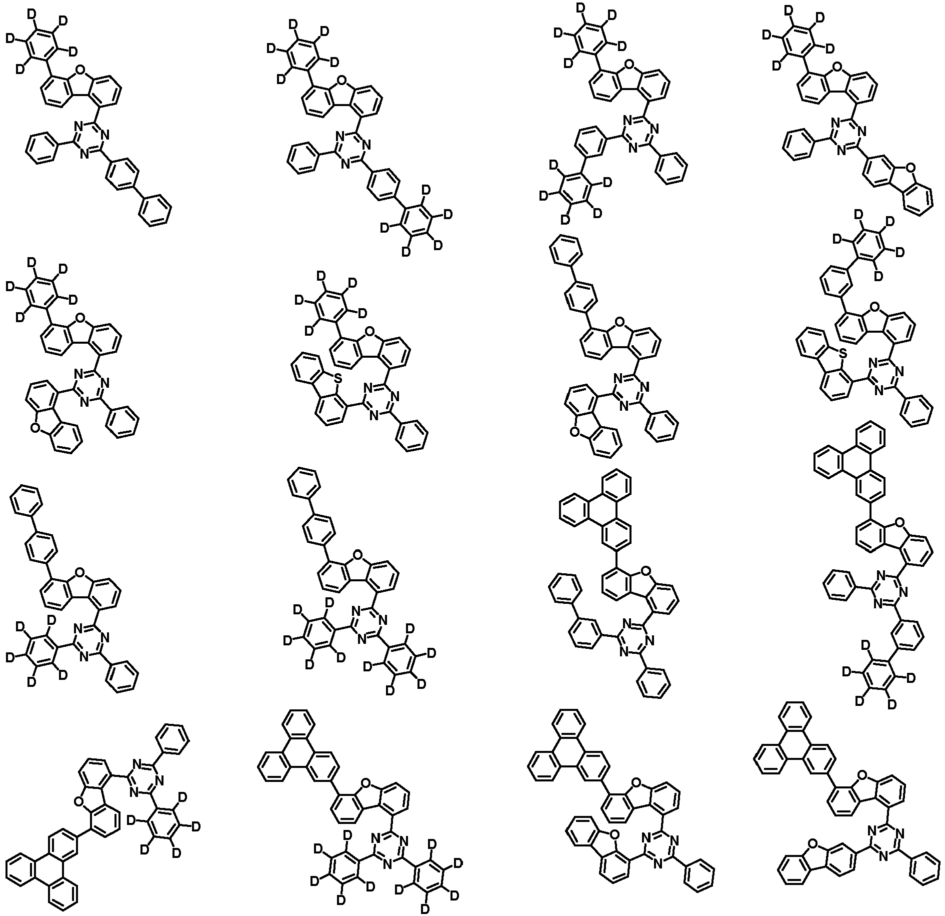

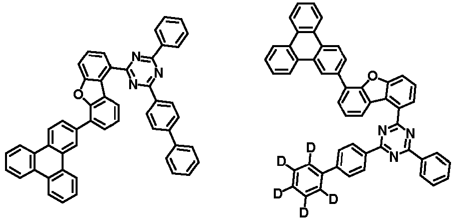

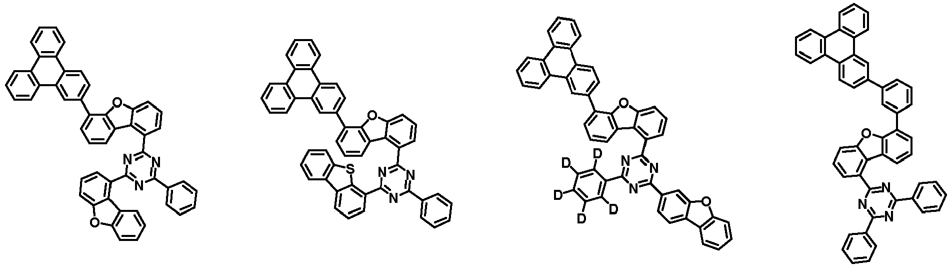

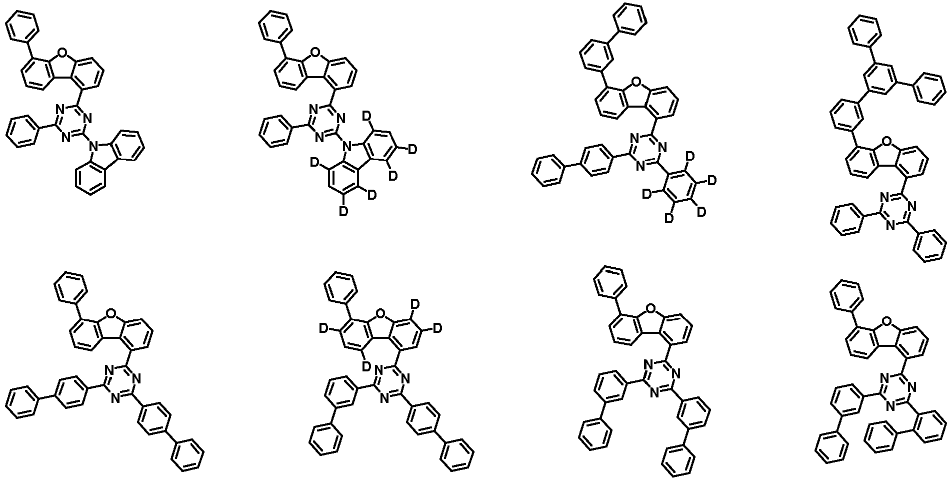

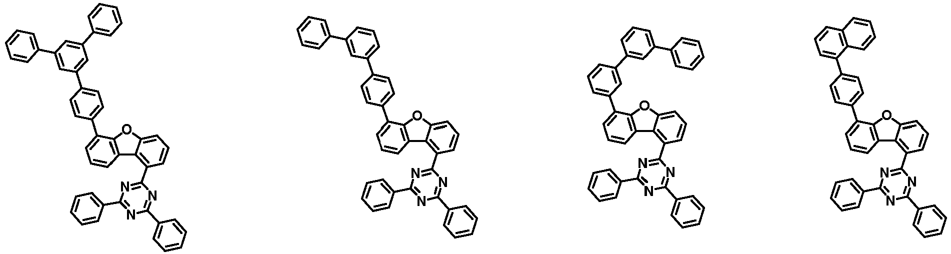

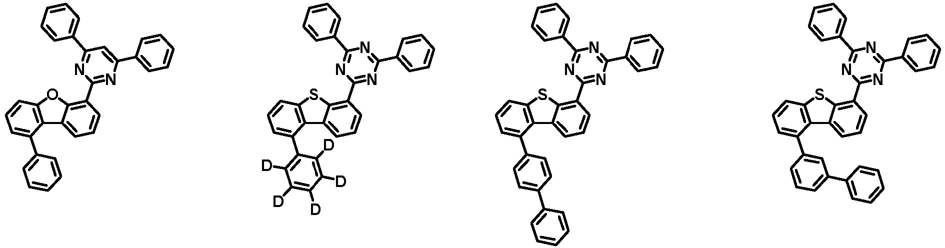

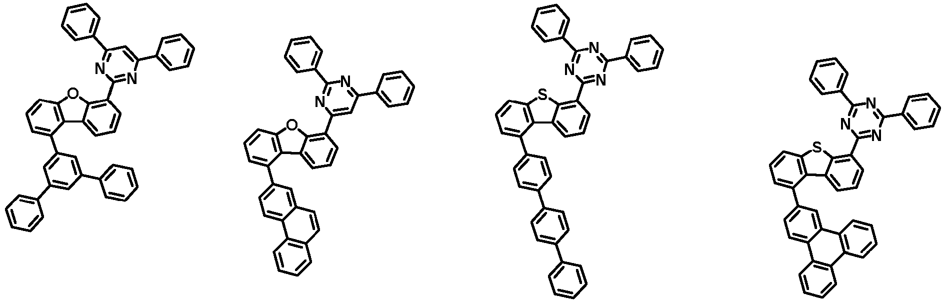

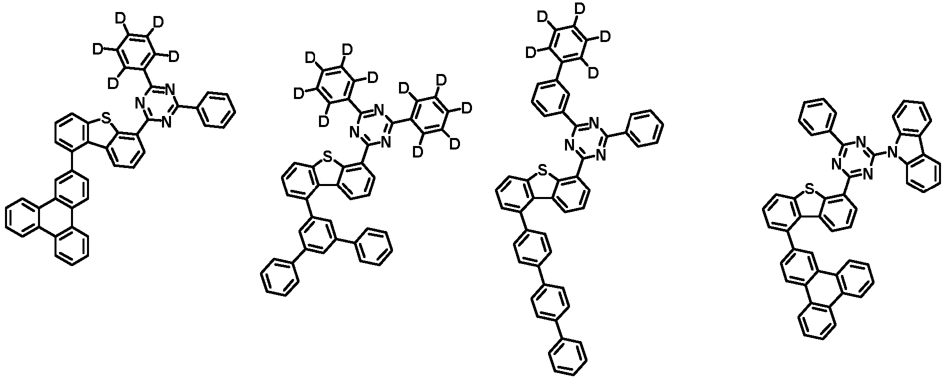

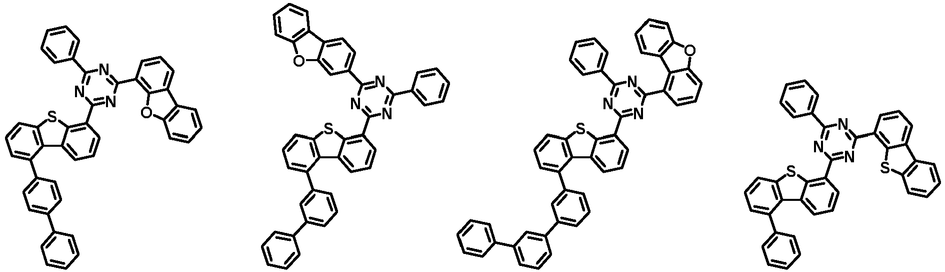

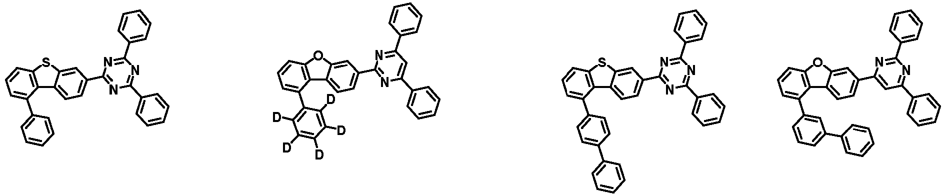

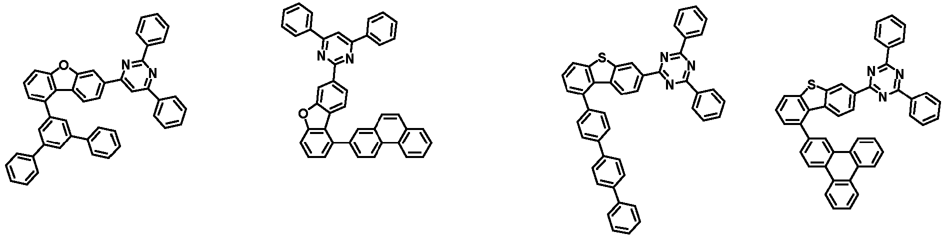

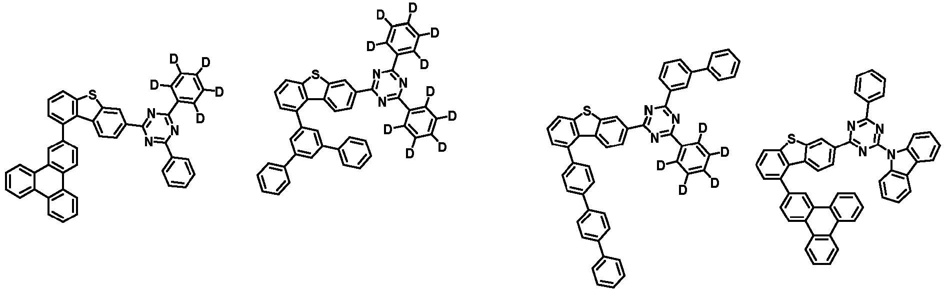

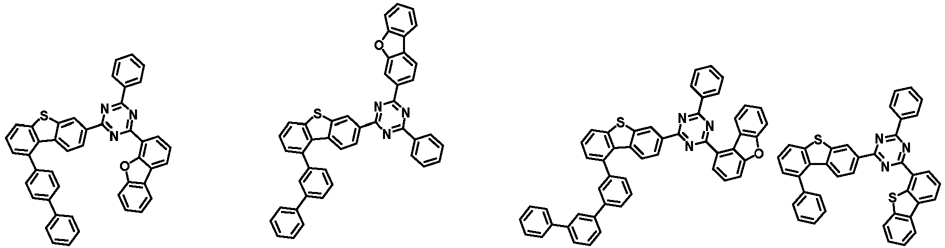

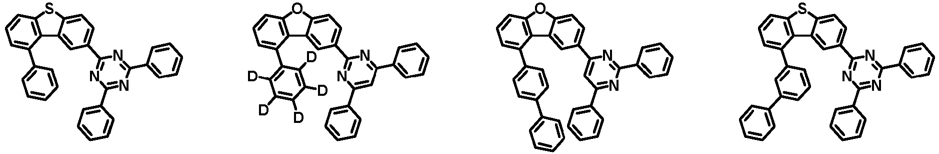

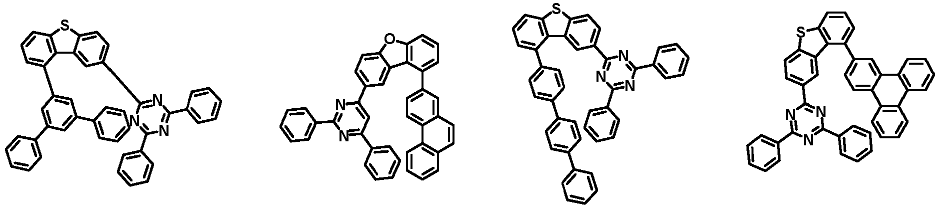

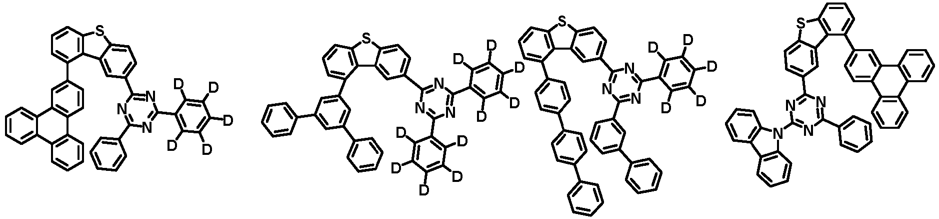

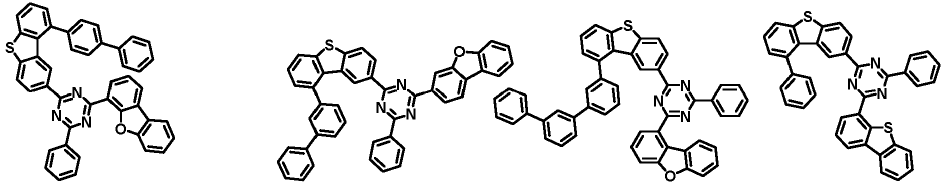

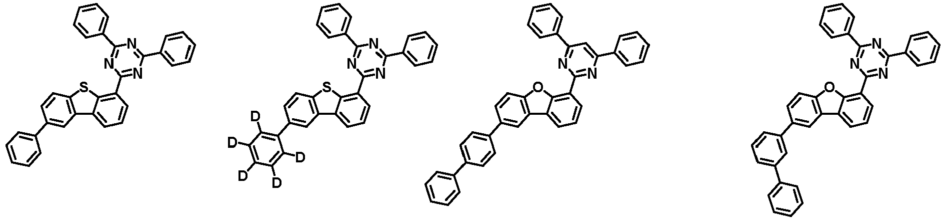

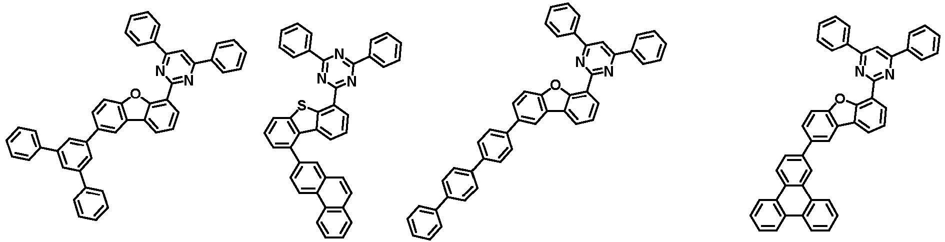

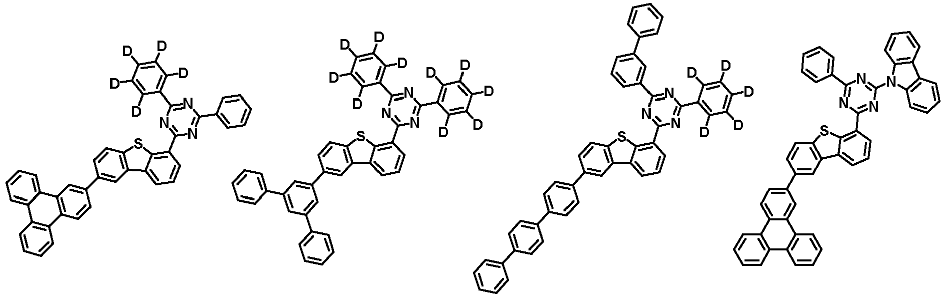

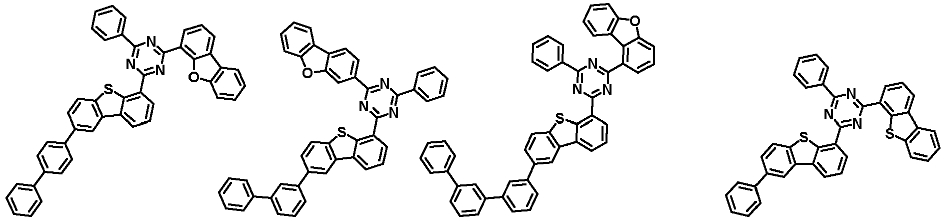

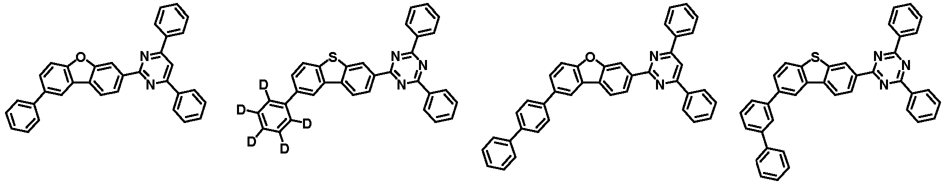

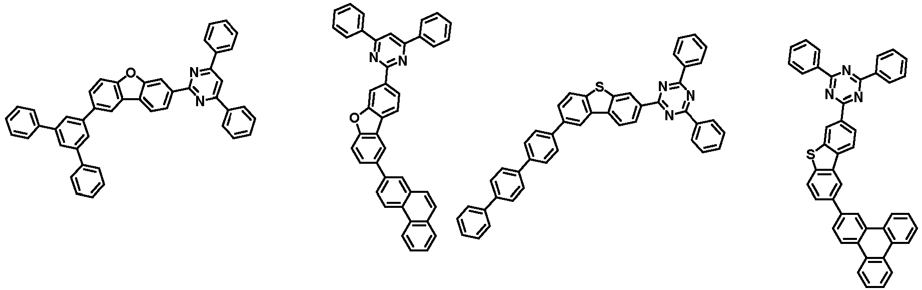

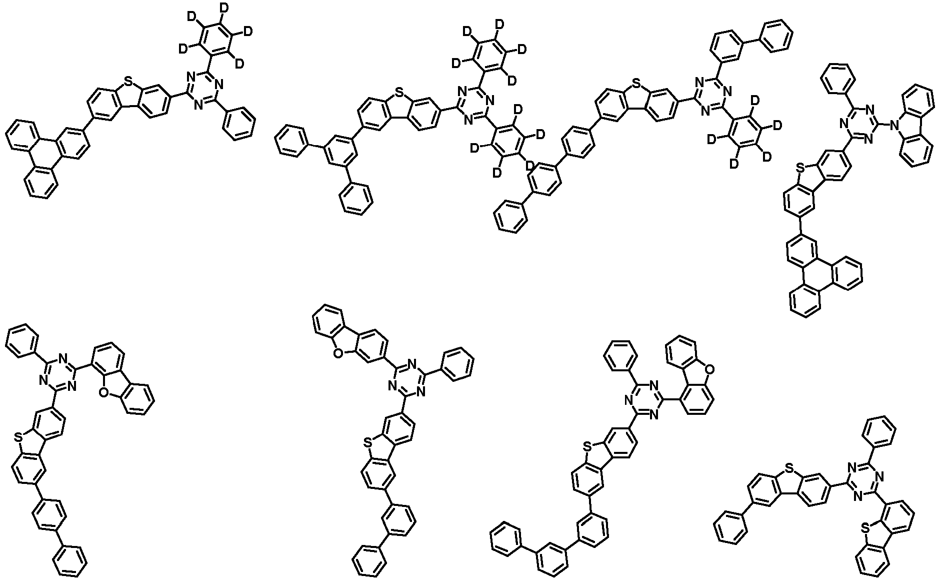

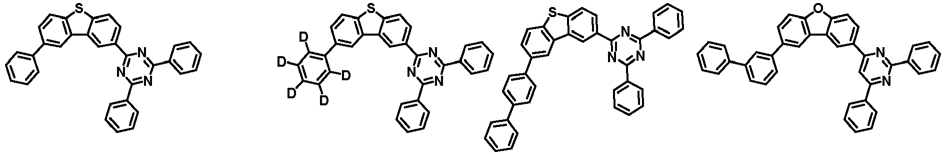

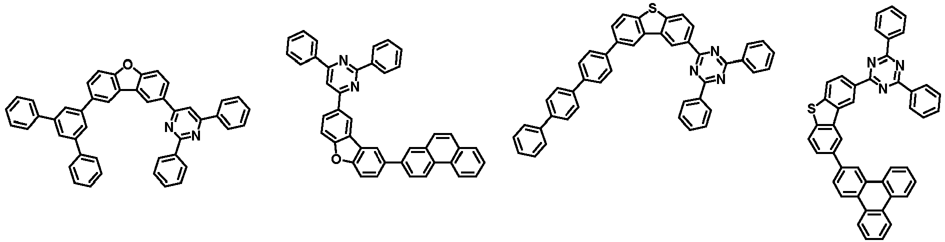

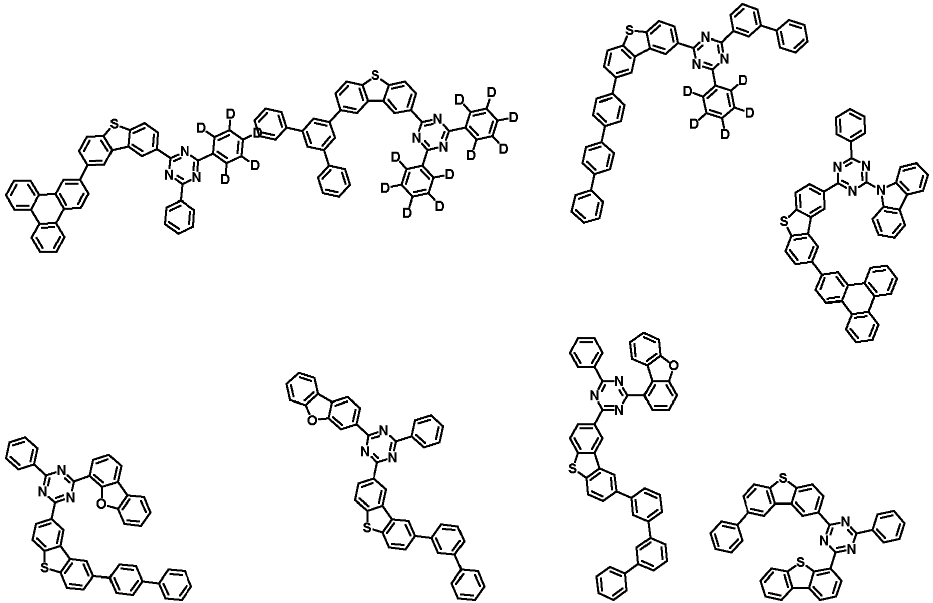

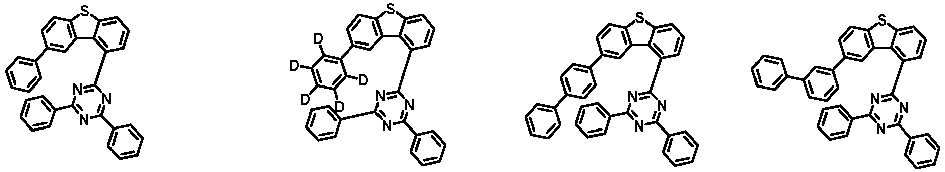

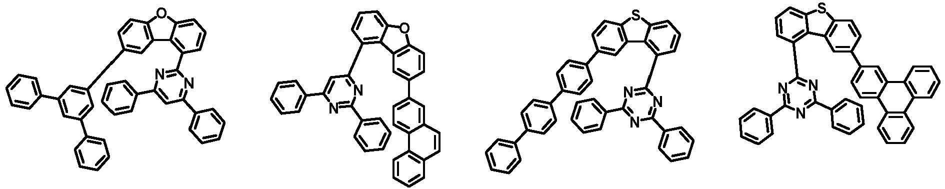

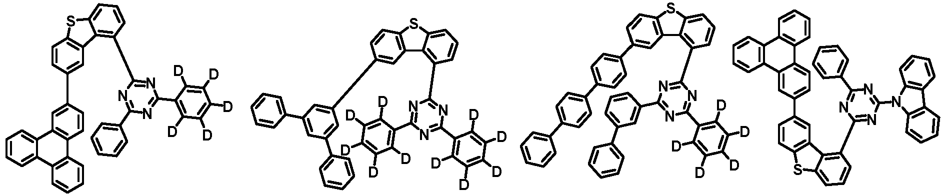

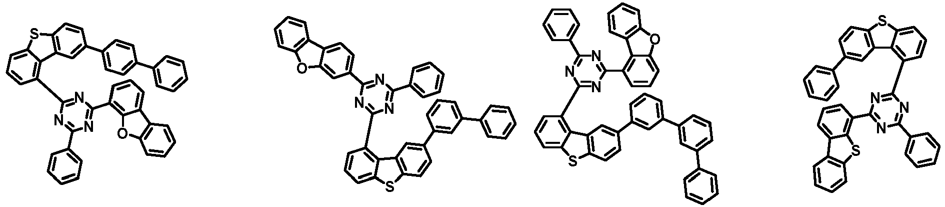

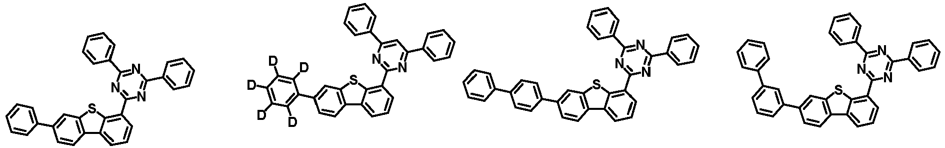

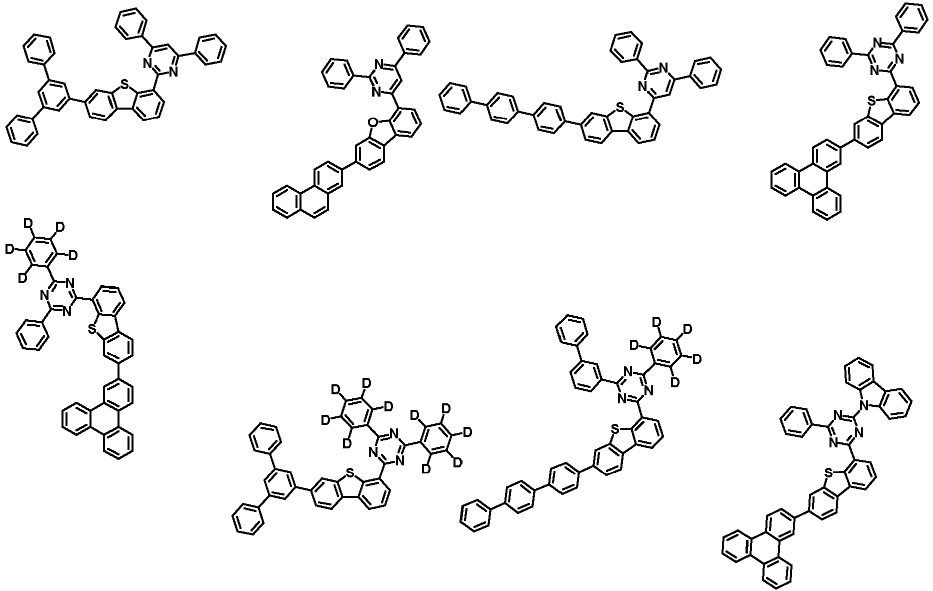

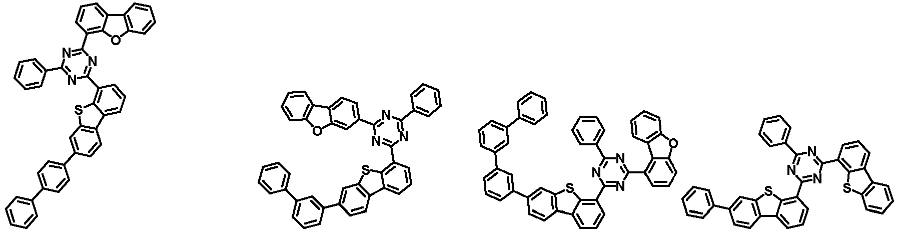

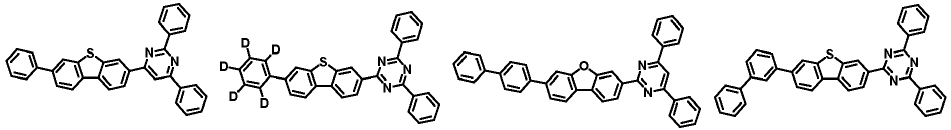

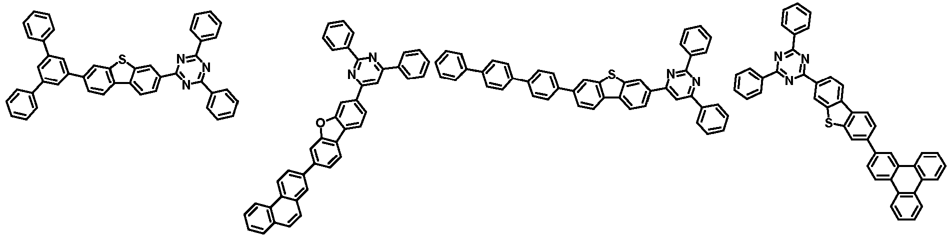

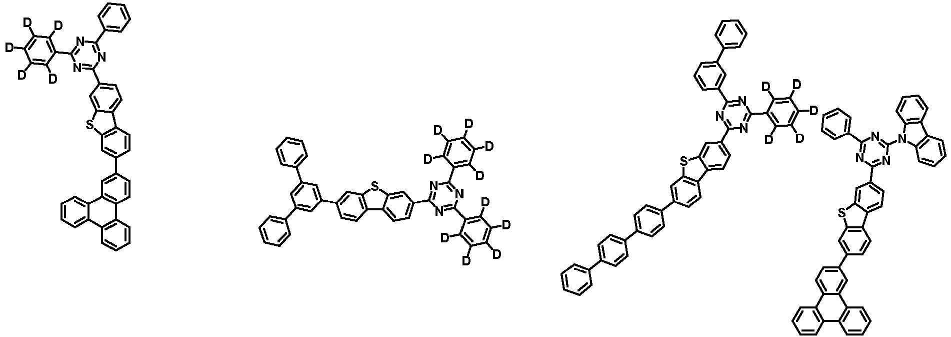

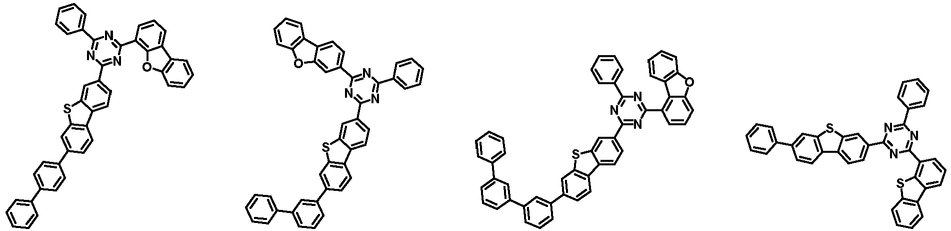

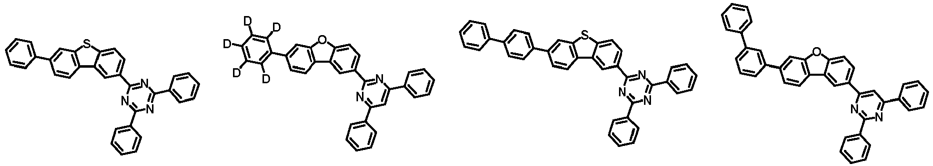

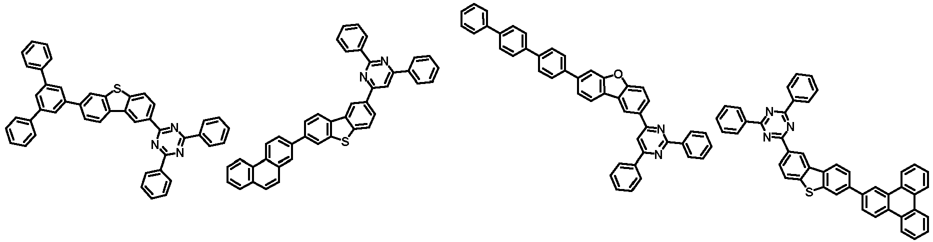

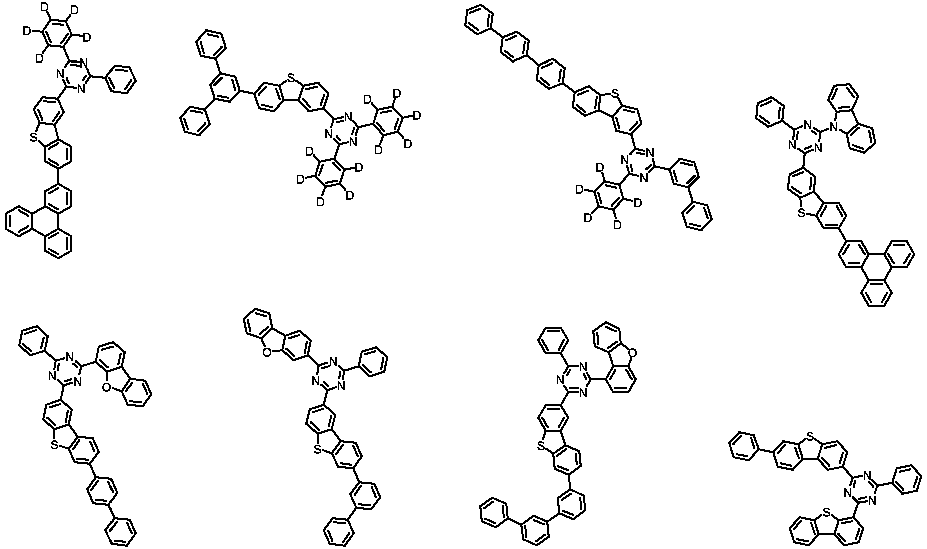

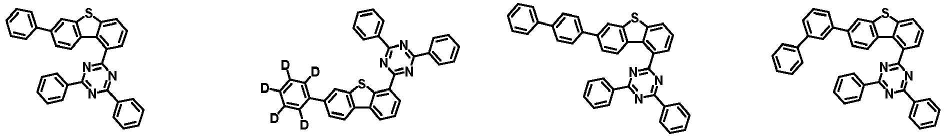

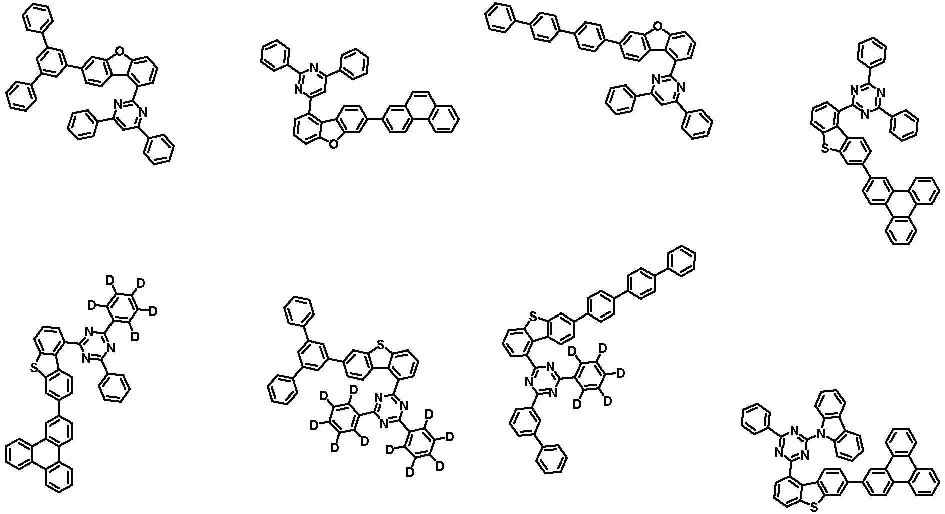

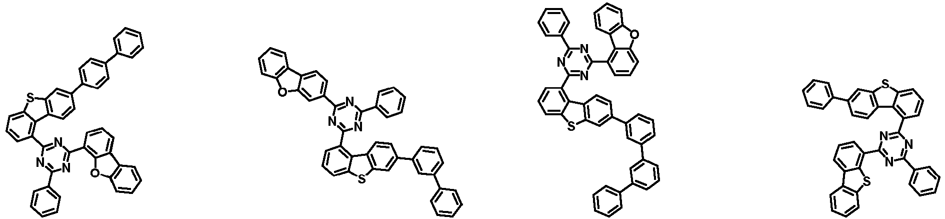

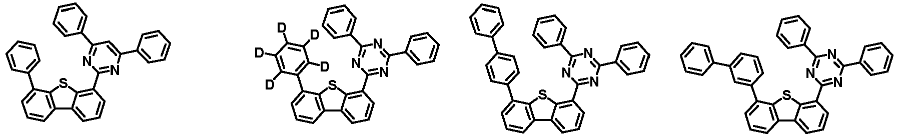

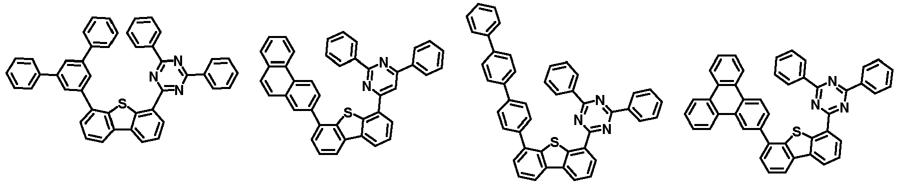

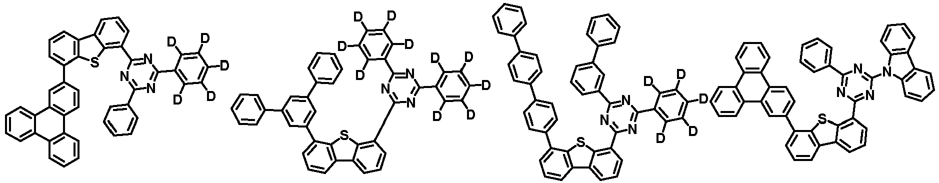

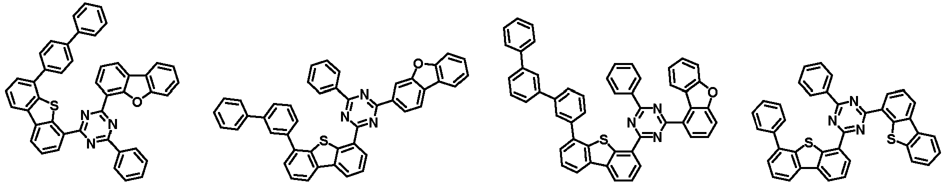

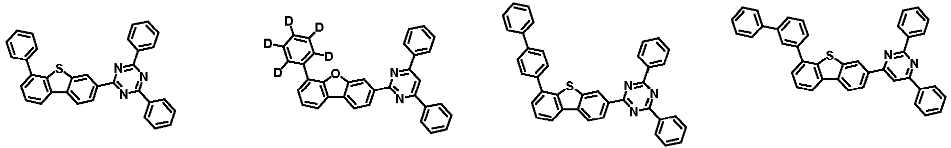

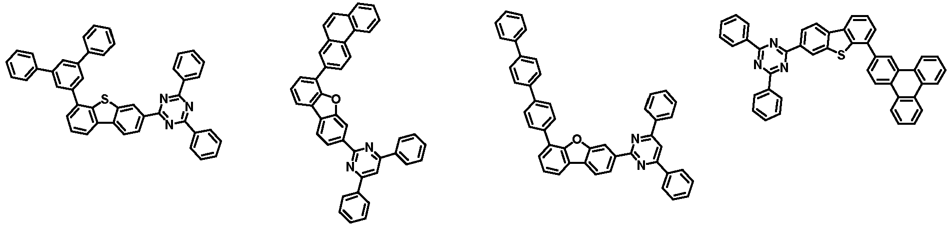

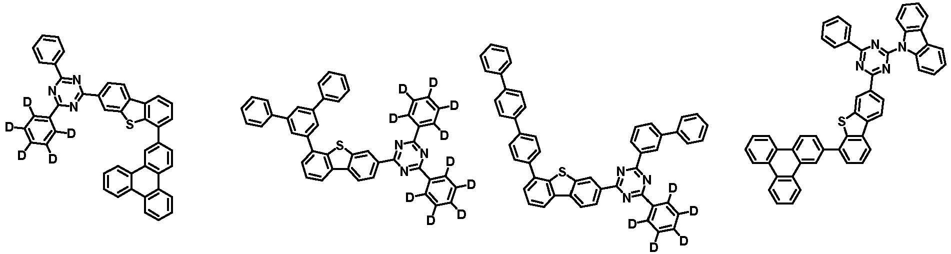

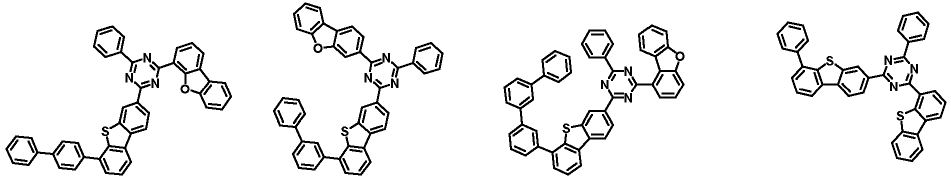

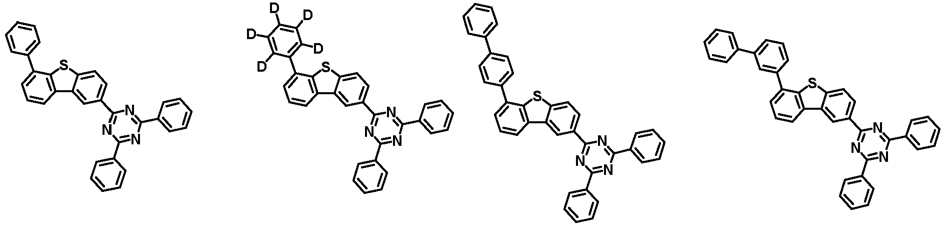

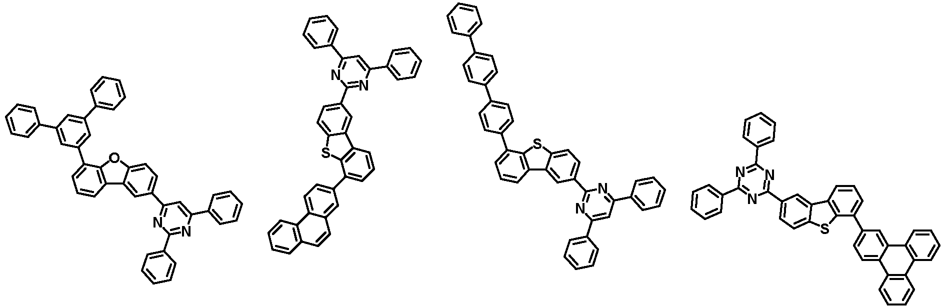

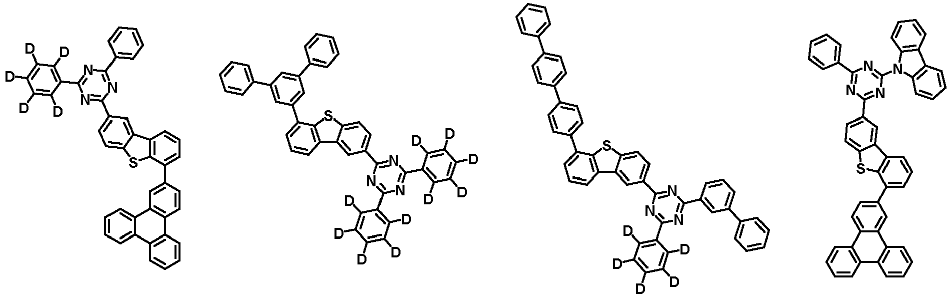

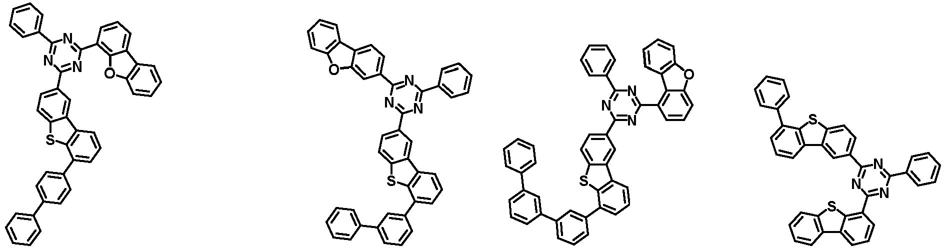

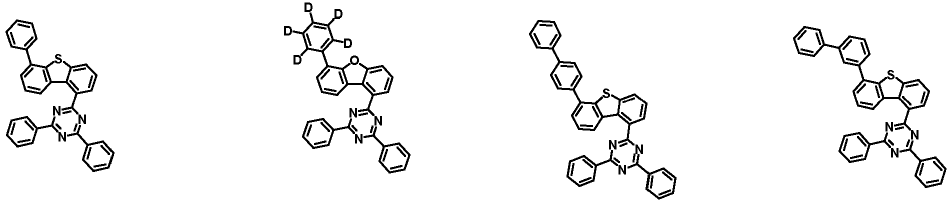

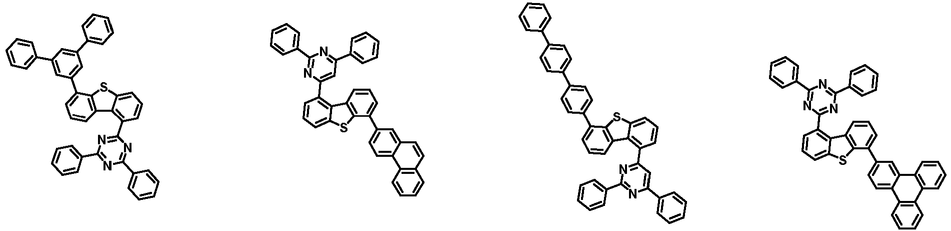

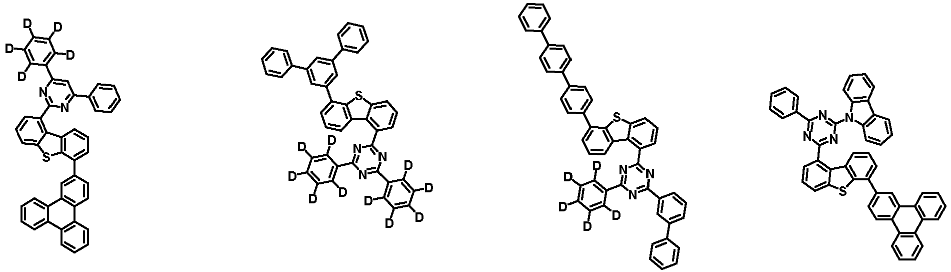

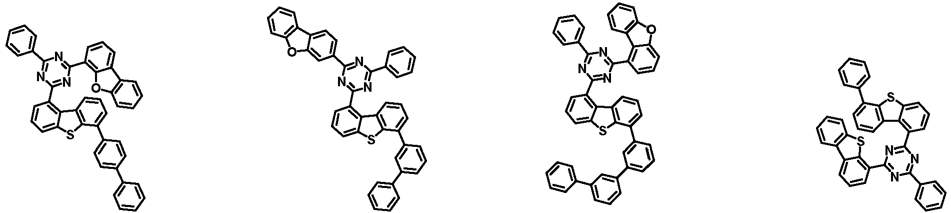

The compound represented by Chemical Formula 1 can be prepared by a preparation method as follows as an example. 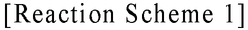 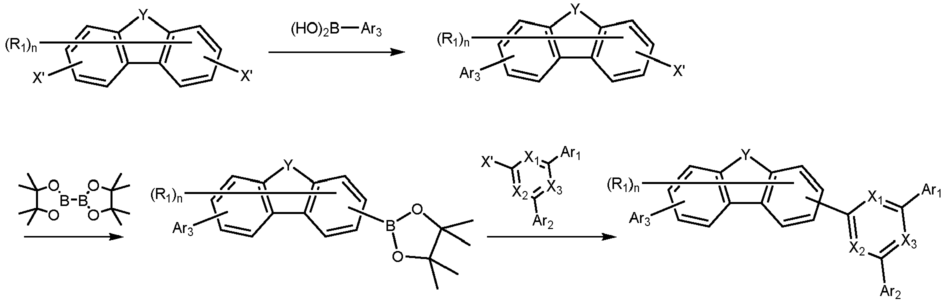 wherein, in Reaction Scheme 1, the definition of the remaining substituents except for X' are the same as defined above, and X' is halogen, more preferably chloro or bromo.

Reaction Scheme 1 is a Suzuki coupling reaction, which is preferably carried out in the presence of a palladium catalyst and a base, and a reactive group for the Suzuki coupling reaction can be modified as known in the art.

The preparation method of the compound represented by Chemical Formula 1 can be further embodied in Preparation Examples described hereinafter.

The compound represented by Chemical Formula 2 is characterized in that it has at least one deuterium.

That is, in Chemical Formula 2, at least one of R'₁ is deuterium; at least one of R'₁ is deuterium, at least one substituent of Ar'₁ and Ar'₂ includes at least one deuterium; or when R'₁ is not all deuterium, at least one substituent of Ar'₁ and Ar'₂ may include at least one deuterium.

The Chemical Formula 2 may be represented by any one of the following Chemical Formulas 2-1 to 2-4: 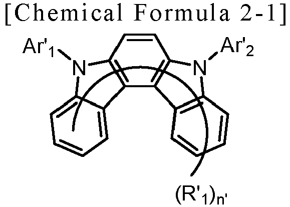 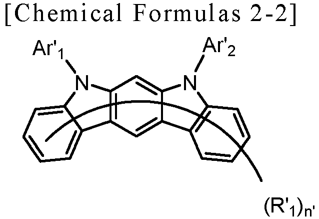 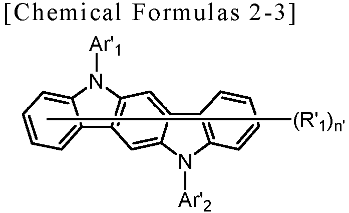 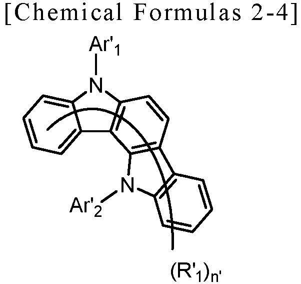
wherein, in Chemical Formula 2-1 to Chemical Formula 2-4,
n', R'₁, Ar'₁, and Ar'₂ are as defined in Chemical Formula 2.

Preferably, each R'₁ is independently hydrogen or deuterium.

Preferably, Ar'₁ and Ar'₂ are each independently a substituted or unsubstituted C₆₋₂₁ aryl; or a substituted or unsubstituted C₂₋₂₀ heteroaryl containing any one or more heteroatoms selected from the group consisting of N, O and S.

Preferably, Ar'₁ and Ar'₂ are each independently phenyl; biphenylyl; terphenylyl; dimethyl fluorenyl; dibenzofuranyl; or dibenzothiophenyl, the phenyl; biphenylyl; terphenylyl; dimethyl fluorenyl; dibenzofuranyl; or dibenzothiophenyl may be each independently unsubstituted or substituted with one or more substituents of deuterium, methyl, dimethylfluorenyl, dibenzofuranyl, or dibenzothiophenyl.

Preferably, Ar'₁ and Ar'₂ are each independently phenyl unsubstituted or substituted with 1 to 5 deuteriums; biphenylyl unsubstituted or substituted with 1 to 9 deuteriums; methyl-biphenylyl unsubstituted or substituted with 1 to 11 deuteriums; dimethyl-biphenylyl unsubstituted or substituted with 1 to 13 deuteriums; terphenylyl unsubstituted or substituted with 1 to 13 deuteriums; dimethylfluorenyl unsubstituted or substituted with 1 to 13 deuteriums; dibenzofuranyl unsubstituted or substituted with 1 to 7 deuteriums; dibenzothiophenyl unsubstituted or substituted with 1 to 7 deuteriums; dimethylfluorenyl-phenyl unsubstituted or substituted with 1 to 17 deuteriums; dibenzofuranyl-phenyl unsubstituted or substituted with 1 to 11 deuteriums; or dibenzothiophenyl-phenyl unsubstituted or substituted with 1 to 11 deuteriums.

As used herein, 'methyl-biphenylyl' means biphenylyl substituted with one methyl, and 'dimethyl-biphenylyl' means biphenylyl substituted with two methyls. Likewise, 'dimethylfluorenyl-phenyl' means phenyl substituted with one dimethyl fluorene, 'dibenzofuranyl-phenyl' means phenyl substituted with one dibenzofuran, and 'dibenzothiophenyl-phenyl' means phenyl substituted with one dibenzothiophene. 'Unsubstituted methyl-biphenylyl' means that all hydrogens contained in biphenylyl and methyl bonded to the biphenylyl are not substituted, and 'methyl-biphenylyl substituted with 1 to 11 deuterium' means that 1 to 11 of the total hydrogens contained in the methyl-biphenylyl are substituted with deuterium. That is, in 'methyl-biphenylyl substituted with one deuterium', deuterium may be included in biphenylyl or methyl bonded to biphenylyl.

In one embodiment, n' is an integer from 6 to 10, R'₁ is deuterium, Ar'₁ and Ar'₂ are each independently phenyl unsubstituted or substituted with 1 to 5 deuteriums; biphenylyl unsubstituted or substituted with 1 to 9 deuteriums; methyl-biphenylyl unsubstituted or substituted with 1 to 11 deuteriums; dimethyl-biphenylyl unsubstituted or substituted with 1 to 13 deuteriums; terphenylyl unsubstituted or substituted with 1 to 13 deuteriums; dimethylfluorenyl unsubstituted or substituted with 1 to 13 deuteriums; dibenzofuranyl unsubstituted or substituted with 1 to 7 deuteriums; dibenzothiophenyl unsubstituted or substituted with 1 to 7 deuteriums; dimethylfluorenyl-phenyl unsubstituted or substituted with 1 to 17 deuterium; dibenzofuranyl-phenyl unsubstituted or substituted with 1 to 11 deuteriums; or dibenzothiophenyl-phenyl unsubstituted or substituted with 1 to 11 deuteriums.

Preferably, the deuterium substitution rate of Chemical Formula 2 is 60 to 100%. The deuterium substitution rate means the number of substituted deuterium contained in the Chemical Formula 2 relative to the total number of hydrogens that can be present in the Chemical Formula 2. Preferably, the deuterium substitution rate of Chemical Formula 3 is 65% or more, 70% or more, 75% or more, 80% or more, 85% or more, 90% or more, and 99% or less, 98% or less, 97% or less, 96% or less, 95% or less, 94% or less, 93% or less, or 92 % or less,

Representative examples of the compound represented by Chemical Formula 2 are as follows: 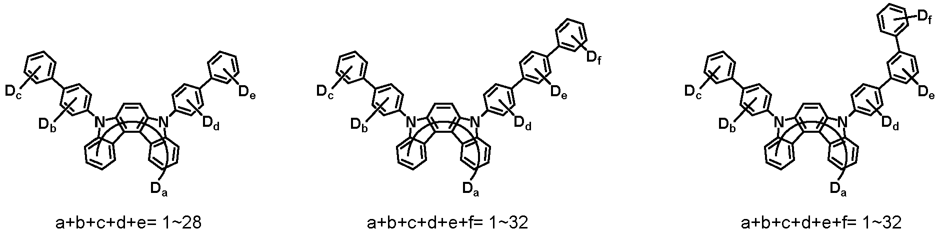 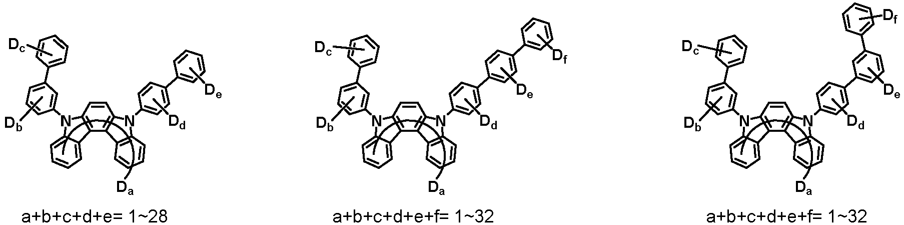 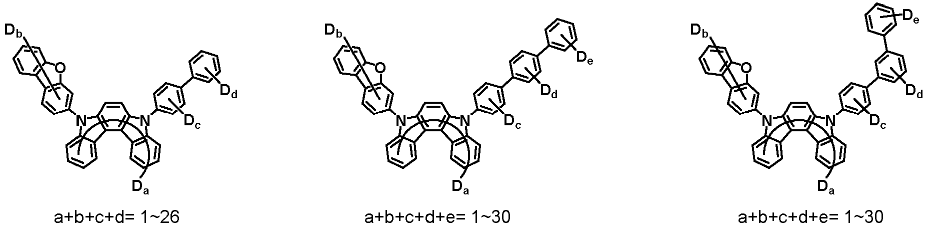 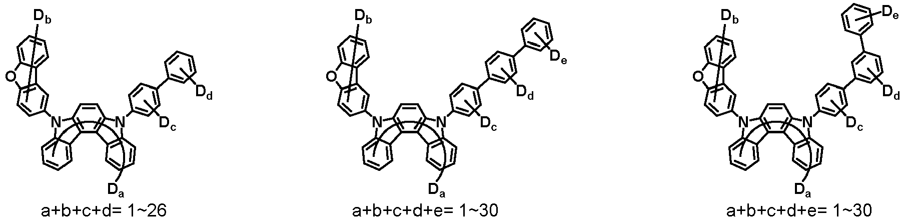 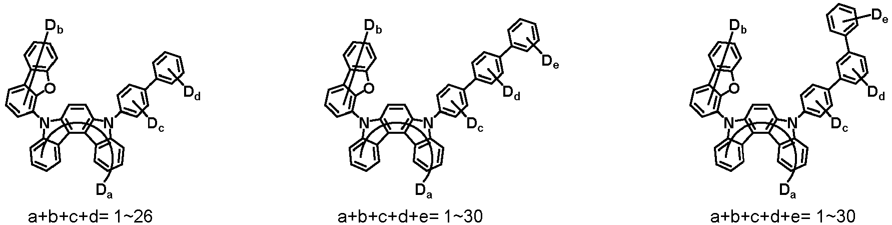 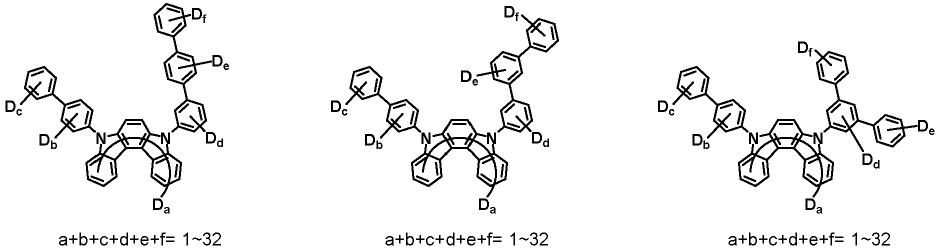 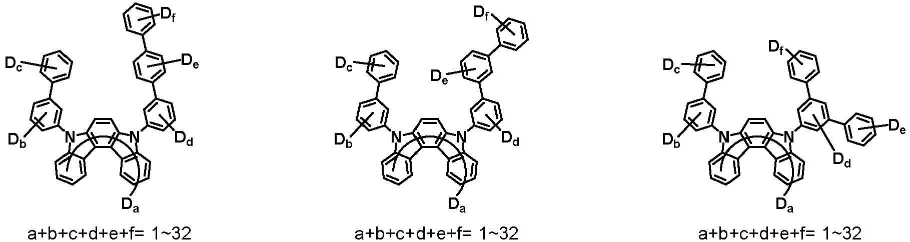 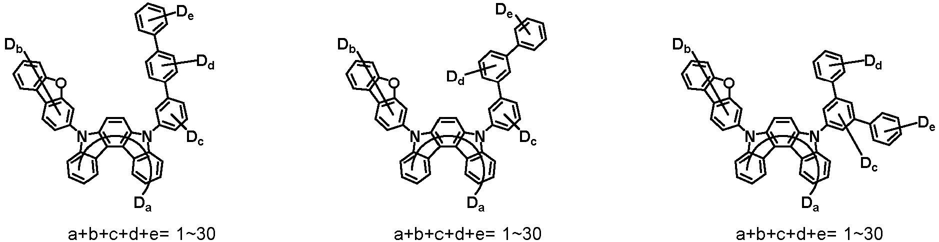 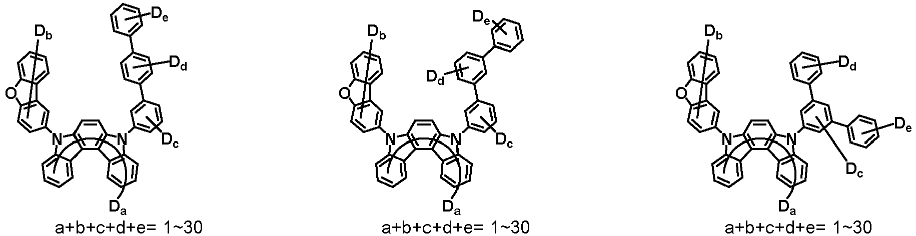 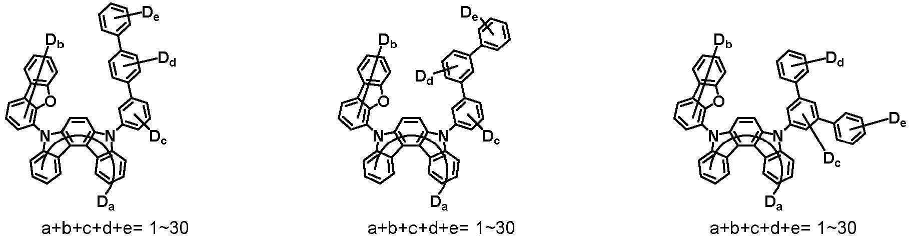 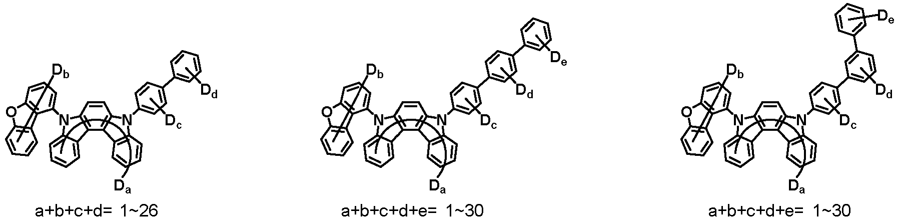 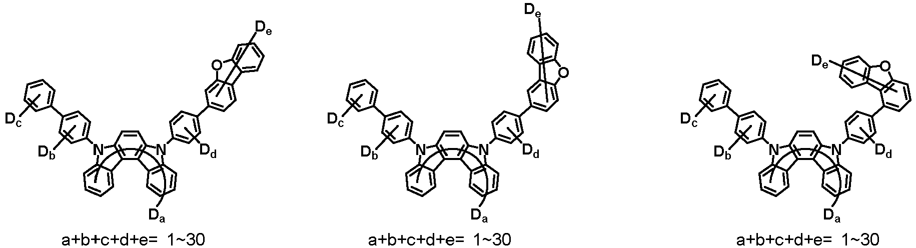 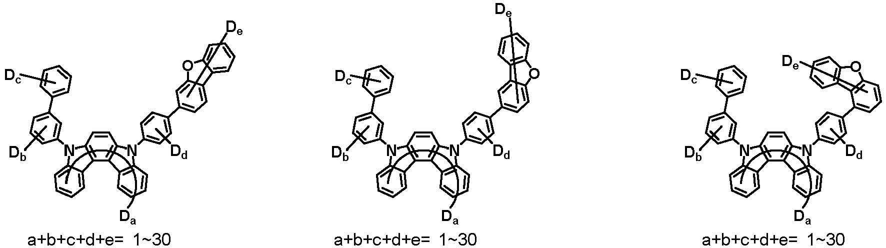 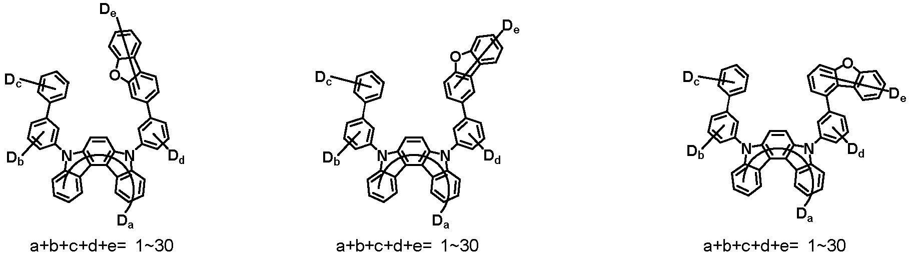 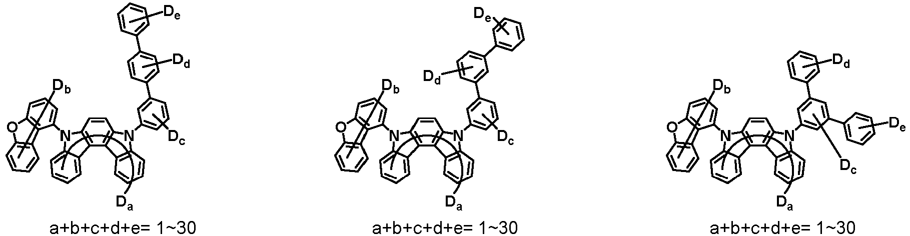 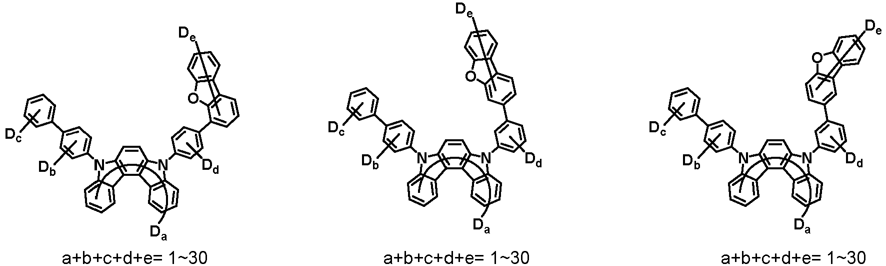 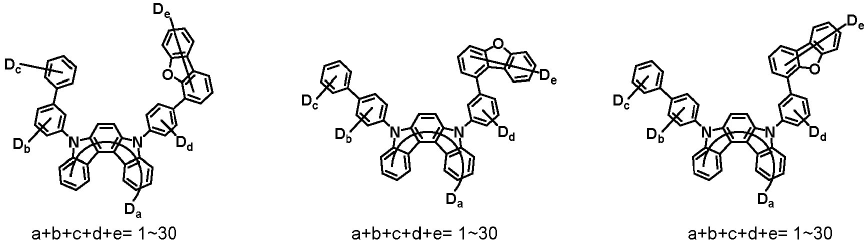 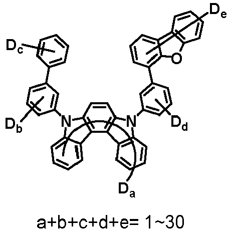 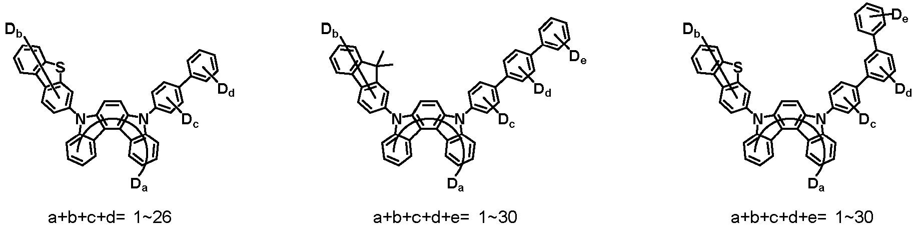 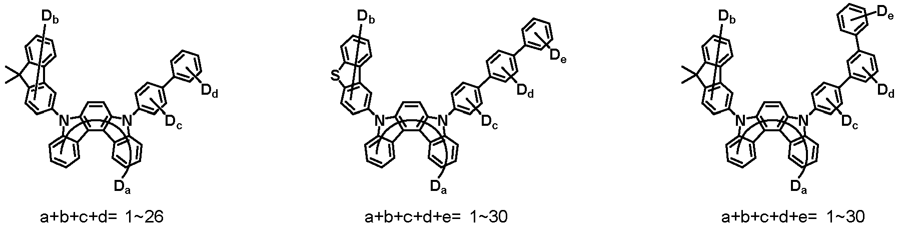 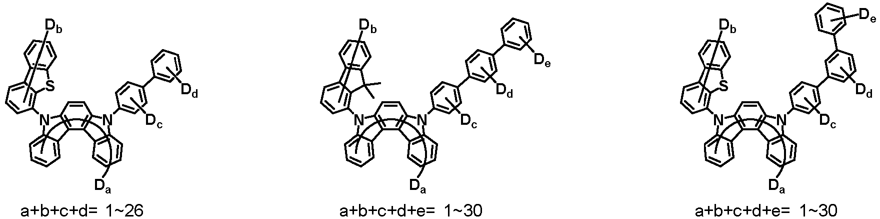 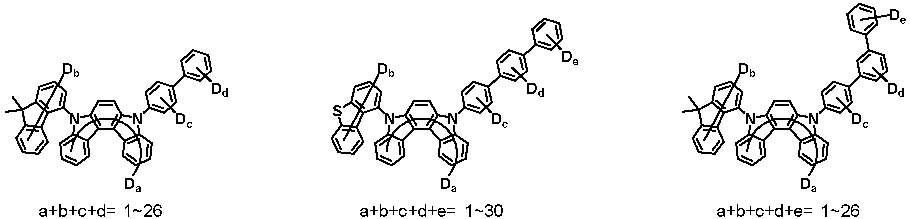 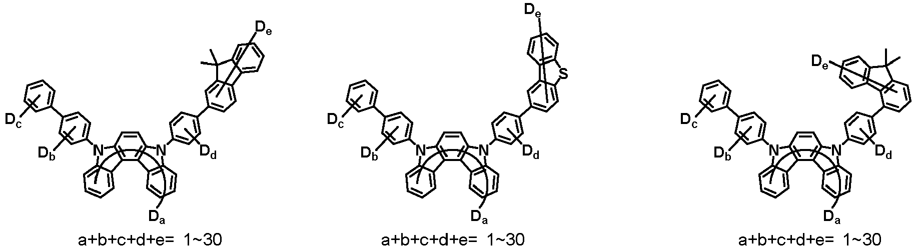 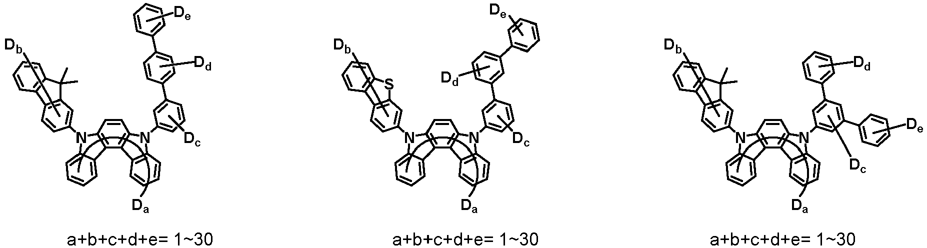 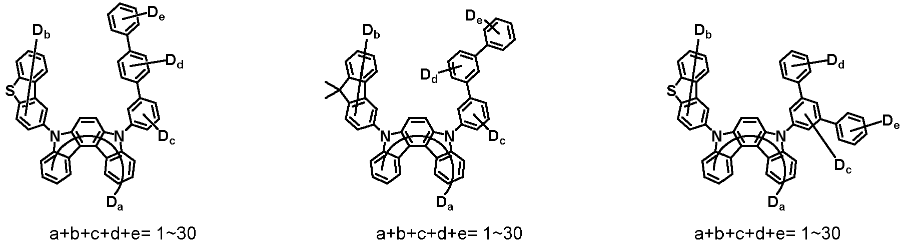 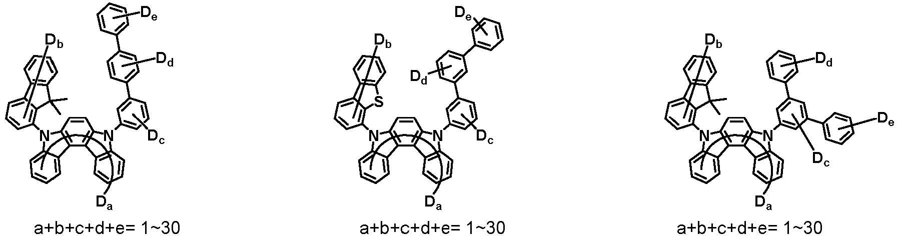 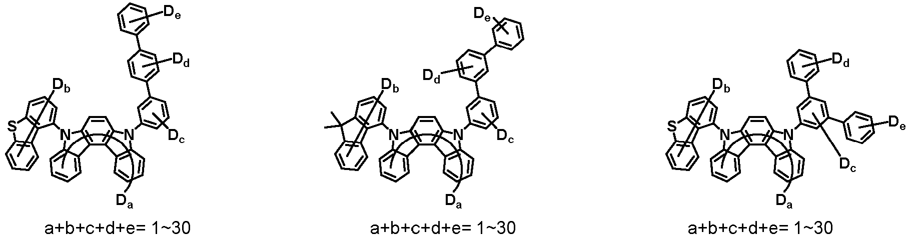 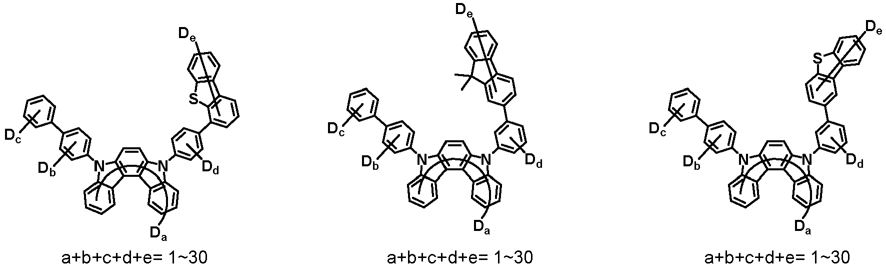 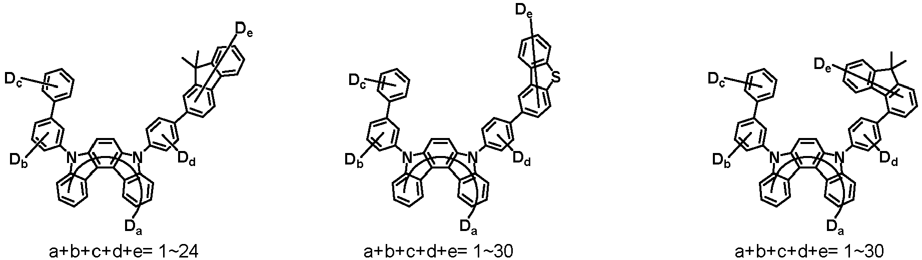 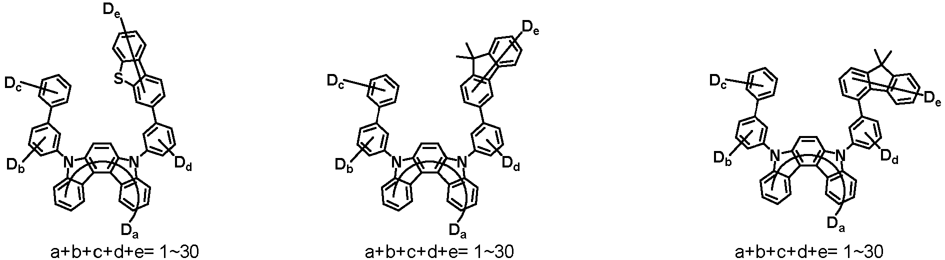 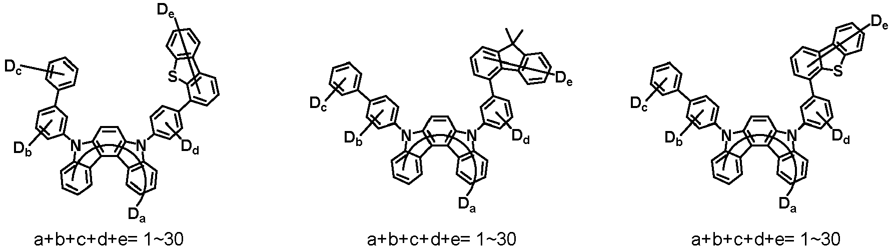 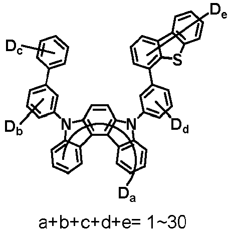 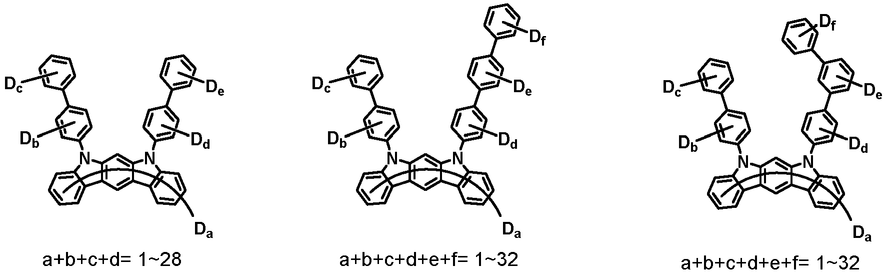 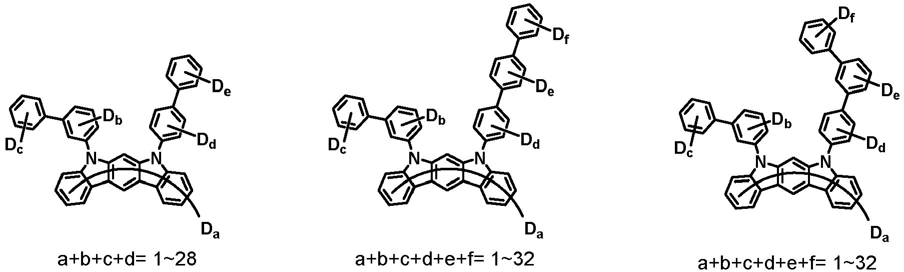 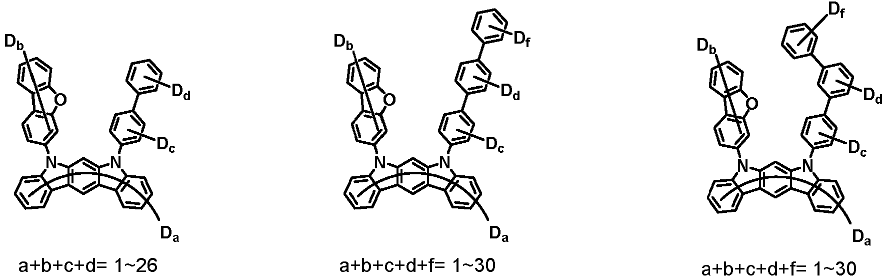 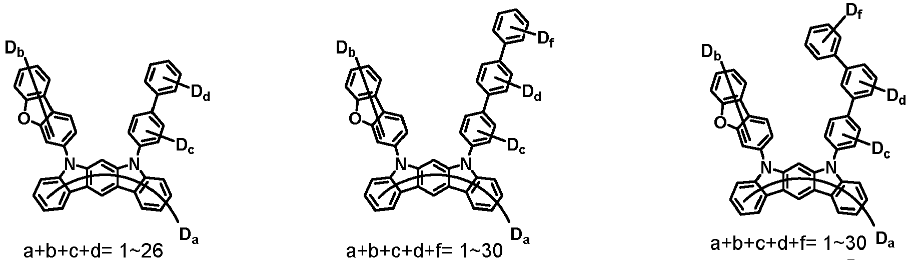 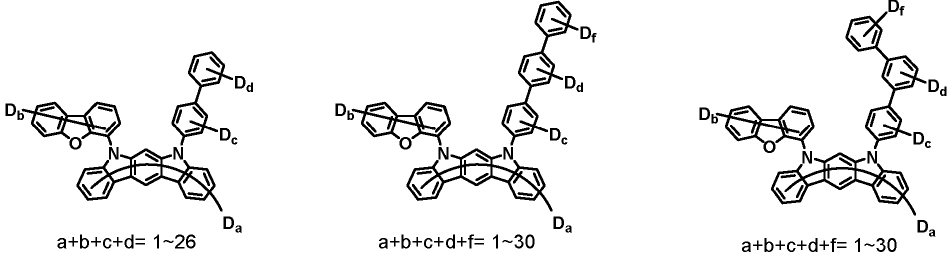 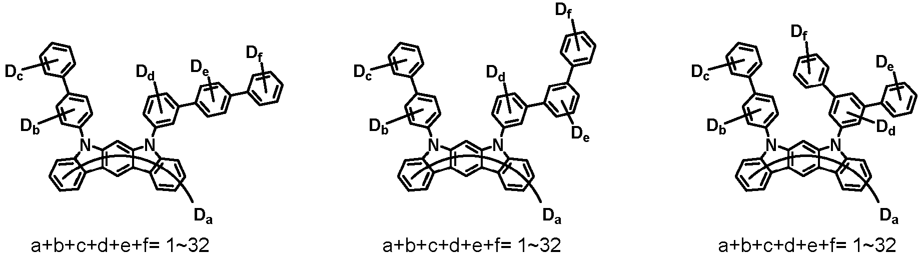 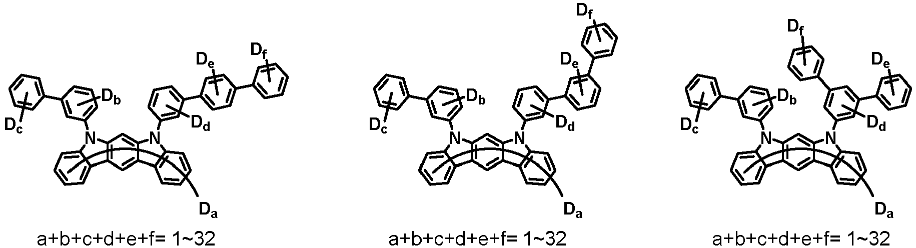 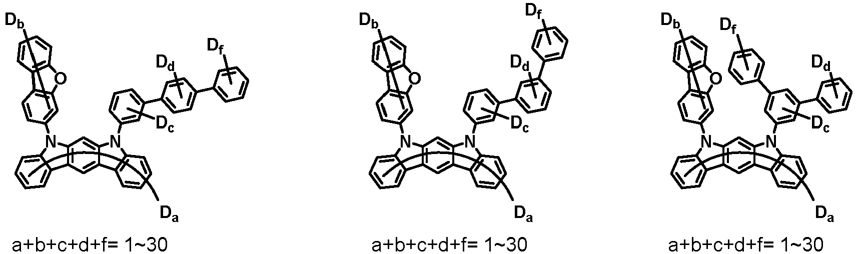 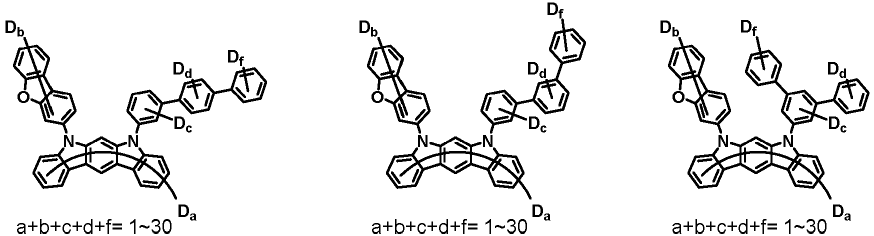 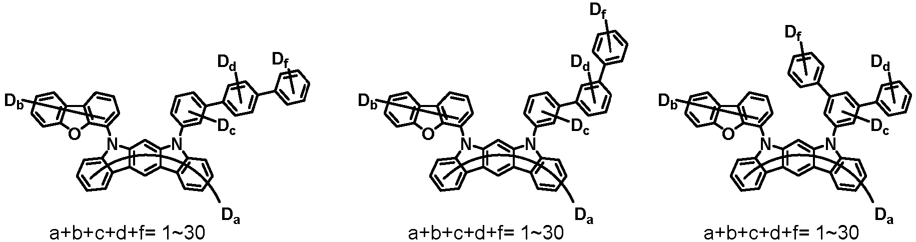 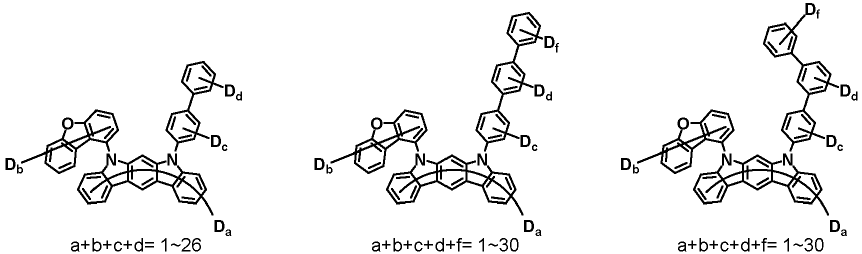 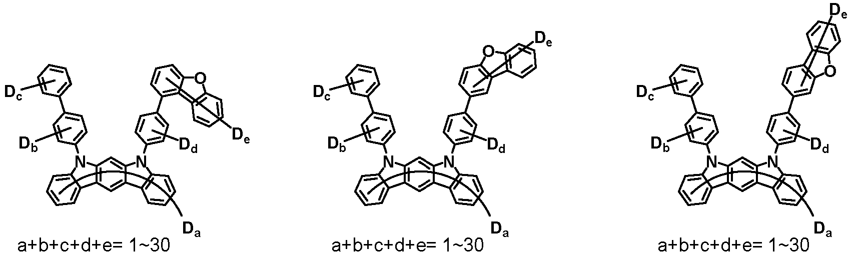 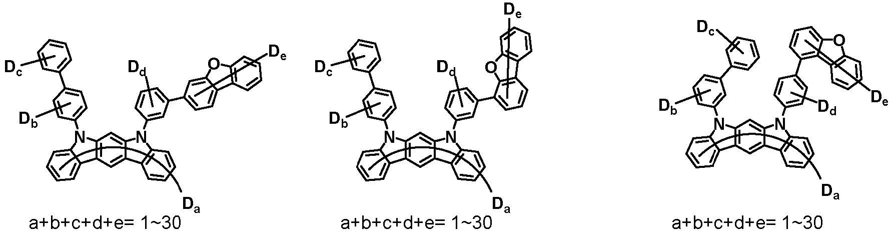 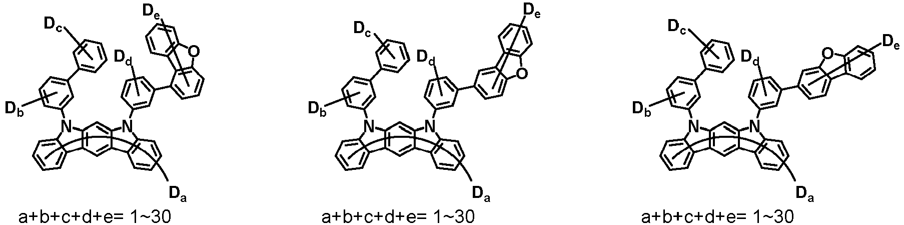 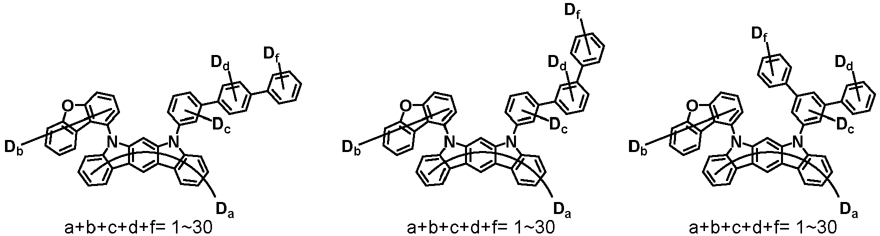 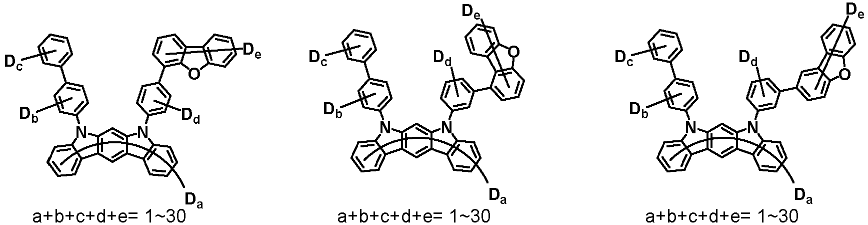 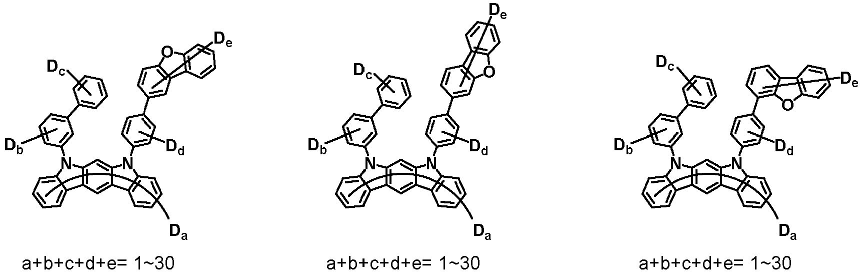 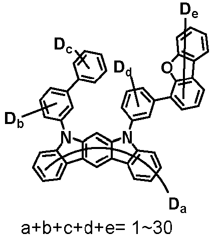 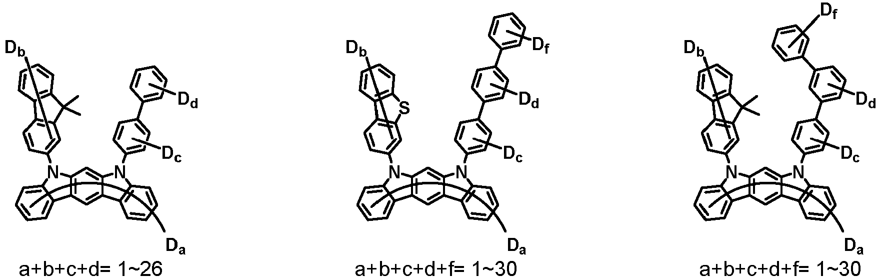 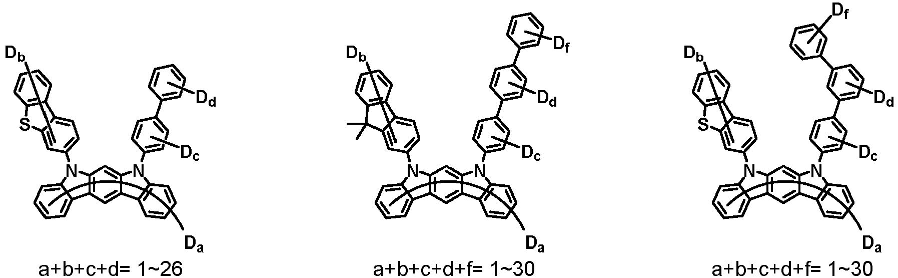 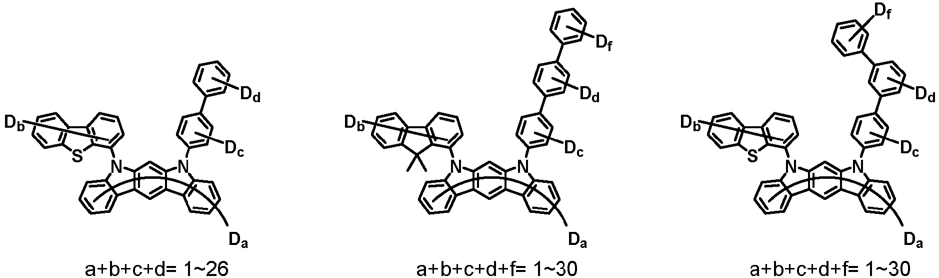 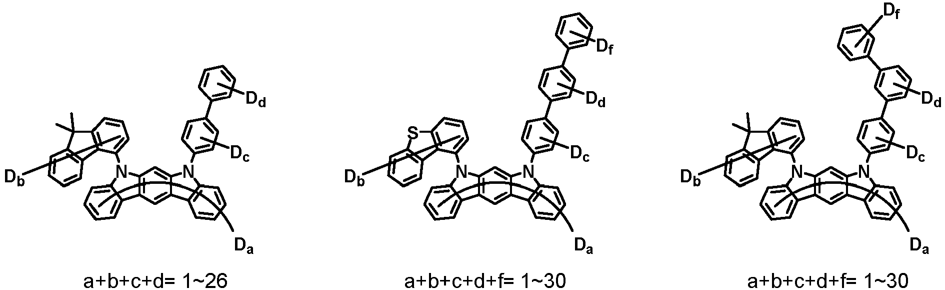 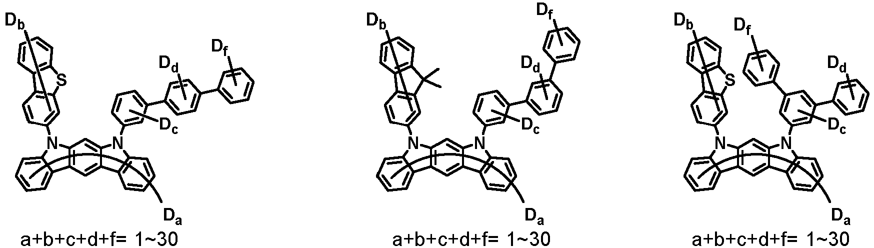 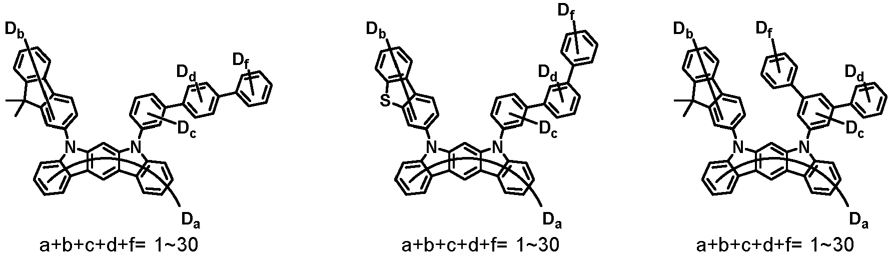 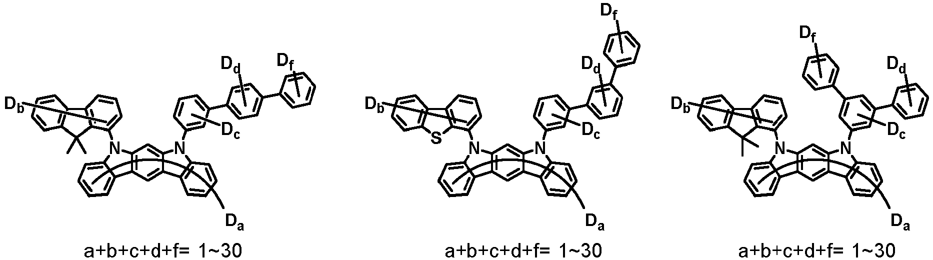 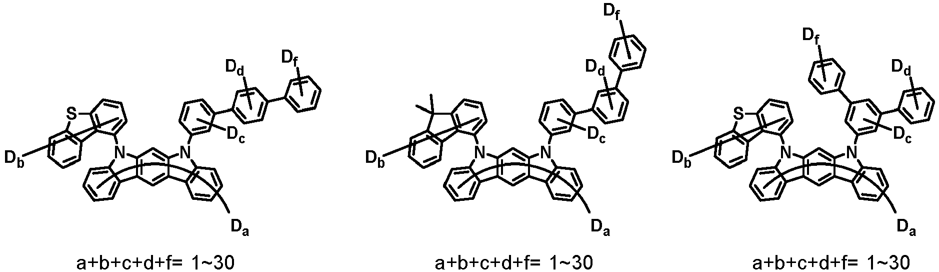 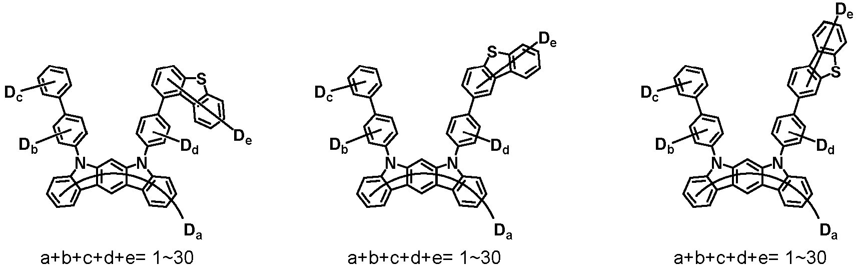 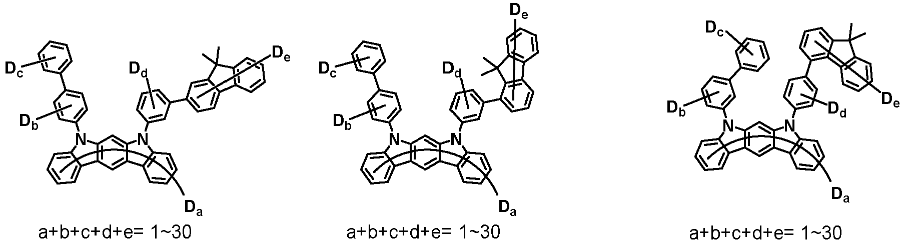 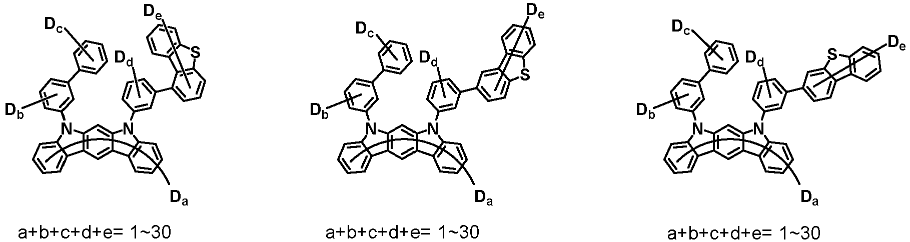 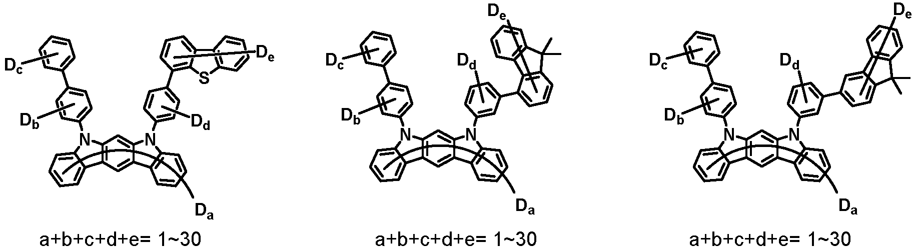 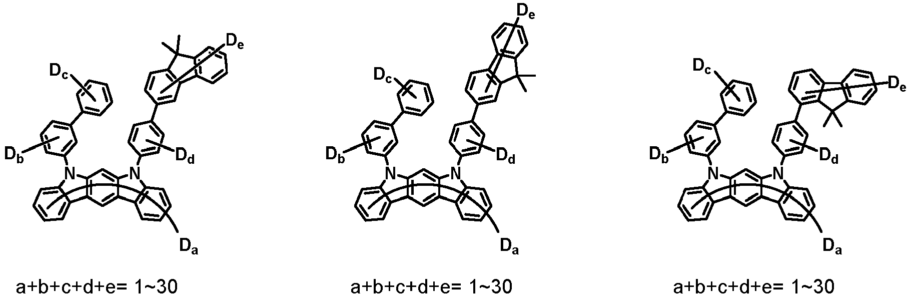 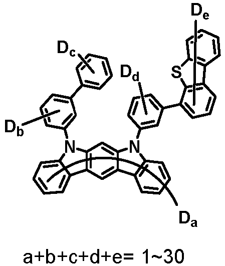 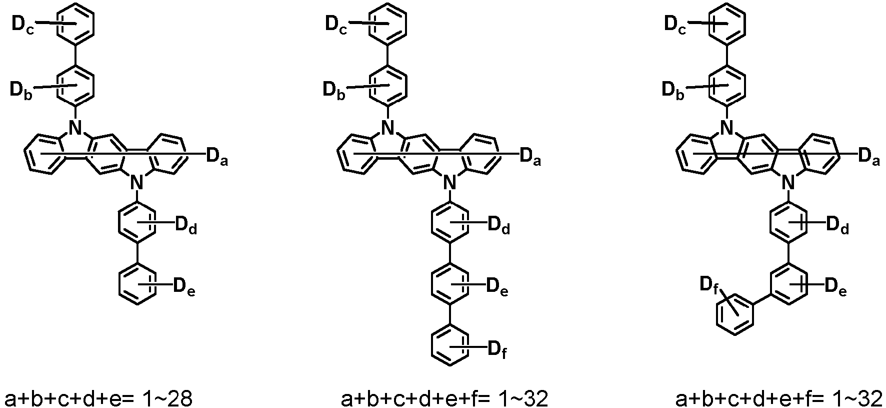 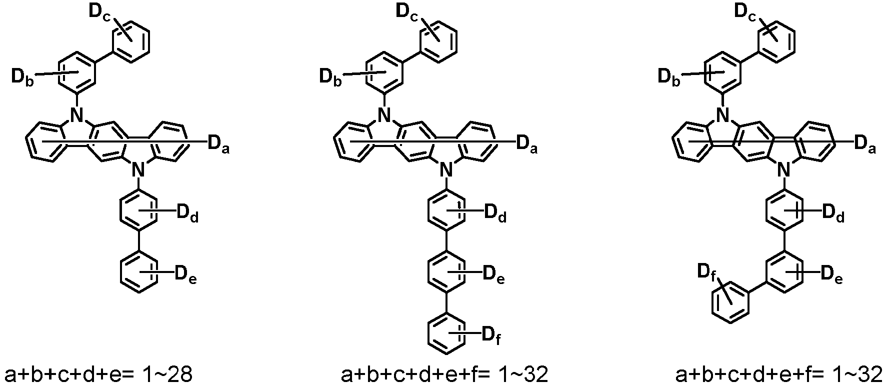 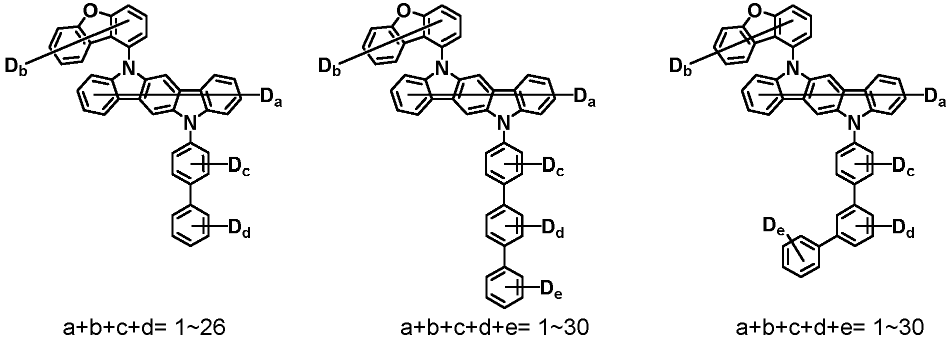 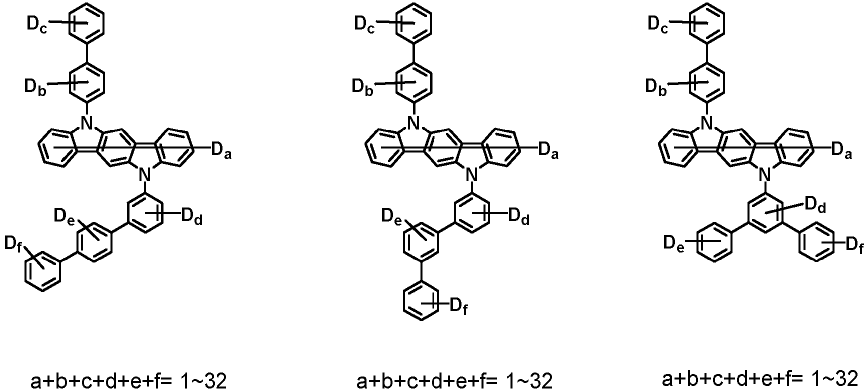 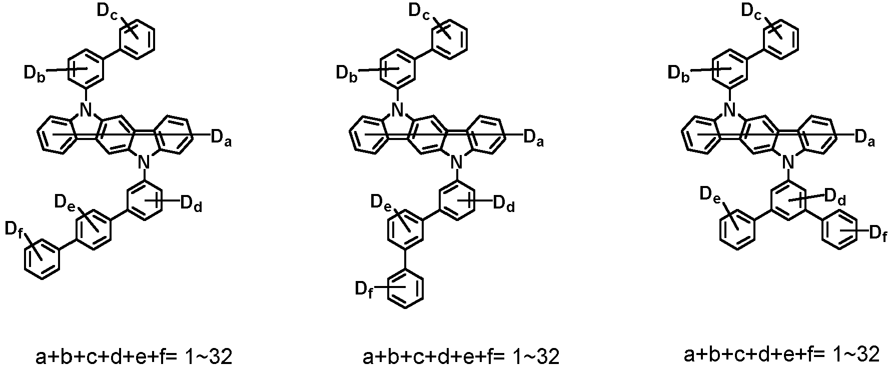 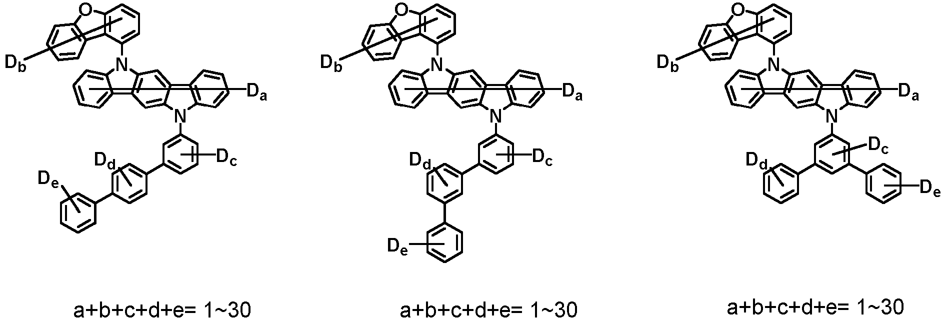 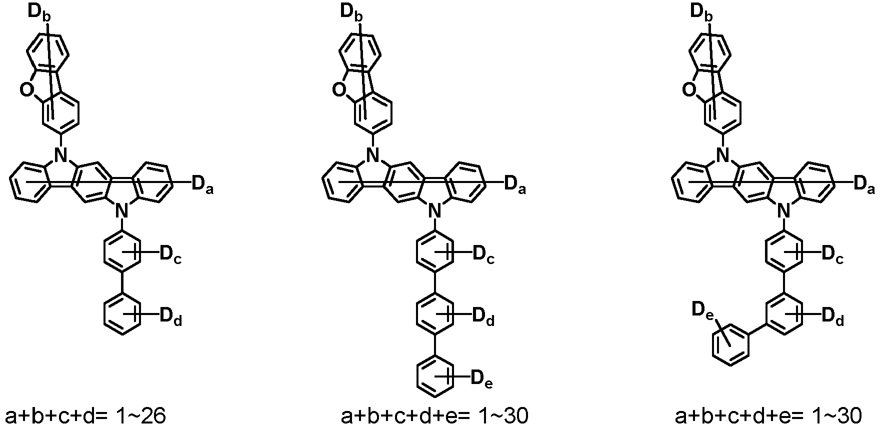 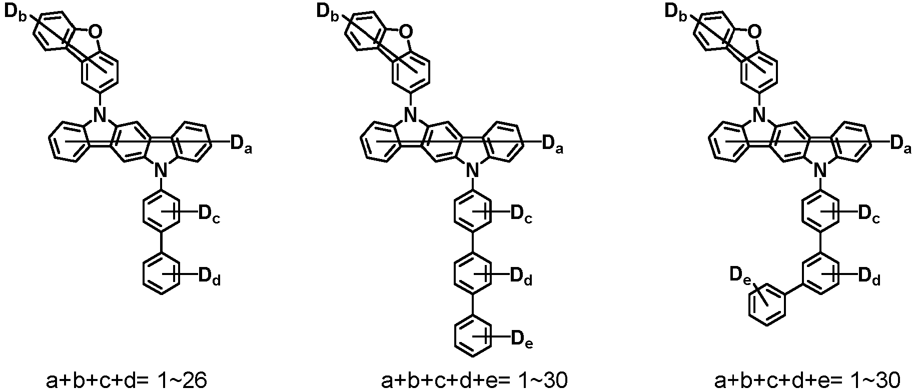 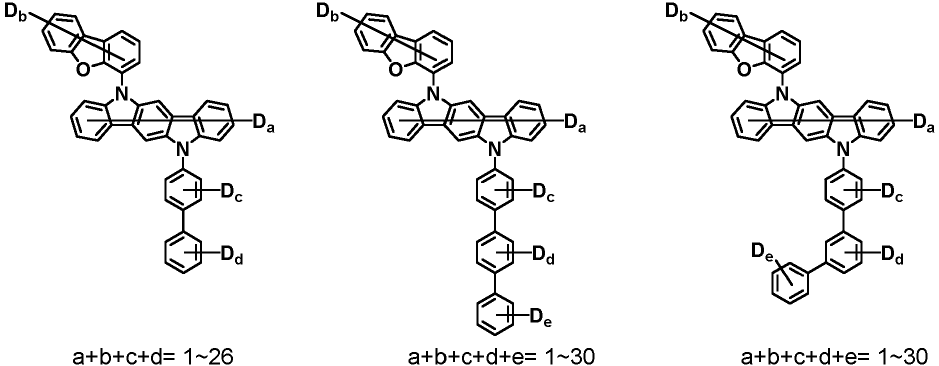 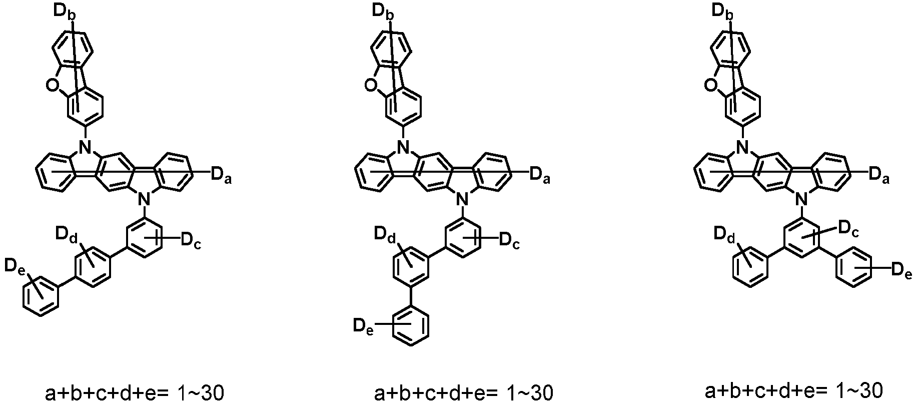 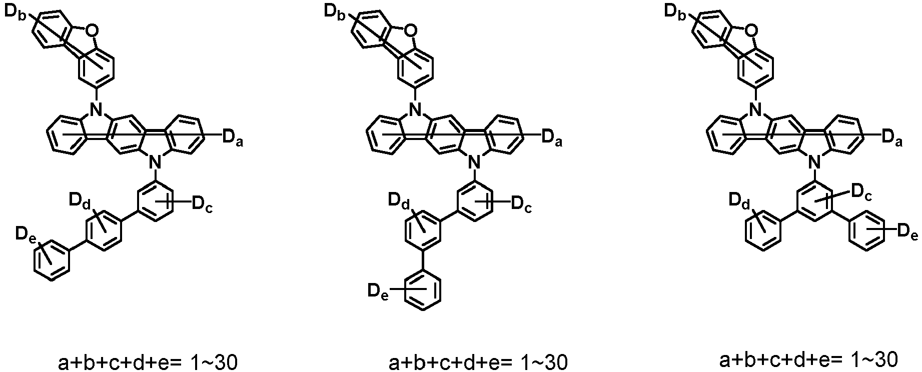 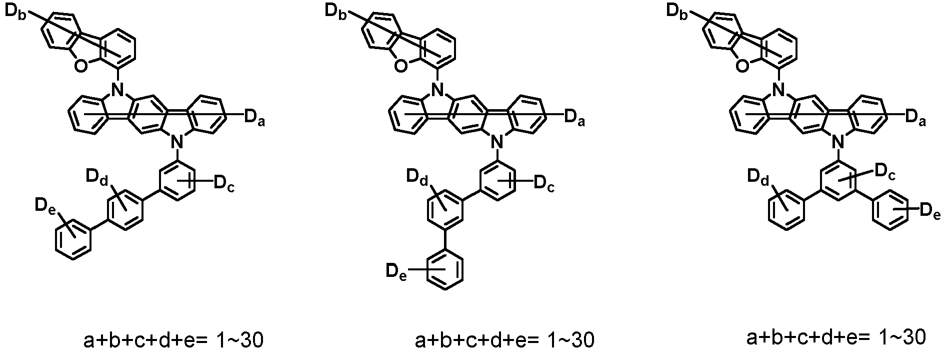 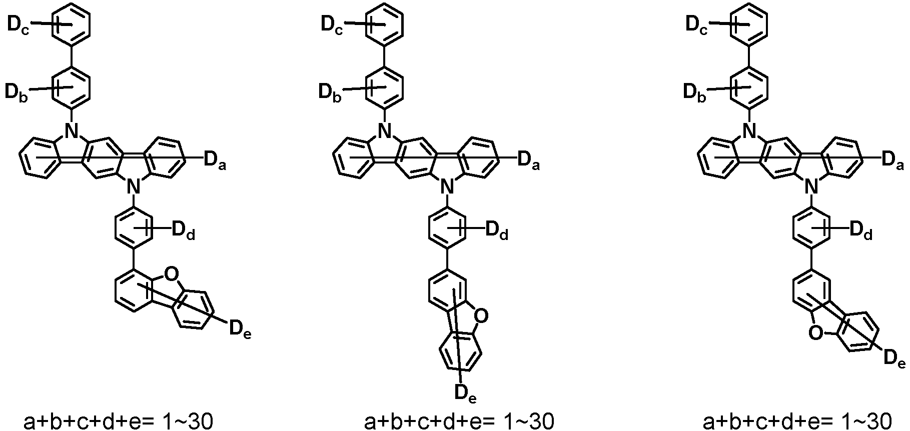 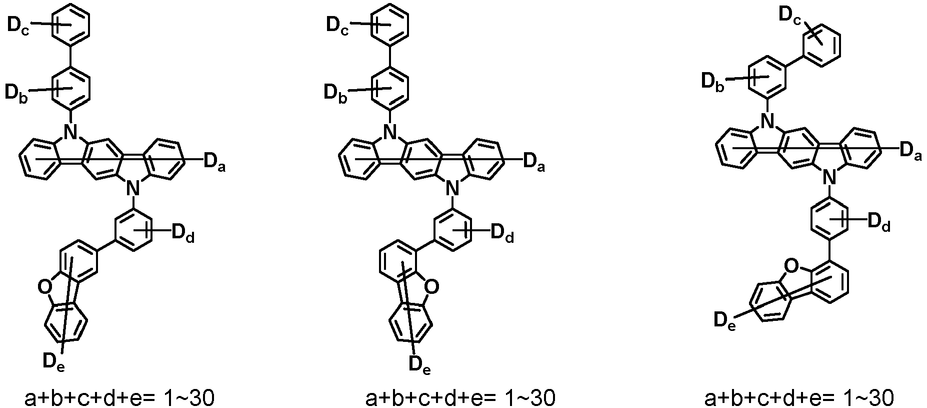 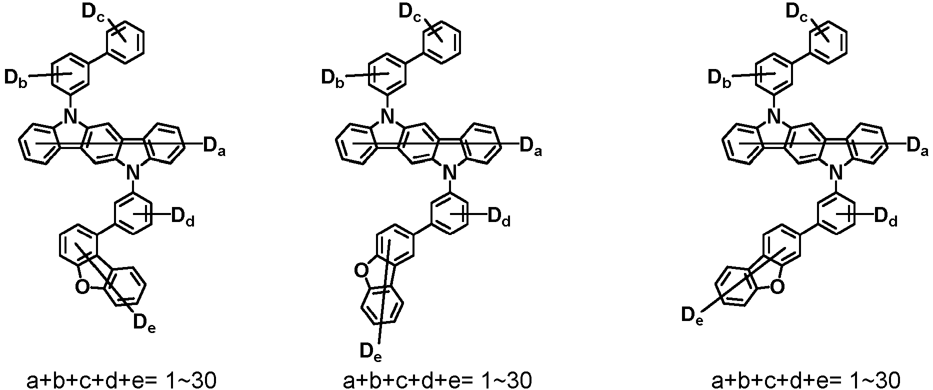 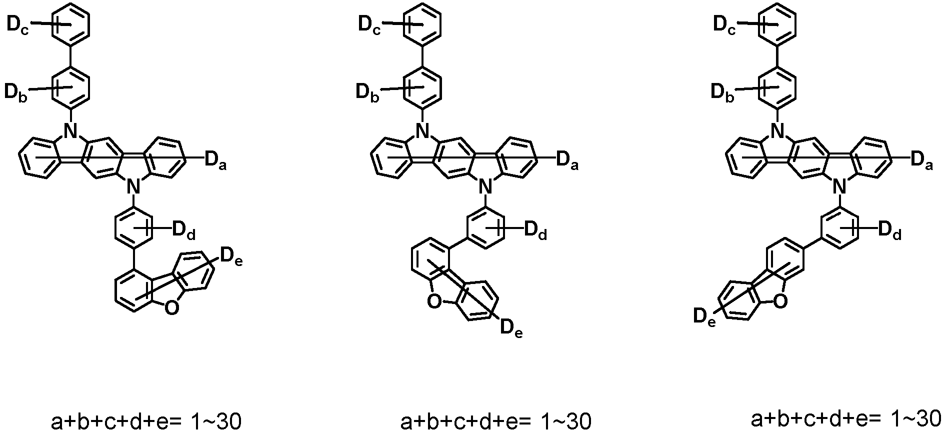 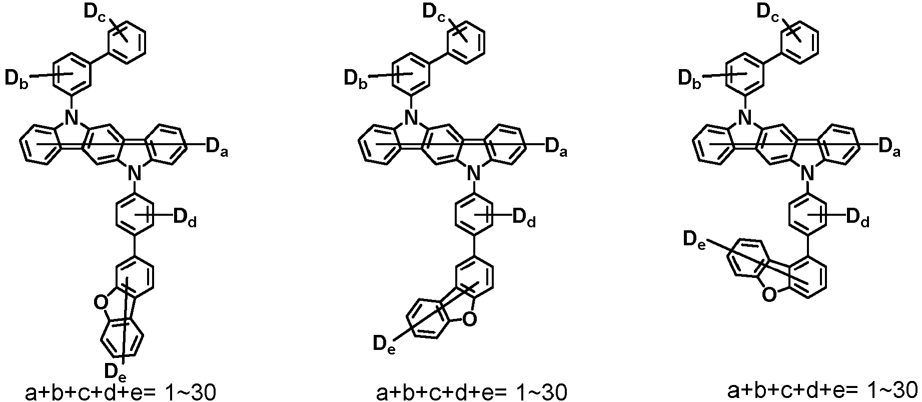 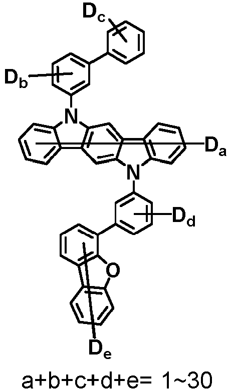 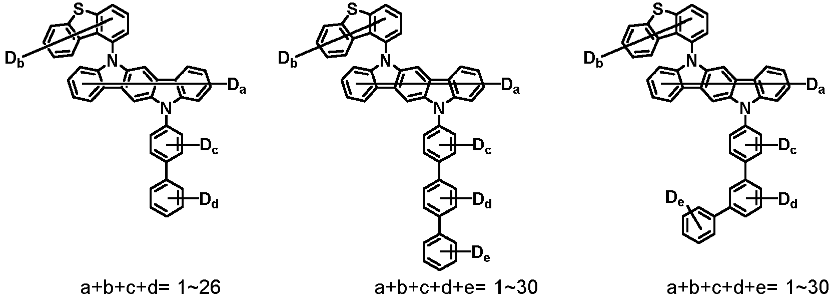 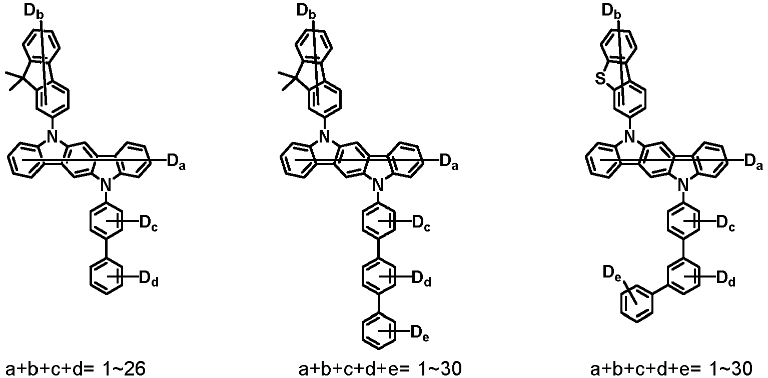 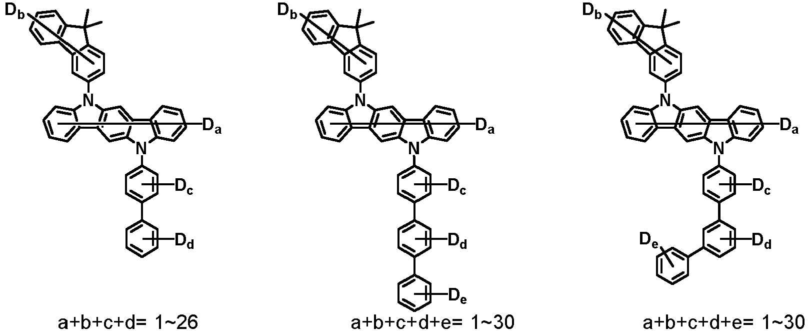 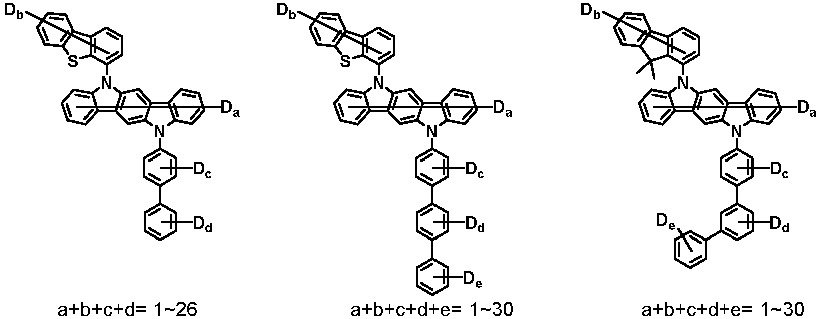 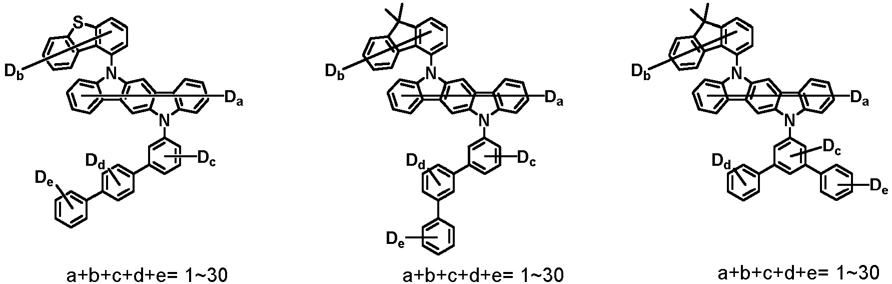 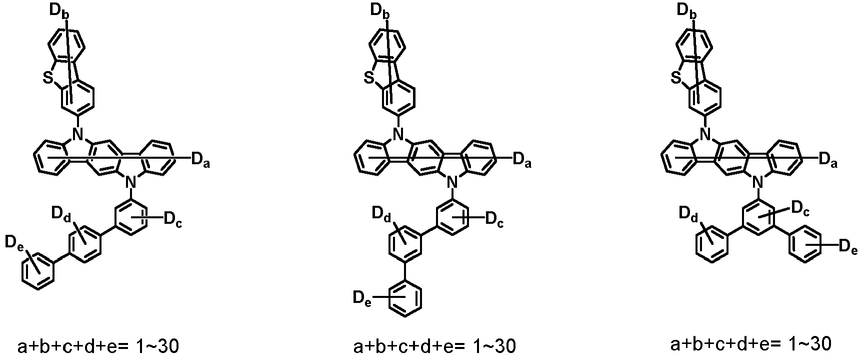 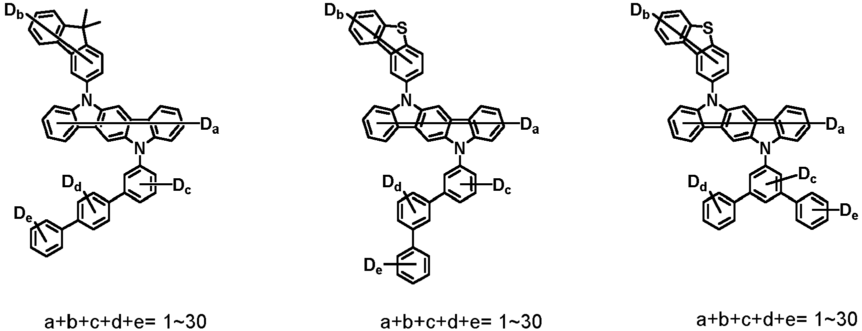 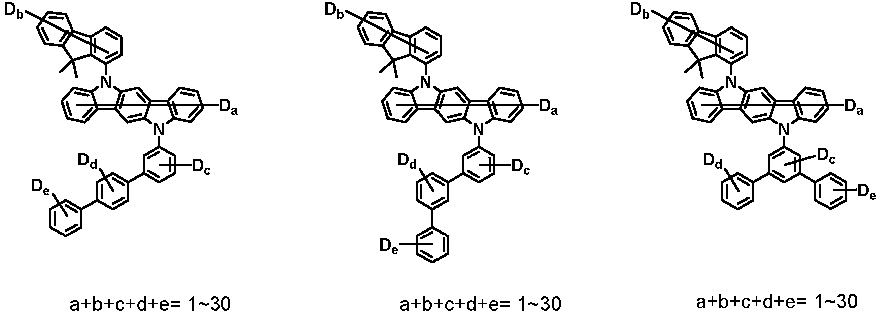 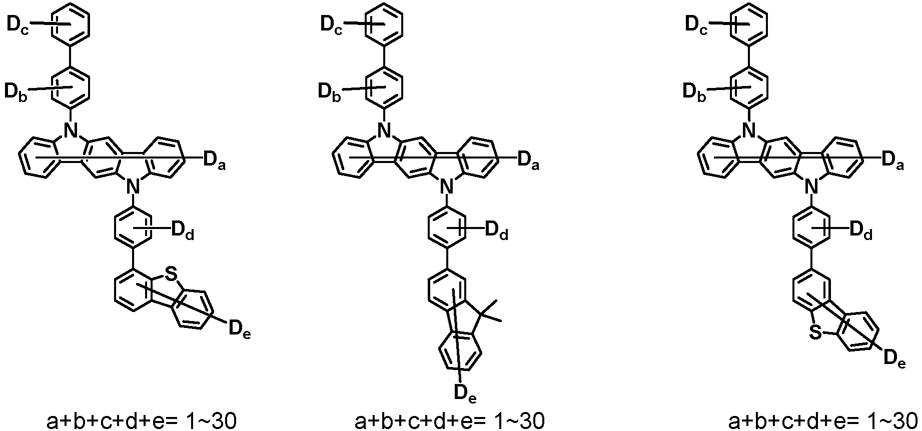 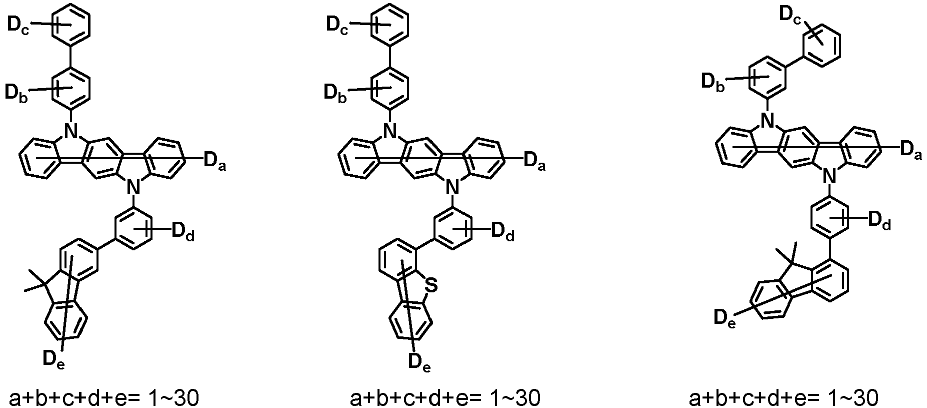 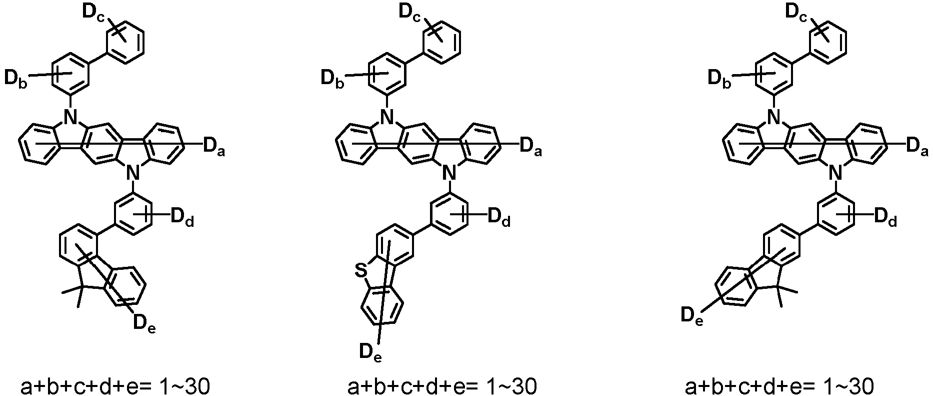 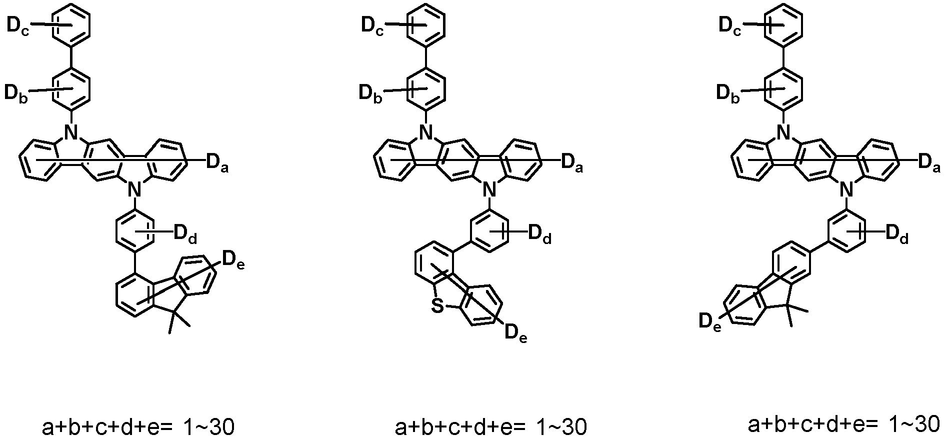 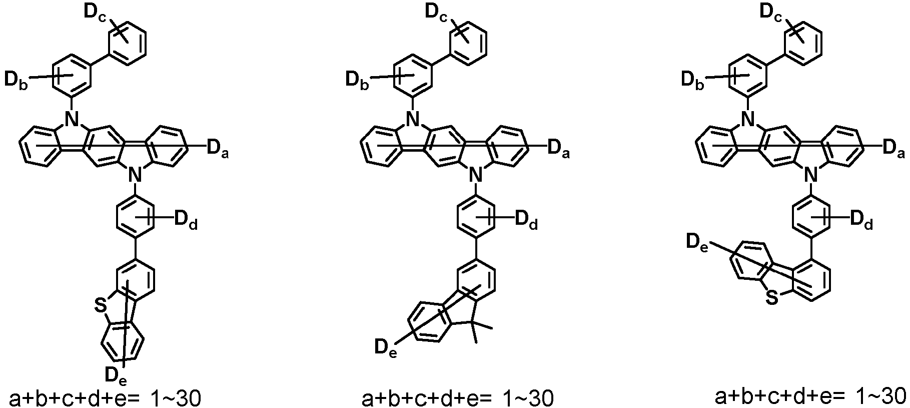 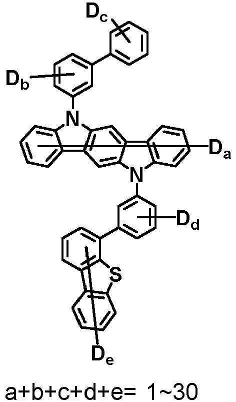 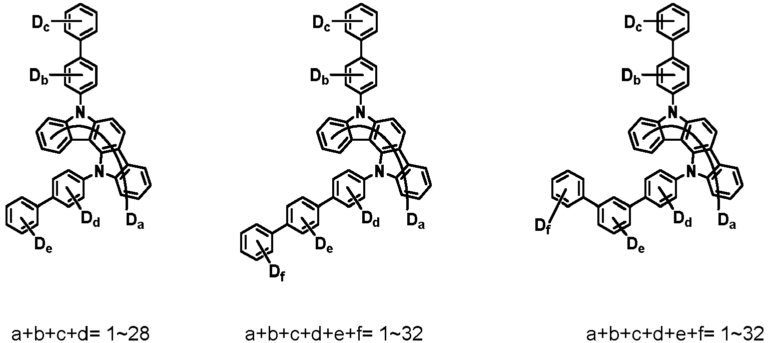 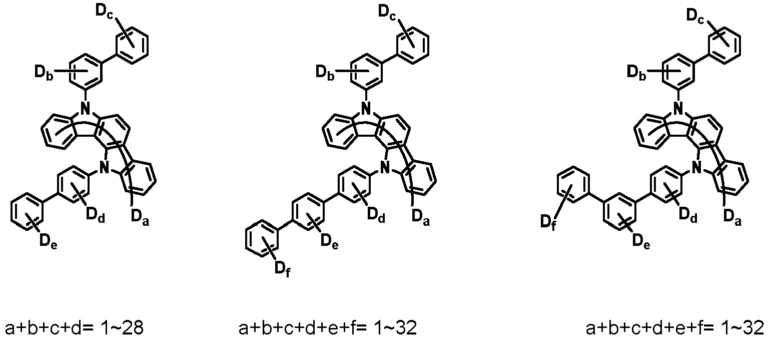 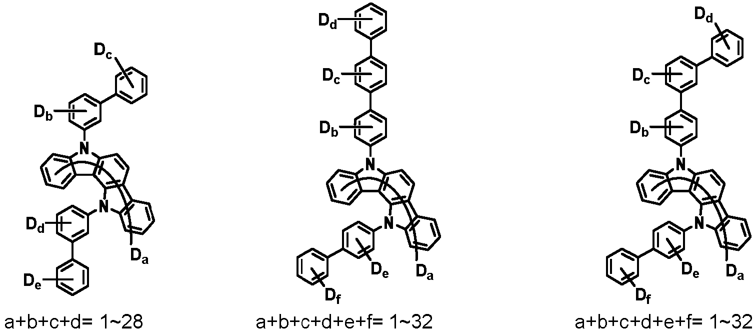 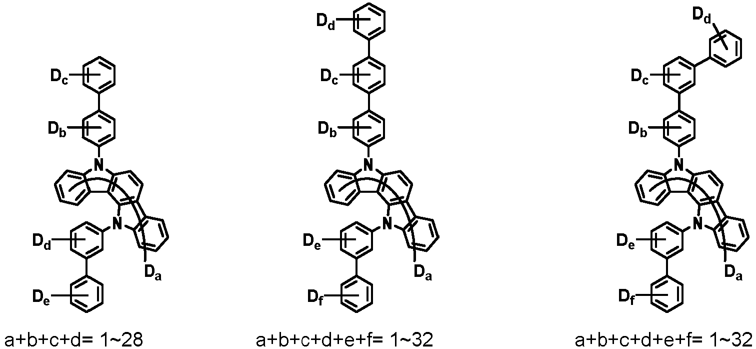 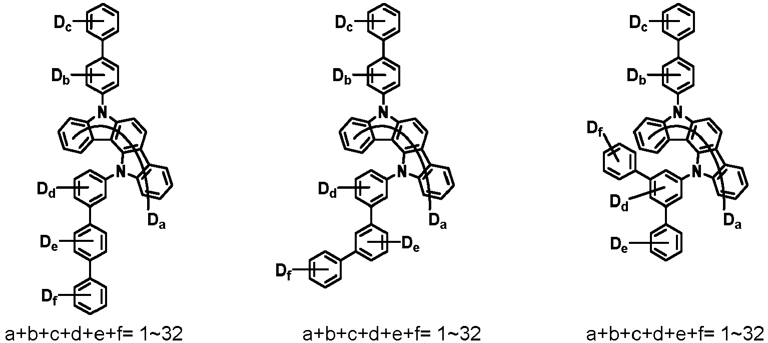 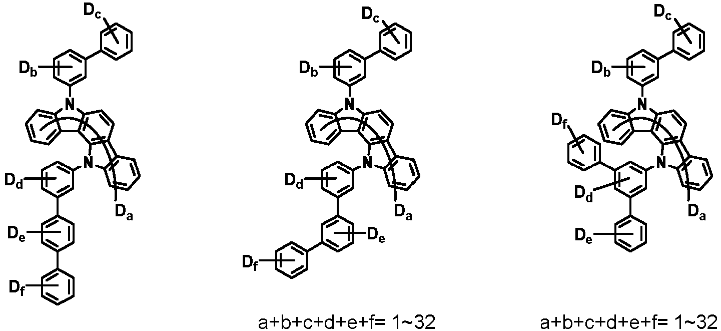 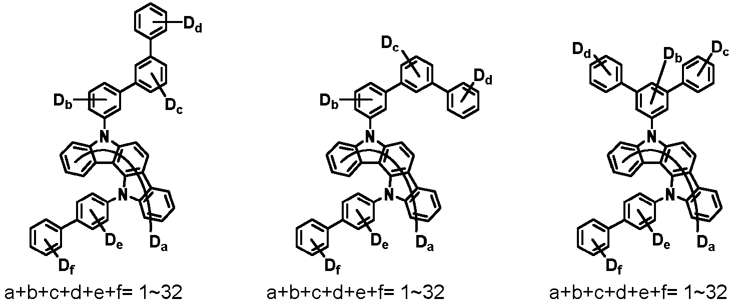 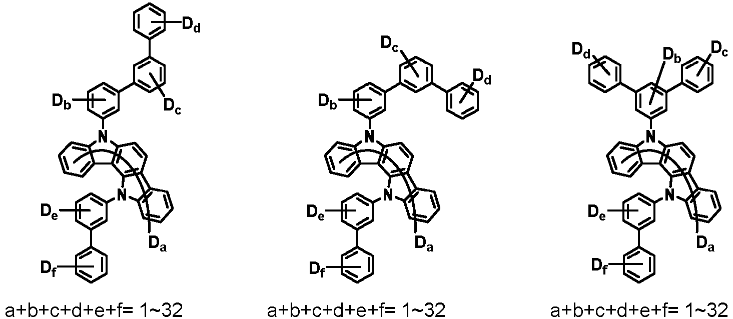 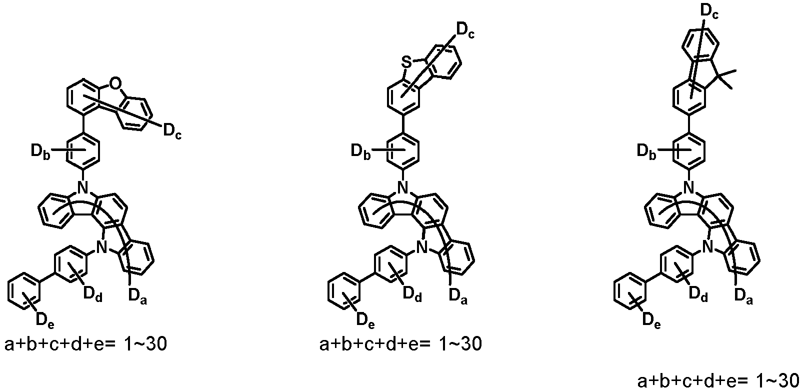 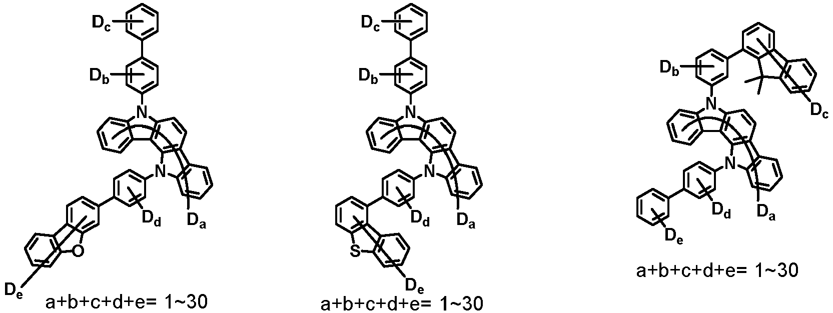 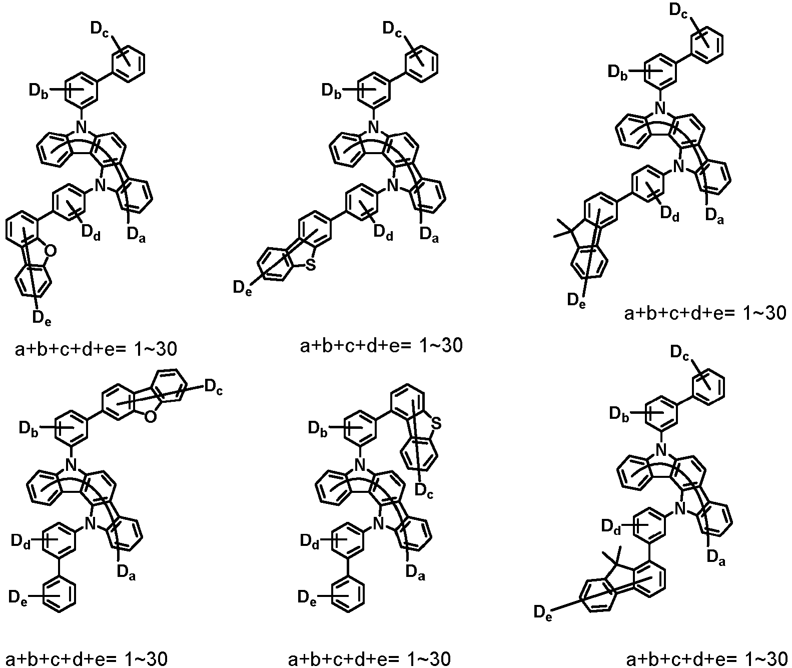 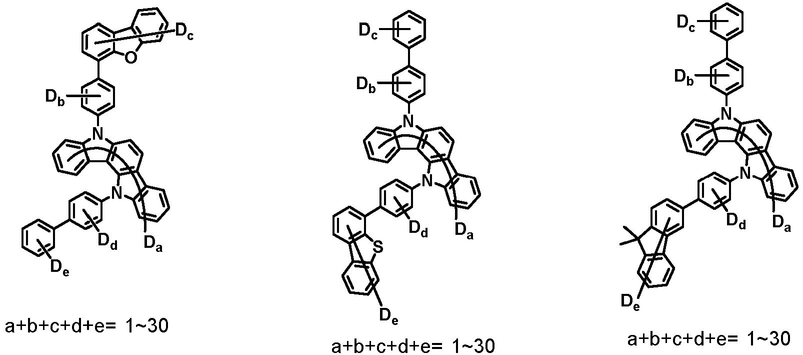 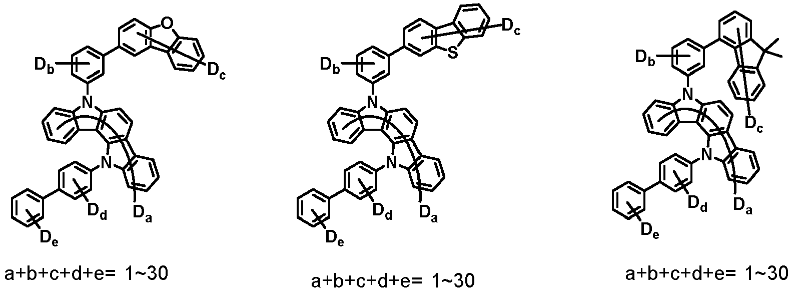 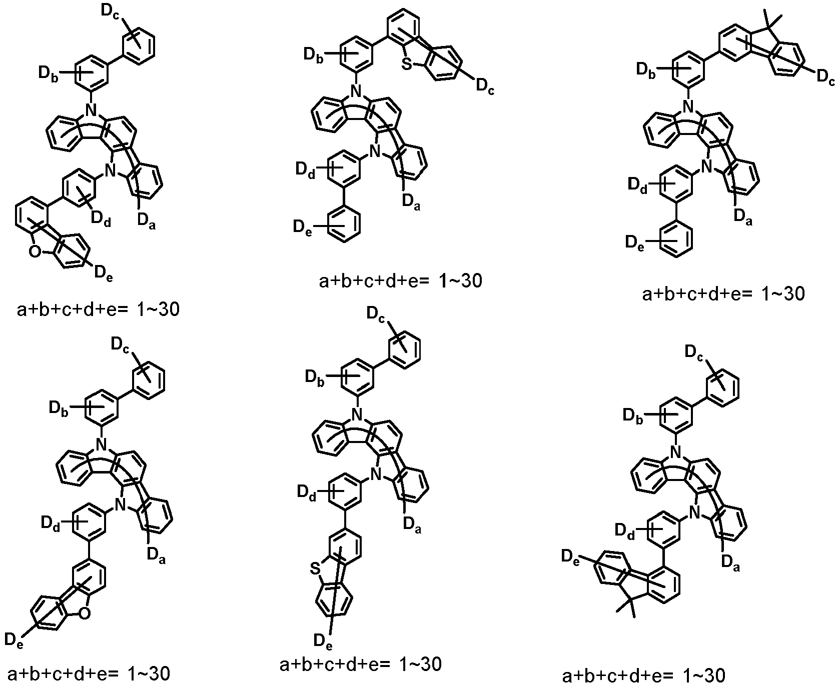 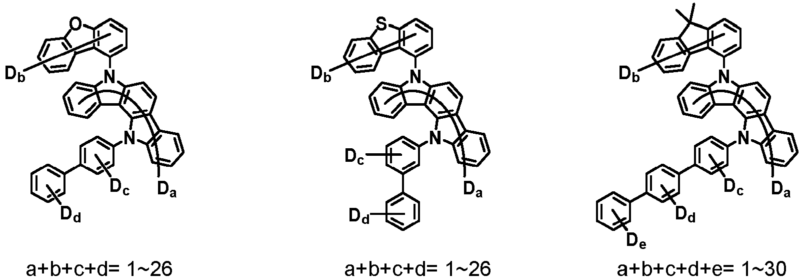 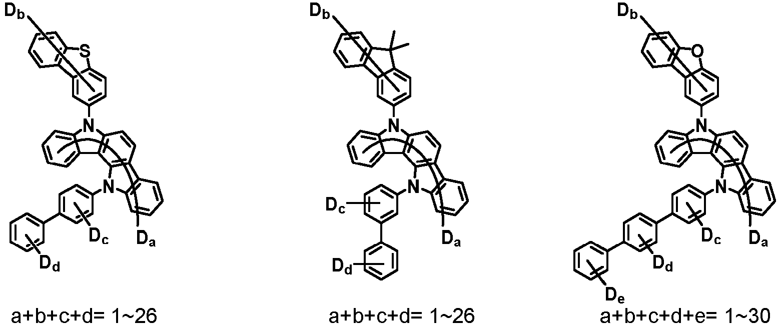 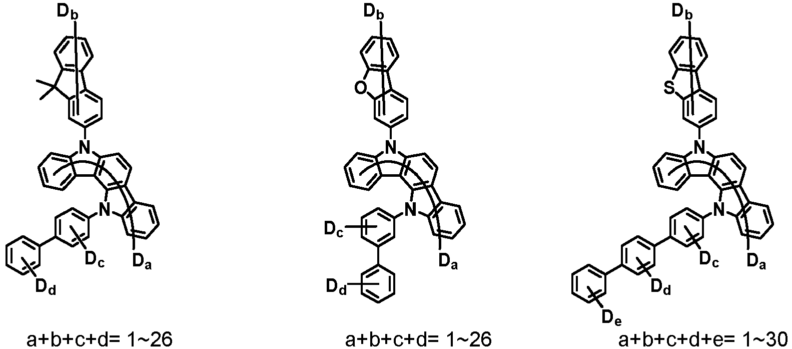 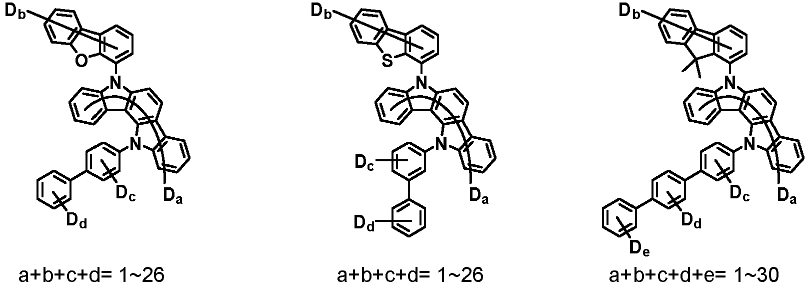 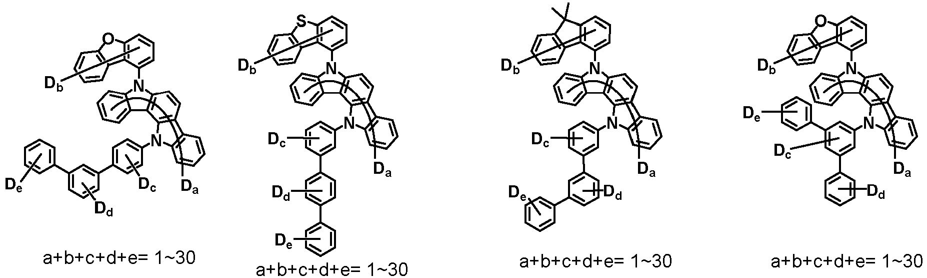 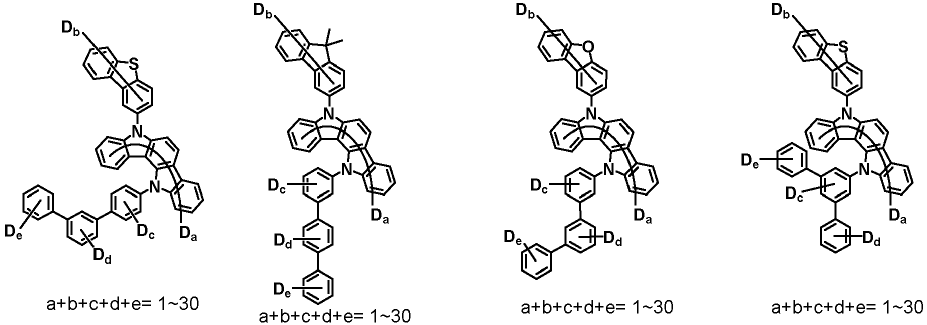 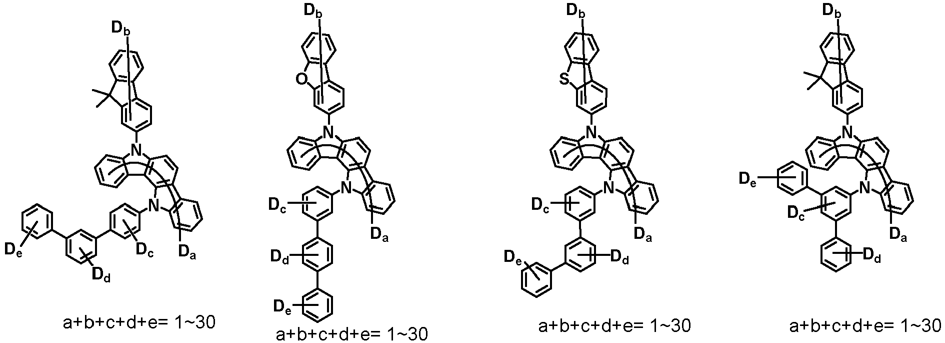 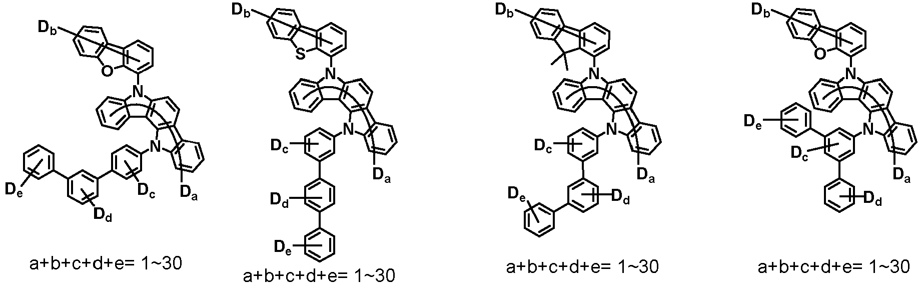 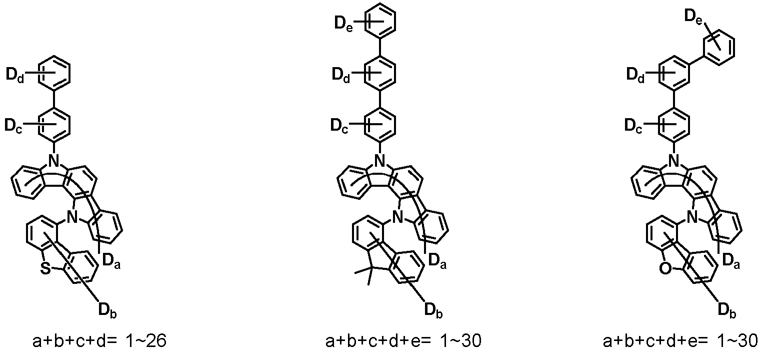 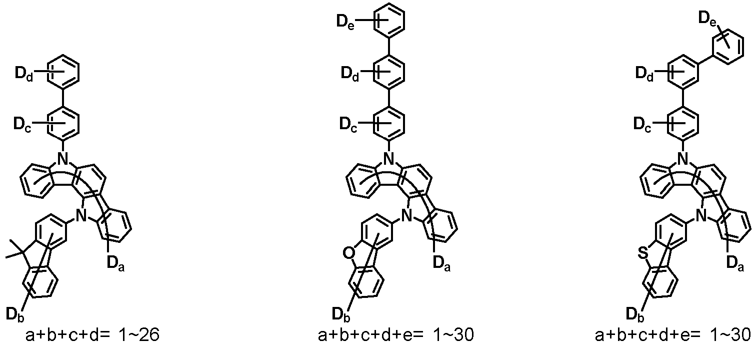 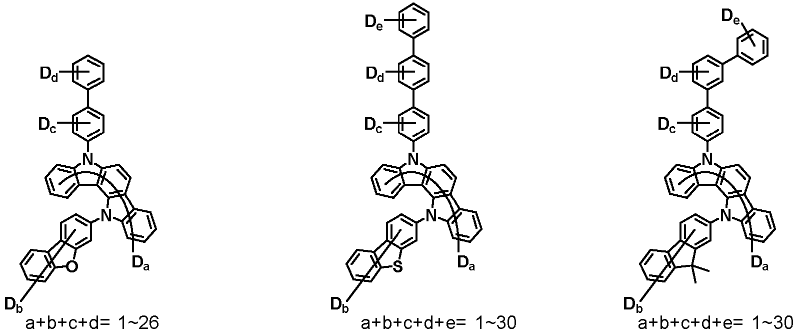 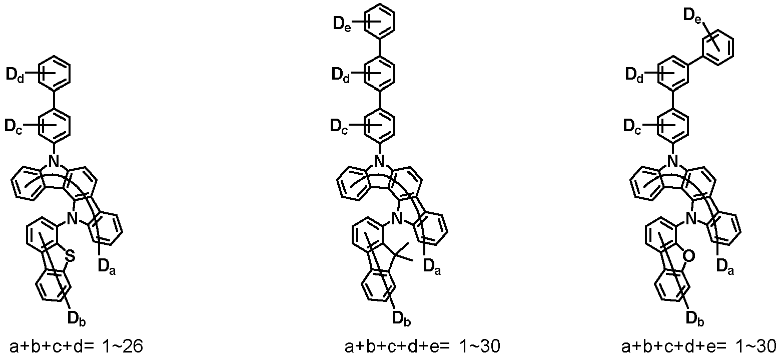 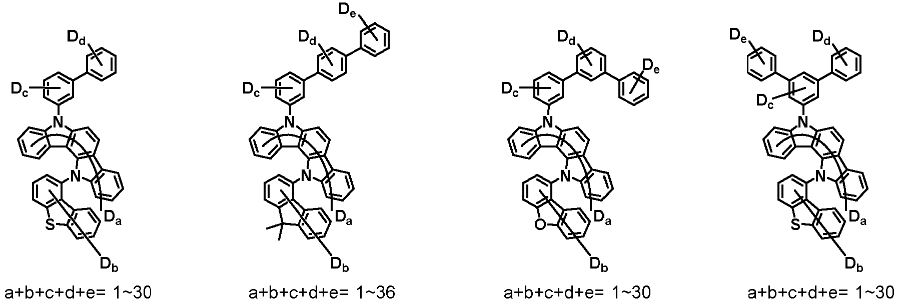 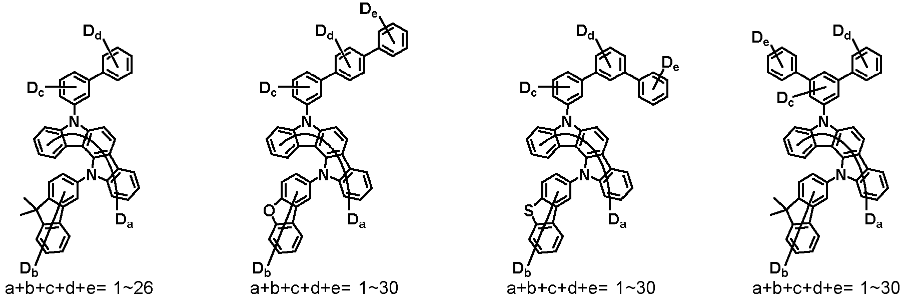 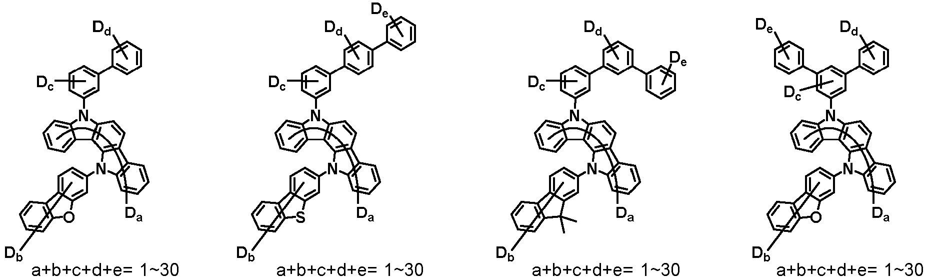 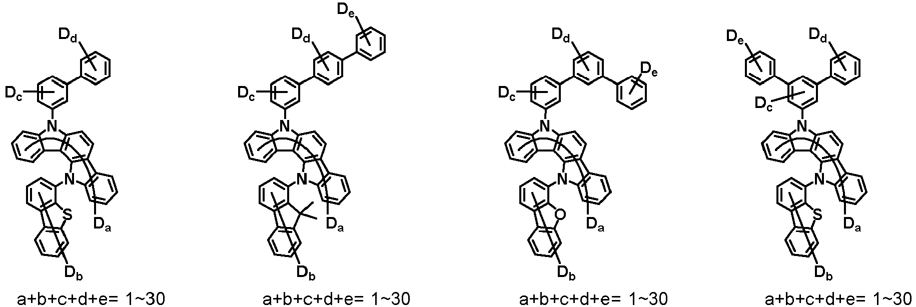 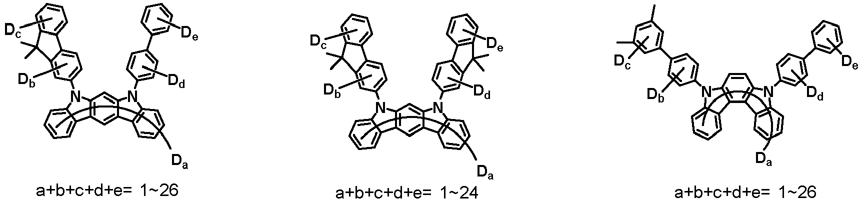 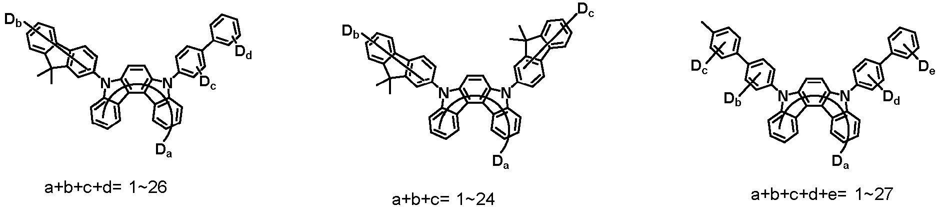 wherein, the methyl groups contained in each Chemical Formula are each independently CH₃, CH₂D, CHD₂, or CD₃. As an example, in Chemical Formula 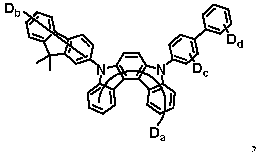 the two methyl groups contained in the dimethylfluorenyl may be each independently CH₃, CH₂D, CHD₂, or CD₃.

The compound represented by Chemical Formula 2 can be prepared by a preparation method as follows. 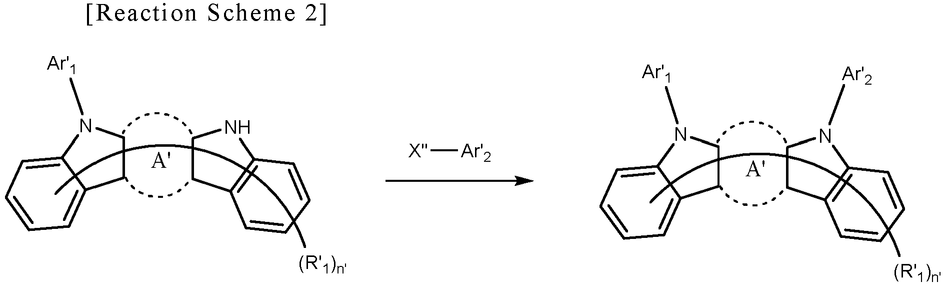 wherein, in Reaction Scheme 2, the definition of the remaining substituents except for X" are the same as defined above, and X" is halogen, more preferably chloro or bromo.

Reaction Scheme 2 is an amine substitution reaction, which is preferably carried out in the presence of a palladium catalyst and a base, and a reactive group for the amine substitution reaction can be modified as known in the art.

The preparation method of the compound represented by Chemical Formula 2 can be further embodied in Preparation Examples described hereinafter.

In the light emitting layer, the weight ratio between the compound represented by Chemical Formula 1 to the compound represented by Chemical Formula 2 is 1:99 to 99:1, 5:95 to 95:5, or 10:90 to 90:10.

Meanwhile, the compound represented by Chemical Formula 1 and the compound represented by Chemical Formula 2 may be included in the light emitting layer as a simple mixture or may be included in the light emitting layer as an organic alloy. The organic alloy is a material obtained by pre-treating more than two single organic compounds, and may have a chemical interaction between the single organic compounds due to the pre-treatment. The pre-treating may be a heat treatment such as heating and sublimation followed by cooling, but is not limited thereto.

The organic alloy has a chemical interaction between two or more single organic compounds as described above and thus, has different intrinsic characteristics from the single organic compounds and their simple mixture having no chemical interaction between single organic compounds. Herein, the simple mixture means a mixture obtained by physically mixing single organic compounds without any pre-treatment. In other words, a simple mixture of the first organic compound and the second organic compound exhibits the characteristics of the first organic compound, the second organic compound, or a combination thereof, while the organic alloy of the first organic compound and the second organic compound can exhibit different characteristics from those of the first organic compound, the second organic compound, or a simple mixture thereof.

In one example, the emission wavelength of the organic alloy may differ from the emission wavelength of the first organic compound, the second organic compound and the simple mixture thereof.

Further, the color of the organic alloy may be different from the color of the first organic compound, the second organic compound, and the simple mixture thereof.

Furthermore, the glass transition temperature (Tg) of the organic alloy may be different from the glass transition temperature (Tg) of the first organic compound, the second organic compound, and the simple mixture thereof. In addition, the organic alloy may have a different crystallization temperature (Tc) from that of the first organic compound, the second organic compound, and the simple mixture thereof. Further, the organic alloy may have a different melting point (Tm) from that of the first organic compound, the second organic compound, and the simple mixture thereof.

The organic alloy can be pre-treated in various methods, and for example, can be obtained from the steps of heat-treating the first organic compound and the second organic compound and liquidating or gasifying the first and second organic compounds and then, cooling and solidifying the heat-treated compounds. Also, an additional step of physically grounding the organic alloy obtained as a solid like a mass using a mixer and the like can be included.

The organic alloy is a product obtained through the aforementioned pre-treatment and may be supplied by using one source to form a thin film. Accordingly, this eliminates the need for a process control step required when two or more organic compounds are respectively supplied from separate sources, and thus, the process can be simplified.

In addition, the organic alloy is a product obtained through the aforementioned pre-treatment and thus, can secure uniformity and consistency for deposition as compared with the two or more single organic compounds supplied by using two or more separate sources or their simple mixture of supplied by using one single source. Accordingly, when a plurality of thin films are formed through a continuous process, the organic alloy may be used to continuously produce the thin films including components in a substantially equivalent ratio and thus, increase reproducibility and reliability of the thin films.

The dopant material is not particularly limited as long as it is a material used for the organic light emitting device. As an example, an aromatic amine derivative, a styrylamine compound, a boron complex, a fluoranthene compound, a metal complex, and the like can be mentioned. Specific examples of the aromatic amine derivatives include substituted or unsubstituted fused aromatic ring derivatives having an arylamino group, examples thereof include pyrene, anthracene, chrysene, and periflanthene having the arylamino group, and the like. The styrylamine compound is a compound where at least one arylvinyl group is substituted in substituted or unsubstituted arylamine, in which one or two or more substituent groups selected from the group consisting of an aryl group, a silyl group, an alkyl group, a cycloalkyl group, and an arylamino group are substituted or unsubstituted. Specific examples thereof include styrylamine, styryldiamine, styryltriamine, styryltetramine, and the like, but are not limited thereto. Further, examples of the metal complex include an iridium complex, a platinum complex, and the like, but are not limited thereto.

### Hole Transport Layer

The organic light emitting device according to the present disclosure may further include a hole transport layer between the light emitting layer and the anode.

The hole transport layer is a layer that receives holes from a hole injection layer and transports the holes to the light emitting layer. The hole transport material is suitably a material having large mobility to the holes, which may receive holes from the anode or the hole injection layer and transfer the holes to the light emitting layer.

Specific examples of the hole transport material include an arylamine-based organic material, a conductive polymer, a block copolymer in which a conjugate portion and a non-conjugate portion are present together, and the like, but are not limited thereto.

### Hole injection layer

The organic light emitting device according to the present disclosure may further include a hole injection layer between the anode and the hole transport layer, if necessary.

The hole injection layer is a layer injecting holes from an electrode, and the hole injection material is preferably a compound which has a capability of transporting the holes, has a hole injection effect in the anode and an excellent hole injection effect to the light emitting layer or the light emitting material, prevents movement of an exciton generated in the light emitting layer to the electron injection layer or the electron injection material, and is excellent in the ability to form a thin film. Further, it is preferable that a HOMO (highest occupied molecular orbital) of the hole injection material is between the work function of the anode material and a HOMO of a peripheral organic material layer.

Specific examples of the hole injection material include metal porphyrine, oligothiophene, an arylamine-based organic material, a hexanitrilehexaazatriphenylene-based organic material, a quinacridone-based organic material, a perylene-based organic material, anthraquinone, polyaniline and polythiophene-based conductive polymer, and the like, but are not limited thereto.

### Electron Blocking Layer

The organic light emitting device according to the present disclosure includes an electron blocking layer between the hole transport layer and the light emitting layer, if necessary.

The electron blocking layer prevents the electrons injected in the cathode from being transferred to the hole transport layer without being recombined in the light emitting layer, which may also be referred to as an electron inhibition layer. The electron blocking layer is preferably a material having the smaller electron affinity than the electron transport layer.

### Electron Transport Layer

The organic light emitting device according to the present disclosure may include an electron transport layer between the light emitting layer and the cathode, if necessary.

The electron transport layer is a layer that receives the electrons from the cathode or the electron injection layer formed on the cathode and transports the electrons to the light emitting layer, and that suppress the transfer of holes from the light emitting layer, and an electron transport material is suitably a material which may receive electrons well from a cathode and transfer the electrons to a light emitting layer, and has a large mobility for electrons.

Specific examples of the electron transport material include: an Al complex of 8-hydroxyquinoline; a complex including Alq₃; an organic radical compound; a hydroxyflavone-metal complex, and the like, but are not limited thereto. The electron transport layer may be used with any desired cathode material, as used according to a conventional technique. In particular, appropriate examples of the cathode material are a typical material which has a low work function, followed by an aluminum layer or a silver layer. Specific examples thereof include cesium, barium, calcium, ytterbium, and samarium, in each case followed by an aluminum layer or a silver layer.

### Electron Injection Layer

The organic light emitting device according to the present disclosure may further include an electron injection layer between the electron transport layer and the cathode.

The electron injection layer is a layer which injects electrons from an electrode, and is preferably a compound which has a capability of transporting electrons, has an effect of injecting electrons from a cathode and an excellent effect of injecting electrons into a light emitting layer or a light emitting material, prevents excitons produced from the light emitting layer from moving to a hole injection layer, and is also excellent in the ability to form a thin film.

Specific examples of the electron injection layer include fluorenone, anthraquinodimethane, diphenoquinone, thiopyran dioxide, oxazole, oxadiazole, triazole, imidazole, perylenetetracarboxylic acid, fluorenylidene methane, anthrone, and the like, and derivatives thereof, a metal complex compound, a nitrogen-containing 5-membered ring derivative, and the like, but are not limited thereto.

Examples of the metal complex compound include 8-hydroxyquinolinato lithium, bis(8-hydroxyquinolinato)zinc, bis(8-hydroxyquinolinato)copper, bis(8-hydroxyquinolinato)manganese, tris(8-hydroxyquinolinato)aluminum, tris(2-methyl-8-hydroxyquinolinato)aluminum, tris(8-hydroxyquinolinato)gallium, bis(10-hydroxybenzo[h]quinolinato)beryllium, bis(10-hydroxybenzo[h]quinolinato)zinc, bis(2-methyl-8-quinolinato)chlorogallium, bis(2-methyl-8-quinolinato)(o-cresolato)gallium, bis(2-methyl-8-quinolinato)(1-naphtholato)aluminum, bis(2-methyl-8-quinolinato)(2-naphtholato)gallium, and the like, but are not limited thereto.

### Hole Blocking Layer

The organic light emitting device according to the present disclosure may include a hole blocking layer between the electron transport layer and the light emitting layer, if necessary.

The hole blocking layer prevents the holes injected in the anode from being transferred to the electron transport layer without being recombined in the light emitting layer, and the hole blocking layer is preferably a material having high ionization energy.

### Organic Light Emitting Device

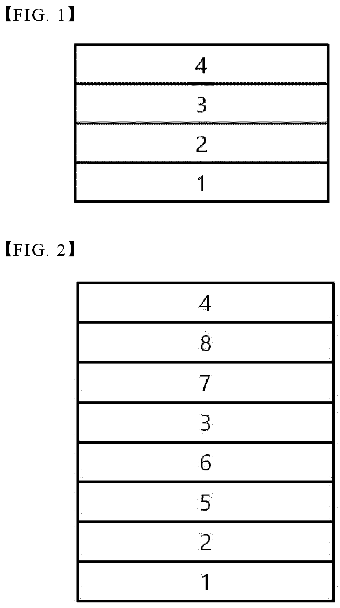

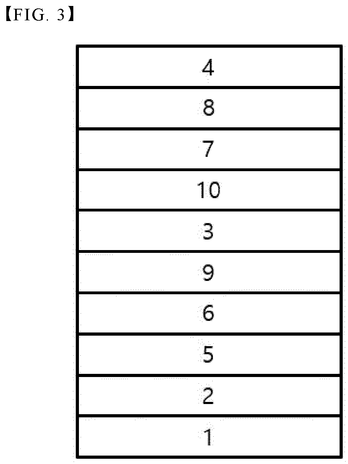

The structure of the organic light emitting device according to the present disclosure is illustrated in FIG. 1. FIG. 1 shows an example of an organic light emitting device comprising a substrate 1, an anode 2, a light emitting layer 3, and a cathode 4. Further, FIG. 2 shows an example of an organic light emitting device comprising a substrate 1, an anode 2, a hole injection layer 5, a hole transport layer 6, a light emitting layer 3, an electron transport layer 7, an electron injection layer 8 and a cathode 4. Further, FIG. 3 shows an example of an organic light emitting device comprising a substrate 1, an anode 2, a hole injection layer 5, a hole transport layer 6, an electron blocking layer 9, a light emitting layer 3, a hole blocking layer 10, an electron transport layer 7, an electron injection layer 8 and a cathode 4.

The organic light emitting device according to the present disclosure can be manufactured by sequentially stacking the above-described structures. In this case, the organic light emitting device may be manufactured by depositing a metal, metal oxides having conductivity, or an alloy thereof on the substrate by using a PVD (physical vapor deposition) method such as a sputtering method or an e-beam evaporation method to form the anode, forming the respective layers described above thereon, and then depositing a material that can be used as the cathode thereon.

In addition to such a method, the organic light emitting device may be manufactured by sequentially depositing from the cathode material to the anode material on a substrate in the reverse order of the above-mentioned configuration (WO 2003/012890). Further, the light emitting layer may be formed by subjecting hosts and dopants to a vacuum deposition method and a solution coating method. Herein, the solution coating method means a spin coating, a dip coating, a doctor blading, an inkjet printing, a screen printing, a spray method, a roll coating, or the like, but is not limited thereto.

Meanwhile, the organic light emitting device according to the present disclosure may be a bottom emission device, a top emission device, or a double-sided light emitting device, and particularly, may be a bottom emission device that requires relatively high luminous efficiency.

The preparation of the organic light emitting device according to the present disclosure will be described in detail in the following examples. However, these examples are presented for illustrative purposes only, and are not intended to limit the scope of the present disclosure.

### [SYNTHESIS EXAMPLE: Preparation of Compound of Chemical Formula 1 and Compound of Chemical Formula 2]

### Synthesis Example 1: Synthesis of Compound 1-1

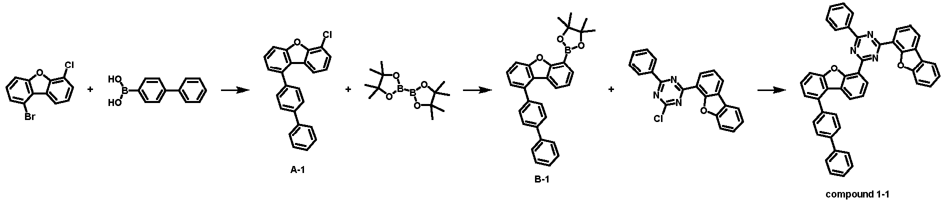

### 1) Synthesis of Compound A-1

1-Bromo-6-chlorodibenzo[b,d]furan(20 g, 71 mmol) and [1,1'-biphenyl]-4-ylboronic acid(14.1 g, 71mmol) were added to 400 ml of THF under a nitrogen atmosphere, and the mixture was stirred and refluxed. Then, potassium carbonate (29.5 g, 213.1mmol) was dissolved in 88 ml of water, added thereto and sufficiently stirred, and then tetrakis(triphenylphosphine)palladium(0) (1.1 g, 2.1 mmol) was added. After the reaction for 3 hours, the reaction mixture was cooled to room temperature, and then the organic layer and the aqueous layer were separated, and the organic layer was distilled. This was added again to 1260 mL (50 times the amount) of toluene, dissolved and washed twice with water. The organic layer was then separated, anhydrous magnesium sulfate was added, stirred and then filtered. The filtrate was distilled under reduced pressure. The concentrated compound was purified by a silica column using chloroform and ethyl acetate to give a white solid compound A-1(15.6g, 62%, MS: [M+H]+ = 355.8).

### 2) Synthesis of Compound B-1

Compound A-1 (30 g, 84.5 mmol) and bis(pinacolato)diboron (21.5 g, 84.5mmol) were added to 600 ml of dioxane under a nitrogen atmosphere, and the mixture was stirred and refluxed. Then, potassium acetate (24.9 g, 253.6mmol) was added thereto and sufficiently stirred, and then palladium dibenzylidene acetone palladium (1.5 g, 2.5mmol) and tricyclohexylphosphine (1.4 g, 5.1 mmol) were added. After the reaction for 8 hours, the reaction mixture was cooled to room temperature and then the organic layer was subjected to filtration treatment to remove a salt, and then the filtered organic layer was distilled. This was added again to 1132 mL (30 times the amount) of chloroform, dissolved and washed twice with water. The organic layer was then separated, anhydrous magnesium sulfate was added, stirred and then filtered. The filtrate was distilled under reduced pressure. The concentrated compound was recrystallized from chloroform and ethanol to give a beige solid compound B-1 (23.4g, 62%, MS: [M+H]+ = 447.4).

### 3) Synthesis of Compound 1-1

B-1(15 g, 33.6 mmol) and 2-chloro-4-(dibenzo[b,d]furan-4-yl)-6-phenyl-1,3,5-triazine(12 g, 33.6mmol) were added to 300ml of THF under a nitrogen atmosphere, and the mixture was stirred and refluxed. Then, potassium carbonate (13.9 g, 100.8 mmol) as dissolved in 14 ml of water, added thereto and sufficiently stirred, and then bis(tri-tert-butyl phosphine) palladium (0.5 g, 1 mmol) and 0 (0.6 g, 2 mmol) were added. After the reaction for 4 hours, the reaction mixture was cooled to room temperature and then the resulting solid was filtered. The solid was added to 647 mL (30 times the amount) of 1,2-dichlorobenzene, dissolved and washed twice with water. The organic layer was then separated, anhydrous magnesium sulfate was added, stirred and then filtered. The filtrate was distilled under reduced pressure. The concentrated compound was recrystallized from DCB and ethyl acetate to give a white solid compound 1-1 (10.8 g, 50%, MS: [M+H] + = 642.7).

### Synthesis Example 2: Synthesis of Compound 1-2

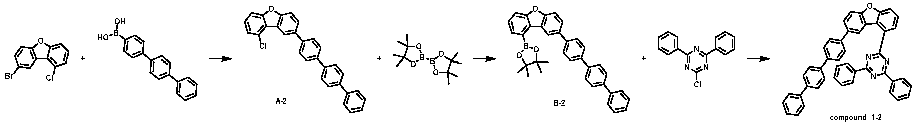

Compound 1-2 (MS[M+H]⁺=628.23) was prepared in the same manner as in the preparation method of Compound 1-1, except that in Synthesis Example 1, 1-bromo-6-chlorodibenzo[b,d]furan was changed to 8-bromo-1-chlorodibenzo[b,d]furan, [1,1'-biphenyl]-4-ylboronic acid was changed to [1,1':4',1"-terphenyl]-4-ylboronic acid, and 2-chloro-4-(dibenzo[b,d]furan-4-yl)-6-phenyl-1,3,5-triazine was changed to 2-chloro-4,6-diphenyl-1,3,5-triazine.

### Synthesis Example 3: Synthesis of Compound 1-3

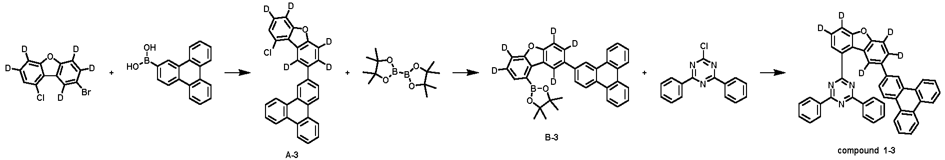

Compound 1-3 (MS[M+H]⁺= 631.25) was prepared in the same manner as in the preparation method of Compound 1-1, except that in Synthesis Example 1, 1-bromo-6-chlorodibenzo[b,d]furan was changed to 8-bromo-1-chlorodibenzo[b,d]furan-3,4,6,7,9-d5, [1,1'-biphenyl]-4-ylboronic acid was changed to triphenylen-2-ylboronic acid, and 2-chloro-4-(dibenzo[b,d]furan-4-yl)-6-phenyl-1,3,5-triazine was changed to 2-chloro-4,6-diphenyl-1,3,5-triazine.

### Synthesis Example 4 : Synthesis of Compound 1-4

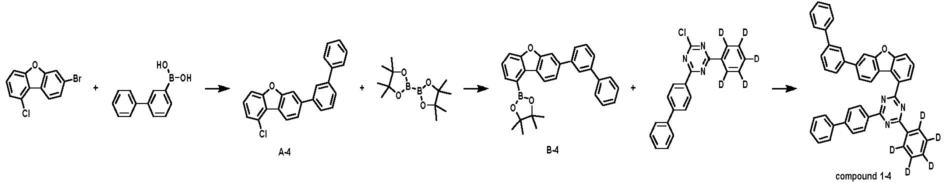

Compound 1-4 (MS[M+H]⁺= 633.26) was prepared in the same manner as in the preparation method of Compound 1-1, except that in Synthesis Example 1, 1-bromo-6-chlorodibenzo[b,d]furan was changed to 7-bromo-1-chlorodibenzo[b,d]furan, [1,1'-biphenyl]-4-ylboronic acid was changed to [1,1'-biphenyl]-3-ylboronic acid, and 2-chloro-4-(dibenzo[b,d]furan-4-yl)-6-phenyl-1,3,5-triazine was changed to 2-([1,1'-biphenyl]-4-yl)-4-chloro-6-(phenyl-d5)-1,3,5-triazine.

### Synthesis Example 5: Synthesis of Compound 1-5

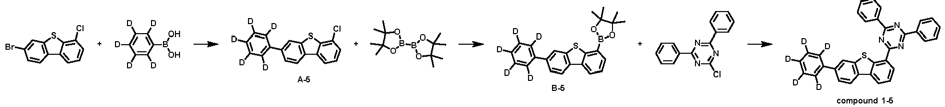

Compound 1-5 (MS[M+H]⁺= 497.18) was prepared in the same manner as in the preparation method of Compound 1-1, except that in Synthesis Example 1, 1-bromo-6-chlorodibenzo[b,d]furan was changed to 3-bromo-6-chlorodibenzo[b,d]thiophene, [1,1'-biphenyl]-4-ylboronic acid was changed to (phenyl-d5)boronic acid, and 2-chloro-4-(dibenzo[b,d]furan-4-yl)-6-phenyl-1,3,5-triazine was changed to 2-chloro-4,6-diphenyl-1,3,5-triazine.

### Synthesis Example 6: Synthesis of Compound 1-6

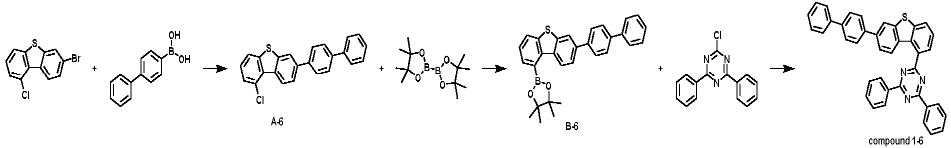

Compound 1-6 (MS[M+H]⁺= 568.18) was prepared in the same manner as in the preparation method of Compound 1-1, except that in Synthesis Example 1, 1-bromo-6-chlorodibenzo[b,d]furan was changed to 7-bromo-1-chlorodibenzo[b,d]thiophene, and 2-chloro-4-(dibenzo[b,d]furan-4-yl)-6-phenyl-1,3,5-triazine was changed to 2-chloro-4,6-diphenyl-1,3,5-triazine.

### Synthesis Example 7: Synthesis of Compound 1-7

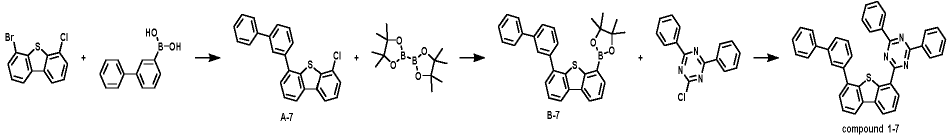

Compound 1-7 (MS[M+H]⁺= 568.18) was prepared in the same manner as in the preparation method of Compound 1-1, except that in Synthesis Example 1, 1-bromo-6-chlorodibenzo[b,d]furan was changed to 4-bromo-6-chlorodibenzo[b,d]thiophene, [1,1'-biphenyl]-4-ylboronic acid was changed to [1,1'-biphenyl]-3-ylboronic acid, and 2-chloro-4-(dibenzo[b,d]furan-4-yl)-6-phenyl-1,3,5-triazine was changed to 2-chloro-4,6-diphenyl-1,3,5-triazine.

### Synthesis Example 8: Synthesis of Compound 1-8

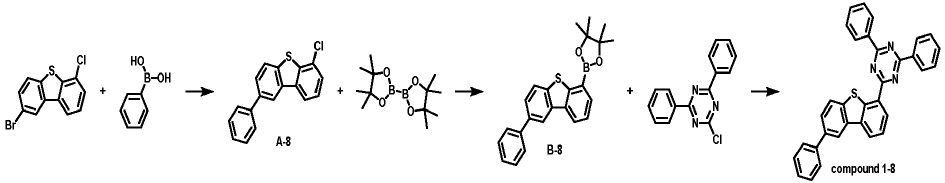

Compound 1-8 (MS[M+H]⁺= 568.18) was prepared in the same manner as in the preparation method of Compound 1-1, except that in Synthesis Example 1, 1-bromo-6-chlorodibenzo[b,d]furan was changed to 2-bromo-6-chlorodibenzo[b,d]thiophene, [1,1'-biphenyl]-4-ylboronic acid was changed to phenylboronic acid, and 2-chloro-4-(dibenzo[b,d]furan-4-yl)-6-phenyl-1,3,5-triazine was changed to 2-chloro-4,6-diphenyl-1,3,5-triazine.

### Synthesis Example 9: Synthesis of Compound 2-1

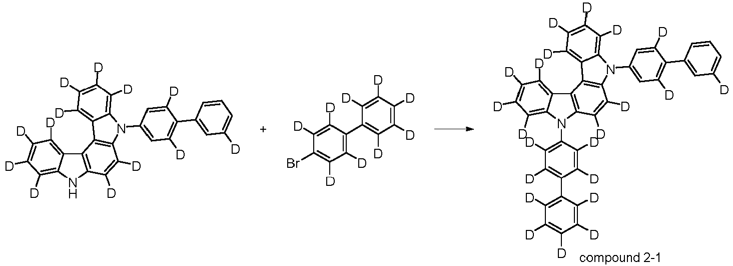

5-([1,1'-biphenyl]-4-yl-2,3',6-d3)-5,8-dihydroindolo[2,3-c]carbazole-1,2,3,4,6,7,9,10,11,12-d10 (20 g, 47.4 mmol) and 4-bromo-1,1'-biphenyl-2,2',3,3',4',5,5',6,6'-d9 (11.5 g, 47.4mmol) were added to 400 ml of xylene under a nitrogen atmosphere, and the mixture was stirred and refluxed. Then, sodium tert-butoxide (13.7 g, 142.3mmol) was added thereto, and the mixture was sufficiently stirred and then bis(tri-tert-butylphosphine)palladium (0.7 g, 1.4 mmol) was added. After the reaction for 6 hours, the reaction mixture was cooled to room temperature, and the organic layer was filtered to remove salts, and then the filtered organic layer was distilled. This was again added to and dissolved in 1382 ml (50 times the amount) of toluene, washed twice with water, and then the organic layer was separated, anhydrous magnesium sulfate was added thereto, stirred, and then filtered, and the filtrate was distilled under reduced pressure. The concentrated compound was recrystallized from toluene and ethyl acetate to prepare a white solid compound 2-1 (21.3 g, 77%, MS: [M+H]+ = 583.8).

### Synthesis Example 10: Synthesis of Compound 2-2

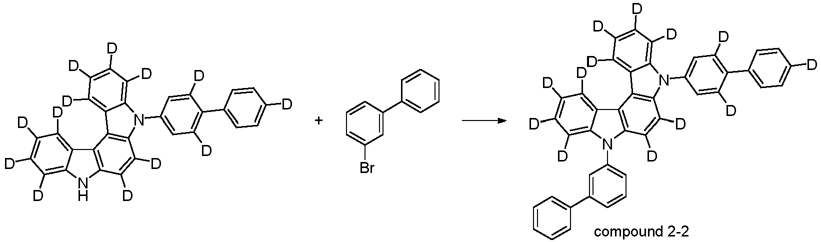

Compound 2-2 (MS[M+H]⁺= 574.31) was prepared in the same manner as in the preparation method of Compound 2-1, except that in Synthesis Example 9, 4-bromo-1,1'-biphenyl-2,2',3,3',4',5,5',6,6'-d9 was changed to 3-bromo-1,1'-biphenyl.

### Synthesis Example 11: Synthesis of Compound 2-3

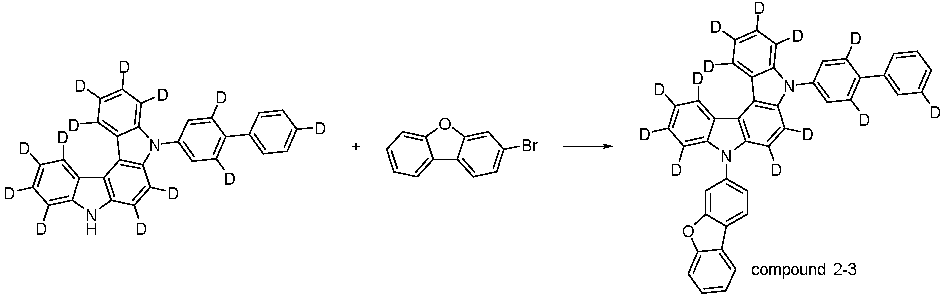

Compound 2-3 (MS[M+H]⁺= 588.29) was prepared in the same manner as in the preparation method of Compound 2-1, except that in Synthesis Example 9, 4-bromo-1,1'-biphenyl-2,2',3,3',4',5,5',6,6'-d9 was changed to 3-bromodibenzo[b,d]furan .

### Synthesis Example 12: Synthesis of Compound 2-4

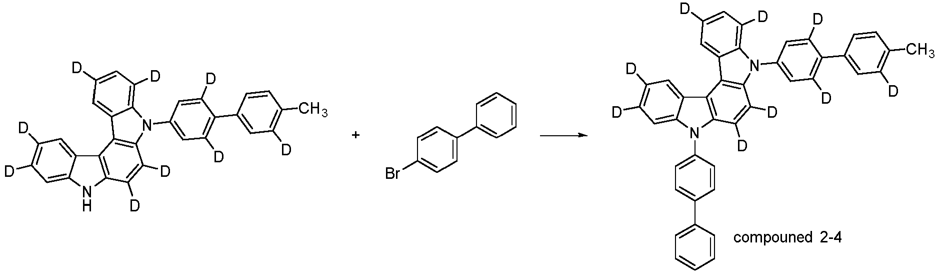

Compound 2-4 (MS[M+H]⁺= 584.30) was prepared in the same manner as in the preparation method of Compound 2-1, except that in Synthesis Example 9, 5-([1,1'-biphenyl]-4-yl-2,3',6-d3)-5,8-dihydroindolo[2,3-c]carbazole-1,2,3,4,6,7,9,10,11,12-d10 was changed to 5-(4'-methyl-[1,1'-biphenyl]-4-yl-2,3',6-d3)-5,8-dihydroindolo[2,3-c]carbazole-2,4,6,7,10,11-d6, and 4-bromo-1,1'-biphenyl-2,2',3,3',4',5,5',6,6'-d9 was changed to 4-bromo-1,1'-biphenyl.

### Synthesis Example 13: Synthesis of Compound 2-5

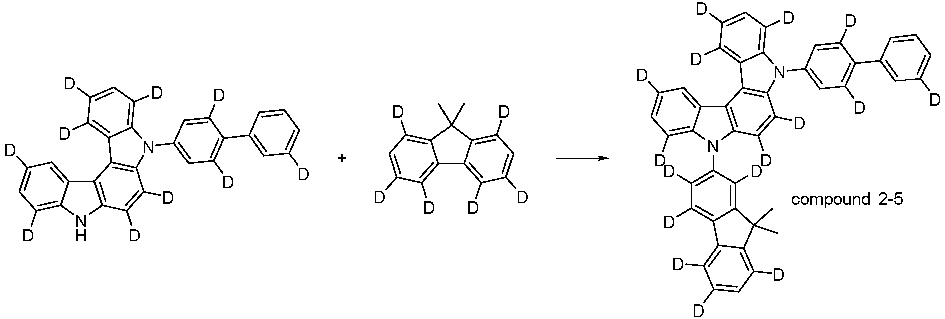

Compound 2-5 (MS[M+H]⁺= 617.36) was prepared in the same manner as in the preparation method of Compound 2-1, except that in Synthesis Example 9, 5-([1,1'-biphenyl]-4-yl-2,3',6-d3)-5,8-dihydroindolo[2,3-c]carbazole-1,2,3,4,6,7,9,10,11,12-d10 was changed to 5-([1,1'-biphenyl]-4-yl-2,3',6-d3)-5,8-dihydroindolo[2,3-c]carbazole-1,2,4,6,7,9,11-d7, and 4-bromo-1,1'-biphenyl-2,2',3,3',4',5,5',6,6'-d9 was changed to 9,9-dimethyl-9H-fluorene-1,3,4,5,6,8-d6.

### Synthesis Example 14: Synthesis of Compound 2-6

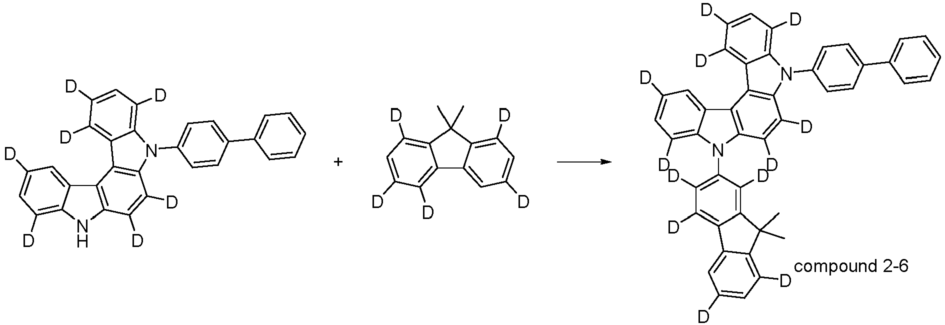

Compound 2-6 (MS[M+H]⁺= 613.33) was prepared in the same manner as in the preparation method of Compound 2-1, except that in Synthesis Example 9, 5-([1,1'-biphenyl]-4-yl-2,3',6-d3)-5,8-dihydroindolo[2,3-c]carbazole-1,2,3,4,6,7,9,10,11,12-d10 was changed to 5-([1,1'-biphenyl]-4-yl)-5,8-dihydroindolo[2,3-c]carbazole-1,2,4,6,7,9,11-d7, and 4-bromo-1,1'-biphenyl-2,2',3,3',4',5,5',6,6'-d9 was changed to 9,9-dimethyl-9H-fluorene-1,3,4,6,8-d5.

### Synthesis Example 15: Synthesis of Compound 2-7

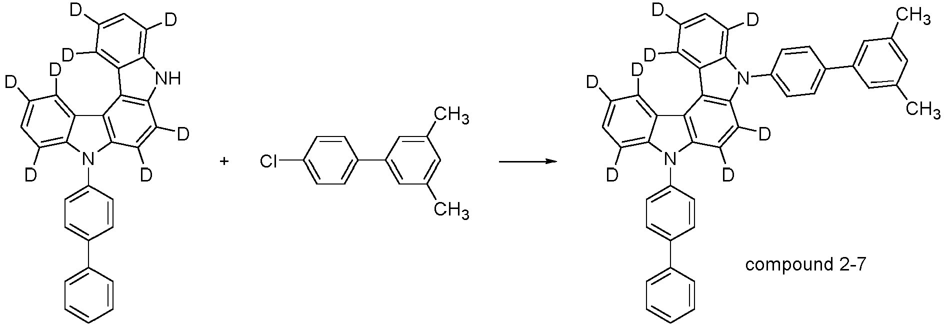

Compound 2-7 (MS[M+H]⁺= 597.31) was prepared in the same manner as in the preparation method of Compound 2-1, except that in Synthesis Example 9, 5-([1,1'-biphenyl]-4-yl-2,3',6-d3)-5,8-dihydroindolo[2,3-c]carbazole-1,2,3,4,6,7,9,10,11,12-d10 was changed to 5-([1,1'-biphenyl]-4-yl)-5,8-dihydroindolo[2,3-c]carbazole-1,2,4,6,7,9,11,12-d8, 4-bromo-1,1'-biphenyl-2,2',3,3',4',5,5',6,6'-d9 was changed to 4'-chloro-3,5-dimethyl-1,1'-biphenyl .

### Synthesis Example 16: Synthesis of Compound 2-8

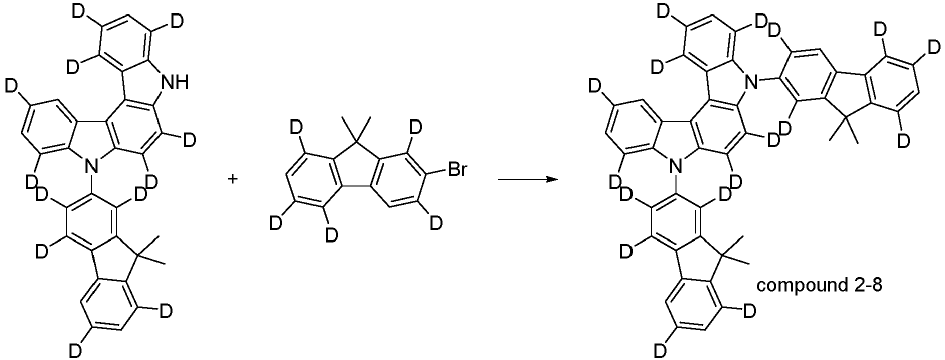

Compound 2-8 (MS[M+H]⁺= 658.39) was prepared in the same manner as in the preparation method of Compound 2-1, except that in Synthesis Example 9, 5-([1,1'-biphenyl]-4-yl-2,3',6-d3)-5,8-dihydroindolo[2,3-c]carbazole-1,2,3,4,6,7,9,10,11,12-d10 was changed to 5-(9,9-dimethyl-9H-fluoren-2-yl-1,3,4,6,8-d5)-5,8-dihydroindolo[2,3-c]carbazole-2,4,6,7,9,11,12-d7, and 4-bromo-1,1'-biphenyl-2,2',3,3',4',5,5',6,6'-d9 was changed to 2-bromo-9,9-dimethyl-9H-fluorene-1,3,5,6,8-d5.

### Synthesis Example 17: Synthesis of Compound 2-9

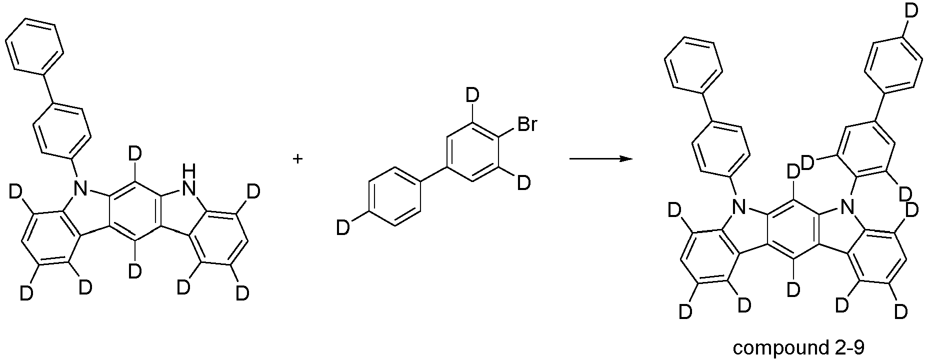

Compound 2-9 (MS[M+H]⁺= 572.29) was prepared in the same manner as in the preparation method of Compound 2-1, except that in Synthesis Example 9, 5-([1,1'-biphenyl]-4-yl-2,3',6-d3)-5,8-dihydroindolo[2,3-c]carbazole-1,2,3,4,6,7,9,10,11,12-d10 was changed to 5-([1,1'-biphenyl]-4-yl)-5,7-dihydroindolo[2,3-b]carbazole-1,2,4,6,8,10,11,12-d8, and 4-bromo-1,1'-biphenyl-2,2',3,3',4',5,5',6,6'-d9 was changed to 4-bromo-1,1'-biphenyl-3,4',5-d3.

### Synthesis Example 18: Synthesis of Compound 2-10

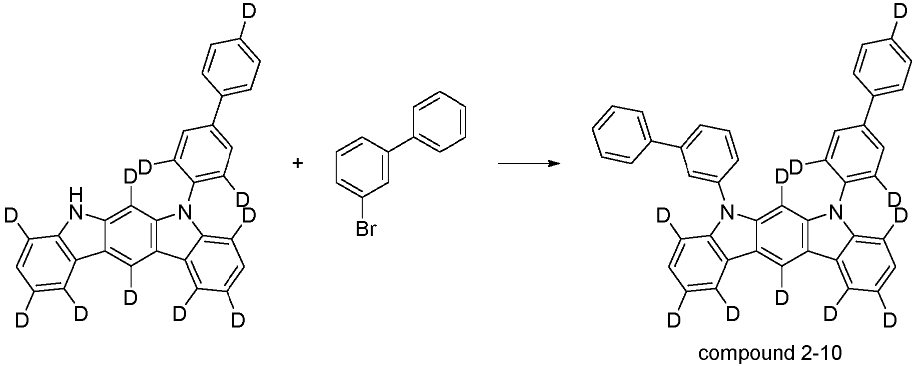

Compound 2-10 (MS[M+H]⁺= 572.29) was prepared in the same manner as in the preparation method of Compound 2-1, except that in Synthesis Example 9, 5-([1,1'-biphenyl]-4-yl-2,3',6-d3)-5,8-dihydroindolo[2,3-c]carbazole-1,2,3,4,6,7,9,10,11,12-d10 was changed to 5-([1,1'-biphenyl]-4-yl-3,4',5-d3)-5,7-dihydroindolo[2,3-b]carbazole-1,2,4,6,8,10,11,12-d8, and 4-bromo-1,1'-biphenyl-2,2',3,3',4',5,5',6,6'-d9 was changed to 3-bromo-1,1'-biphenyl.

### [PREPARATION EXAMPLE: Preparation of Organic Alloy]

### Preparation Example 1

Compound 1-1 and Compound 2-1 were mixed and placed in a weight ratio of 40:60 in a vacuum chamber. The two mixtures were melted by increasing the temperature under a pressure of 10⁻² Torr or less, and then the mixture was cooled to room temperature after 1 hour to obtain a solid product. This product was ground with a mixer to obtain a powdery organic alloy 1.

### Preparation Example 2 to Preparation Example 10 and Preparation Example A to Preparation Example B

Organic alloys 2 to 10 and organic alloys A to B were prepared in the same manner as in the preparation method of organic alloy 1, except that the materials to be mixed were changed as shown in Table 1 below. Compounds GH-1 to Compound GH-4 of Table 1 are as follows.

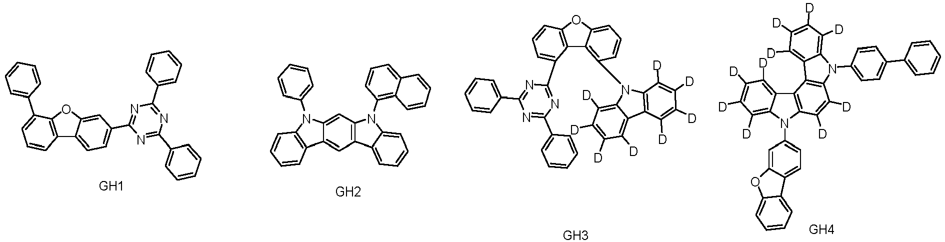

**[Table 1]**

| Preparation Example | Organic alloy | Mixed material 1 | Mixed material 2 | Mixing ratio (weight ratio) |
|---|---|---|---|---|
| Preparation Example 1 | Organic alloy 1 | Compound 1-1 | Compound 2-1 | 40:60 |
| Preparation Example 2 | Organic alloy 2 | Compound 1-2 | Compound 2-2 | 40:60 |
| Preparation Example 3 | Organic alloy 3 | Compound 1-3 | Compound 2-3 | 40:60 |
| Preparation Example 4 | Organic alloy 4 | Compound 1-4 | Compound 2-4 | 40:60 |
| Preparation Example 5 | Organic alloy 5 | Compound 1-5 | Compound 2-5 | 40:60 |
| Preparation Example 6 | Organic alloy 6 | Compound 1-6 | Compound 2-6 | 40:60 |
| Preparation Example 7 | Organic alloy 7 | Compound 1-7 | Compound 2-7 | 40:60 |
| Preparation Example 8 | Organic alloy 8 | Compound 1-8 | Compound 2-8 | 40:60 |
| Preparation Example 9 | Organic alloy 9 | Compound 1-5 | Compound 2-9 | 40:60 |
| Preparation Example 10 | Organic alloy 10 | Compound 1-7 | Compound 2-10 | 40:60 |
| Preparation Example A | Organic alloy A | Compound GH-1 | Compound GH-2 | 40:60 |
| Preparation Example B | Organic alloy B | Compound GH-3 | Compound GH-4 | 40:60 |

### [EXAMPLE: Manufacture of organic light emitting device]

### Example 1

A glass substrate on which a thin film of ITO (indium tin oxide) was coated in a thickness of 1400 Å was put into distilled water containing the detergent dissolved therein and washed by the ultrasonic wave. In this case, the used detergent was a product commercially available from Fisher Co. and the distilled water was one which had been twice filtered by using a filter commercially available from Millipore Co. The ITO was washed for 30 minutes, and ultrasonic washing was then repeated twice for 10 minutes by using distilled water. After the washing with distilled water was completed, the substrate was ultrasonically washed with isopropyl alcohol, acetone, and methanol solvent, and dried, after which it was transported to a plasma cleaner. Then, the substrate was cleaned with oxygen plasma for 5 minutes, and then transferred to a vacuum evaporator.

On the ITO transparent electrode thus prepared, 95 wt% of Compound HT-A and 5wt% of Compound PD were thermally vacuum-deposited to a thickness of 100 Å to form a hole injection layer, and then only Compound HT-A was deposited to a thickness of 1150 Å to form a hole transport layer. The following Compound HT-B was thermally vacuum-deposited to a thickness of 450 Å thereon to form an electron blocking layer.

Then, the organic alloy 1 prepared in Preparation Example 1 and Compound GD as a dopant material were vacuum-deposited in a weight ratio of 92:8 to a thickness of 350 Å on the electron blocking layer to form a light emitting layer.

Then, the following Compound ET-A was vacuum-deposited to a thickness of 50 Å as a hole blocking layer. Then, the following Compound ET-B and the following Compound Liq were thermally vacuum-deposited in a weight ratio of 1:1 to a thickness of 300 Å as an electron transport layer, and then Yb(ytterbium) was vacuum-deposited to a thickness of 10 Å as an electron injection layer.

Magnesium and silver were deposited in a weight ratio of 1: 4 to a thickness of 150 Å on the electron injection layer to form a cathode, thereby completing the manufacture of an organic light emitting device.

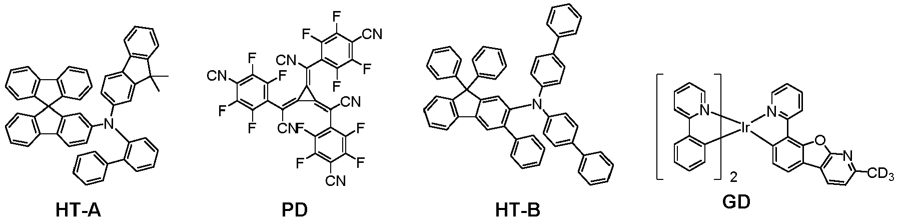

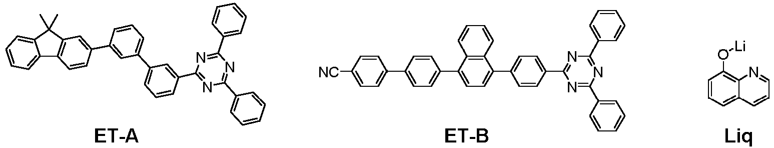

In the above-mentioned process, the vapor deposition rate of the organic material was maintained at 0.4 ~ 0.7 Å/sec, the deposition rate of magnesium and silver was maintained at 2 Å/sec, and the degree of vacuum during the deposition was maintained at 2x10⁻⁷ ~ 5x10⁻⁶ torr, thereby manufacturing an organic light emitting device.

### Examples 2 to 10, and Comparative Examples 1 to 2

The organic light emitting devices of Examples 2 to 10 and Comparative Examples 1 to 2 were manufactured in the same manner as in Example 1, except that the host material was changed as shown in Table 2 below.

### [EXPERIMENTAL EXAMPLE]

The organic light emitting devices manufactured in Examples 1 to 10, and Comparative Examples 1 to 2 were heat-treated in an oven at 120°C for 30 minutes, then taken out, and the voltage, efficiency, and lifetime (T95) were measured by applying a current, and the results are shown in Table 2 below.

At this time, the driving voltage and efficiency were measured by applying a current density of 10 mA/cm², and T95 means the time (hr) required for the luminance to be reduced to 95% of the initial luminance at a current density of 20 mA/cm².

**[Table 2]**

| | Host material | Voltage (V) @ 10mA/cm² | Efficiency (cd/A) @ 10mA/cm² | Lifetime (T95, hr) @ 20mA/cm² |
|---|---|---|---|---|
| Example 1 | Organic compound 1 | 4.03 | 71.9 | 139 |
| Example 2 | Organic compound 2 | 4.36 | 74.9 | 128 |
| Example 3 | Organic compound 3 | 4.21 | 73.4 | 127 |
| Example 4 | Organic compound 4 | 4.10 | 70.1 | 120 |
| Example 5 | Organic compound 5 | 4.11 | 80.0 | 147 |
| Example 6 | Organic compound 6 | 4.05 | 65.4 | 124 |
| Example 7 | Organic compound 7 | 4.01 | 71.7 | 128 |
| Example 8 | Organic compound 8 | 4.22 | 76.2 | 127 |
| Example 9 | Organic compound 9 | 4.18 | 78.0 | 122 |
| Example 10 | Organic compound 10 | 3.99 | 80.4 | 150 |
| Example 11 | Simple mixture of Compound 1-1:Compound 2-1 in a weight ratio of 40:60 | 4.07 | 68.3 | 131 |
| Example 12 | Simple mixture of Compound 1-2:Compound 2-2 in a weight ratio of 40:60 | 4.40 | 72.1 | 120 |
| Example 13 | Simple mixture of Compound 1-3:Compound 2-4 in a weight ratio of 40:60 | 4.22 | 72.6 | 125 |
| Example 14 | Simple mixture of Compound 1-4:Compound 2-1 in a weight ratio of 40:60 | 4.17 | 66.3 | 123 |
| Example 15 | Simple mixture of Compound 1-5:Compound 2-7 in a weight ratio of 40:60 | 4.05 | 62.7 | 116 |
| Example 16 | Simple mixture of Compound 1-6:Compound 2-8 in a weight ratio of 40:60 | 4.25 | 71.9 | 123 |
| Comparative Example 1-1 | Organic compound A | 4.42 | 57.4 | 61 |
| Comparative Example 1-2 | Organic compound B | 4.51 | 53.2 | 72 |
| Comparative Example 2-1 | Simple mixture of Compound GH-1:Compound GH-2 in a weight ratio of 40:60 | 4.49 | 54.6 | 57 |
| Comparative Example 2-2 | Simple mixture of Compound GH-3:Compound GH-4 in a weight ratio of 40:60 | 4.53 | 52.7 | 63 |

Referring to Table 2, it can be confirmed that when the compound represented by Chemical Formula 1 and the compound represented by Chemical Formula 2 were used as a host for the light emitting layer of an organic light emitting device, it has low voltage and high efficiency characteristics, and has excellent lifespan characteristics, as compared with the compounds used in Comparative Examples. In addition, it can be confirmed that when an organic alloy prepared from the compound represented by Chemical Formula 1 and the compound represented by Chemical Formula 2 is used, the voltage, efficiency and lifespan characteristics are more excellent as compared with when the compounds of Chemical Formula 1 and Chemical Formula 2 are simply mixed and used.

**<Description of Symbols>**

| | | | |
|---|---|---|---|
| 1: | substrate | 2: | anode |
| 3: | light emitting layer | 4: | cathode |
| 5: | hole injection layer | 6: | hole transport layer |
| 7: | electron transport layer | 8: | electron injection layer |
| 9: | electron blocking layer | 10 : | hole blocking layer |

## Claims

1. An organic light emitting device comprising:
an anode; a cathode; and a light emitting layer between the anode and the cathode,
wherein the light emitting layer includes a compound represented by the following Chemical Formula 1 and a compound represented by the following Chemical Formula 2, 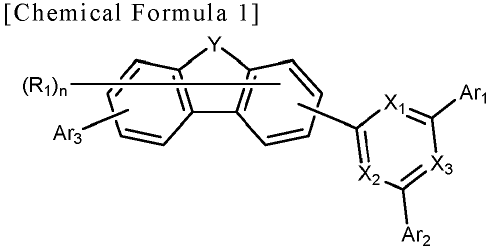
in Chemical Formula 1,
Y is O or S,
X₁ to X₃ are each independently CH or N, with the proviso that at least one of X₁ to X₃ is N,
Ar₁ and Ar₂ are each independently a substituted or unsubstituted C₆₋₆₀ aryl; or a substituted or unsubstituted C₂₋₆₀ heteroaryl containing one or more selected from the group consisting of N, O and S,
Ar₃ is a substituted or unsubstituted C₆₋₆₀ aryl,
n is an integer from 1 to 6, and
each R₁ is independently hydrogen; or deuterium; 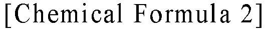 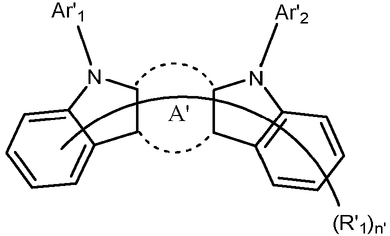
in Chemical Formula 2,
A' is a benzene ring fused with two adjacent pentagonal rings,
n' is an integer from 1 to 10,
R'₁ is hydrogen; deuterium; a substituted or unsubstituted C₆₋₆₀ aryl; or a substituted or unsubstituted C₂₋₆₀ heteroaryl containing one or more selected from the group consisting of N, O and S, and
Ar'₁ and Ar'₂ are each independently a substituted or unsubstituted C₆₋₆₀ aryl; or a substituted or unsubstituted C₂₋₆₀ heteroaryl containing one or more heteroatoms selected from the group consisting of N, O and S,
with the proviso that at least one of R'₁ is deuterium; and/or at least one of Ar'₁ and Ar'₂ is substituted with at least one deuterium.

2. The organic light emitting device according to claim 1, wherein:
at least two of X₁ to X₃ are N.

3. The organic light emitting device according to claim 1, wherein:
Ar₁ and Ar₂ are each independently phenyl; phenyl substituted with 5 deuteriums; biphenylyl; biphenylyl substituted with 5 deuteriums; terphenylyl; phenanthrenyl; carbazolyl; carbazolyl substituted with 6 deuteriums; dibenzofuranyl; dibenzothiophenyl; or triphenylenyl.

4. The organic light emitting device according to claim 1, wherein:
Ar₃ is phenyl; phenyl substituted with 5 deuteriums; biphenylyl; biphenylyl substituted with 5 deuteriums; terphenylyl; terphenylyl substituted with 5 deuteriums; terphenylyl substituted with one phenyl; naphthyl; naphthylphenyl; phenanthrenyl; triphenylenyl; triphenylenyl substituted with 9 deuteriums; triphenylenylphenyl; 9,9-dimethylfluorenyl; or 9,9'-spirobifluorenyl.

5. The organic light emitting device according to claim 1, wherein:
the compound represented by Chemical Formula 1 is any one selected from the group consisting of:

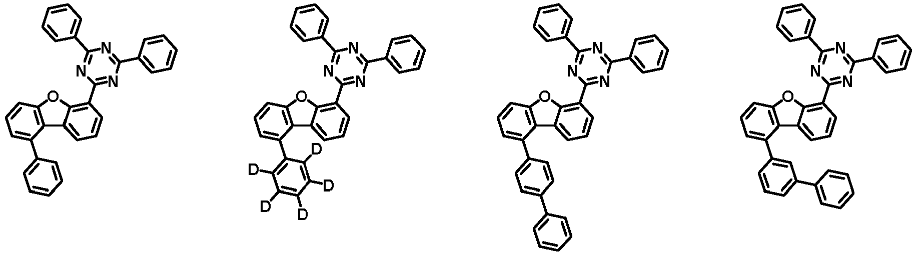

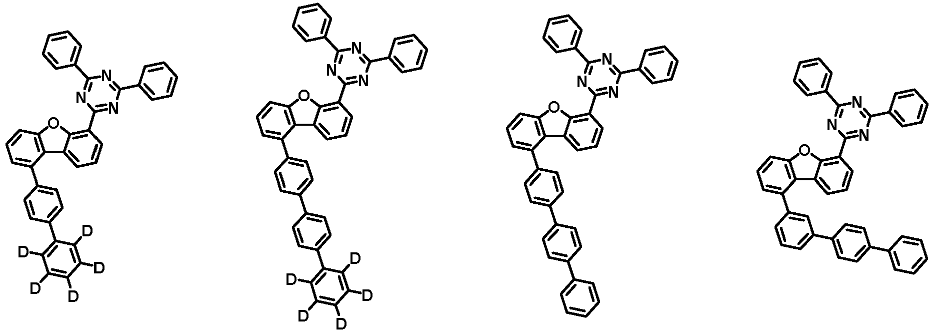

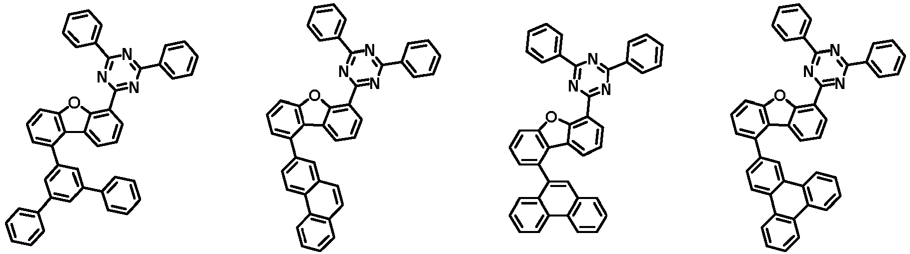

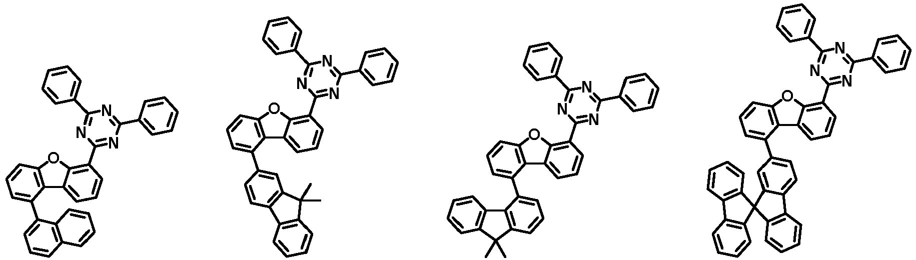

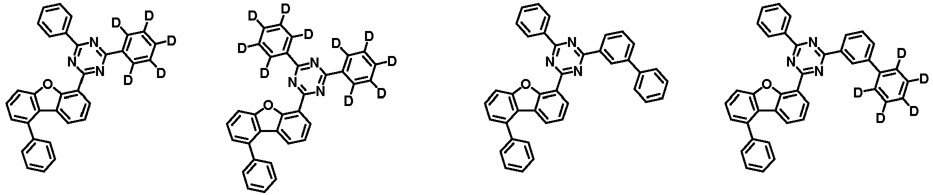

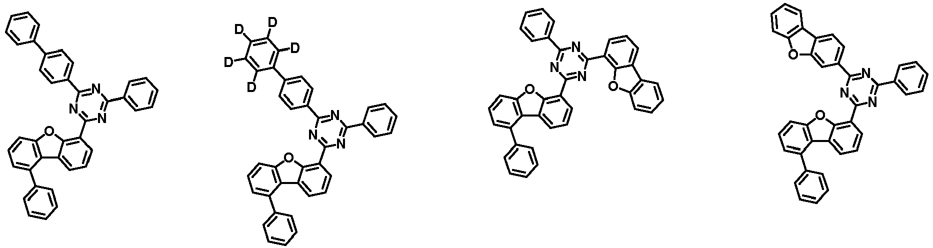

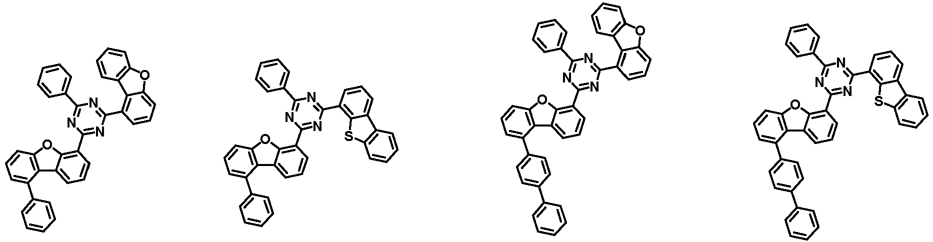

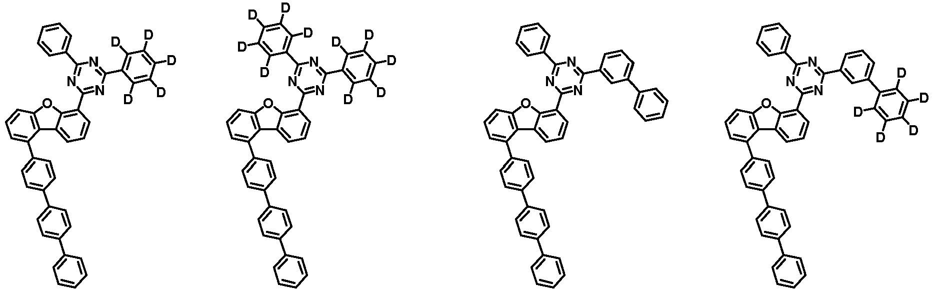

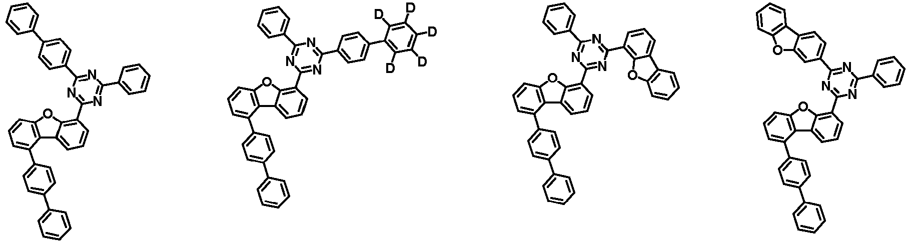

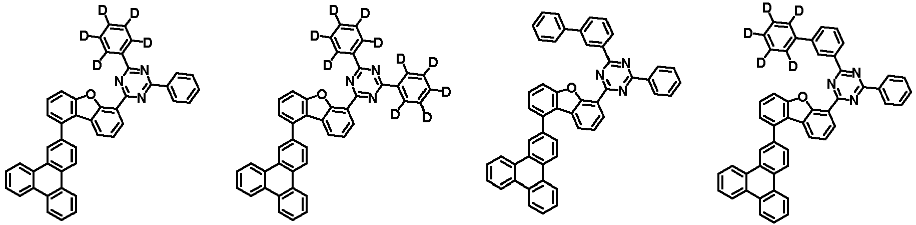

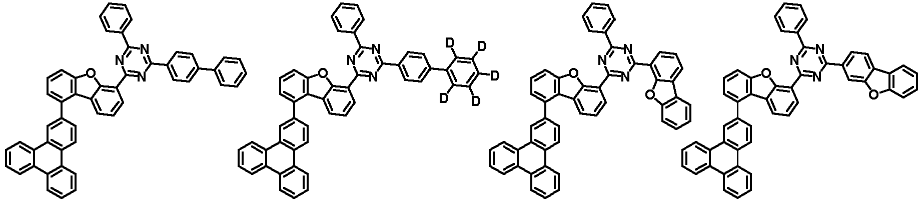

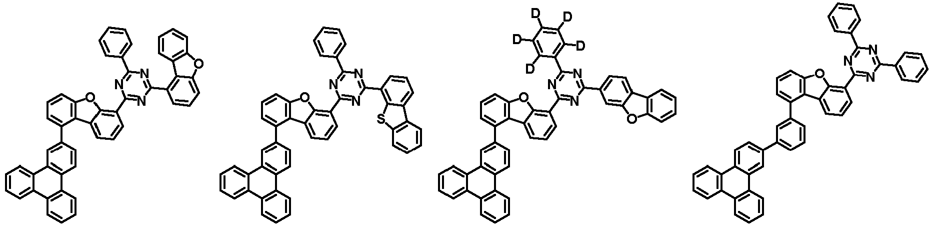

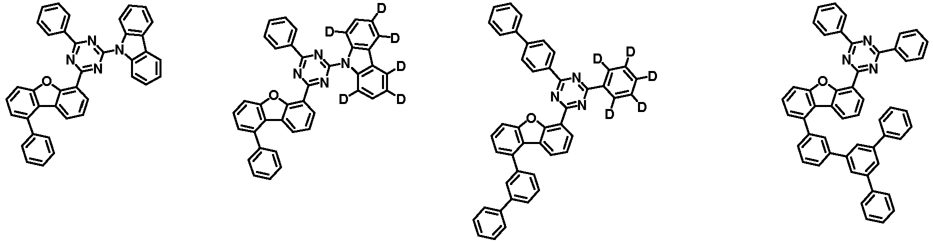

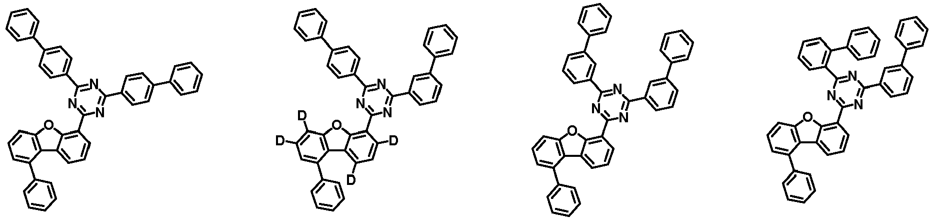

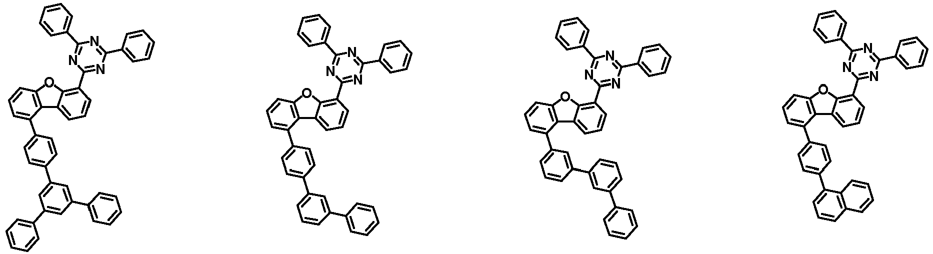

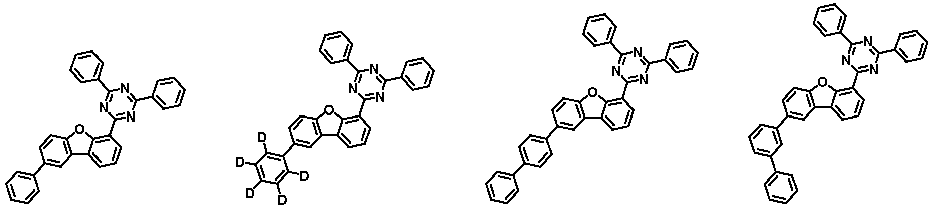

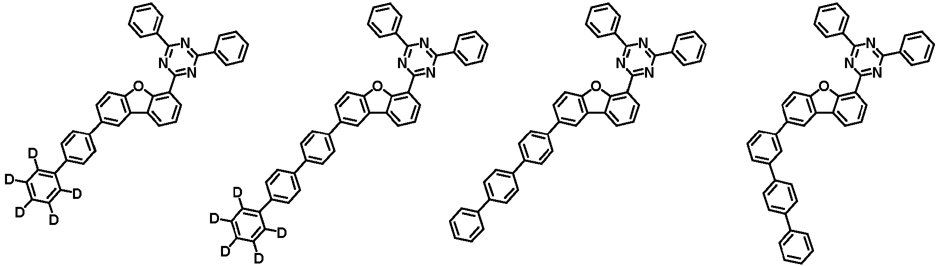

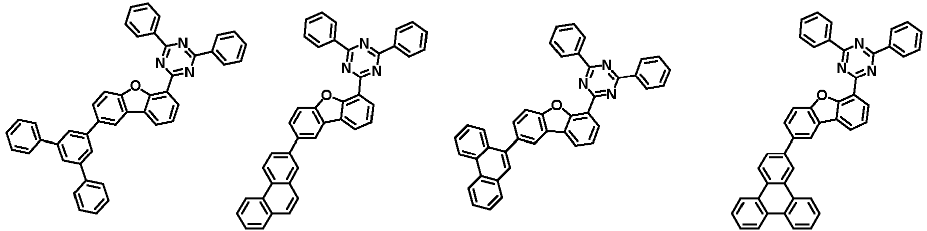

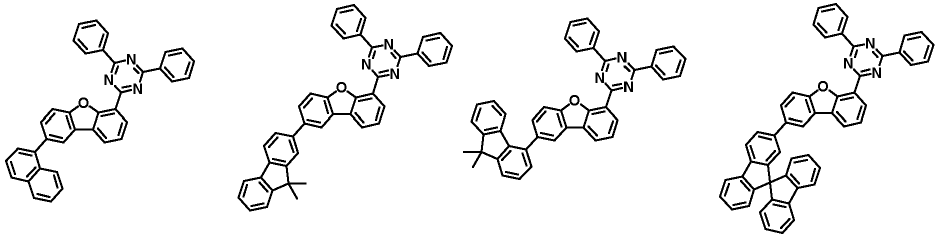

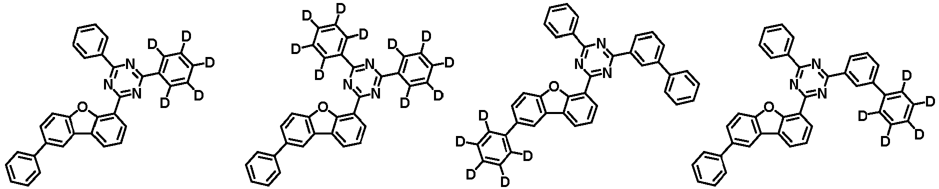

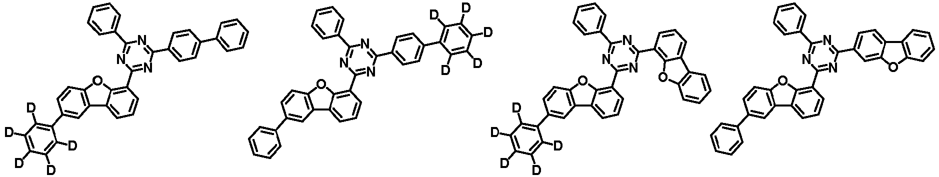

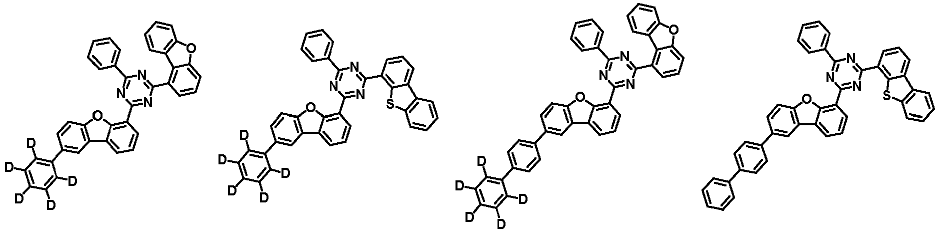

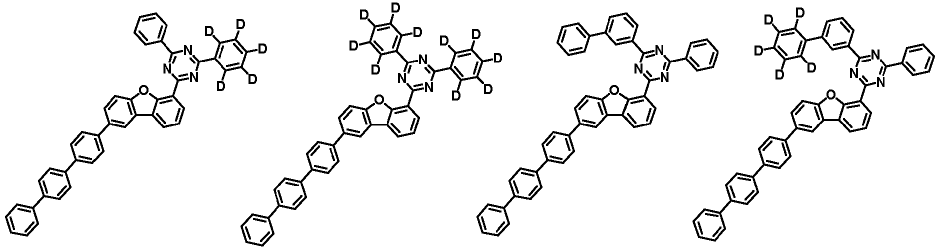

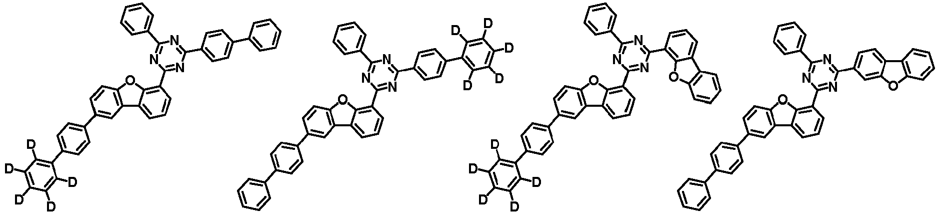

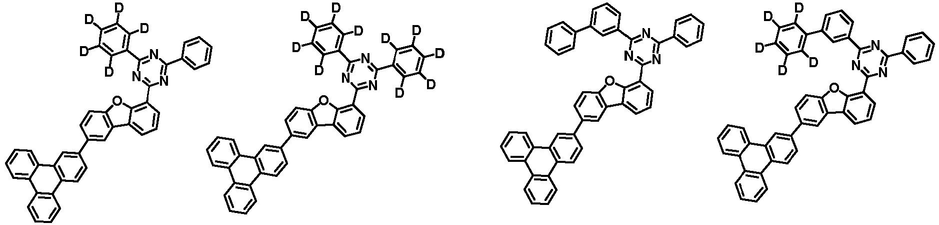

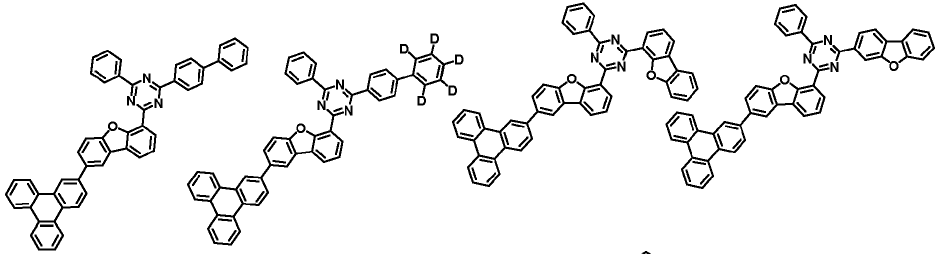

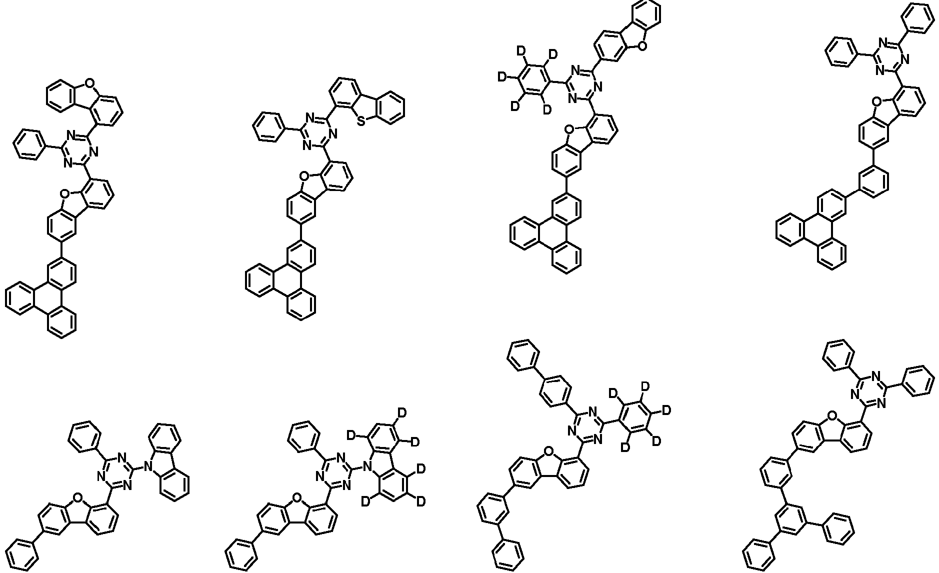

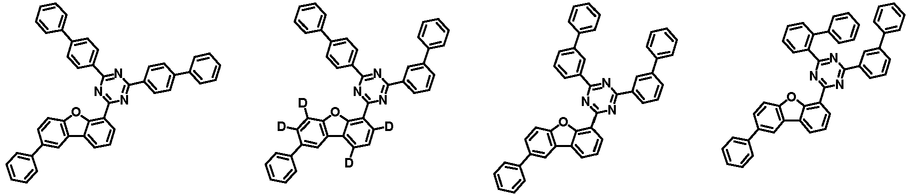

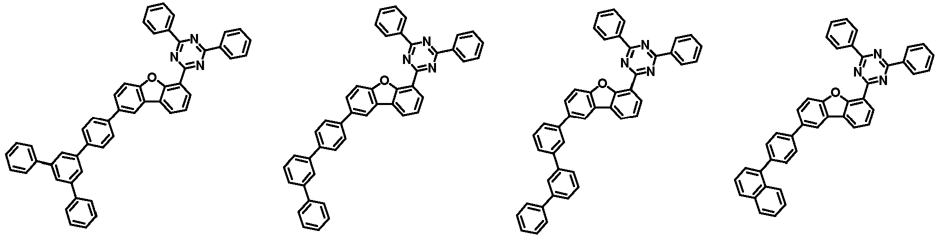

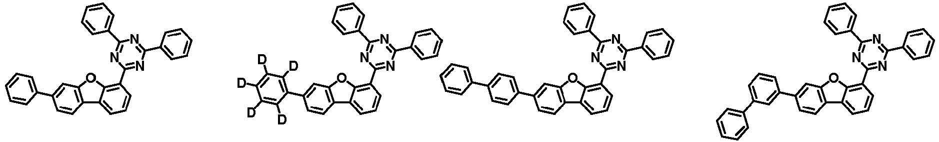

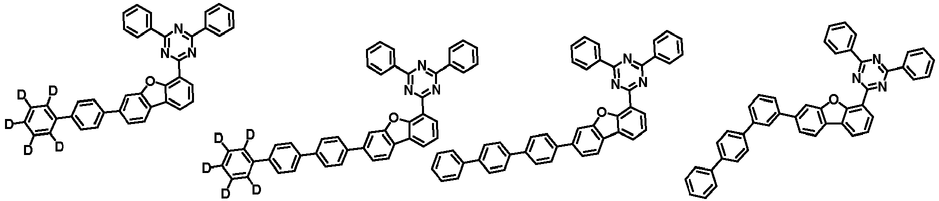

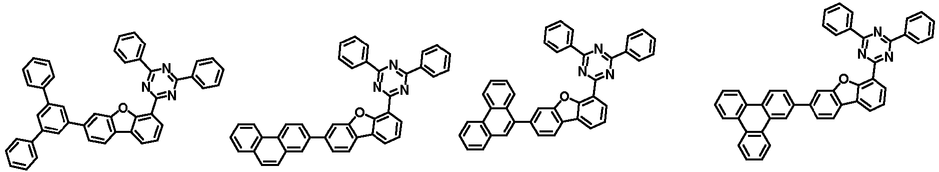

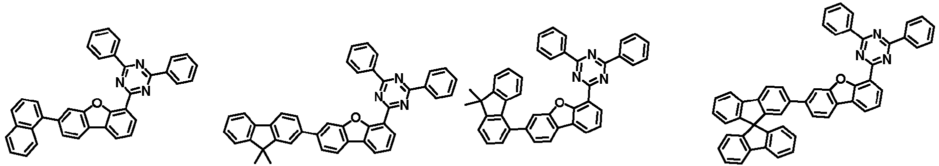

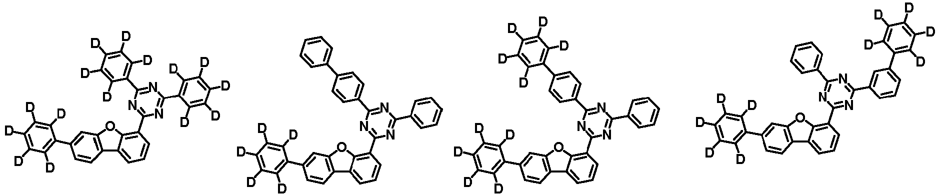

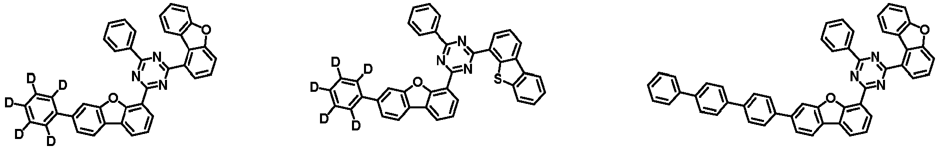

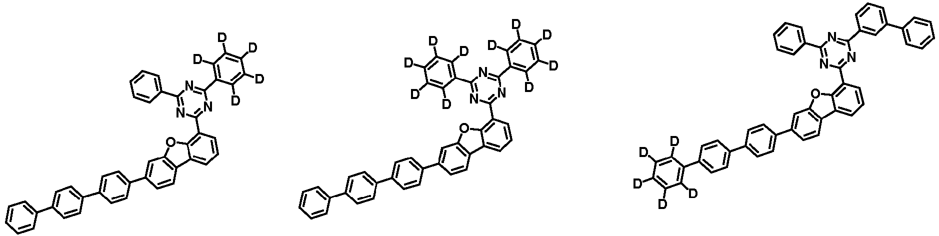

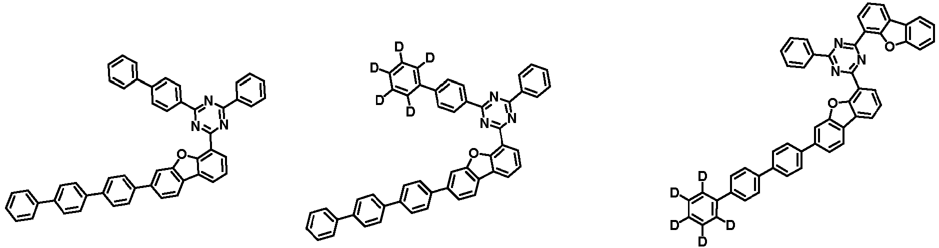

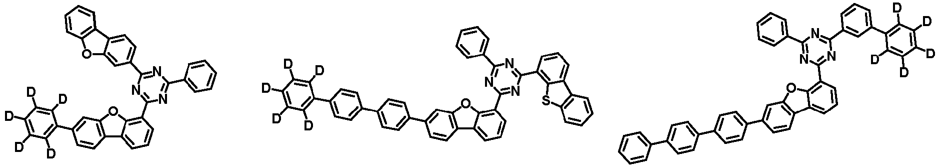

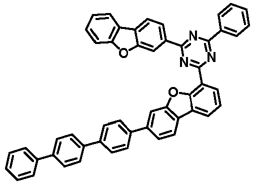

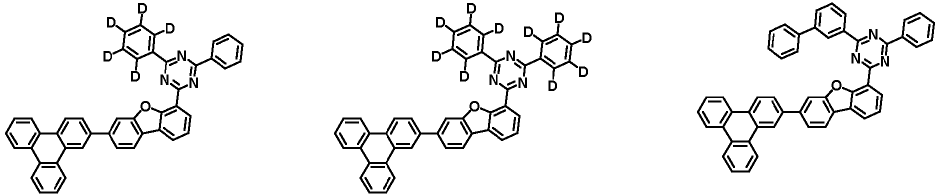

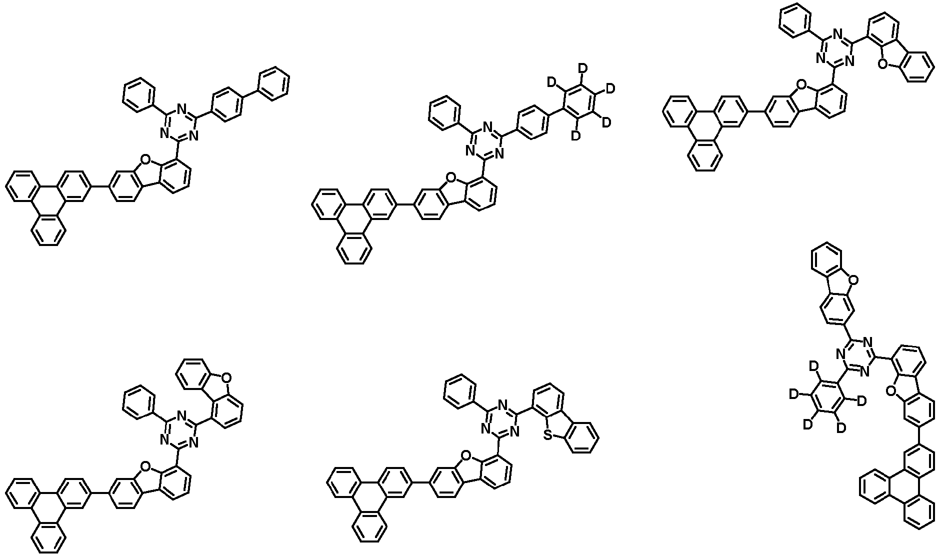

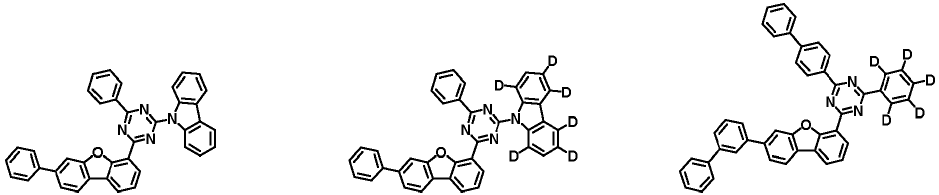

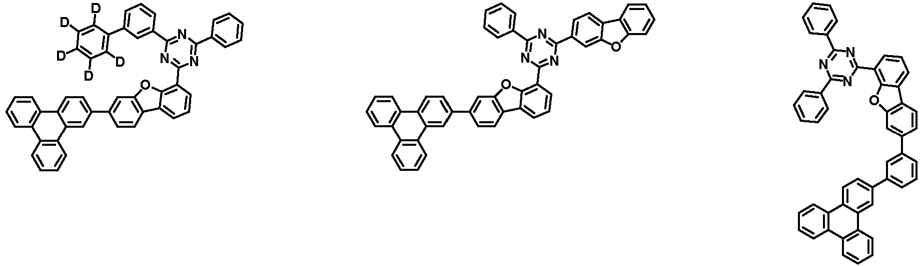

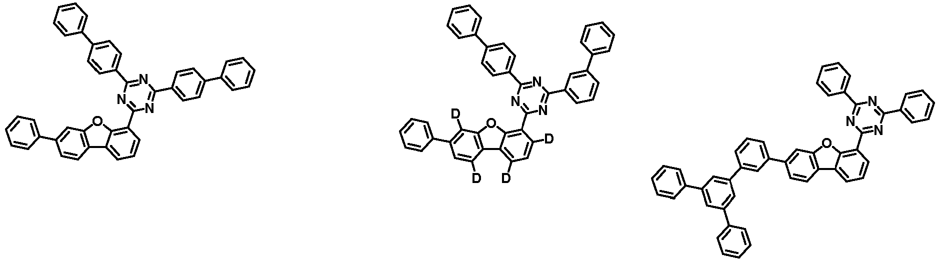

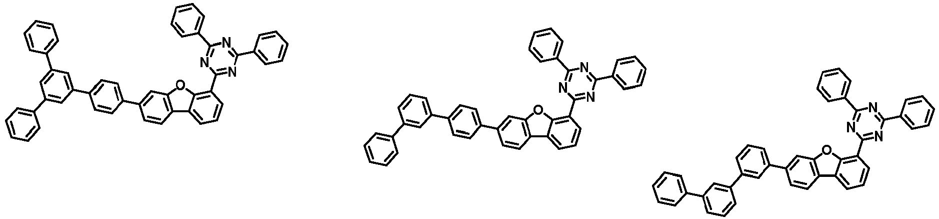

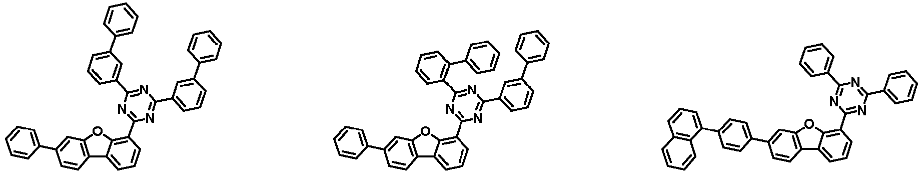

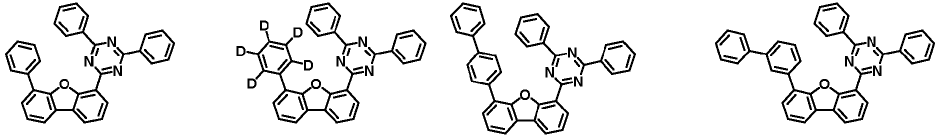

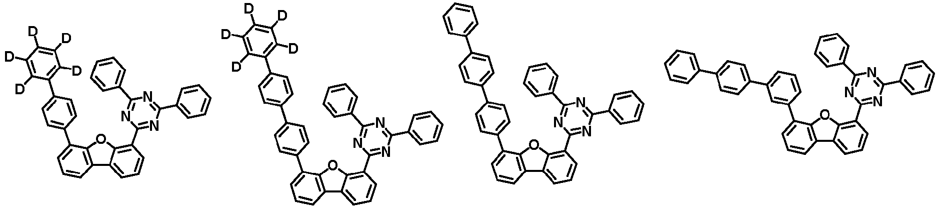

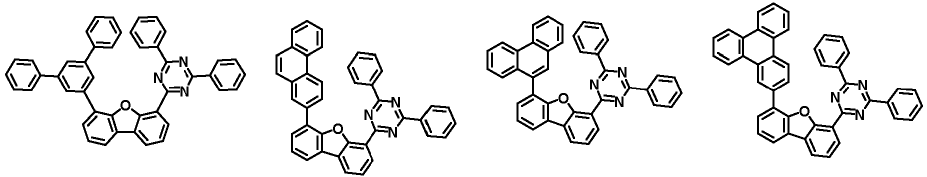

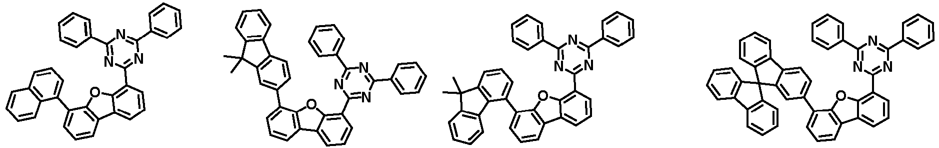

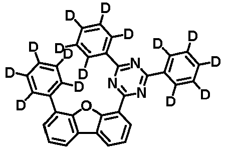

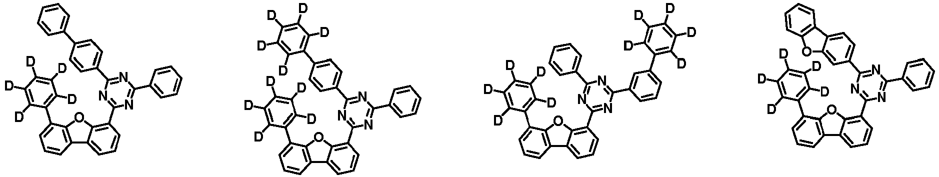

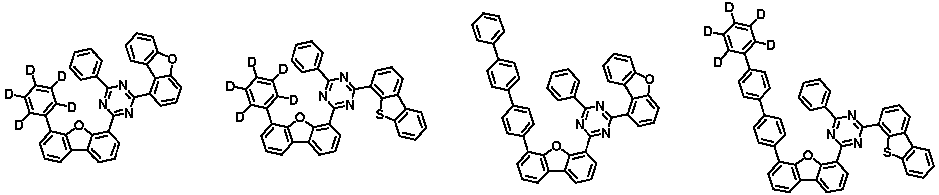

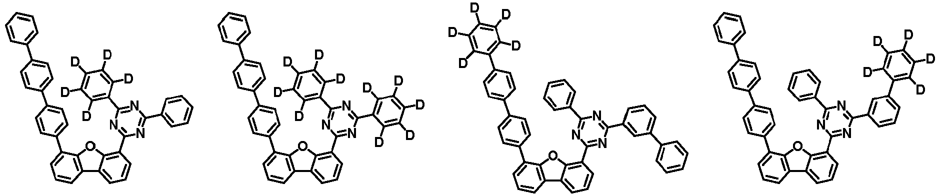

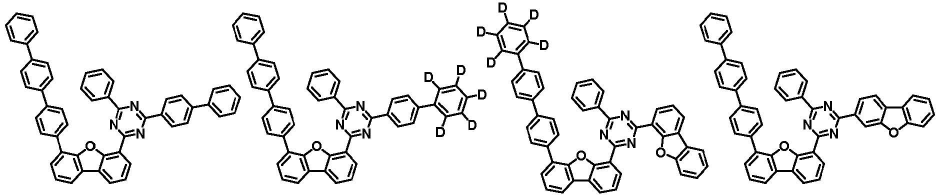

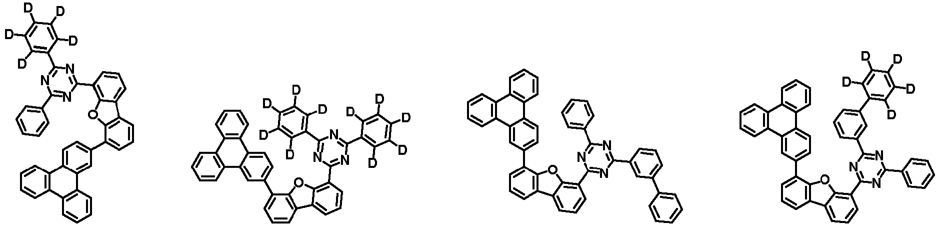

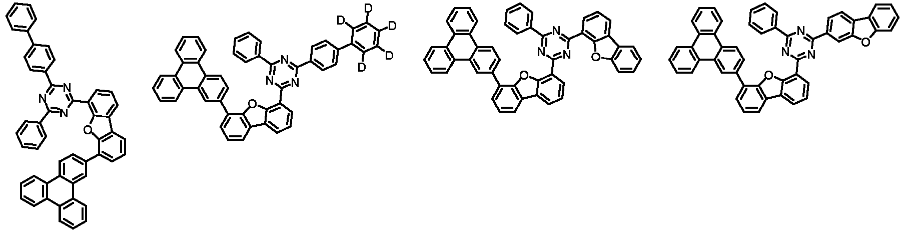

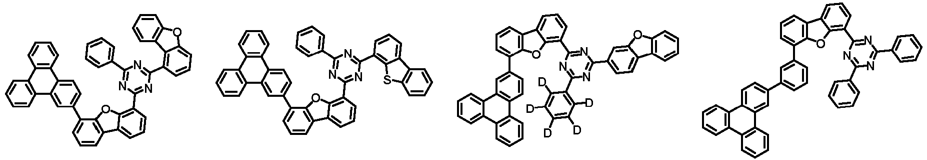

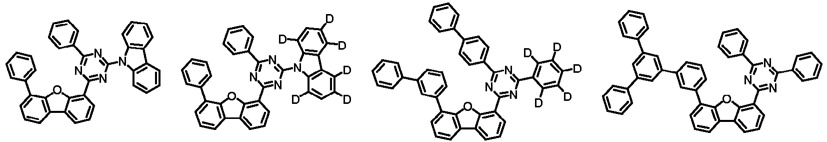

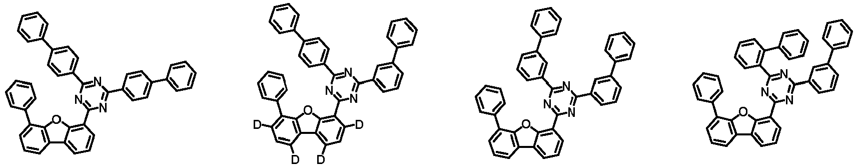

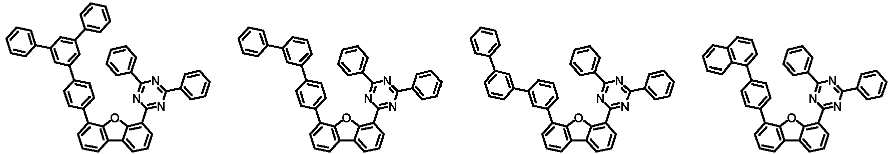

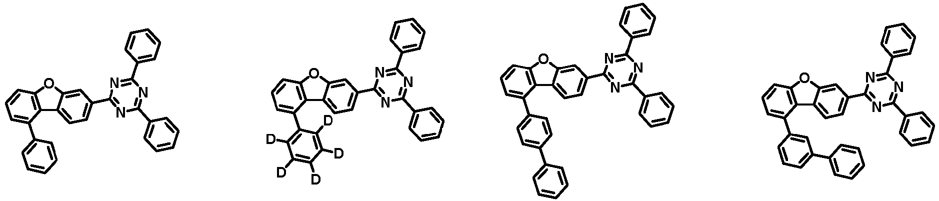

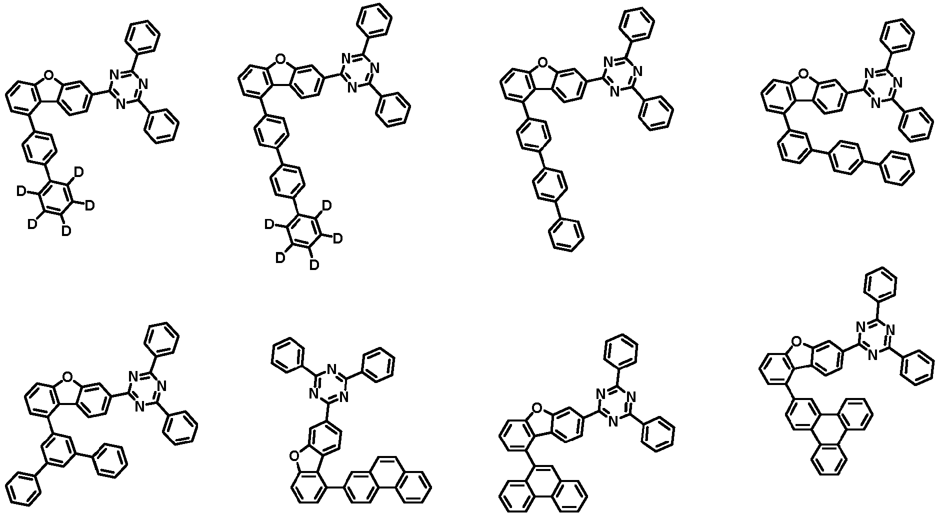

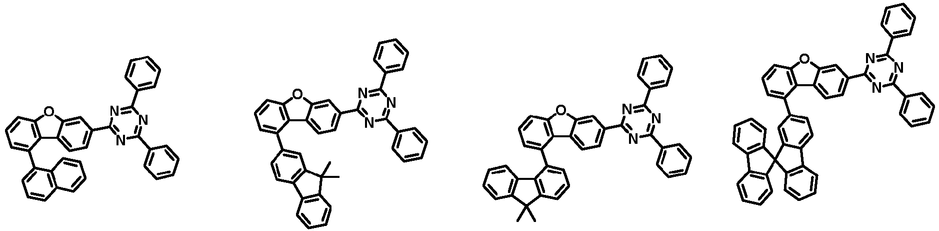

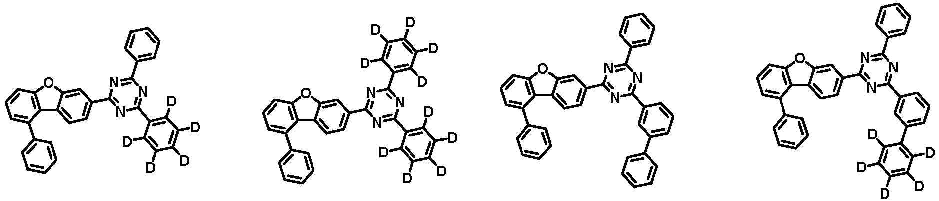

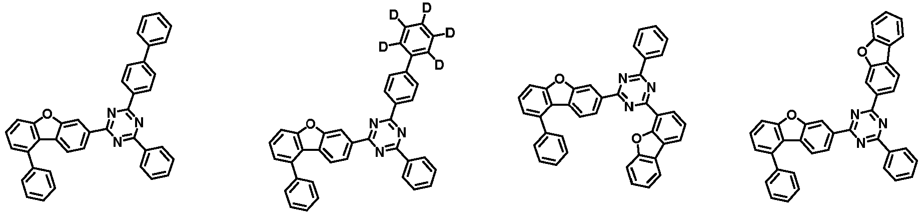

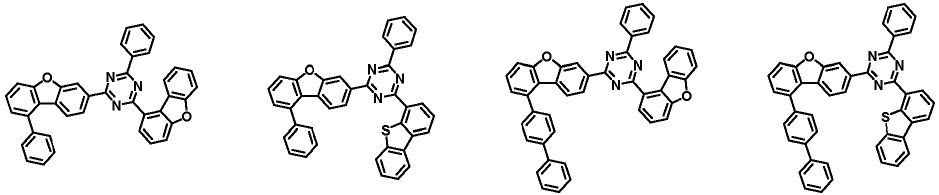

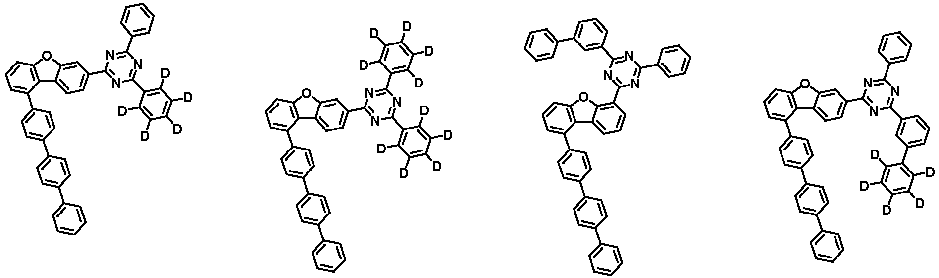

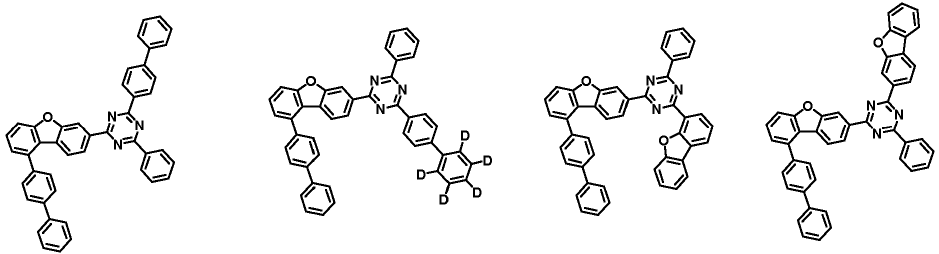

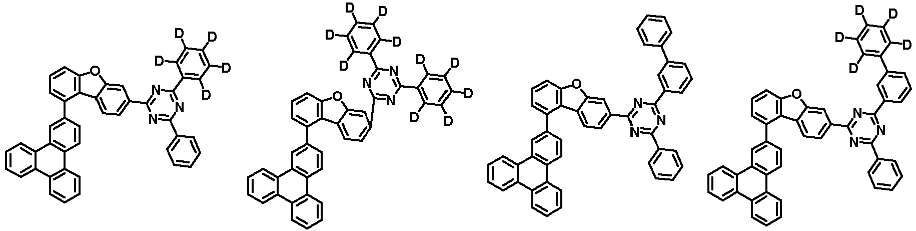

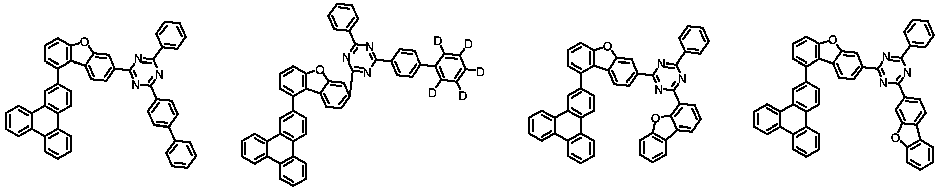

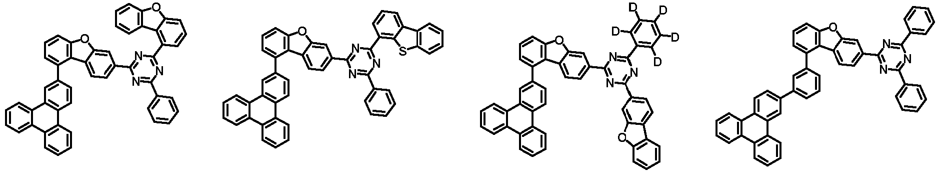

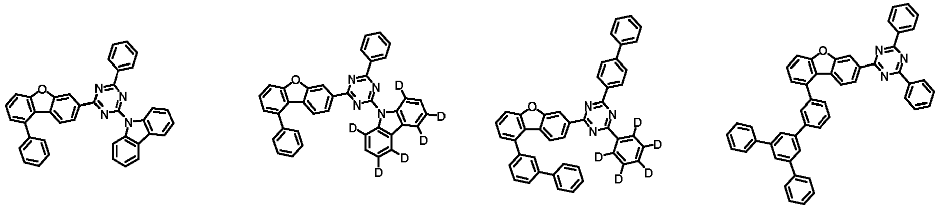

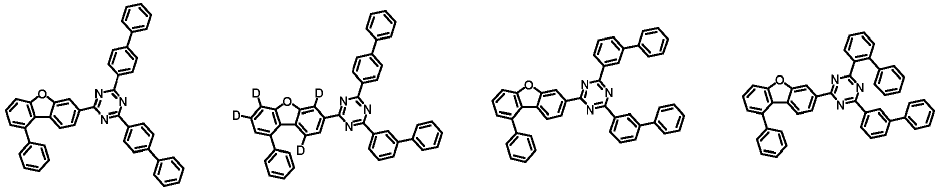

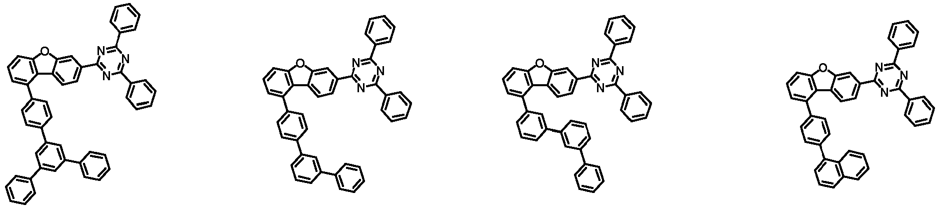

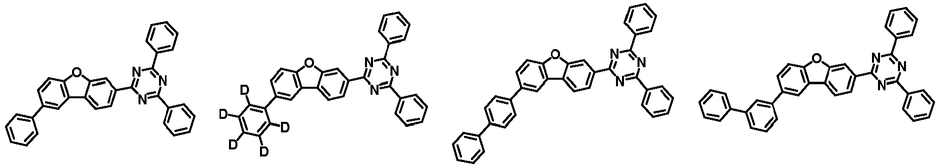

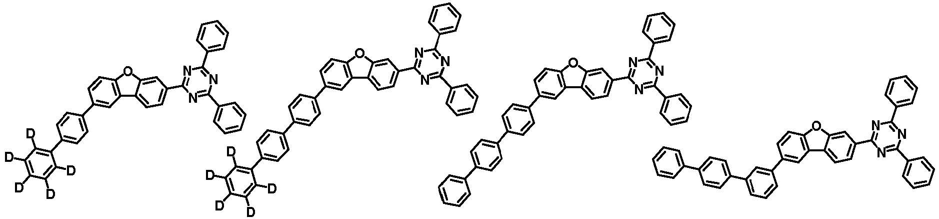

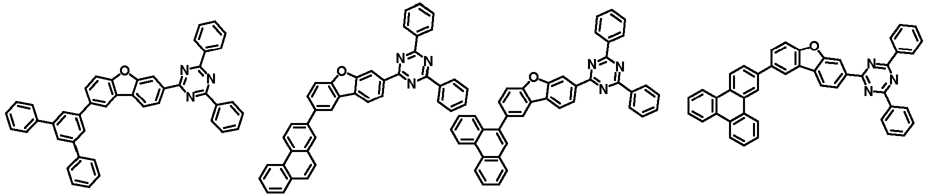

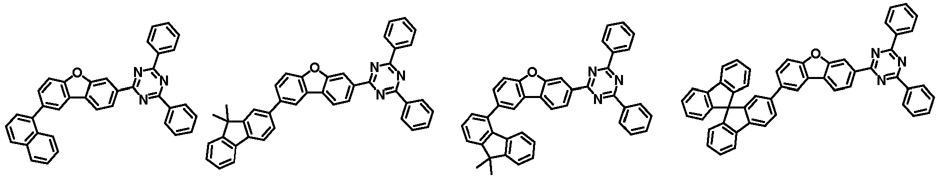

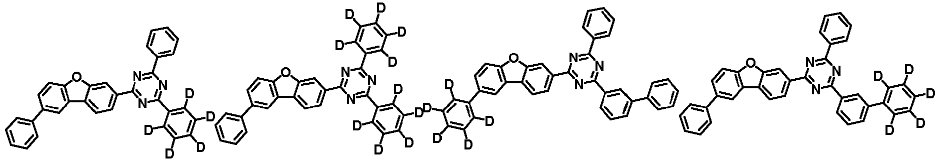

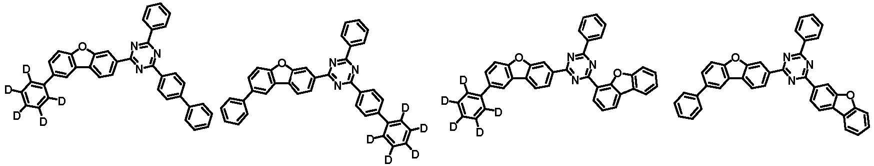

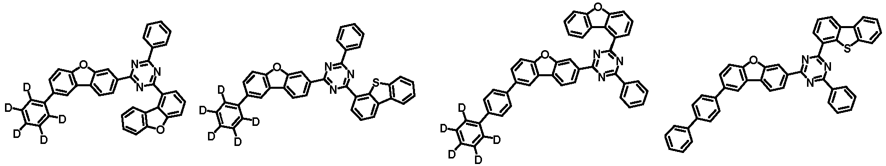

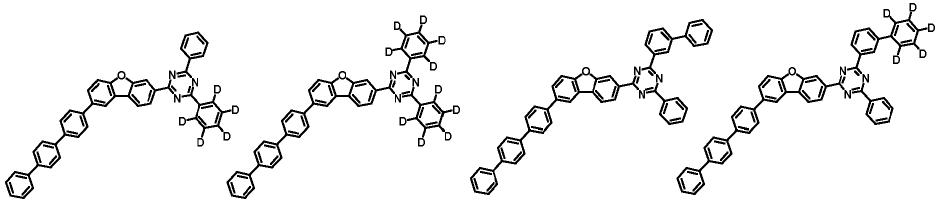

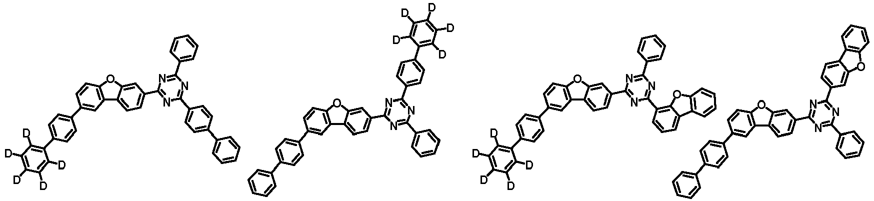

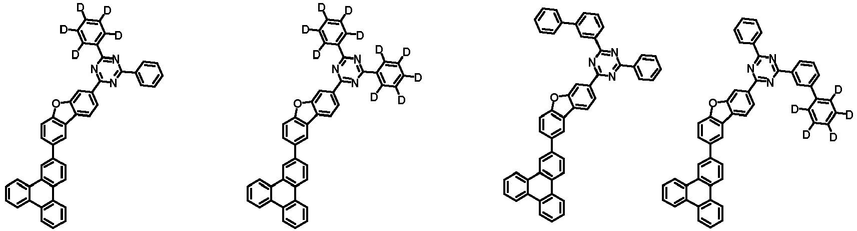

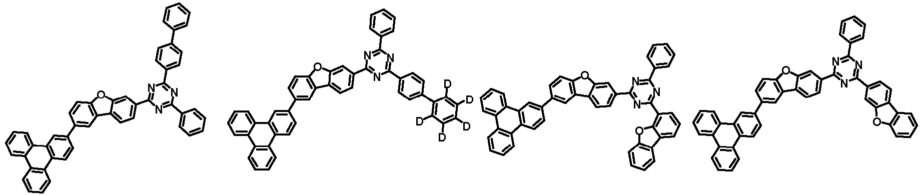

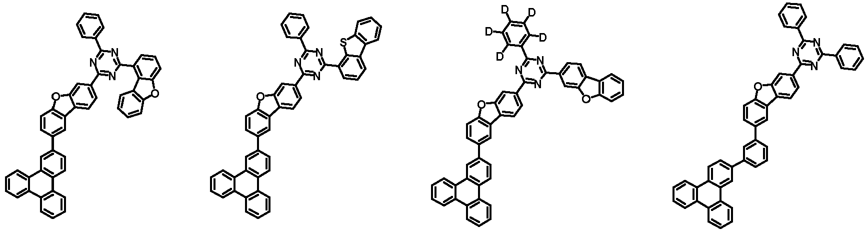

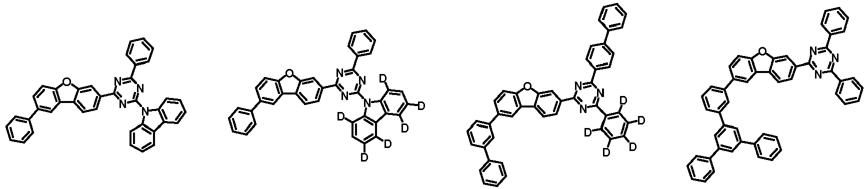

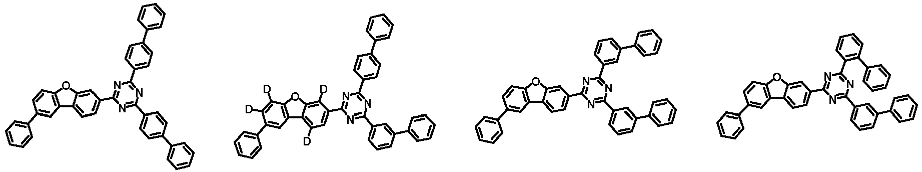

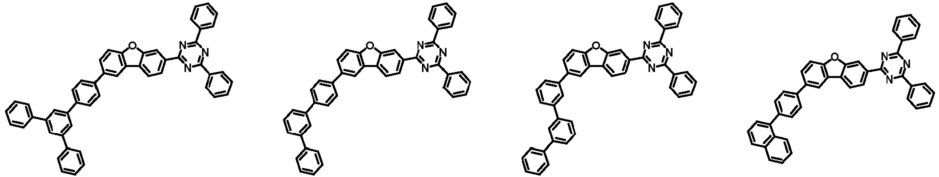

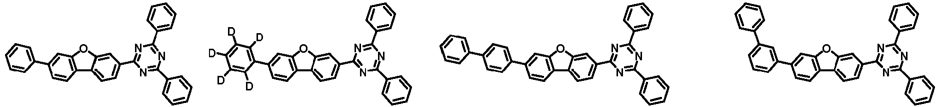

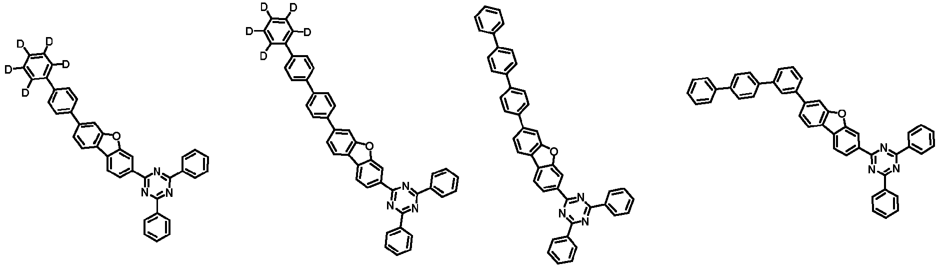

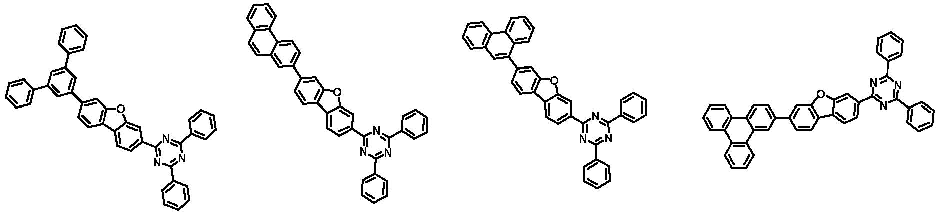

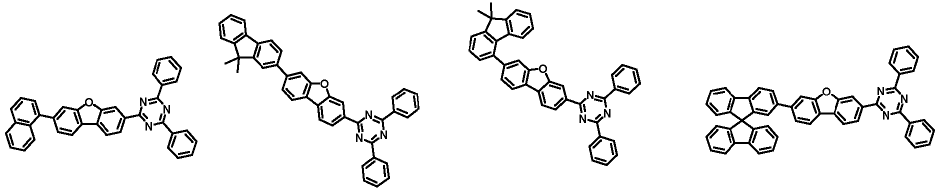

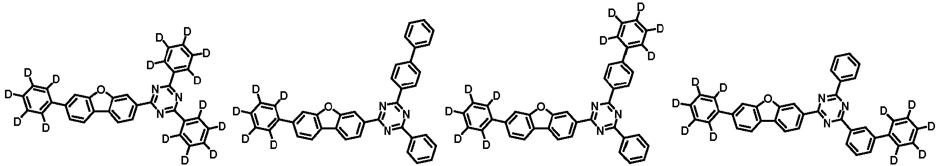

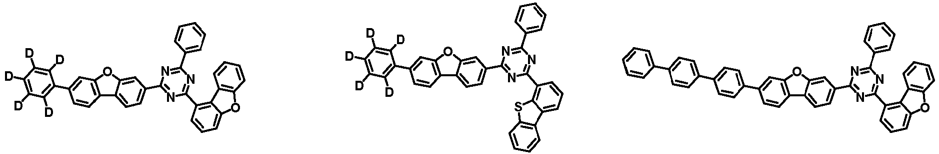

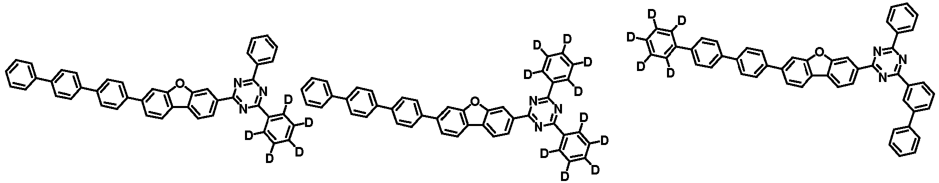

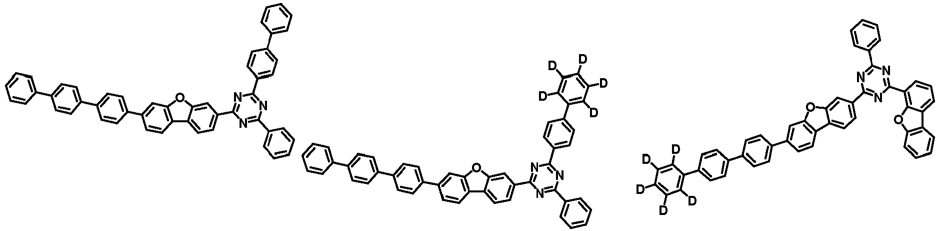

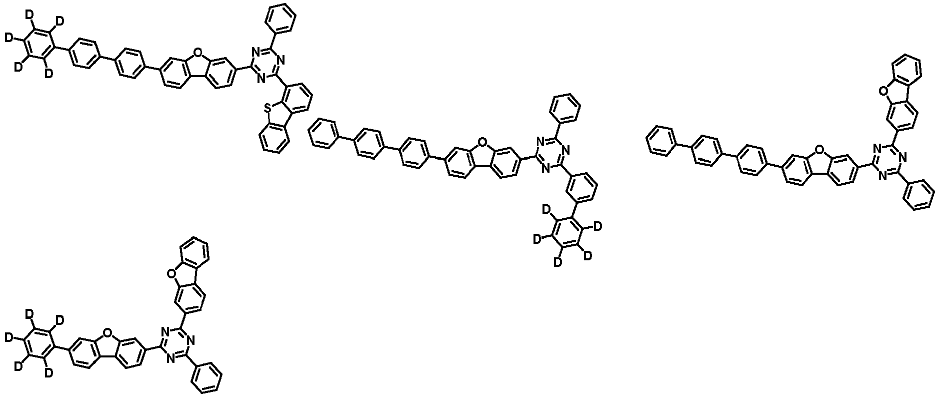

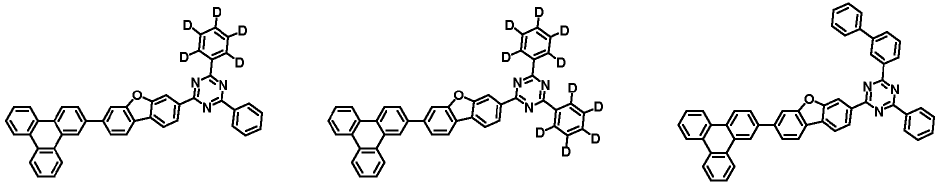

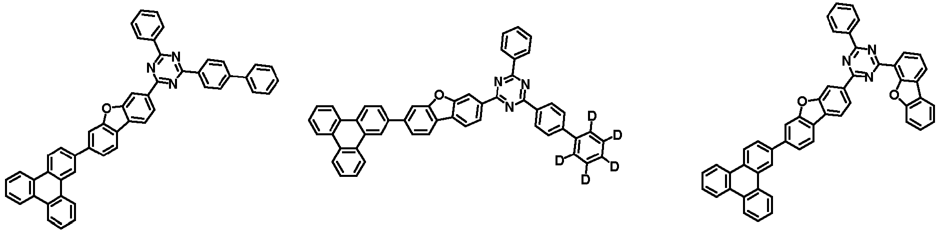

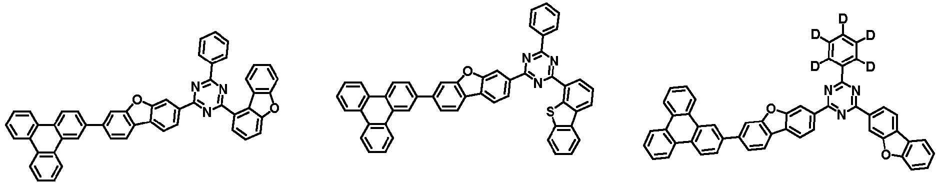

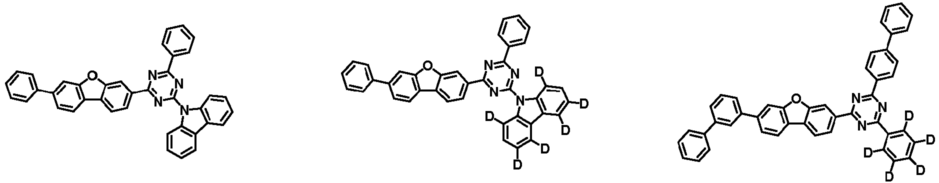

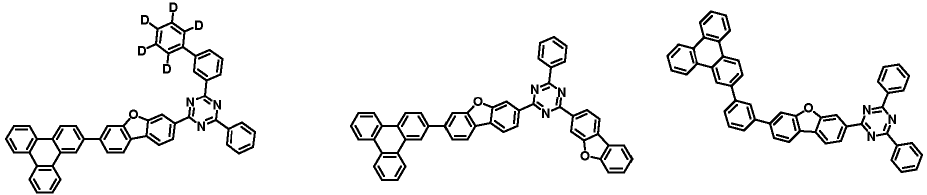

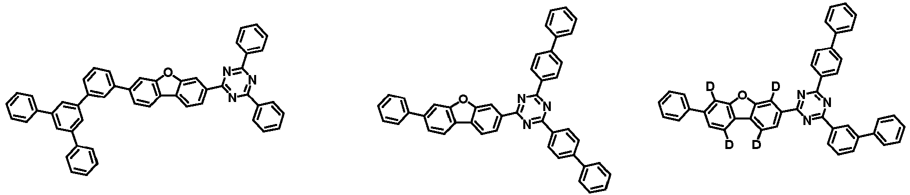

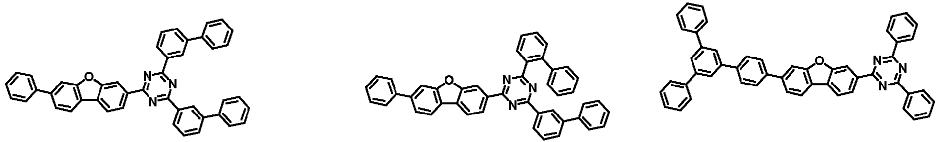

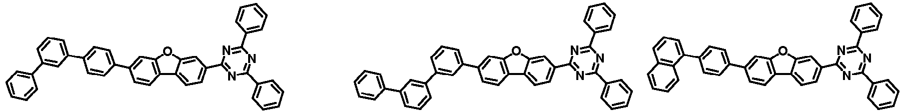

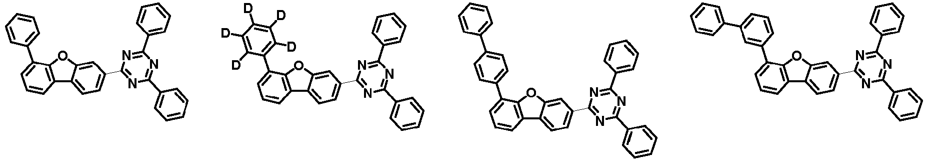

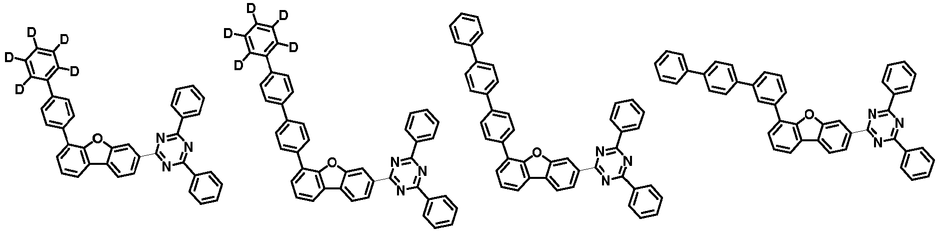

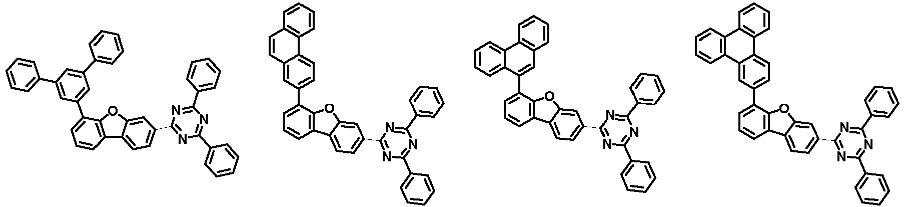

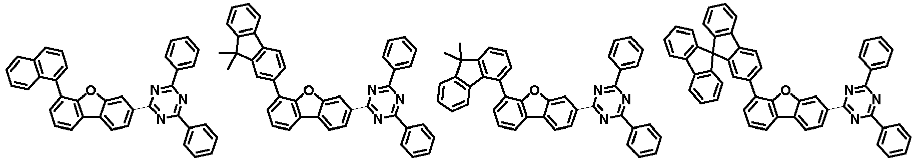

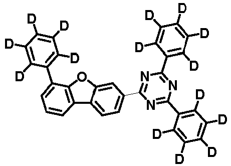

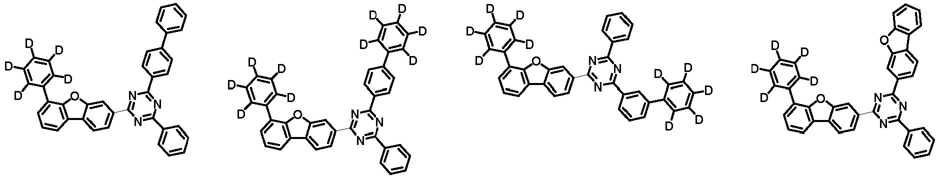

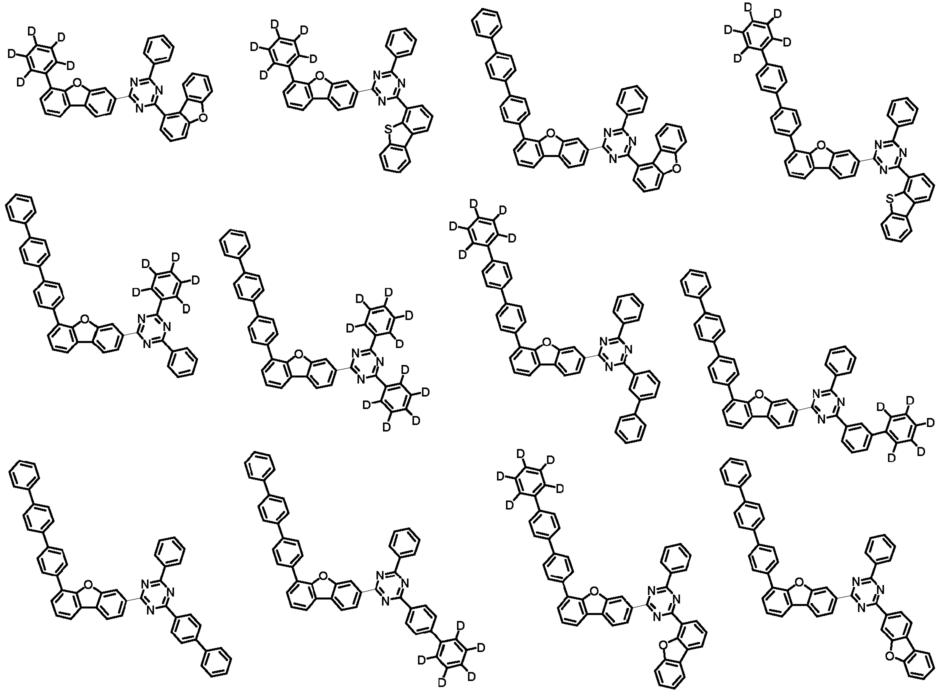

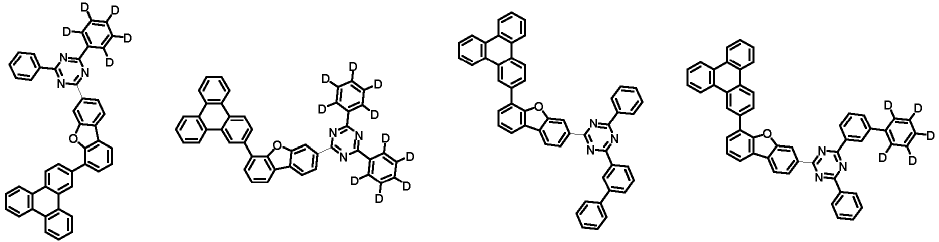

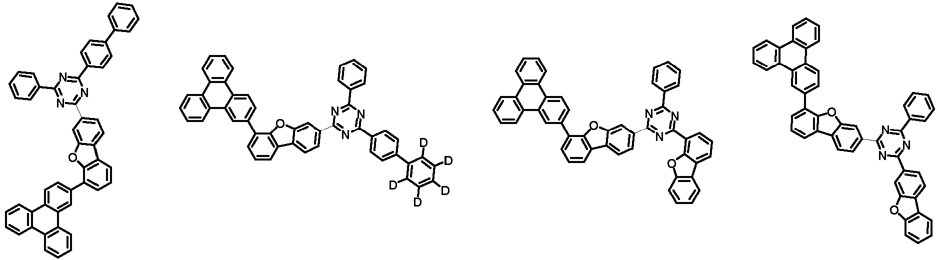

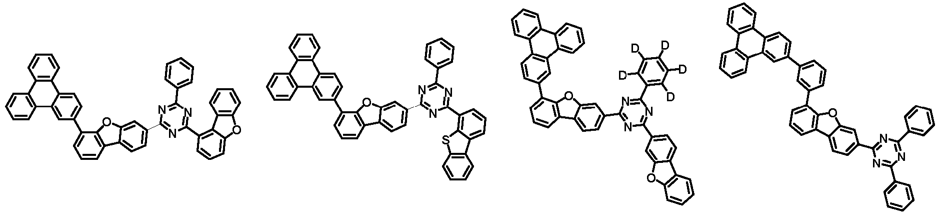

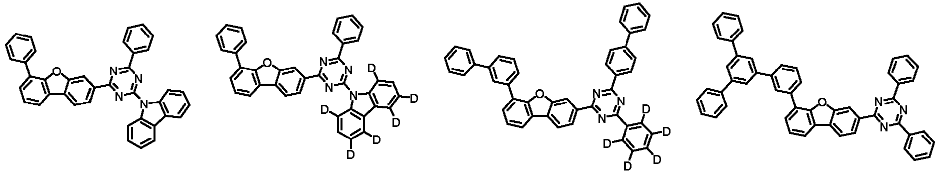

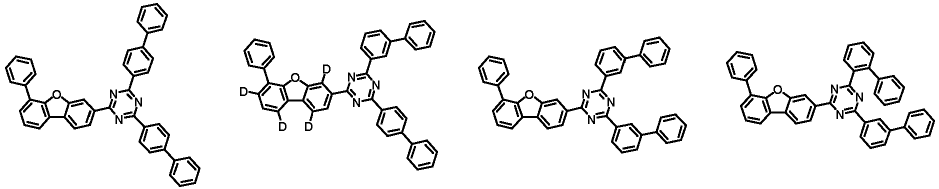

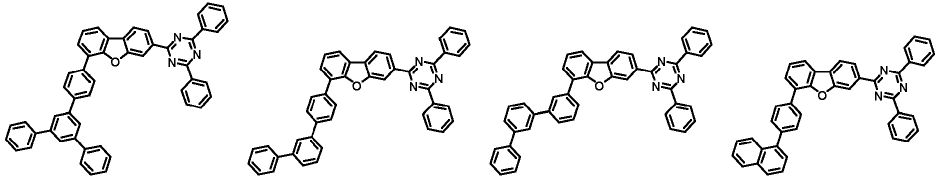

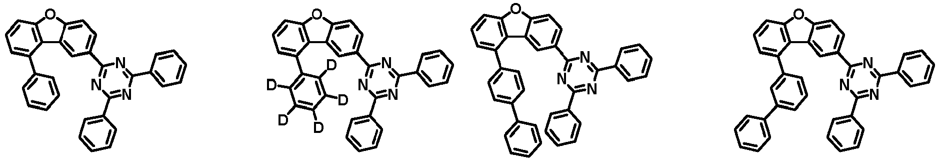

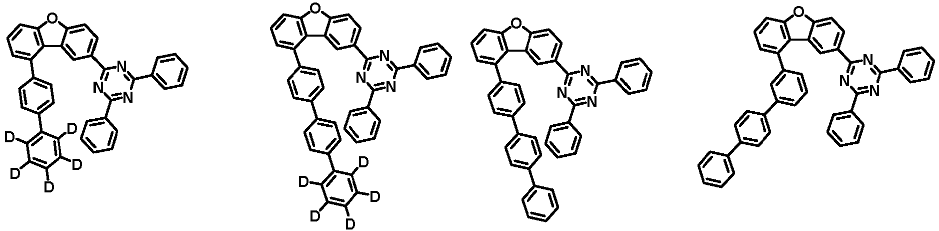

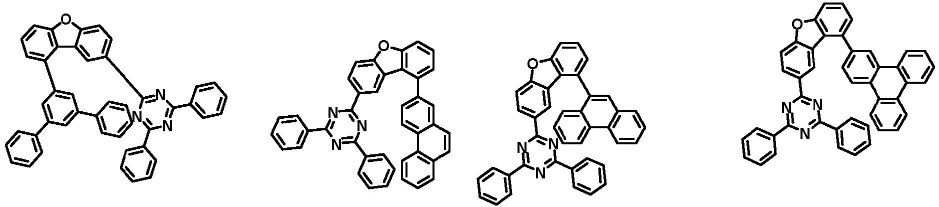

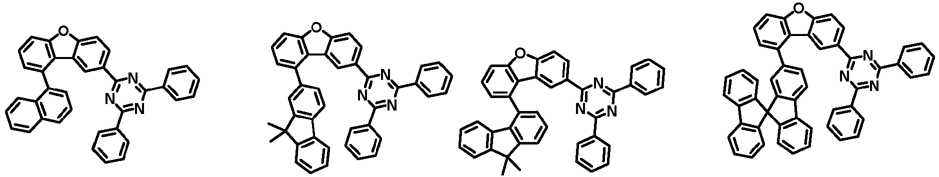

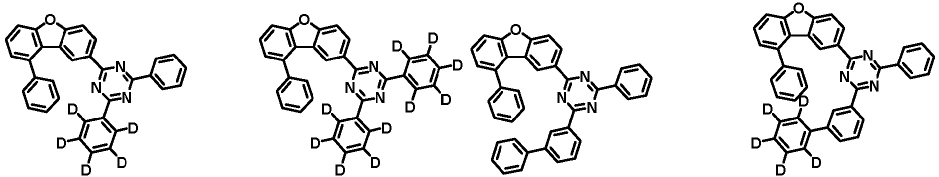

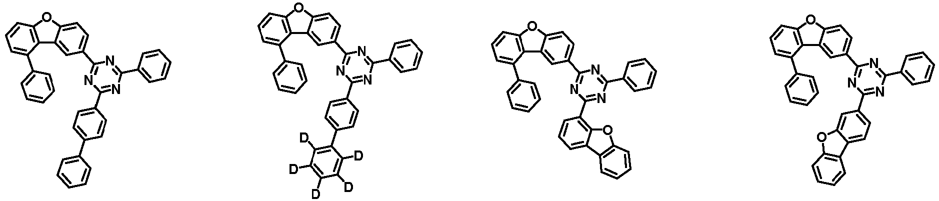

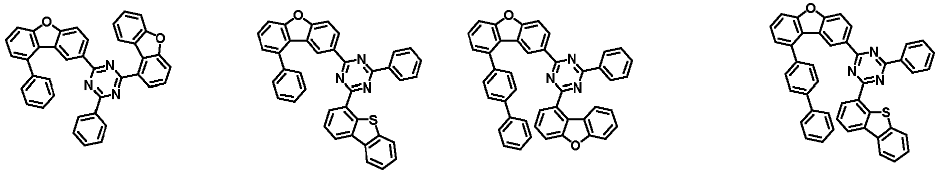

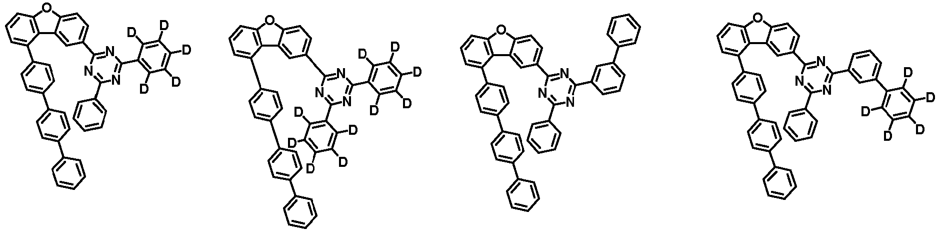

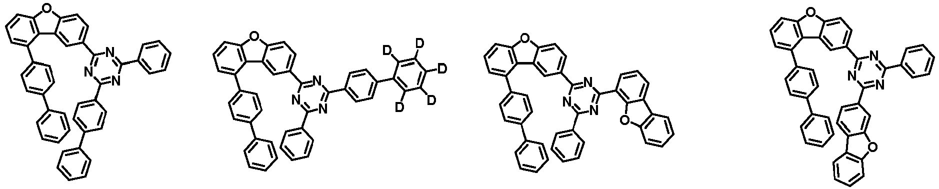

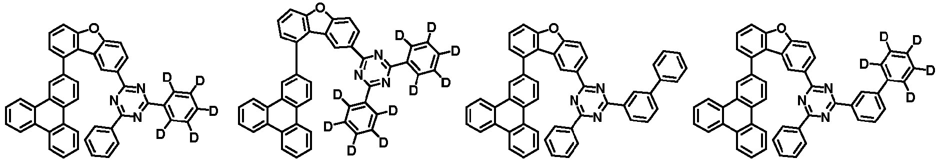

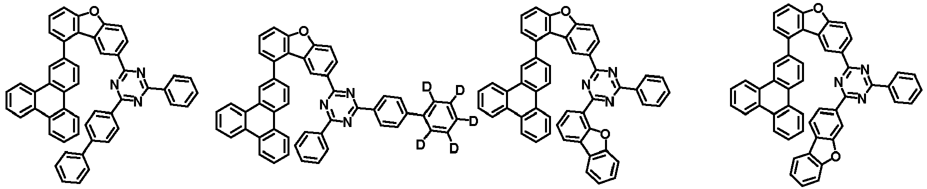

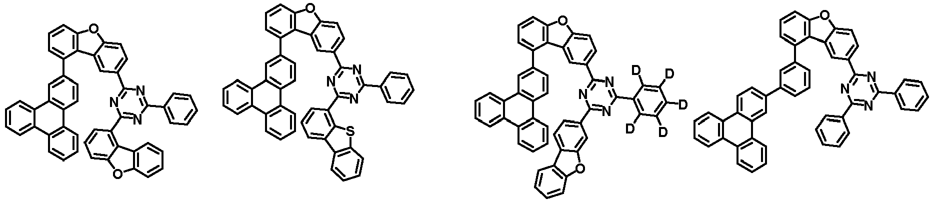

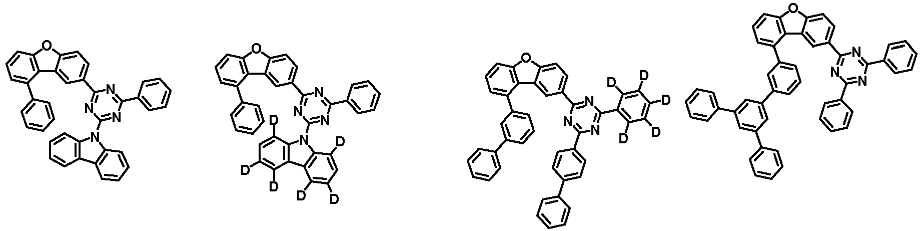

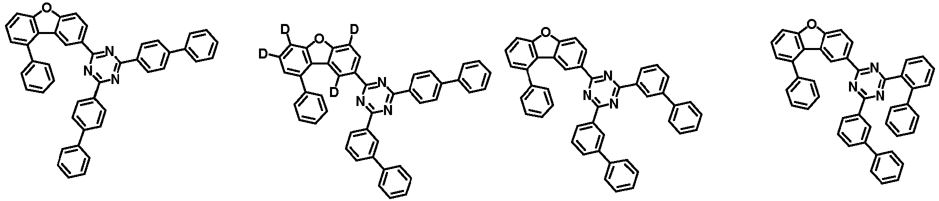

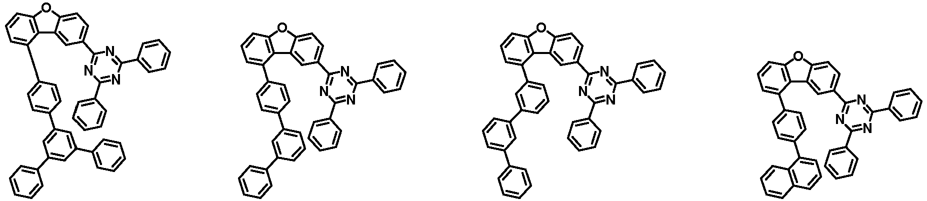

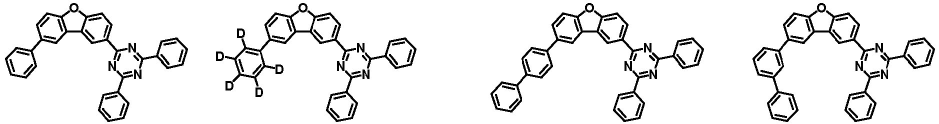

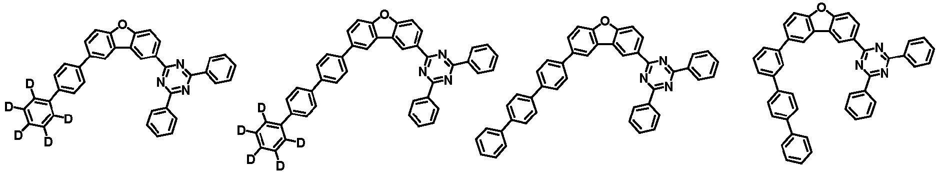

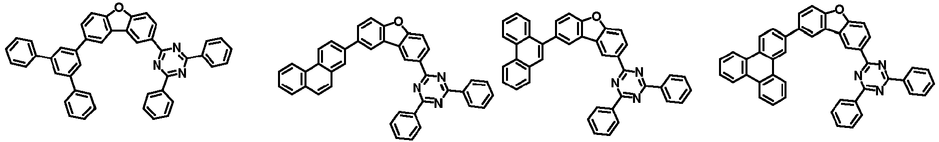

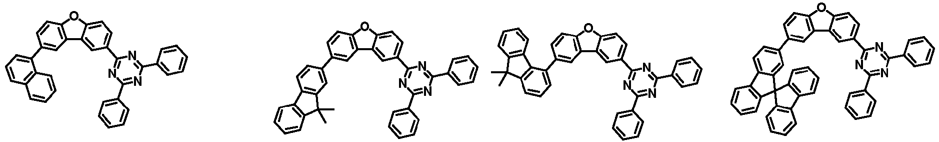

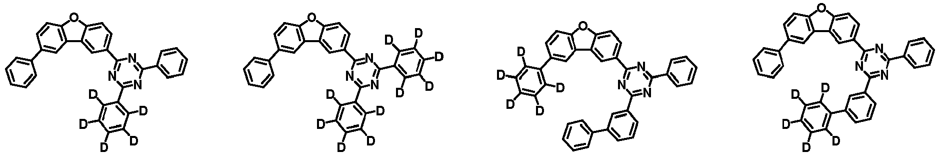

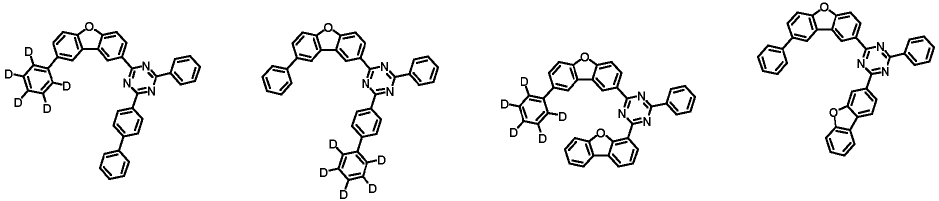

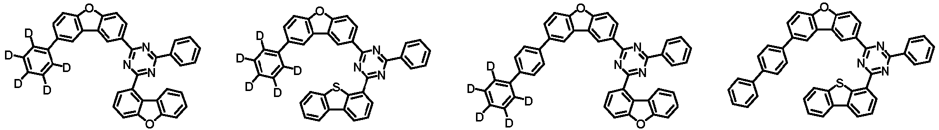

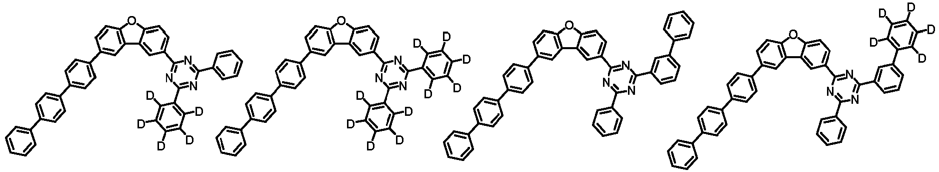

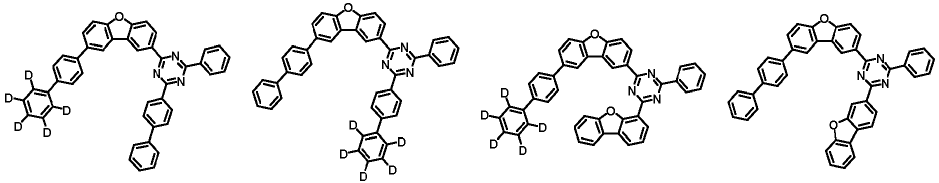

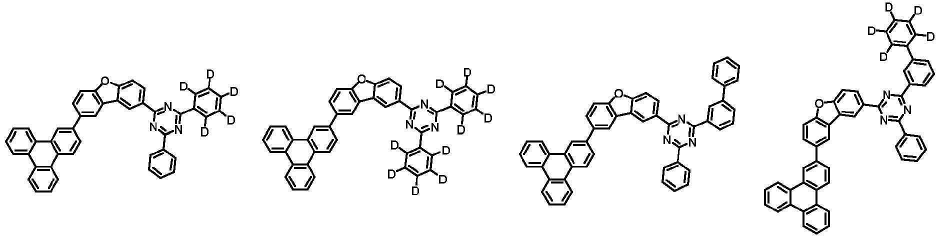

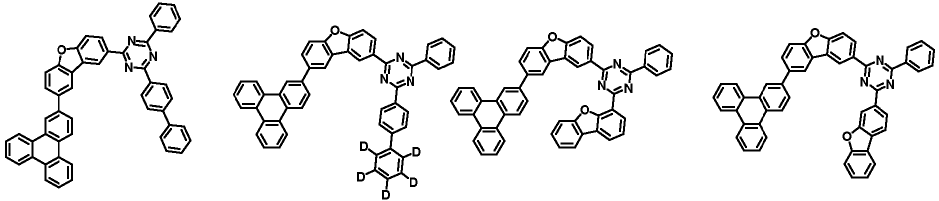

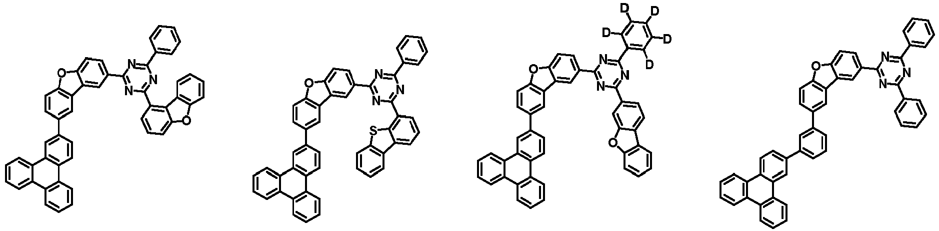

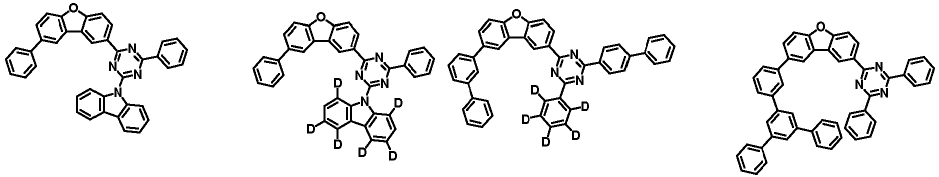

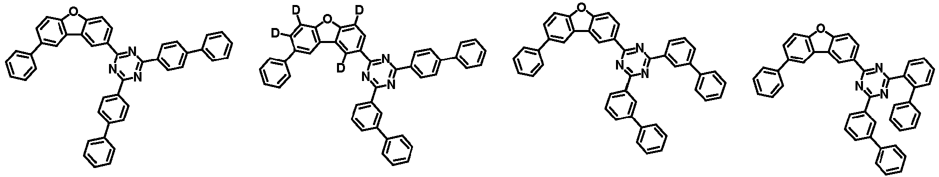

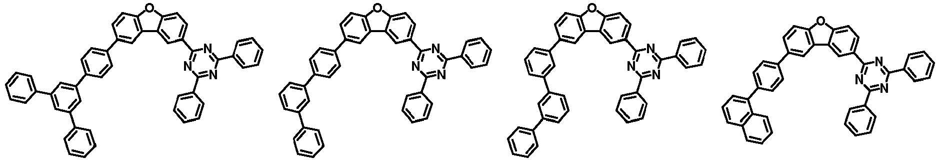

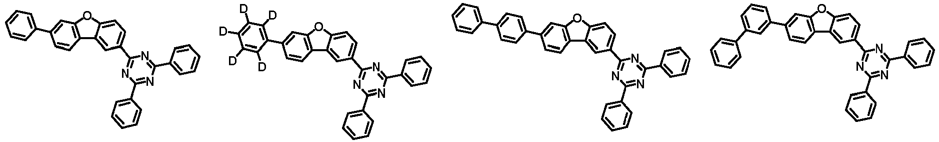

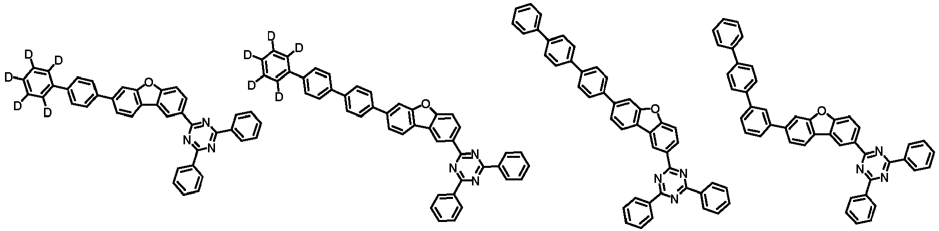

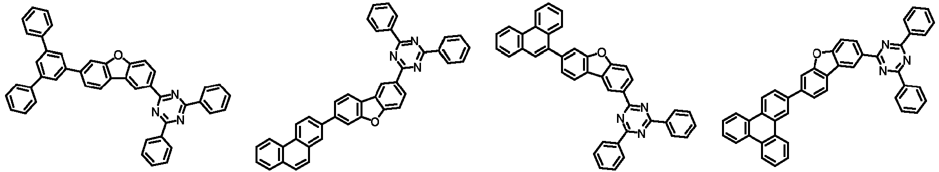

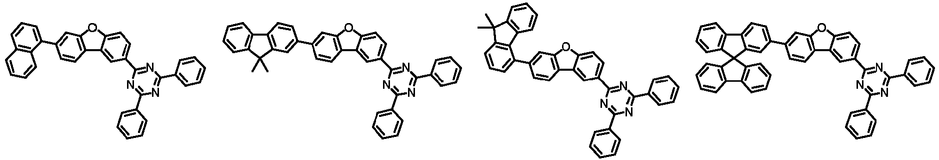

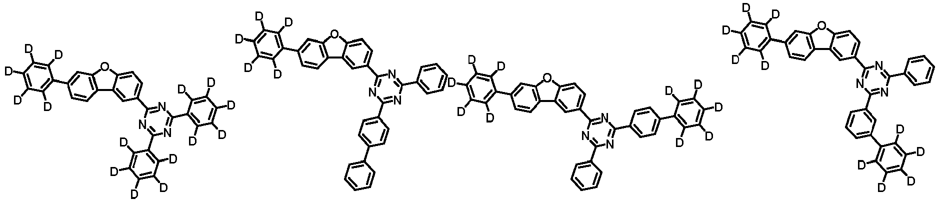

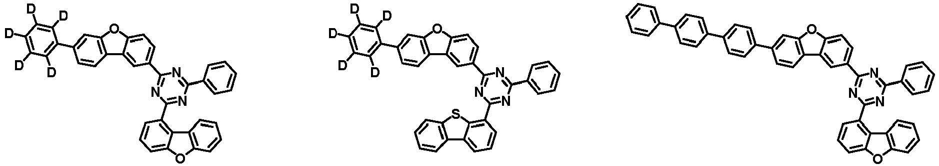

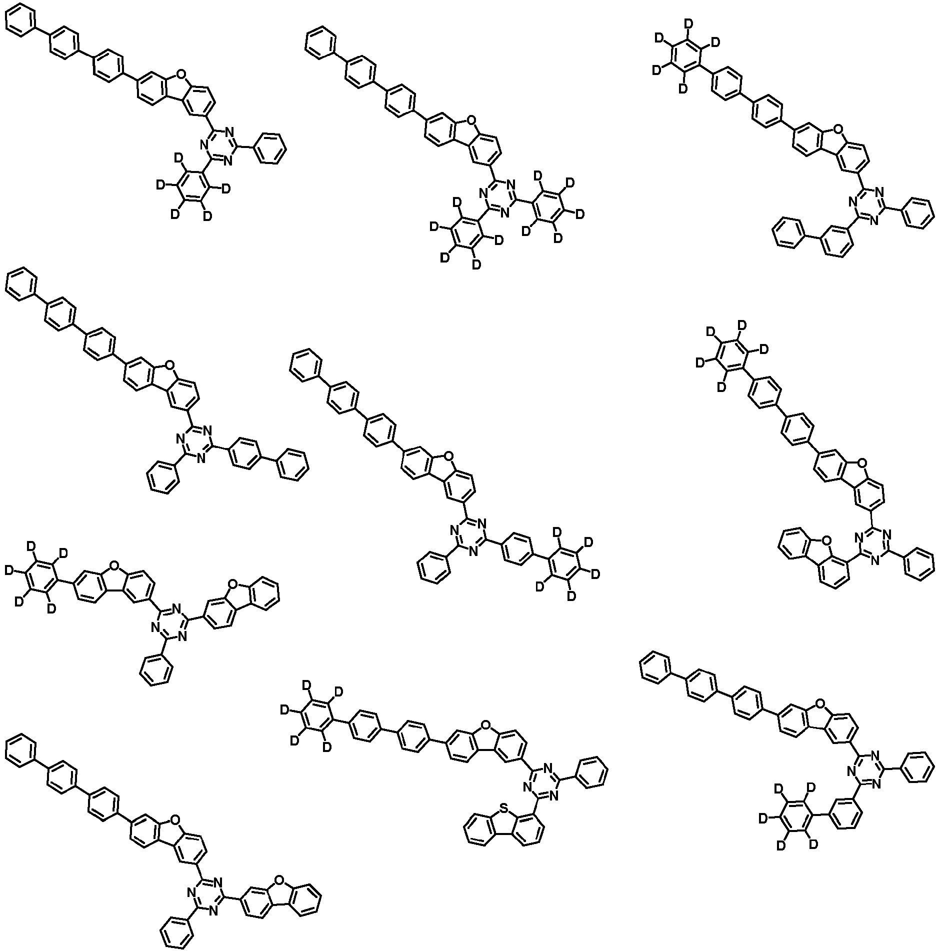

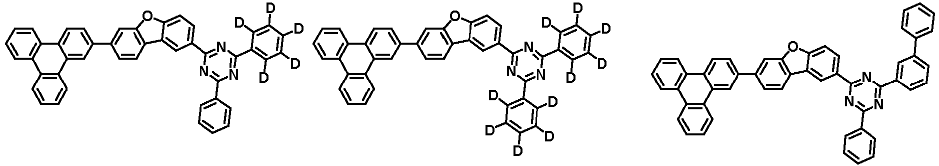

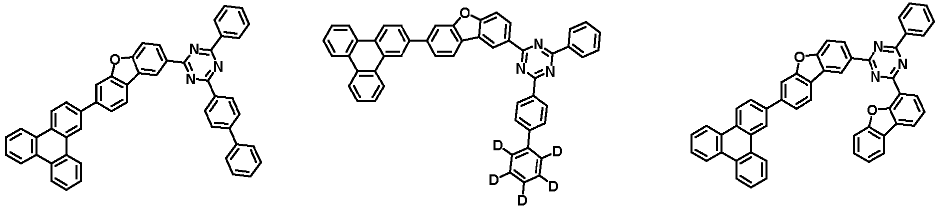

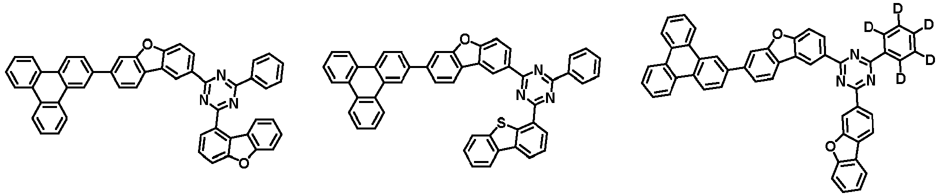

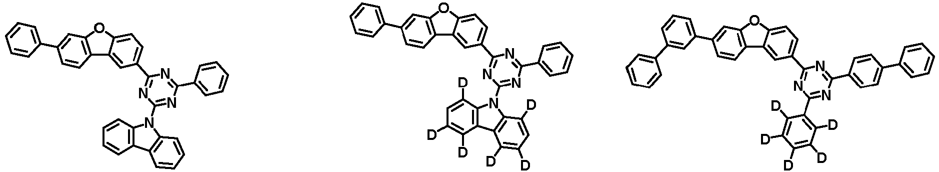

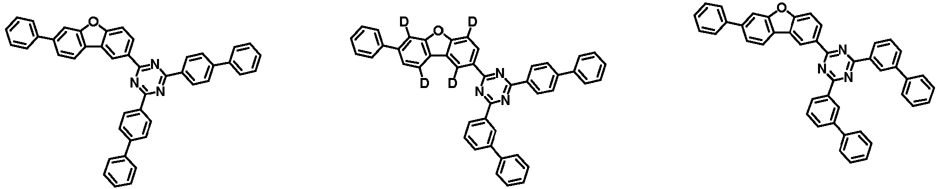

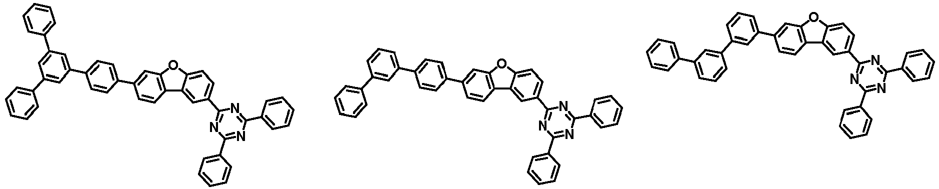

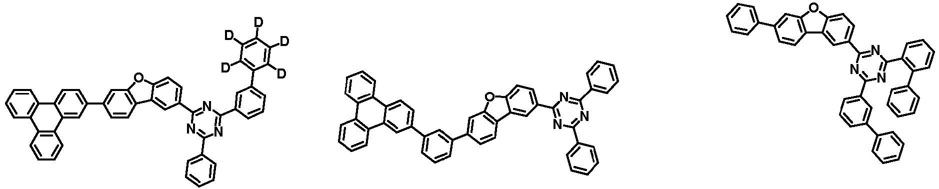

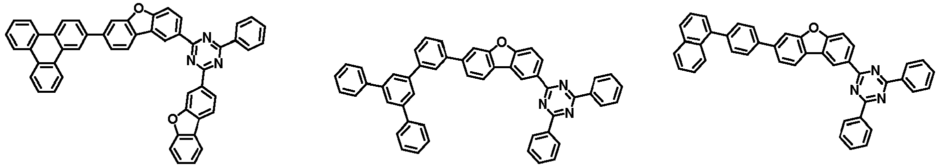

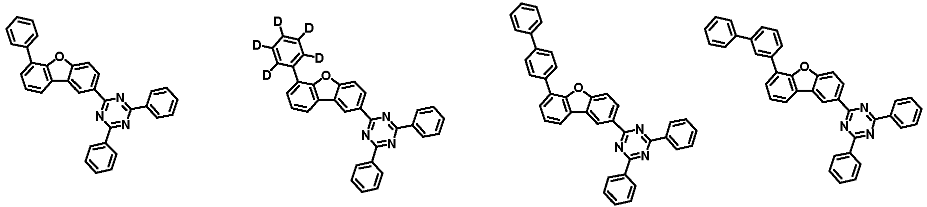

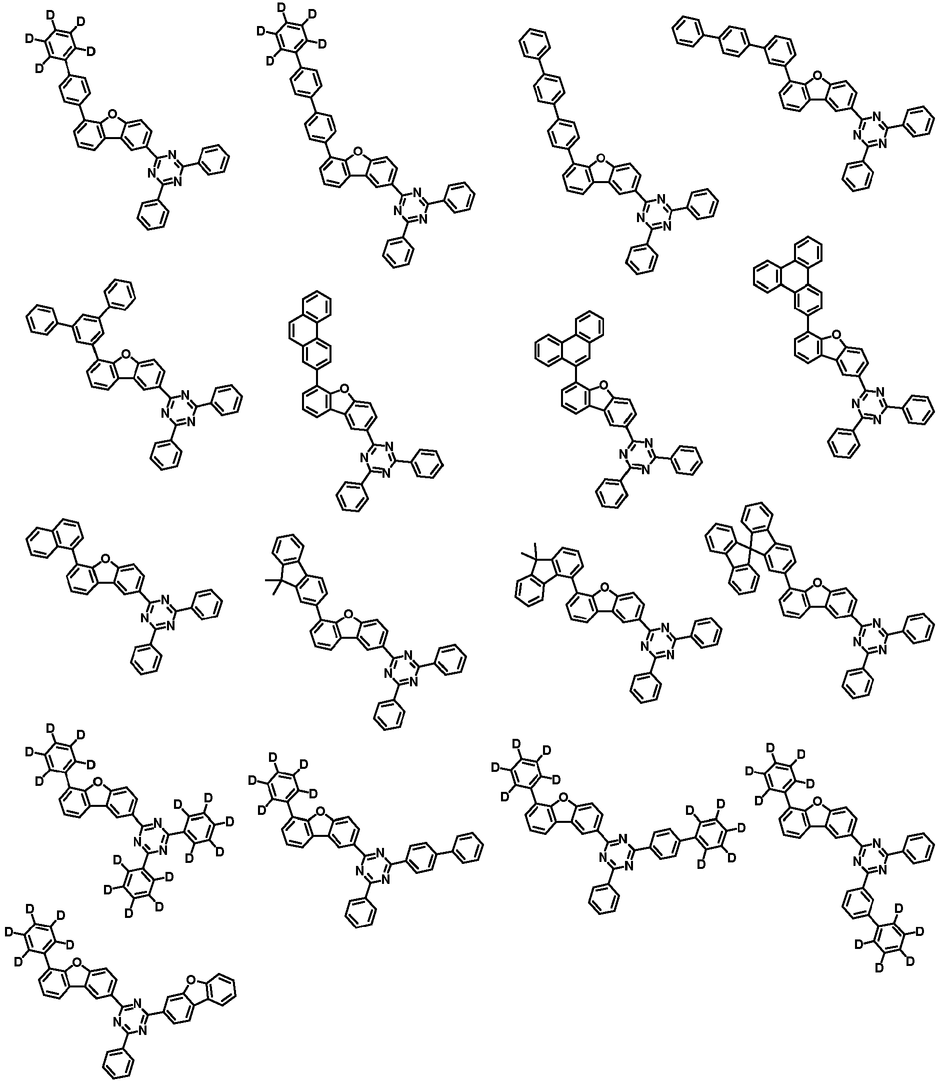

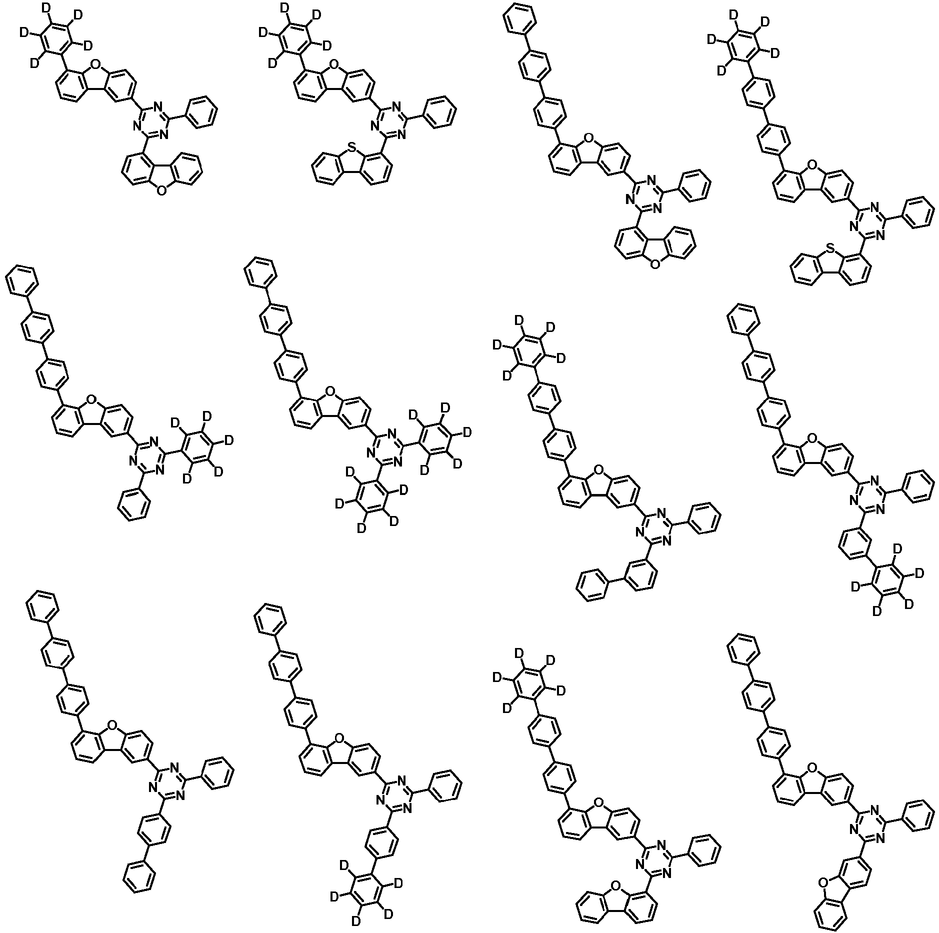

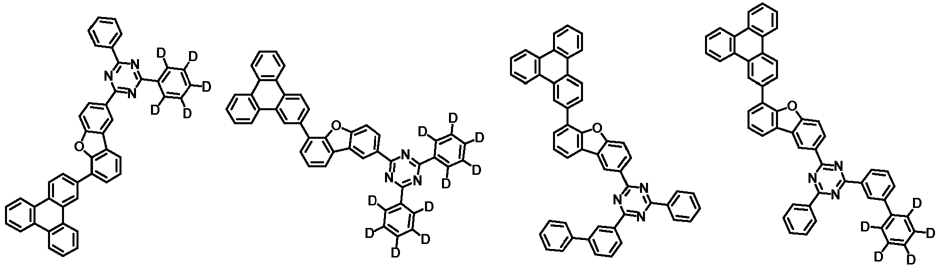

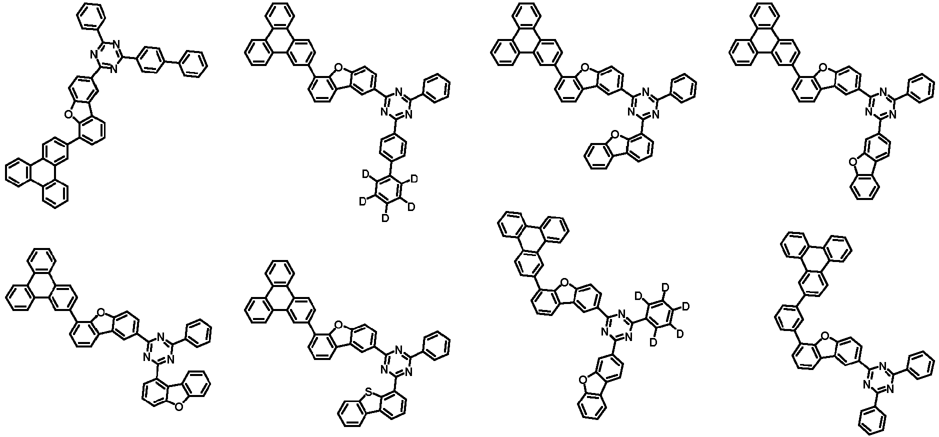

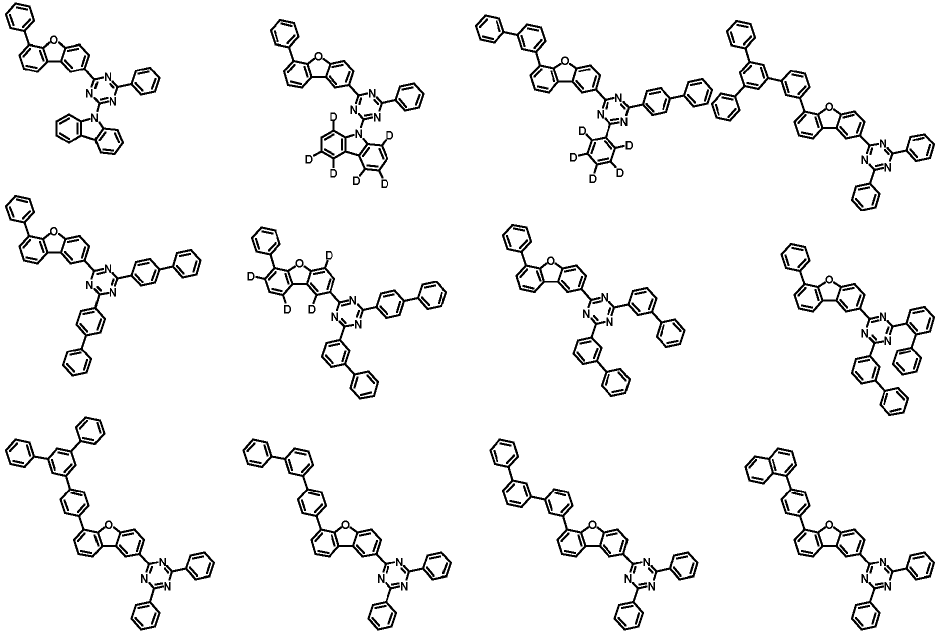

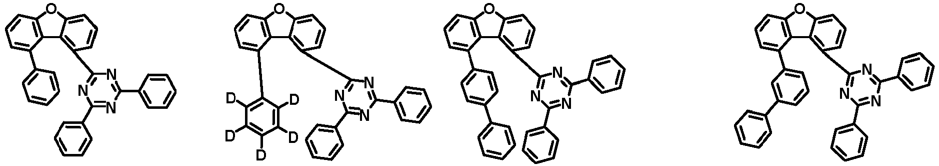

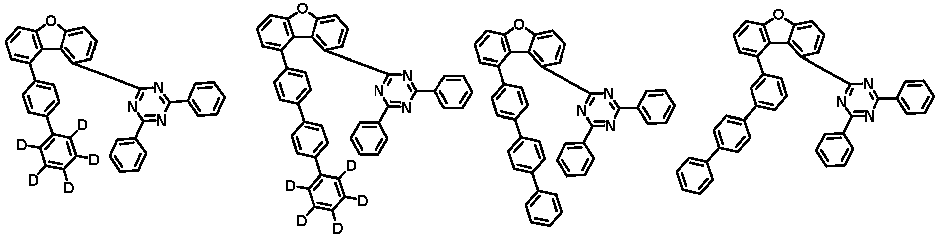

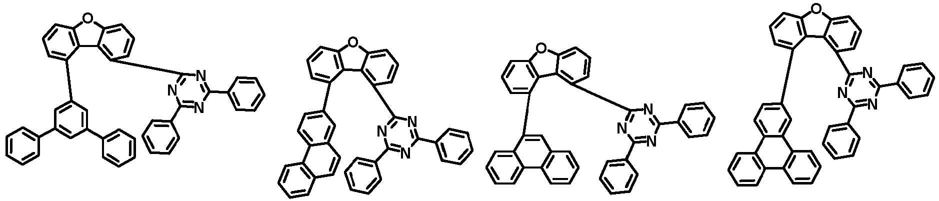

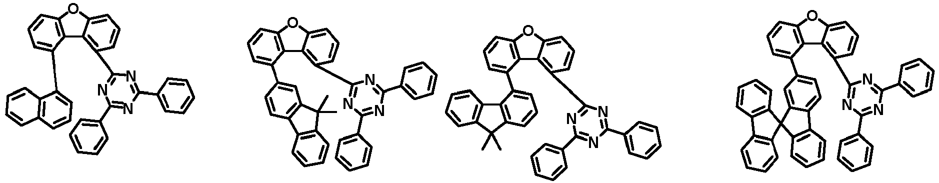

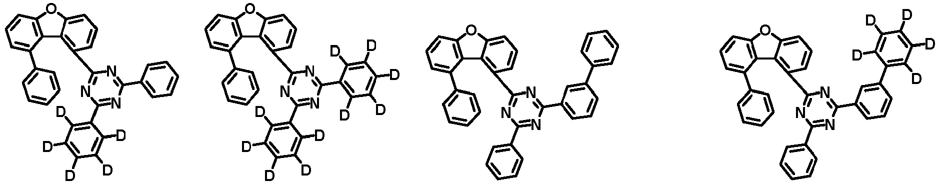

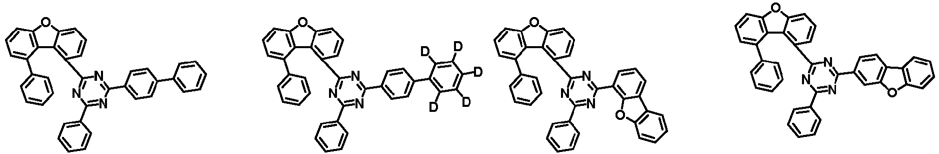

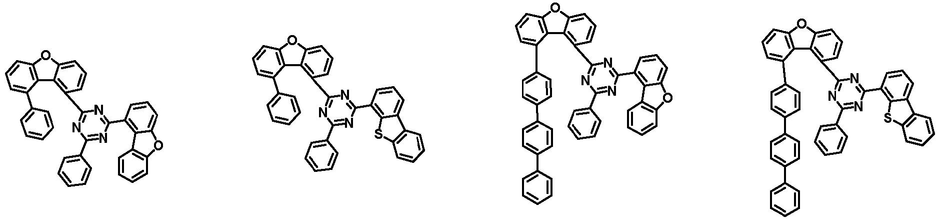

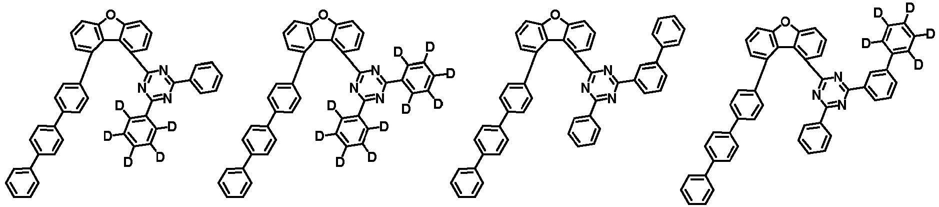

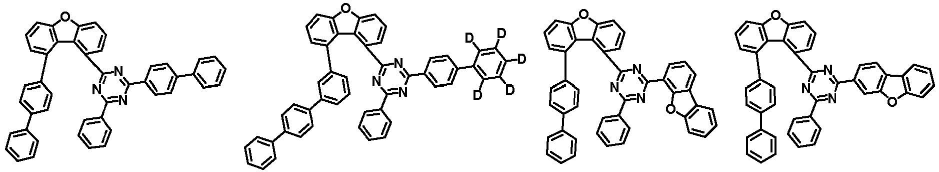

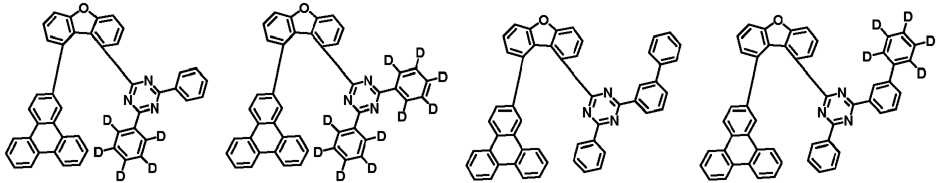

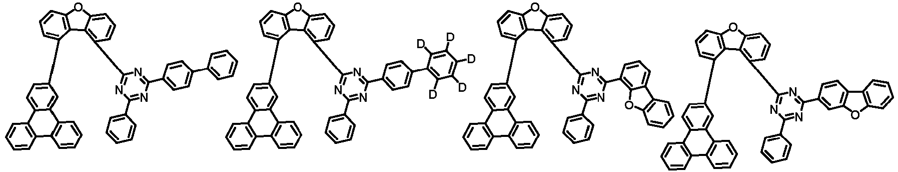

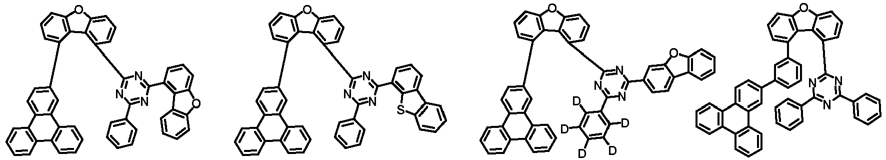

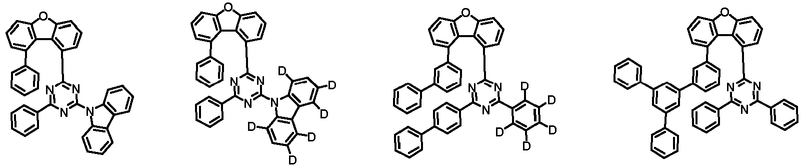

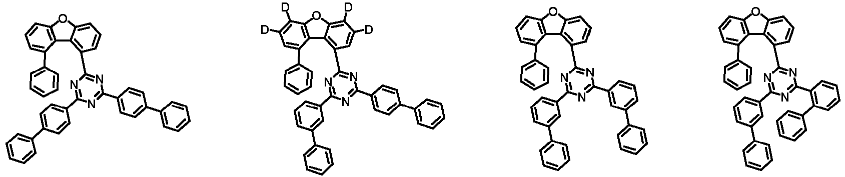

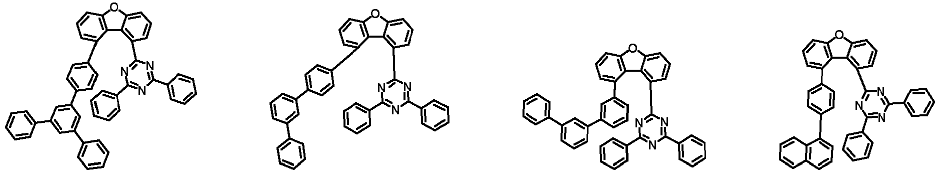

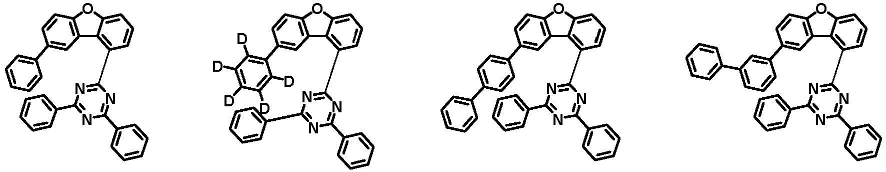

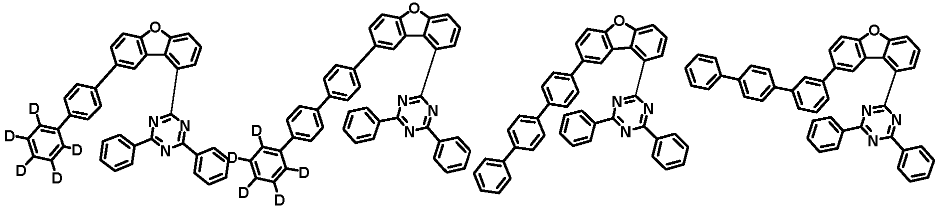

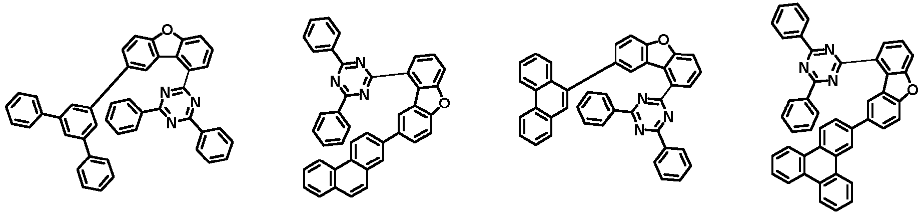

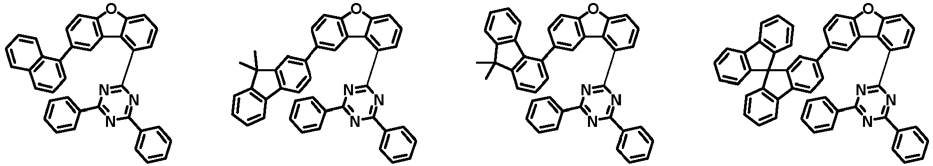

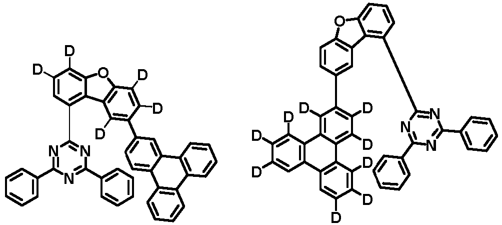

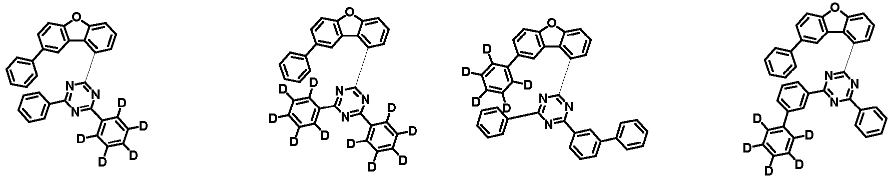

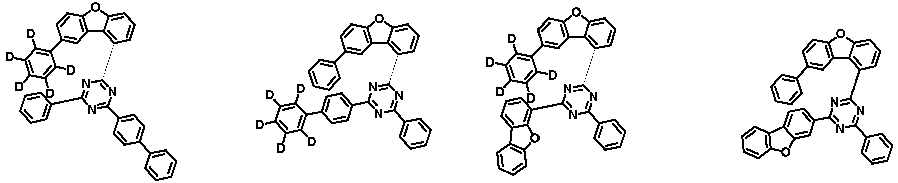

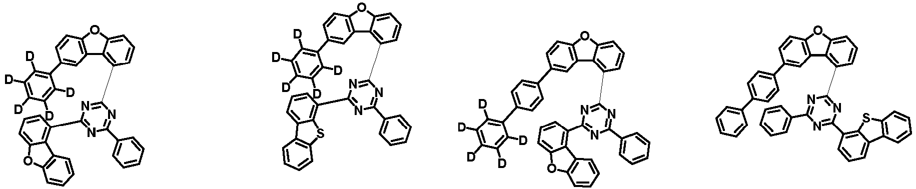

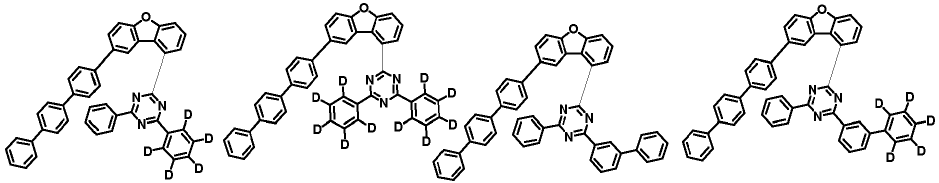

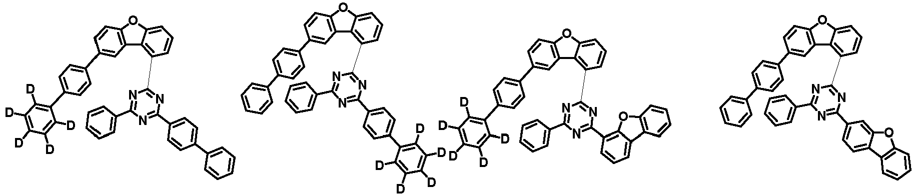

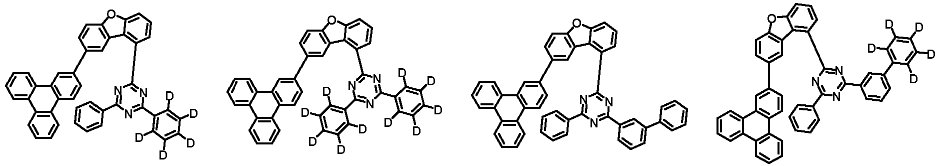

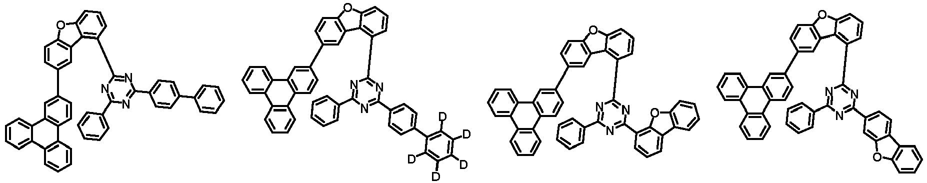

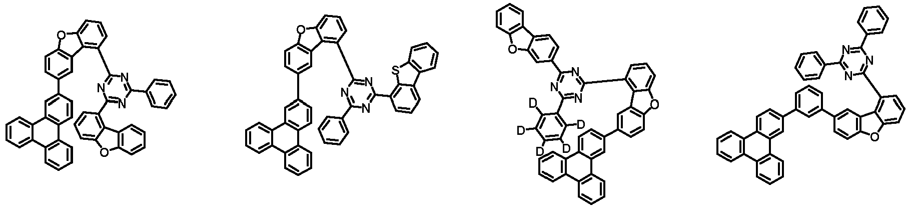

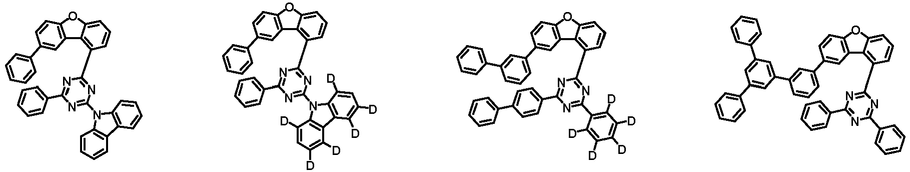

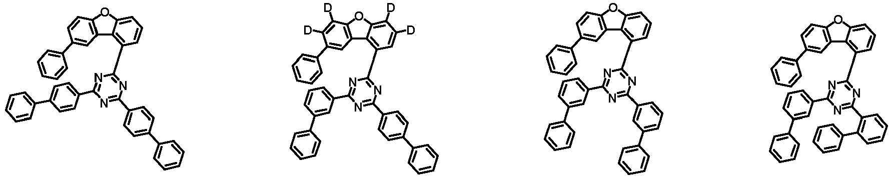

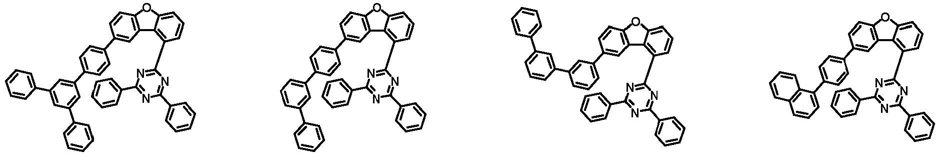

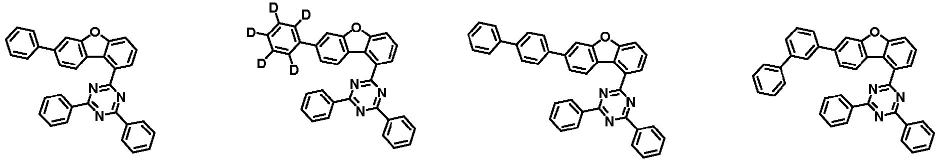

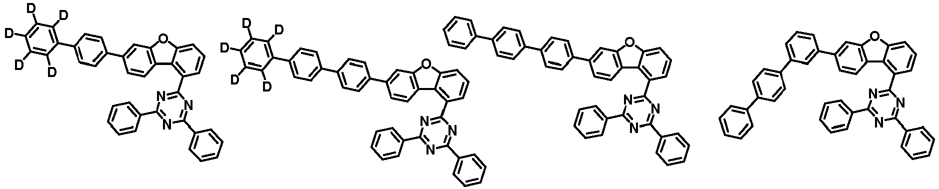

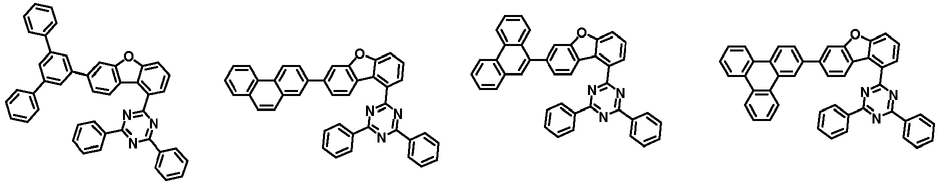

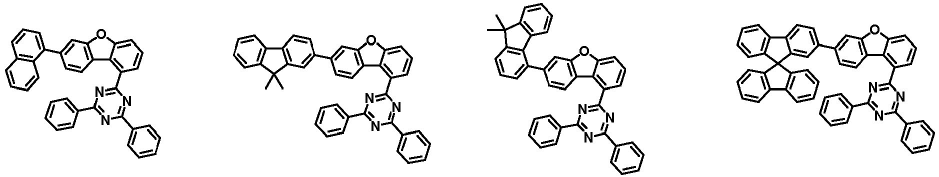

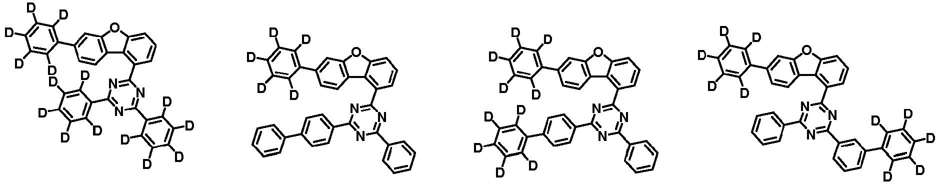

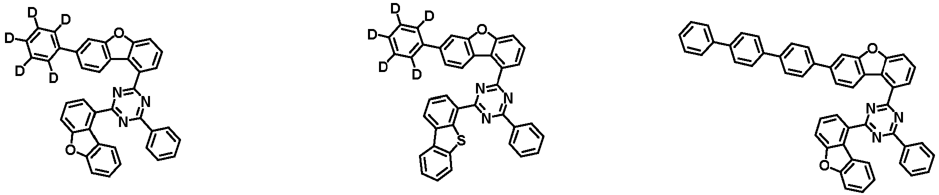

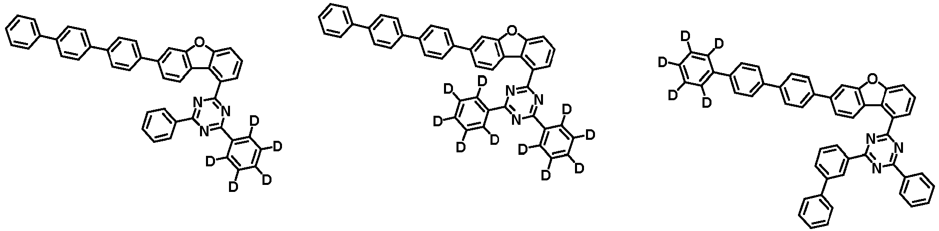

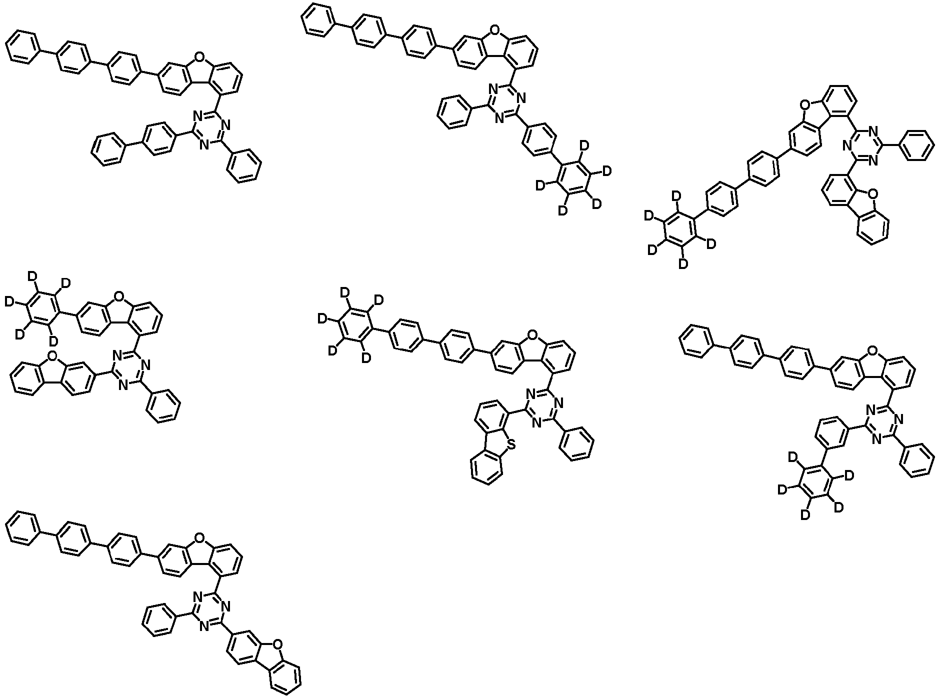

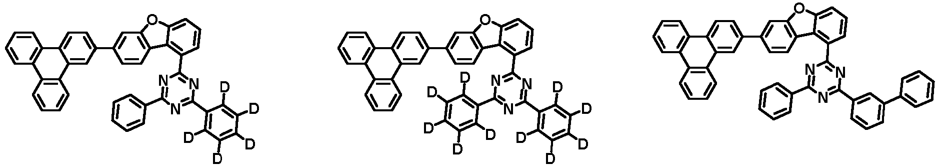

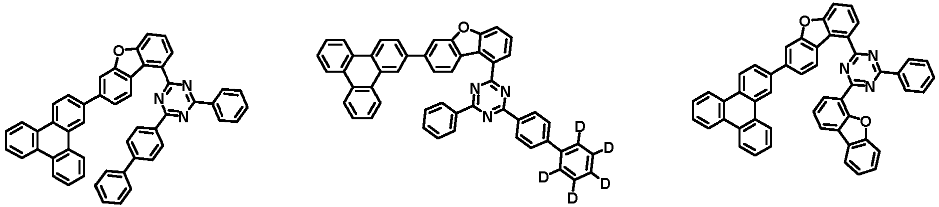

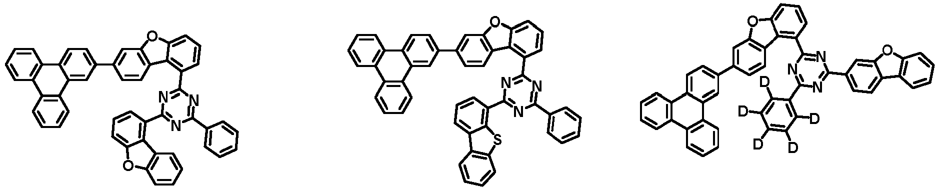

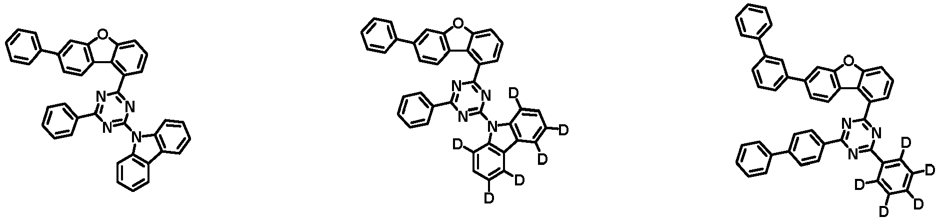

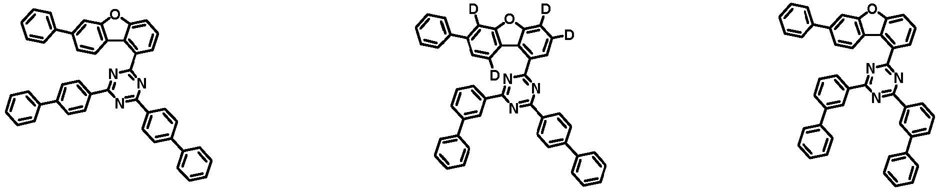

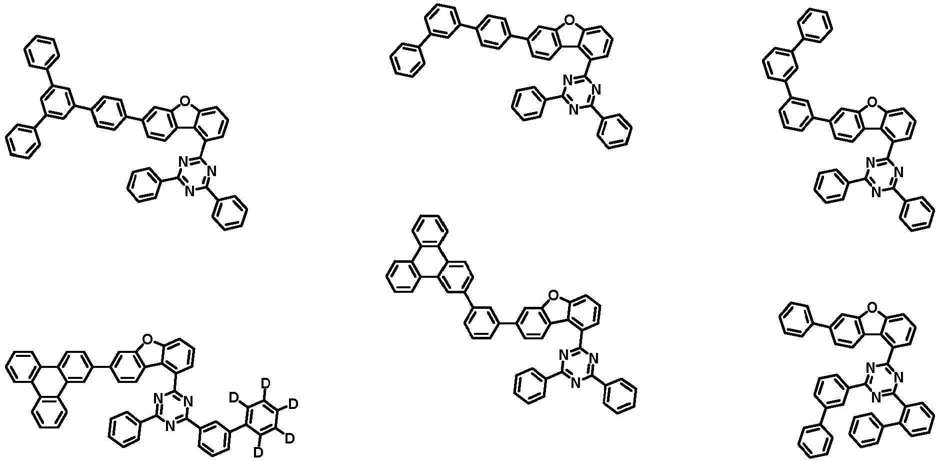

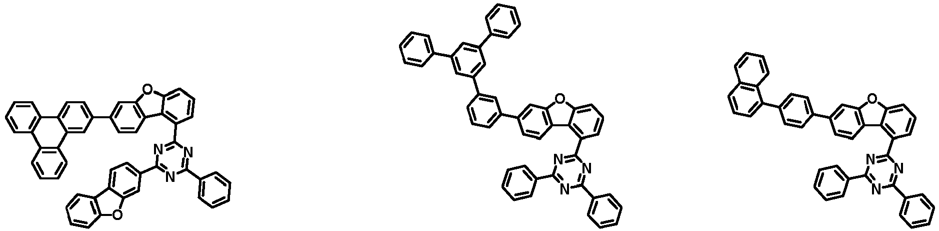

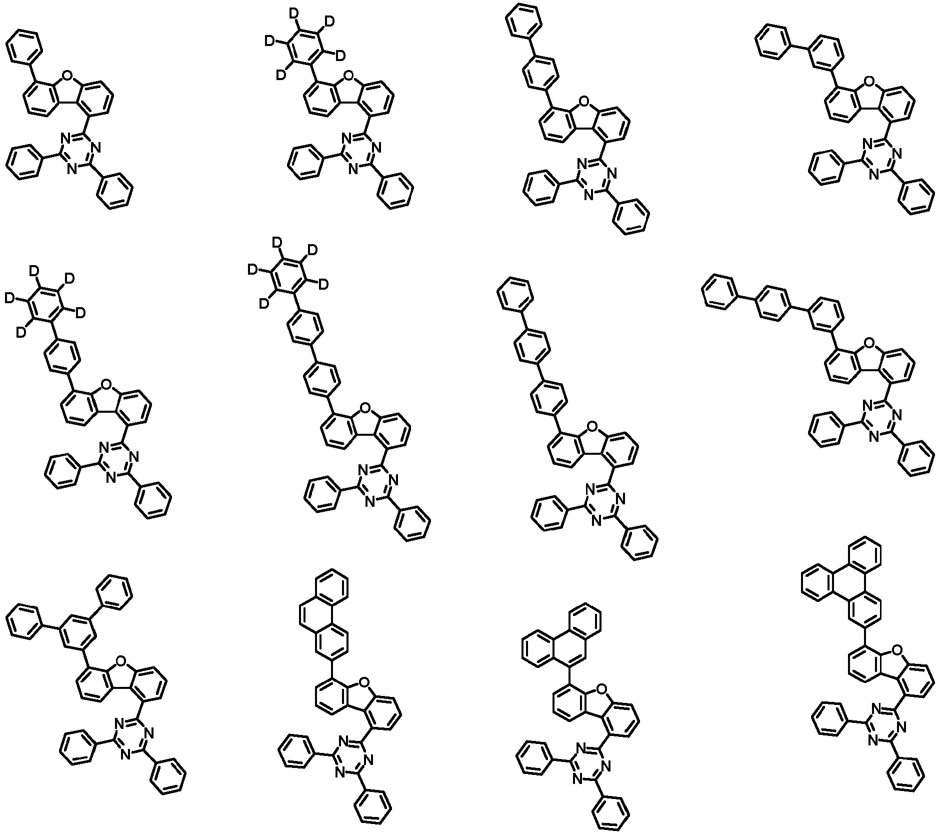

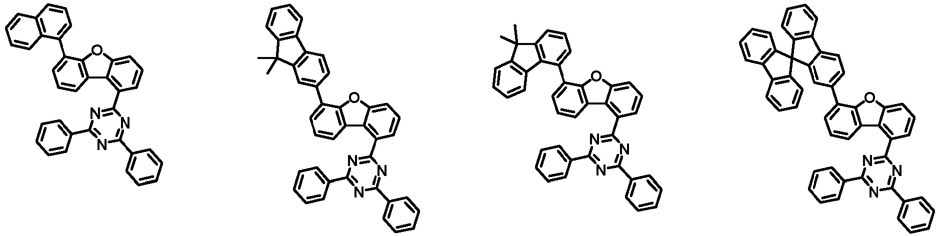

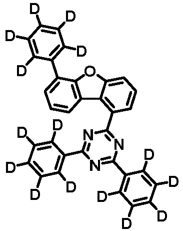

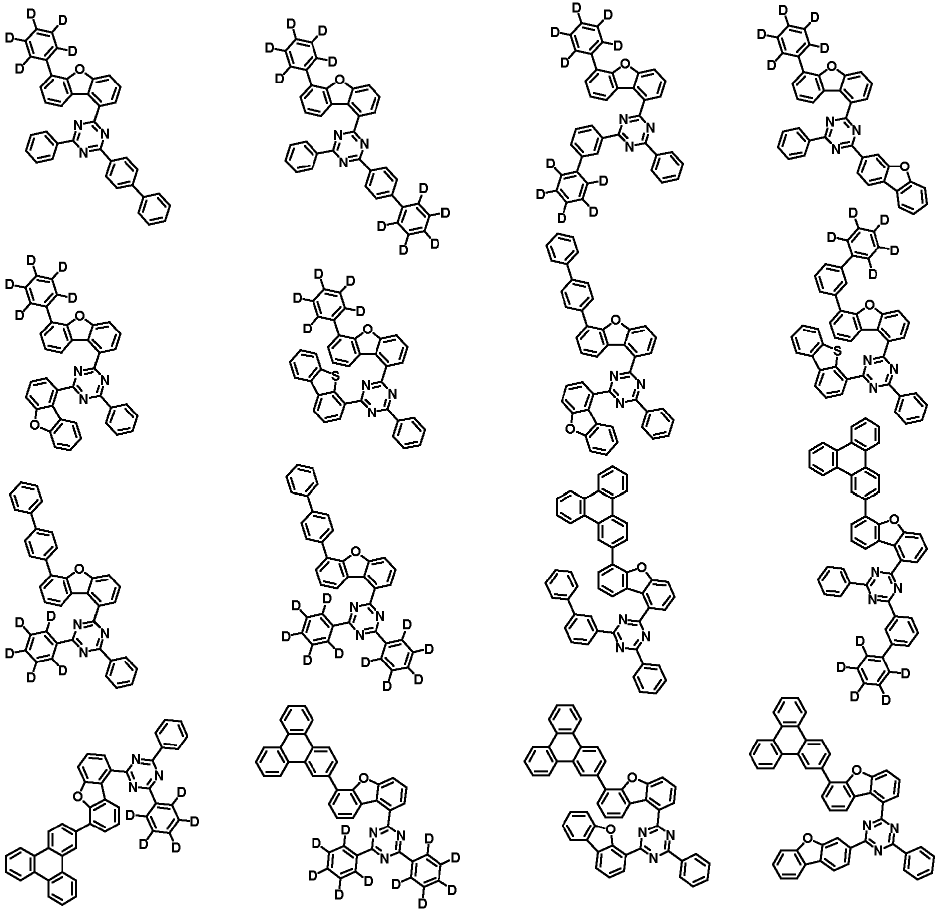

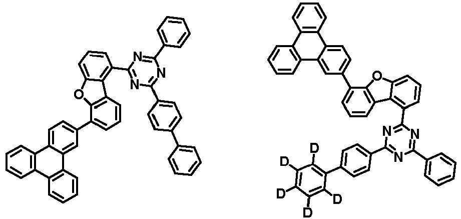

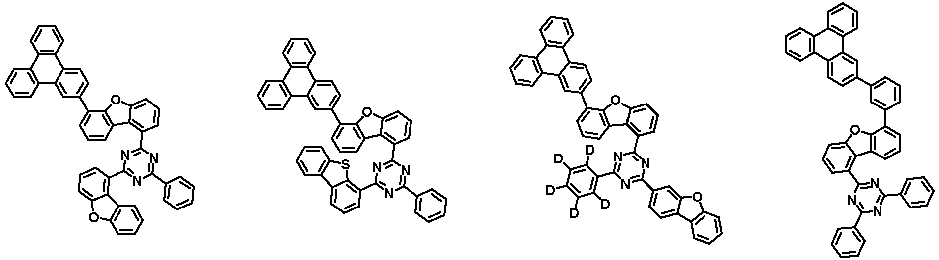

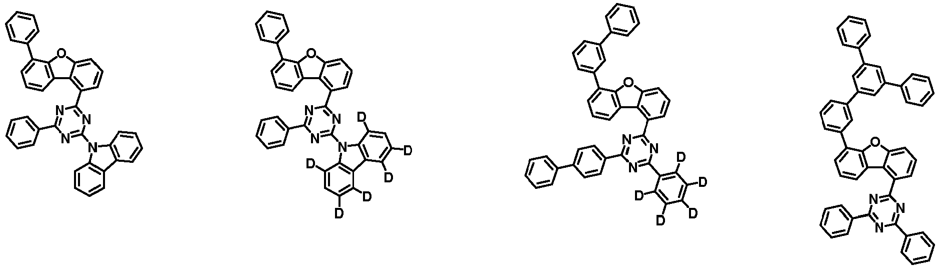

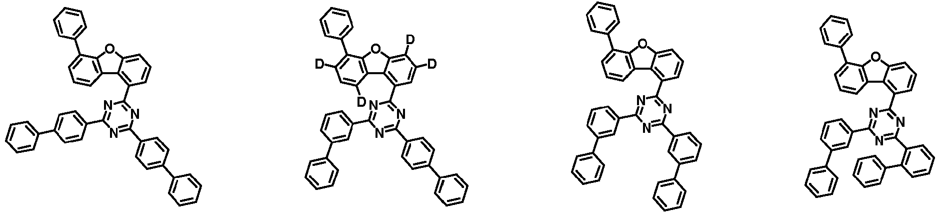

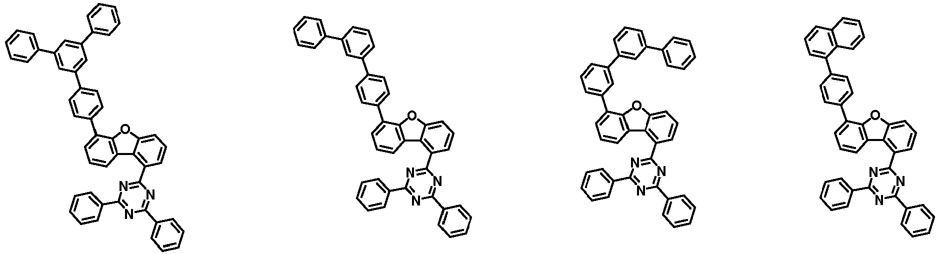

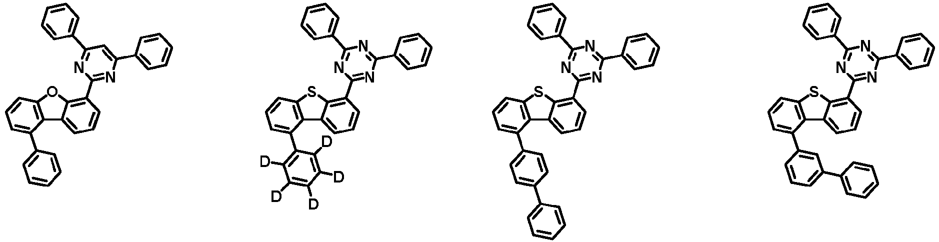

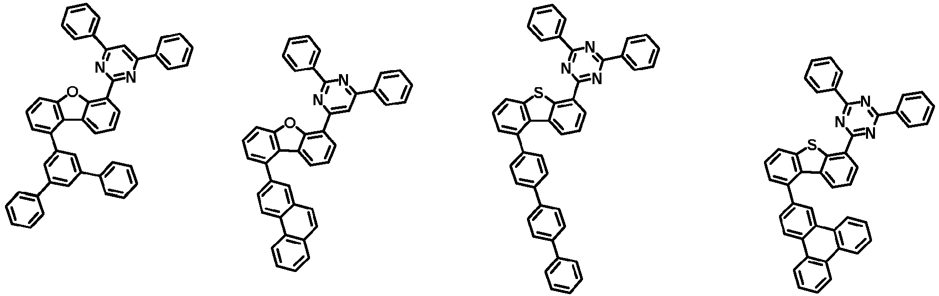

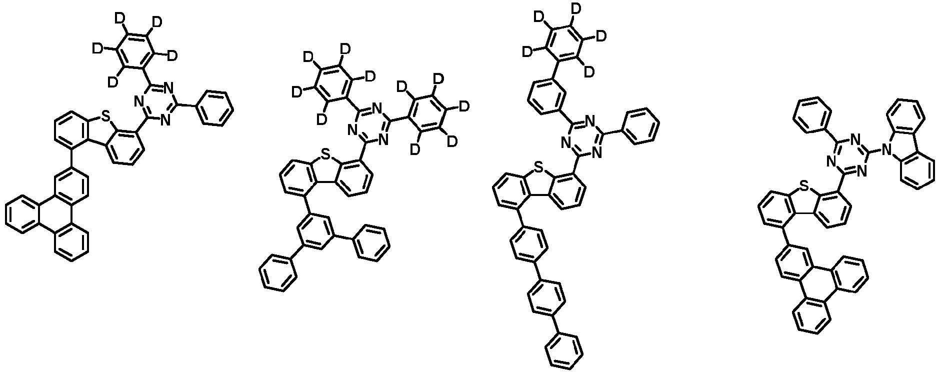

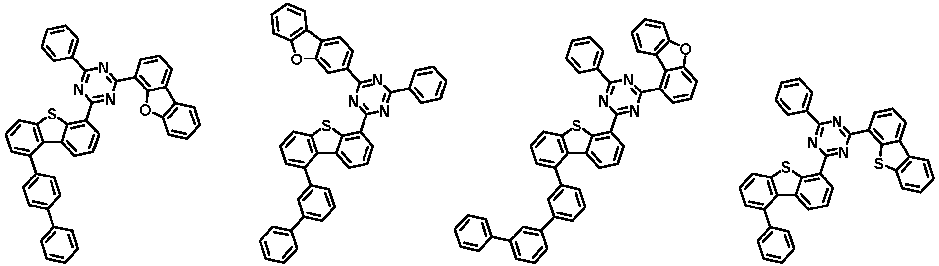

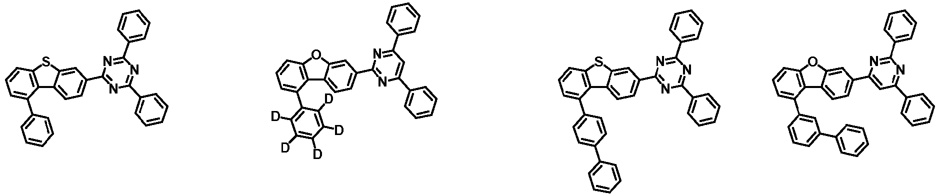

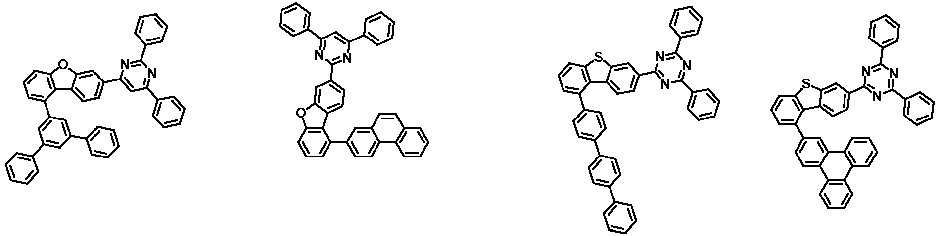

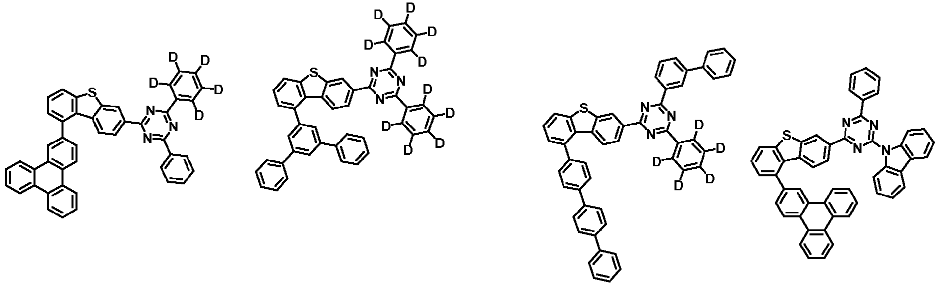

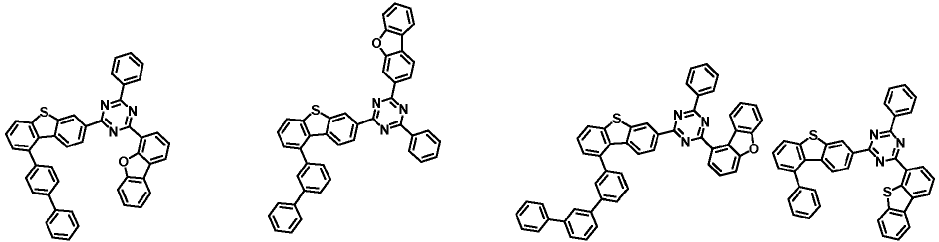

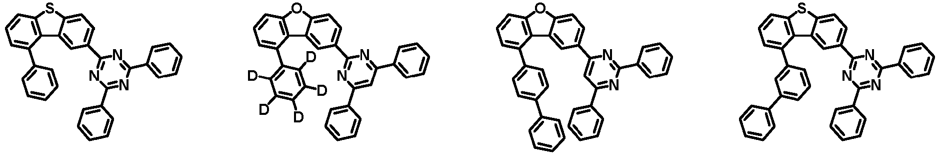

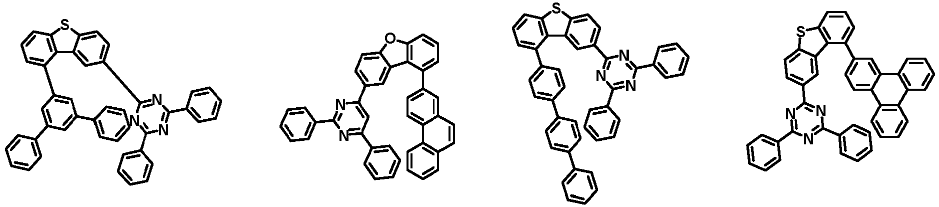

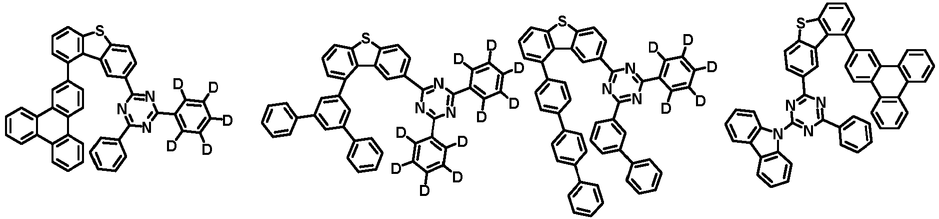

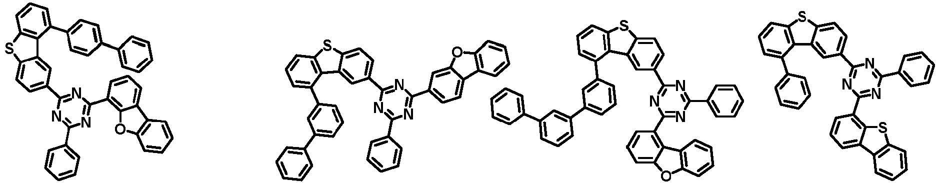

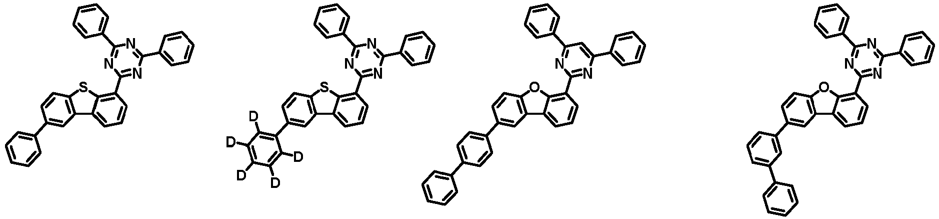

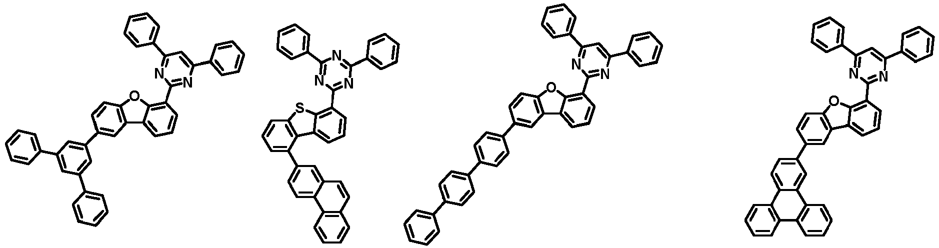

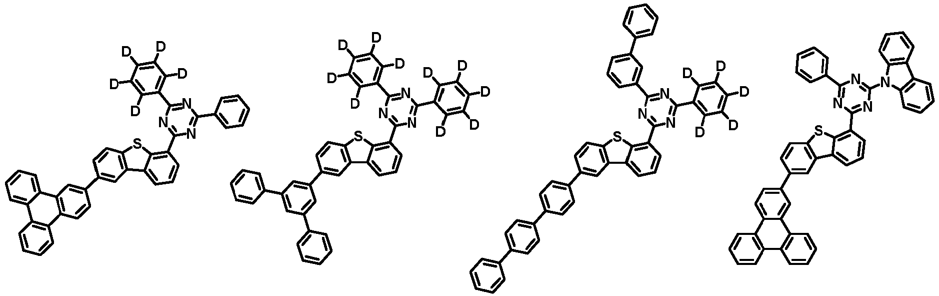

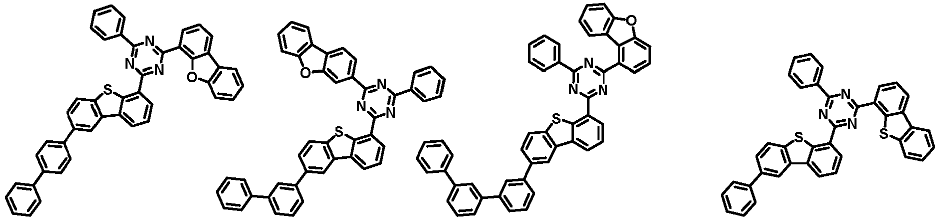

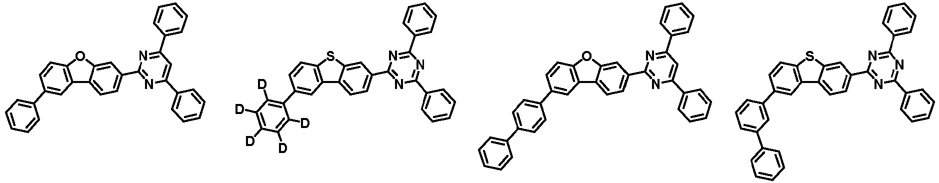

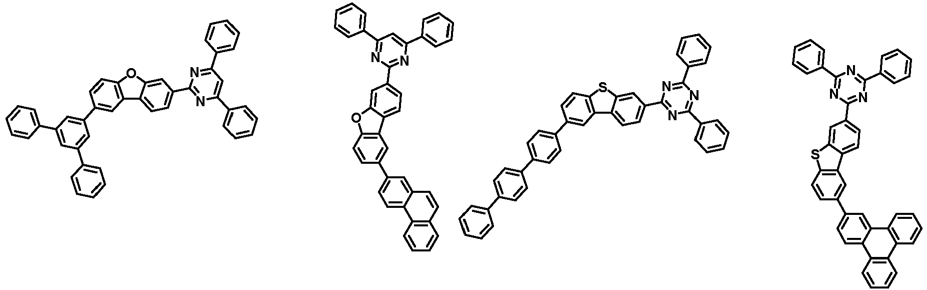

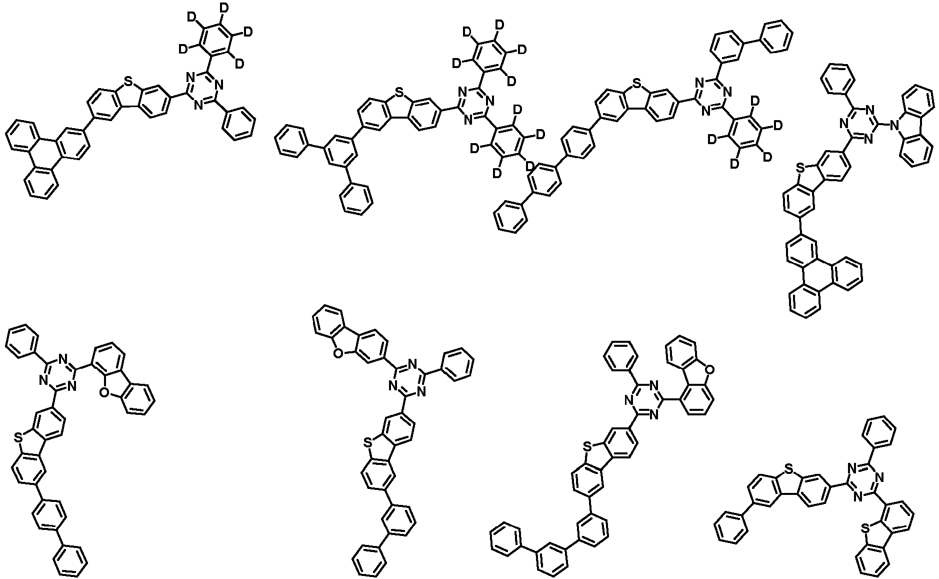

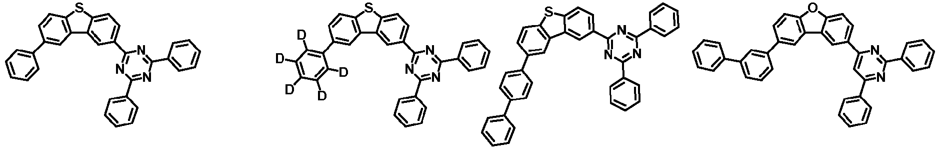

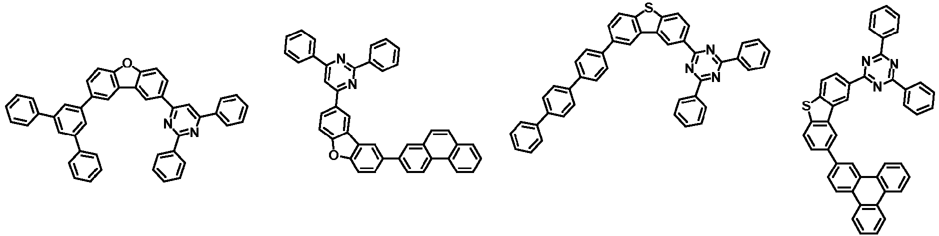

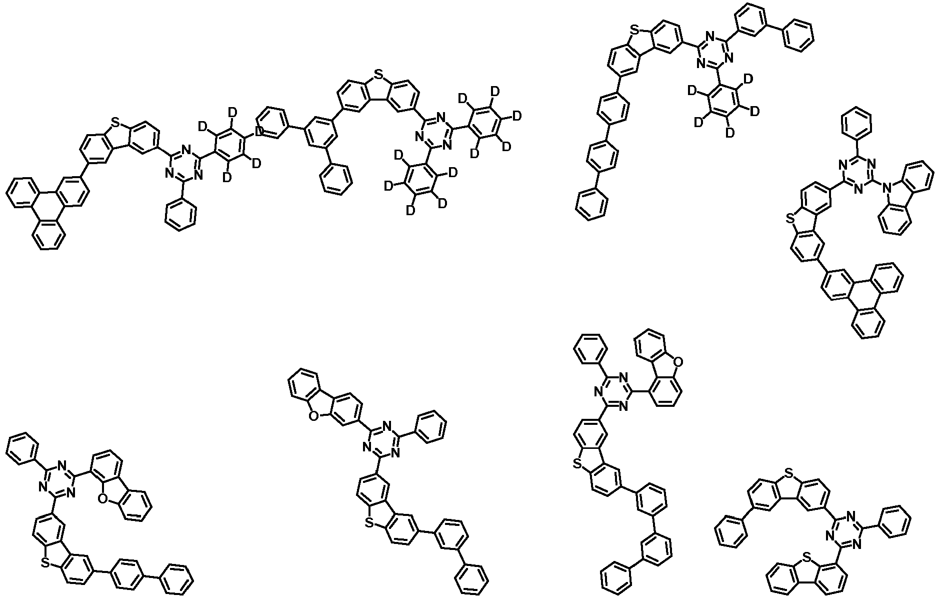

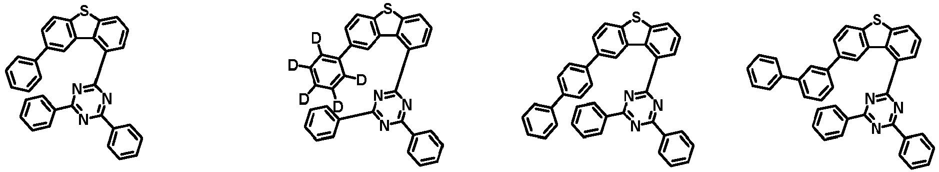

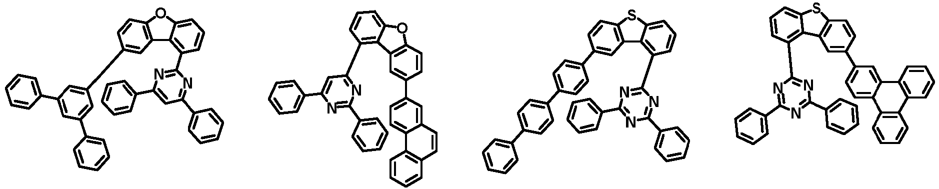

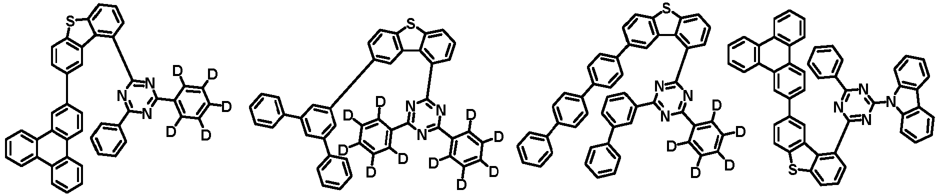

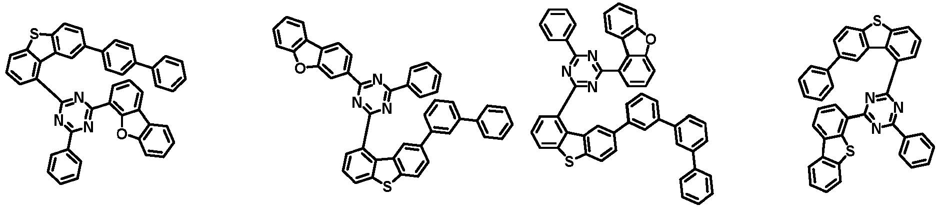

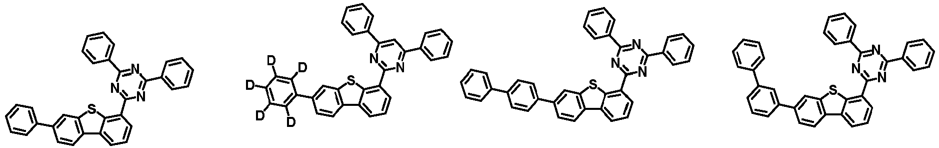

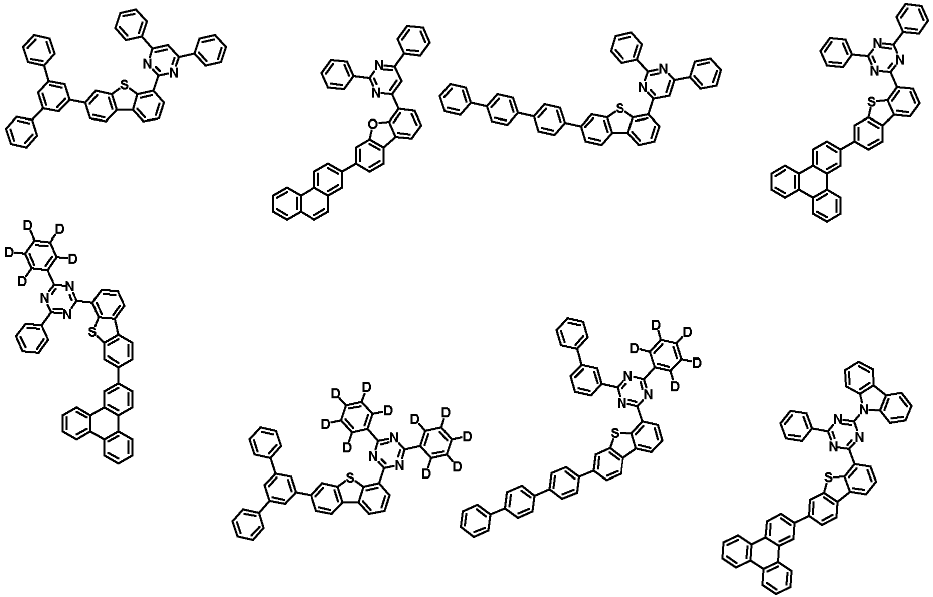

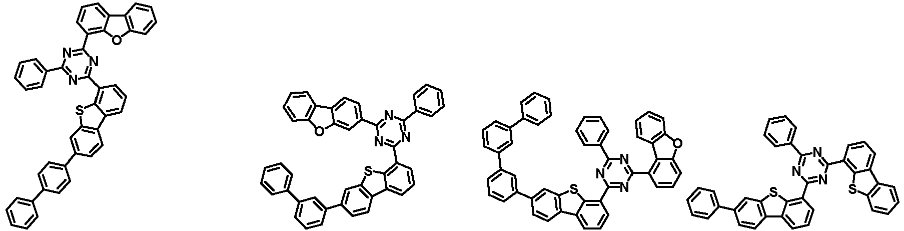

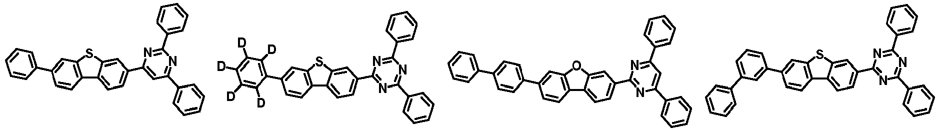

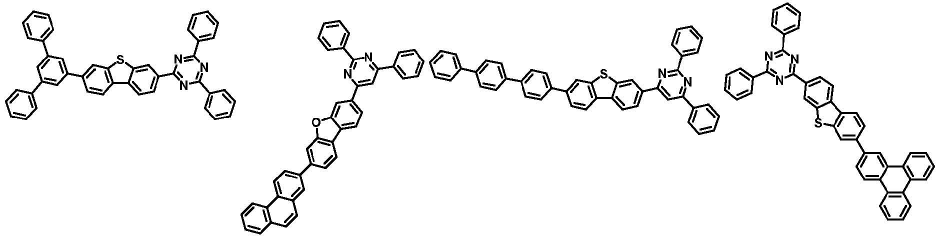

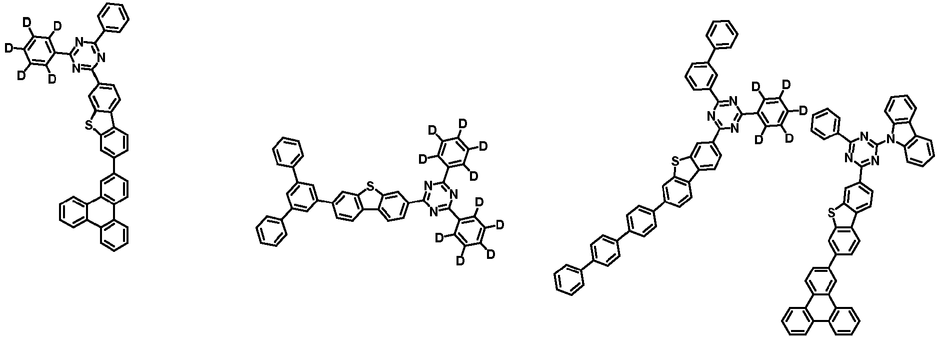

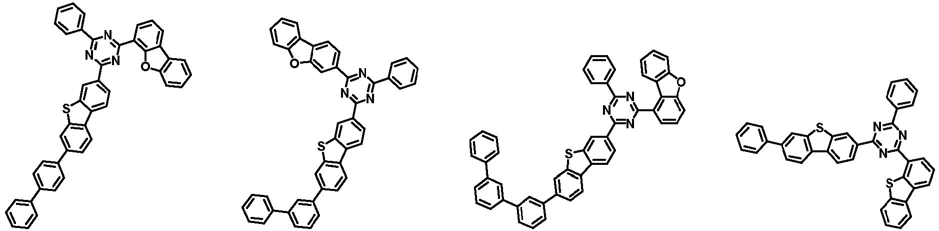

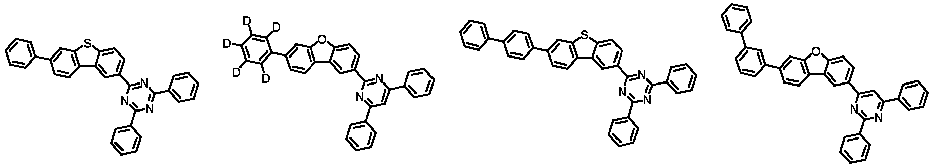

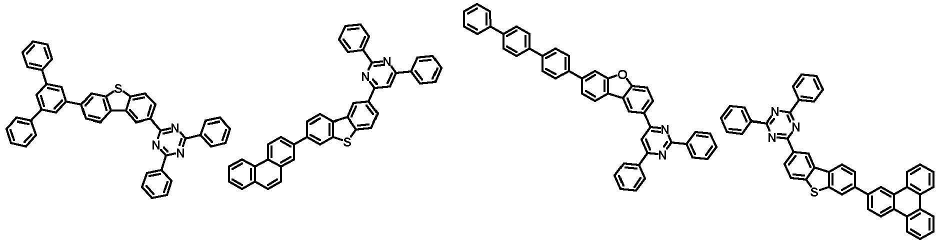

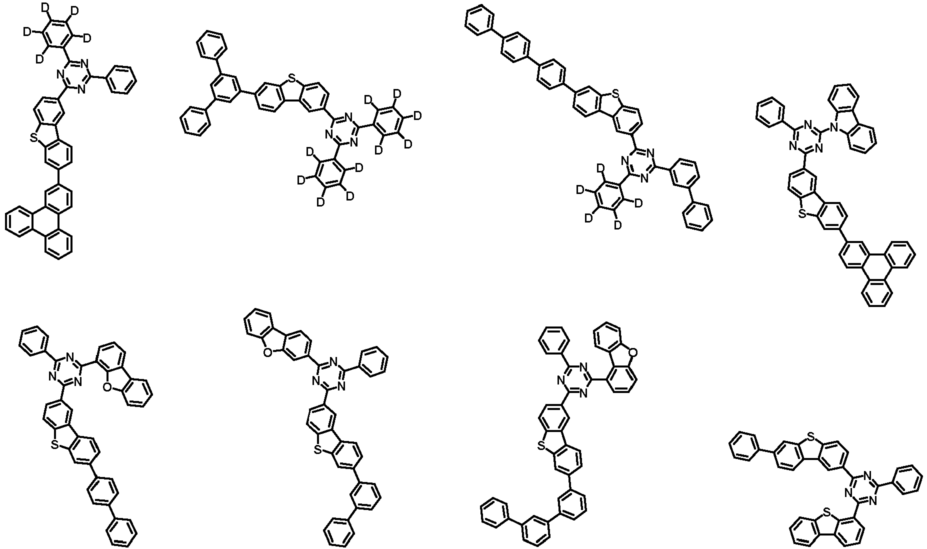

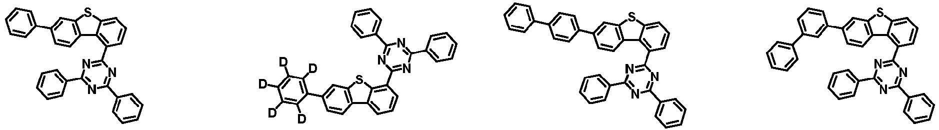

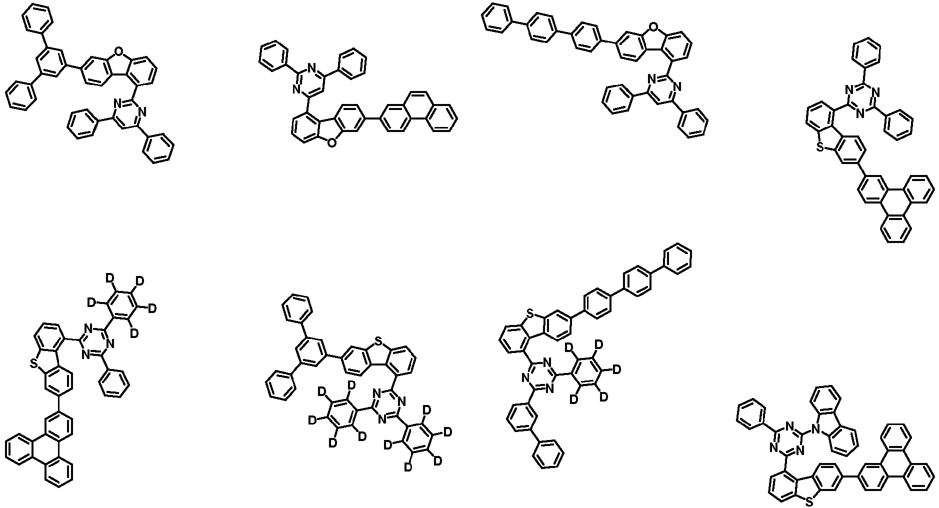

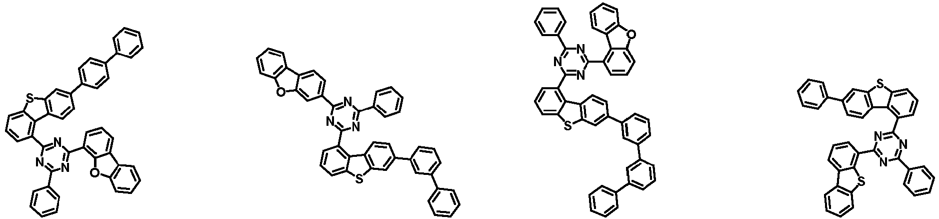

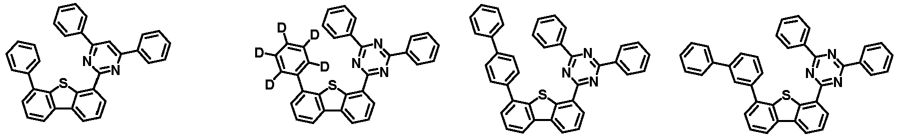

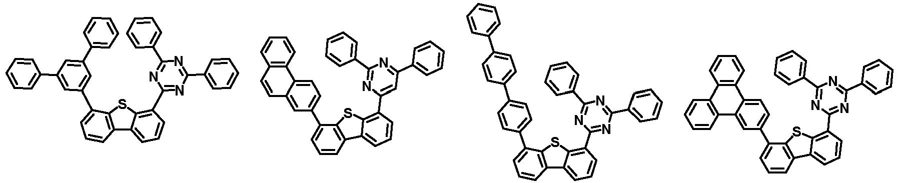

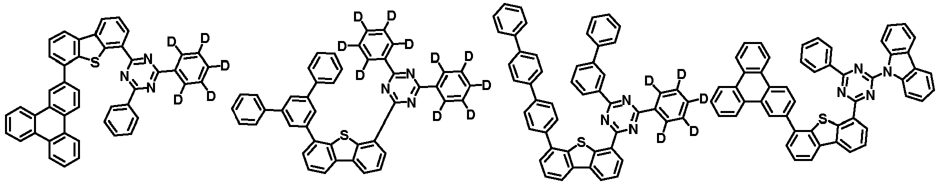

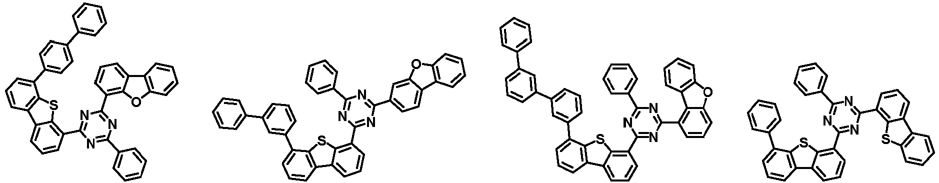

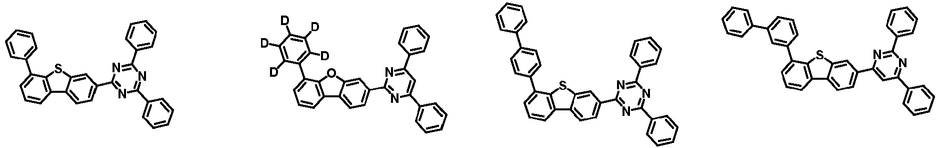

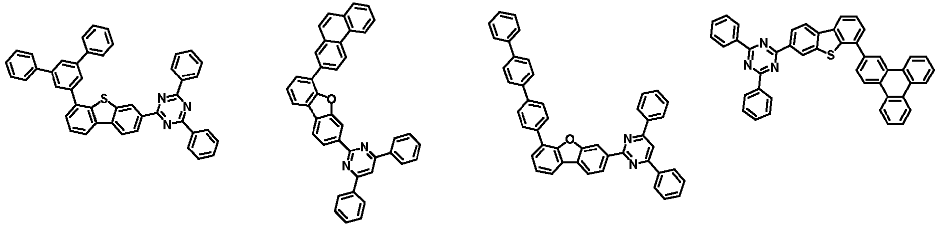

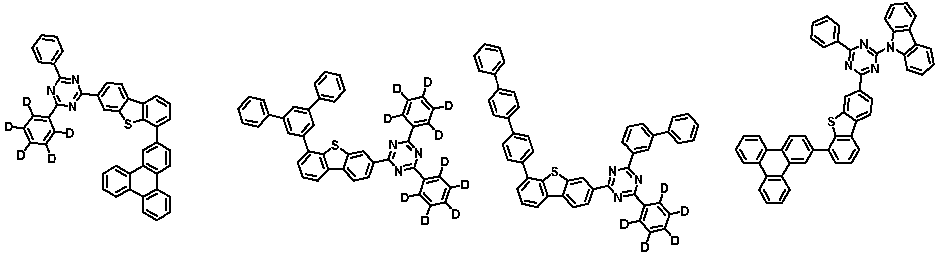

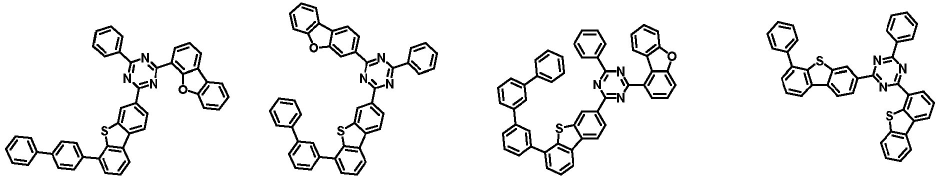

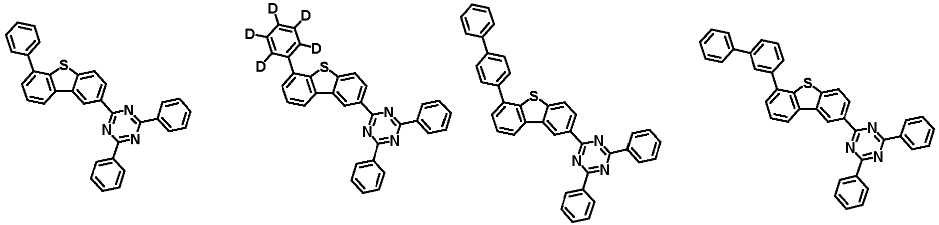

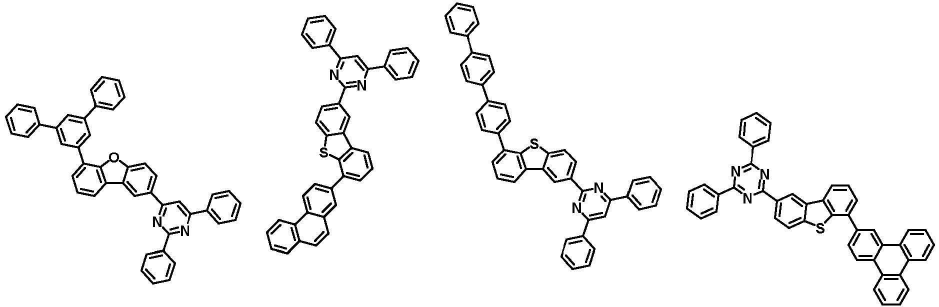

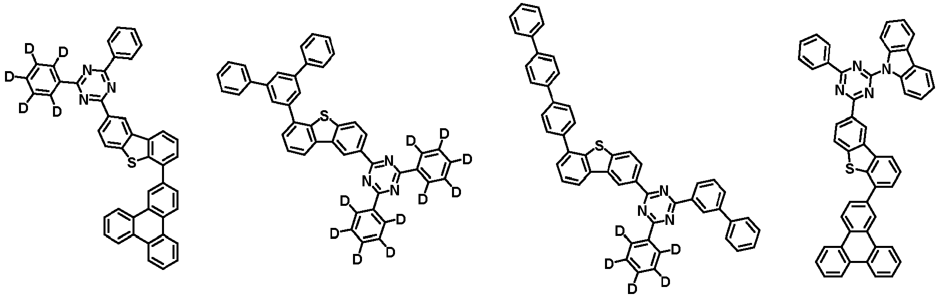

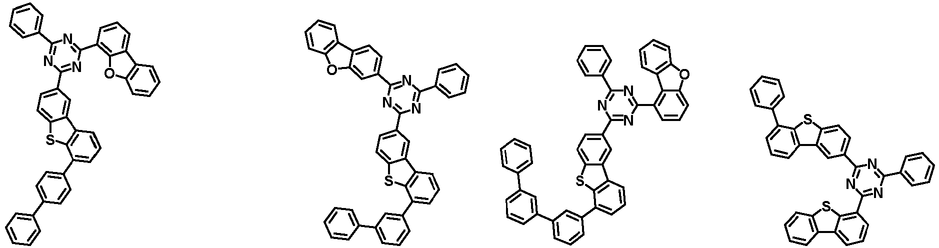

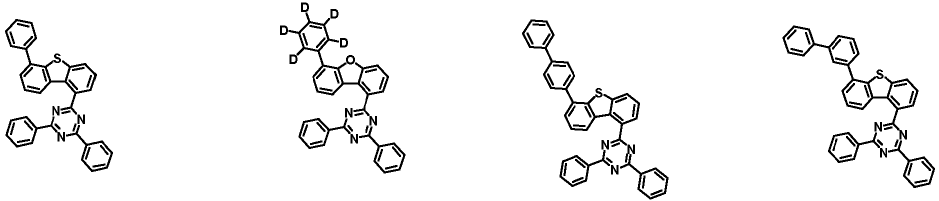

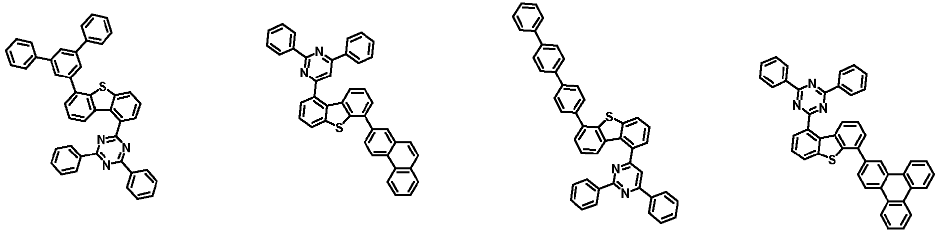

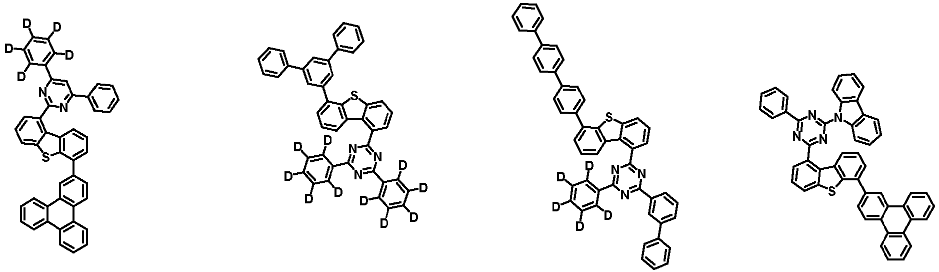

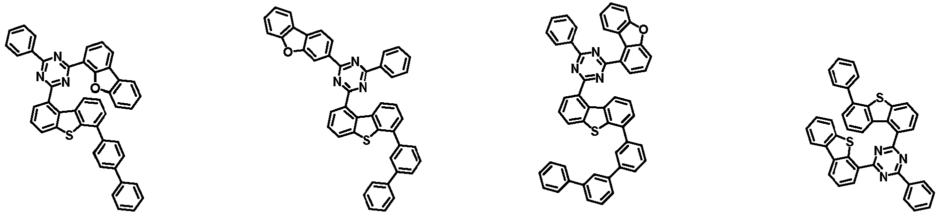

6. The organic light emitting device according to claim 1, wherein:
the Chemical Formula 2 is represented by any one of the following Chemical Formulas 2-1 to 2-4: 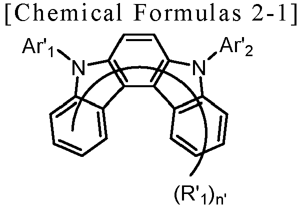 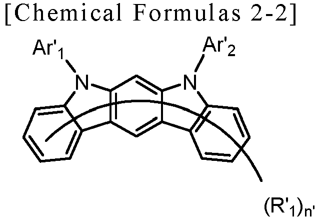 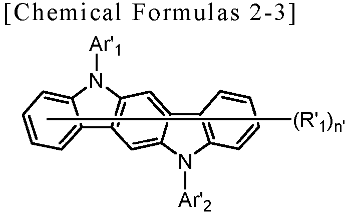 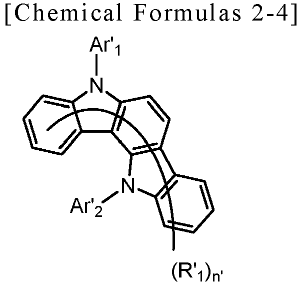
wherein, in Chemical Formula 2-1 to Chemical Formula 2-4,
n', R'₁, Ar'₁, and Ar'₂ are the same as defined in claim 1.

7. The organic light emitting device according to claim 1, wherein:
R'₁ is each independently hydrogen or deuterium.

8. The organic light emitting device according to claim 1, wherein:
Ar'₁ and Ar'₂ are each independently phenyl unsubstituted or substituted with 1 to 5 deuteriums; biphenylyl unsubstituted or substituted with 1 to 9 deuteriums; methyl-biphenylyl unsubstituted or substituted with 1 to 11 deuteriums; dimethyl-biphenylyl unsubstituted or substituted with 1 to 13 deuteriums; terphenylyl unsubstituted or substituted with 1 to 13 deuteriums; dimethylfluorenyl unsubstituted or substituted with 1 to 13 deuteriums; dibenzofuranyl unsubstituted or substituted with 1 to 7 deuteriums; dibenzothiophenyl unsubstituted or substituted with 1 to 7 deuteriums; dimethylfluorenyl-phenyl unsubstituted or substituted with 1 to 17 deuteriums; dibenzofuranyl-phenyl unsubstituted or substituted with 1 to 11 deuteriums; or dibenzothiophenyl-phenyl unsubstituted or substituted with 1 to 11 deuteriums.

9. The organic light emitting device according to claim 1, wherein:
the compound represented by Chemical Formula 2 is any one selected from the group consisting of: 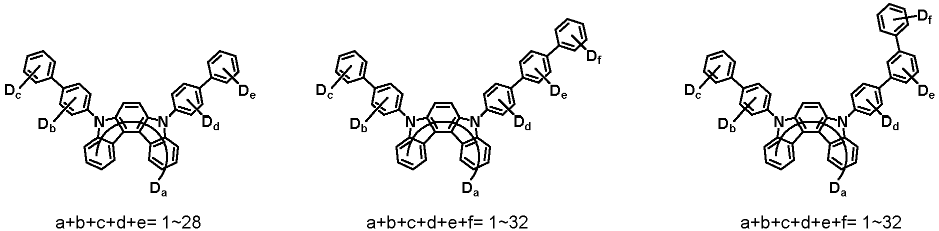 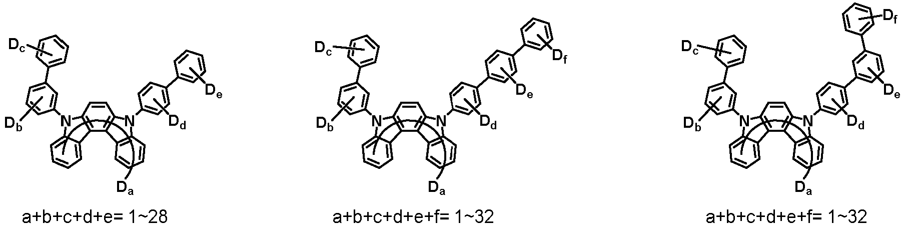 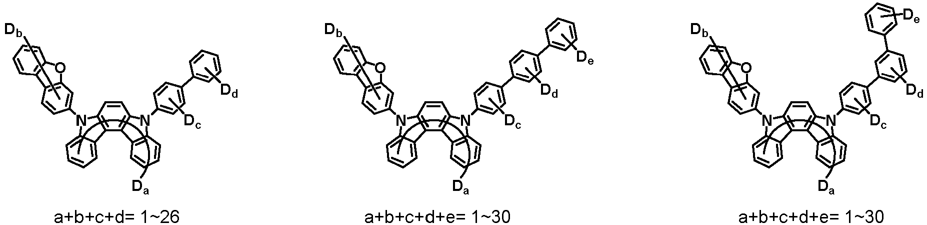 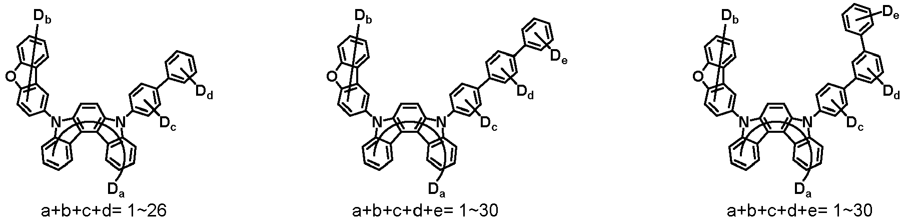 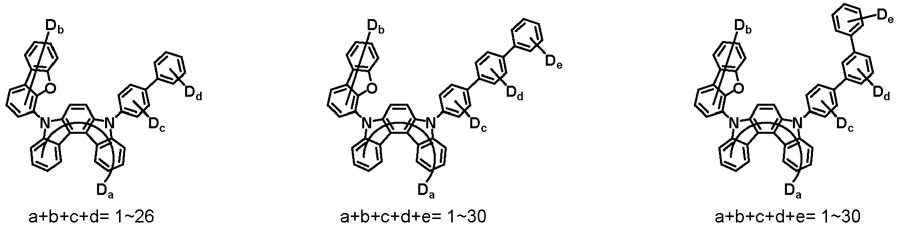 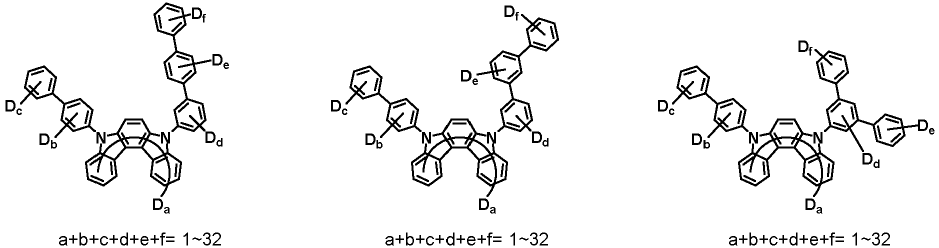 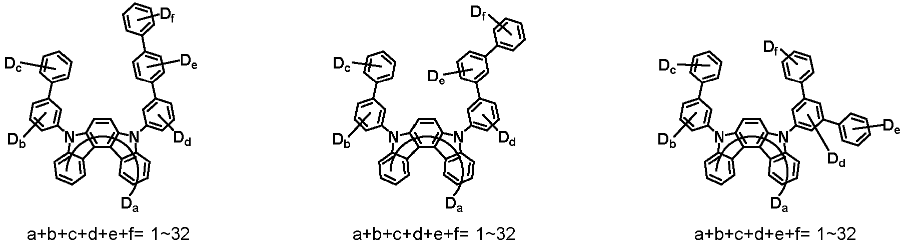 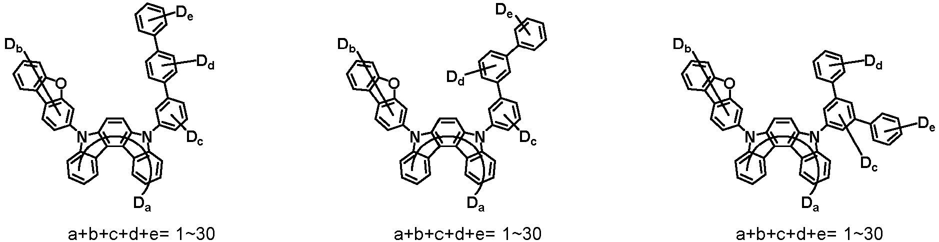 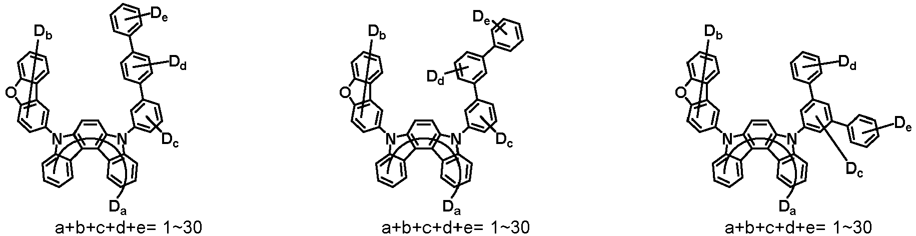 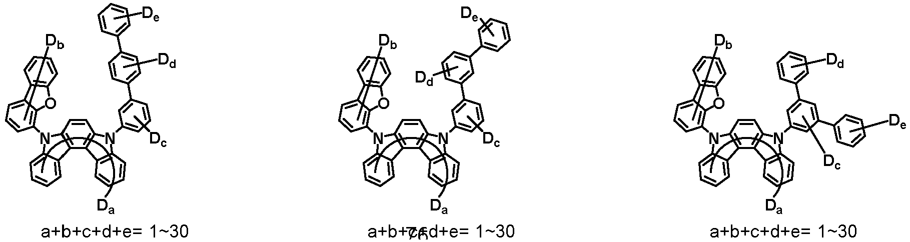 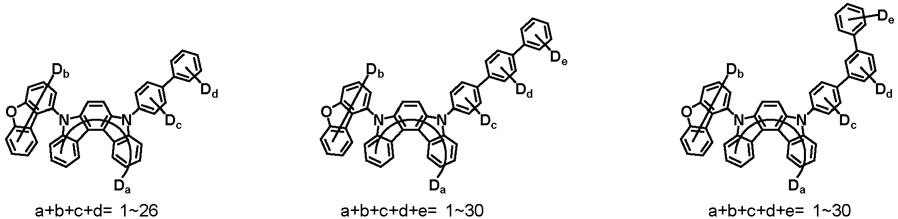 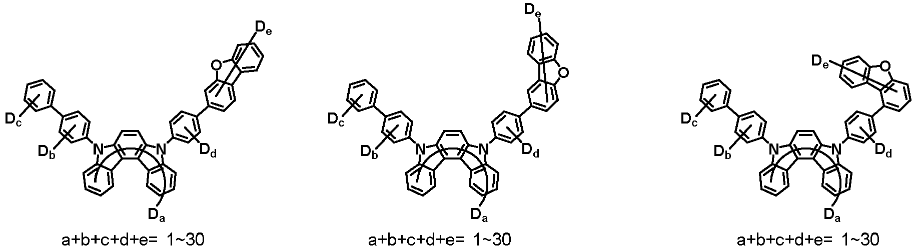 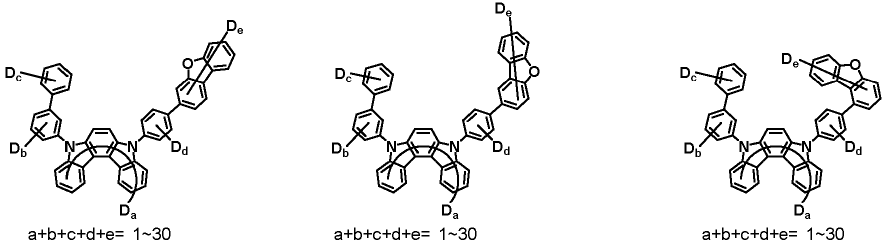 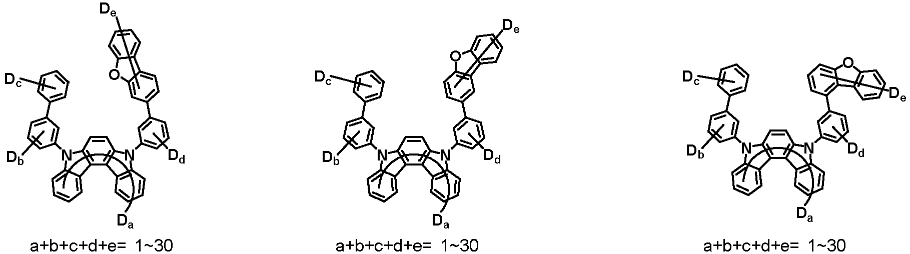 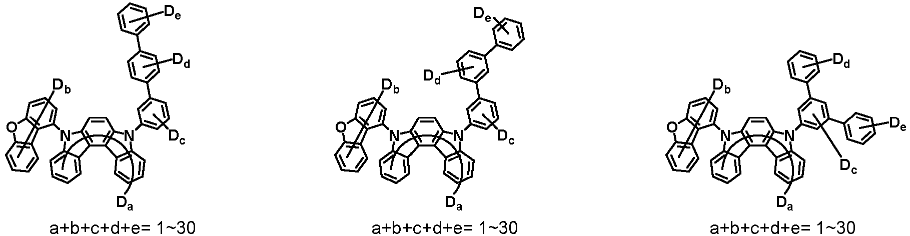 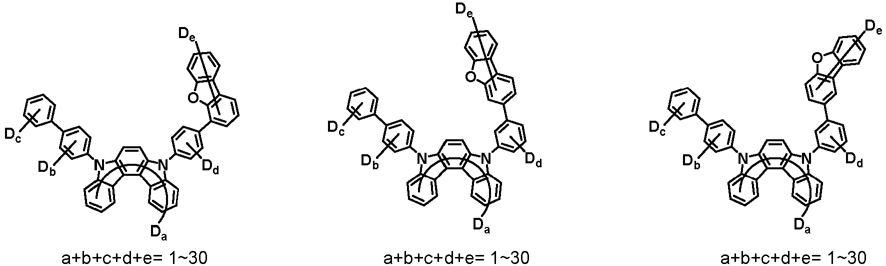 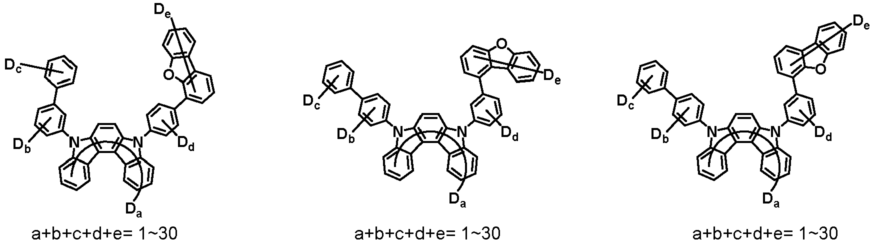 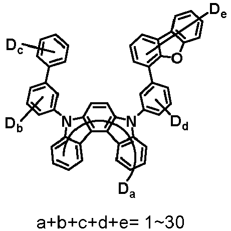 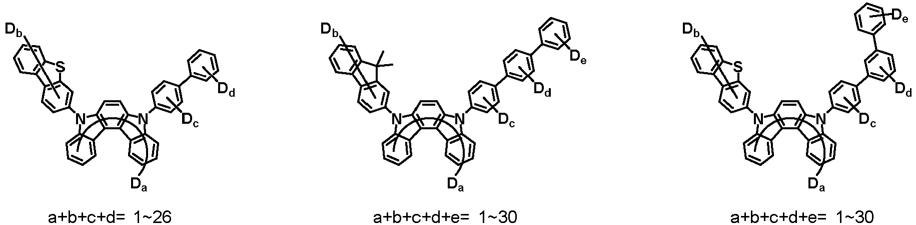 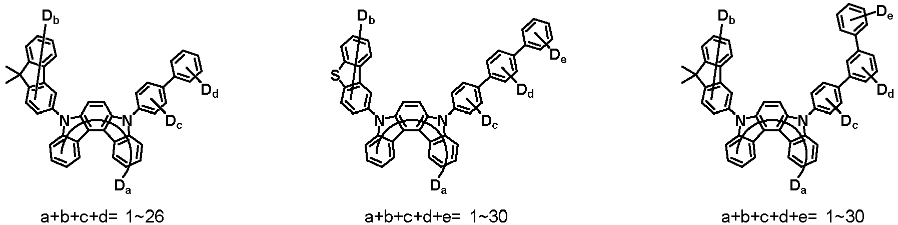 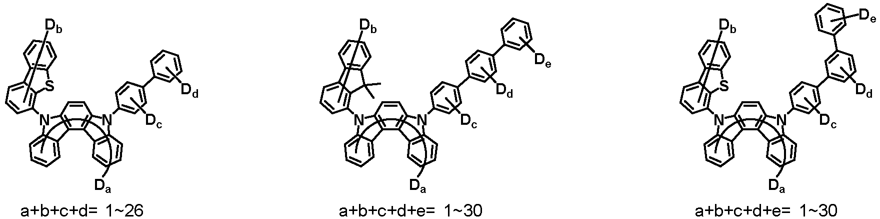 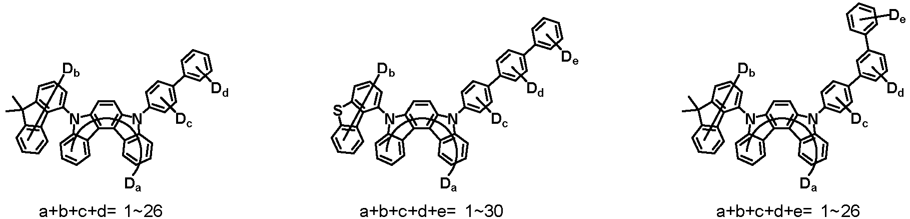 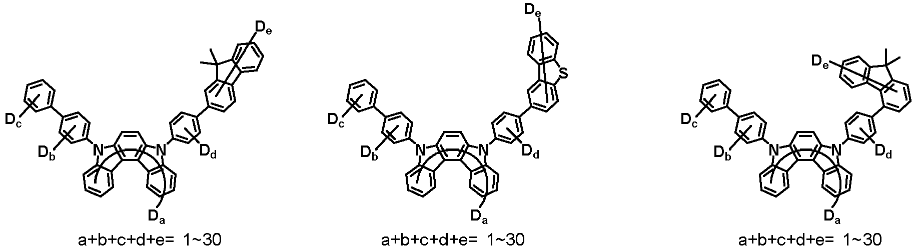 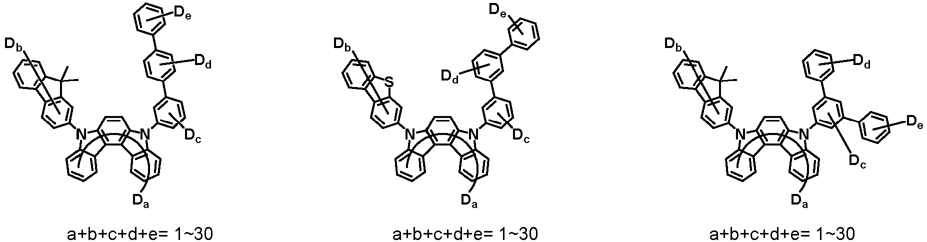 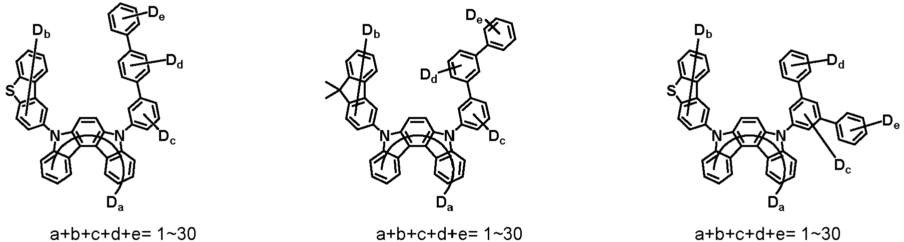 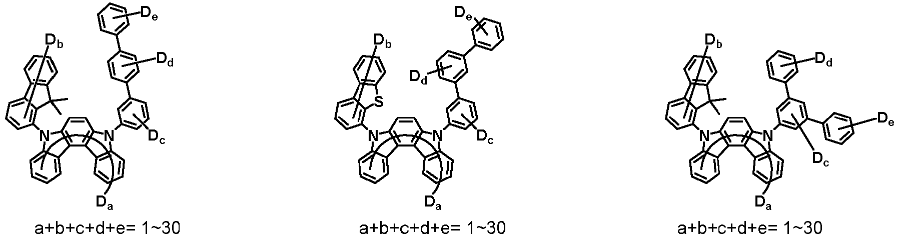 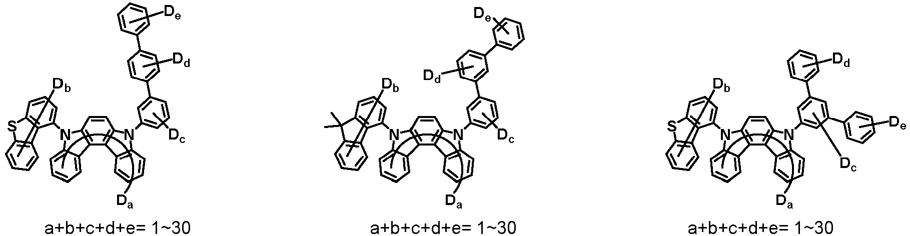 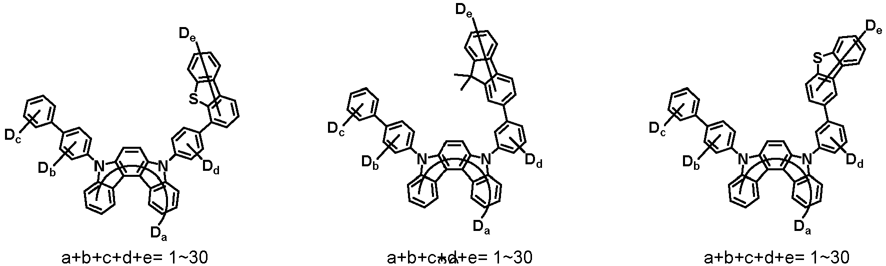 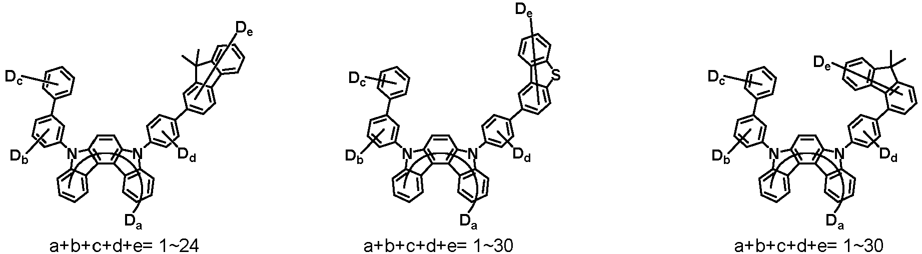 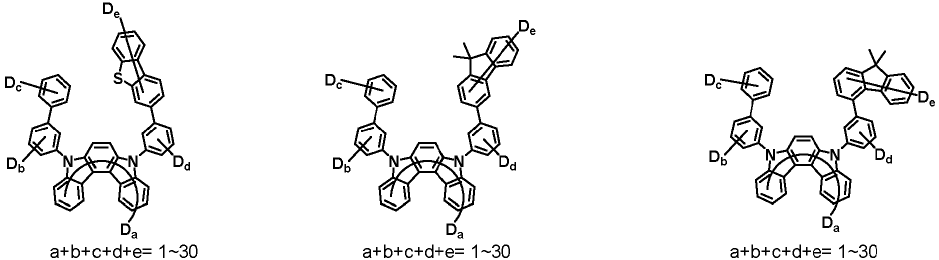 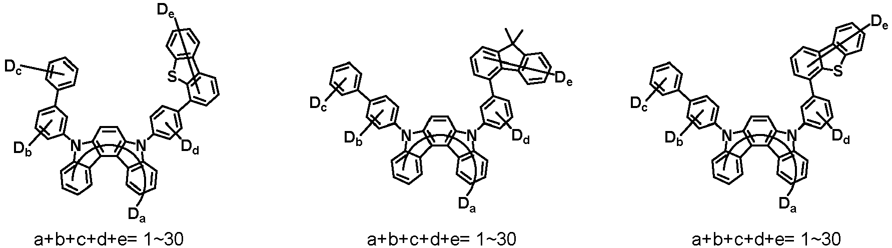 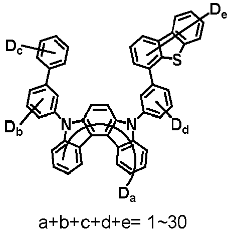 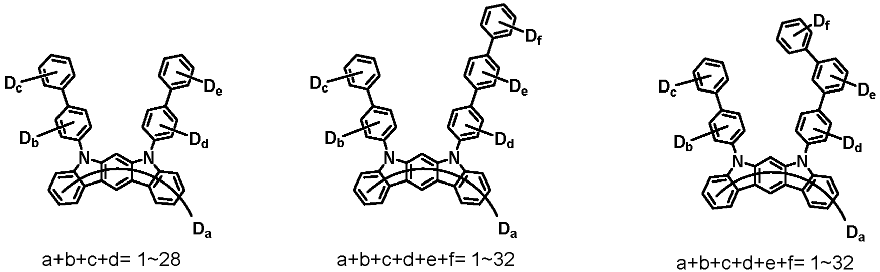 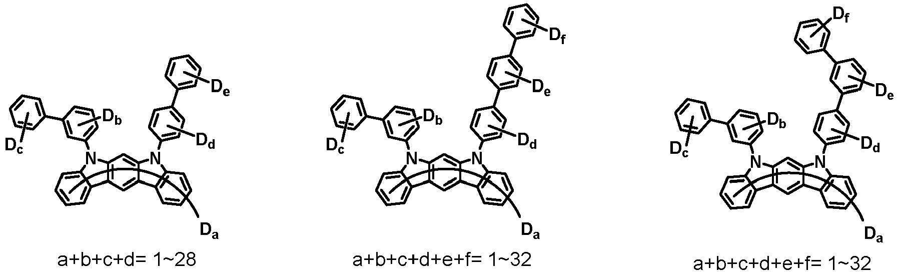 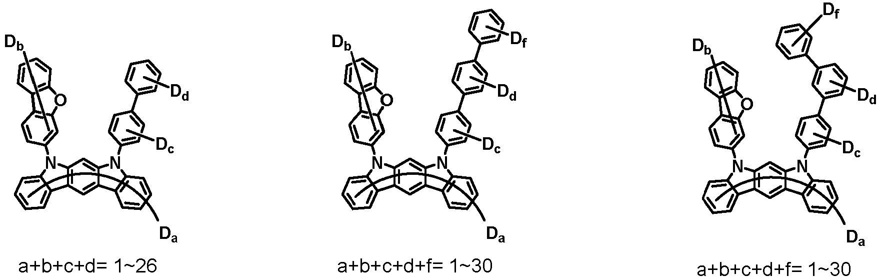 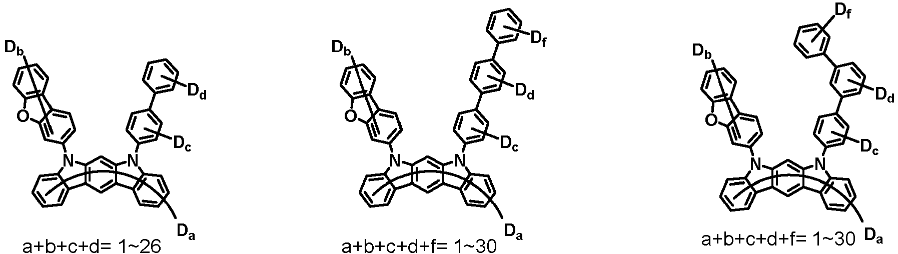 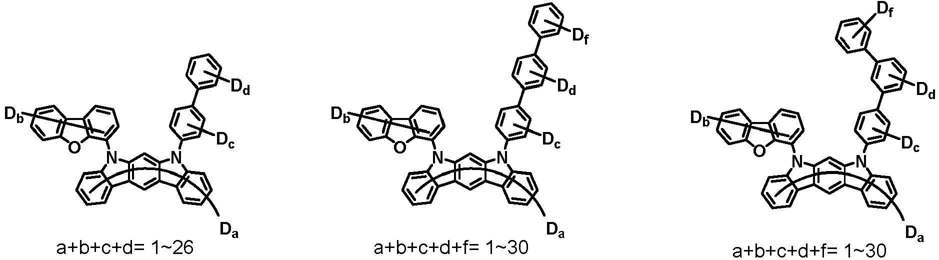 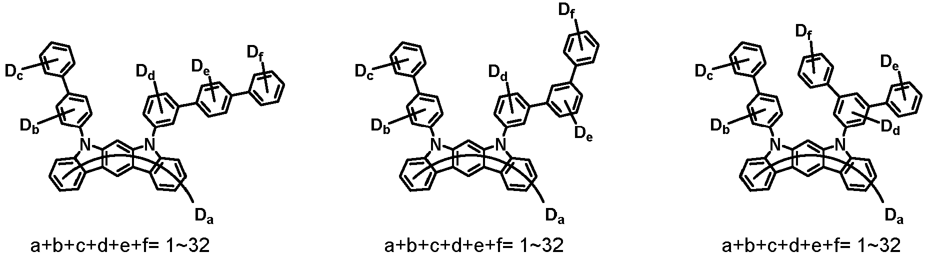 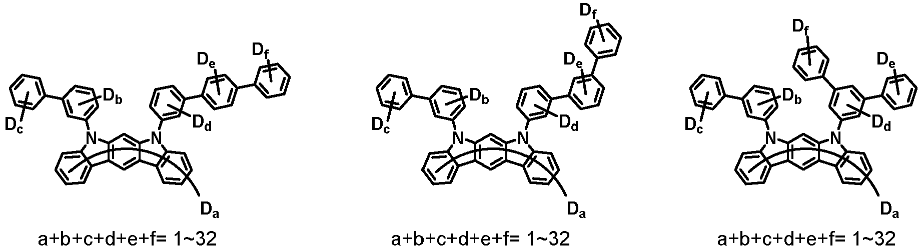 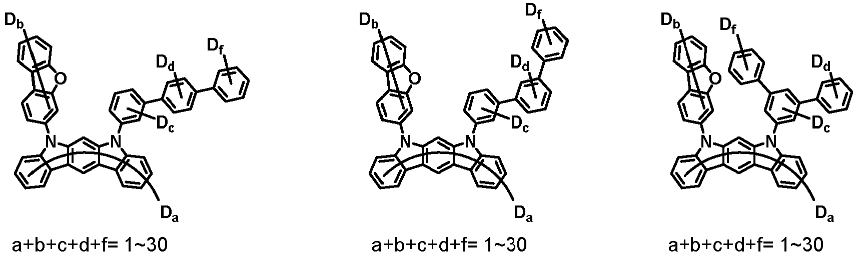 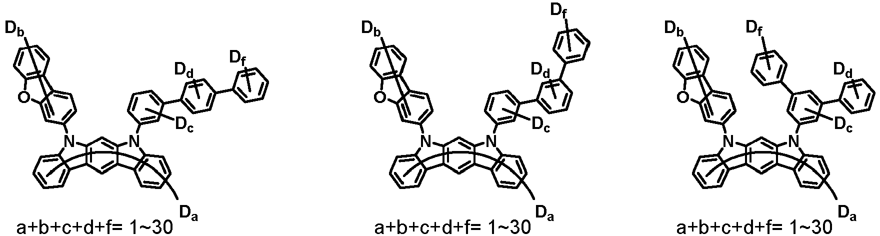 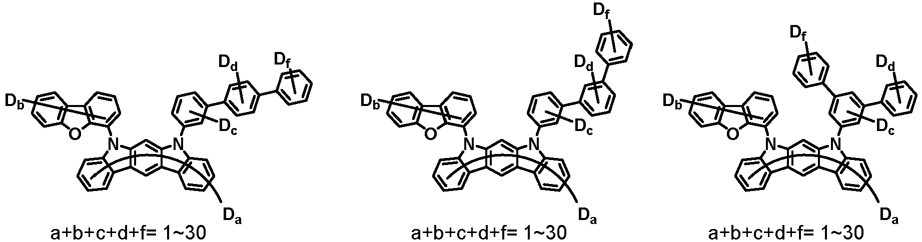 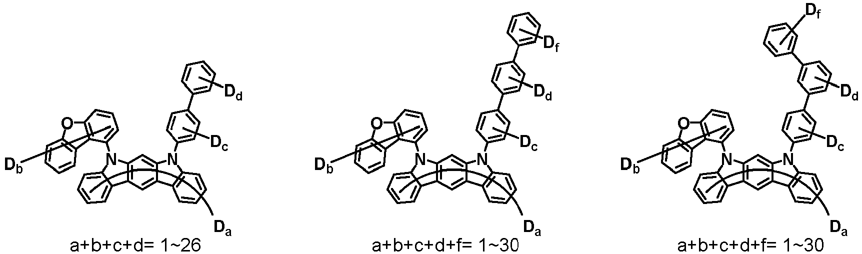 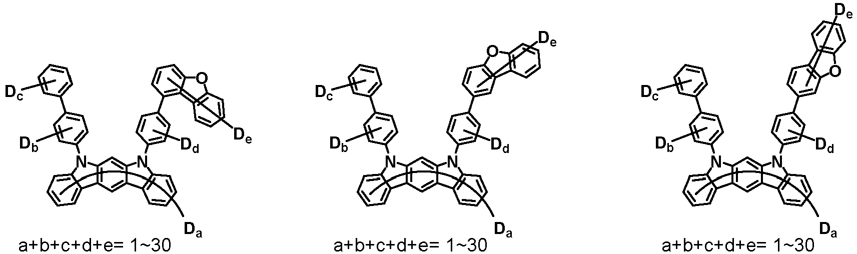 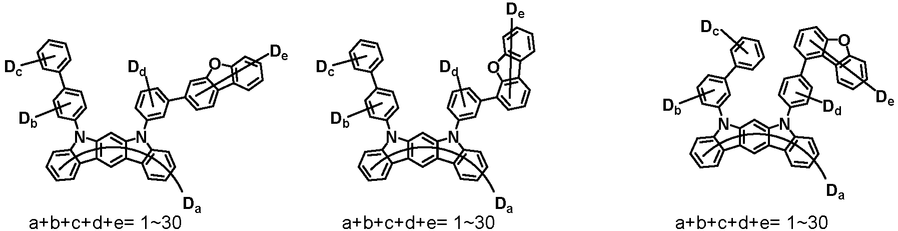 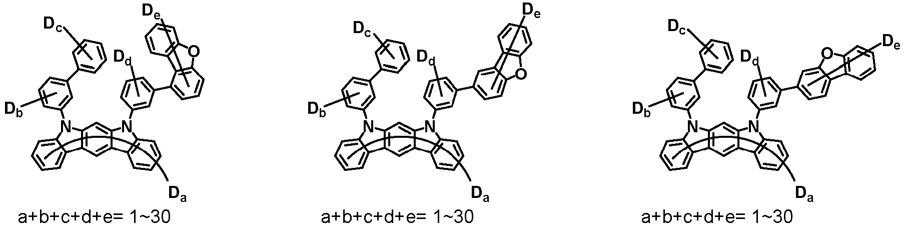 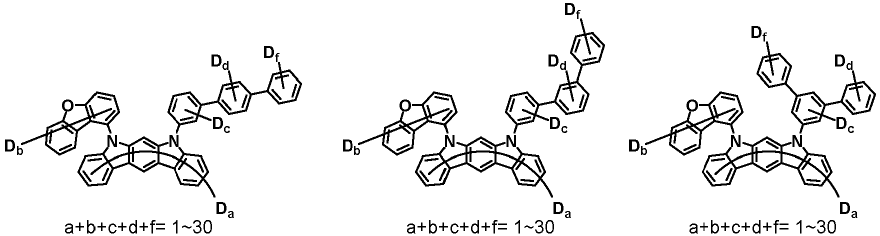 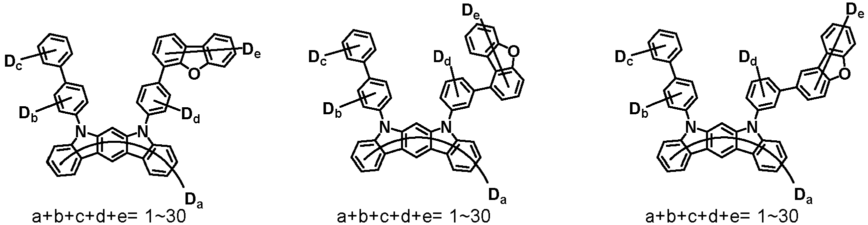 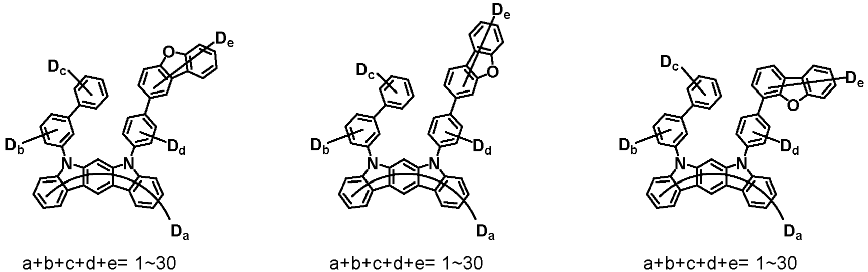 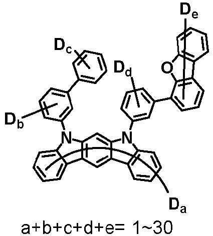 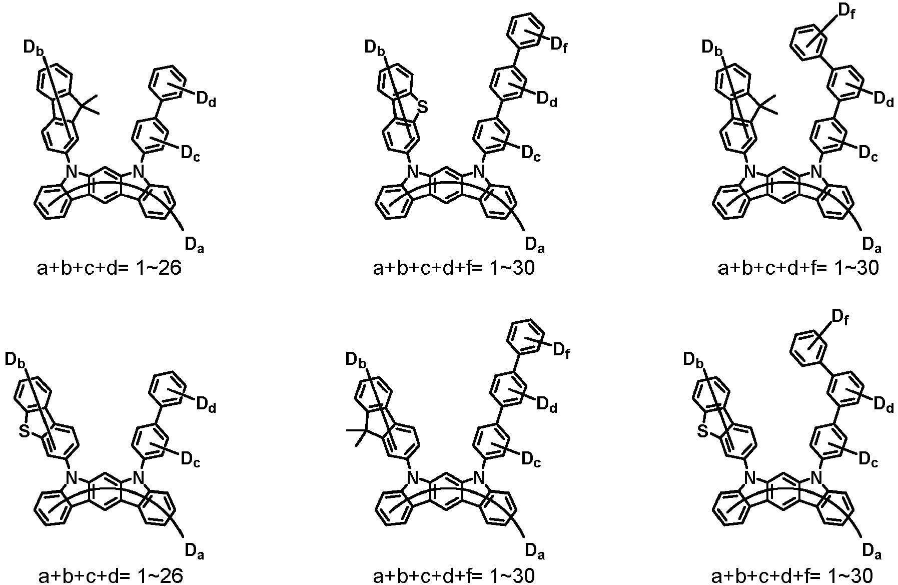 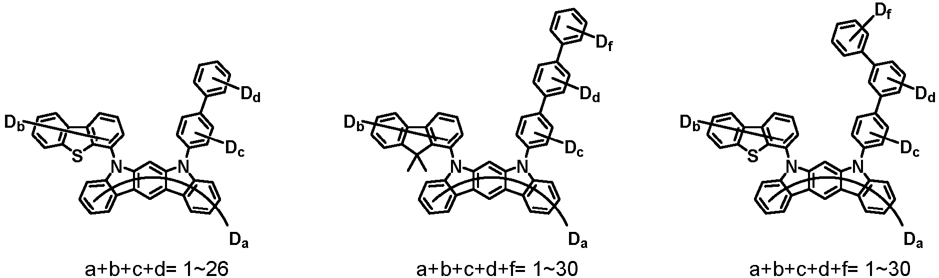 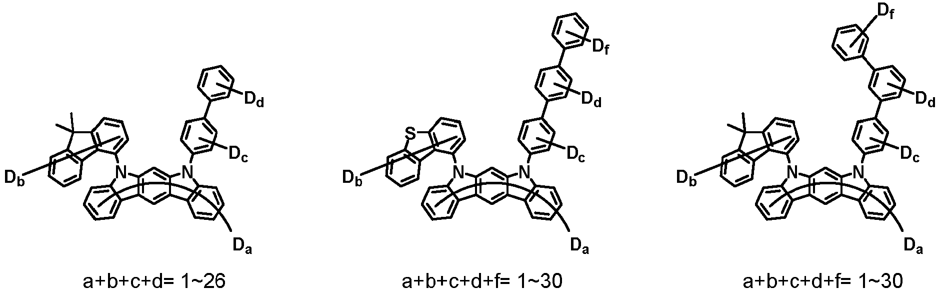 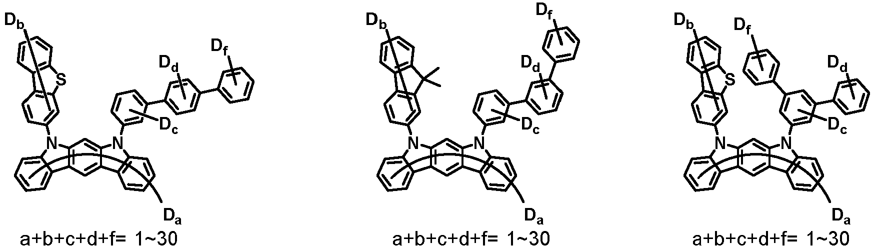 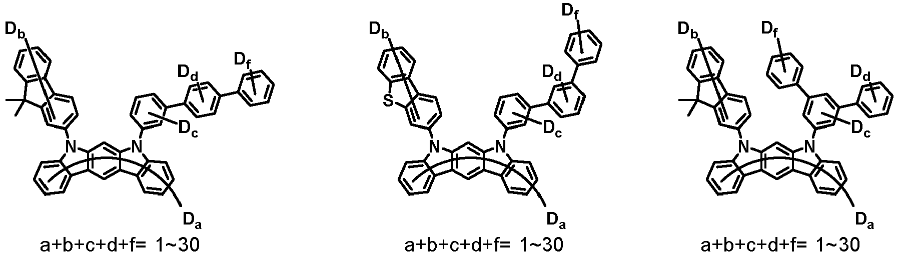 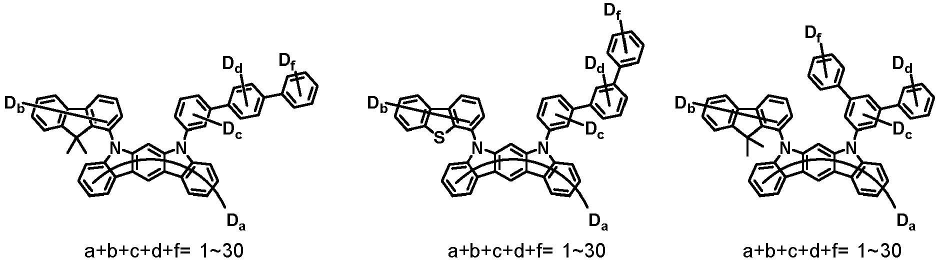 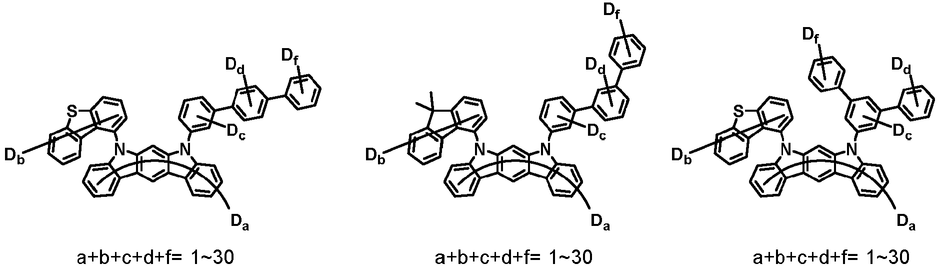 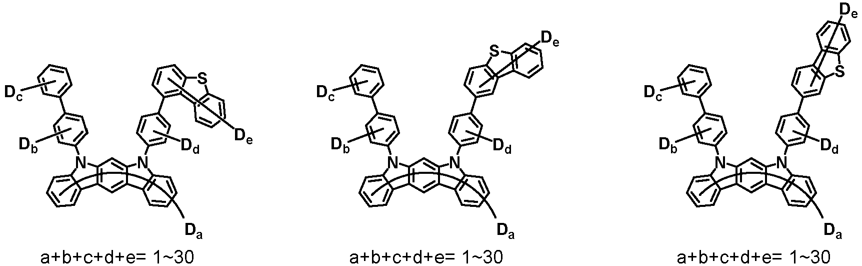 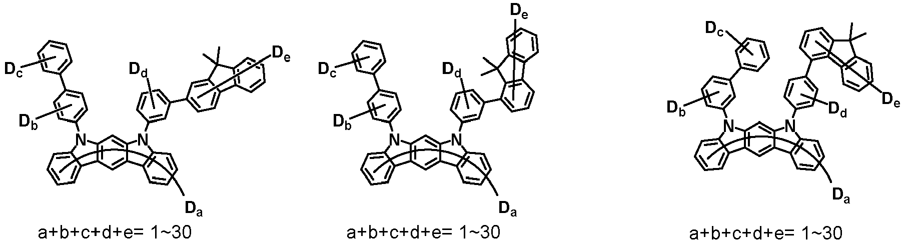 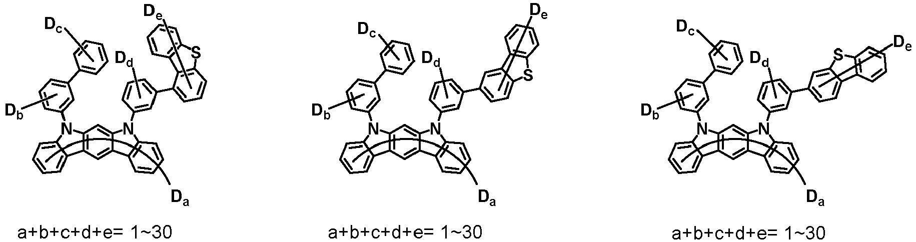 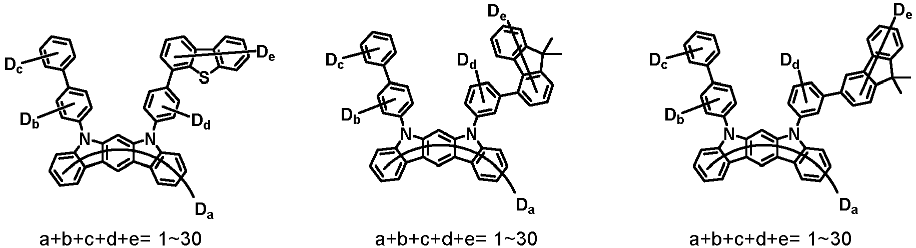 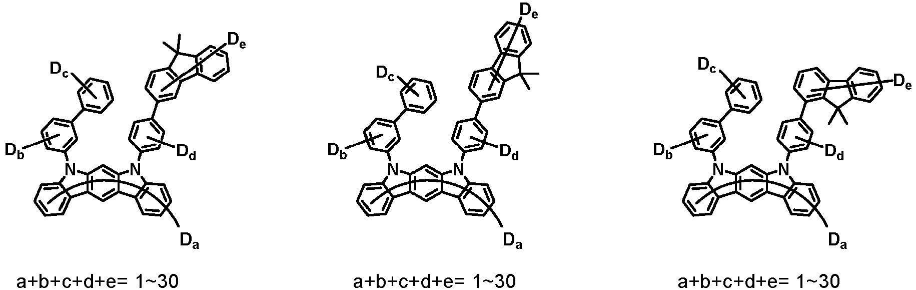 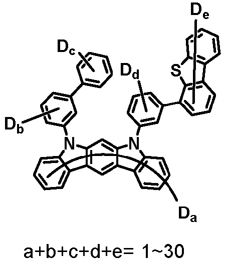 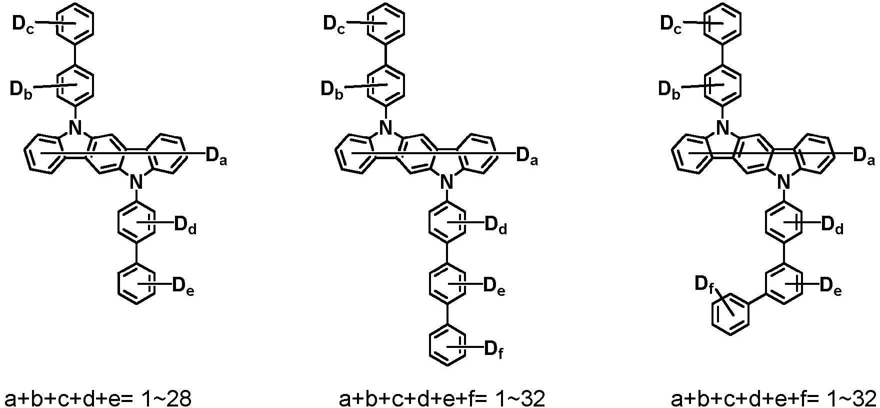 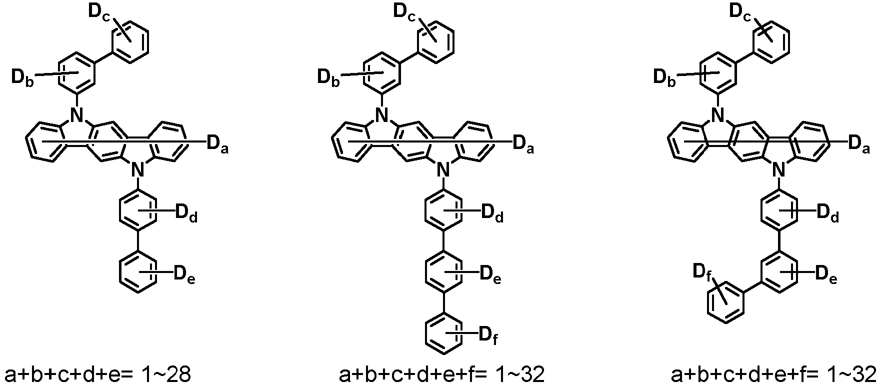 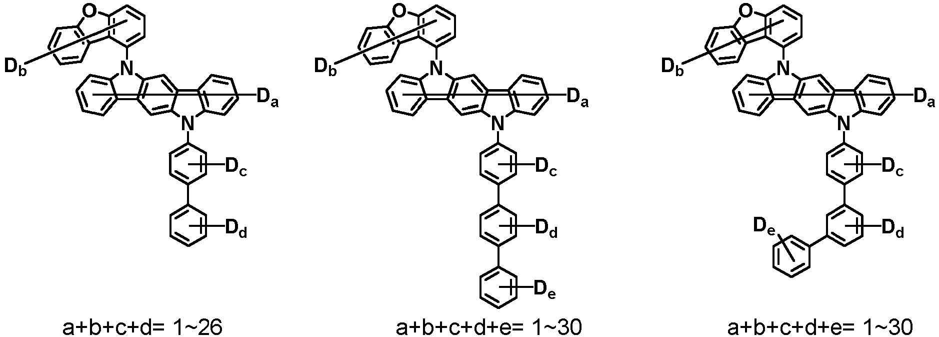 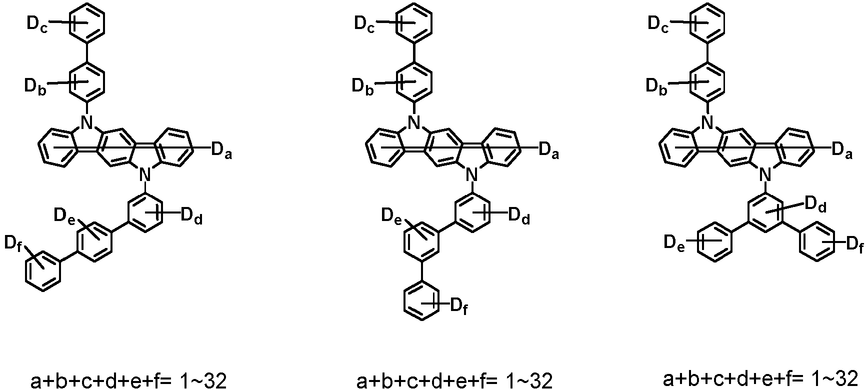 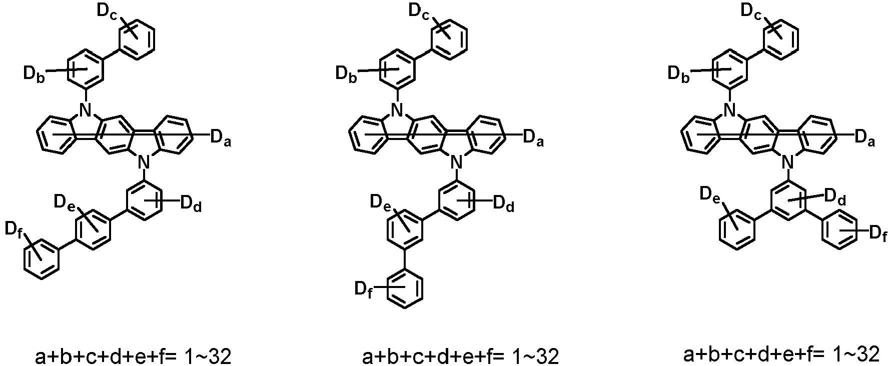 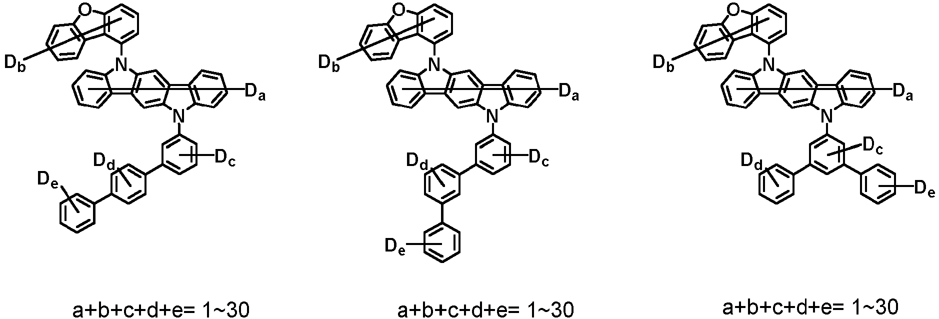 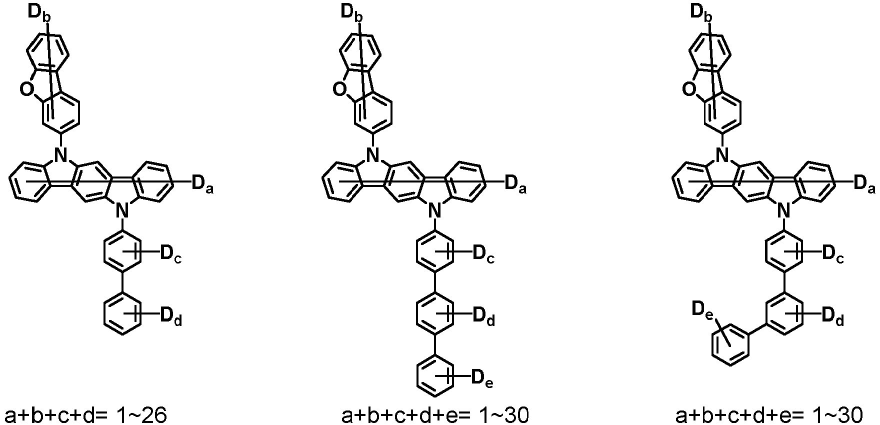 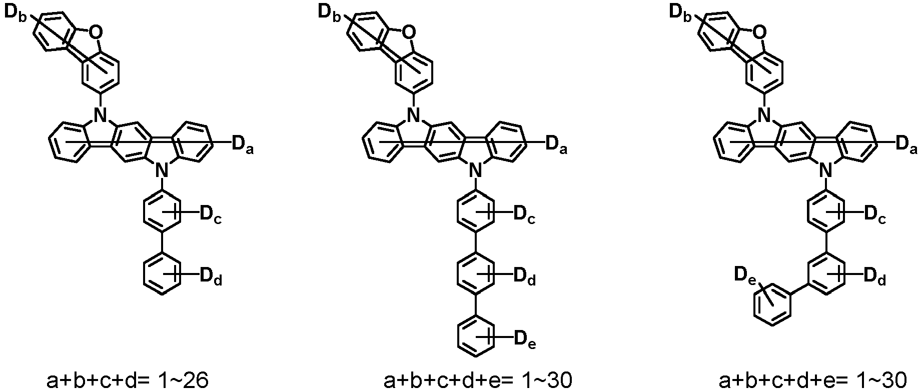 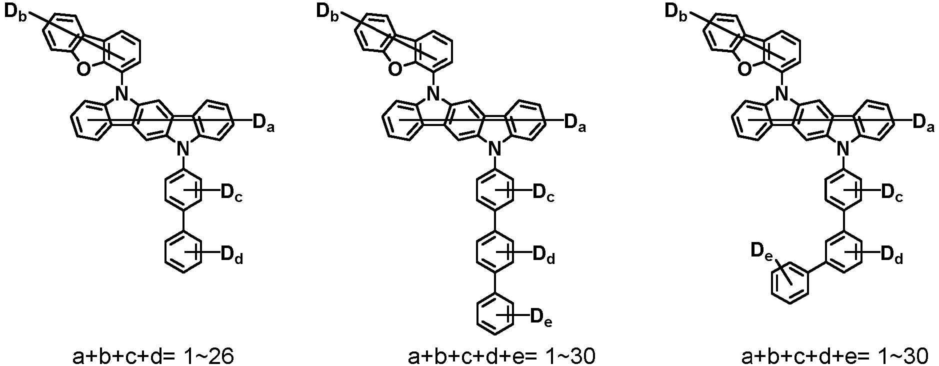 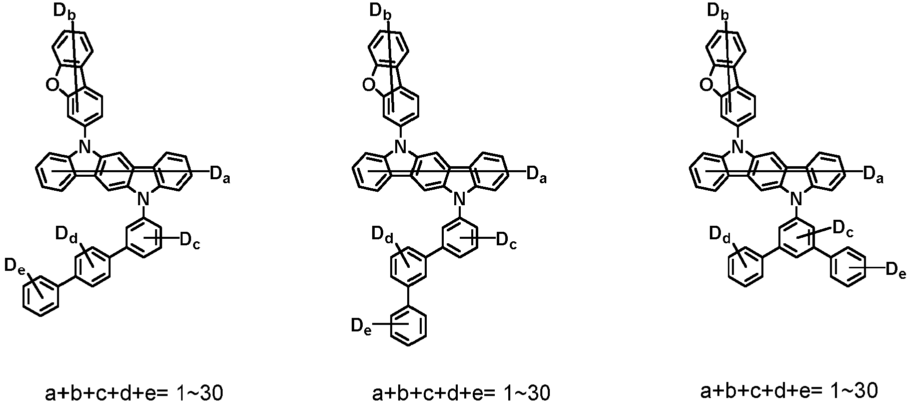 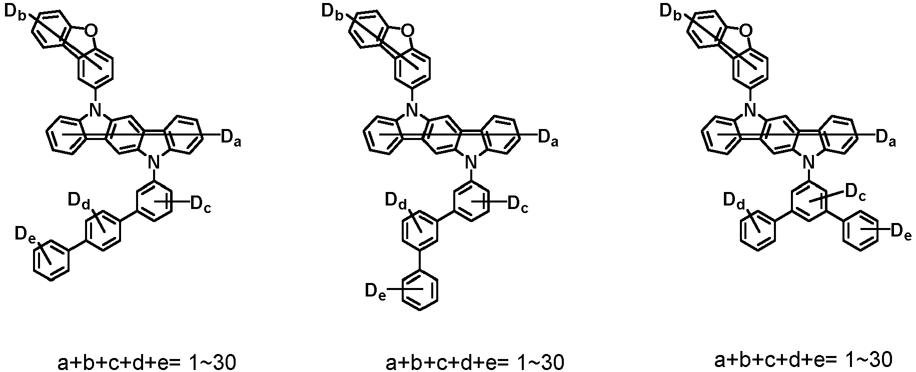 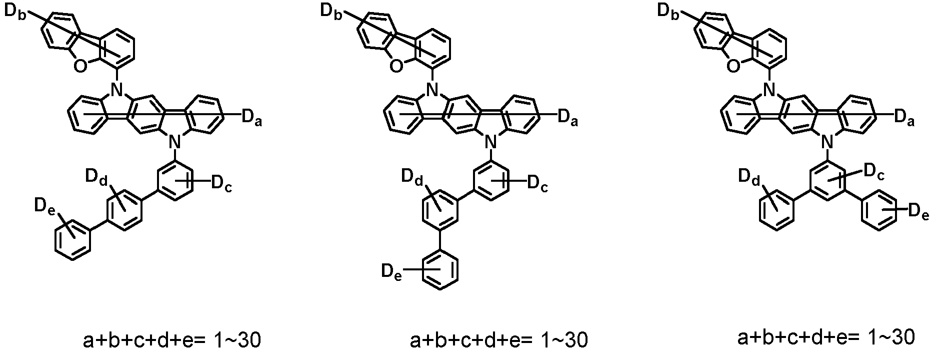 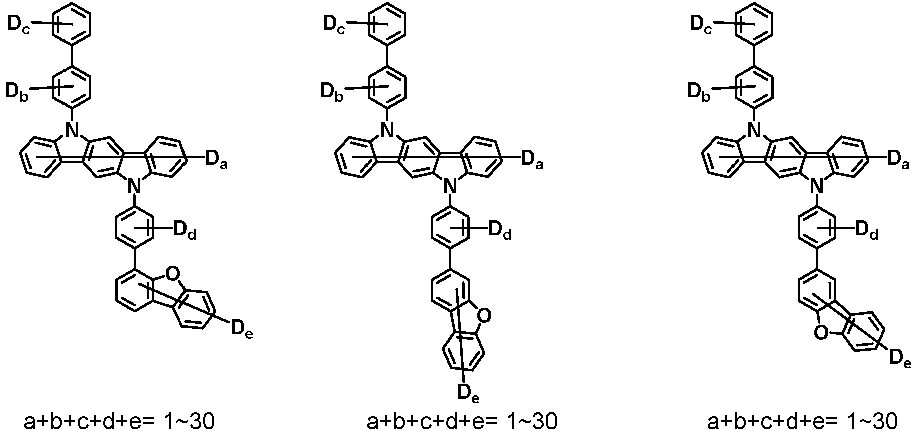 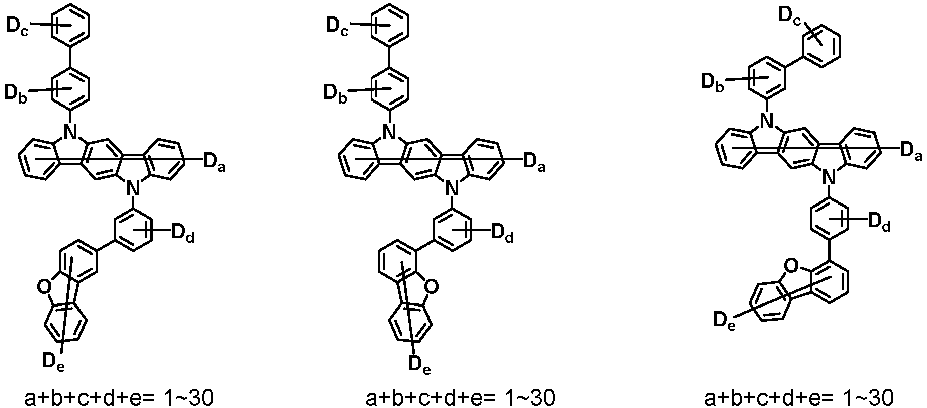 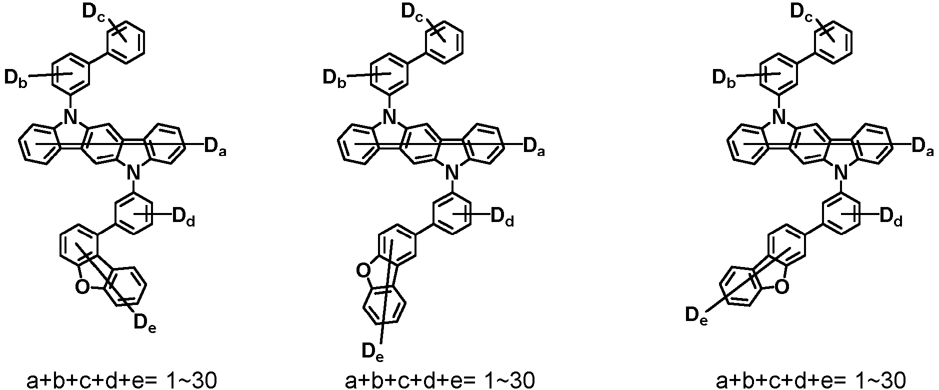 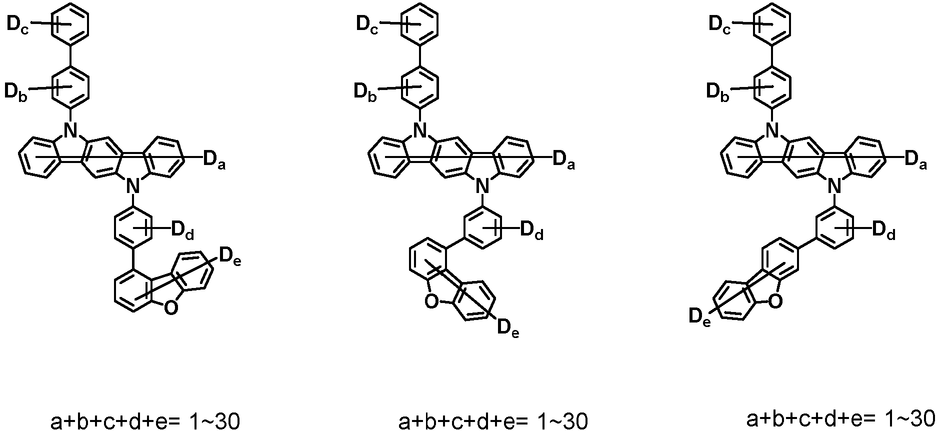 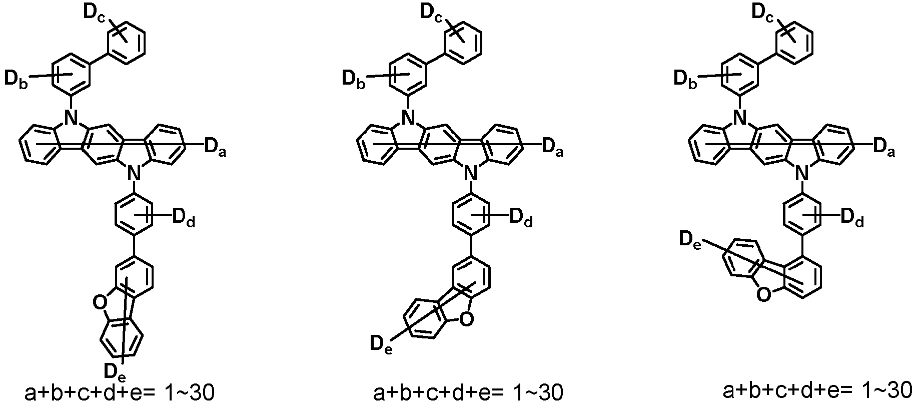 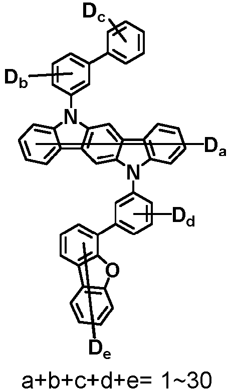 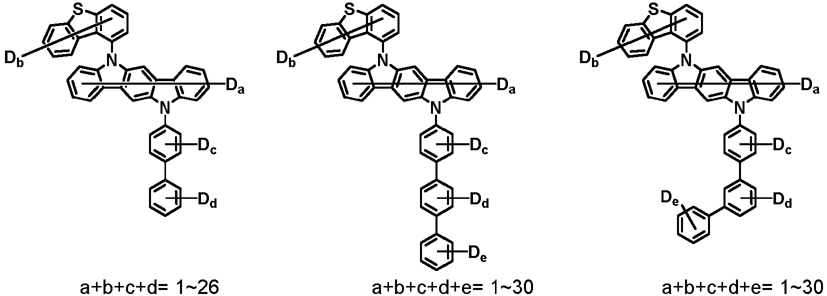 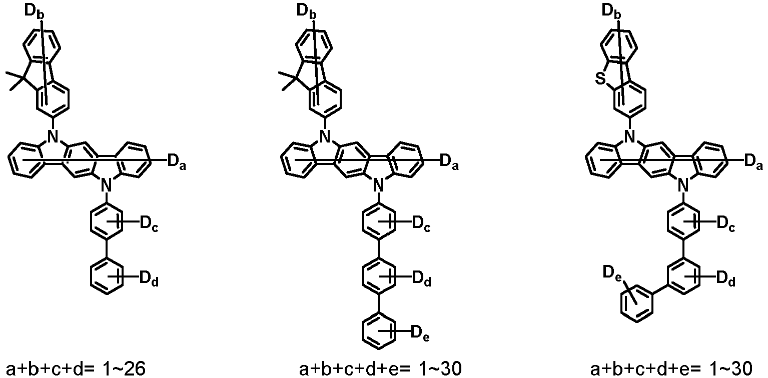 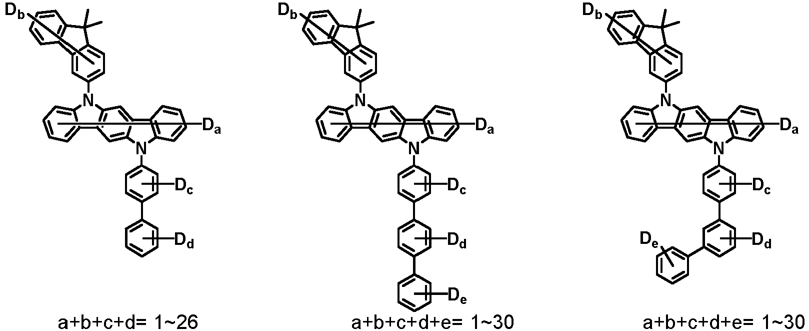 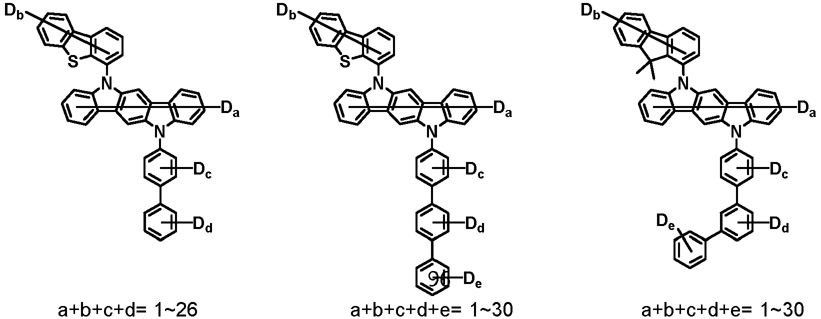 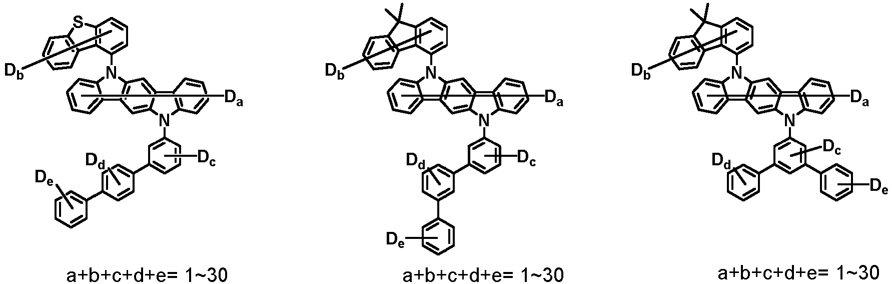 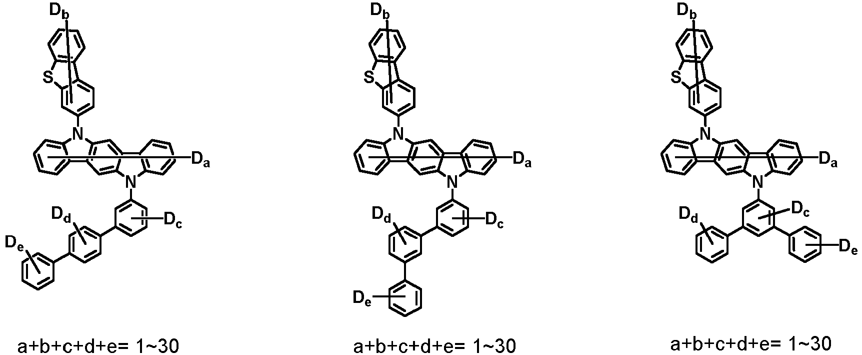 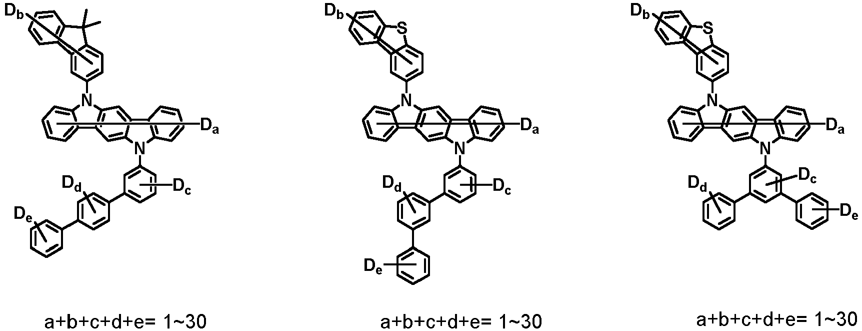 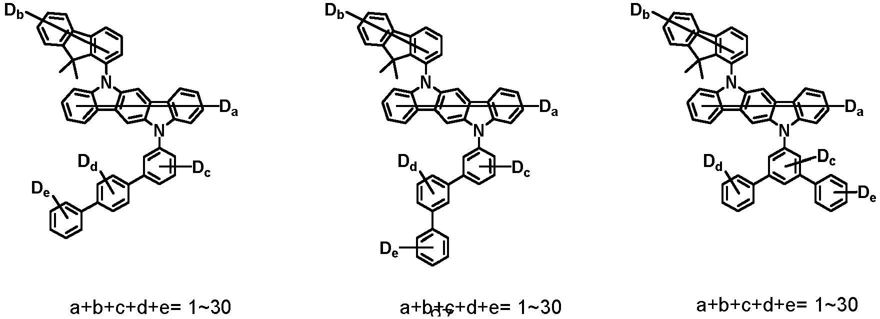 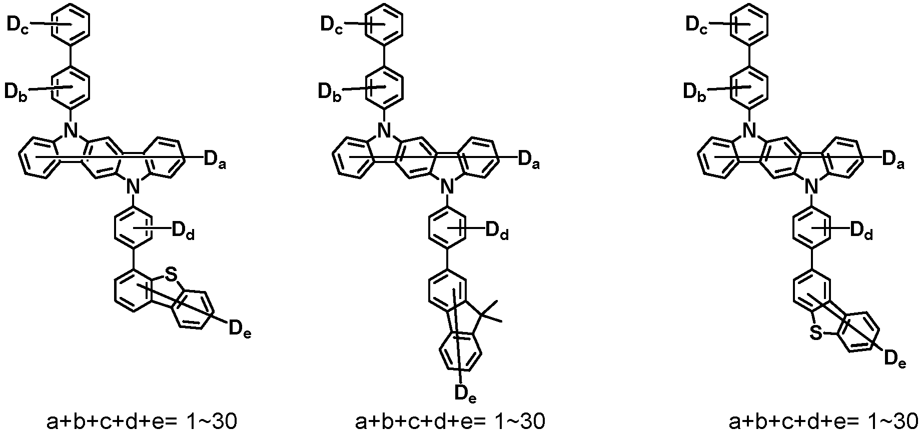 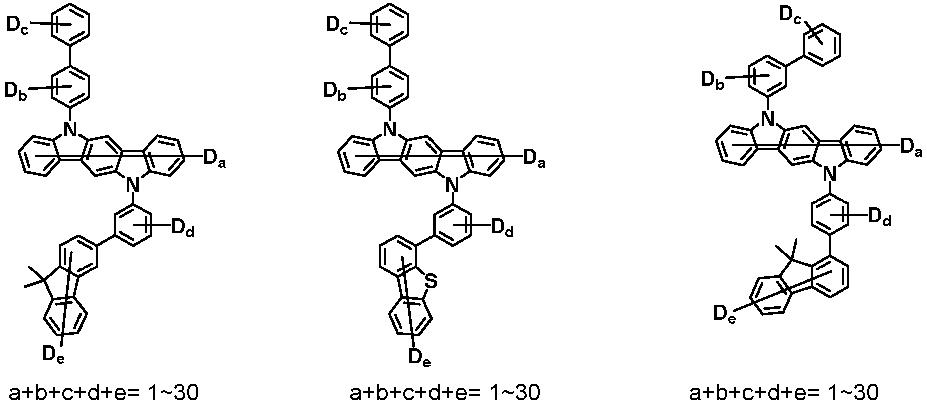 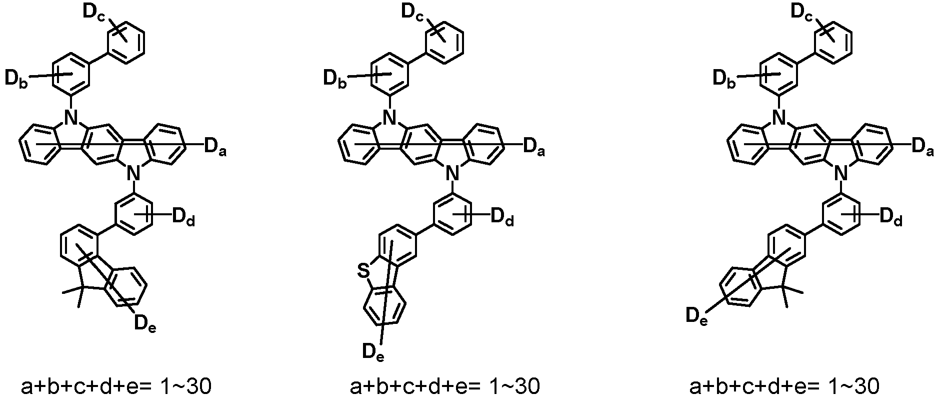 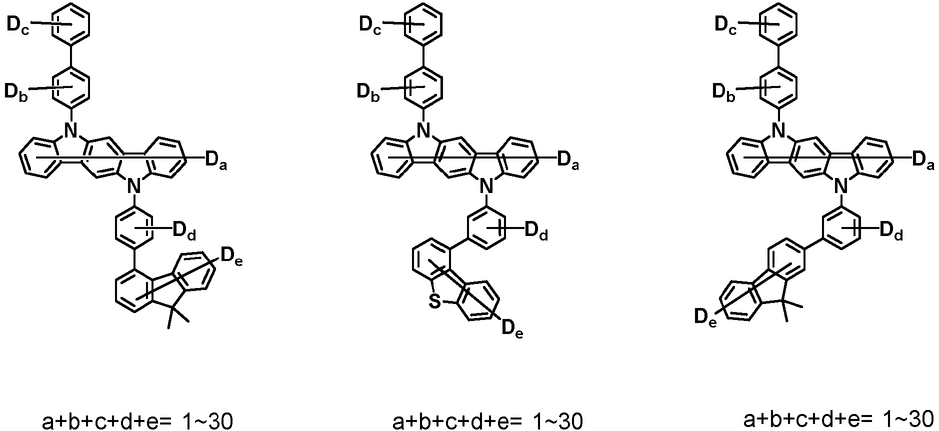 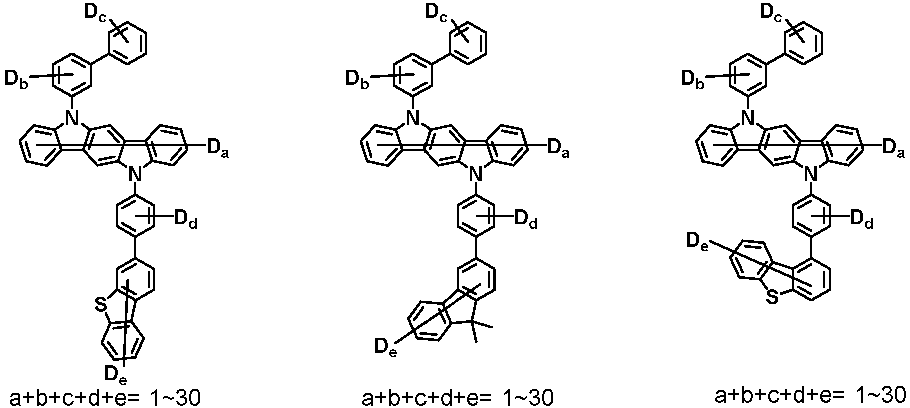 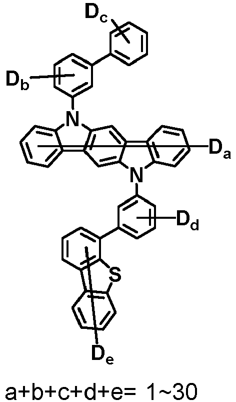 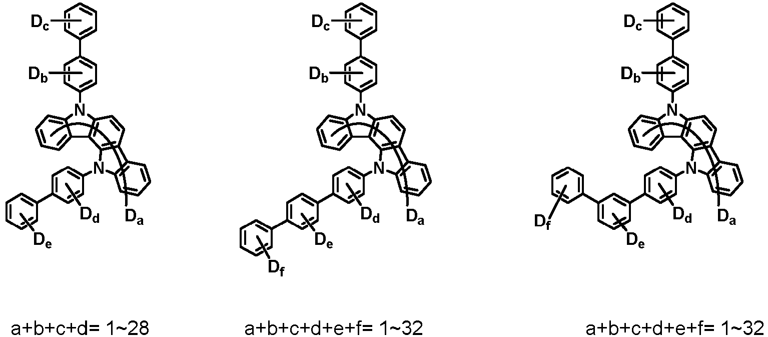 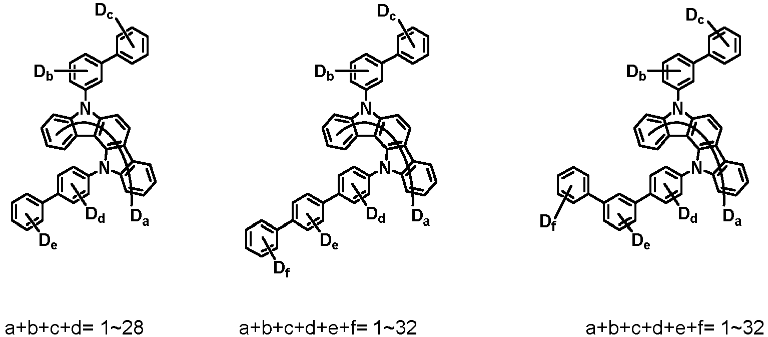 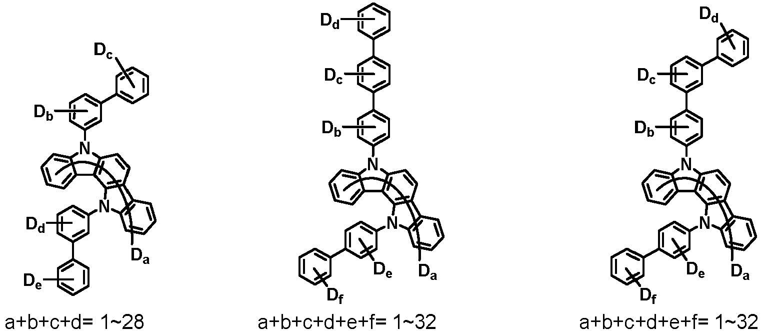 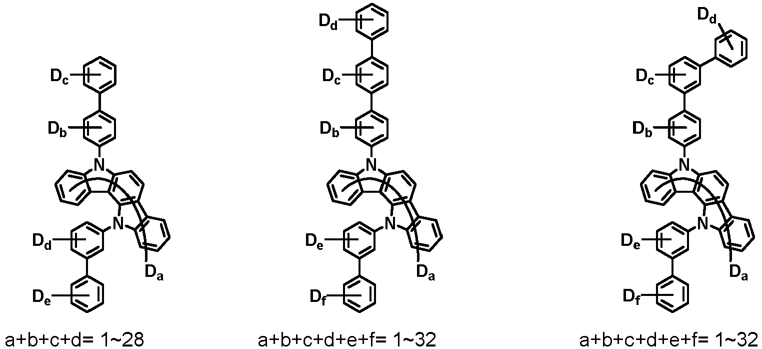 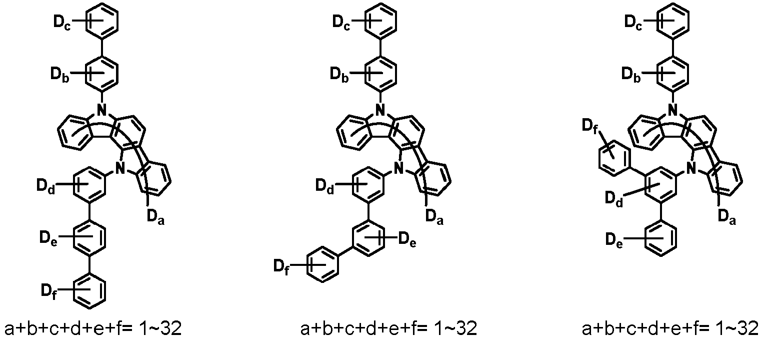 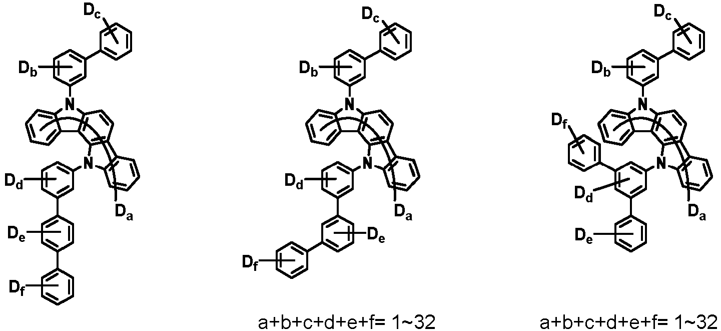 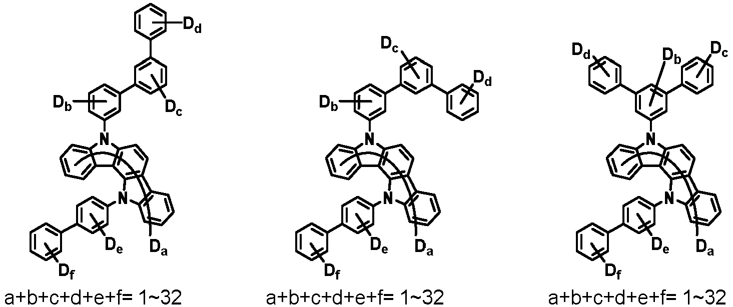 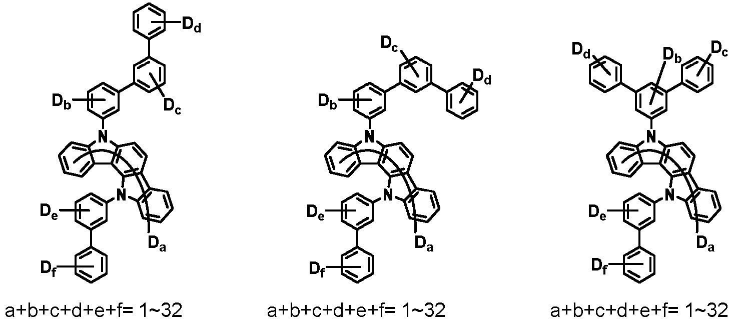 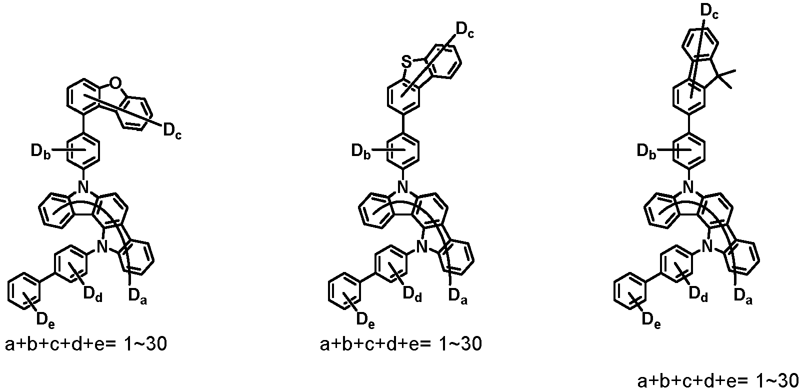 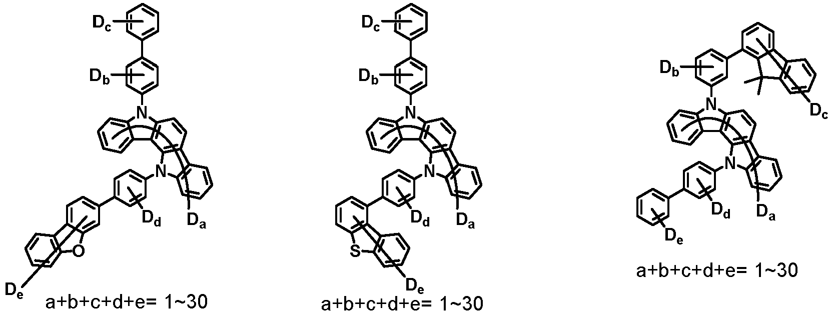 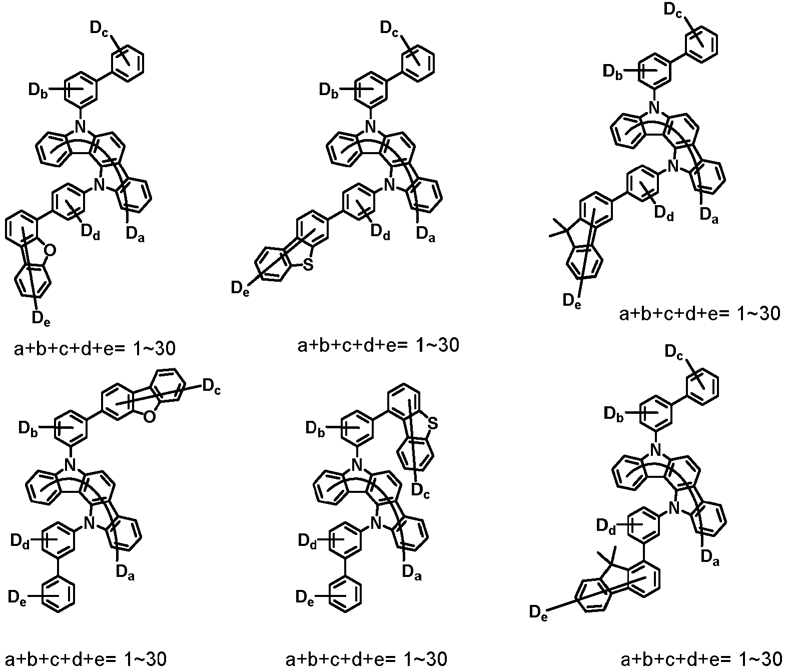 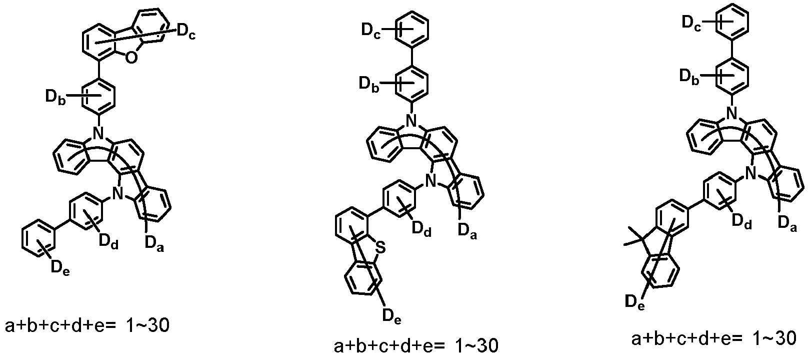 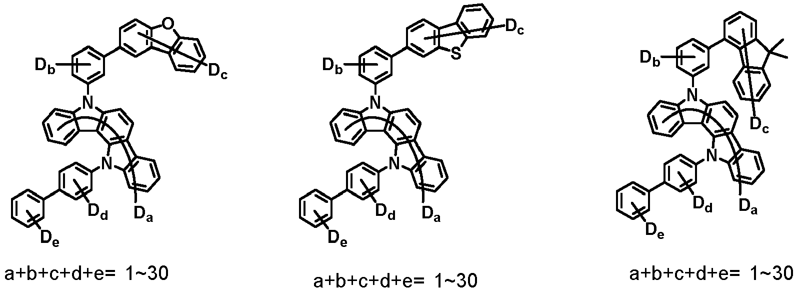 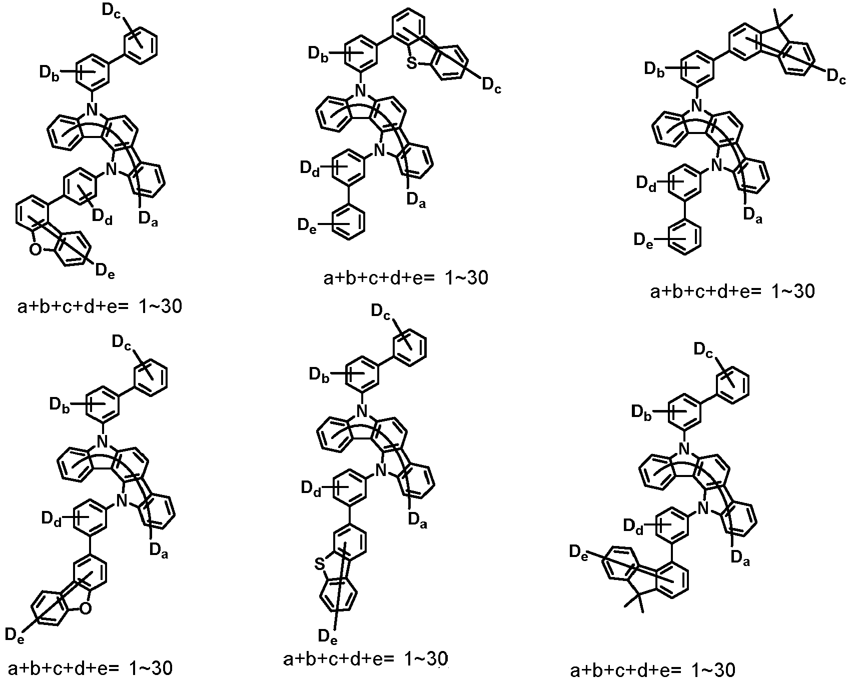 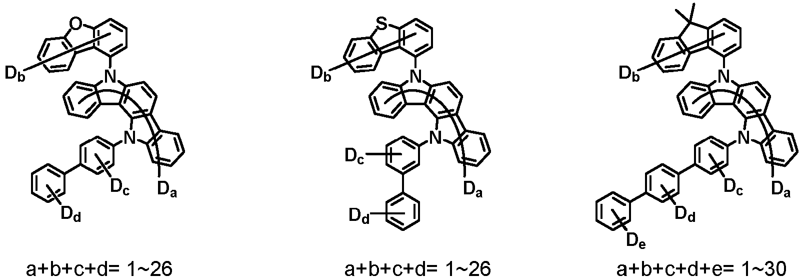 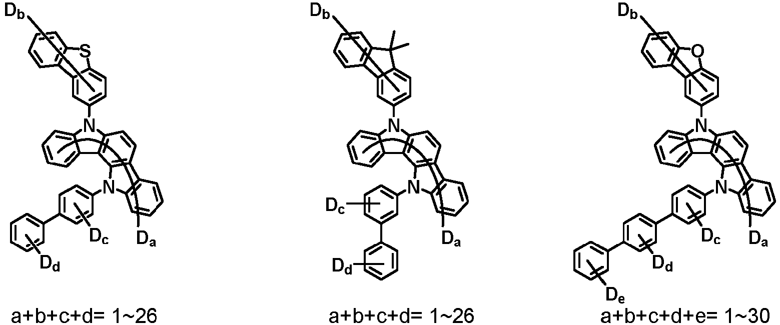 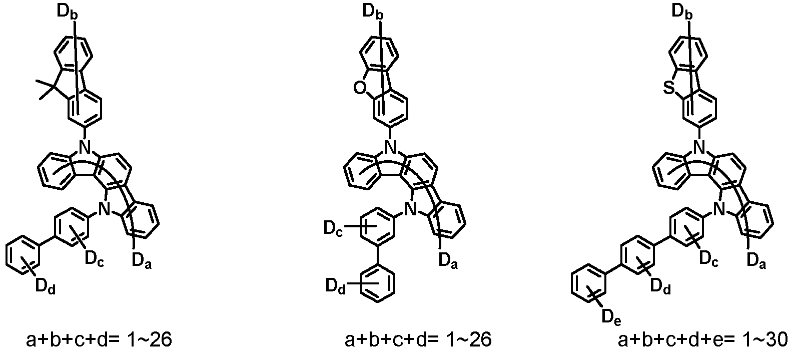 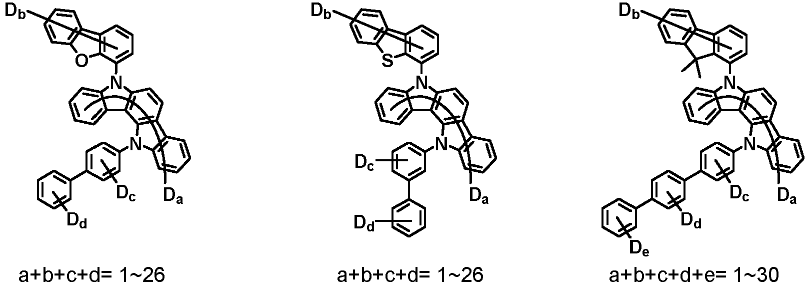 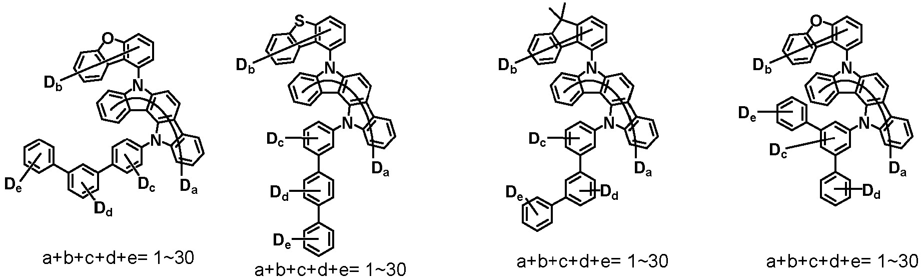 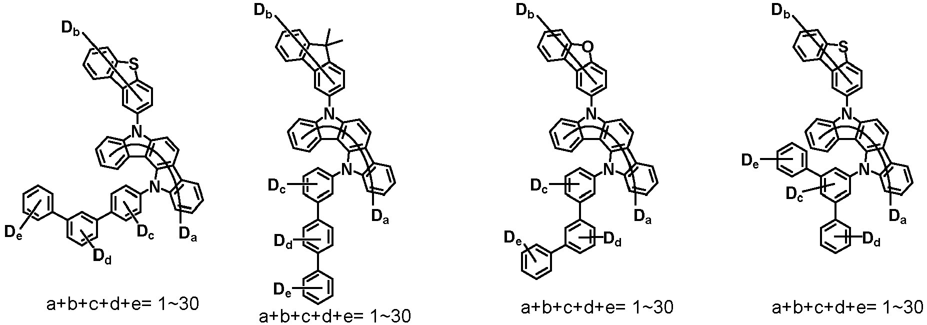 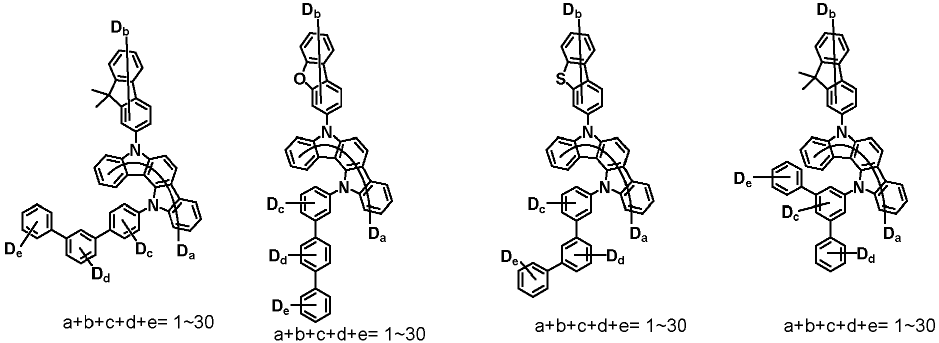 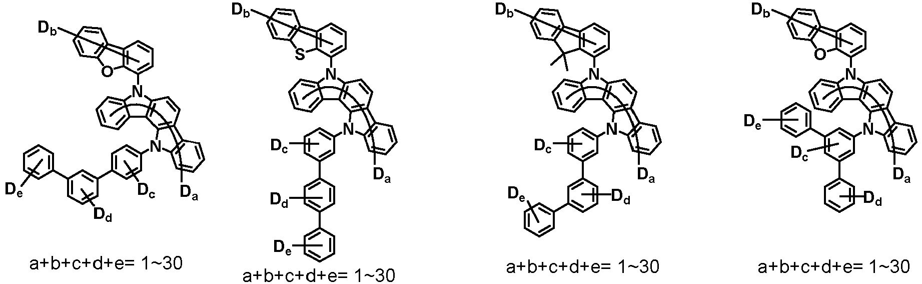 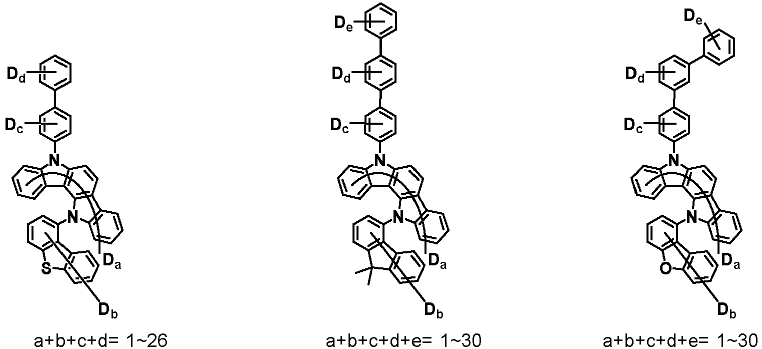 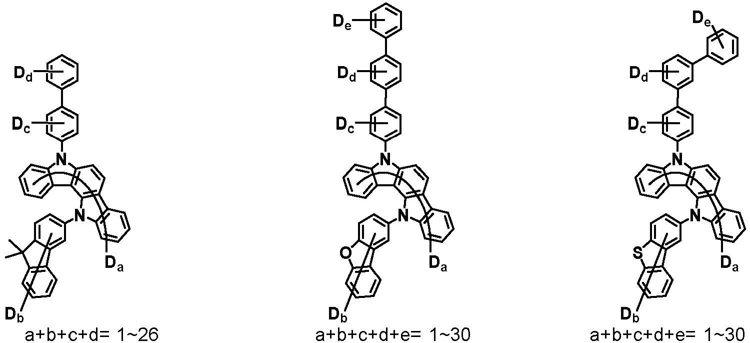 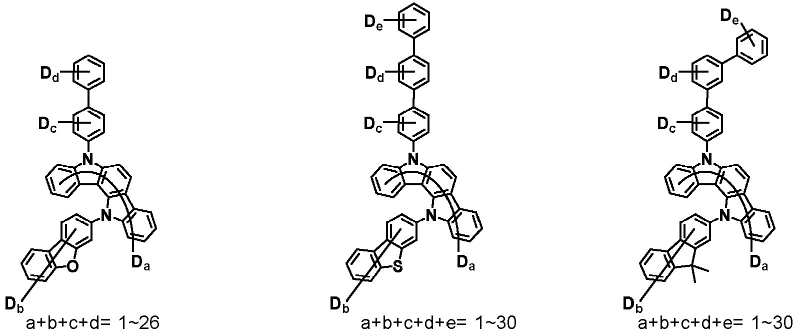 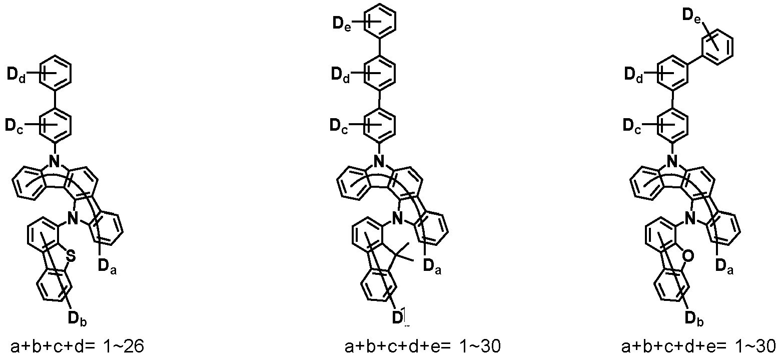 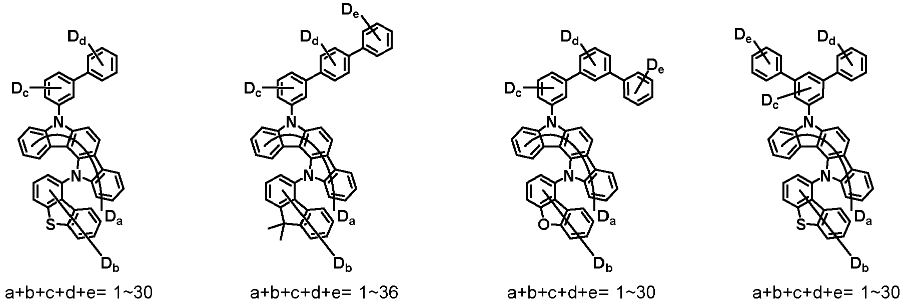 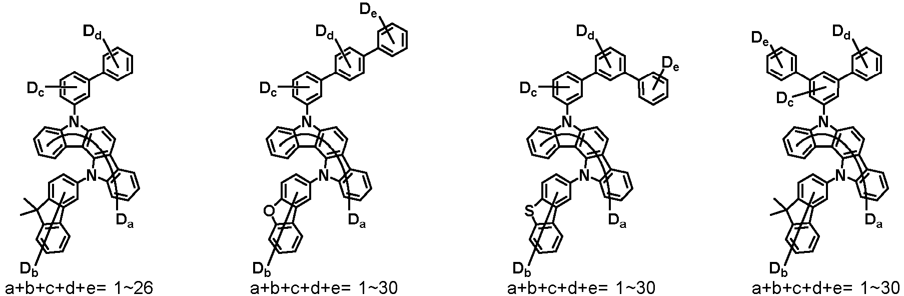 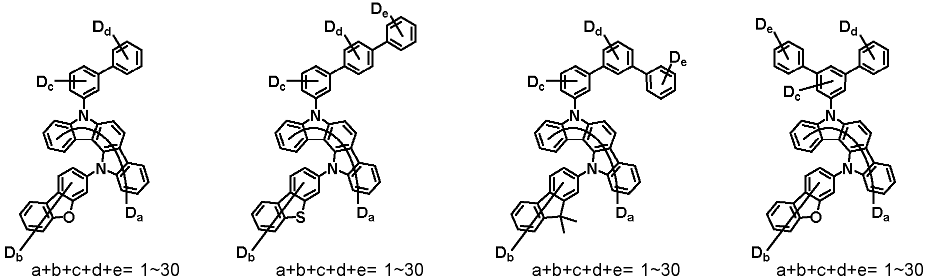 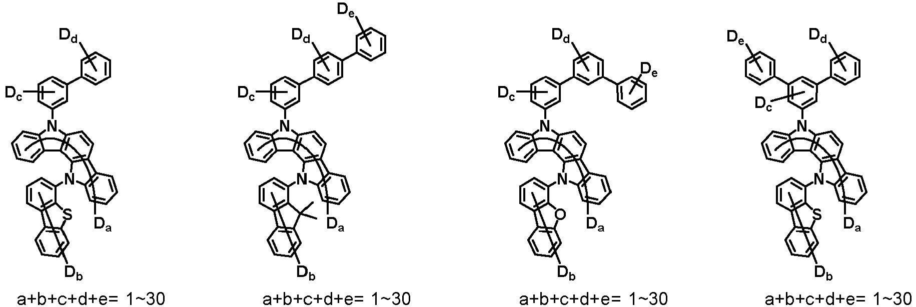 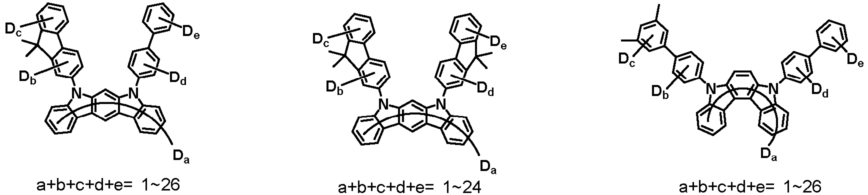 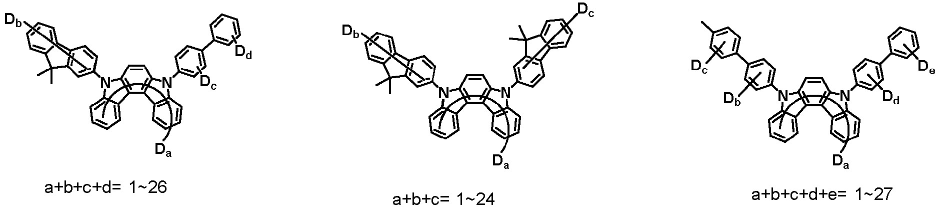 wherein, the methyl groups included in each Chemical Formula are each independently CH₃, CH₂D, CHD₂, or CD₃.

10. The organic light emitting device according to claim 1, wherein:
the light emitting layer comprises an organic alloy of the compound represented by Chemical Formula 1 and the compound represented by Chemical Formula 2.

## Patentansprüche

1. Organische lichtemittierende Vorrichtung, umfassend:
eine Anode; eine Kathode; und eine lichtemittierende Schicht zwischen der Anode und der Kathode,
worin die lichtemittierende Schicht eine durch die folgende chemische Formel 1 dargestellte Verbindung und eine durch die folgende chemische Formel 2 dargestellte Verbindung umfasst 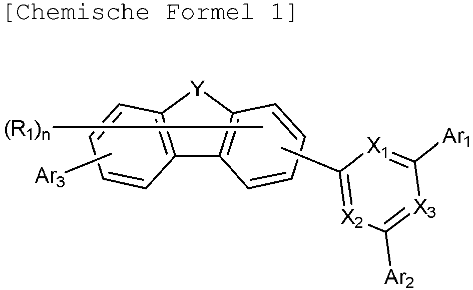
worin in der chemischen Formel 1,
Y O oder S ist,
X₁ bis X₃ jeweils unabhängig CH oder N sind, vorausgesetzt, dass zumindest eines von X₁ bis X₃ N ist,
Ar₁ und Ar₂ jeweils unabhängig ein substituiertes oder unsubstituiertes C₆₋₆₀-Aryl; oder ein substituiertes oder unsubstituiertes C₂₋₆₀-Heteroaryl, enthaltend eines oder mehr, ausgewählt aus der Gruppe, bestehend aus N, O und S, sind,
Ar₃ substituiertes oder unsubstituiertes C₆₋₆₀-Aryl ist,
n eine ganze Zahl von 1 bis 6 ist und
jedes R₁ unabhängig Wasserstoff oder Deuterium ist; 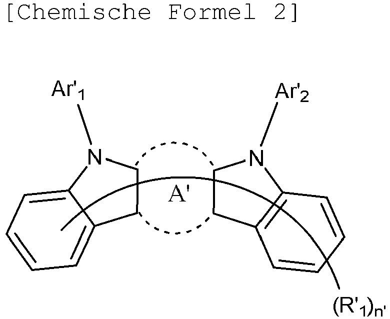
worin in der chemischen Formel 2,
A' ein Benzolring ist, der mit zwei benachbarten pentagonalen Ringen kondensiert ist,
n' eine ganze Zahl von 1 bis 10,
R'₁ Wasserstoff; Deuterium, ein substituiertes oder unsubstituiertes C₆₋₆₀-Aryl; oder ein substituiertes oder unsubstituiertes C₂₋₆₀-Heteroaryl, enthaltend eines oder mehr, ausgewählt aus der Gruppe, bestehend aus N, O und S, ist, und
Ar'₁ und Ar'₂ jeweils unabhängig ein substituiertes oder unsubstituiertes C₆₋₆₀-Aryl; oder ein substituiertes oder unsubstituiertes C₂₋₆₀-Heteroaryl, enthaltend ein oder mehr Heteroatome, ausgewählt aus der Gruppe, bestehend aus N, O und S, sind,
vorausgesetzt, dass zumindest eines von R'₁ Deuterium ist; und/oder zumindest eines von Ar'₁ und Ar'₂ mit zumindest einem Deuterium substituiert ist.

2. Organische lichtemittierende Vorrichtung gemäß Anspruch 1, worin:
zumindest zwei von X₁ bis X₃ N sind.

3. Organische lichtemittierende Vorrichtung gemäß Anspruch 1, worin:
Ar₁ und Ar₂ jeweils unabhängig Phenyl; mit 5 Deuterium substituiertes Phenyl; Biphenylyl; mit 5 Deuterium substituiertes Biphenylyl; Terphenylyl; Phenanthrenyl; Carbazolyl; mit 6 Deuterium substituiertes Carbazolyl; Dibenzofuranyl; Dibenzothiophenyl oder Triphenylenyl sind.

4. Organische lichtemittierende Vorrichtung gemäß Anspruch 1, worin:
Ar₃ Phenyl; mit 5 Deuterium substituiertes Phenyl; Biphenylyl; mit 5 Deuterium substituiertes Biphenylyl; Terphenylyl; mit 5 Deuterium substituiertes Terphenylyl; mit einem Phenyl substituiertes Terphenylyl; Naphthyl; Naphthylphenyl; Phenanthrenyl; Triphenylenyl; mit 9 Deuterium substituiertes Triphenylenyl; Triphenylenylphenyl; 9,9-Dimethylfluorenyl oder 9,9'-Spirobifluorenyl ist.

5. Organische lichtemittierende Vorrichtung gemäß Anspruch 1, worin:
die durch die chemische Formel 1 dargestellte Verbindung irgendeine ist, die ausgewählt ist aus der Gruppe, bestehend aus:

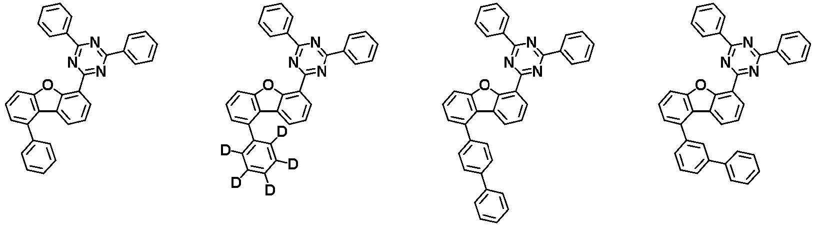

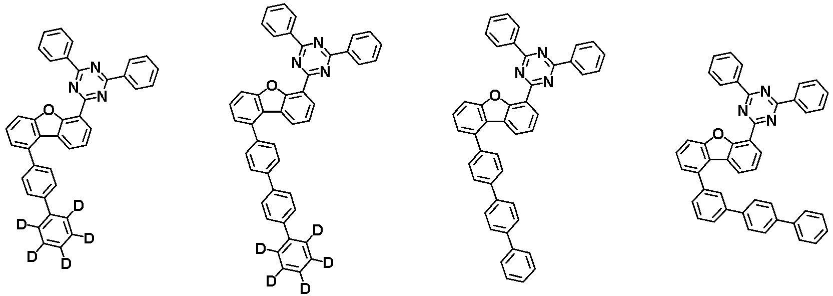

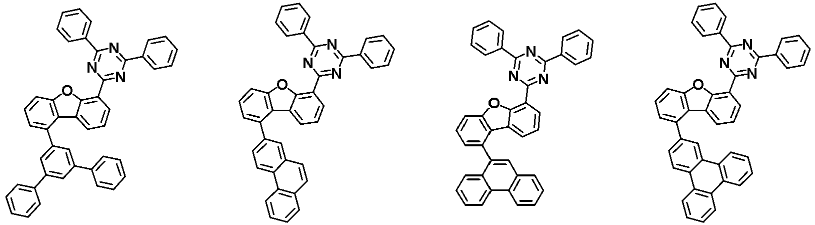

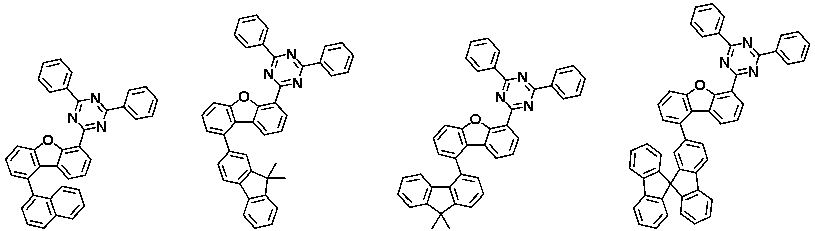

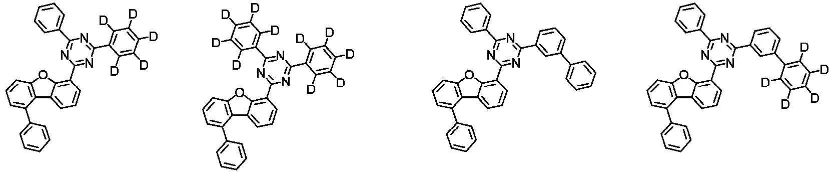

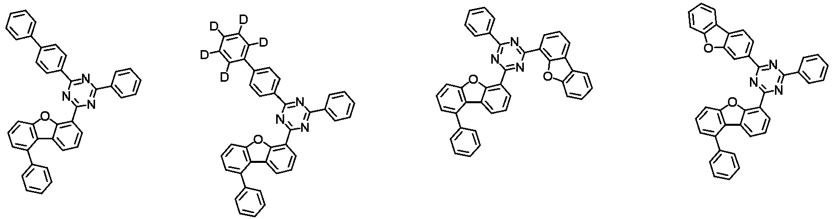

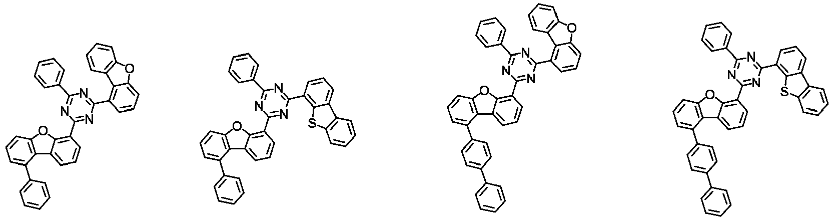

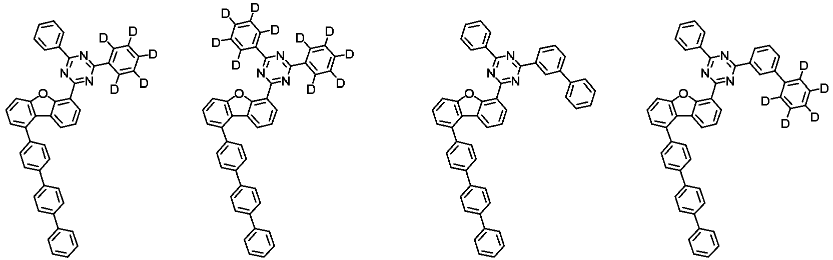

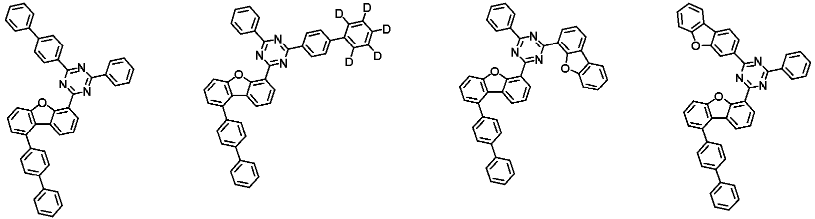

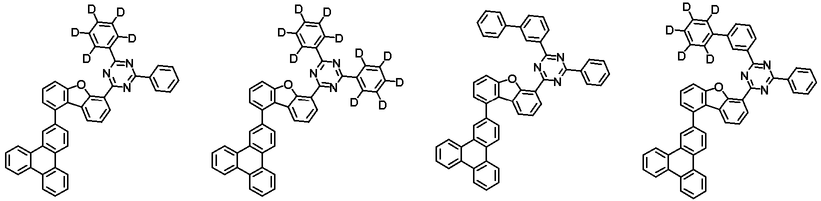

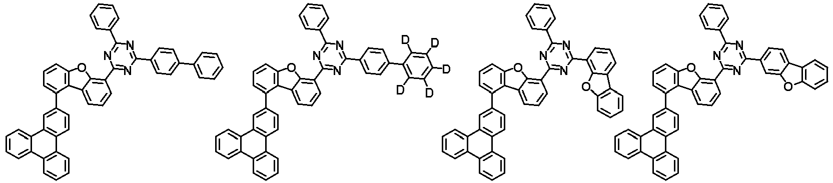

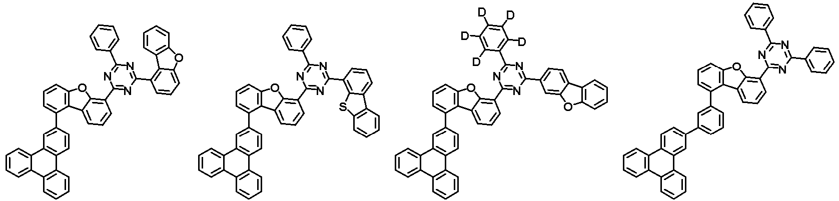

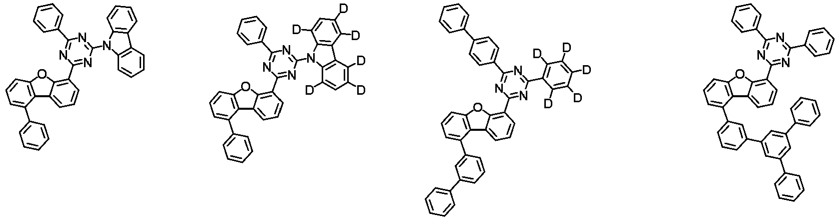

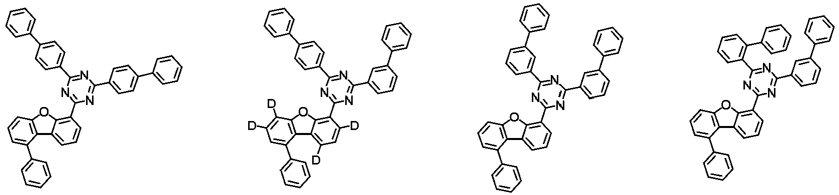

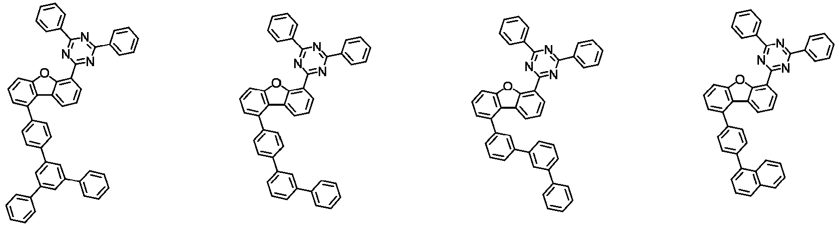

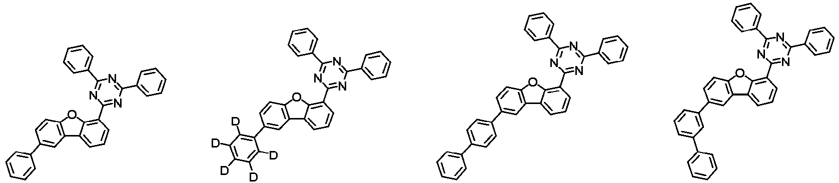

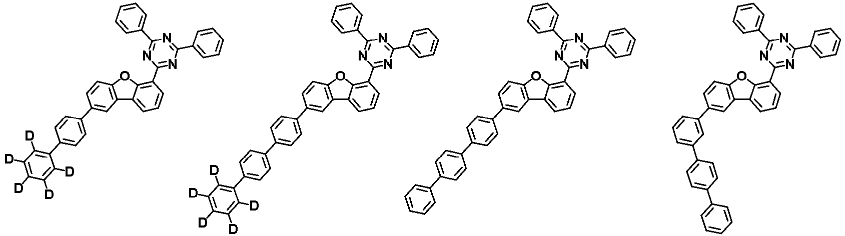

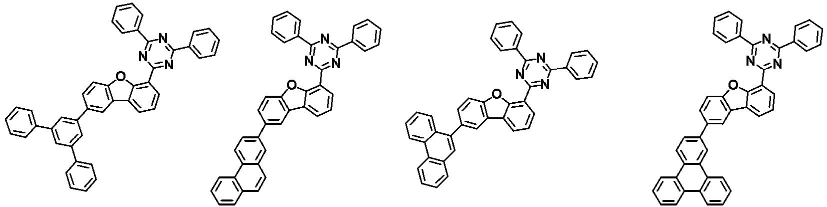

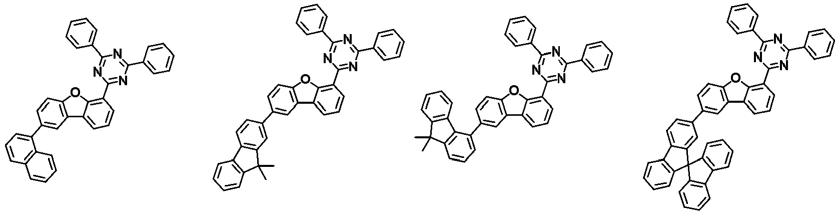

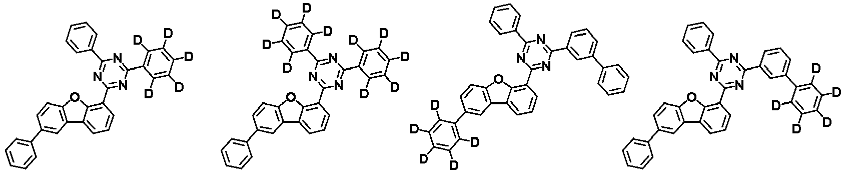

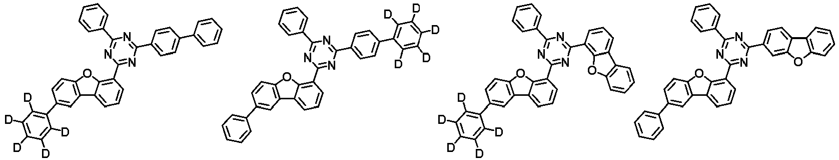

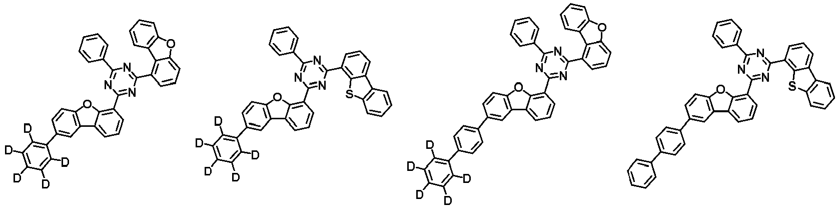

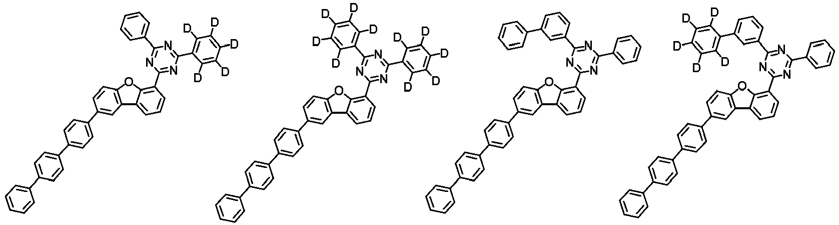

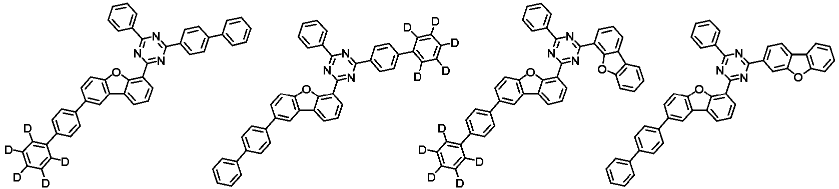

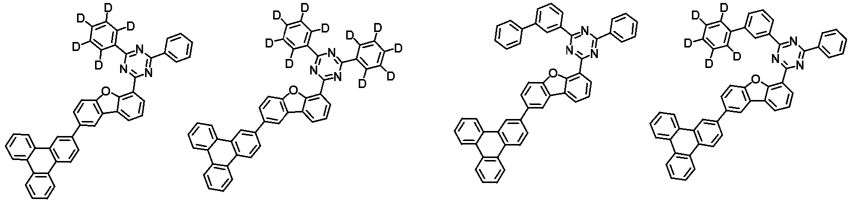

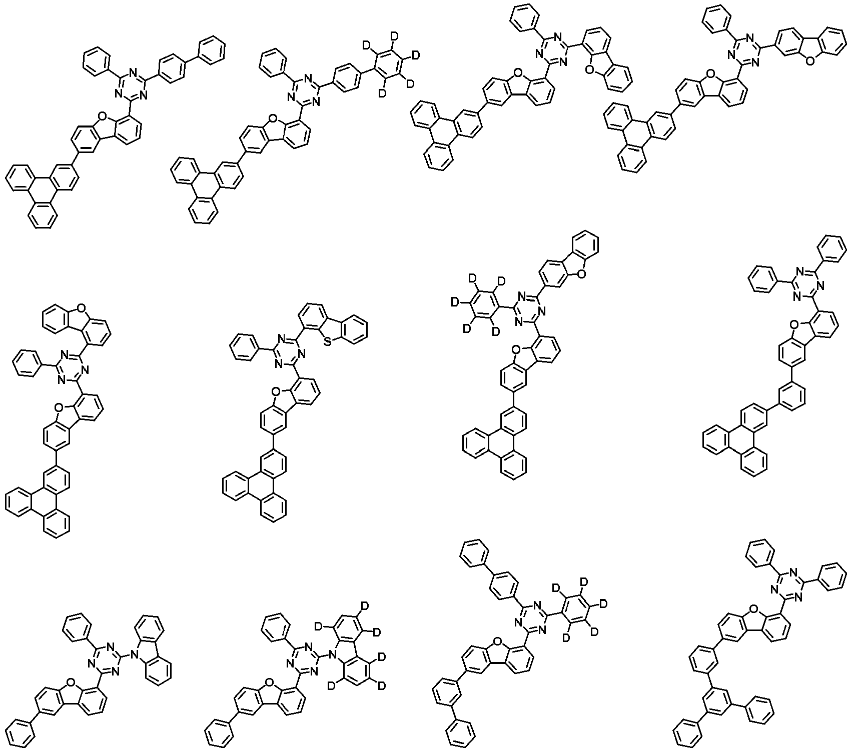

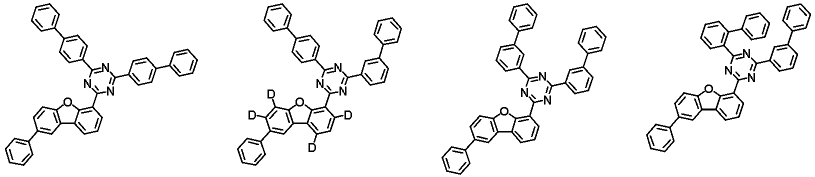

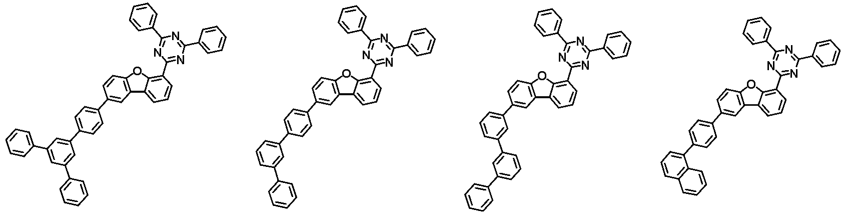

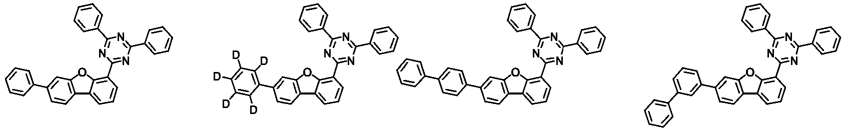

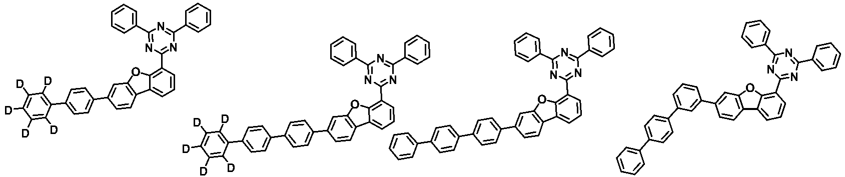

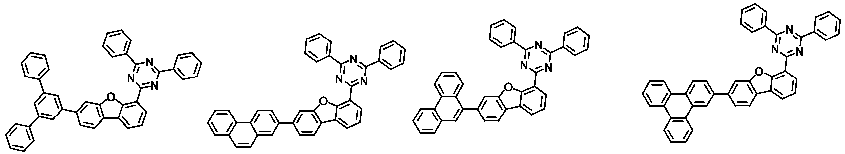

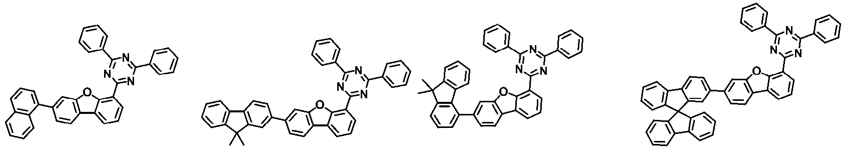

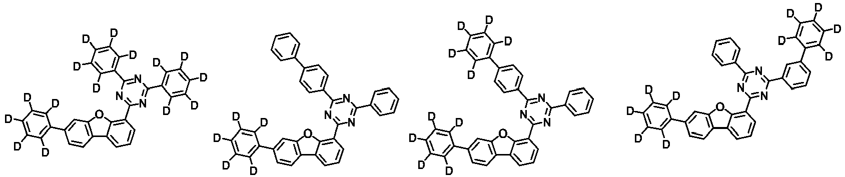

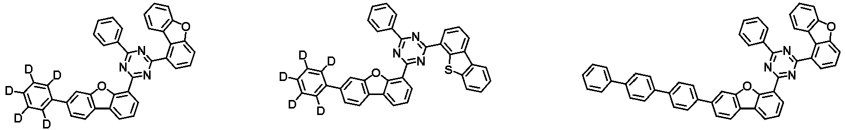

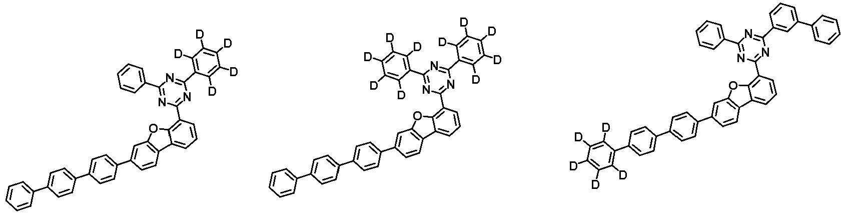

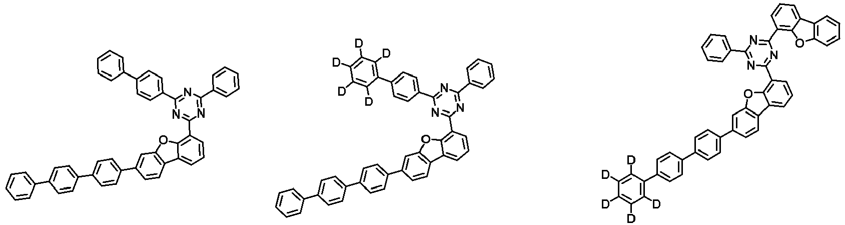

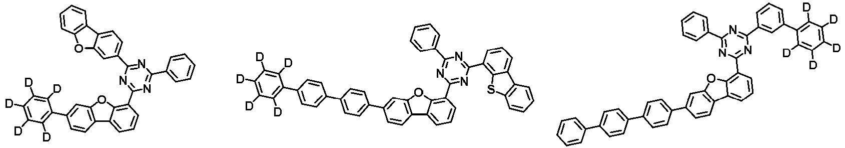

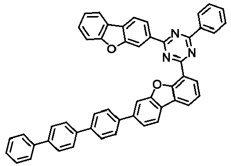

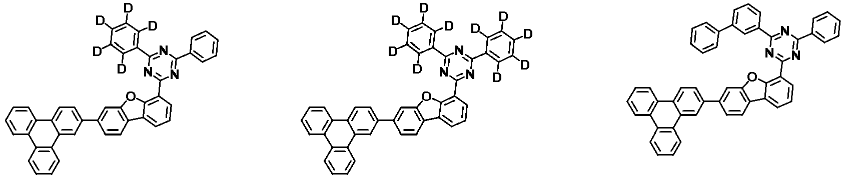

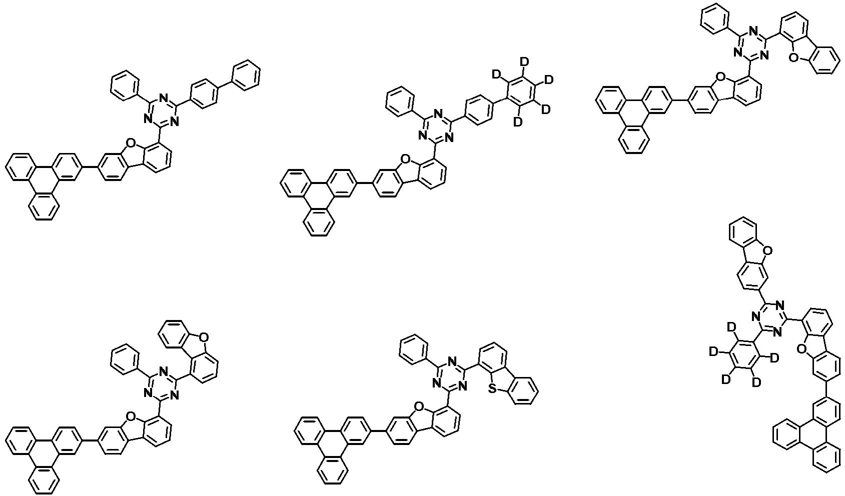

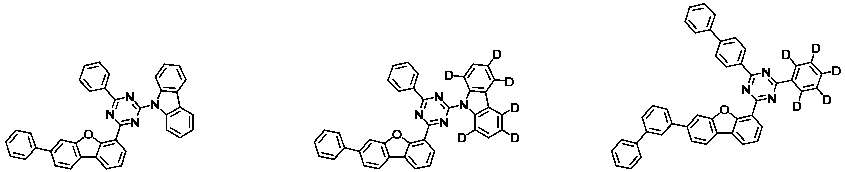

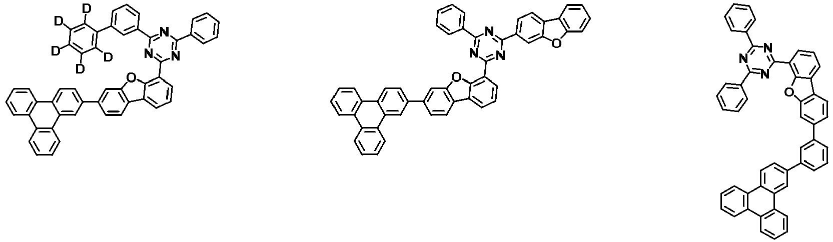

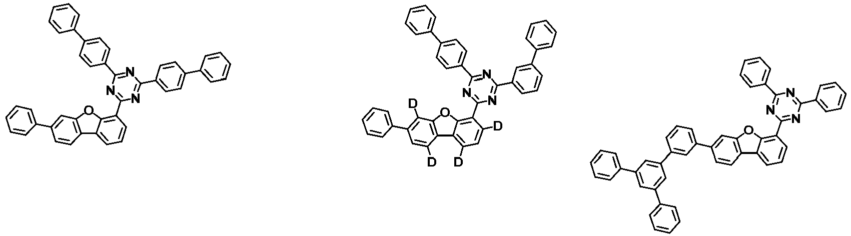

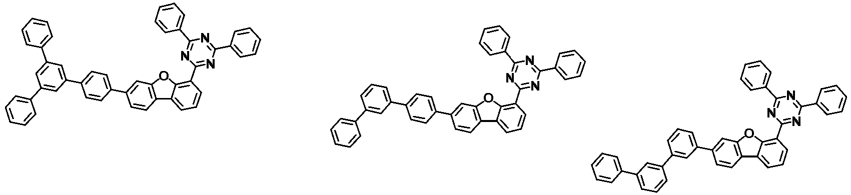

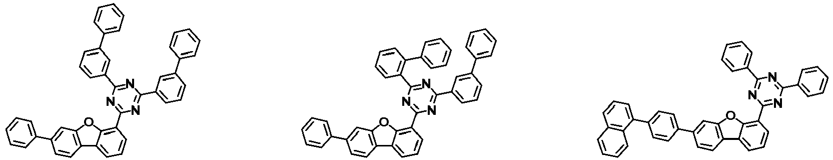

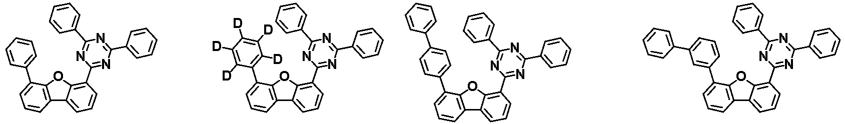

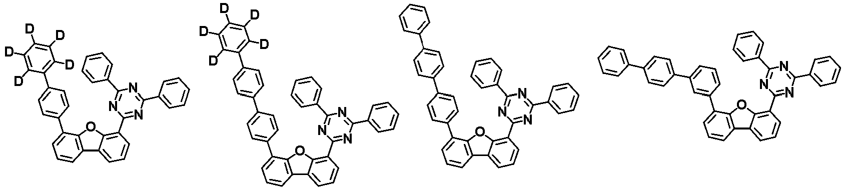

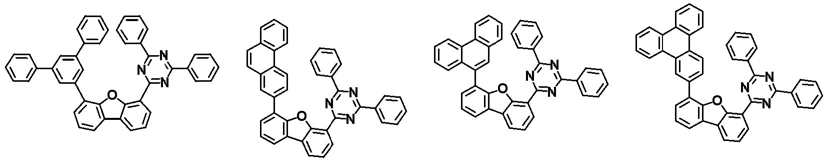

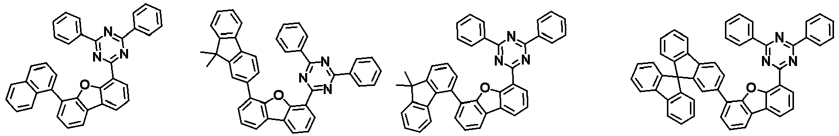

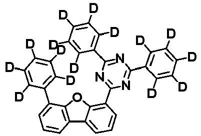

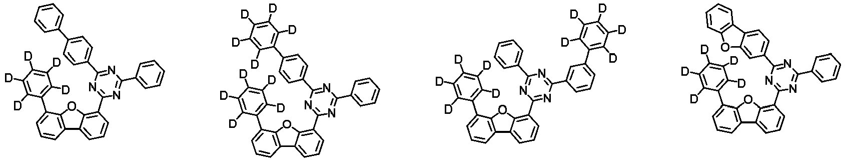

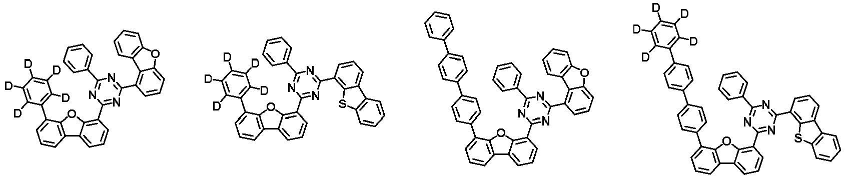

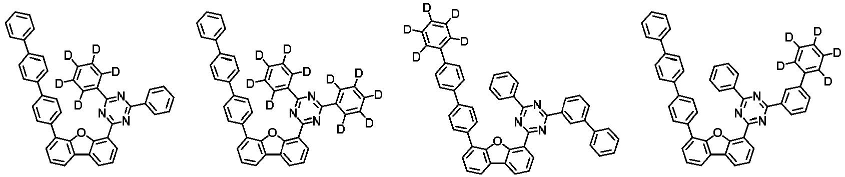

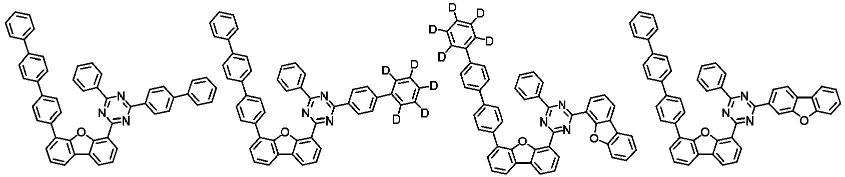

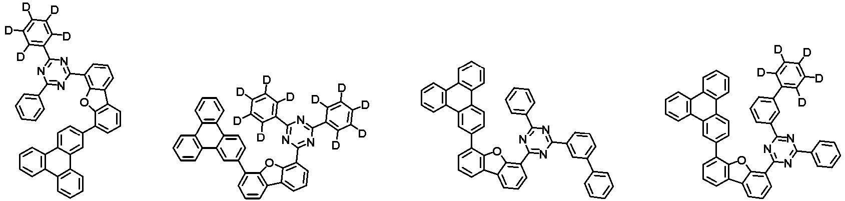

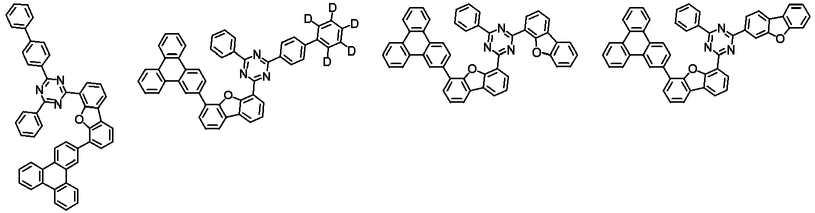

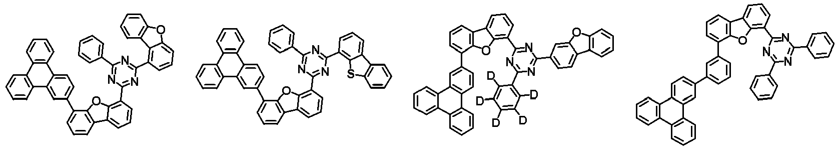

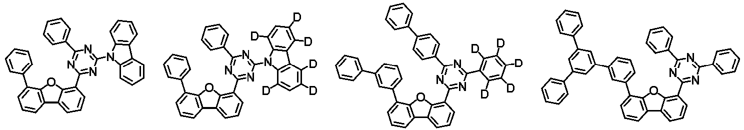

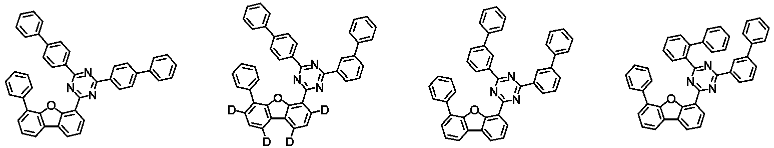

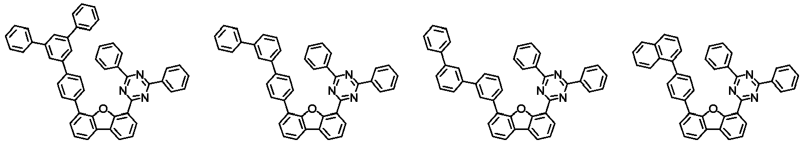

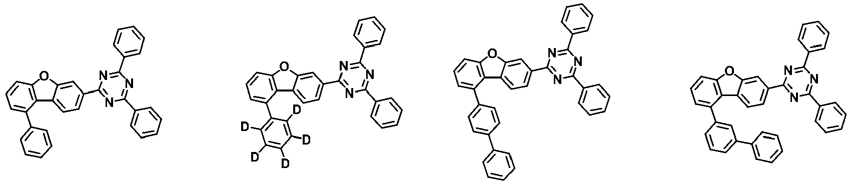

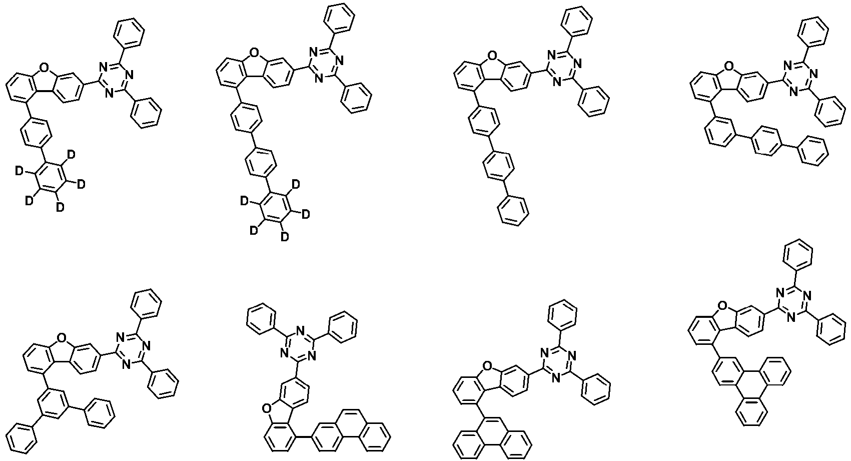

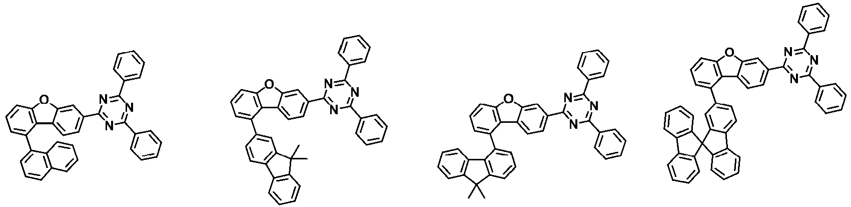

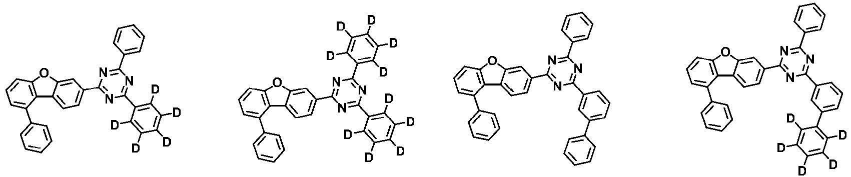

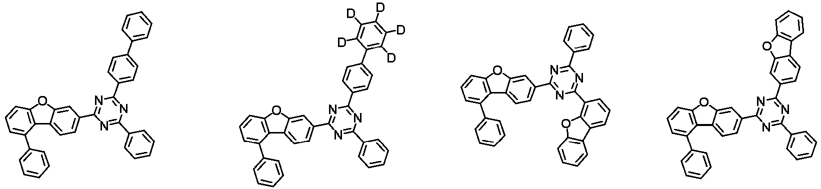

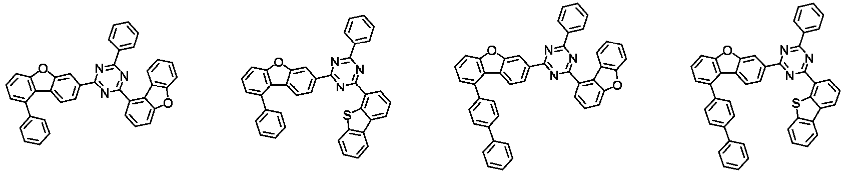

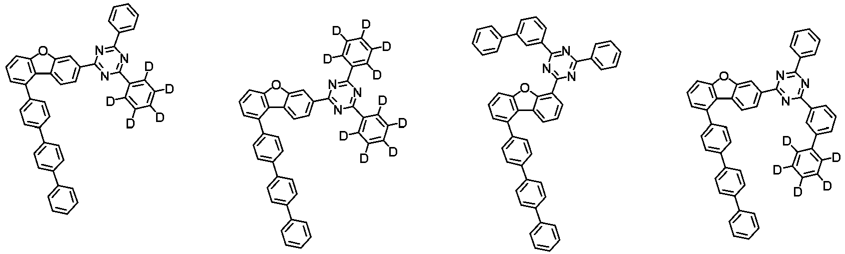

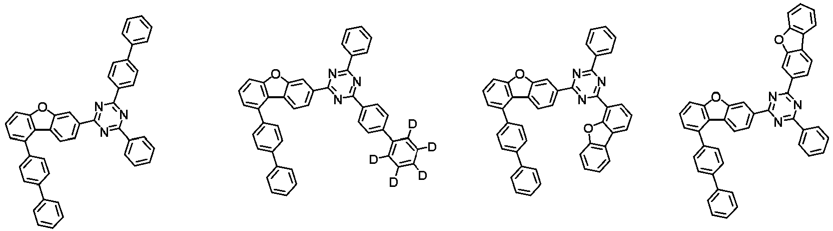

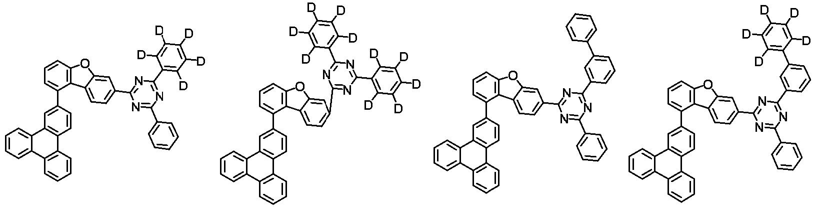

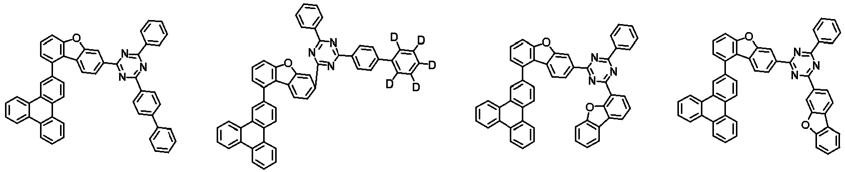

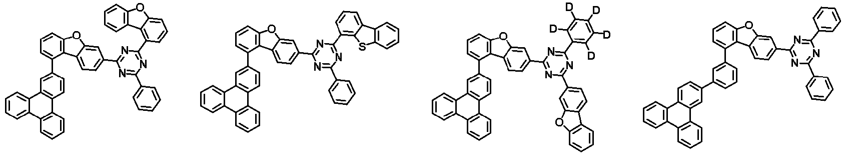

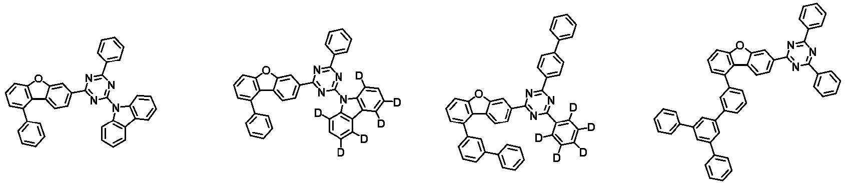

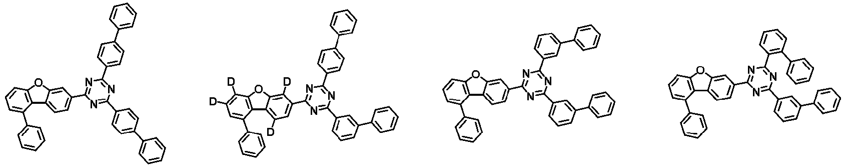

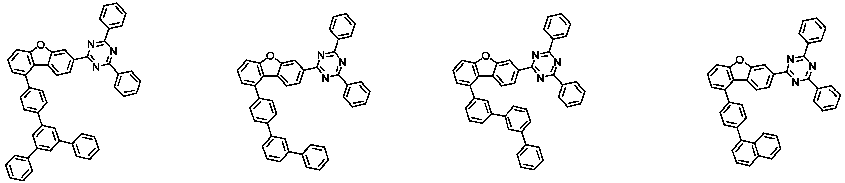

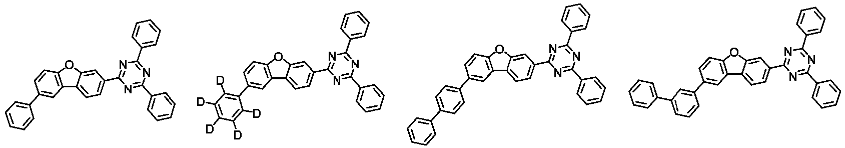

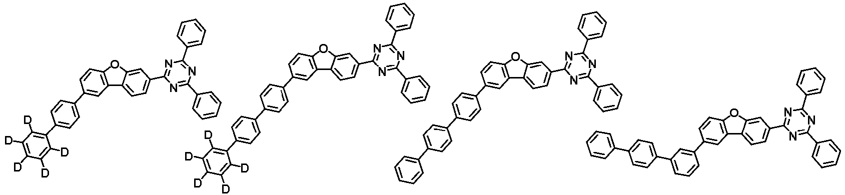

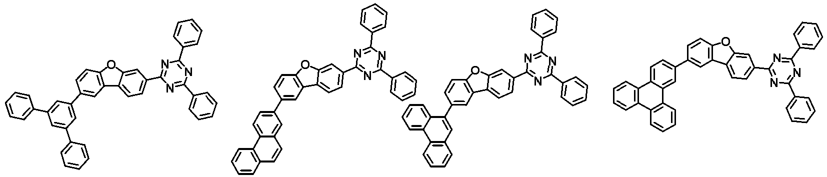

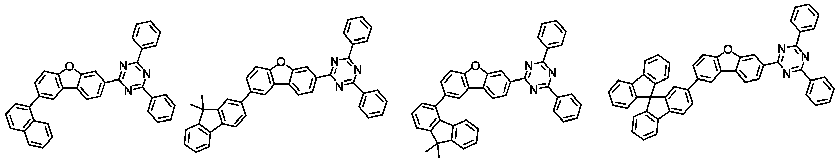

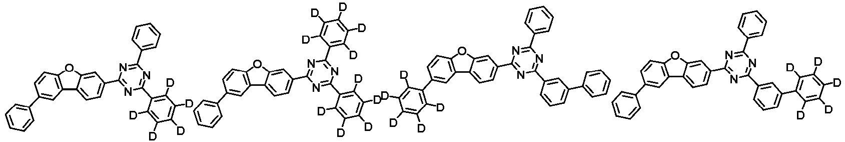

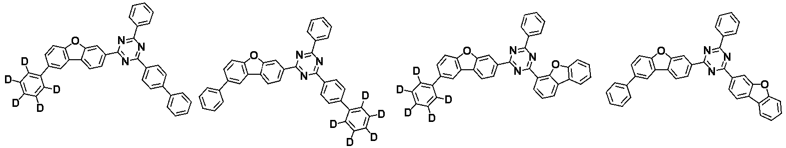

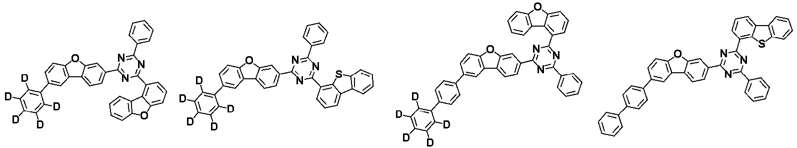

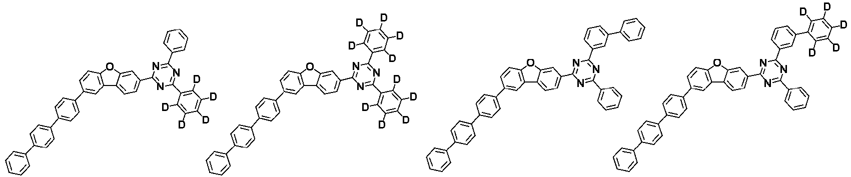

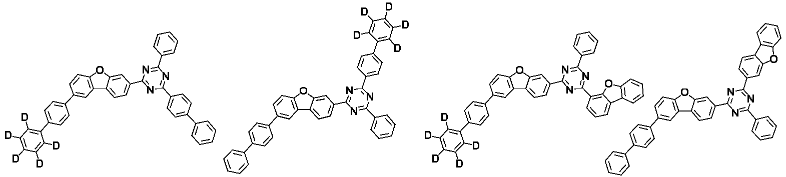

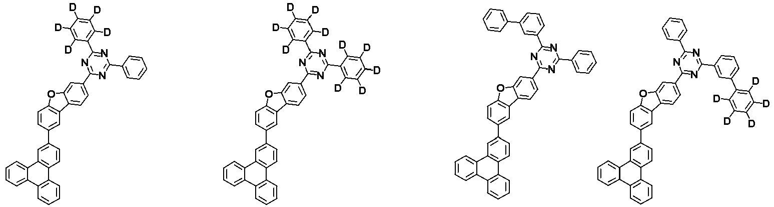

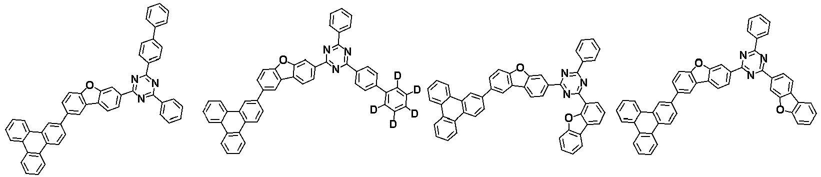

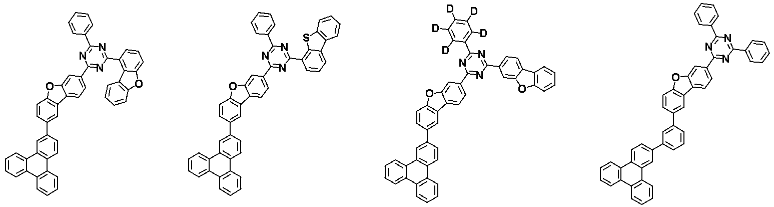

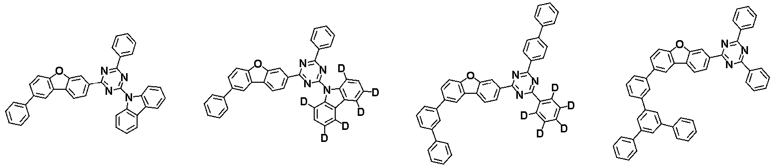

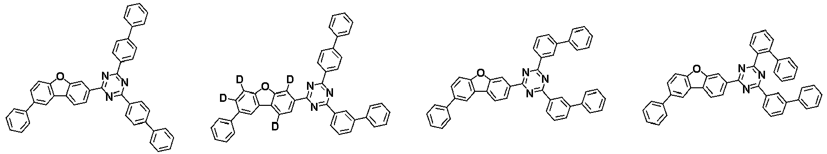

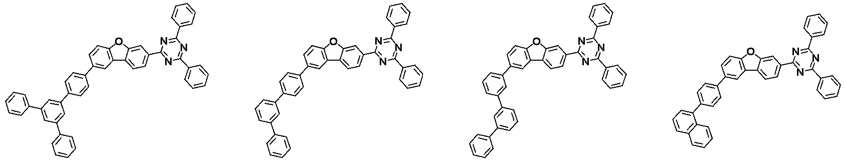

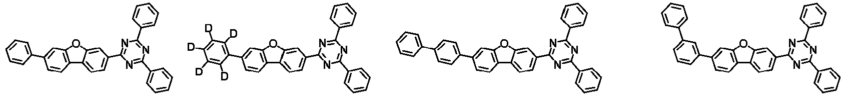

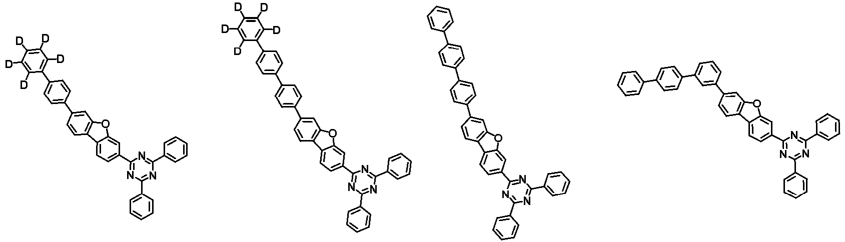

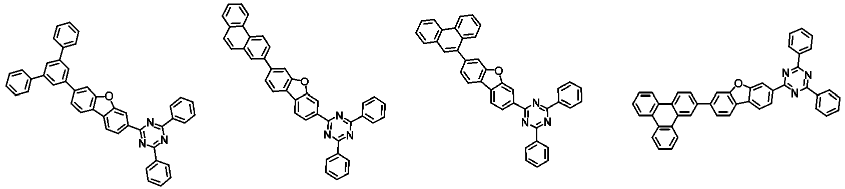

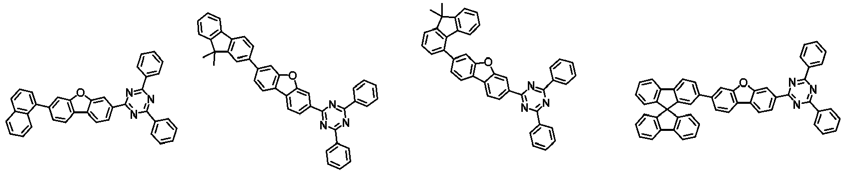

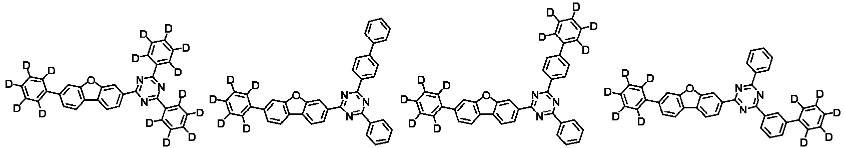

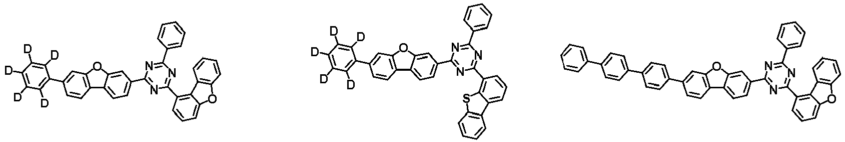

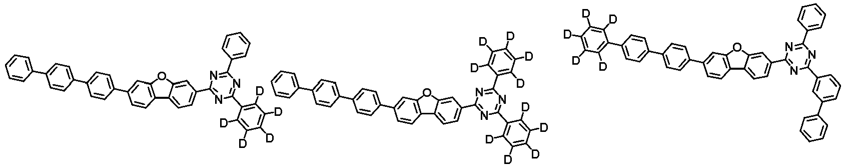

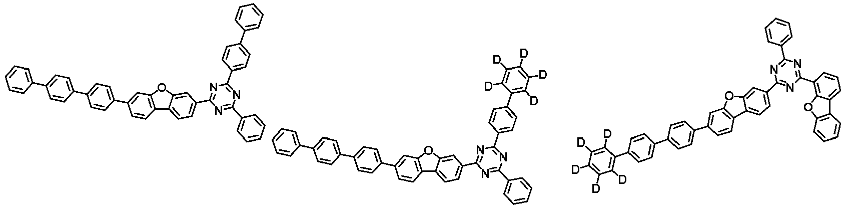

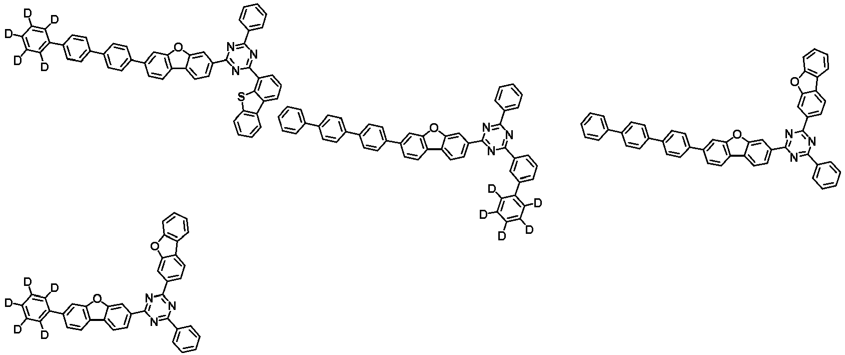

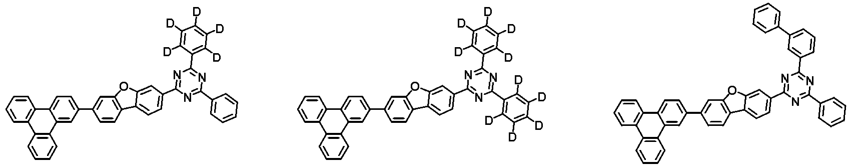

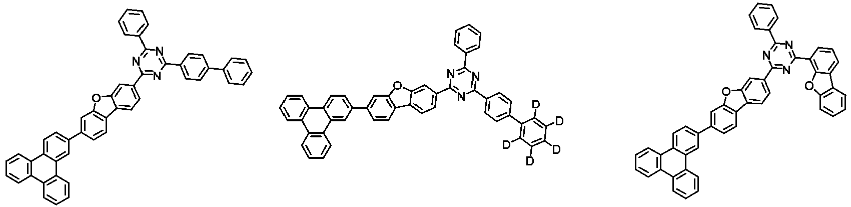

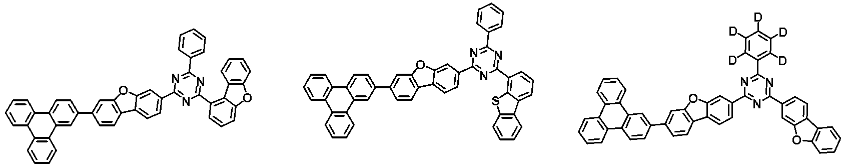

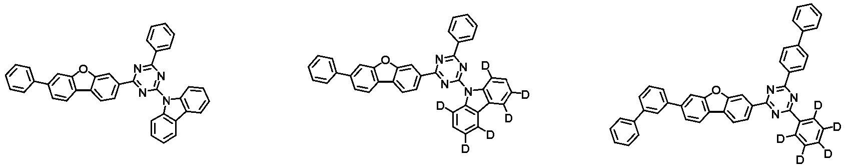

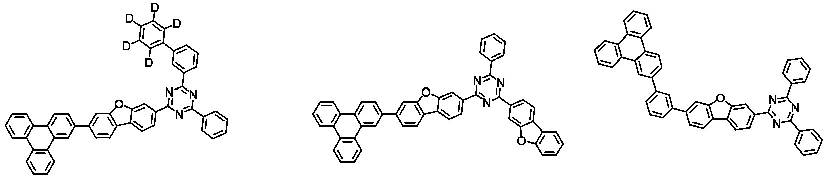

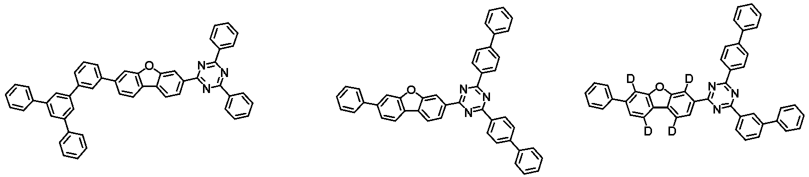

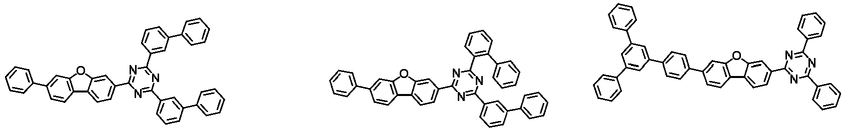

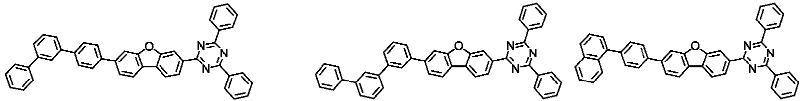

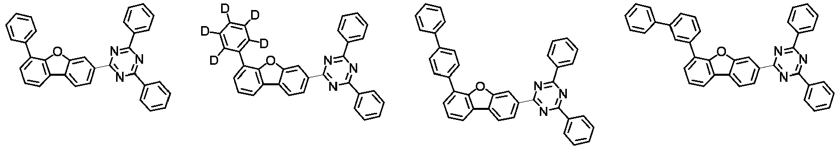

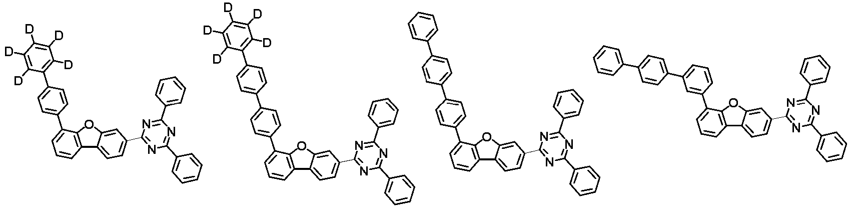

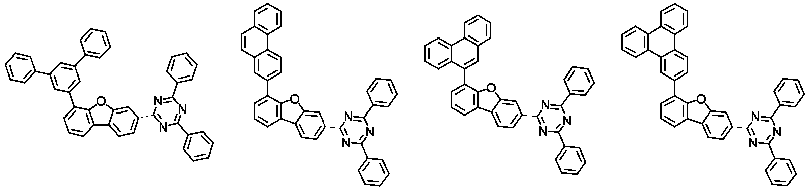

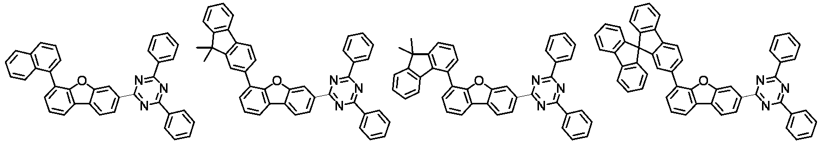

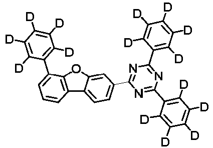

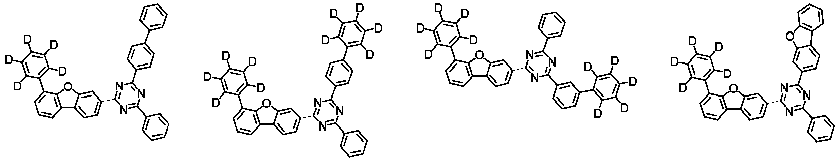

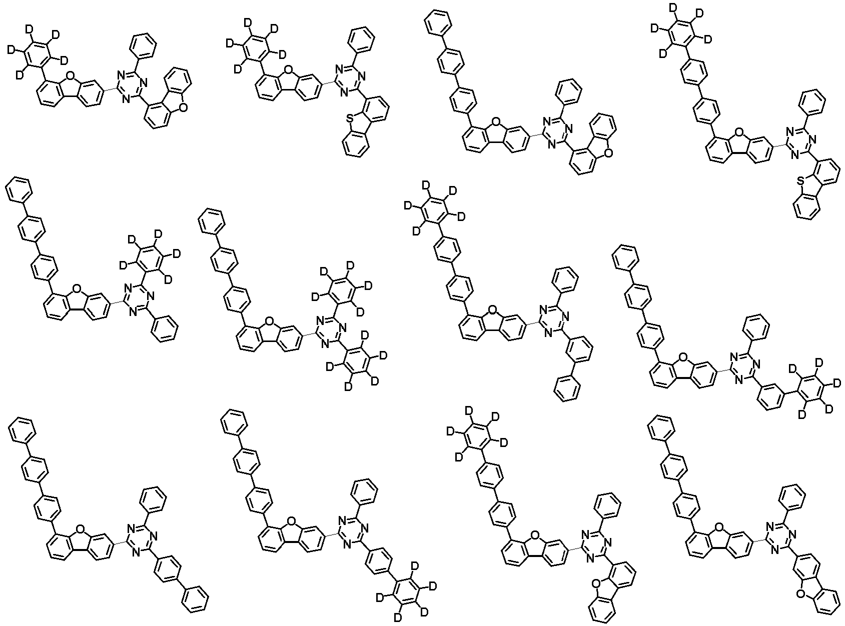

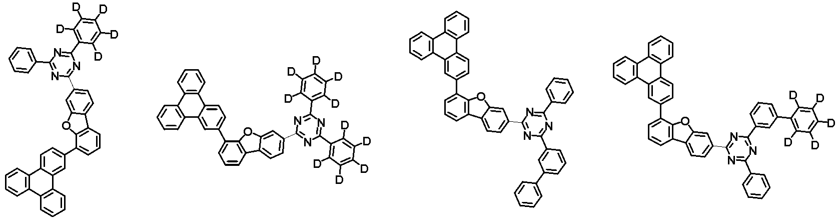

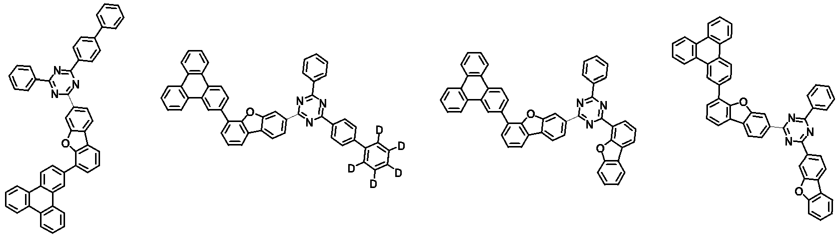

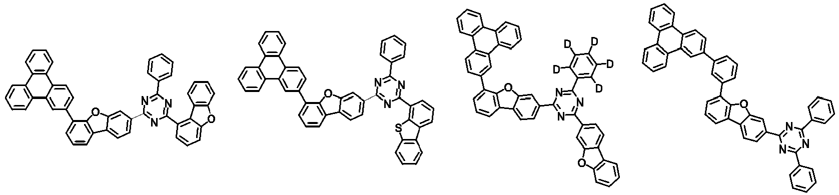

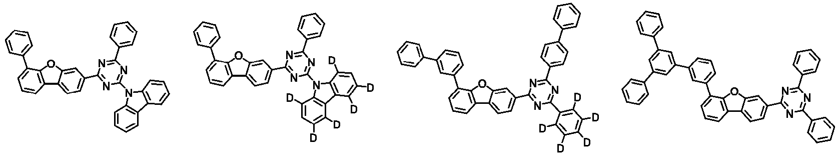

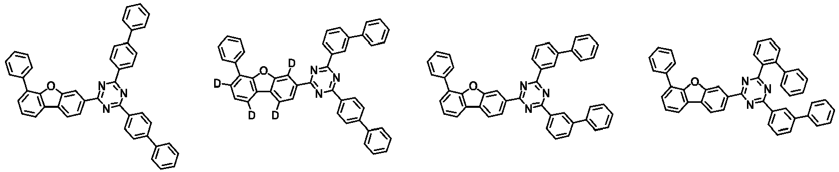

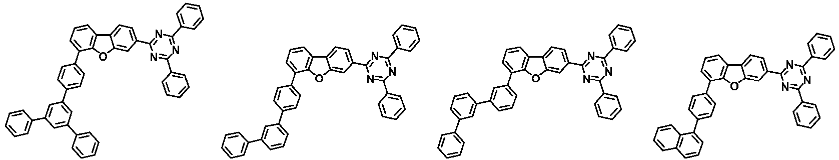

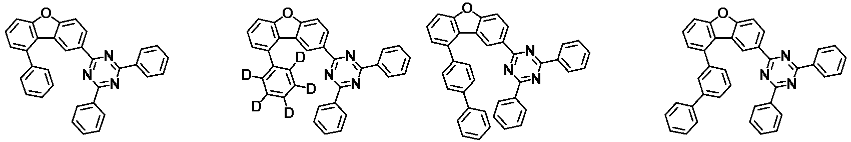

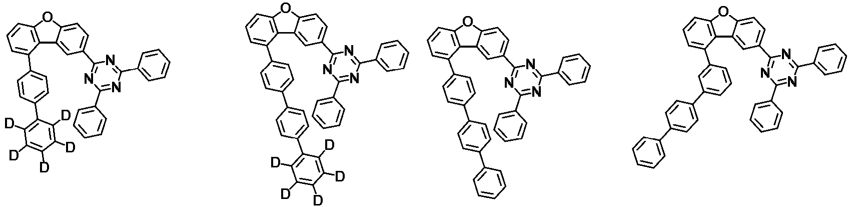

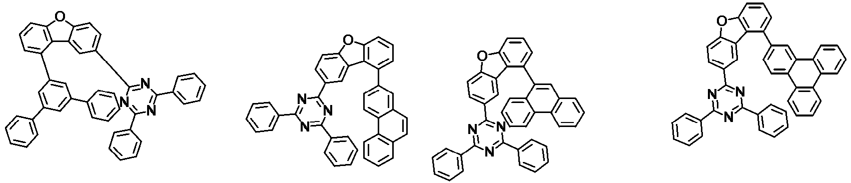

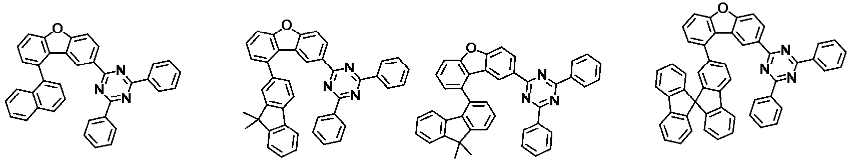

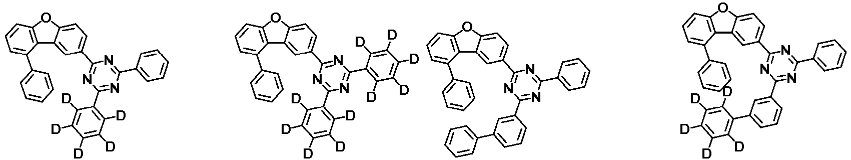

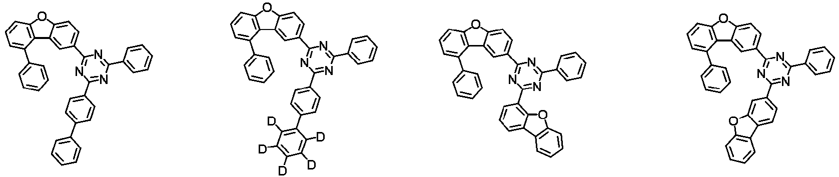

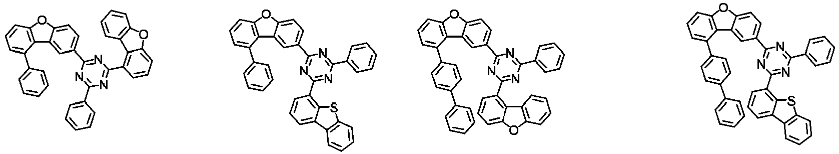

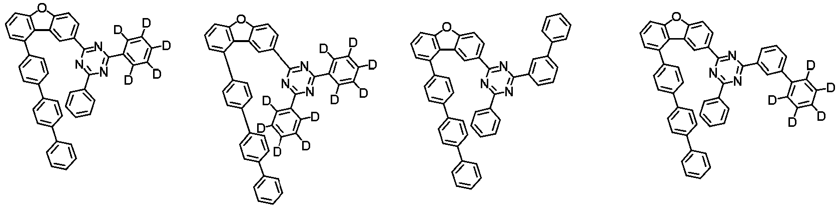

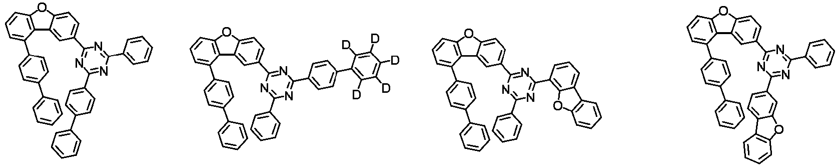

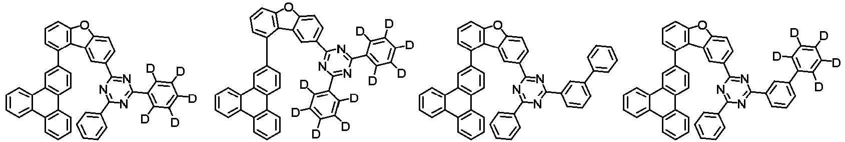

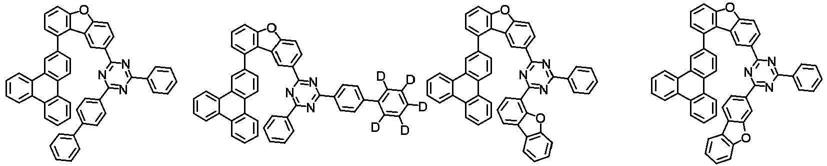

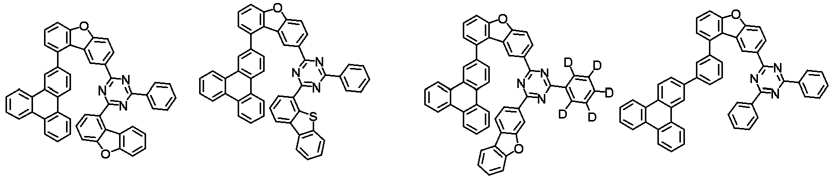

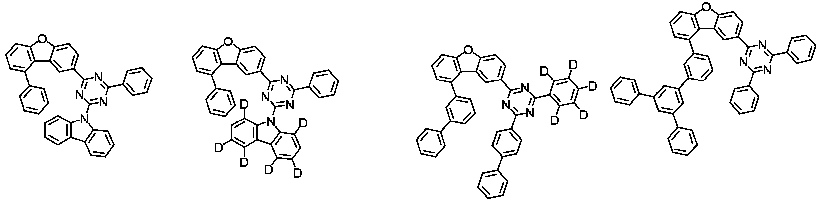

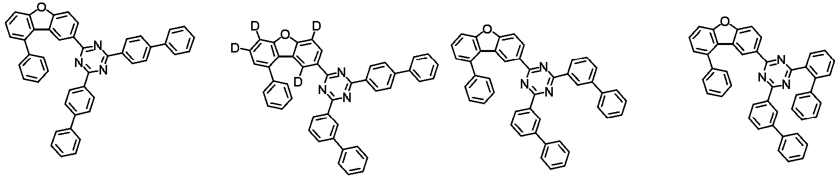

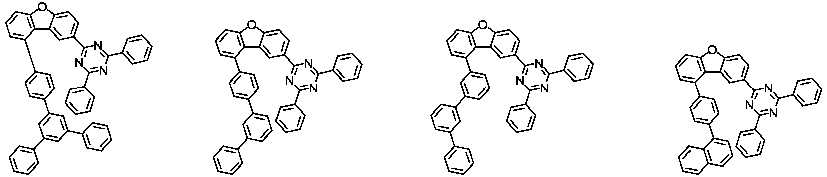

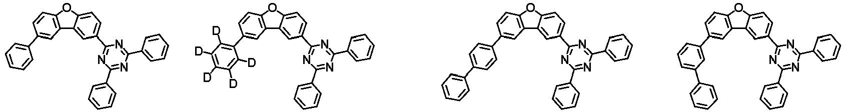

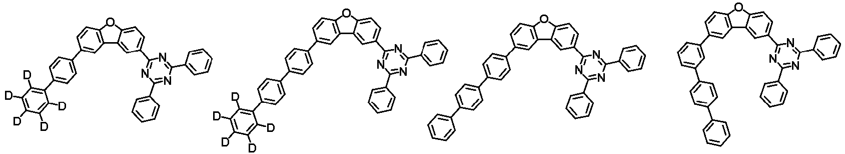

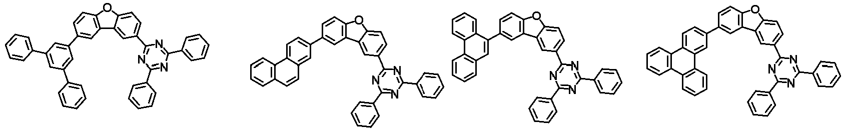

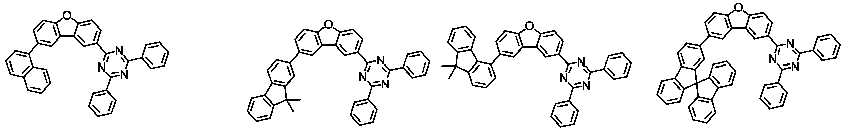

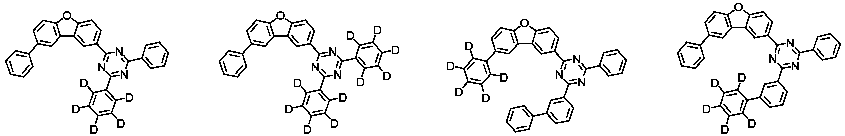

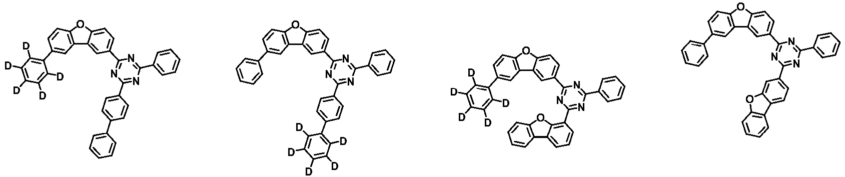

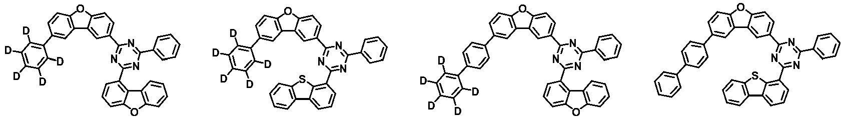

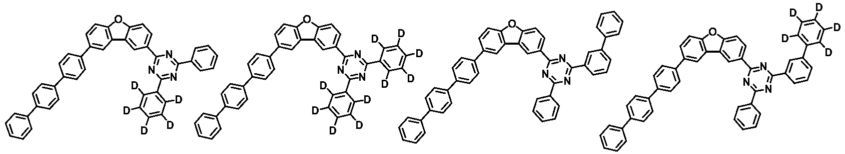

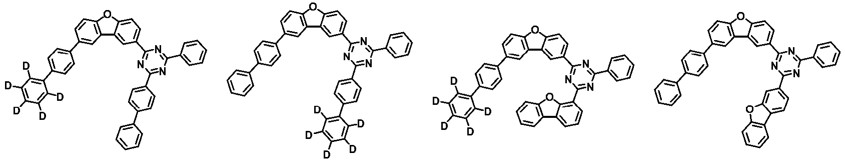

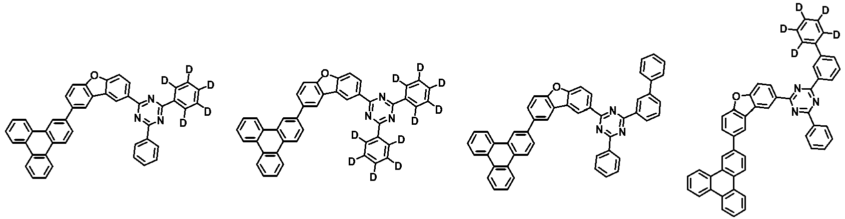

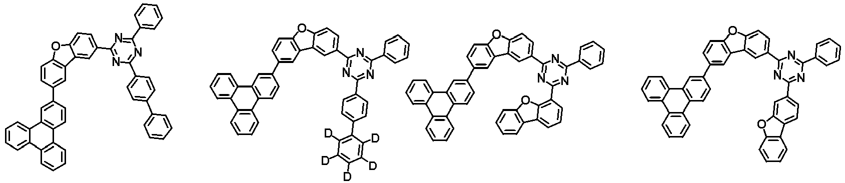

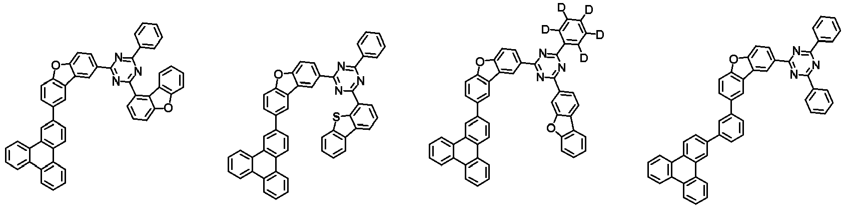

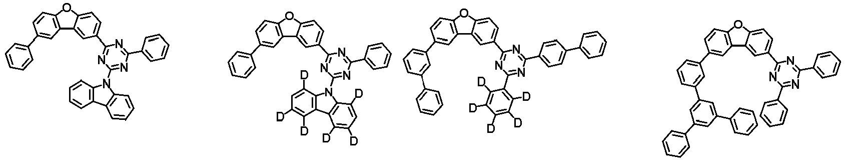

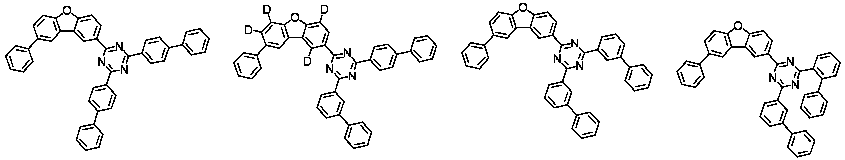

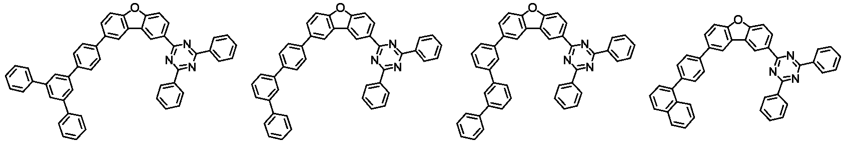

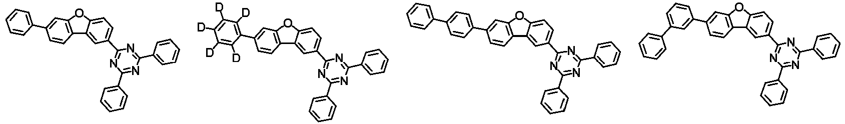

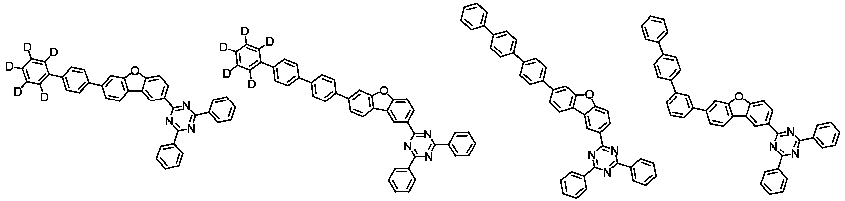

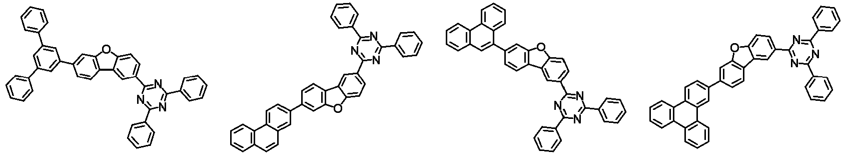

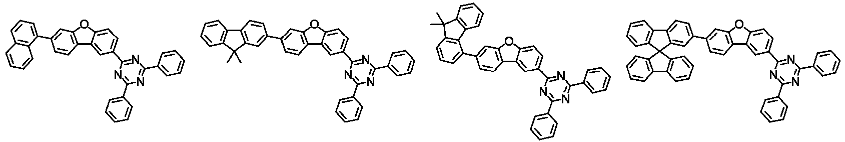

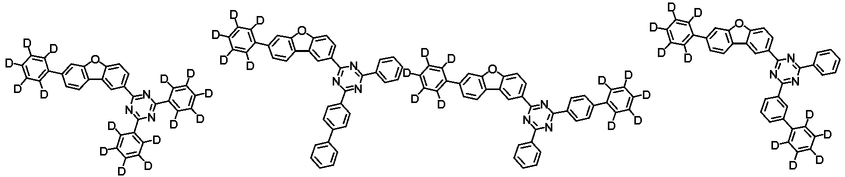

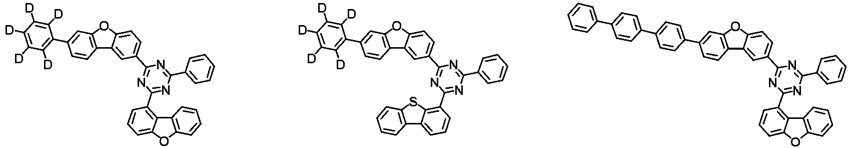

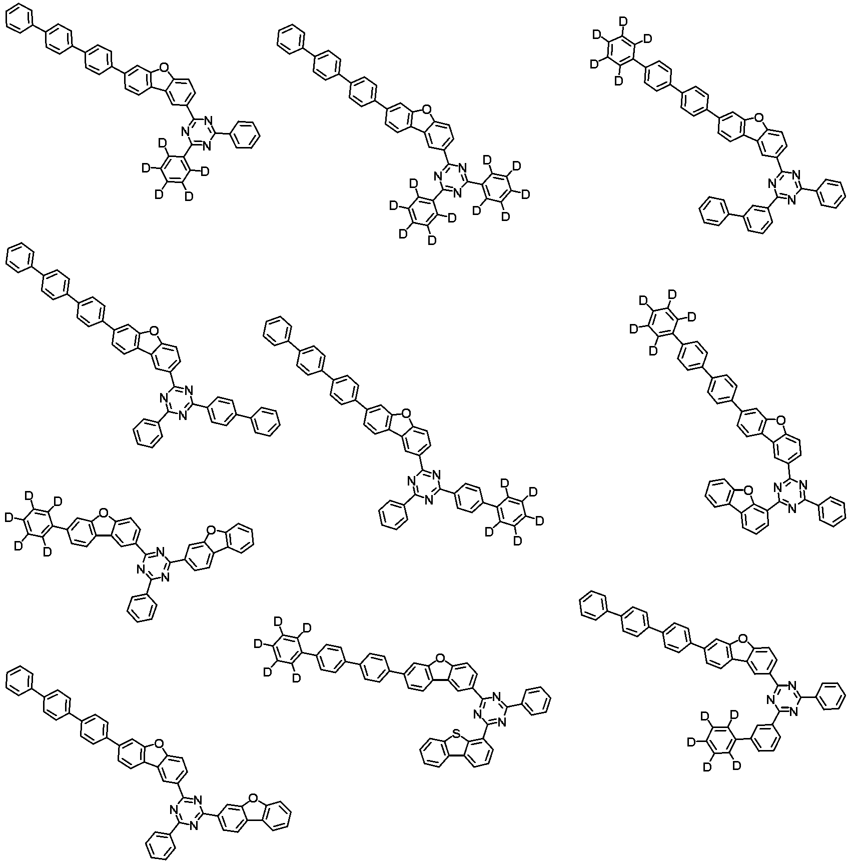

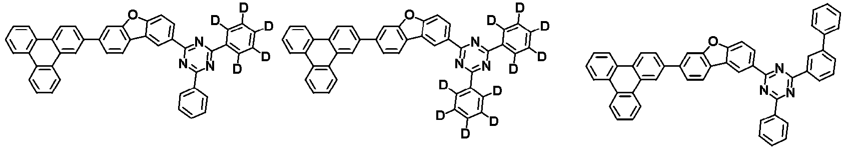

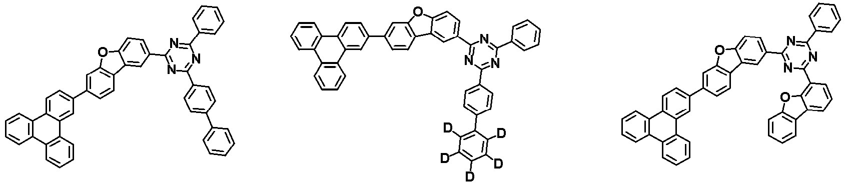

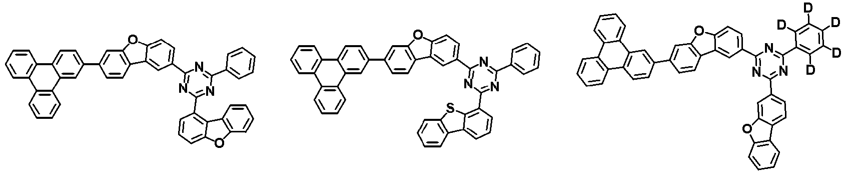

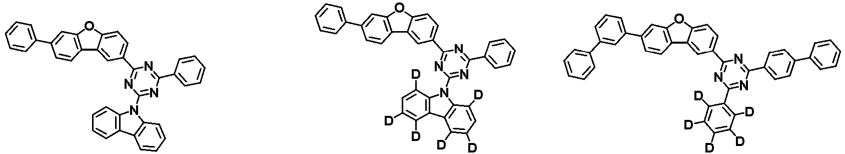

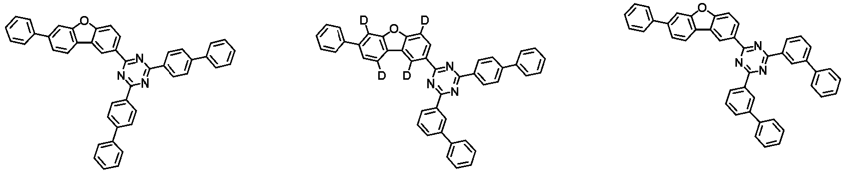

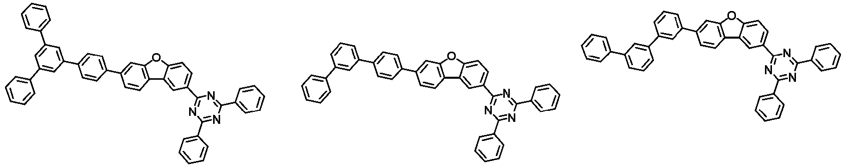

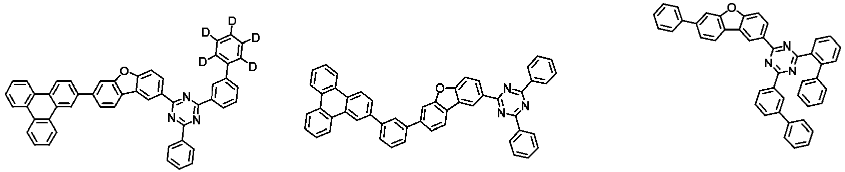

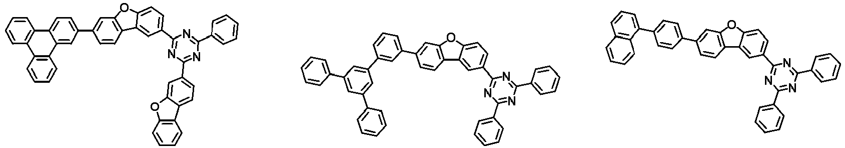

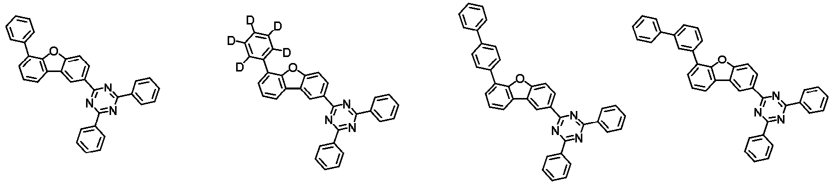

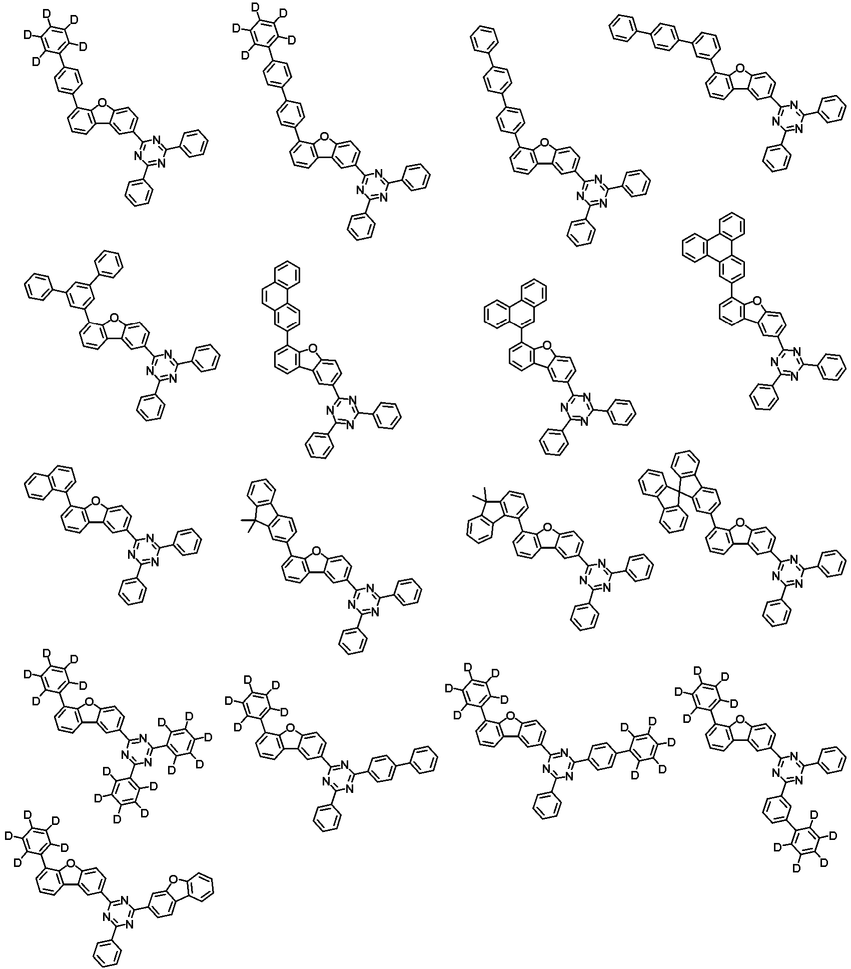

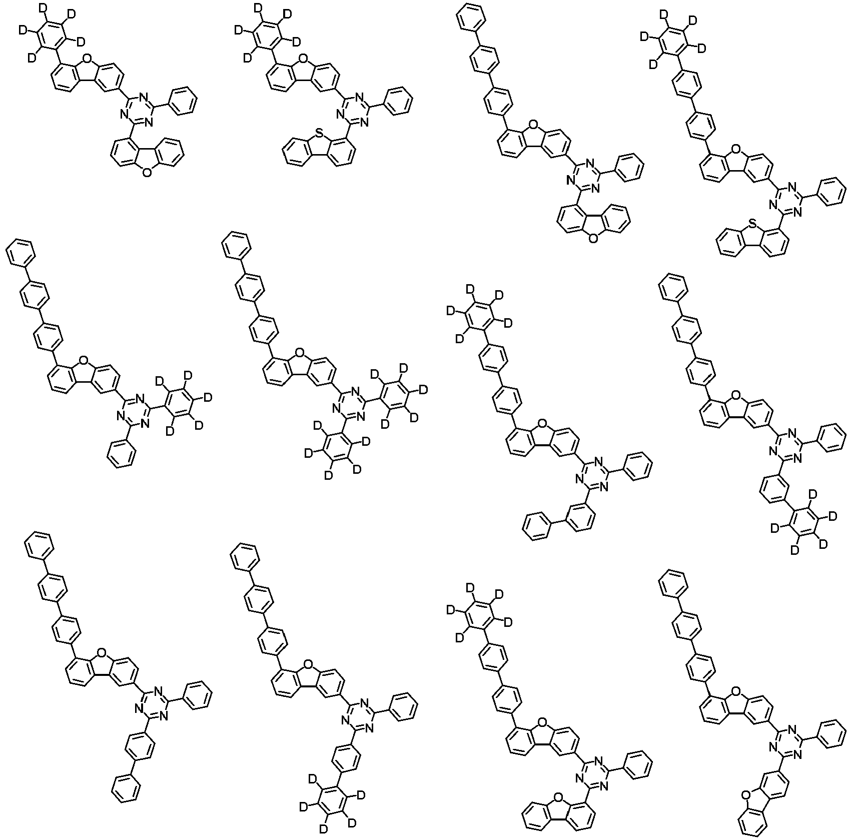

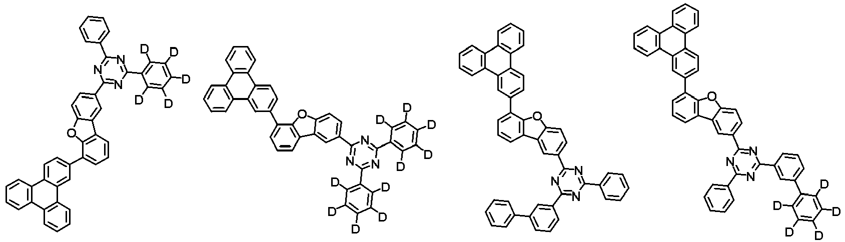

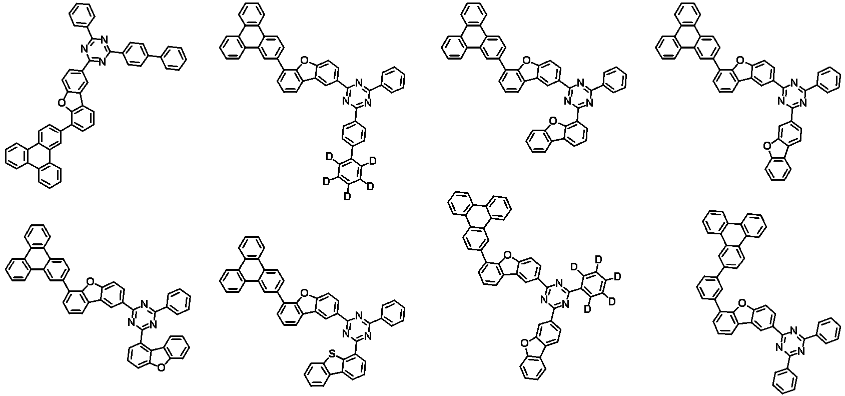

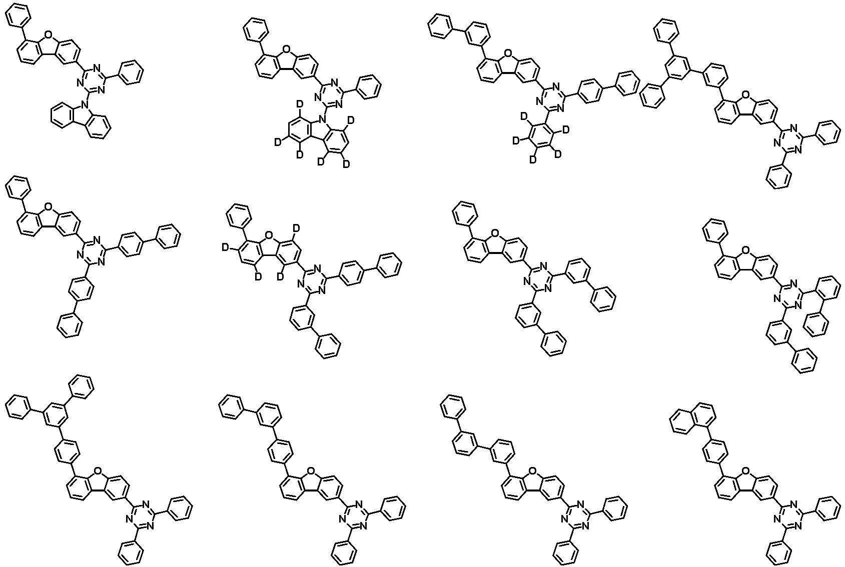

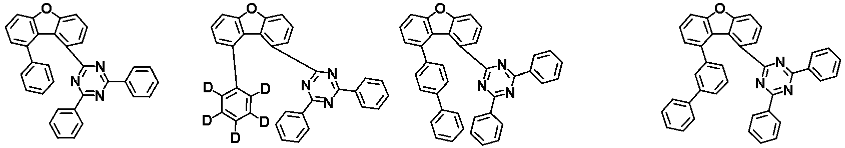

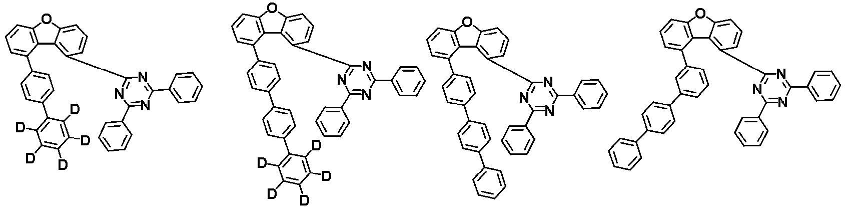

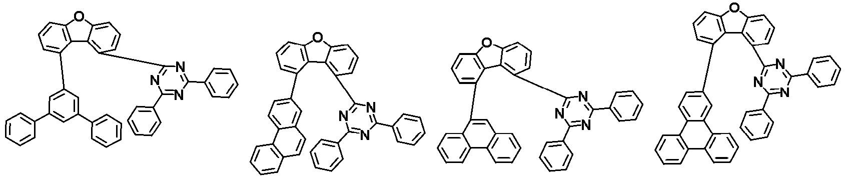

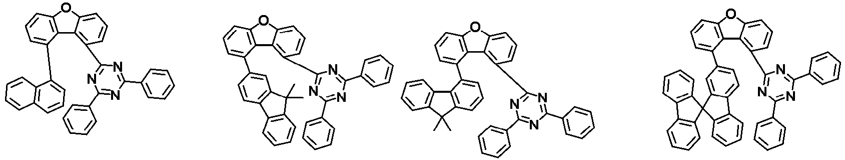

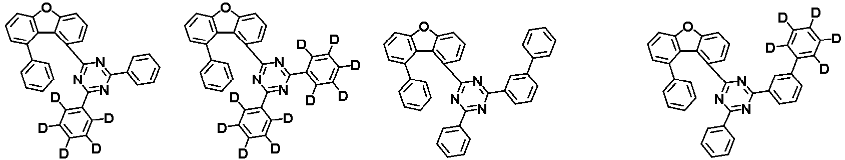

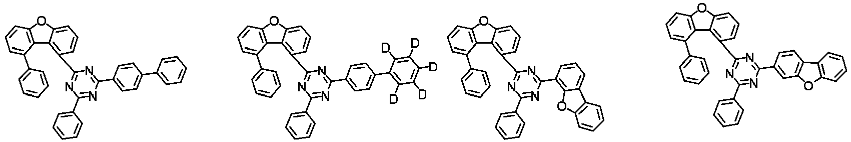

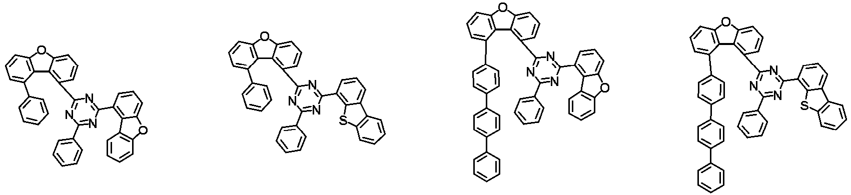

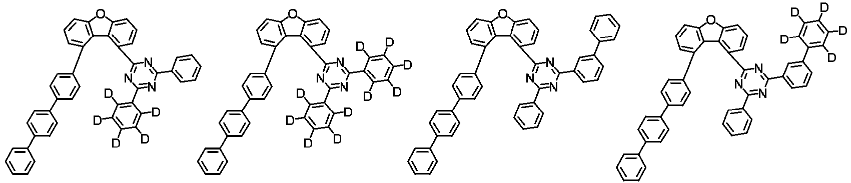

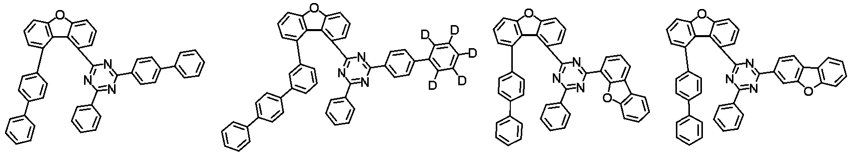

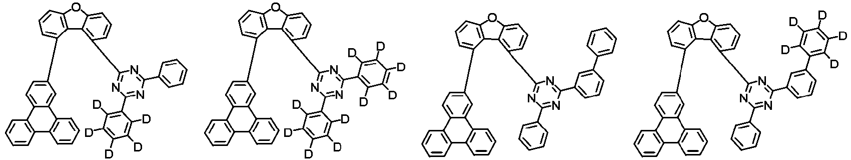

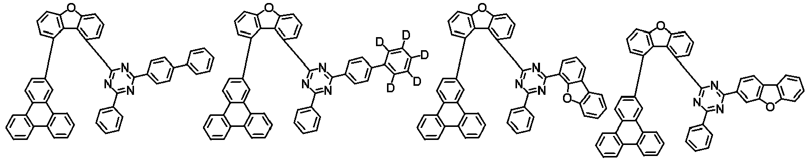

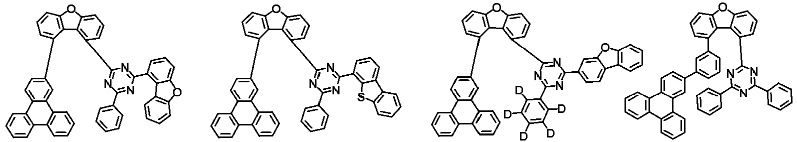

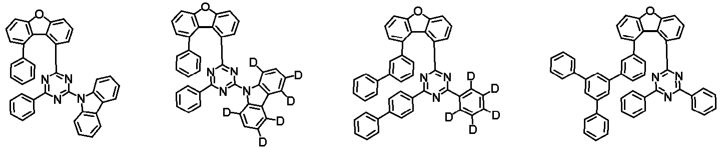

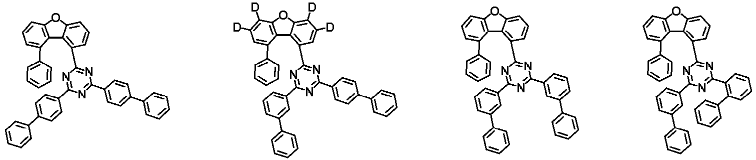

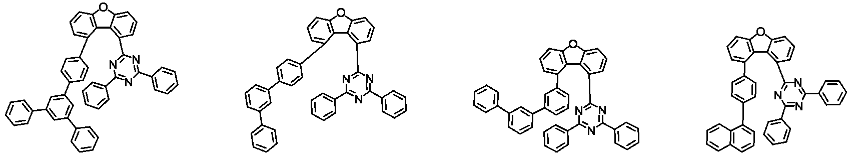

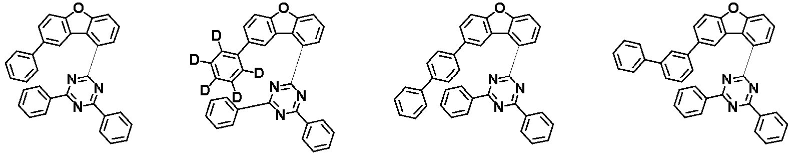

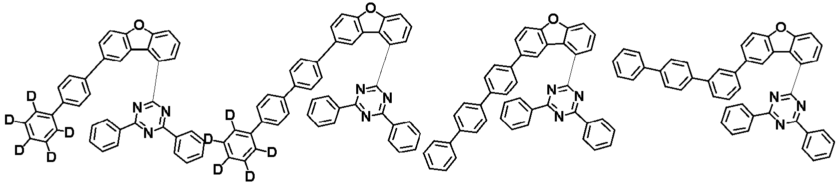

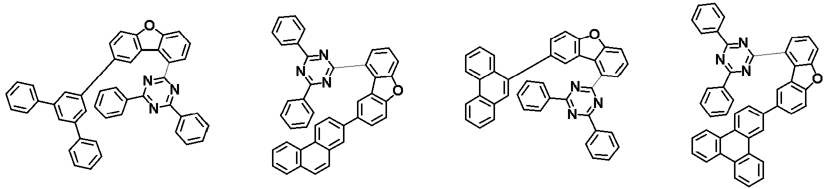

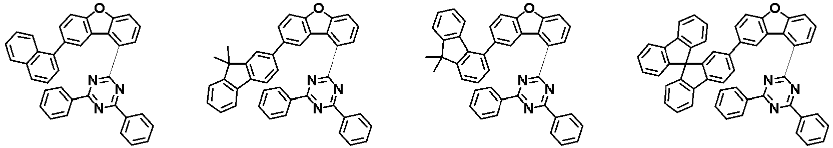

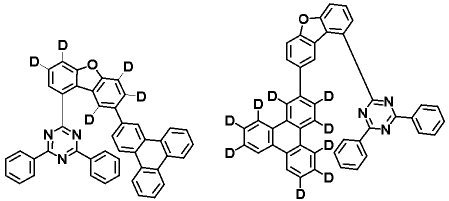

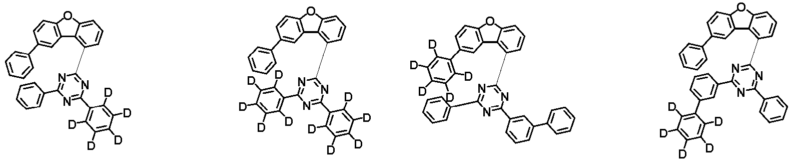

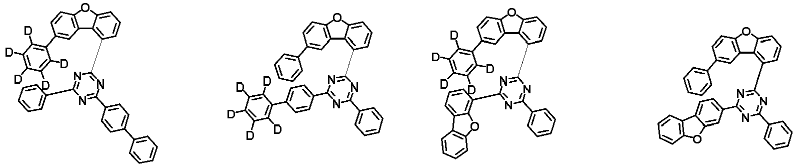

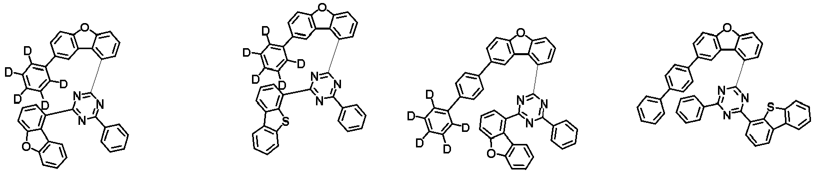

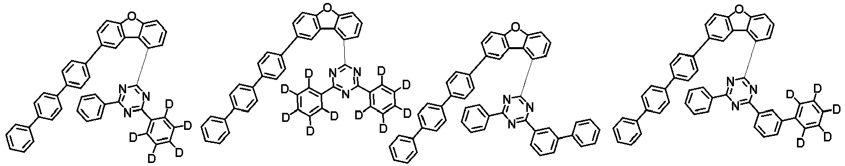

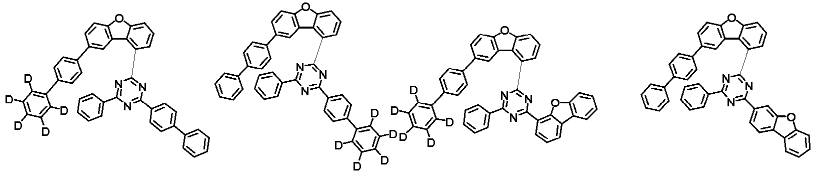

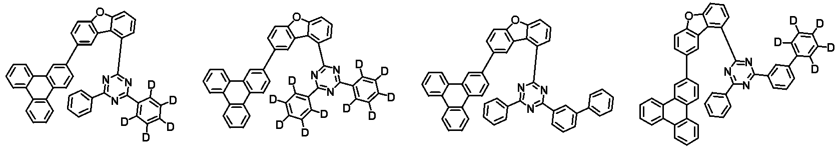

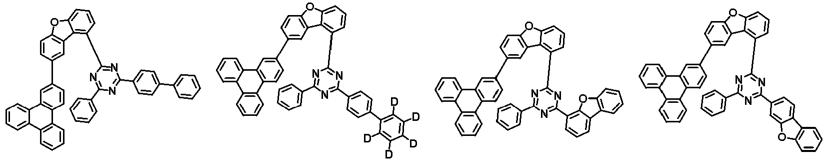

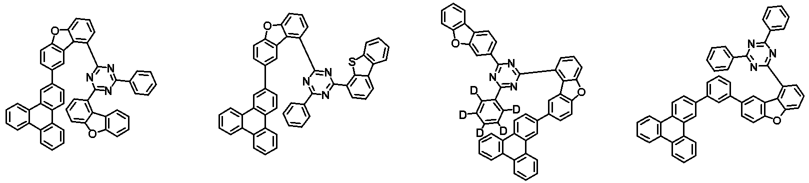

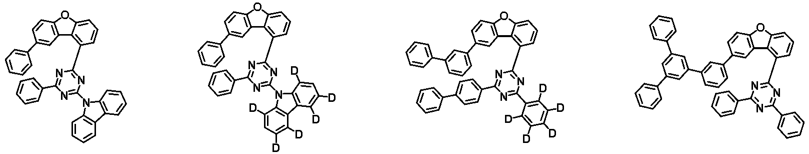

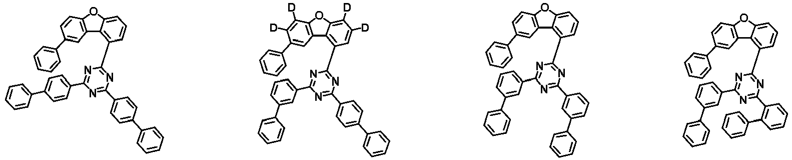

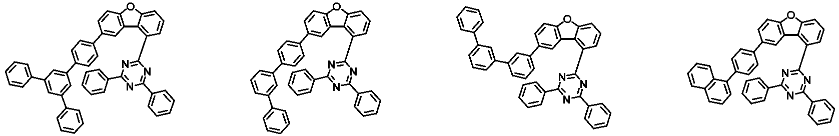

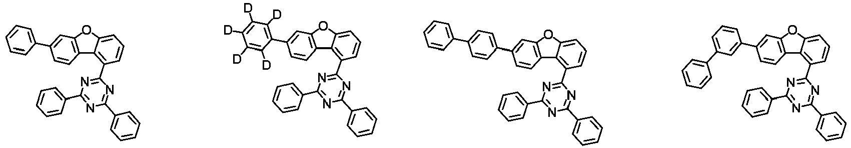

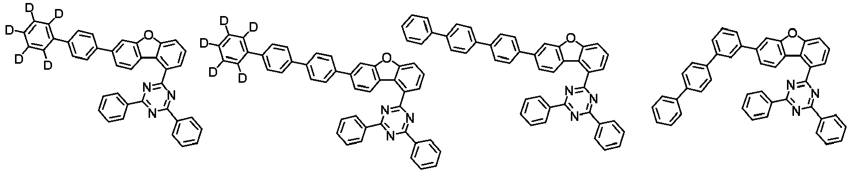

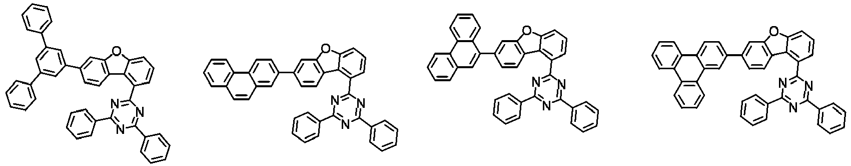

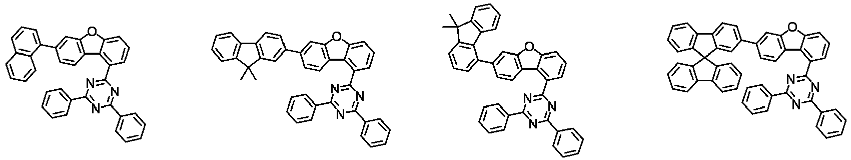

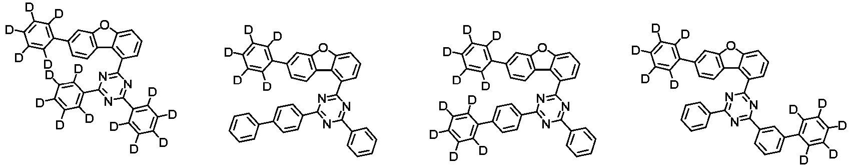

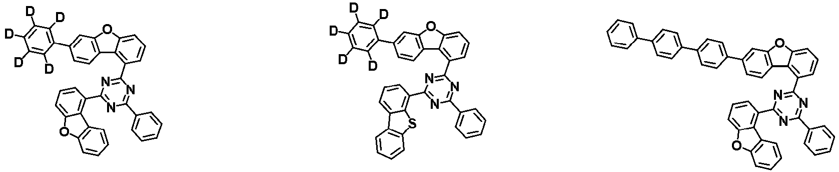

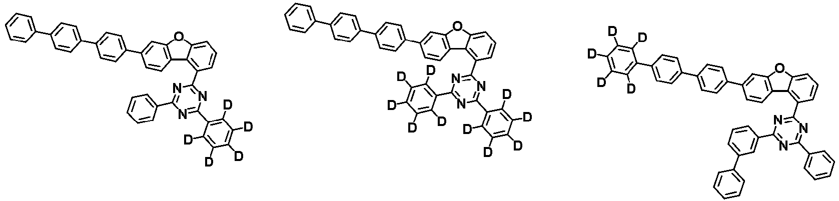

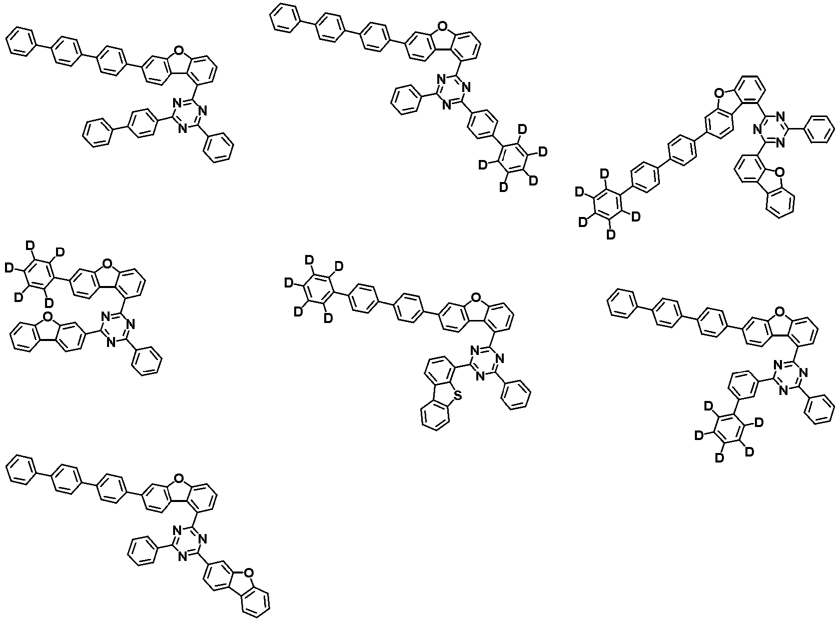

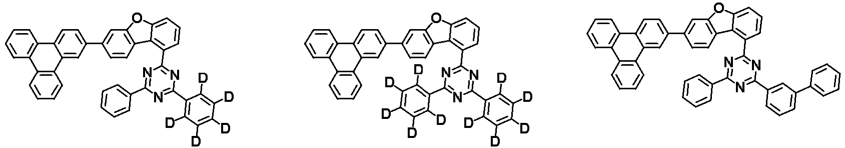

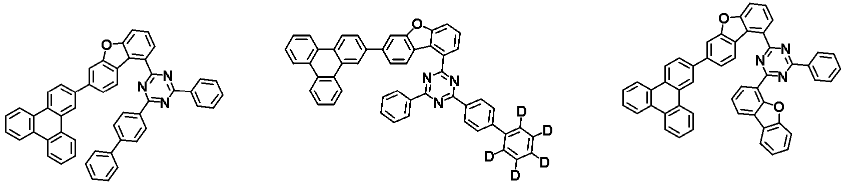

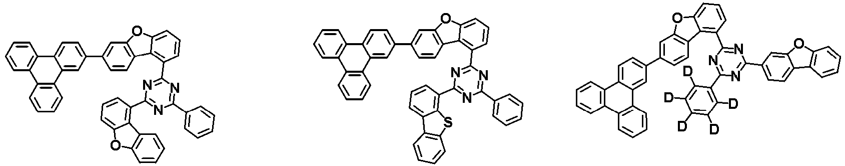

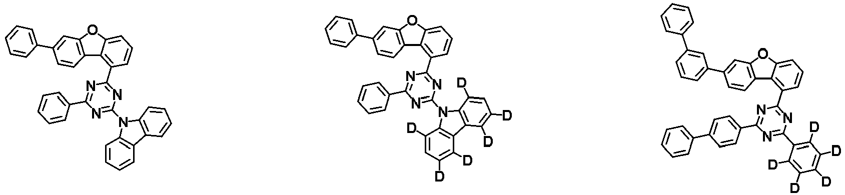

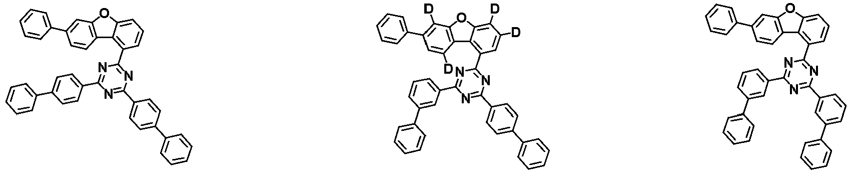

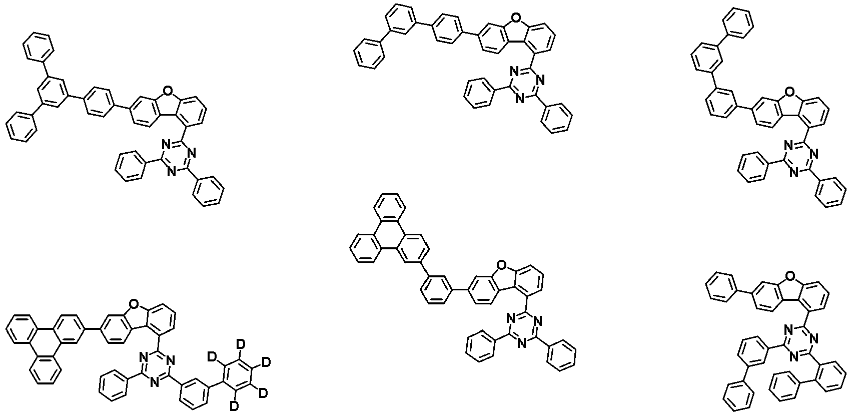

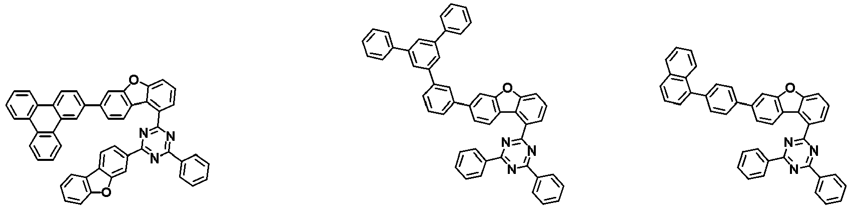

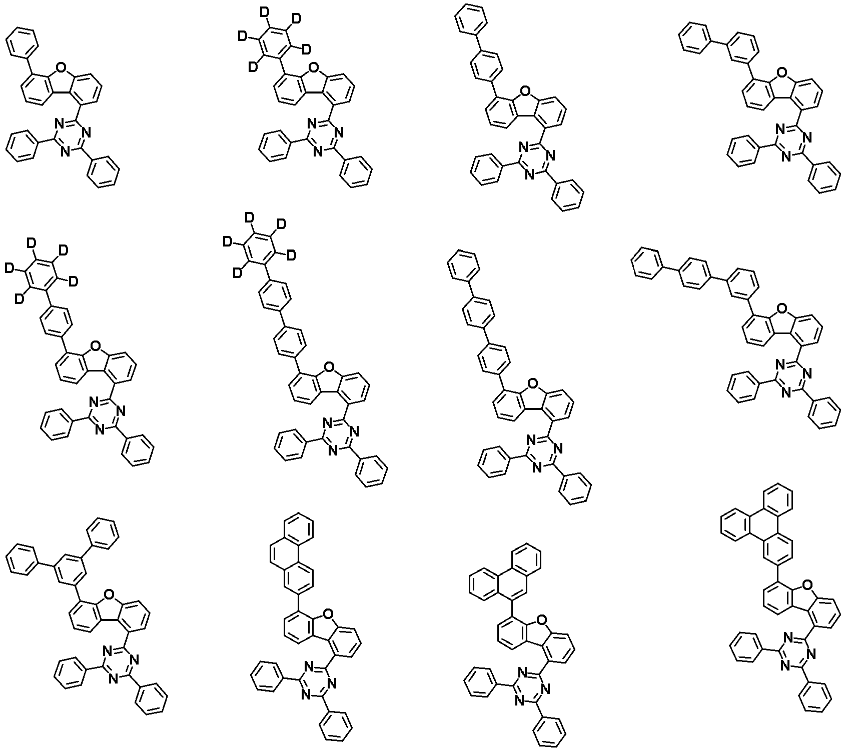

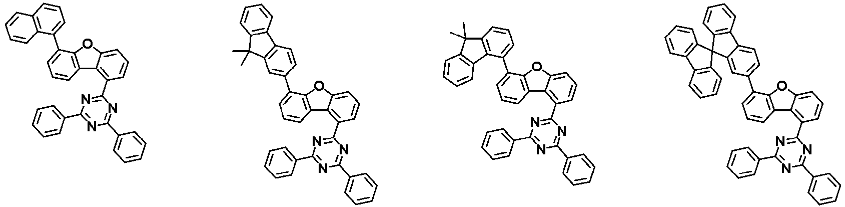

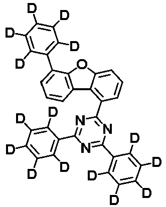

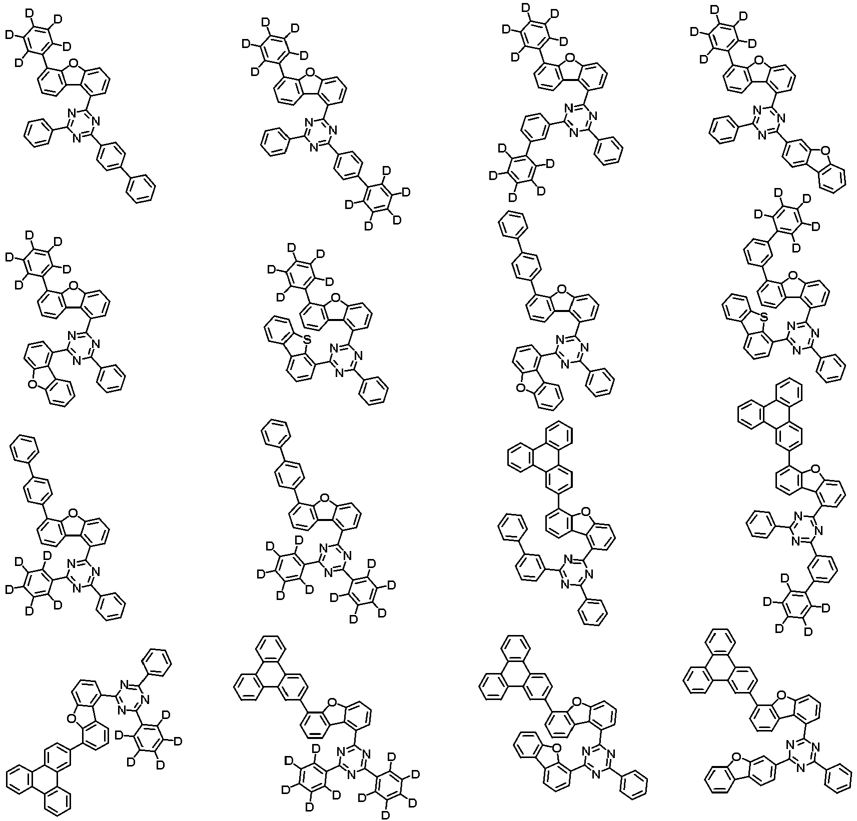

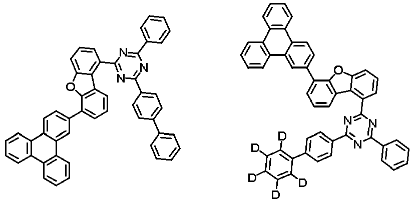

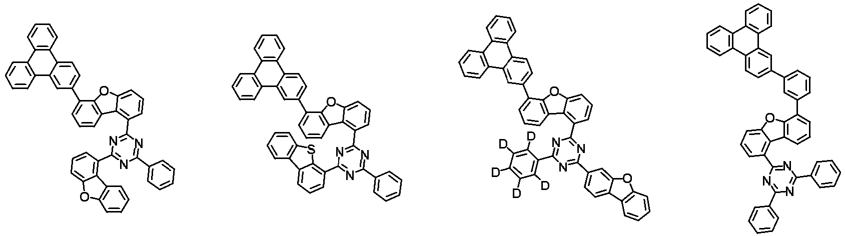

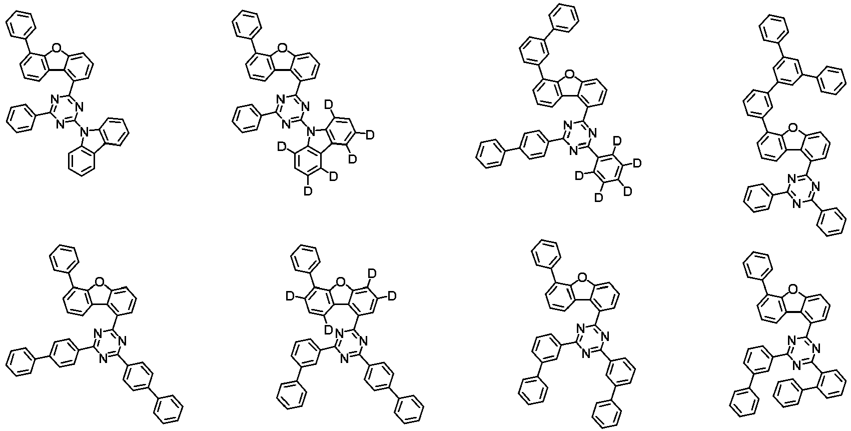

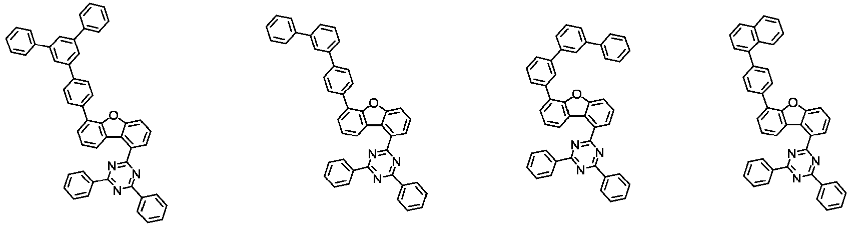

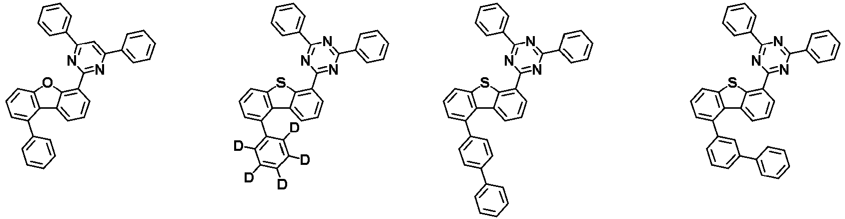

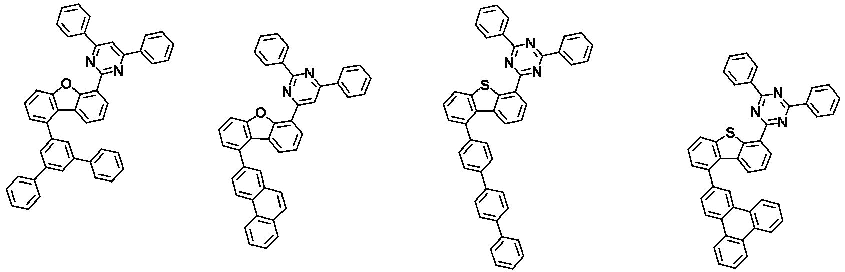

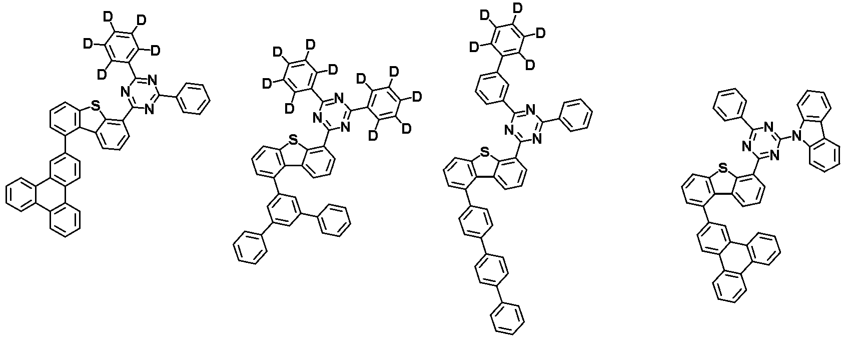

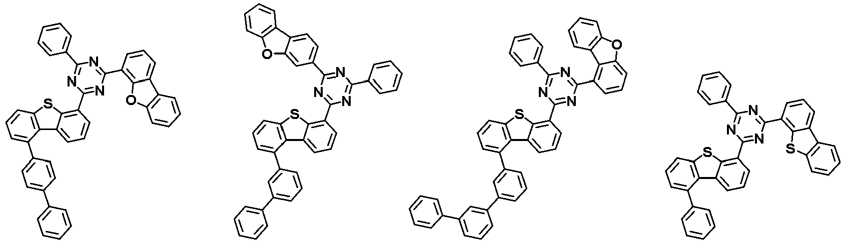

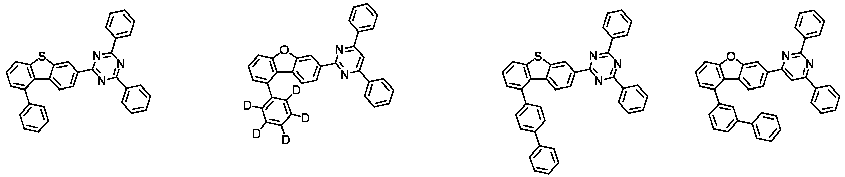

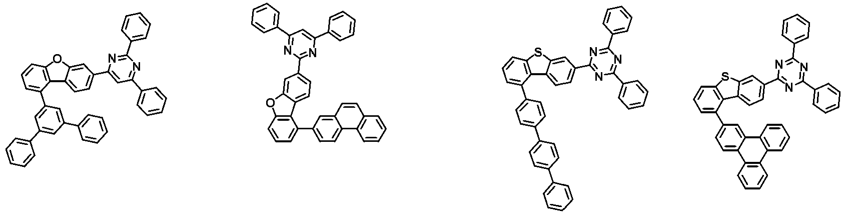

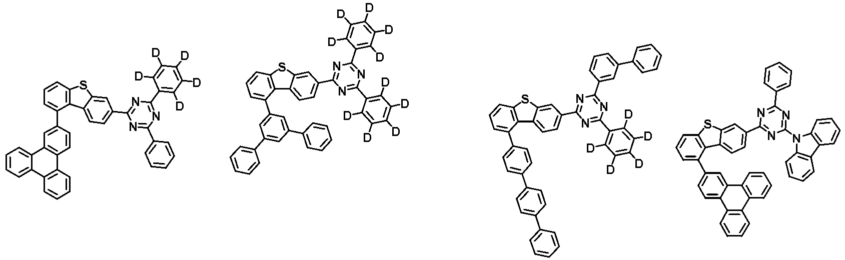

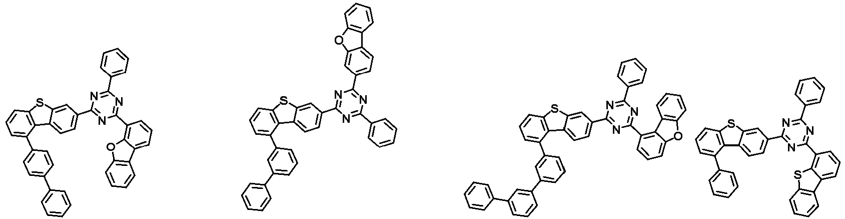

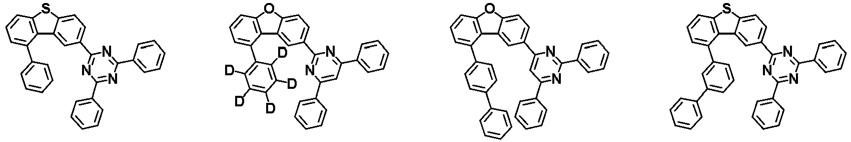

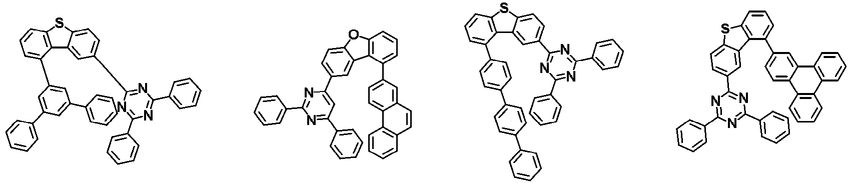

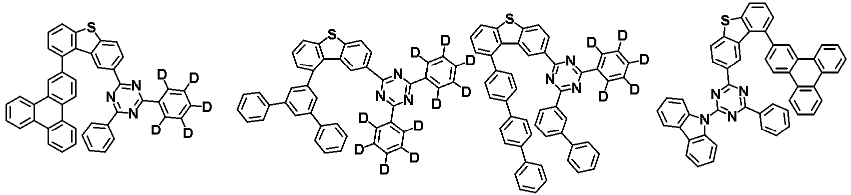

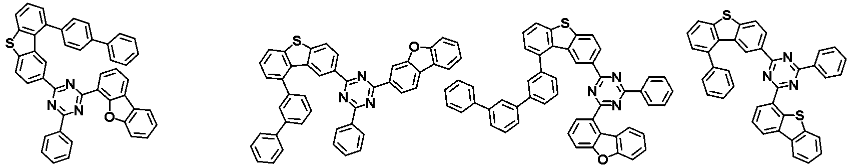

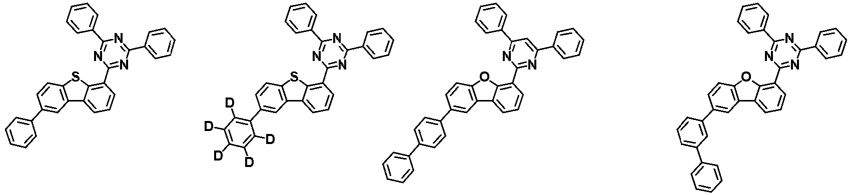

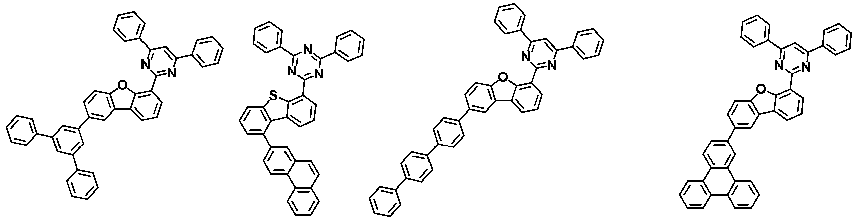

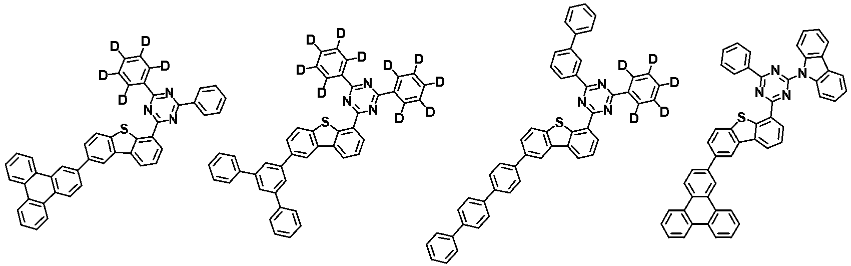

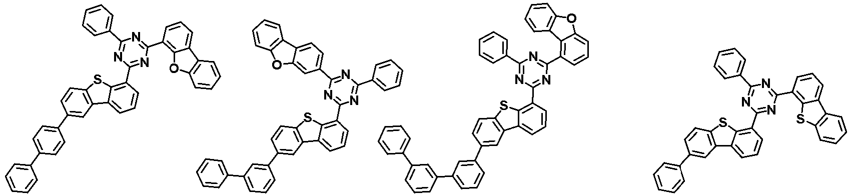

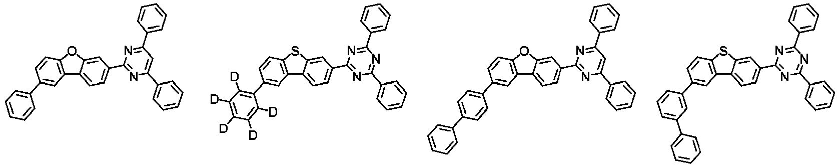

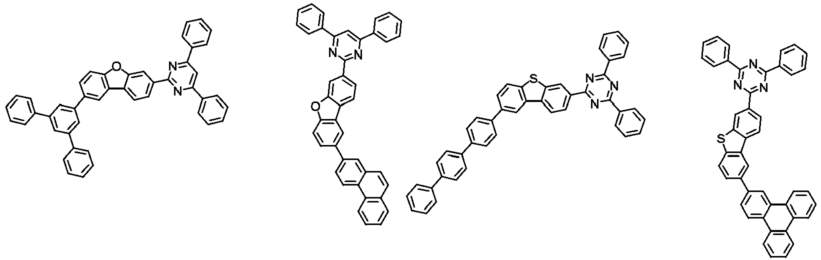

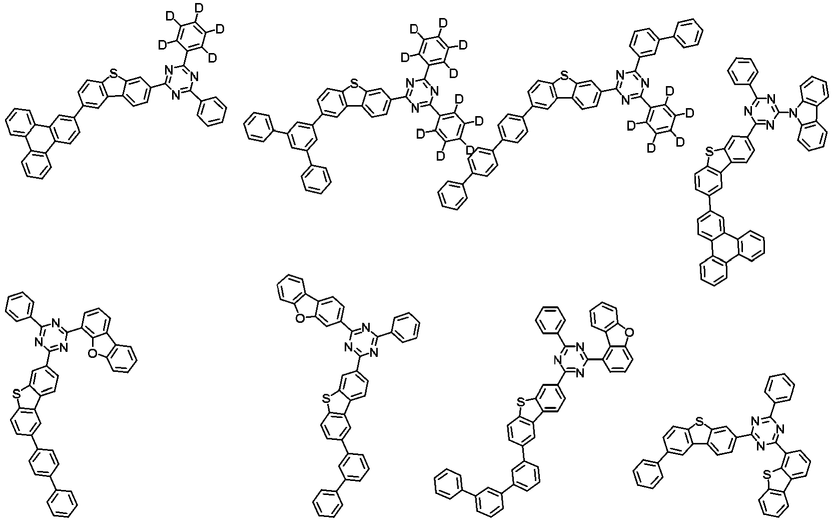

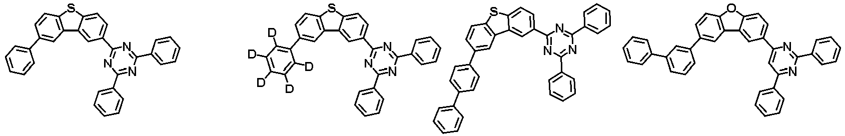

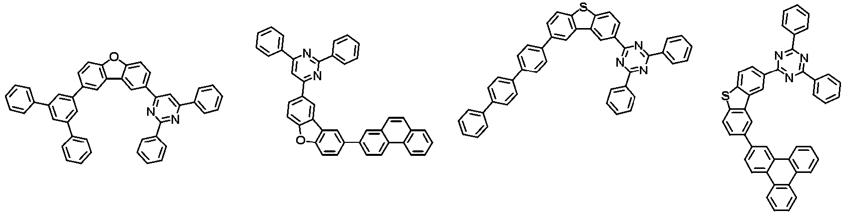

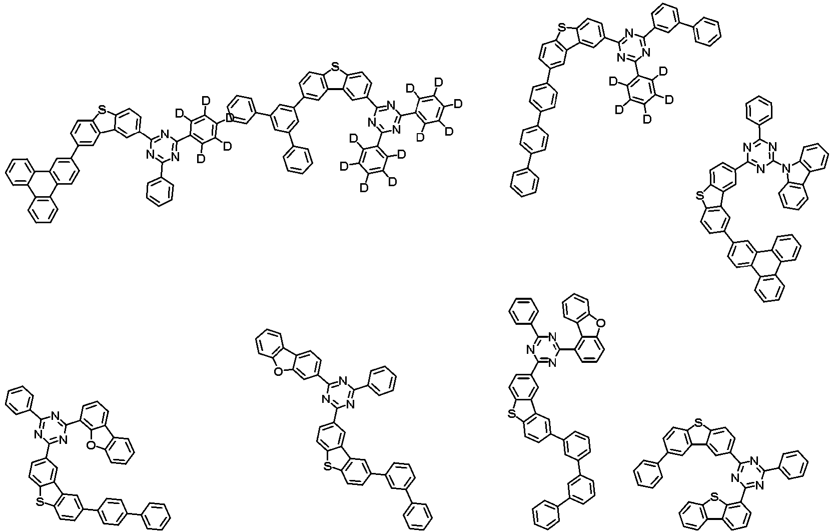

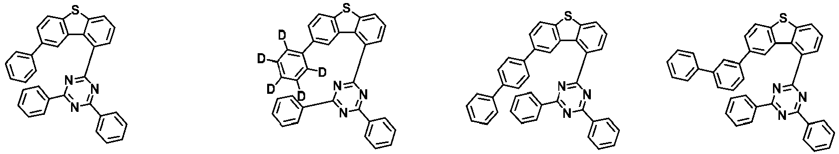

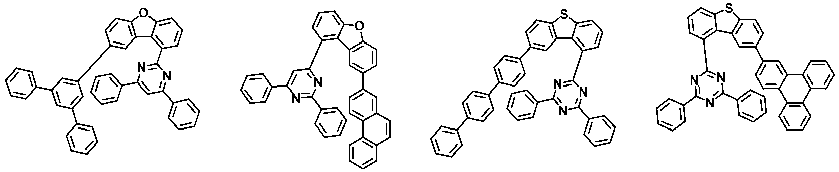

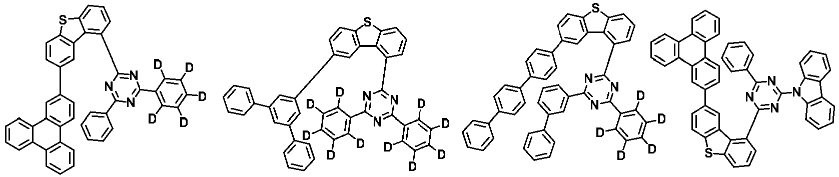

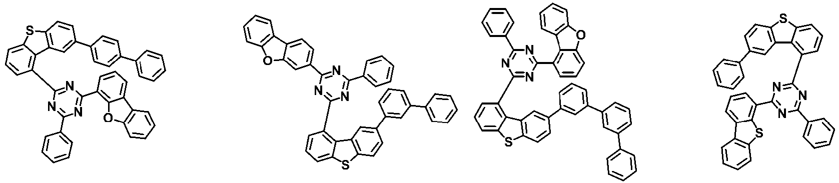

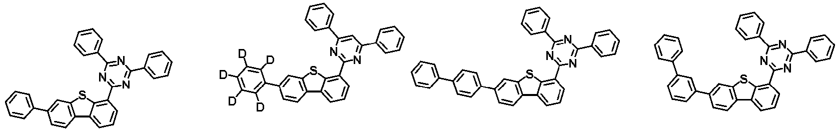

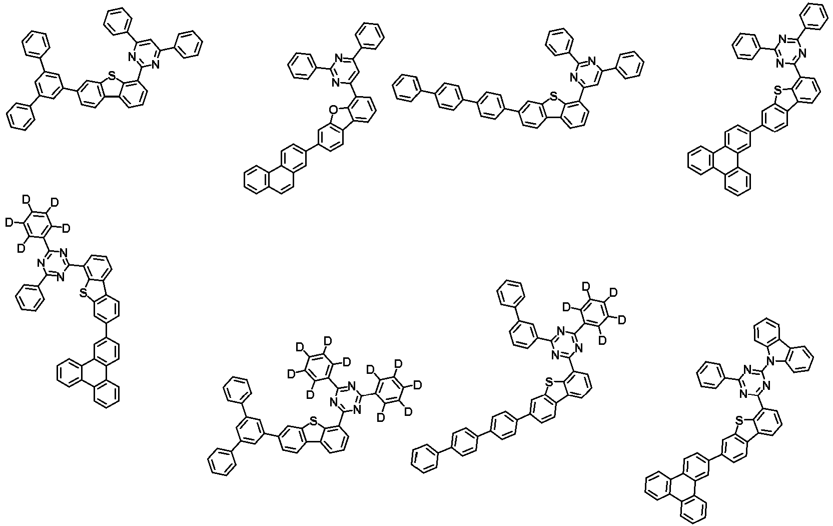

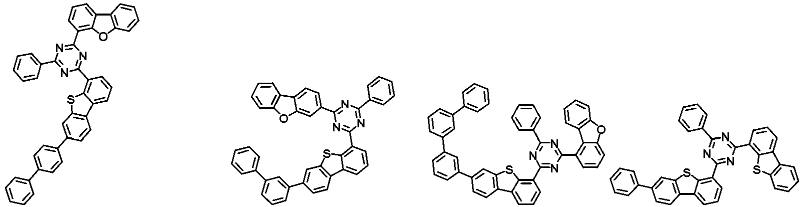

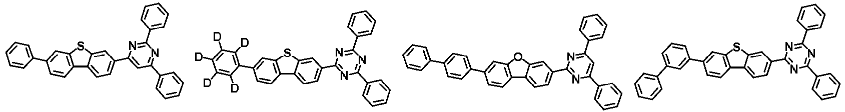

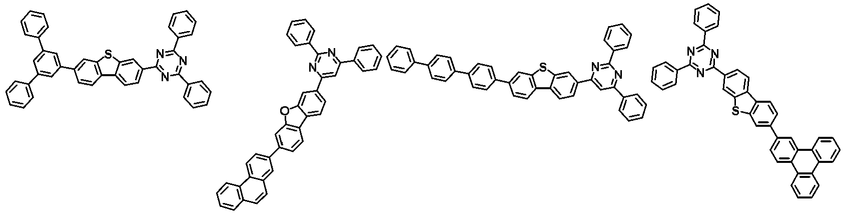

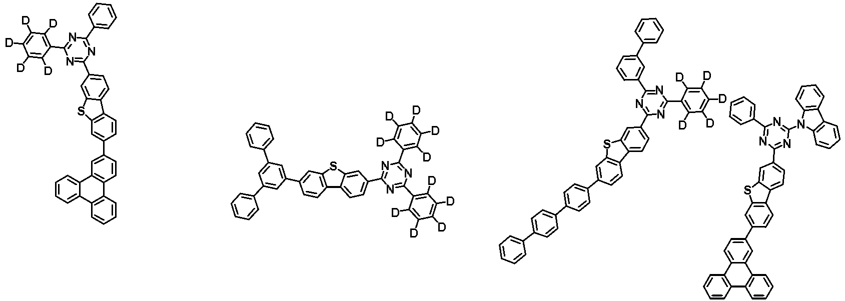

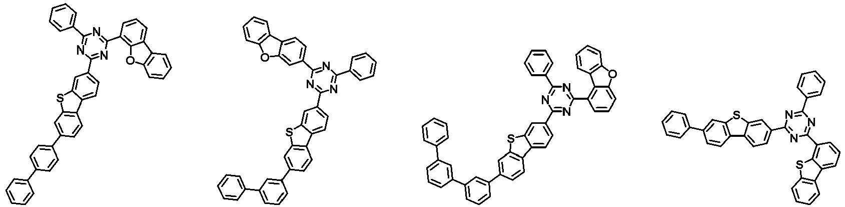

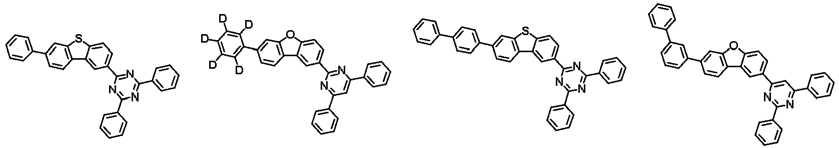

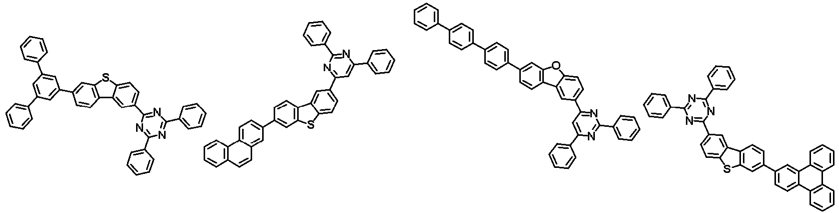

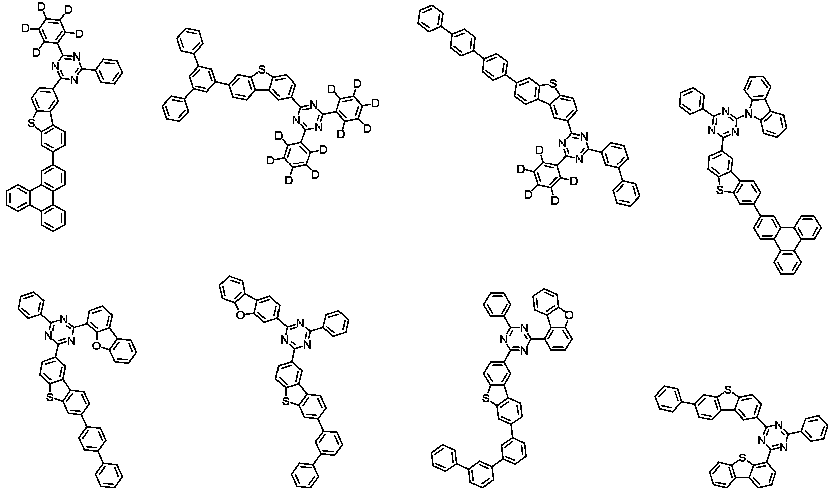

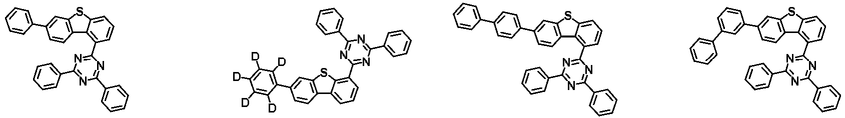

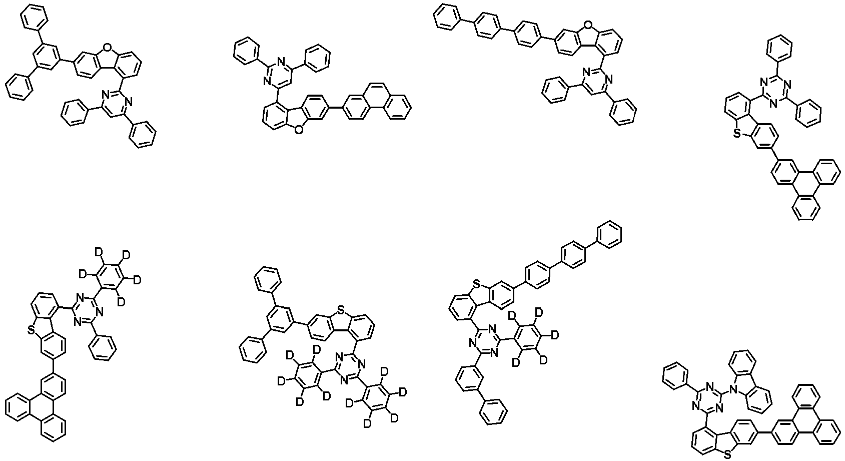

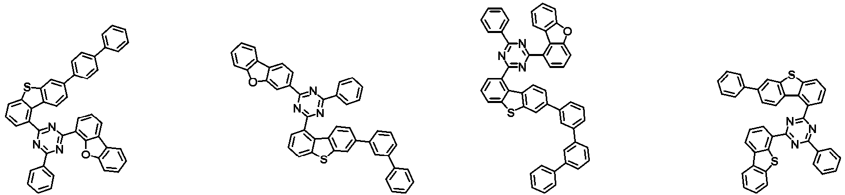

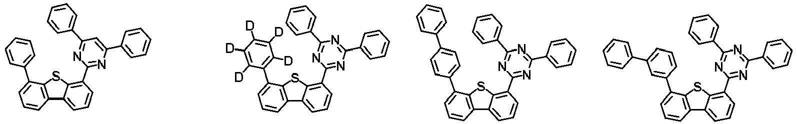

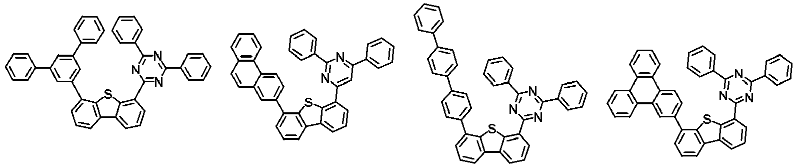

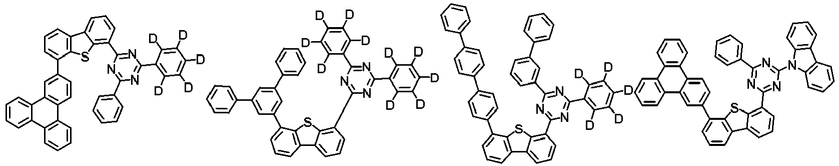

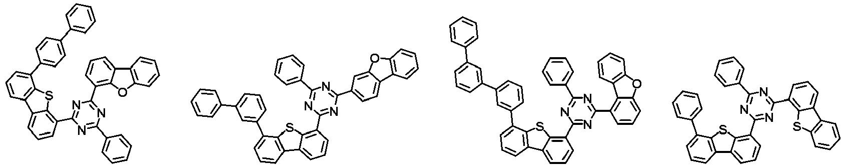

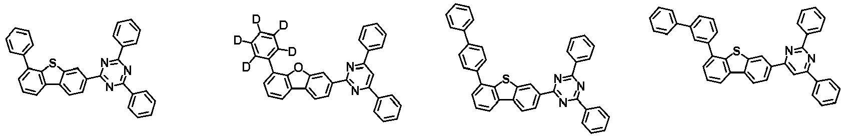

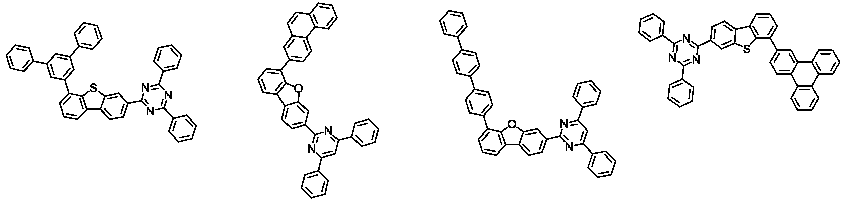

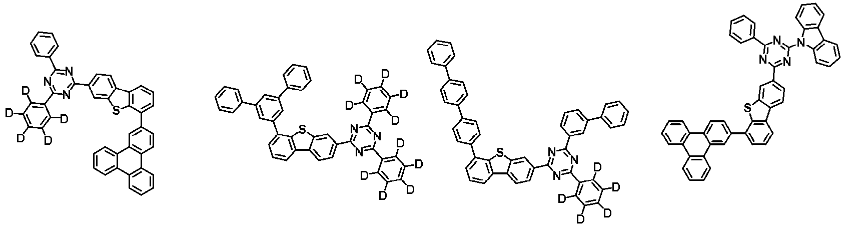

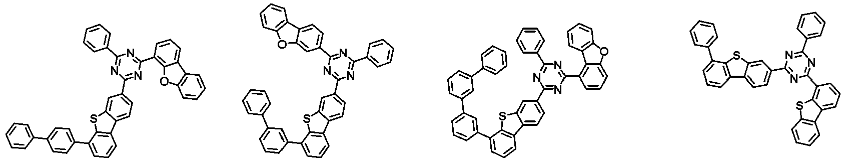

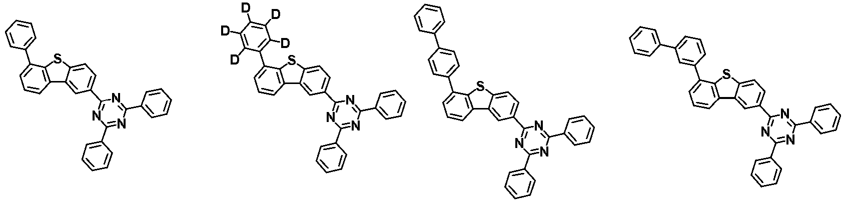

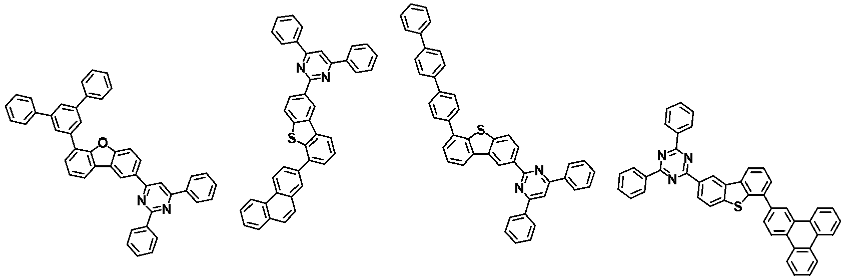

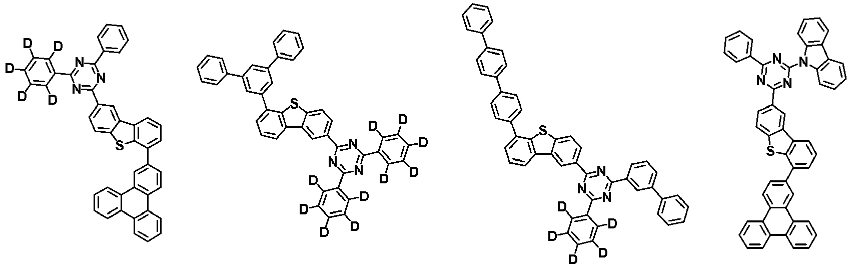

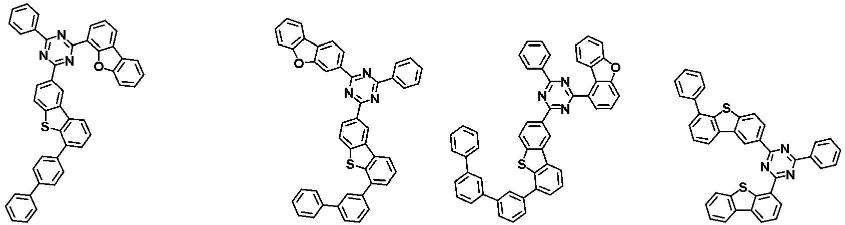

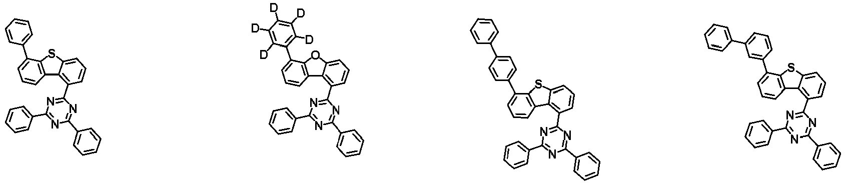

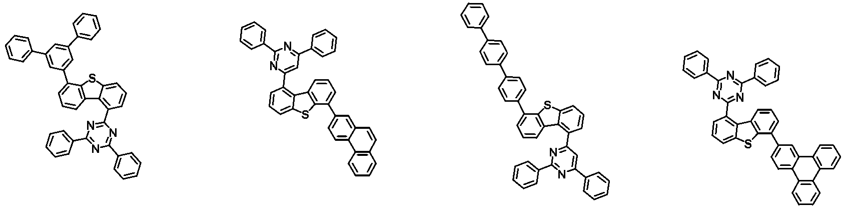

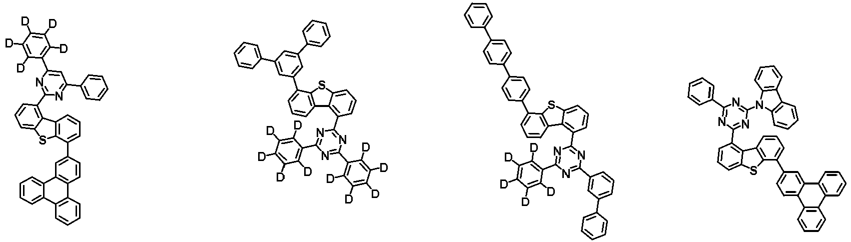

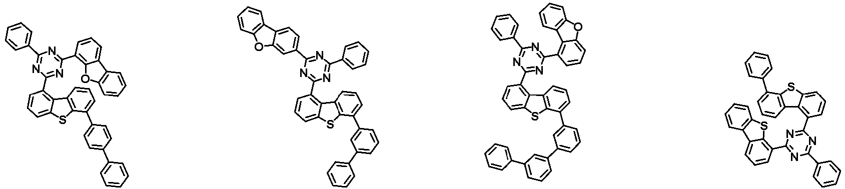

6. Organische lichtemittierende Vorrichtung gemäß Anspruch 1, worin:
die chemische Formel 2 durch irgendeine der folgenden chemischen Formeln 2-1 to 2-4 dargestellt wird: 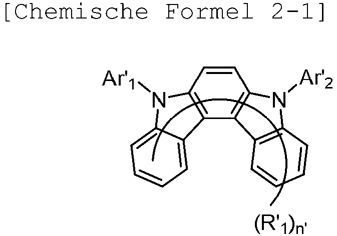 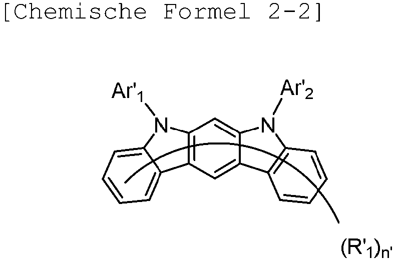 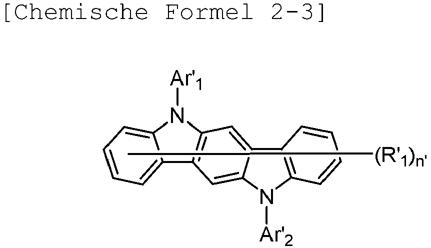 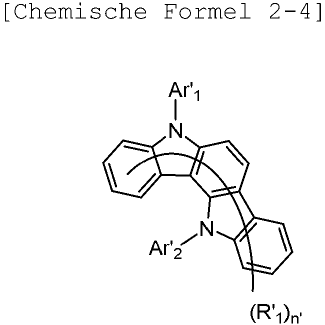
worin in der chemischen Formel 2-1 bis zur chemischen Formel 2-4,
n', R'₁, Ar'₁ und Ar'₂ die gleichen sind, wie sie in Anspruch 1 definiert sind.

7. Organische lichtemittierende Vorrichtung gemäß Anspruch 1, worin:
R'₁ jeweils unabhängig Wasserstoff oder Deuterium ist.

8. Organische lichtemittierende Vorrichtung gemäß Anspruch 1, worin:
Ar'₁ und Ar'₂ jeweils unabhängig Phenyl, unsubstituiert oder substituiert mit 1 bis 5 Deuterium; Biphenylyl, unsubstituiert oder substituiert mit 1 bis 9 Deuterium; Methyl-Biphenylyl, unsubstituiert oder substituiert mit 1 bis 11 Deuterium; Dimethyl-Biphenylyl, unsubstituiert oder substituiert mit 1 bis 13 Deuterium; Terphenylyl, unsubstituiert oder substituiert mit 1 bis 13 Deuterium; Dimethylfluorenyl, unsubstituiert oder substituiert mit 1 bis 13 Deuterium; Dibenzofuranyl, unsubstituiert oder substituiert mit 1 bis 7 Deuterium; Dibenzothiophenyl, unsubstituiert oder substituiert mit 1 bis 7 Deuterium; Dimethylfluorenyl-Phenyl, unsubstituiert oder
substituiert mit 1 bis 17 Deuterium; Dibenzofuranyl-Phenyl, unsubstituiert oder substituiert mit 1 bis 11 Deuterium, oder Dibenzothiophenyl-Phenyl, unsubstituiert oder substituiert mit 1 bis 11 Deuterium, sind.

9. Organische lichtemittierende Vorrichtung gemäß Anspruch 1, worin:
die durch die Chemische Formel 2 dargestellte Verbindung irgendeine ist, die ausgewählt ist aus der Gruppe, bestehend aus: 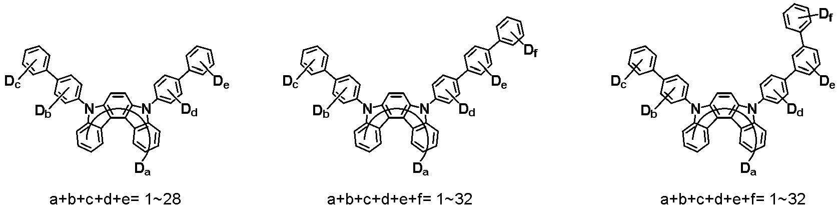 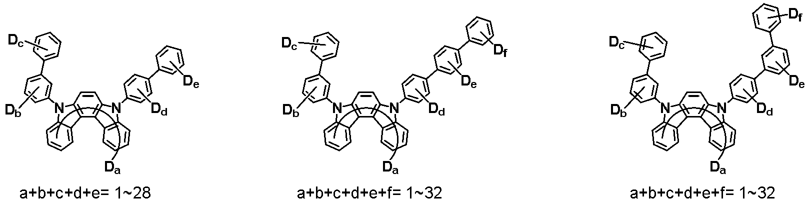 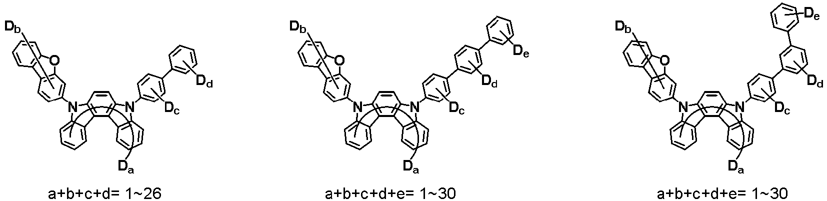 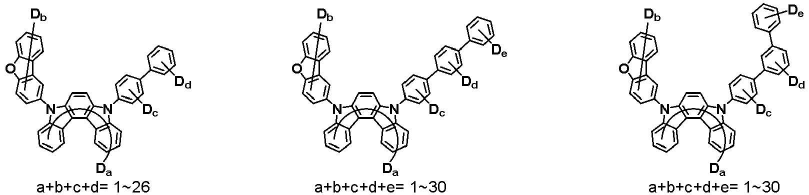 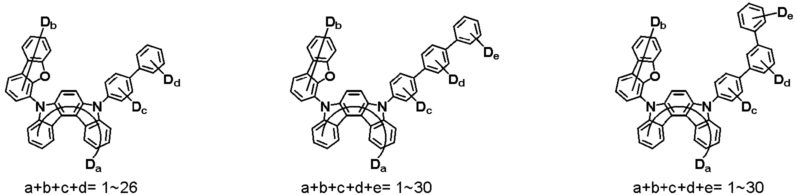 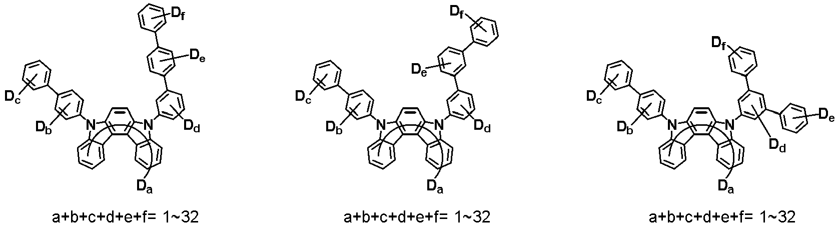 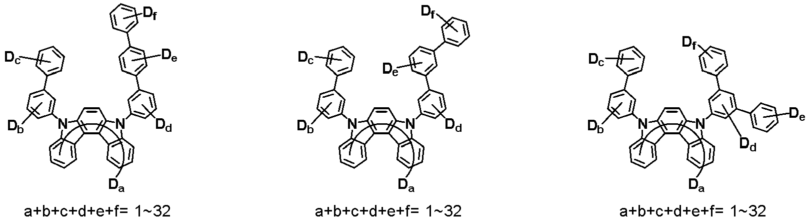 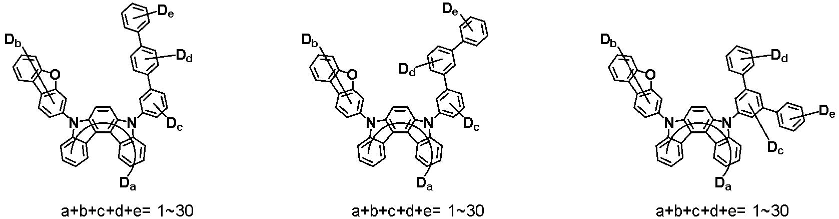 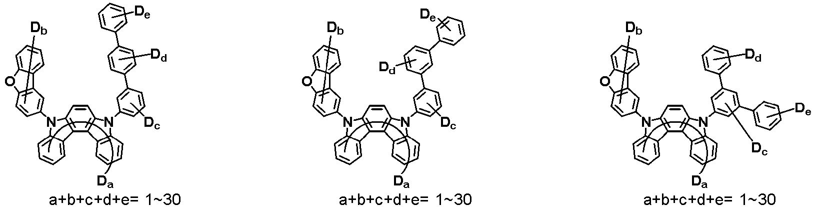 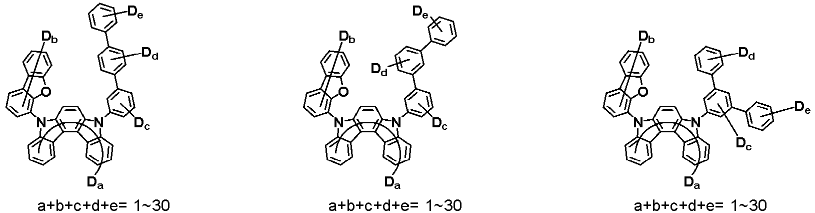 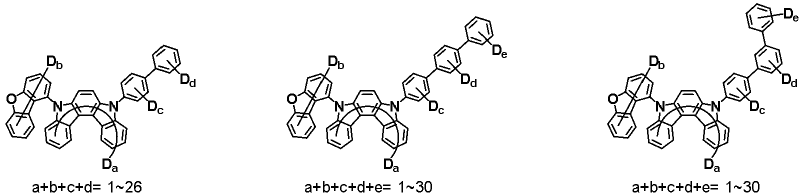 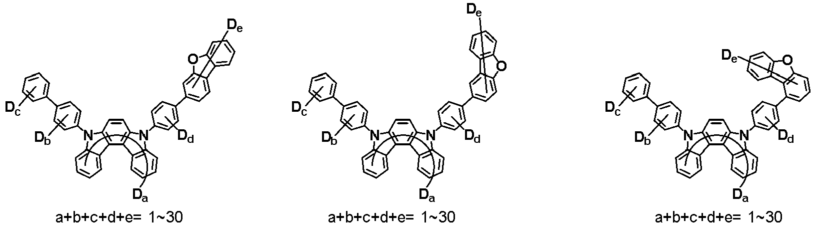 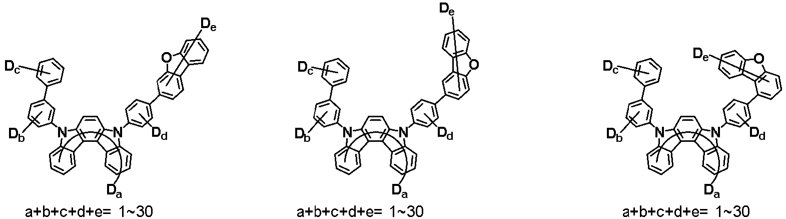 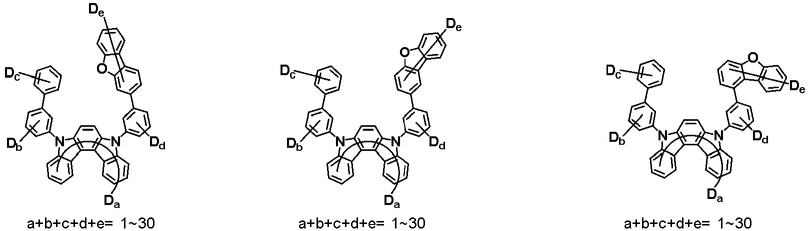 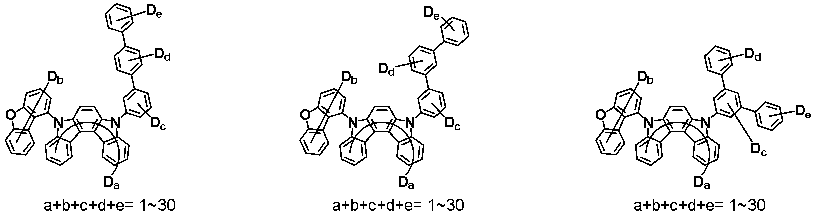 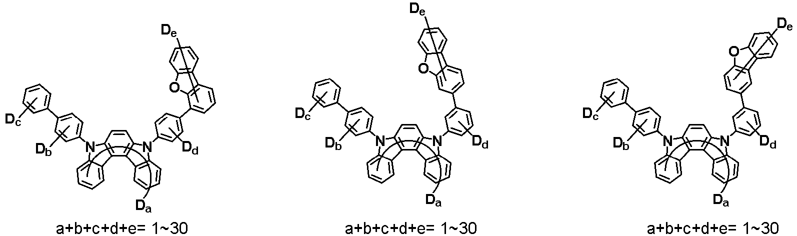 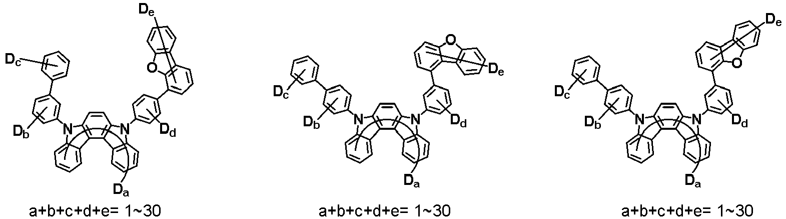 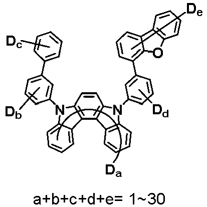 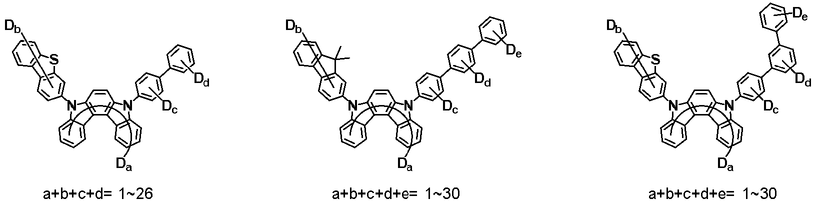 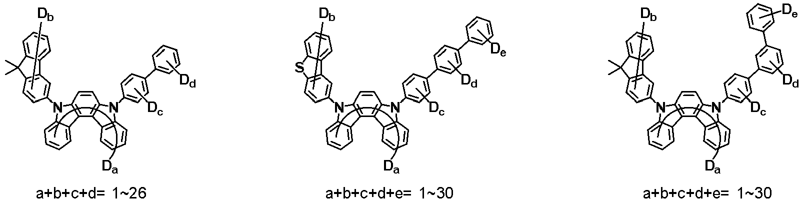 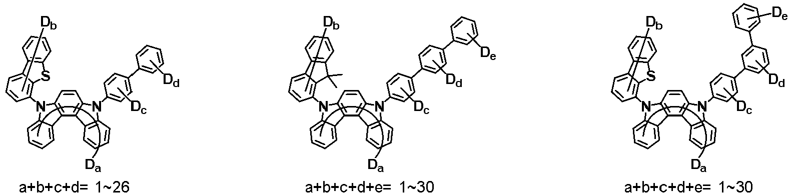 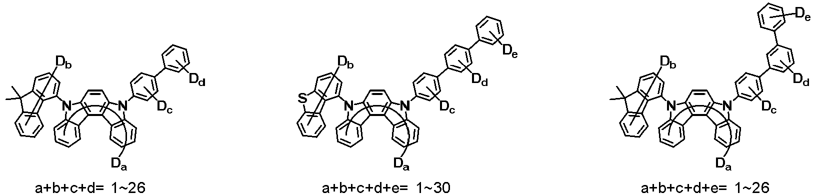 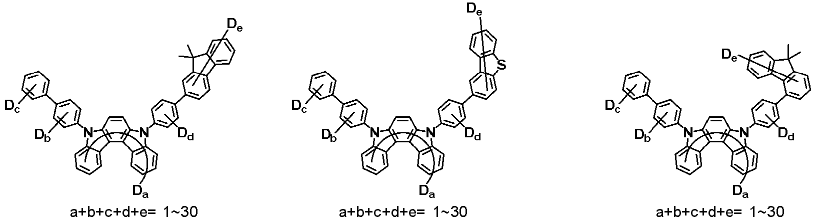 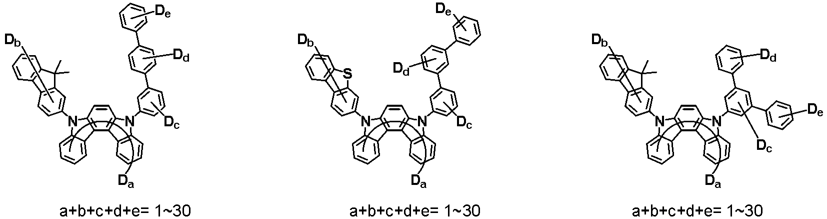 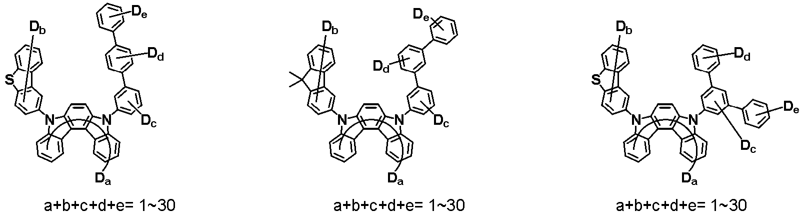 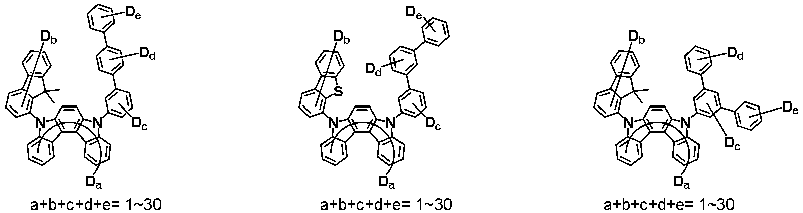 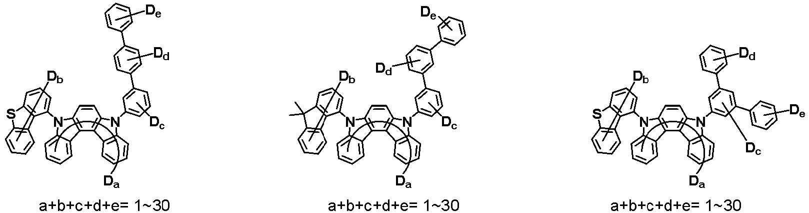 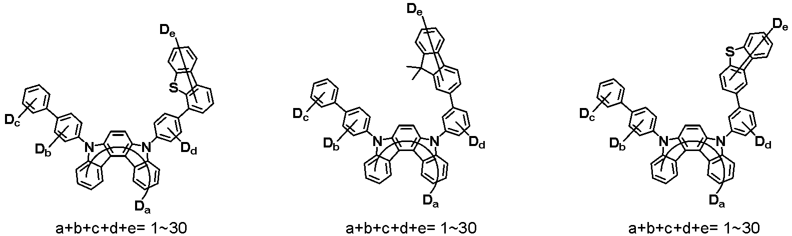 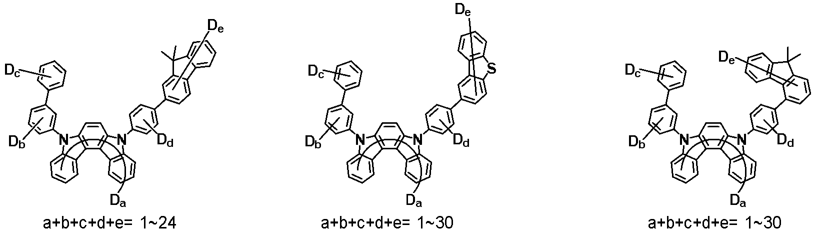 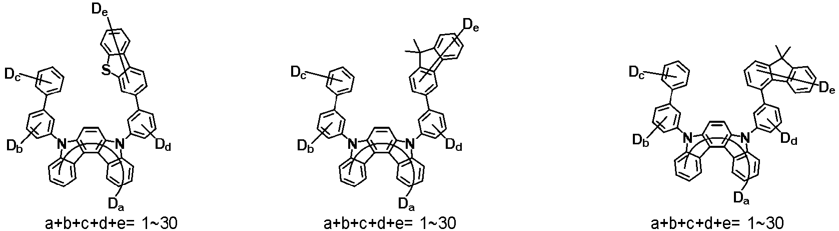 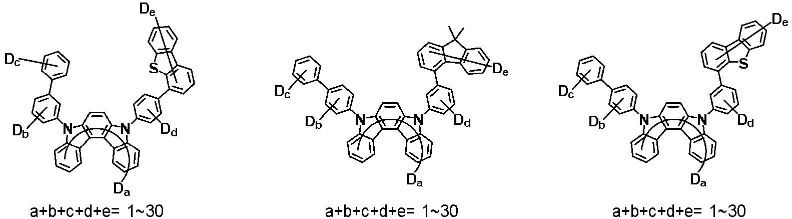 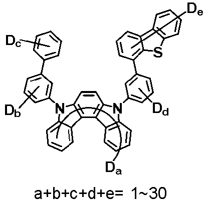 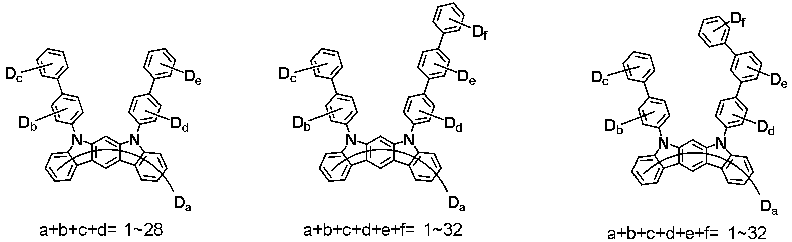 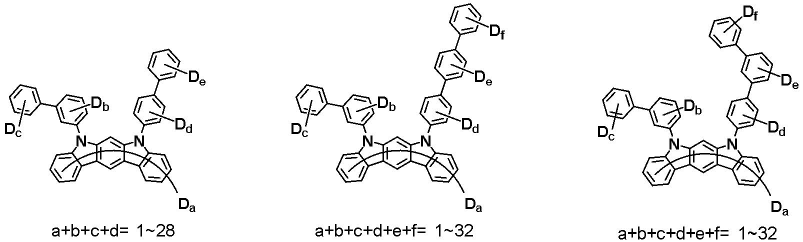 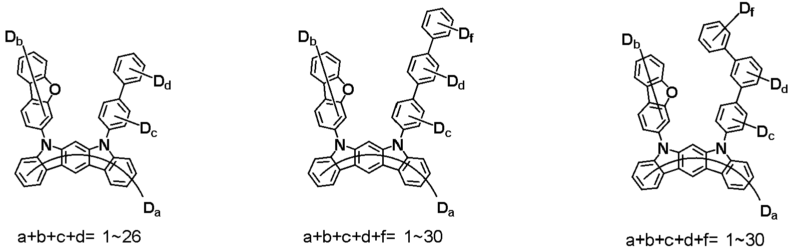 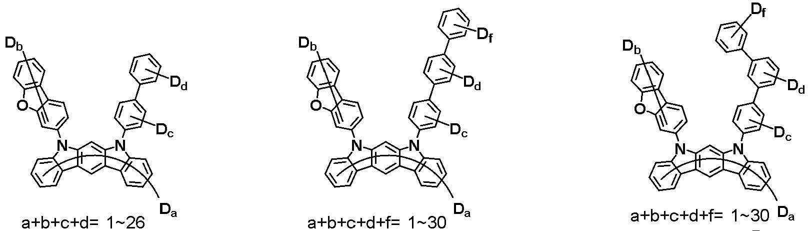 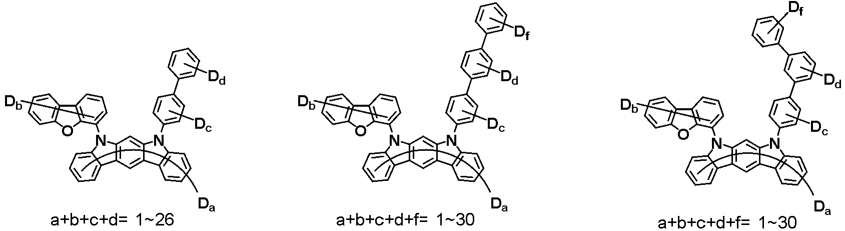 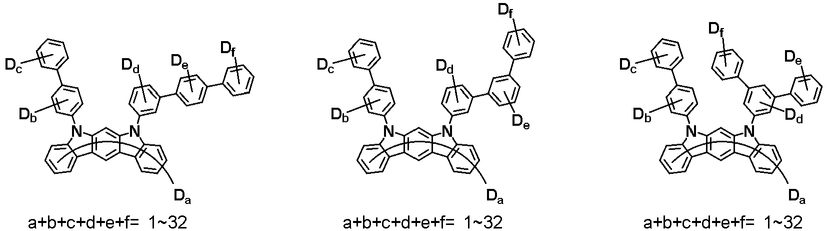 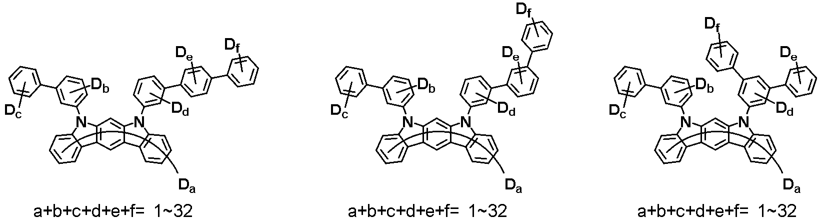 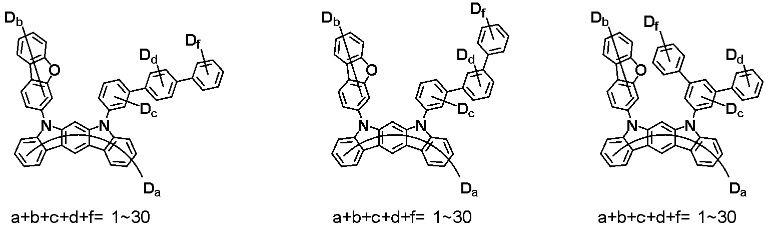 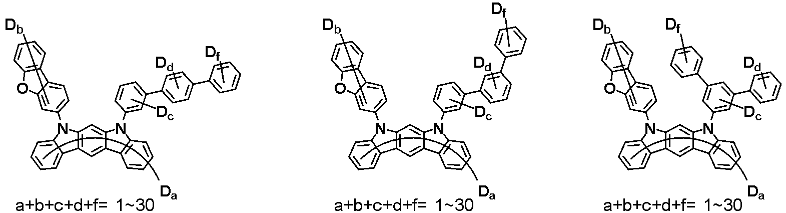 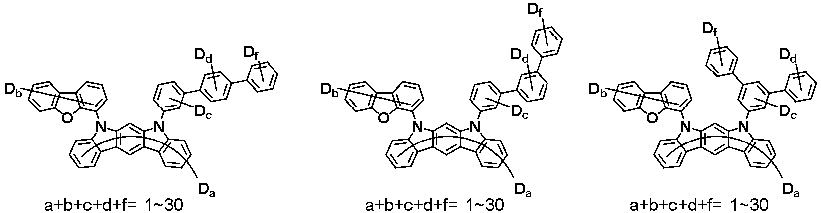 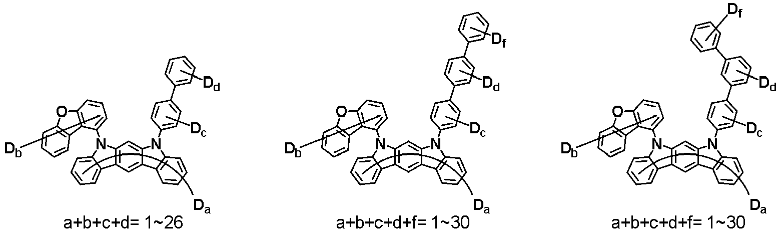 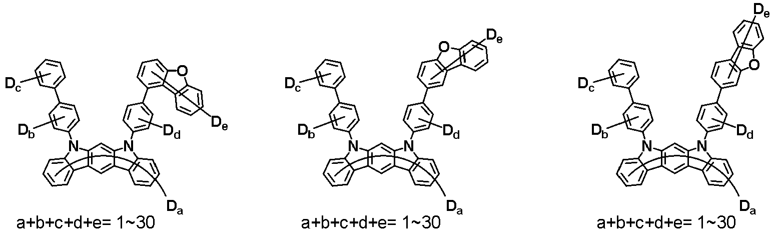 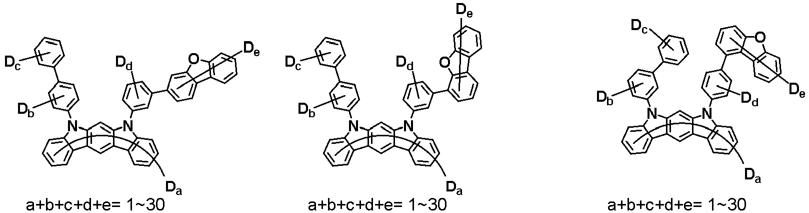 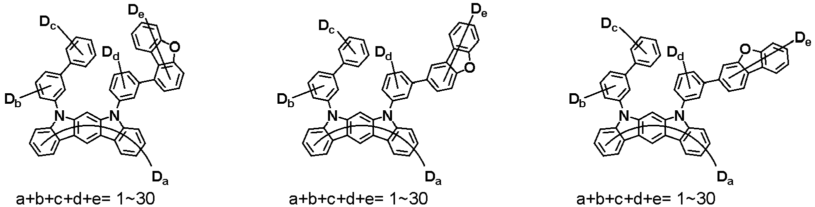 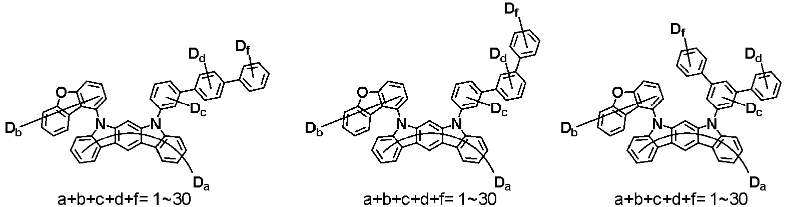 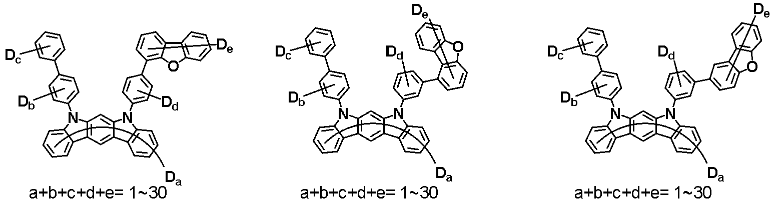 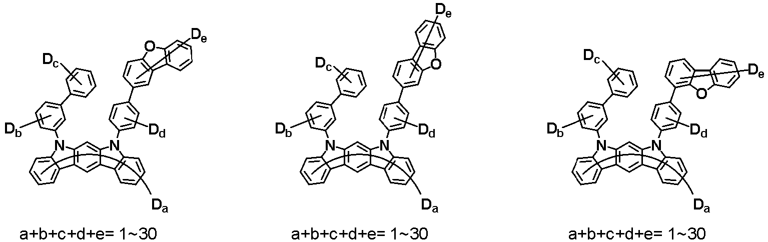 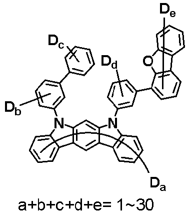 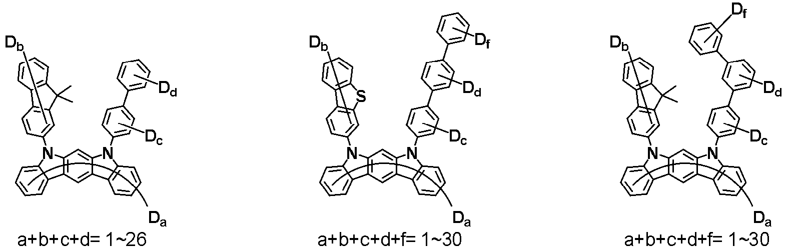 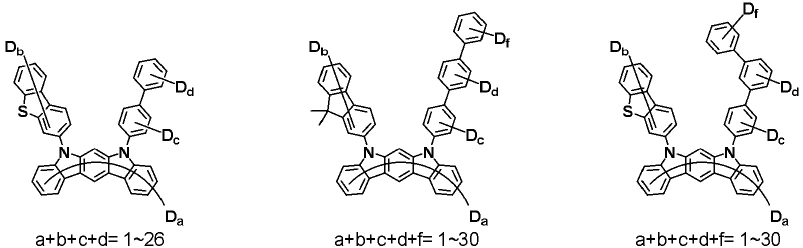 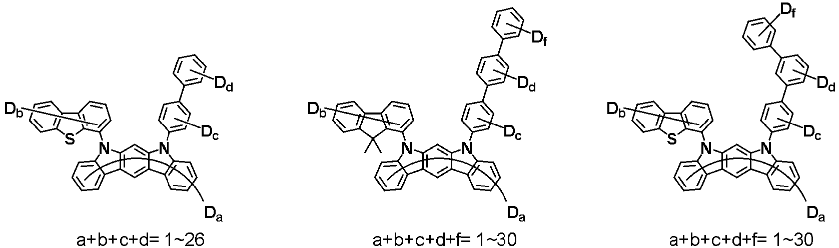 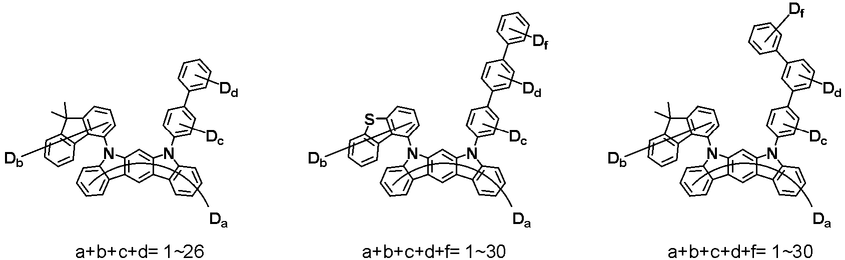 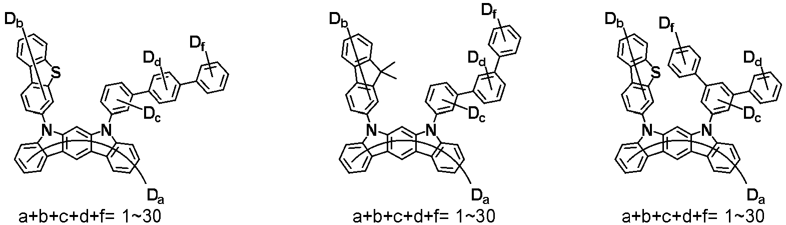 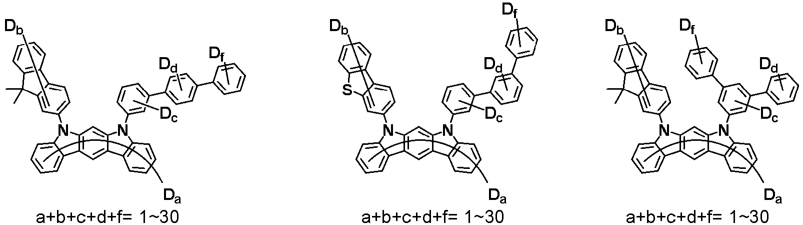 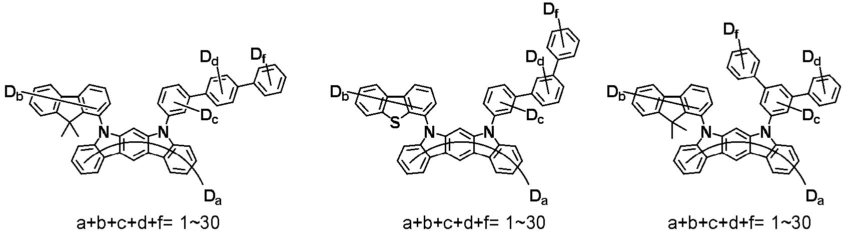 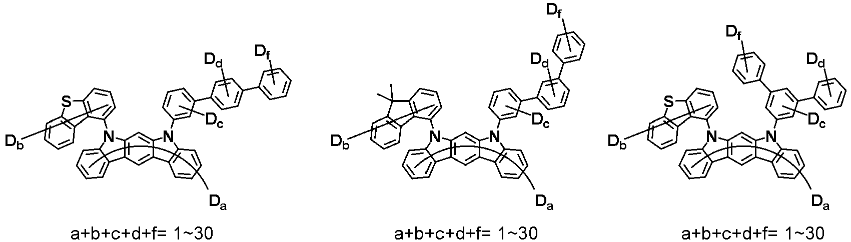 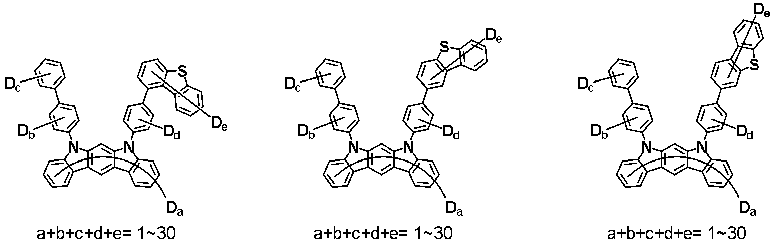 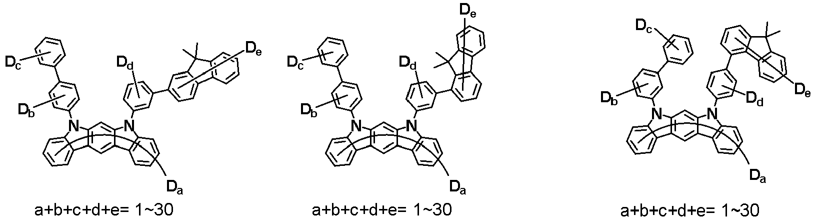 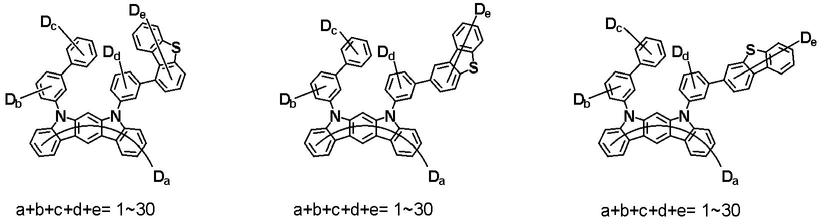 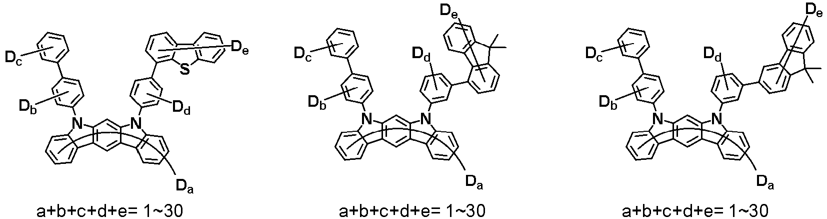 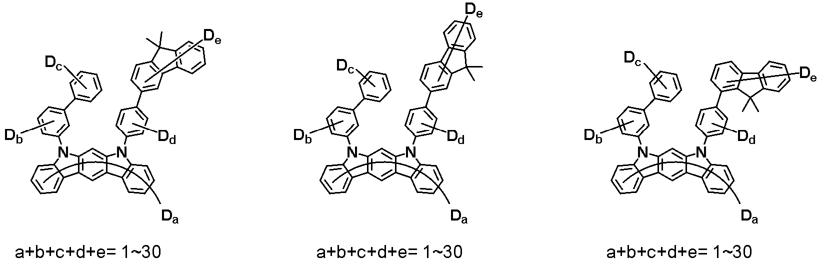 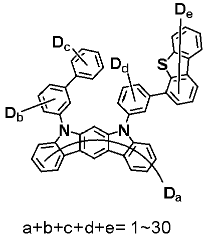 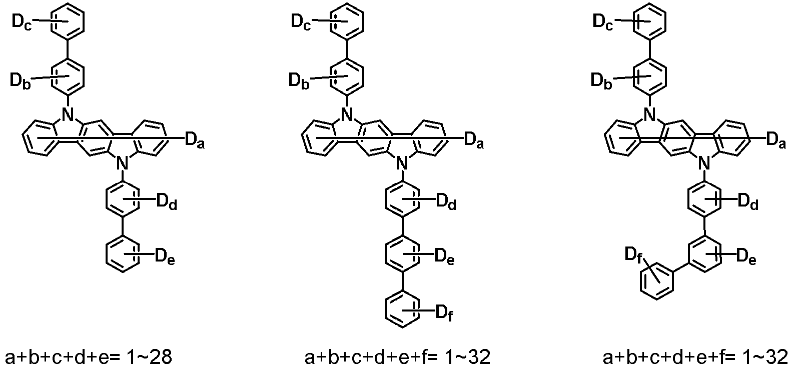 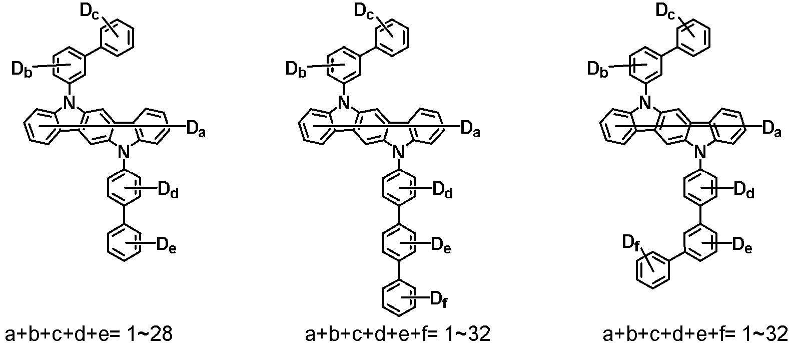 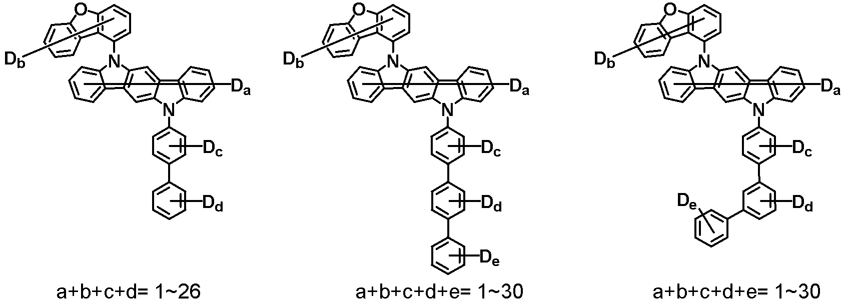 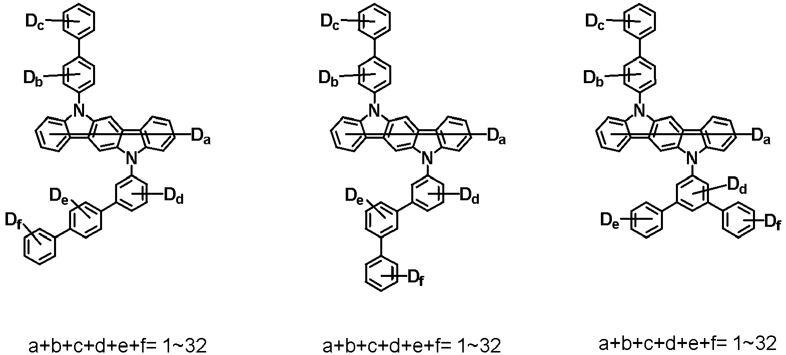 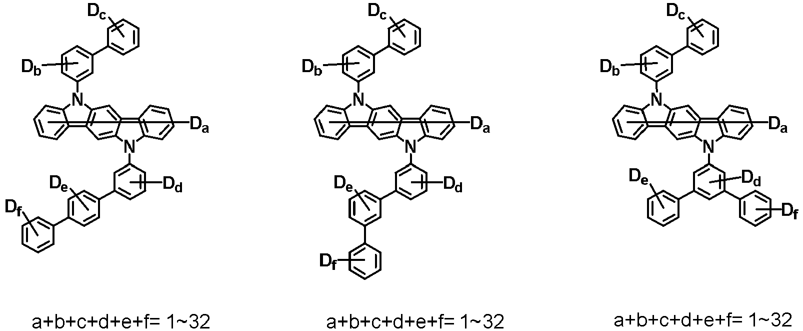 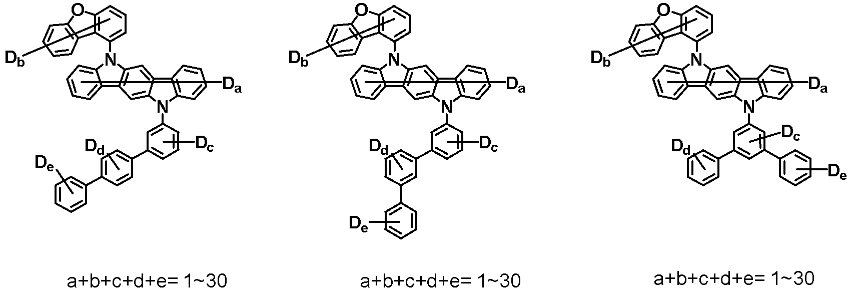 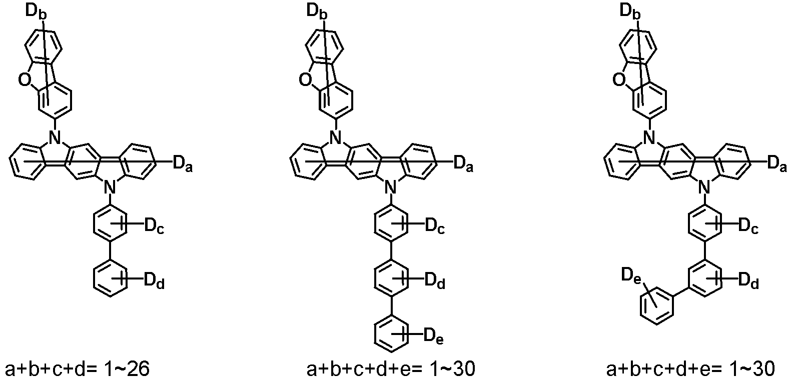 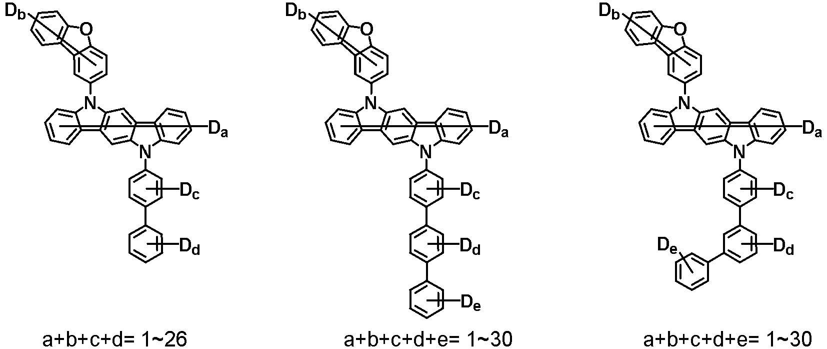 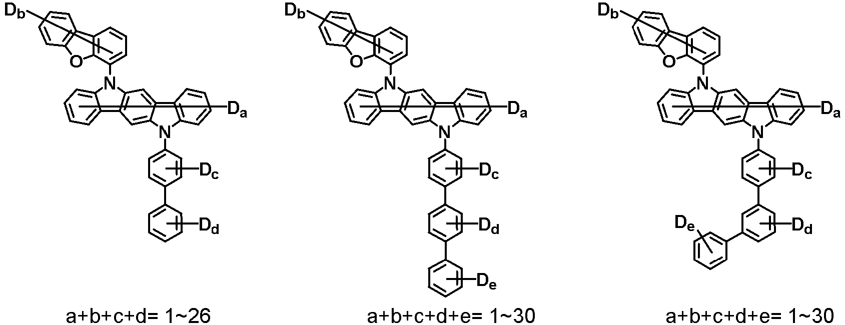 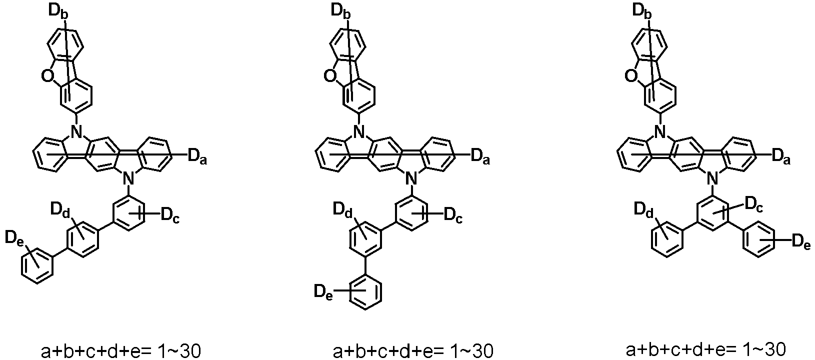 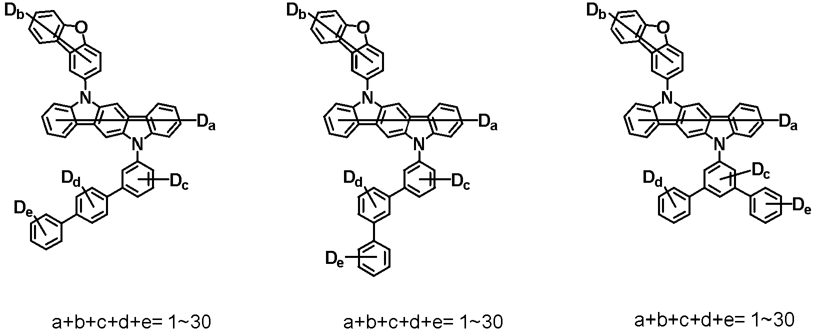 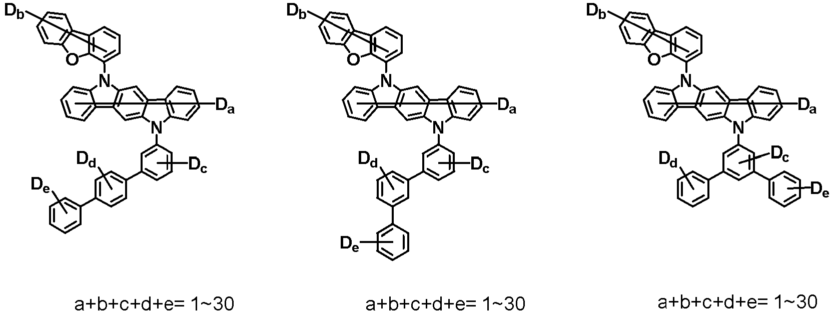 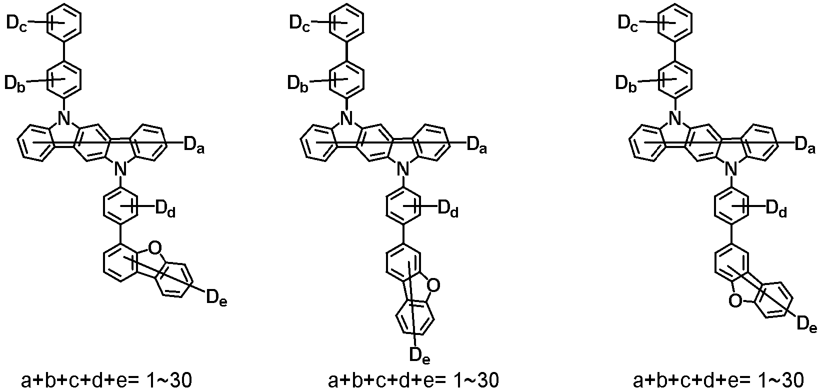 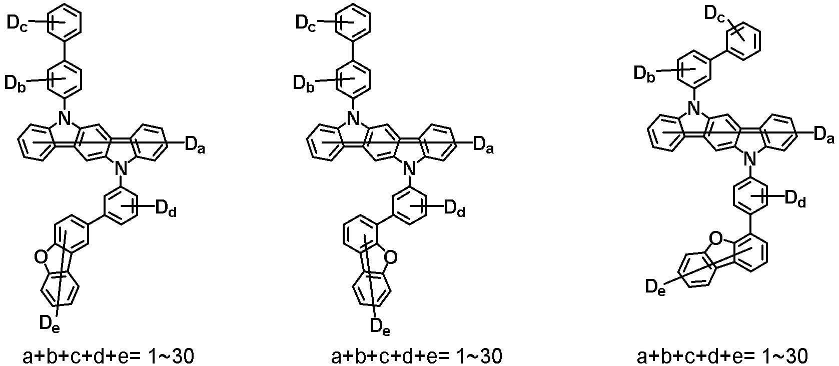 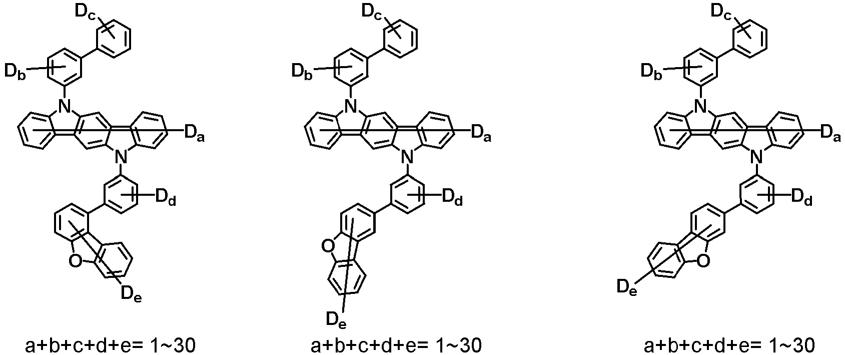 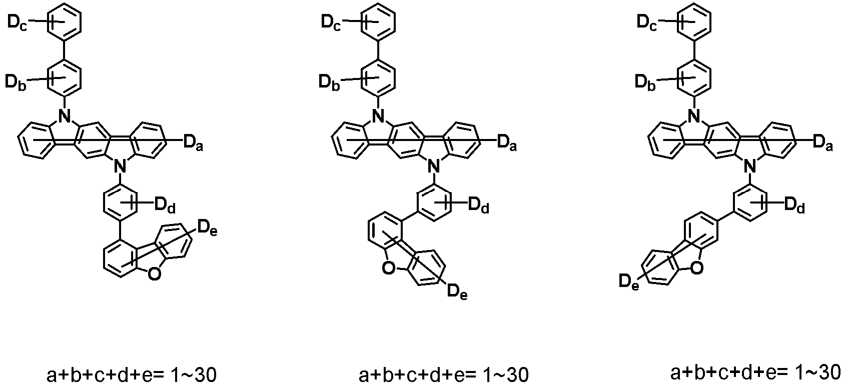 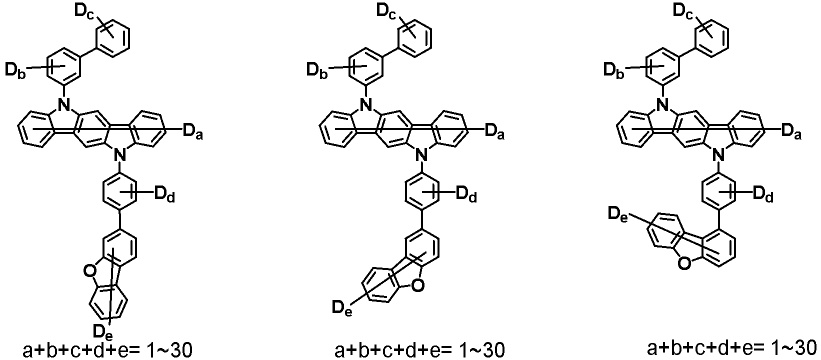 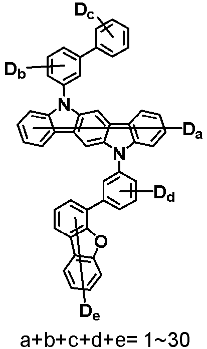 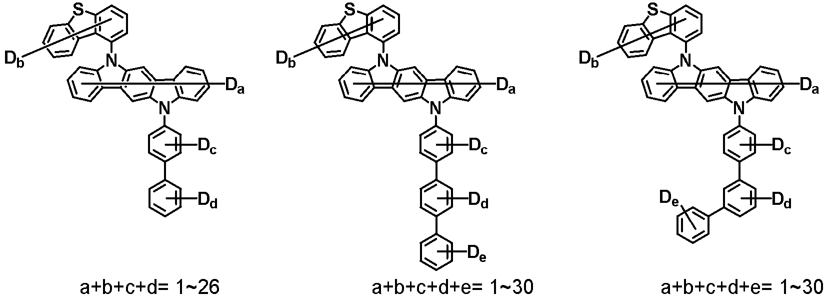 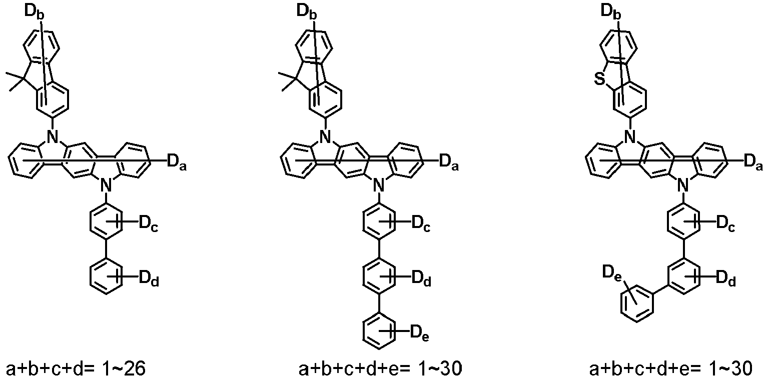 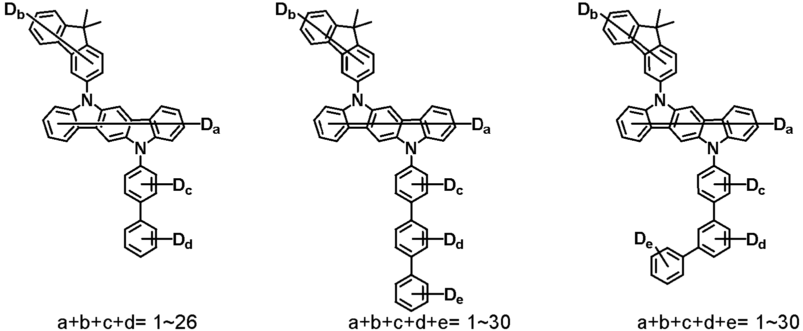 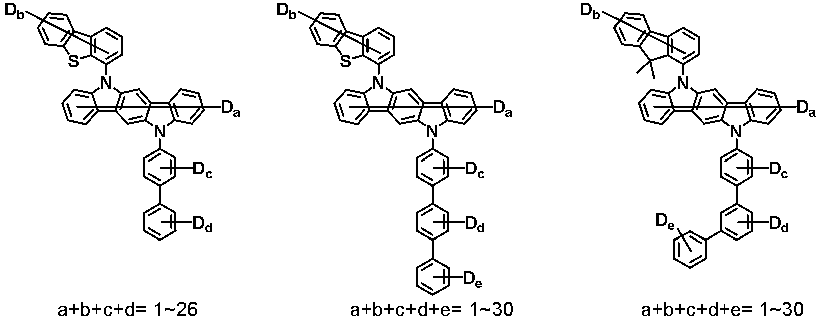 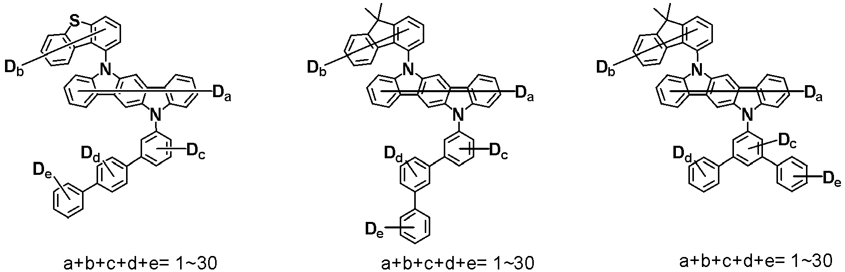 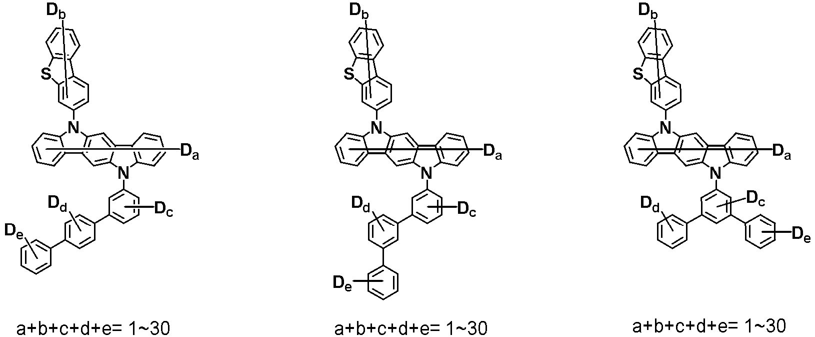 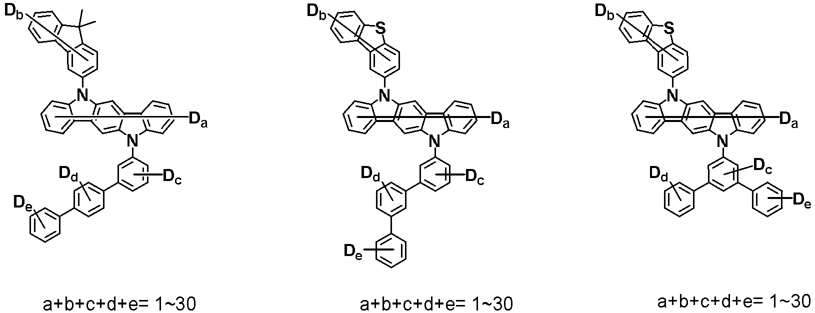 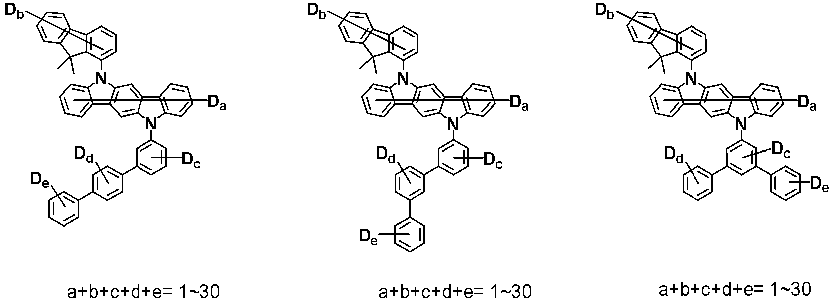 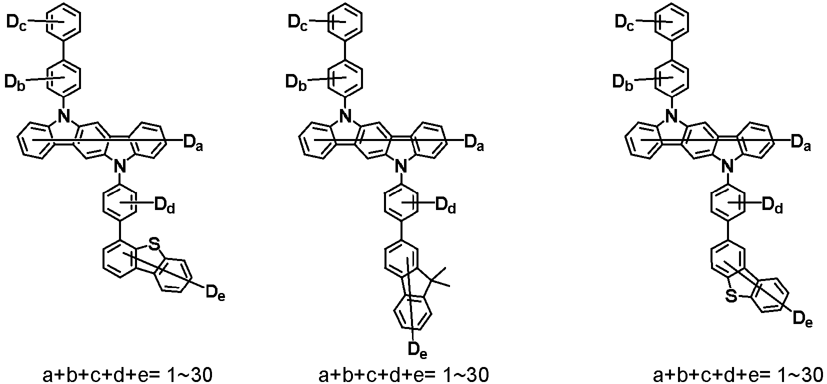 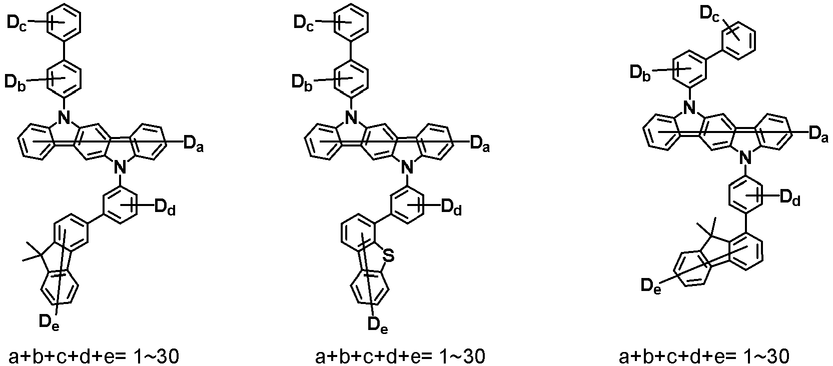 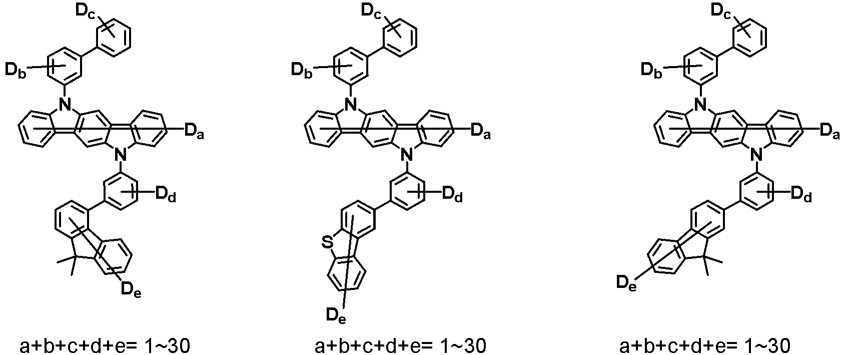 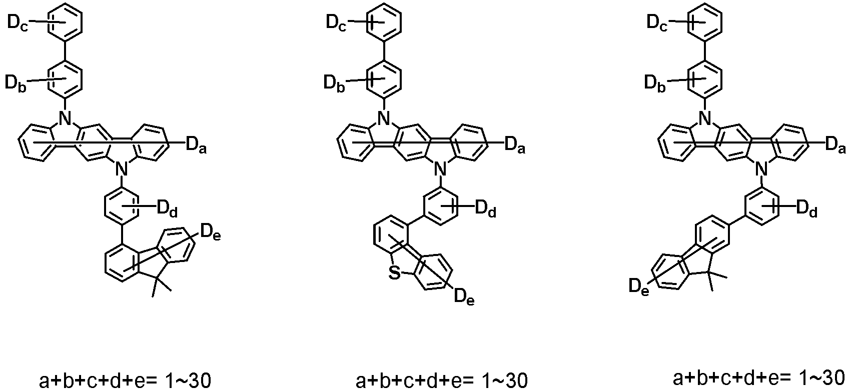 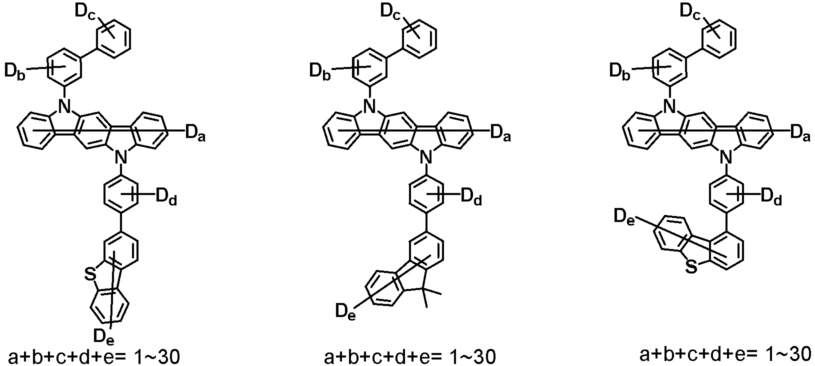 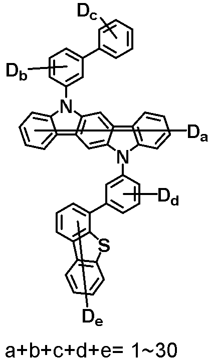 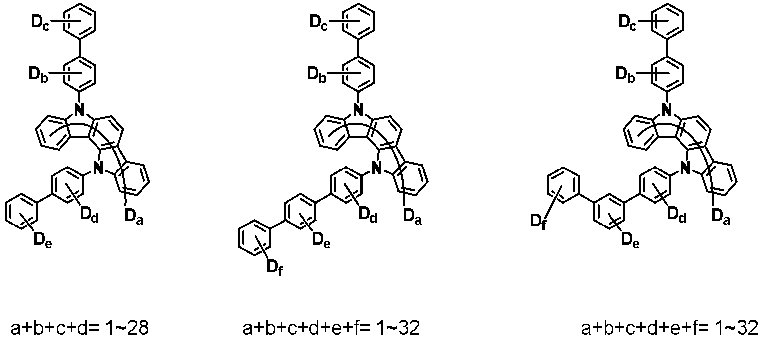 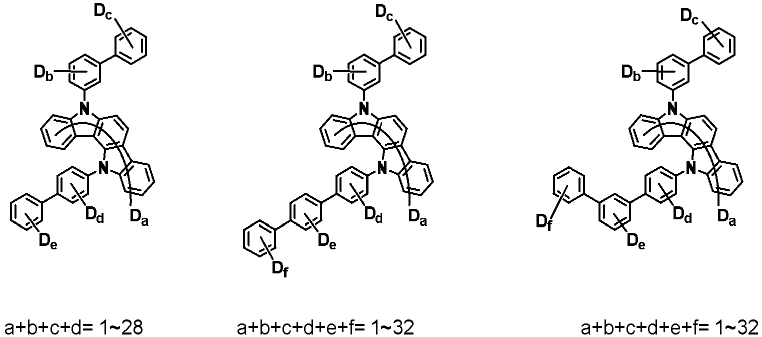 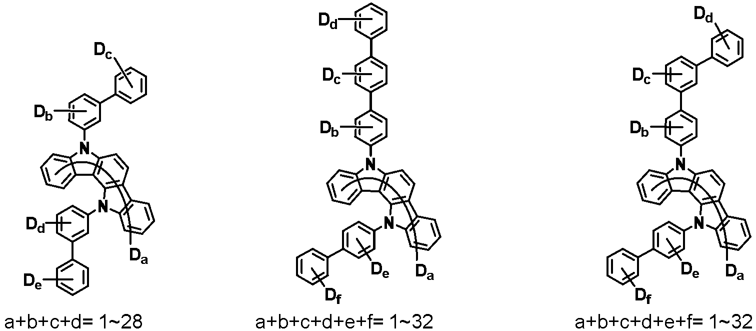 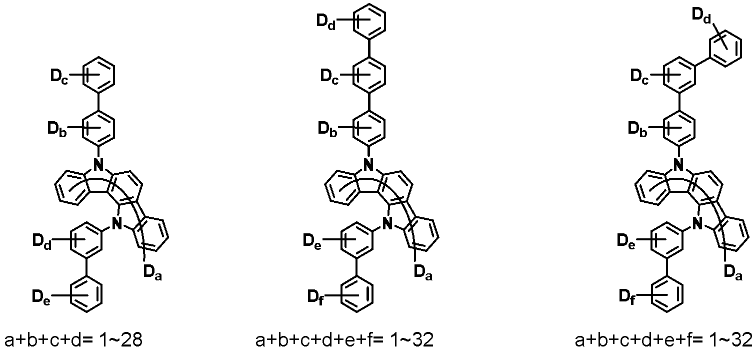 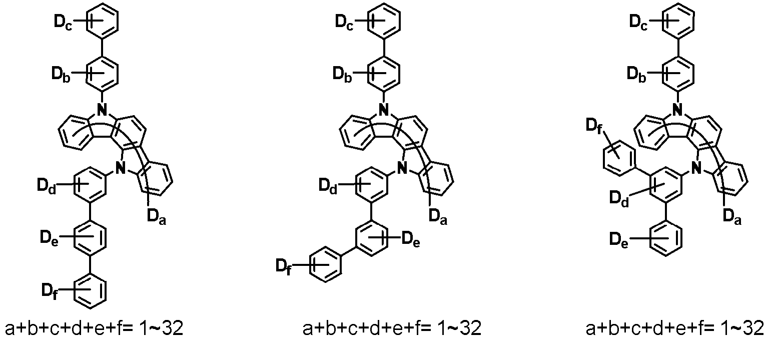 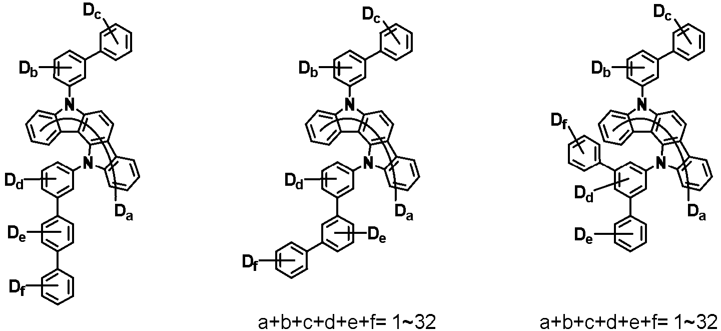 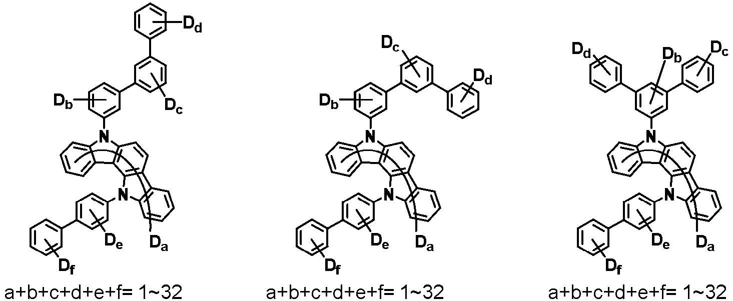 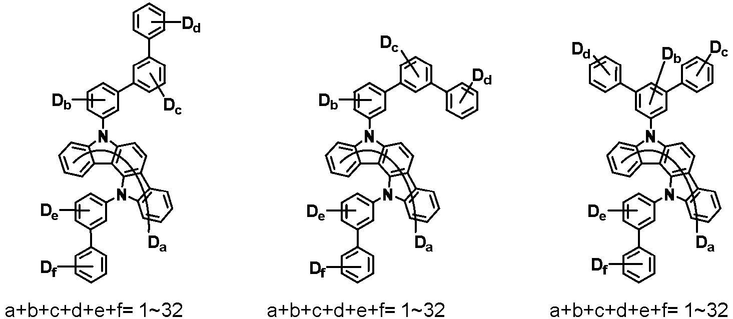 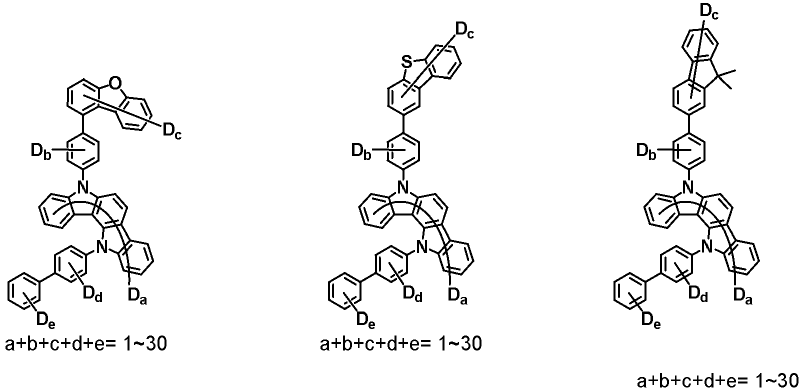 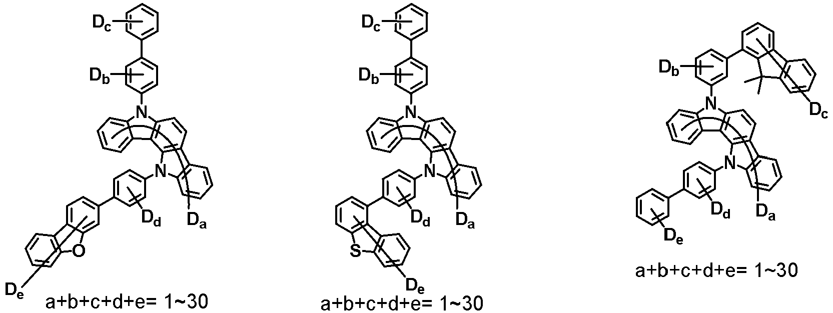 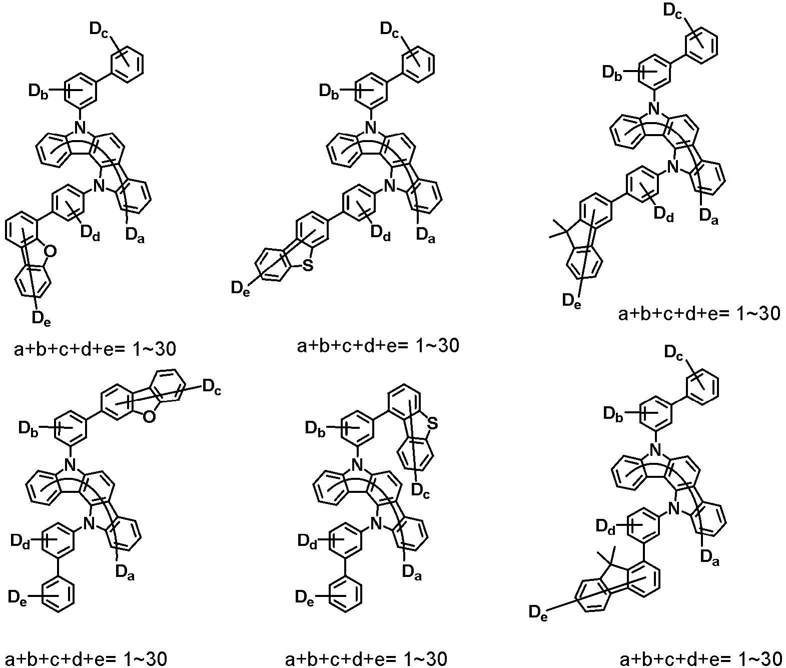 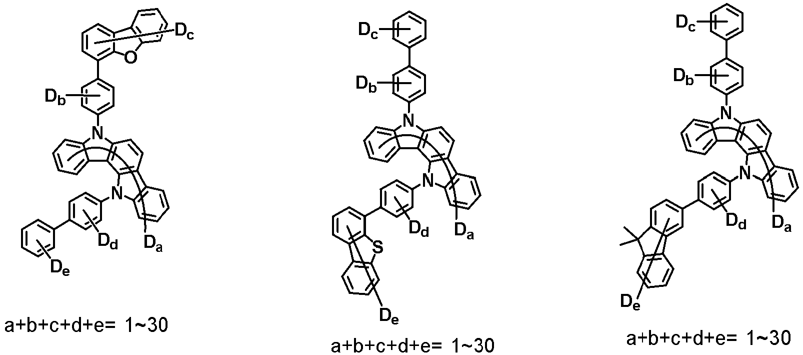 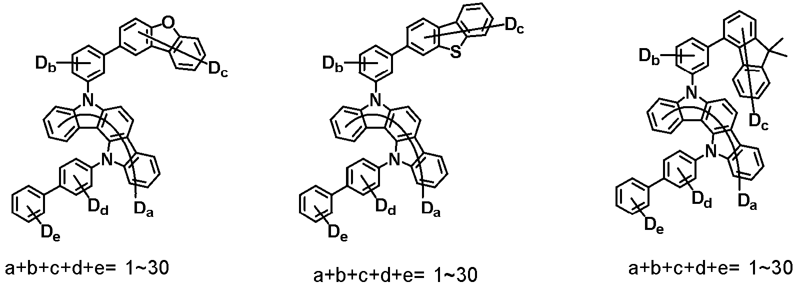 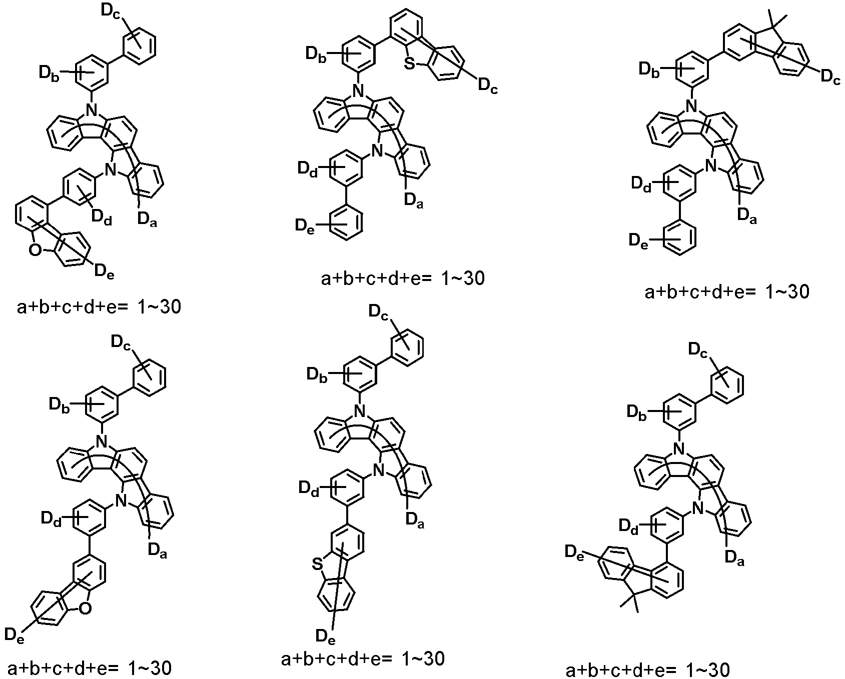 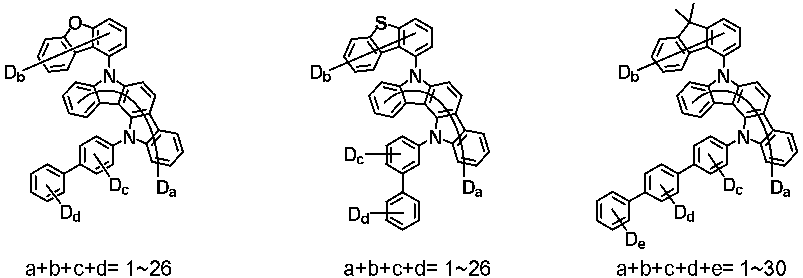 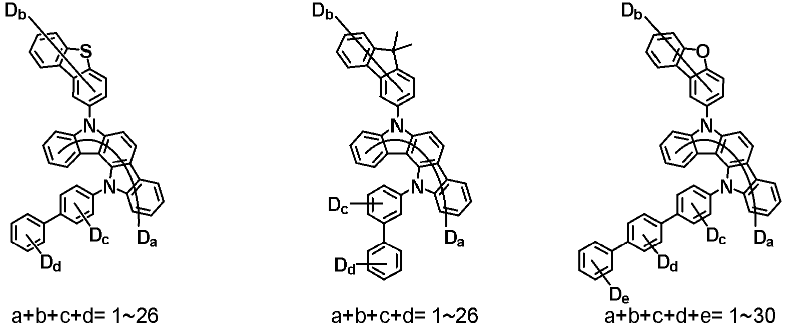 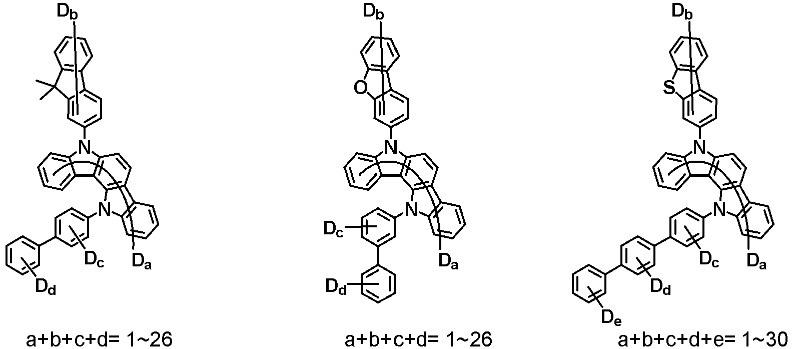 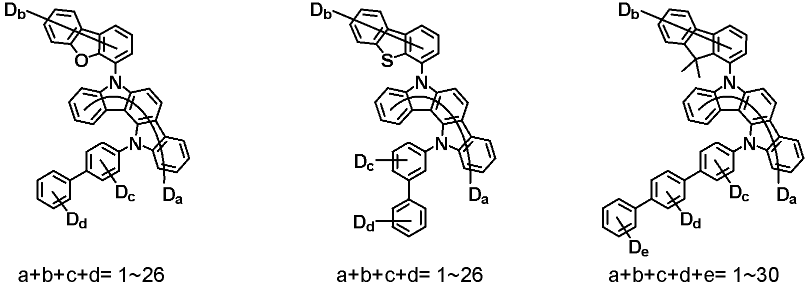 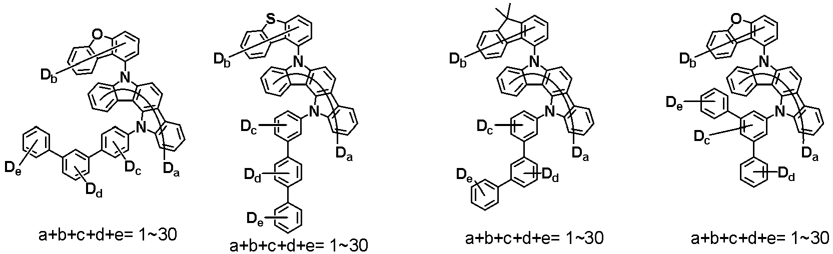 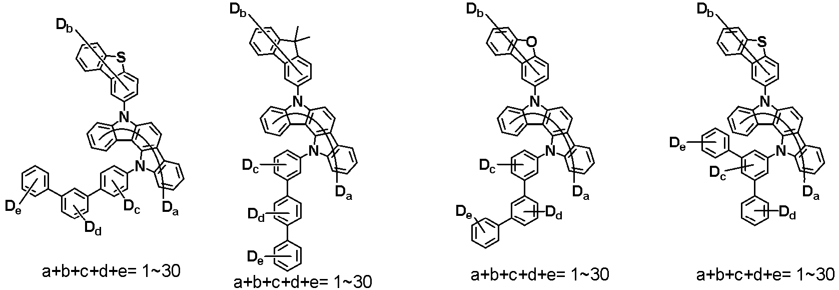 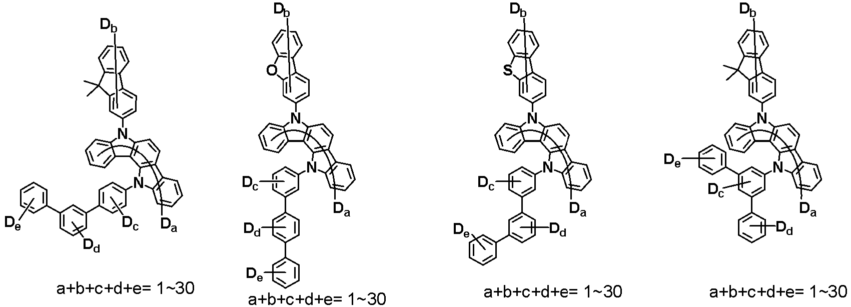 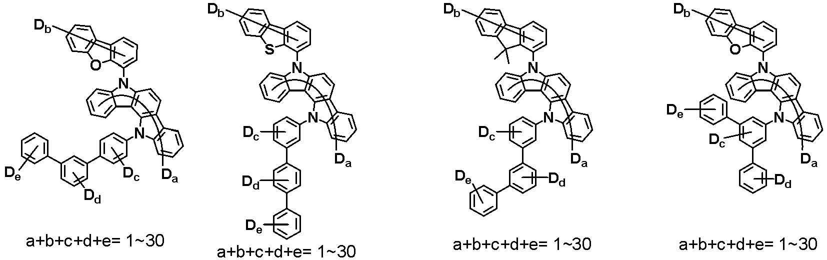 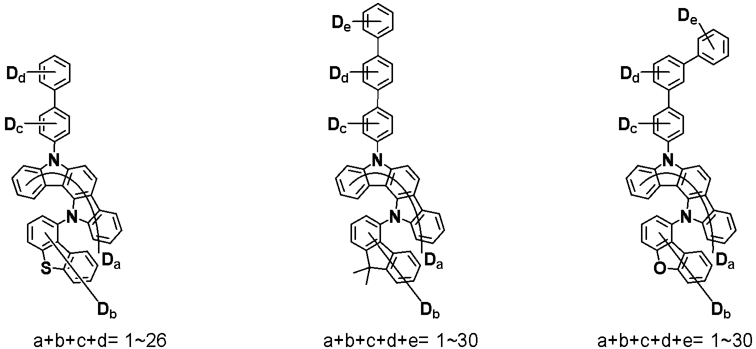 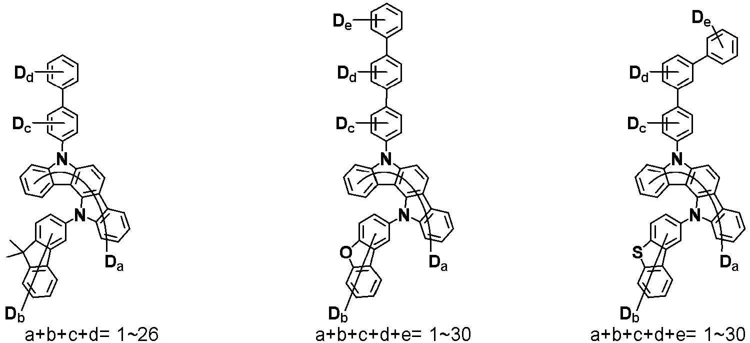 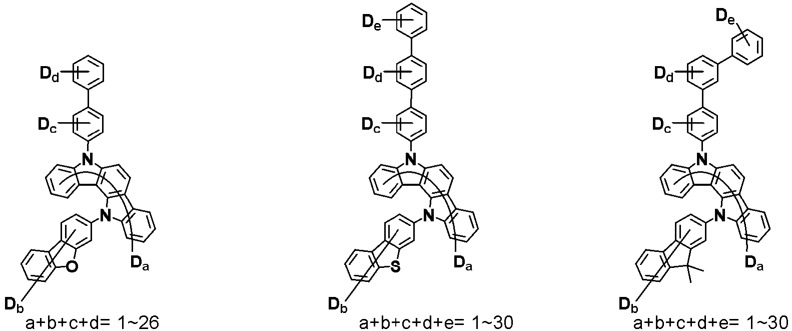 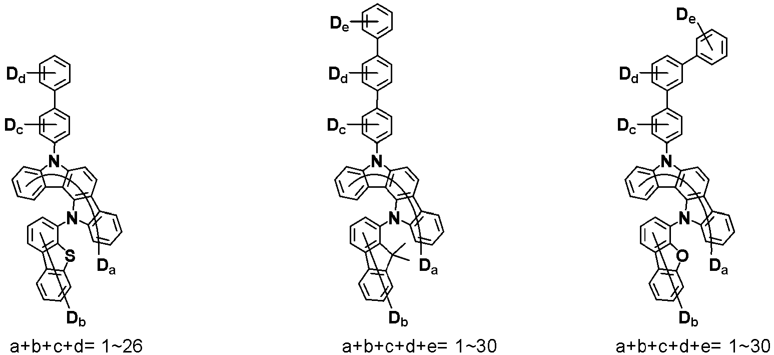 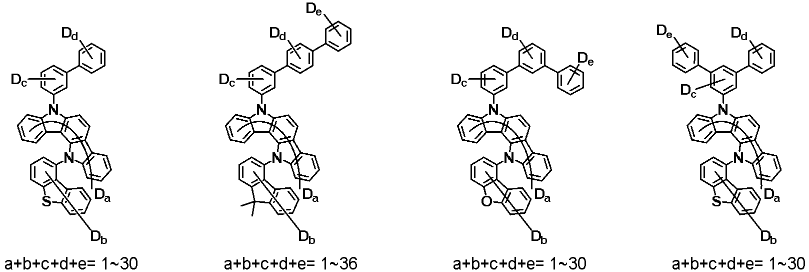 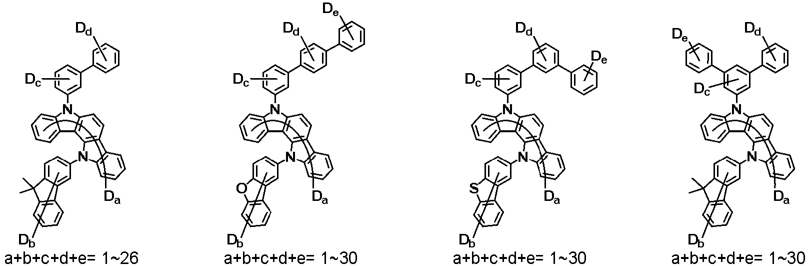 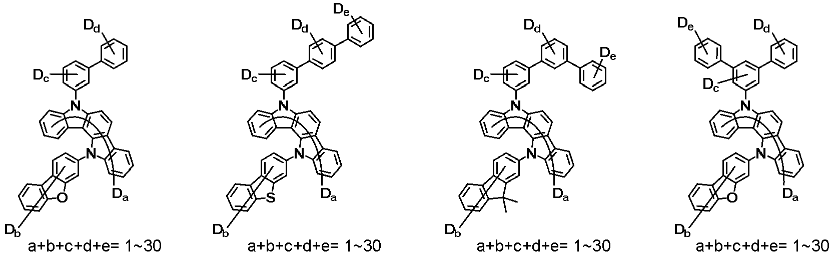 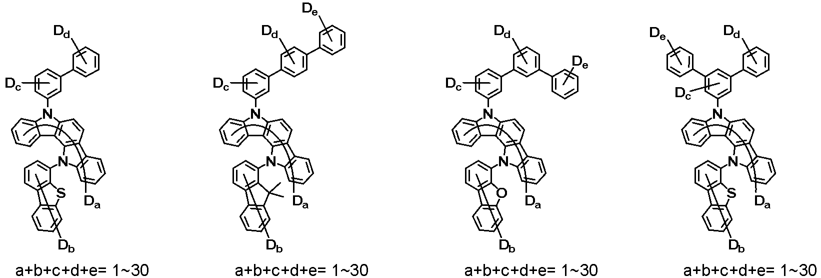 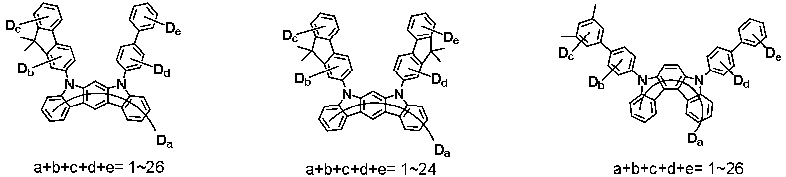 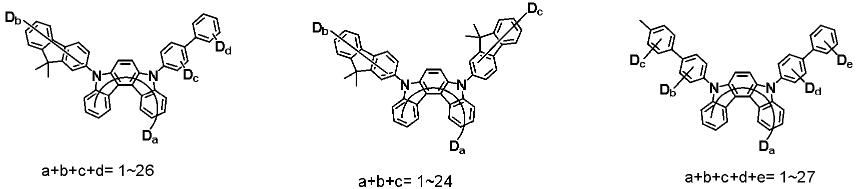
worin die in jeder chemischen Formel umfassten Methylgruppen jeweils unabhängig CH₃, CH₂D, CHD₂ oder CD₃ sind.

10. Organische lichtemittierende Vorrichtung gemäß Anspruch 1, worin:
die lichtemittierende Schicht eine organische Legierung der durch die chemische Formel 1 dargestellten Verbindung und der durch die chemische Formel 2 dargestellten Verbindung umfasst.

## Revendications

1. Dispositif électroluminescent organique comprenant :
une anode ; une cathode ; et une couche électroluminescente entre l'anode et la cathode,
dans lequel la couche électroluminescente inclut un composé représenté par la Formule chimique 1 suivante et un composé représenté par la Formule chimique 2 suivante, 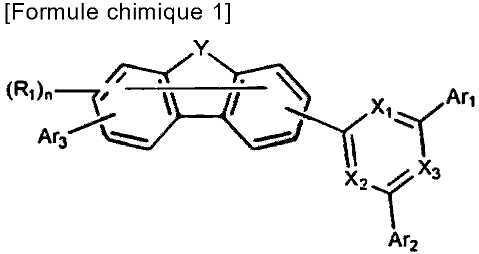
dans la Formule chimique 1,
Y est O ou S,
X₁ à X₃ sont chacun indépendamment CH ou N, à condition qu'au moins un parmi X₁ à X₃ soit N,
Ar₁ et Ar₂ sont chacun indépendamment un aryle en C₆₋₆₀ substitué ou non substitué ; ou un hétéroaryle en C₂₋₆₀ substitué ou non substitué contenant un ou plusieurs sélectionnés dans le groupe consistant en N, O et S,
Ar₃ est un aryle en C₆₋₆₀ substitué ou non substitué,
n est un nombre entier de 1 à 6, et
chaque R₁ est indépendamment hydrogène ; ou deutérium ; 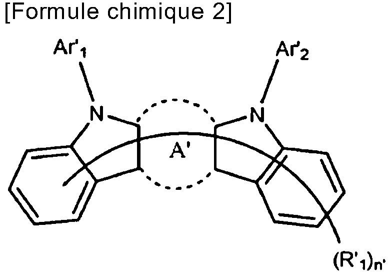
dans la Formule chimique 2,
A' est un cycle benzène condensé avec deux cycles pentagonaux adjacents,
n'est un nombre entier de 1 à 10,
R'₁ est hydrogène ; deutérium ; un aryle en C₆₋₆₀ substitué ou non substitué ; ou un hétéroaryle en C₂₋₆₀ substitué ou non substitué contenant un ou plusieurs sélectionnés dans le groupe consistant en N, O et S, et
Ar'₁ et Ar'₂ sont chacun indépendamment un aryle en C₆₋₆₀ substitué ou non substitué ; ou un hétéroaryle en C₂₋₆₀ substitué ou non substitué contenant un ou plusieurs hétéroatomes sélectionnés dans le groupe consistant en N, O et S,
à condition qu'au moins un des R'₁ soit deutérium ; et/ou qu'au moins un parmi Ar'₁ et Ar'₂ soit substitué par au moins un deutérium.

2. Dispositif électroluminescent organique selon la revendication 1, dans lequel :
au moins deux parmi X₁ à X₃ sont N.

3. Dispositif électroluminescent organique selon la revendication 1, dans lequel :
Ar₁ et Ar₂ sont chacun indépendamment phényle ; phényle substitué par 5 deutériums ; biphénylyle ; biphénylyle substitué par 5 deutériums ; terphénylyle ; phénanthrényle ; carbazolyle ; carbazolyle substitué par 6 deutériums ; dibenzofuranyle ; dibenzothiophényle ; ou triphénylényle.

4. Dispositif électroluminescent organique selon la revendication 1, dans lequel :
Ar₁ est phényle ; phényle substitué par 5 deutériums ; biphénylyle ; biphénylyle substitué par 5 deutériums ; terphénylyle ; terphénylyle substitué par 5 deutériums ; terphénylyle substitué par un phényle ; naphtyle ; naphtylphényle ; phénanthrényle ; triphénylényle ; triphénylényle substitué par 9 deutériums ; triphénylénylphényle ; 9,9-diméthylfluorényle ; ou 9,9'-spirobifluorényle.

5. Dispositif électroluminescent organique selon la revendication 1, dans lequel :
le composé représenté par la Formule chimique 1 est un quelconque sélectionné dans le groupe consistant en :

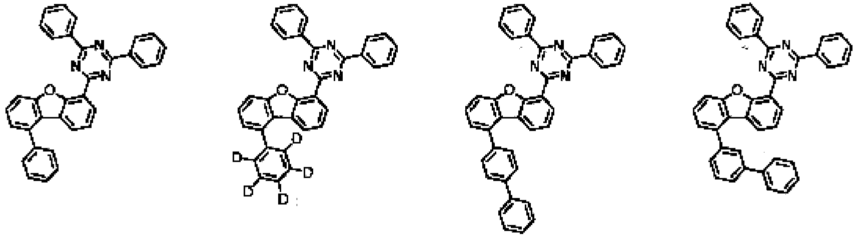

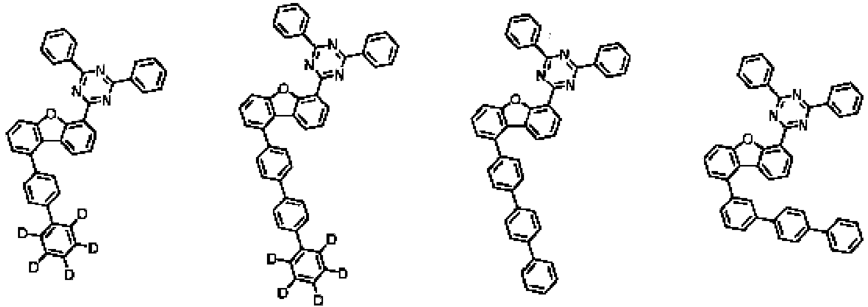

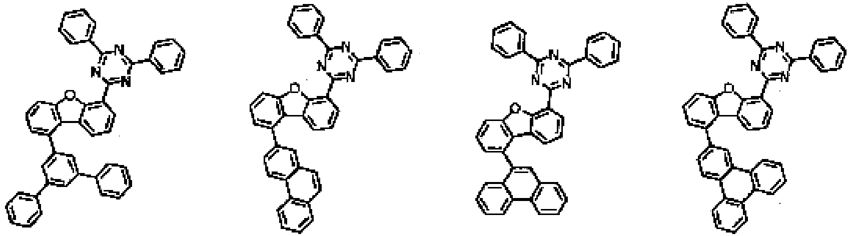

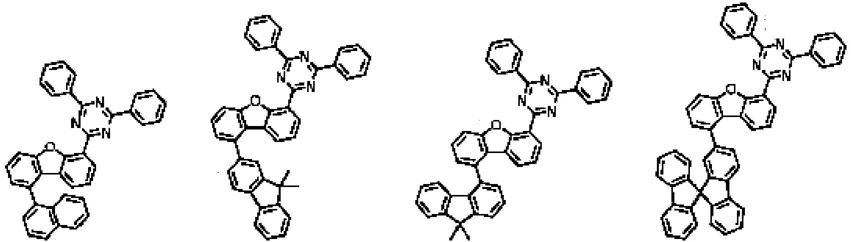

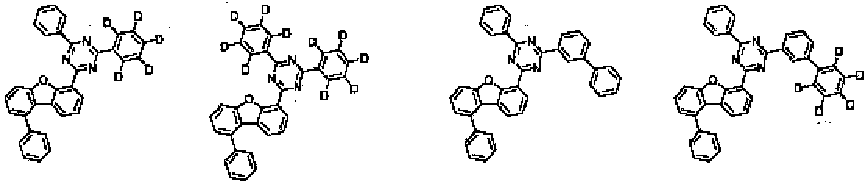

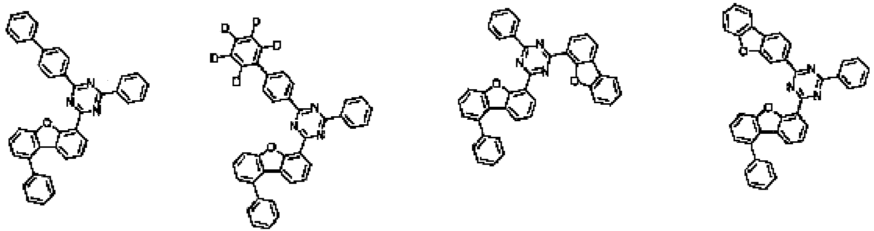

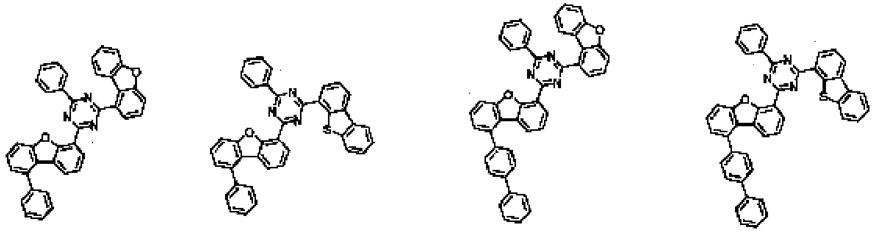

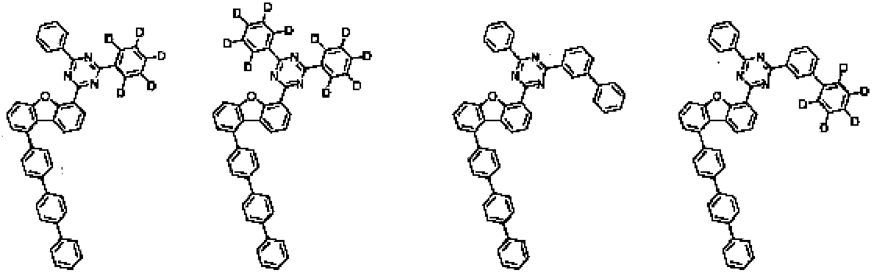

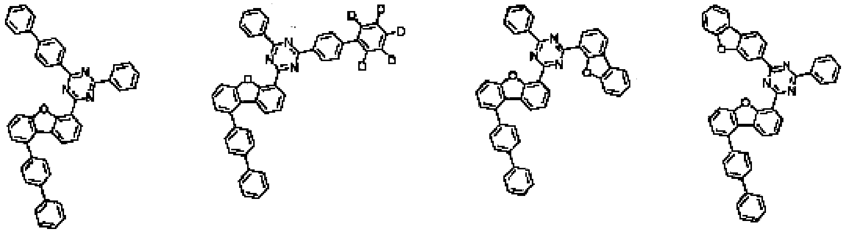

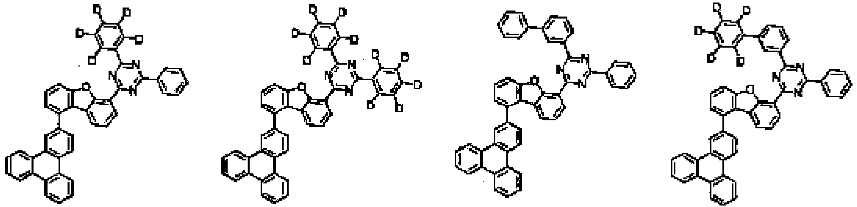

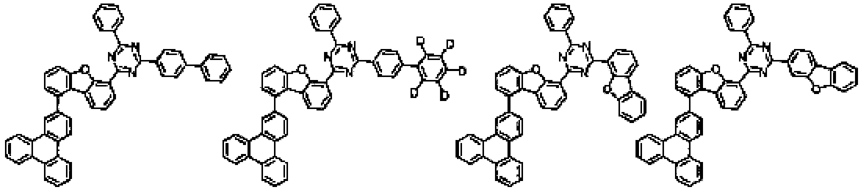

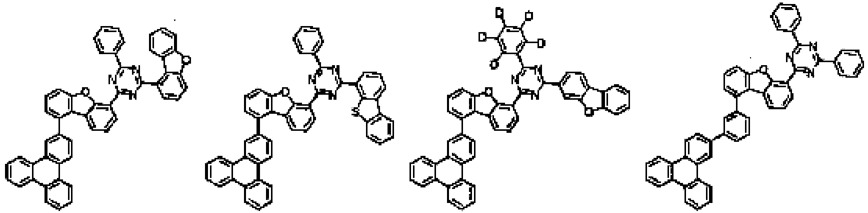

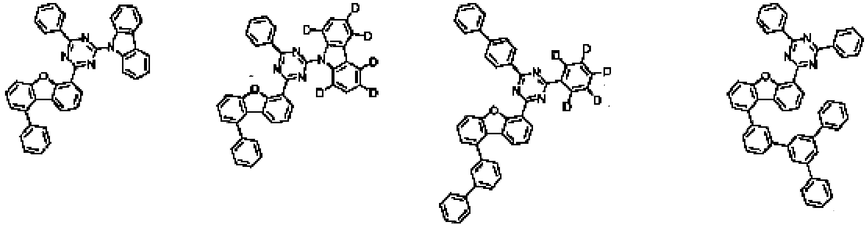

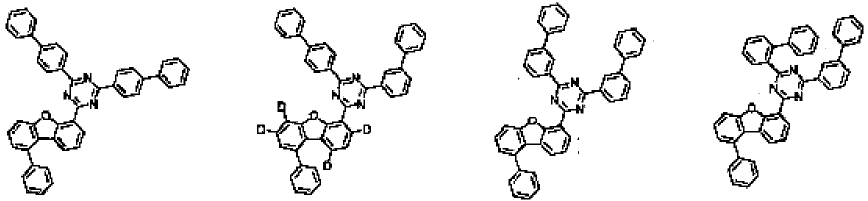

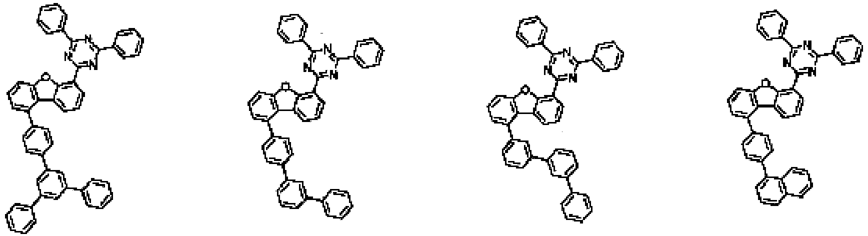

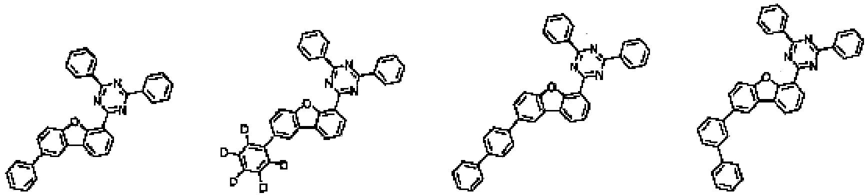

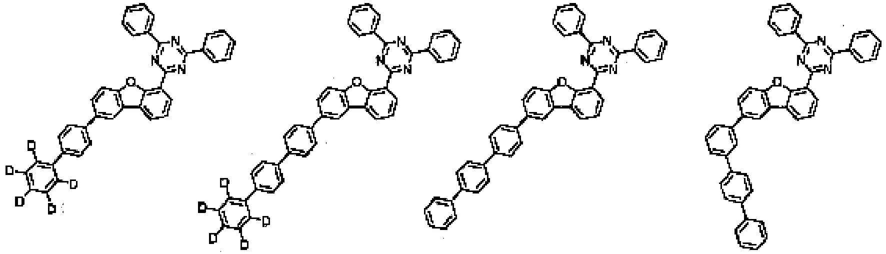

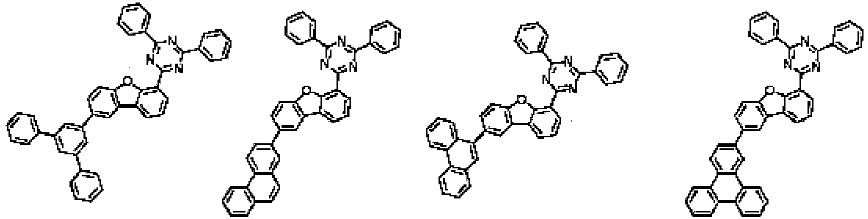

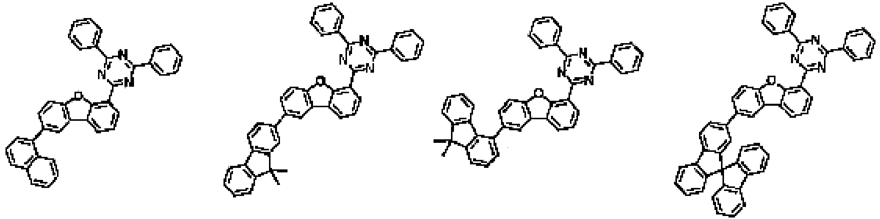

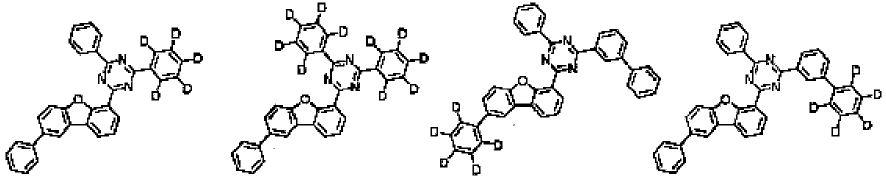

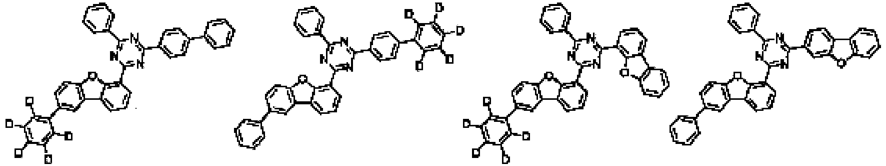

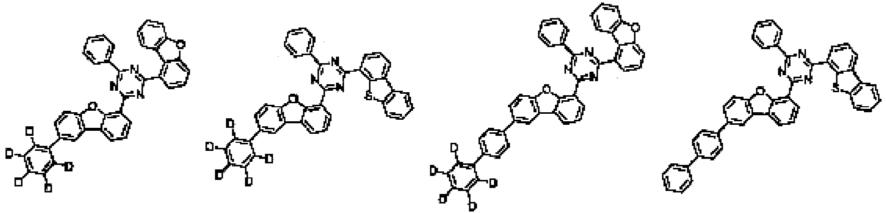

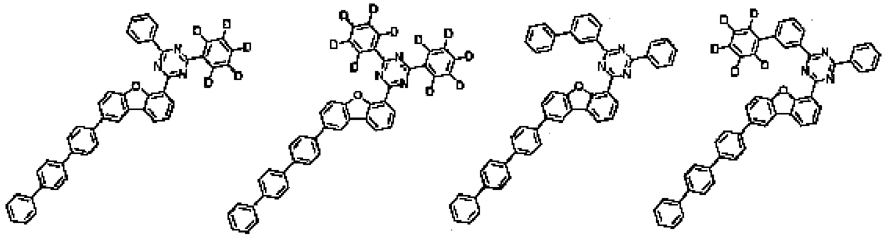

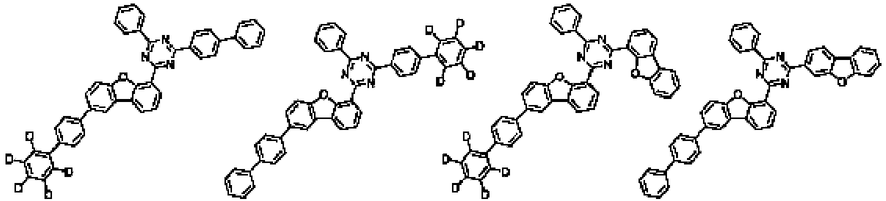

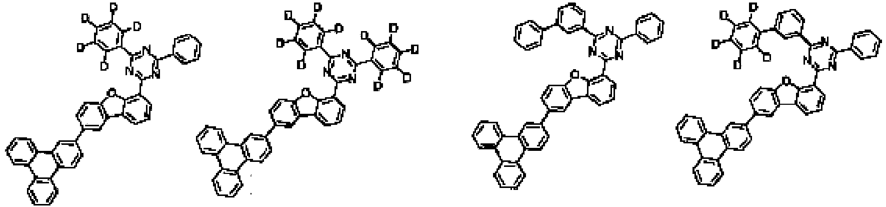

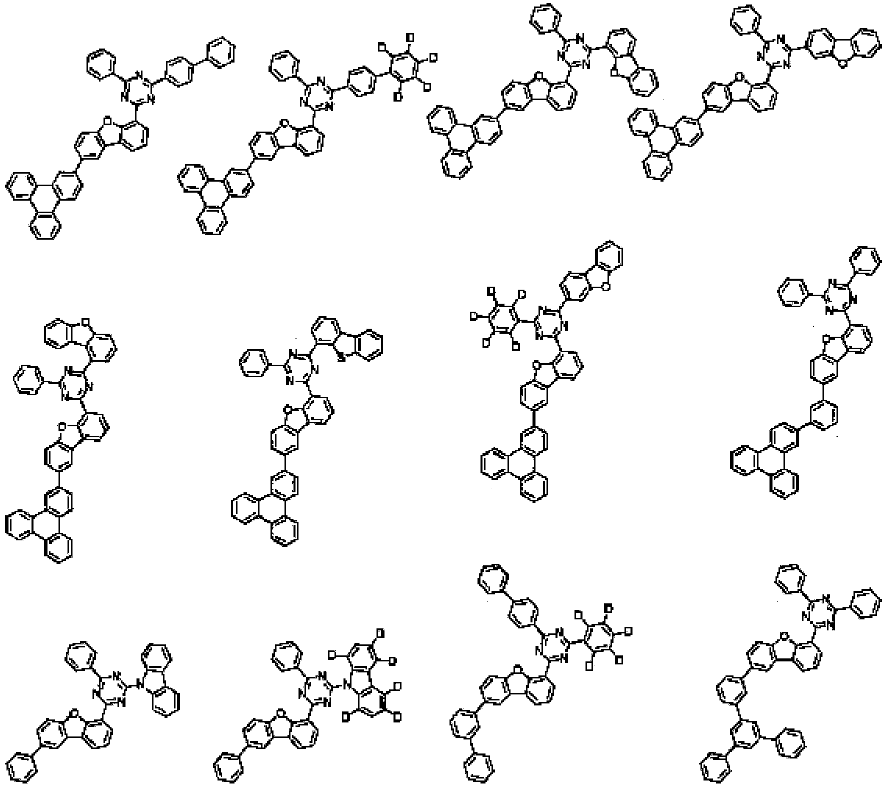

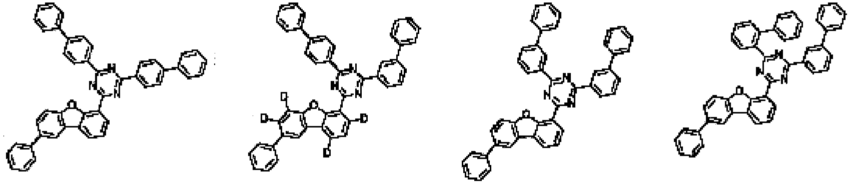

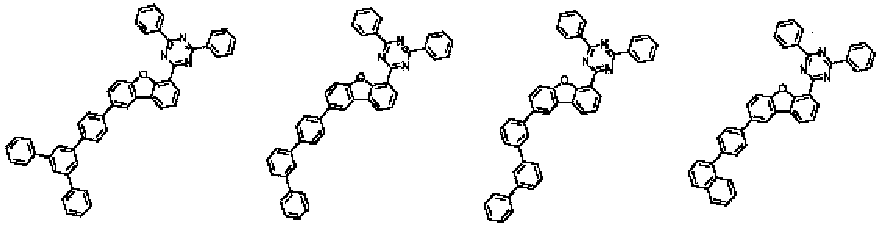

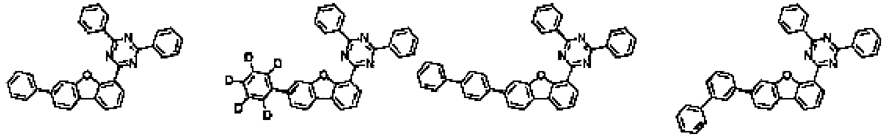

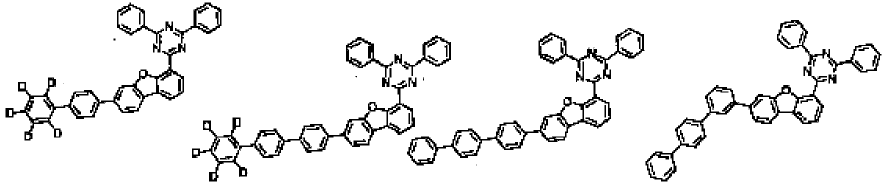

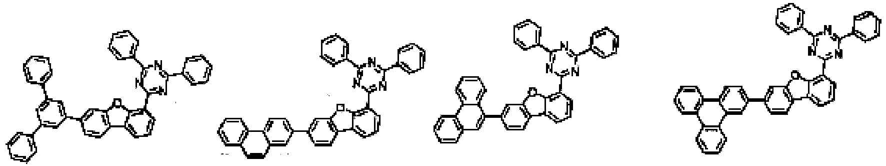

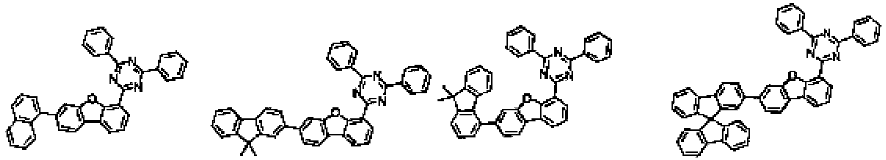

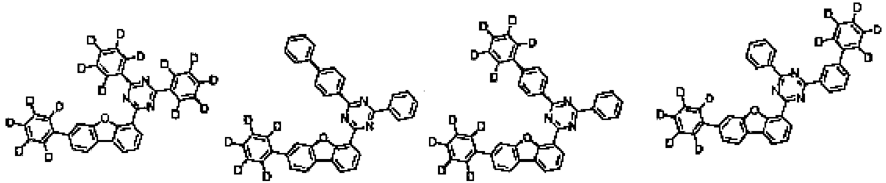

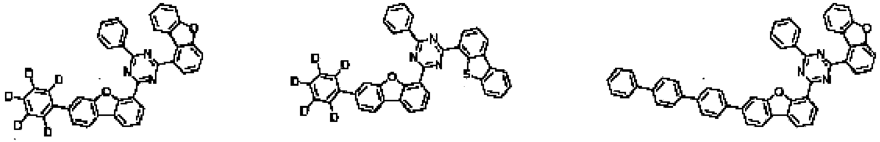

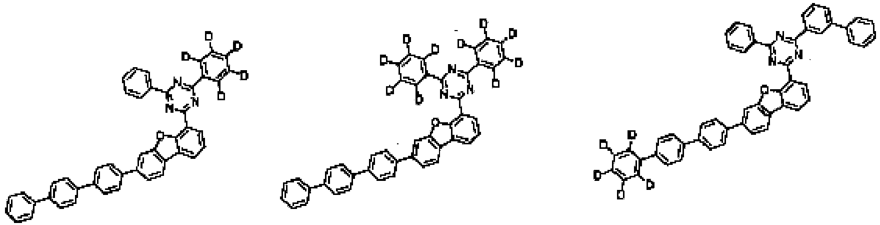

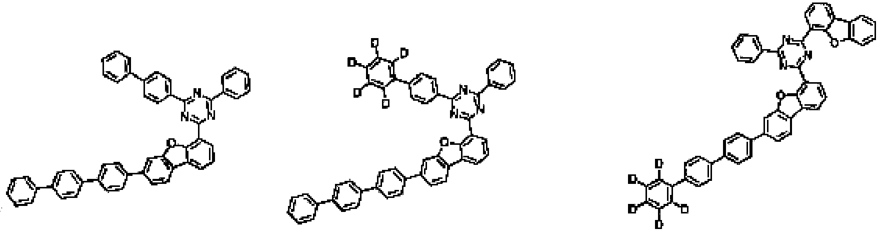

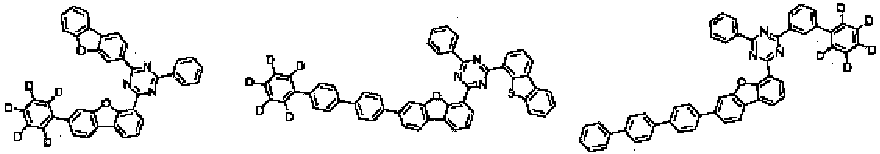

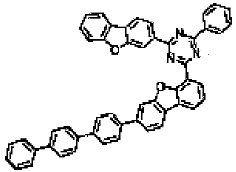

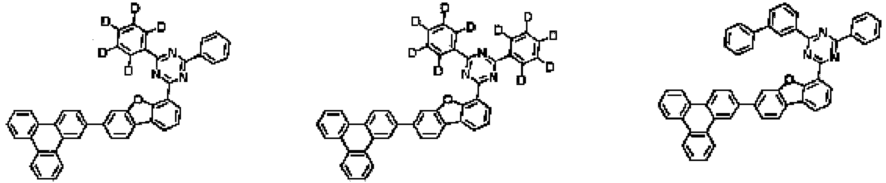

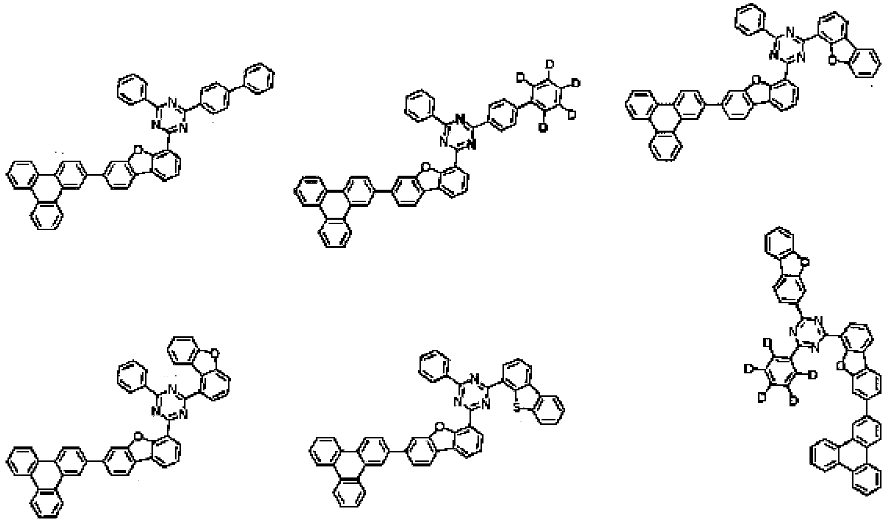

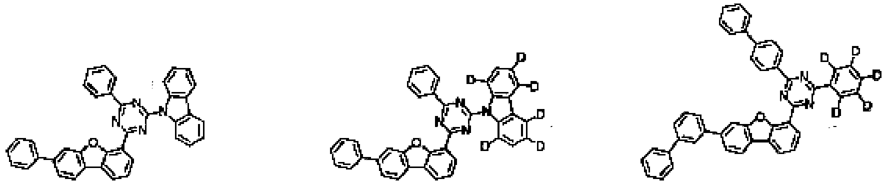

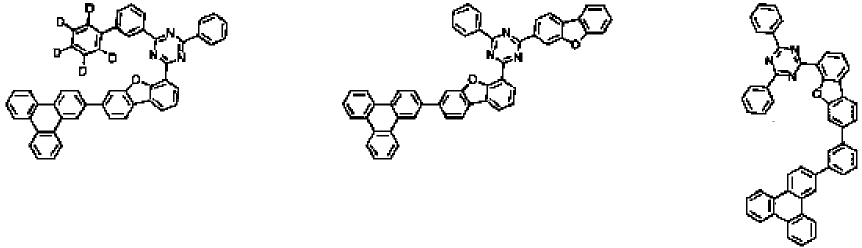

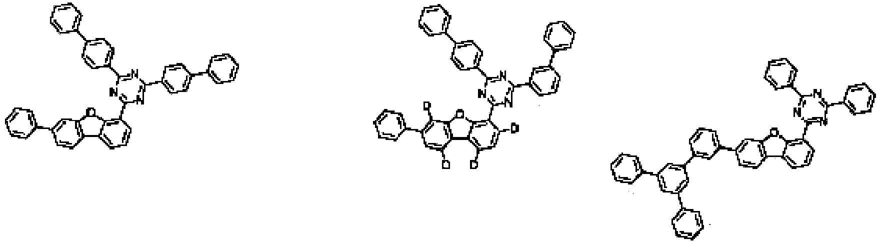

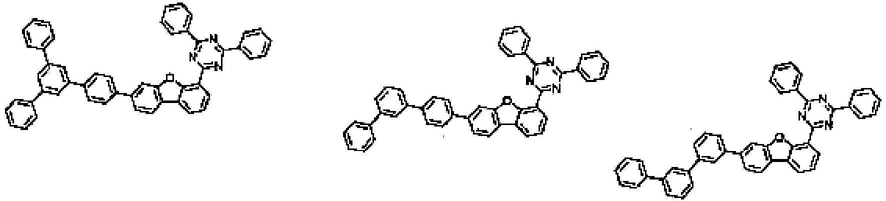

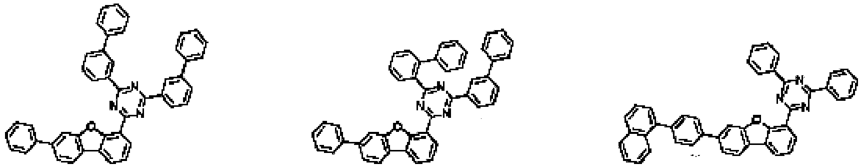

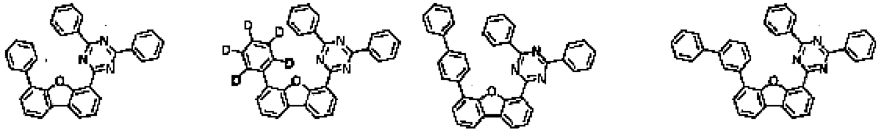

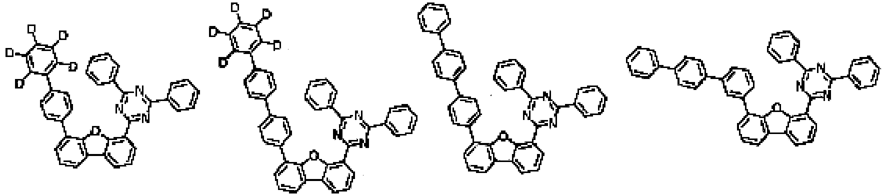

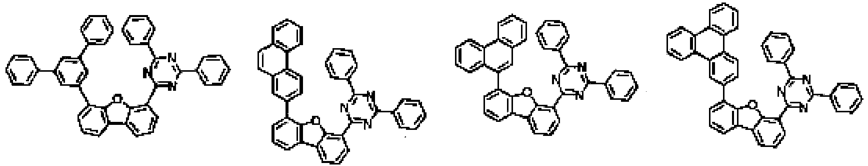

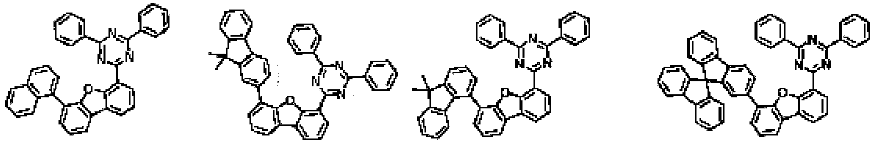

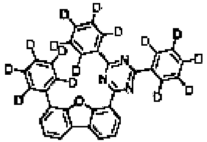

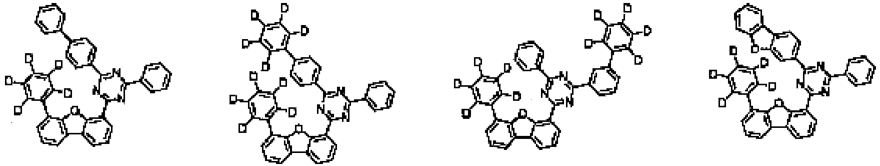

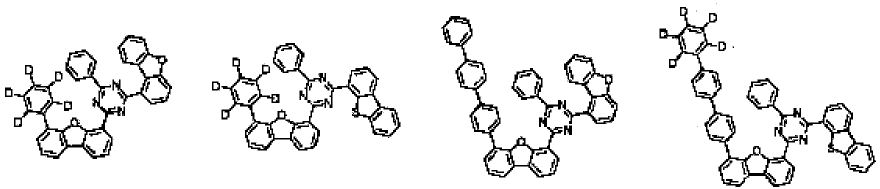

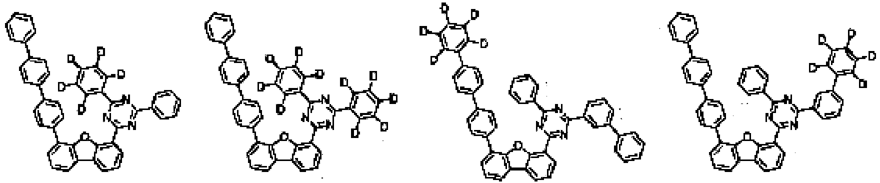

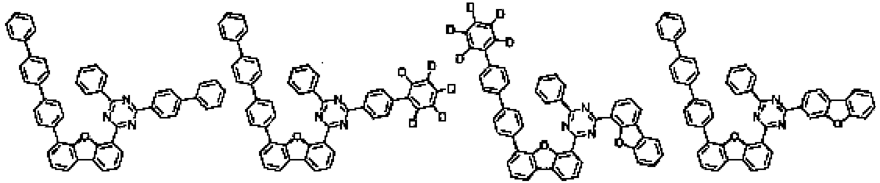

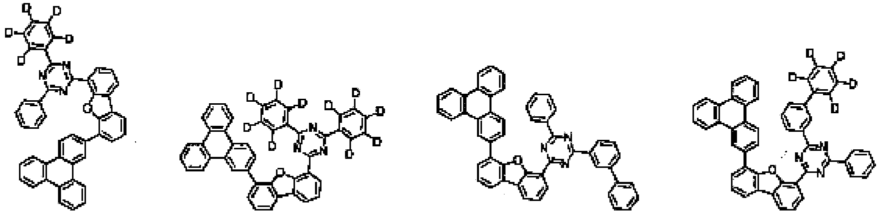

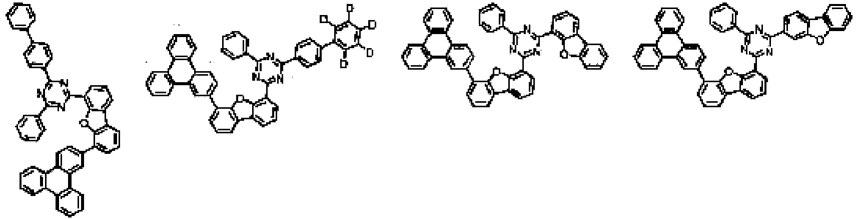

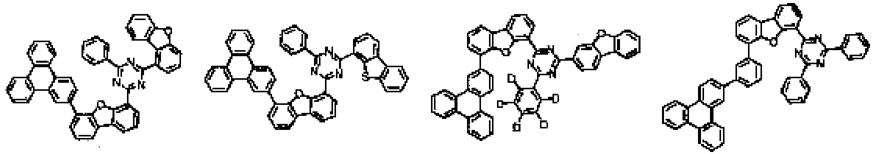

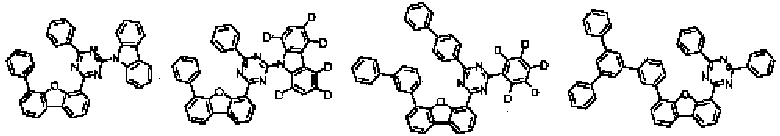

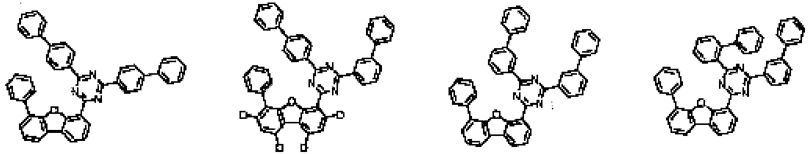

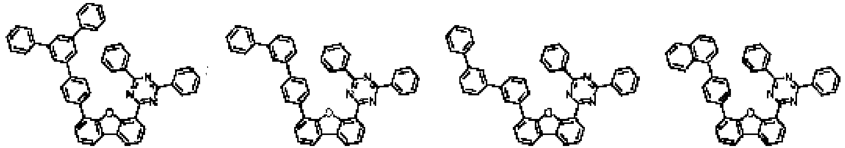

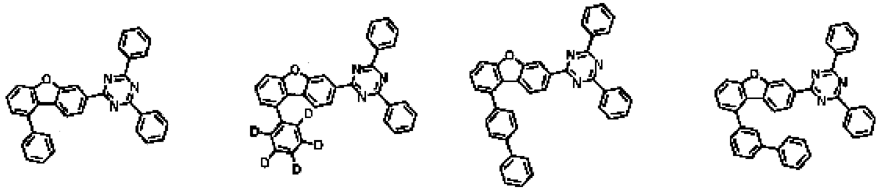

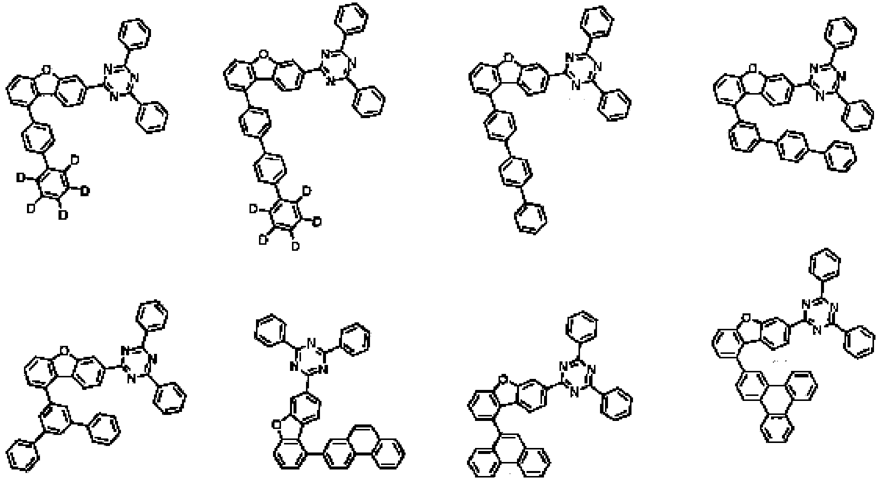

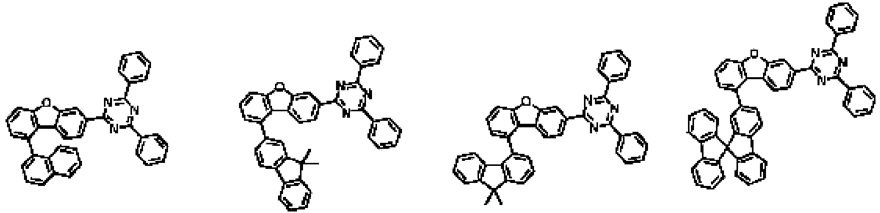

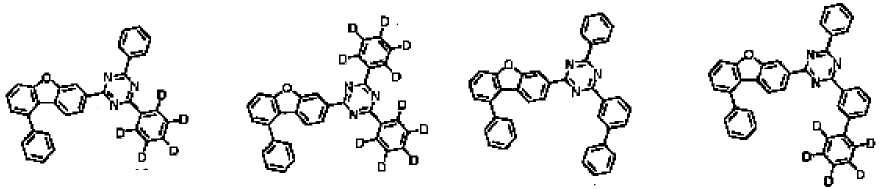

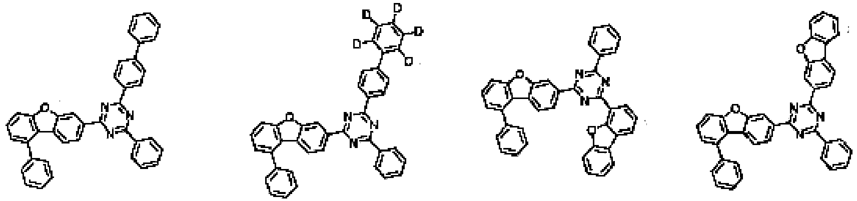

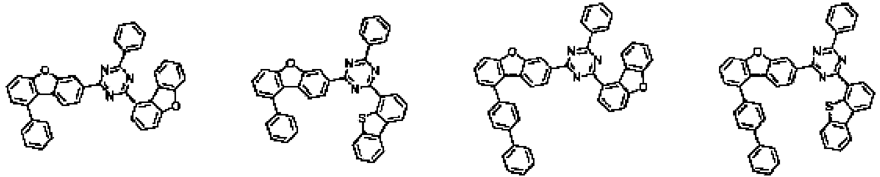

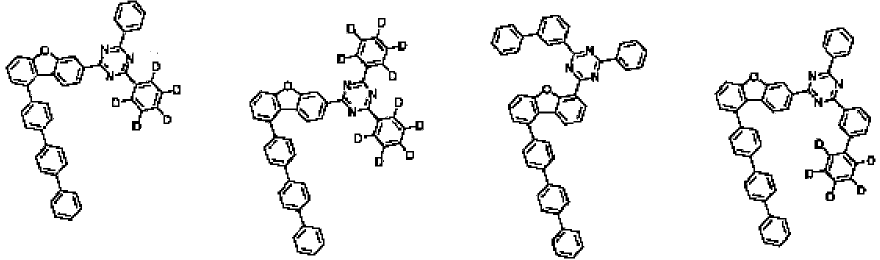

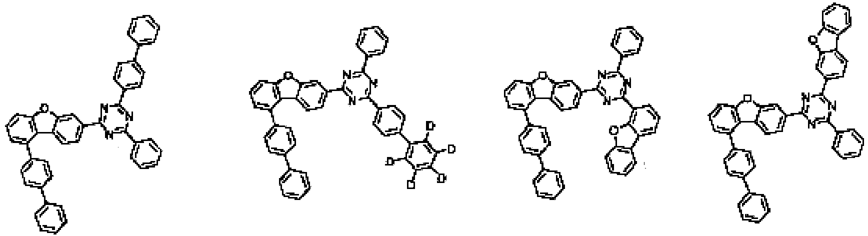

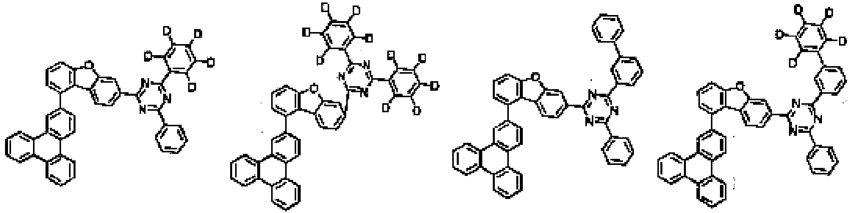

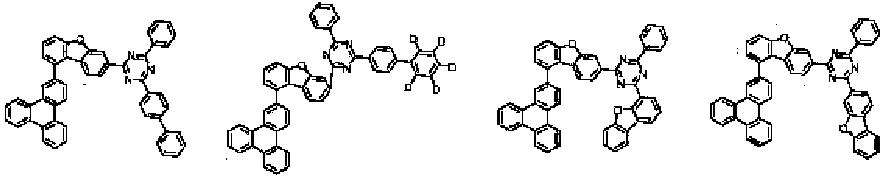

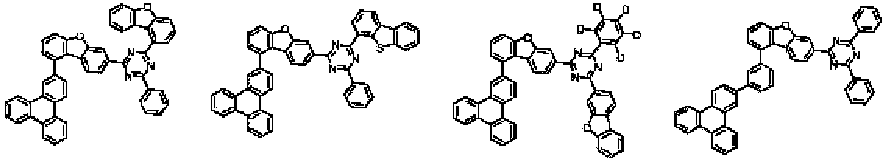

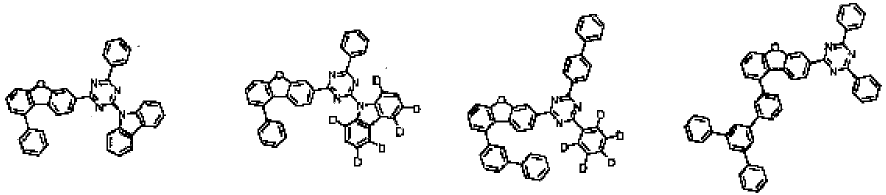

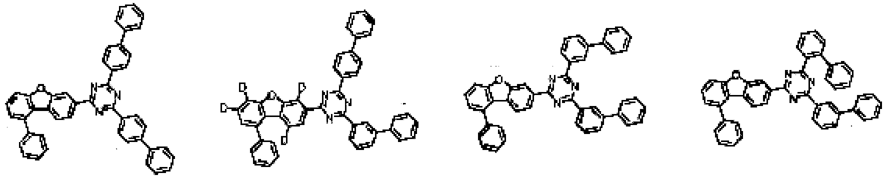

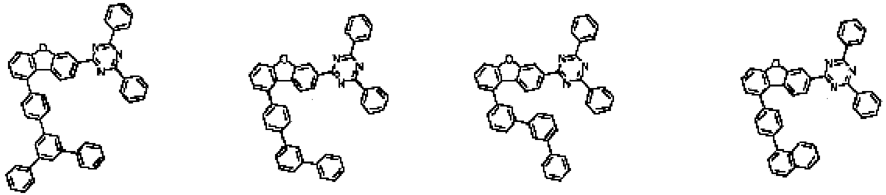

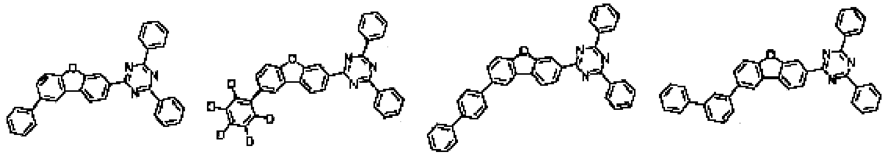

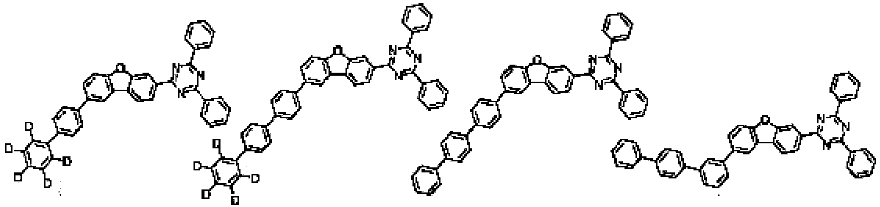

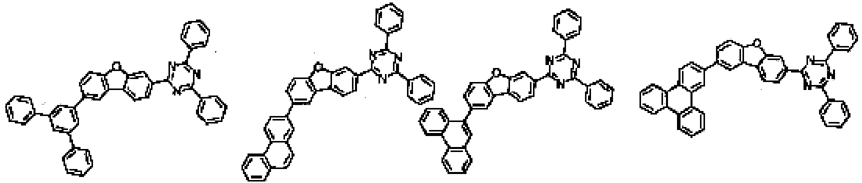

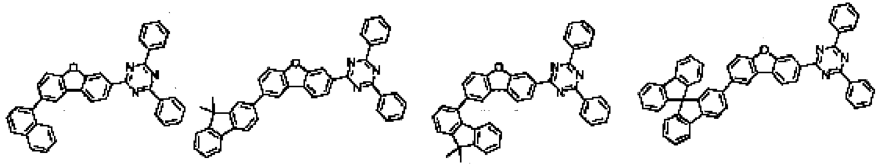

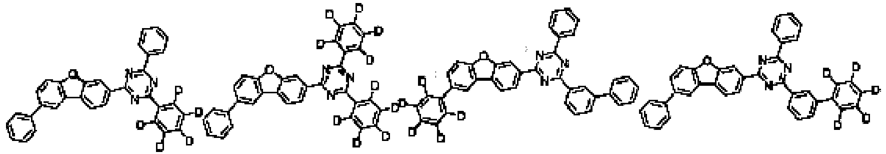

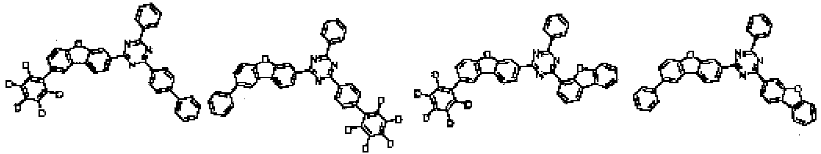

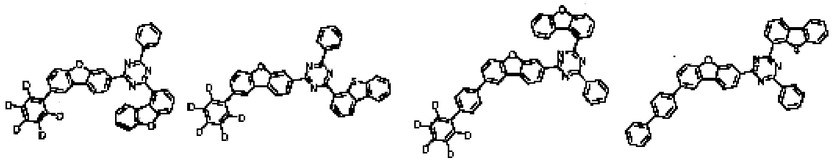

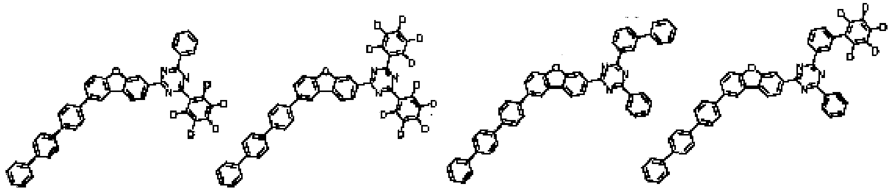

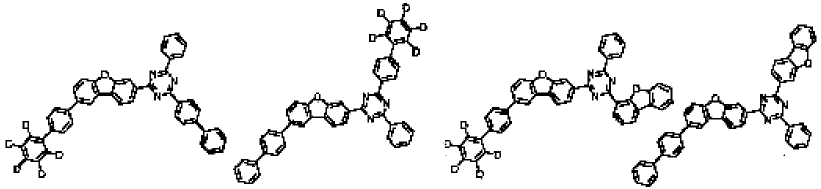

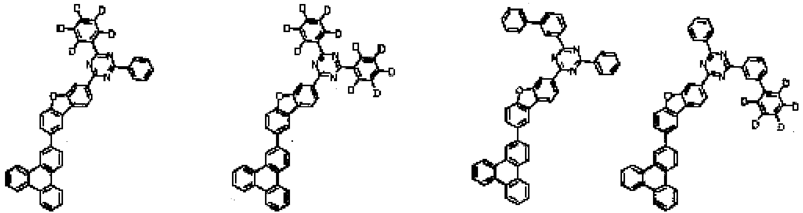

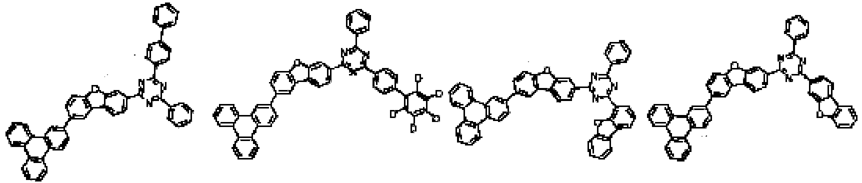

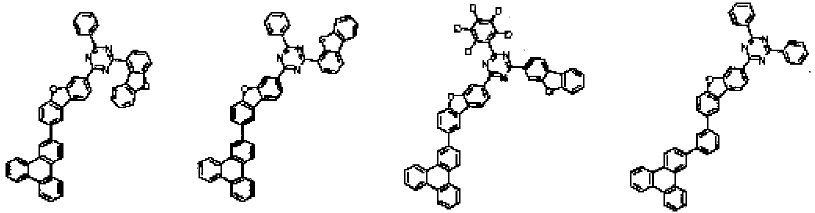

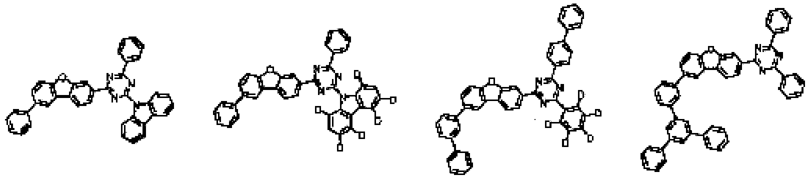

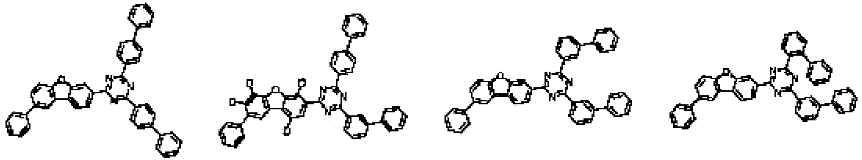

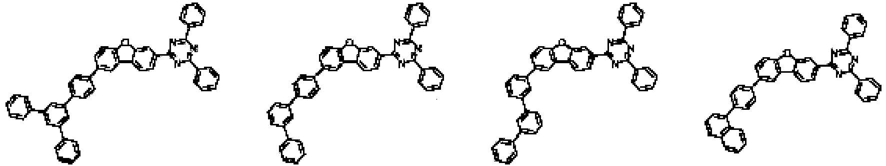

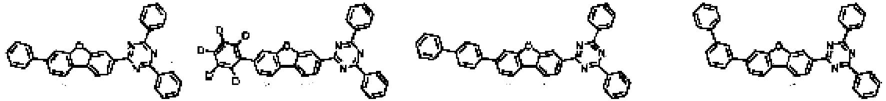

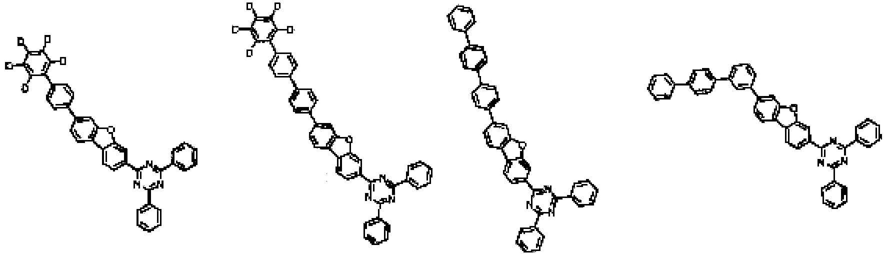

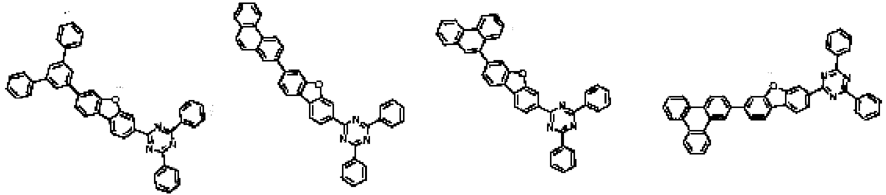

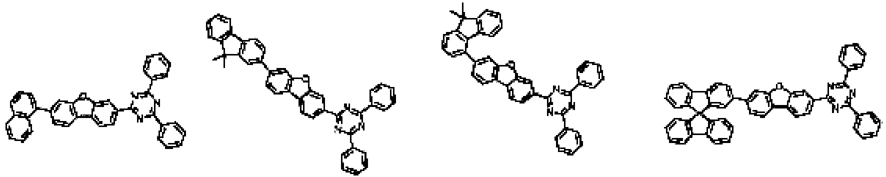

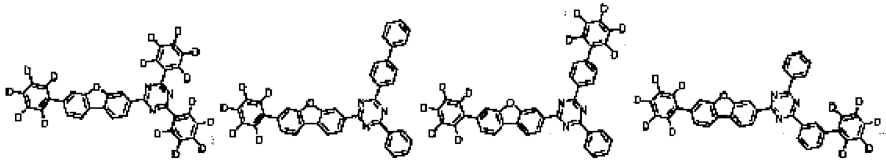

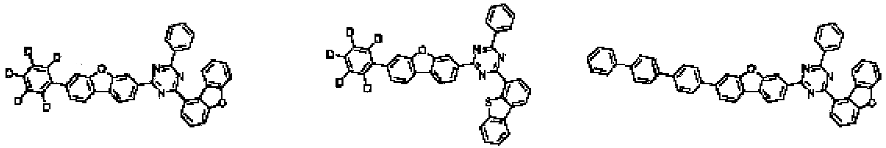

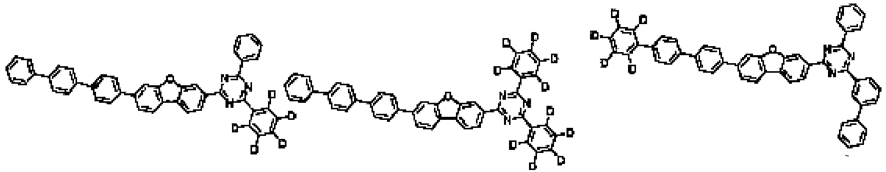

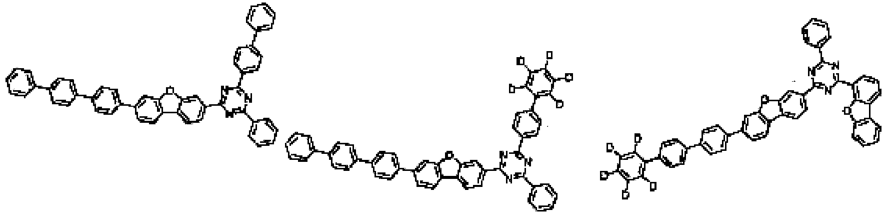

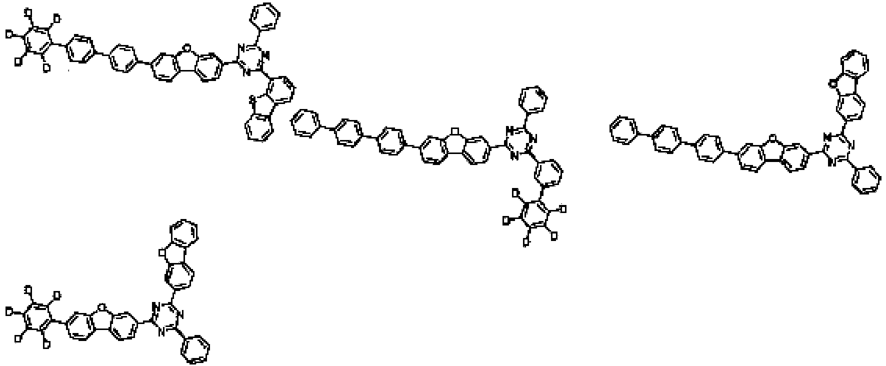

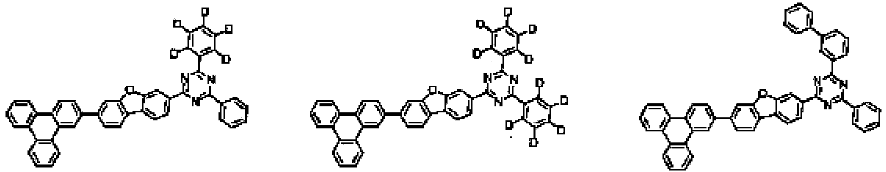

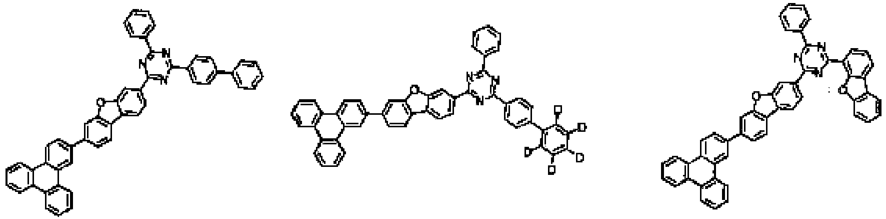

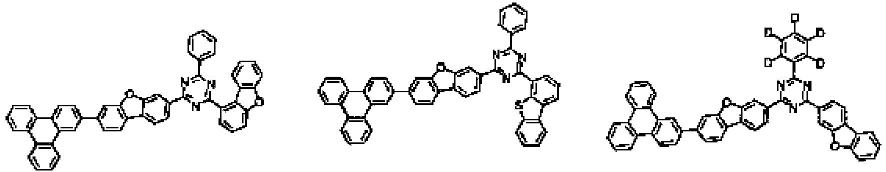

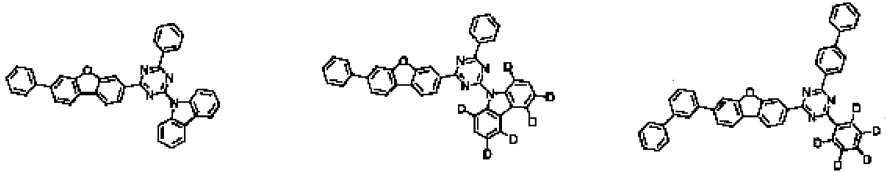

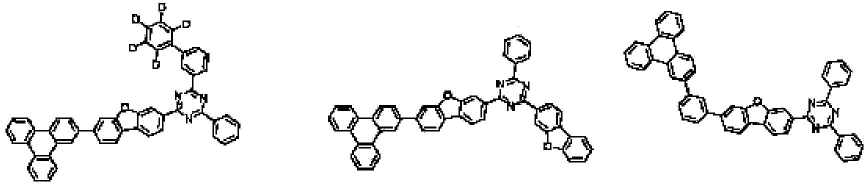

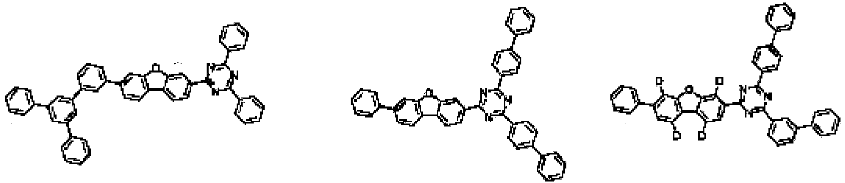

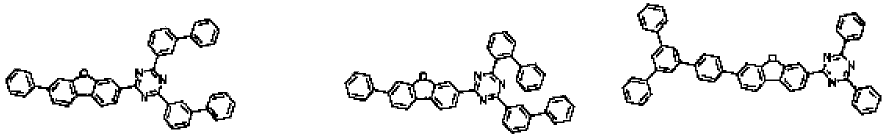

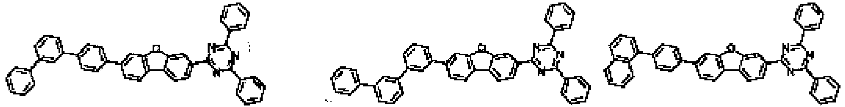

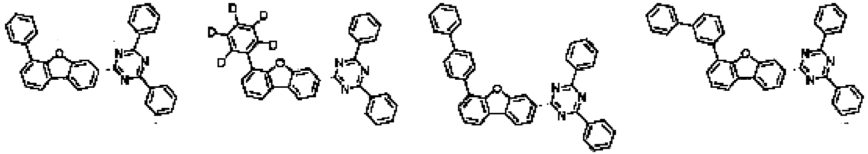

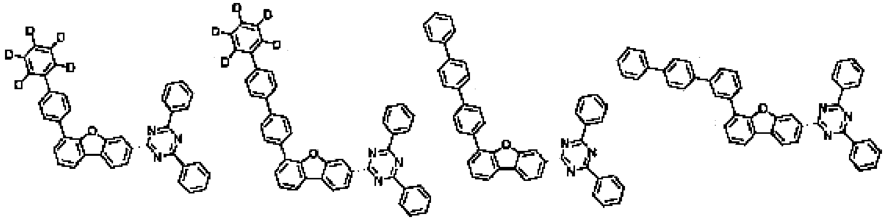

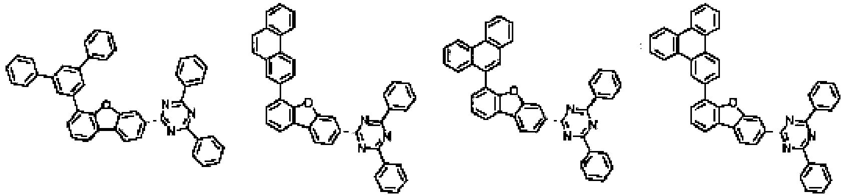

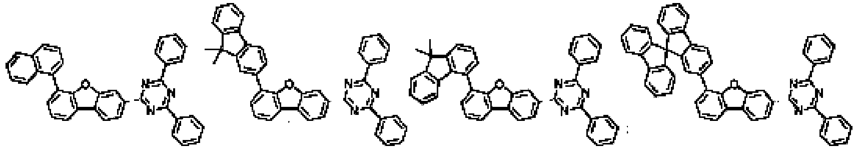

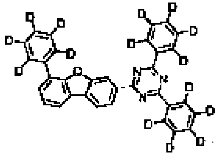

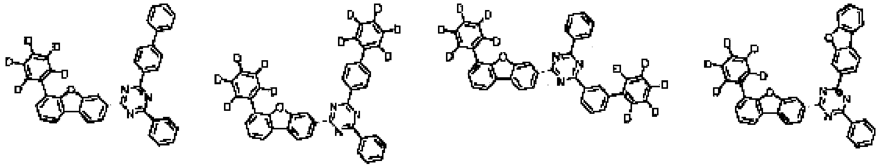

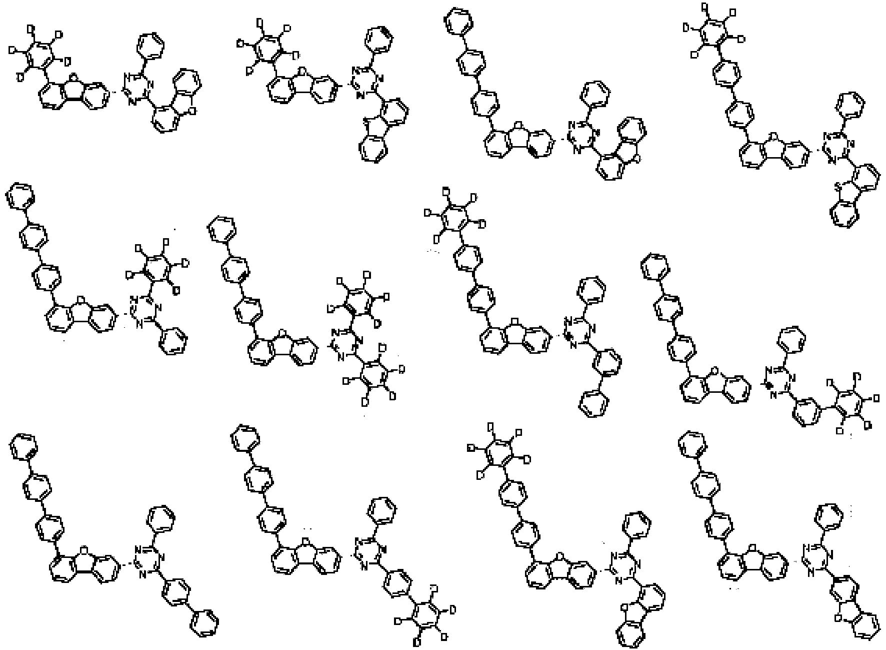

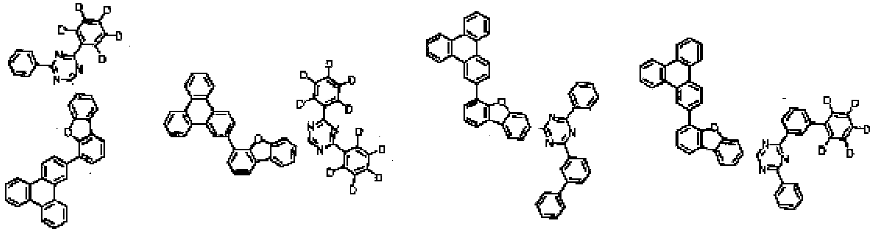

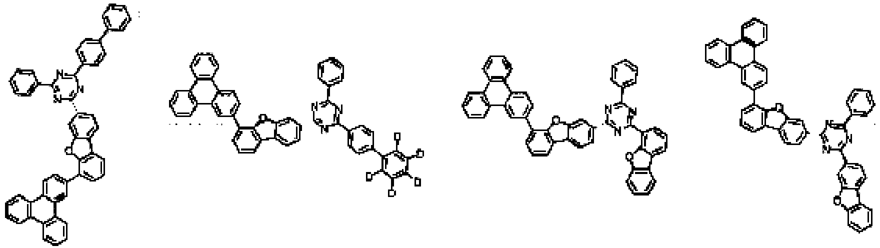

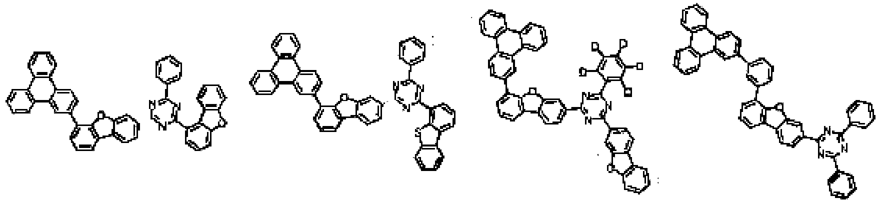

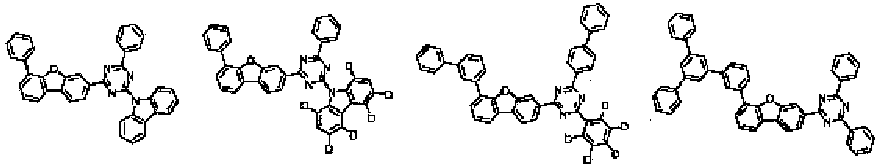

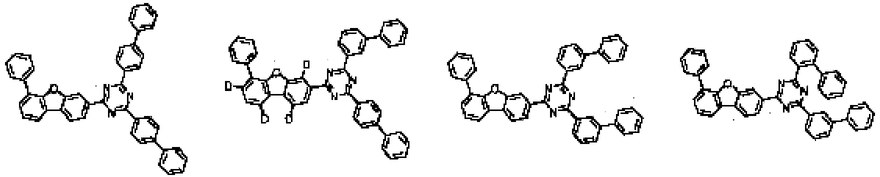

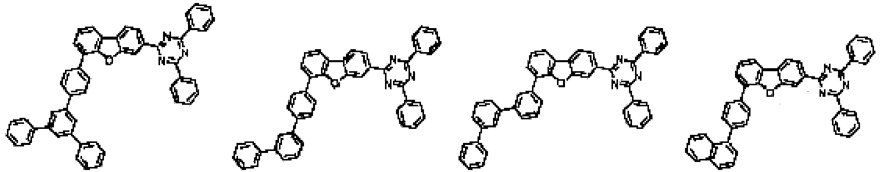

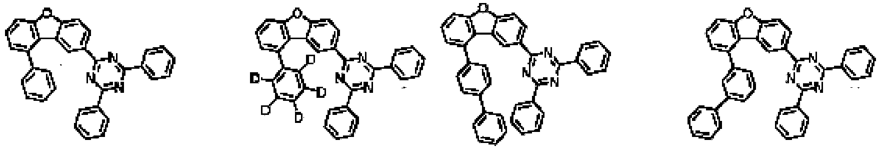

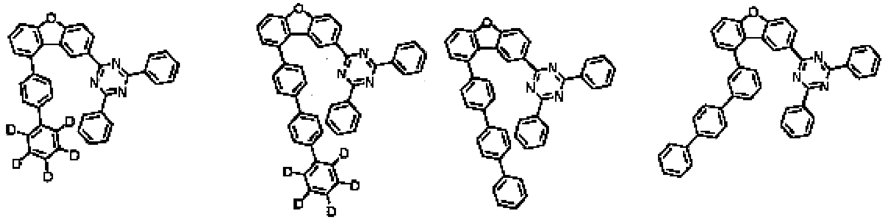

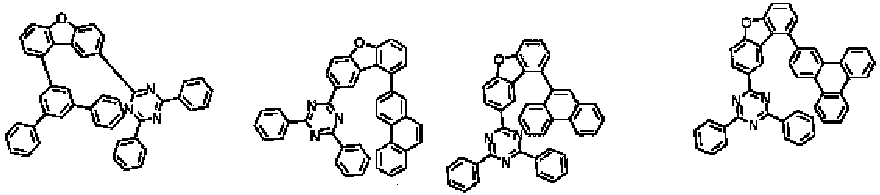

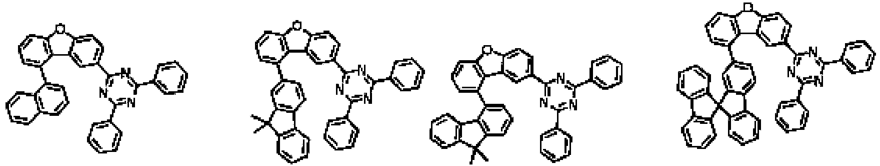

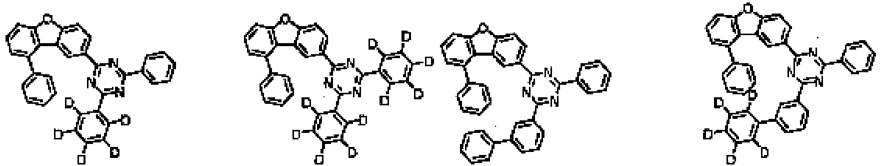

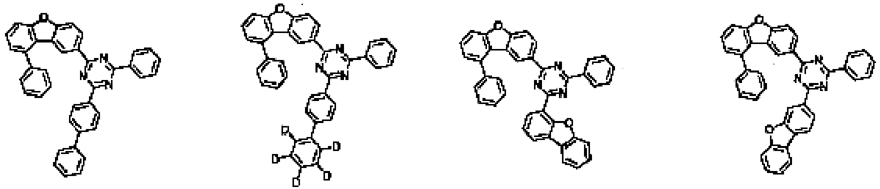

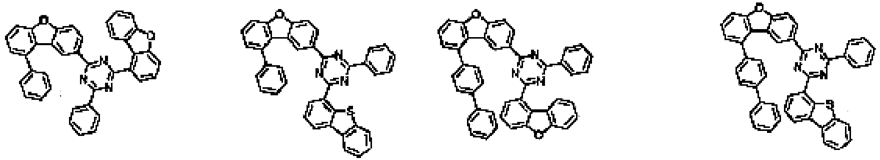

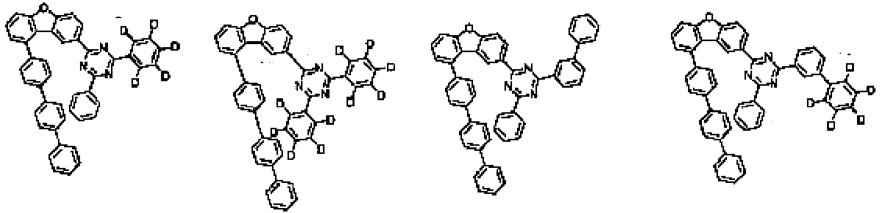

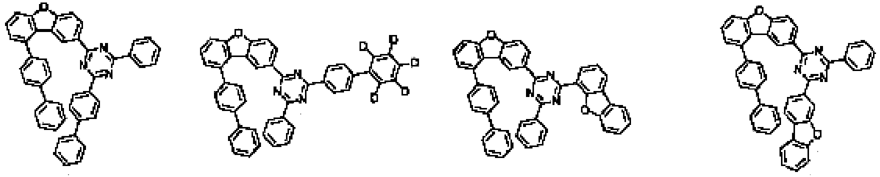

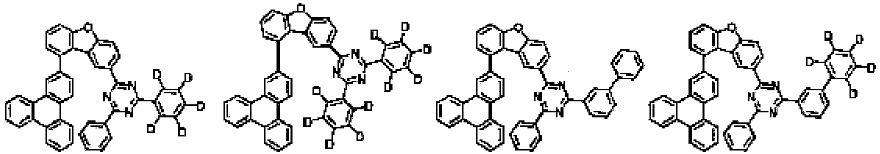

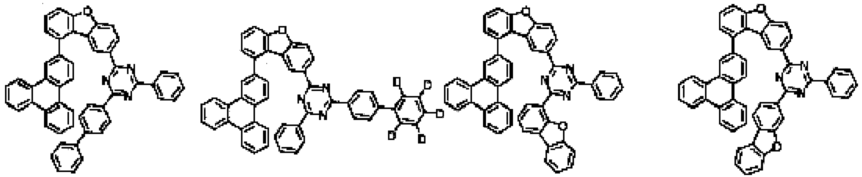

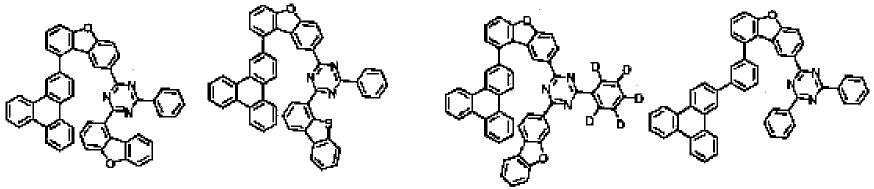

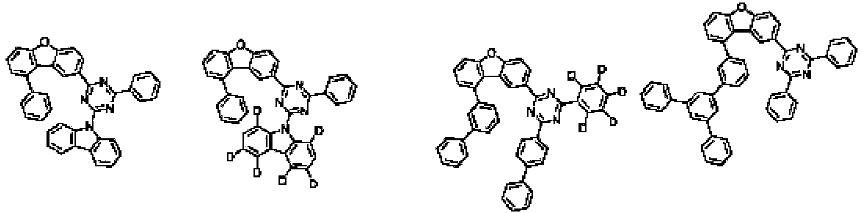

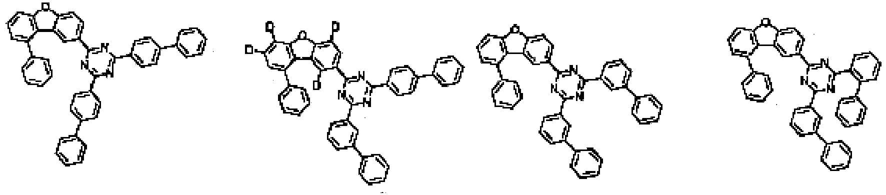

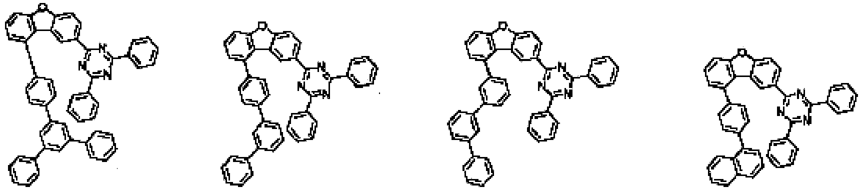

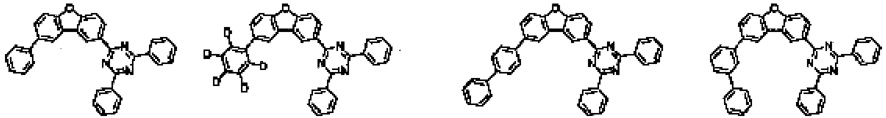

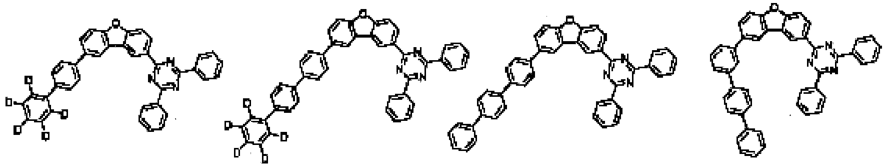

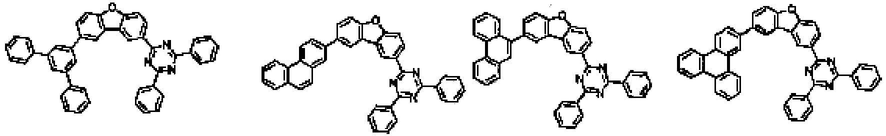

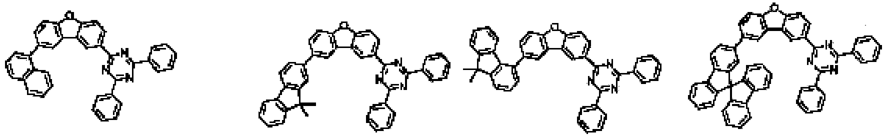

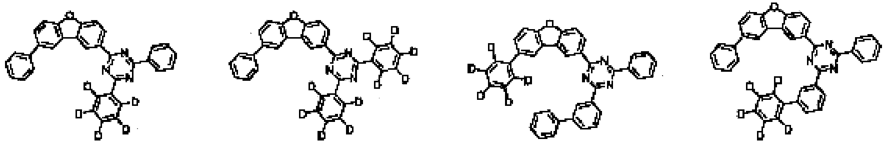

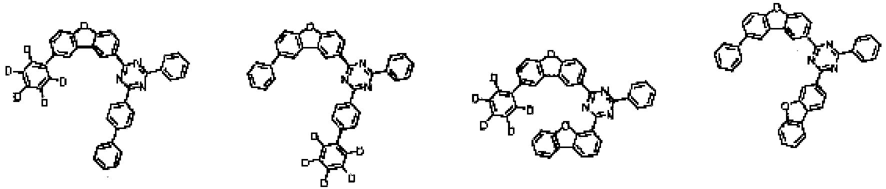

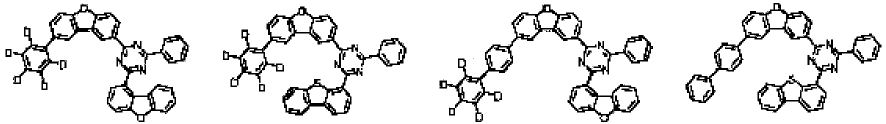

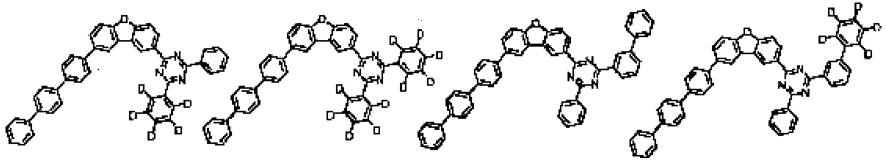

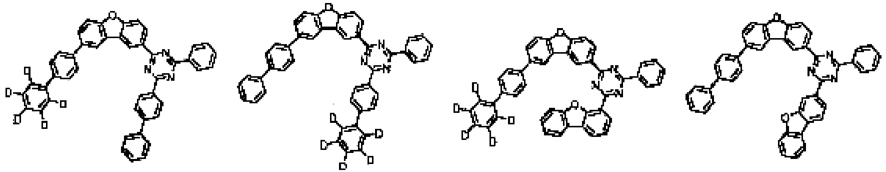

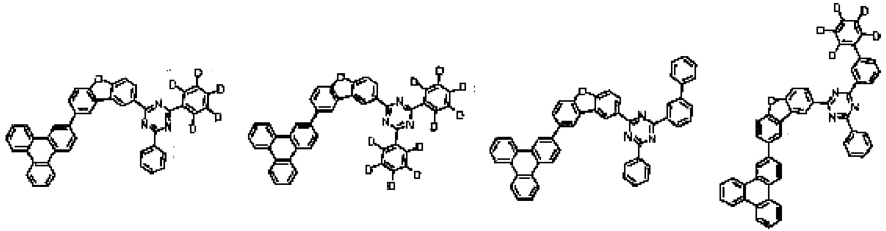

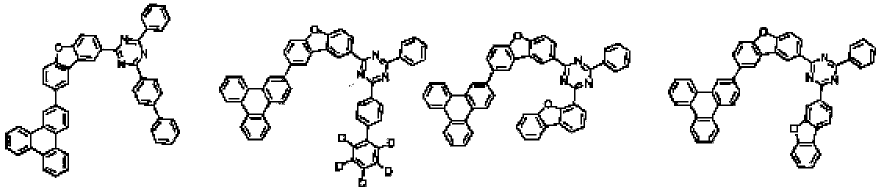

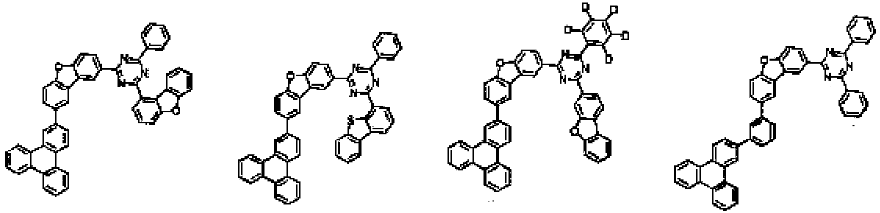

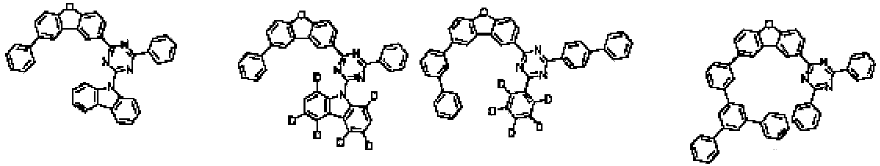

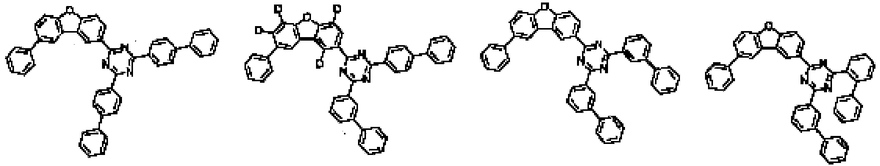

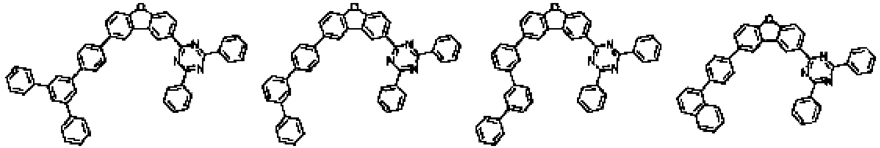

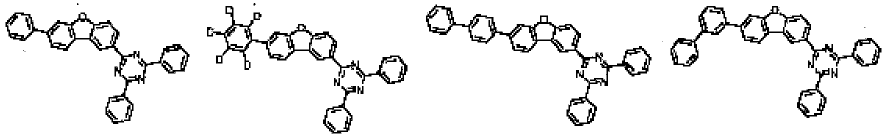

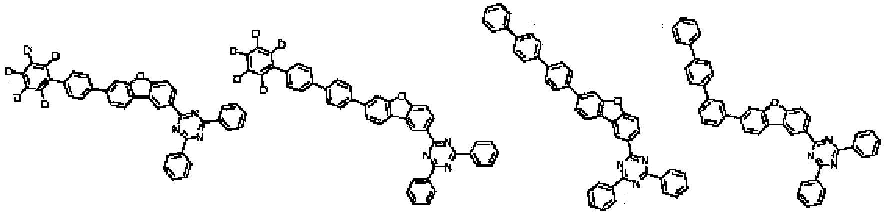

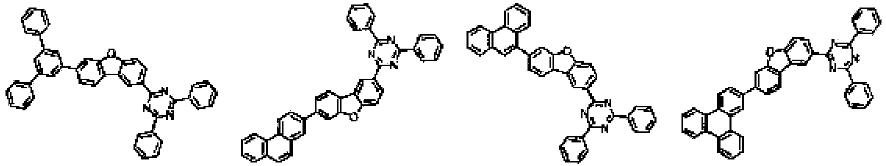

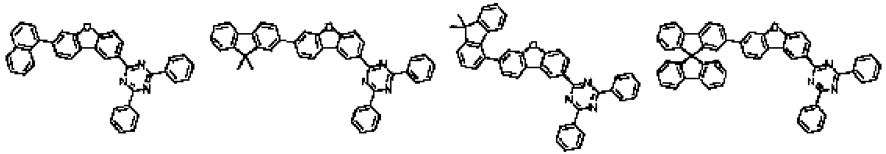

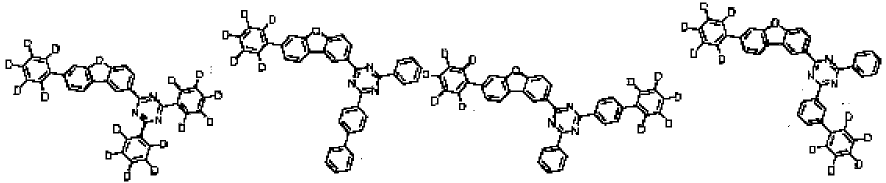

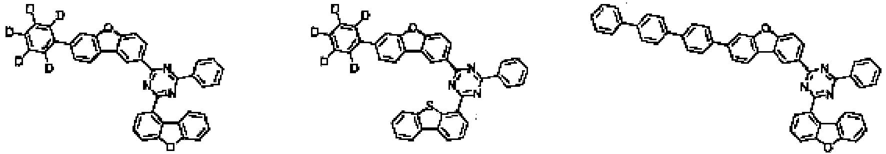

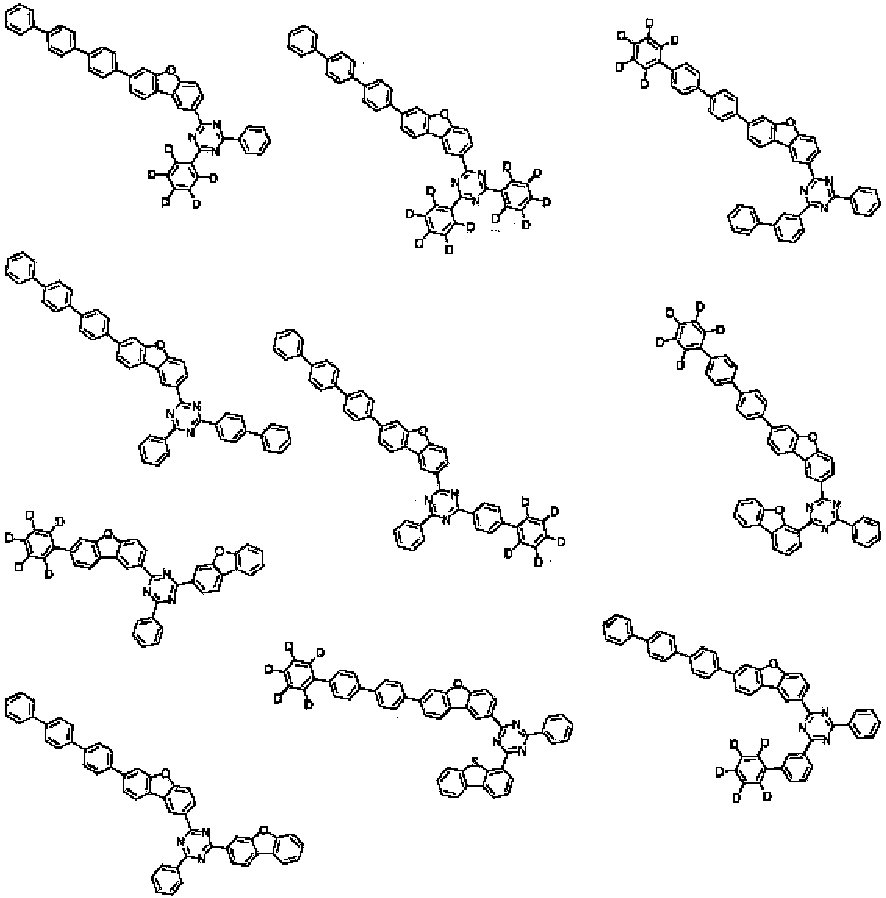

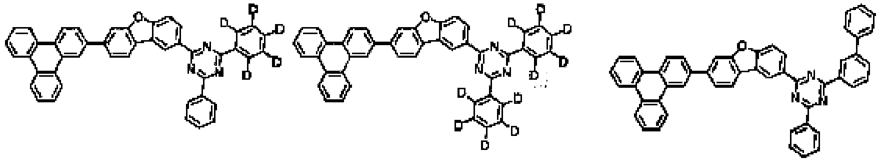

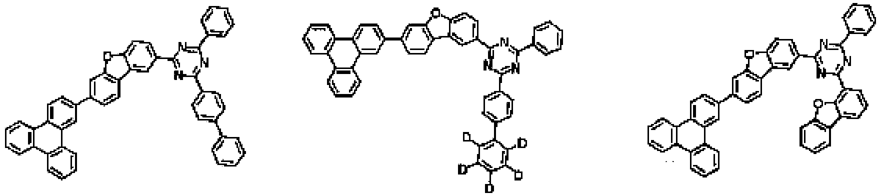

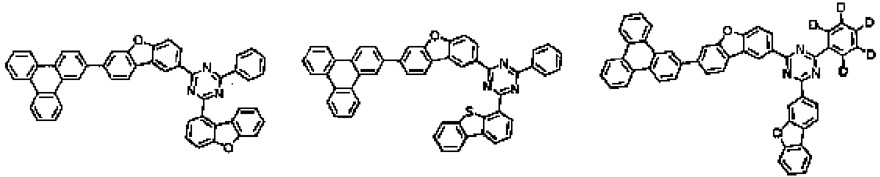

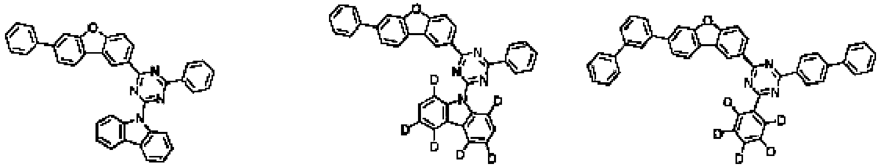

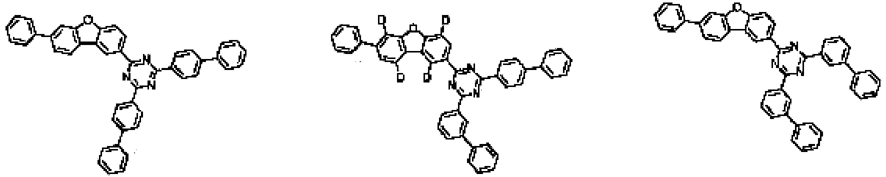

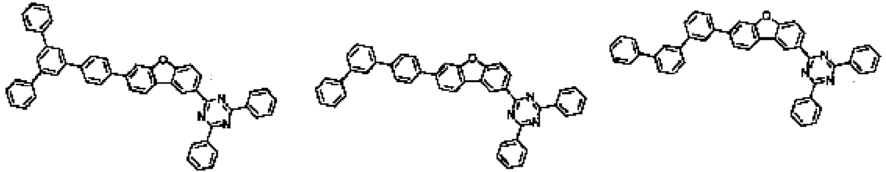

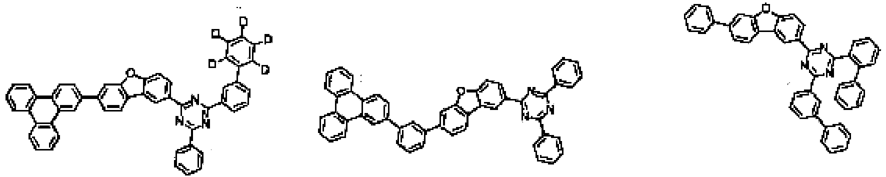

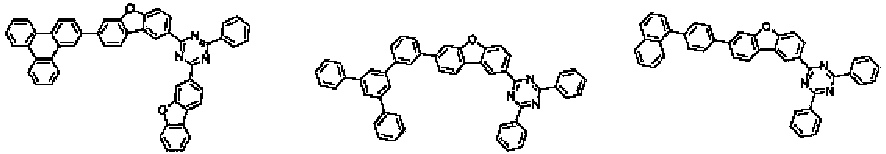

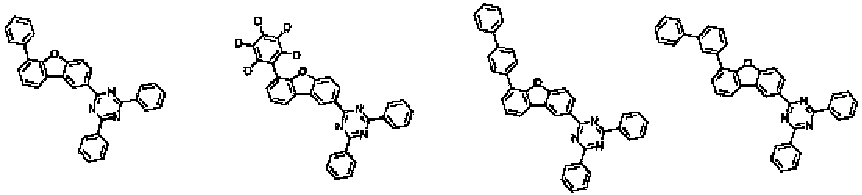

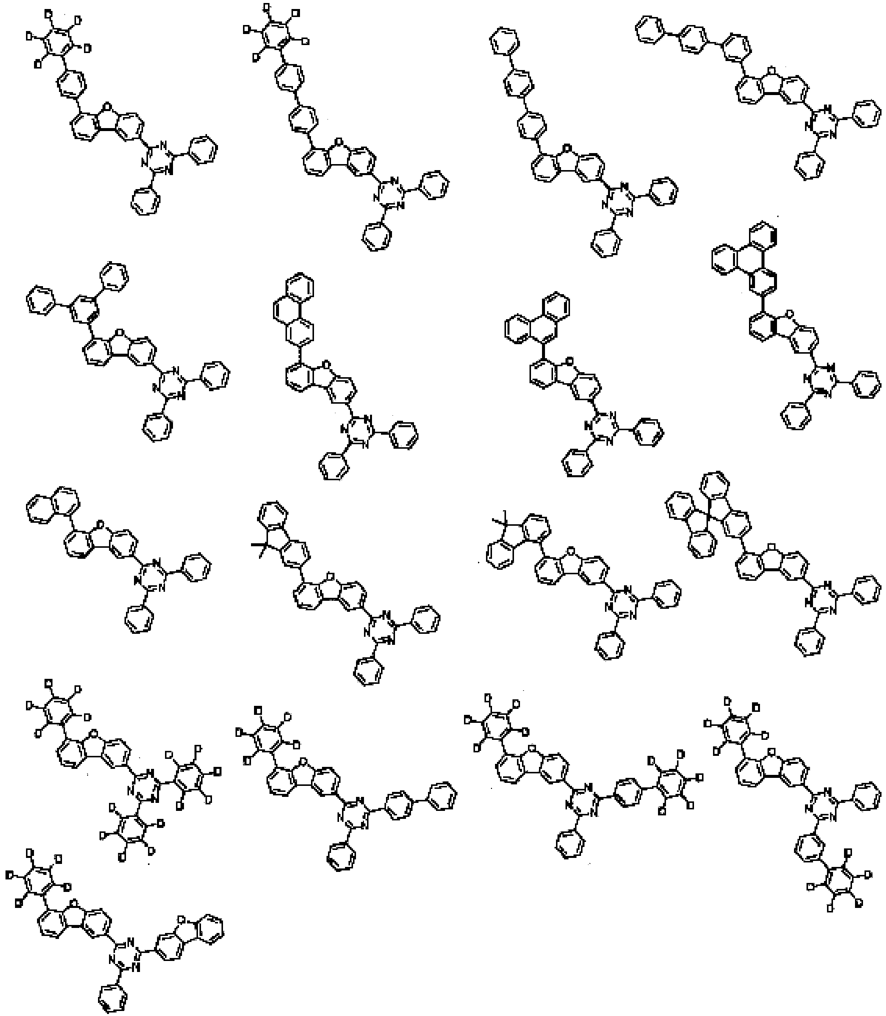

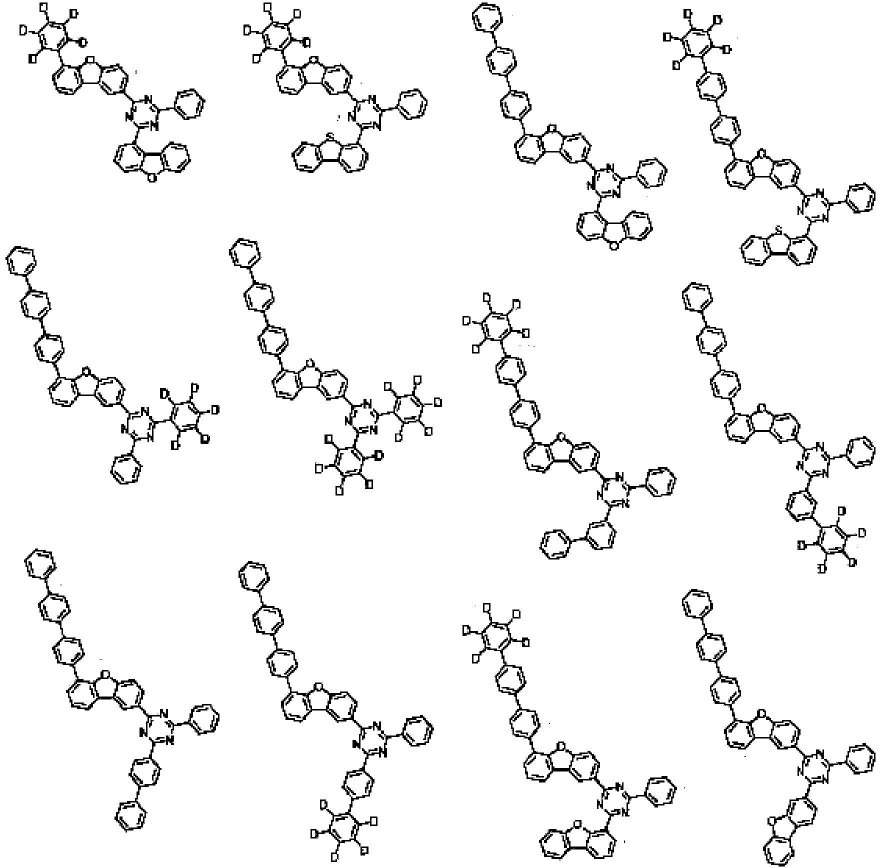

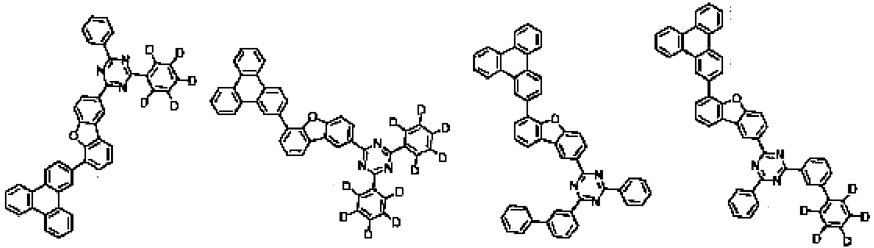

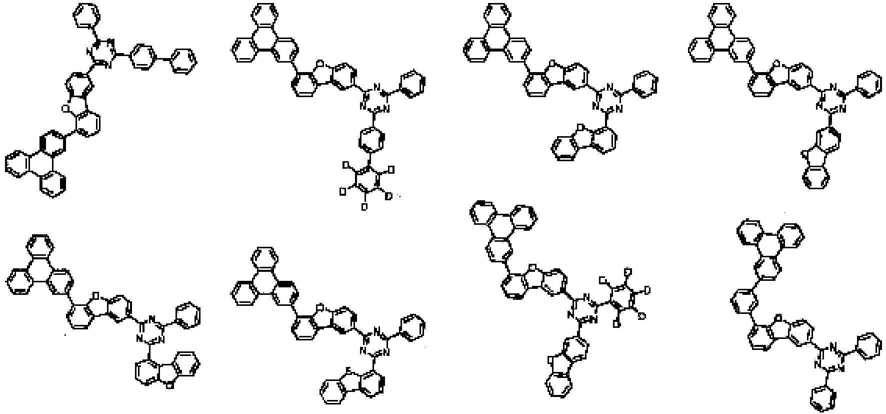

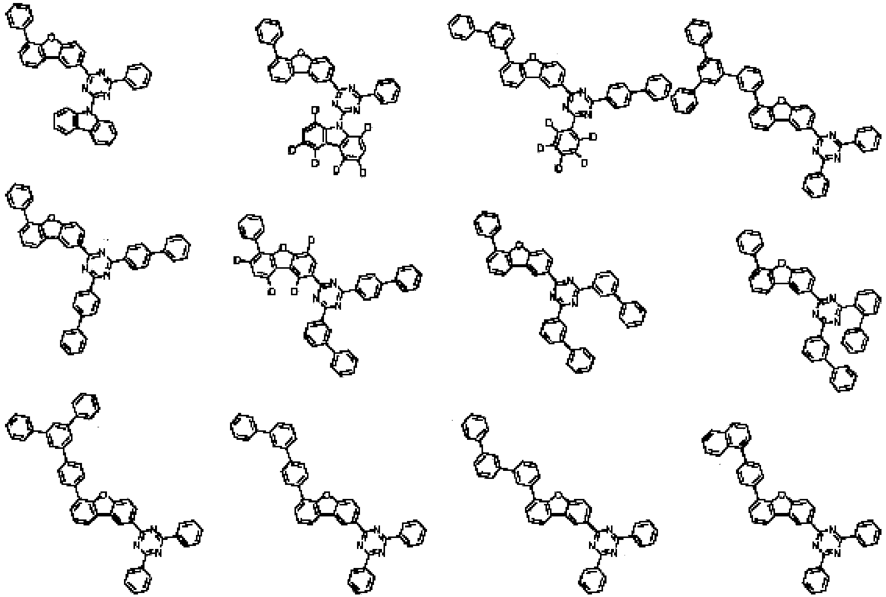

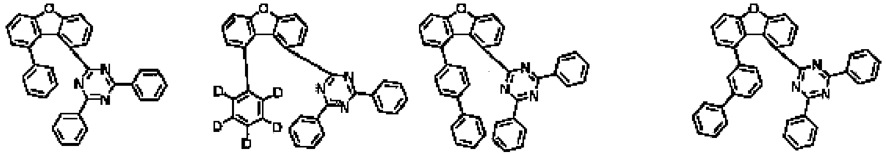

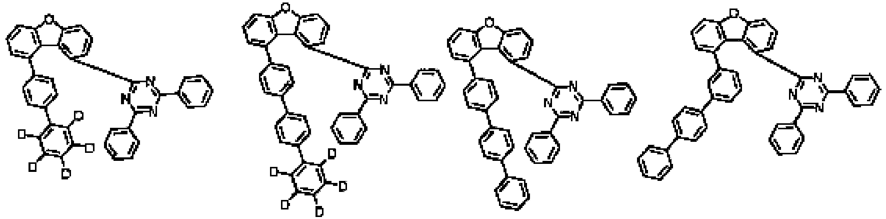

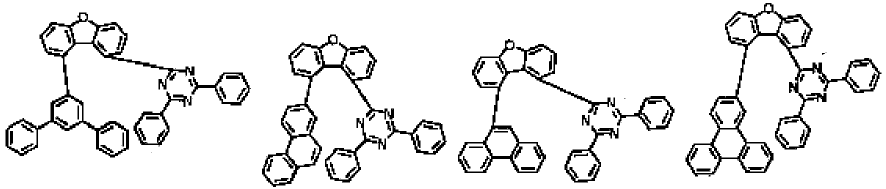

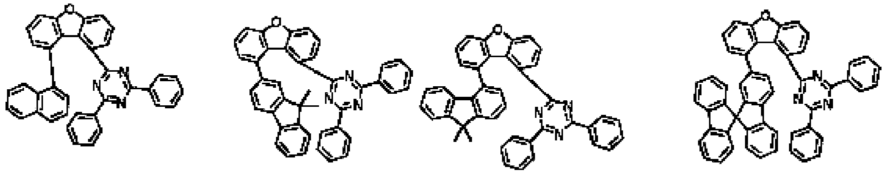

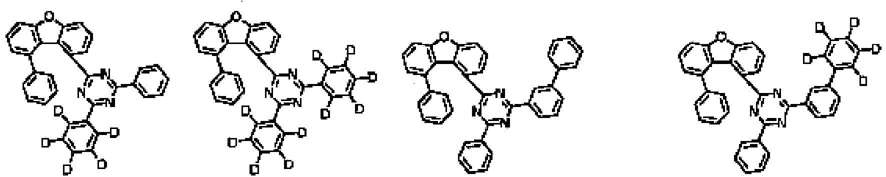

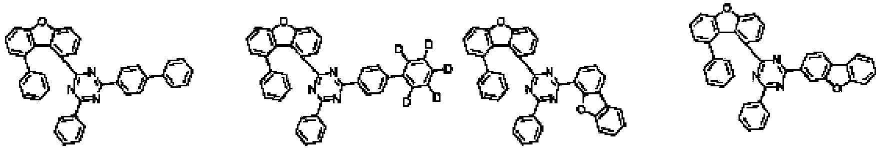

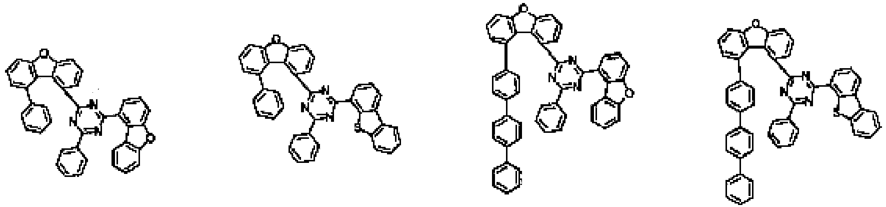

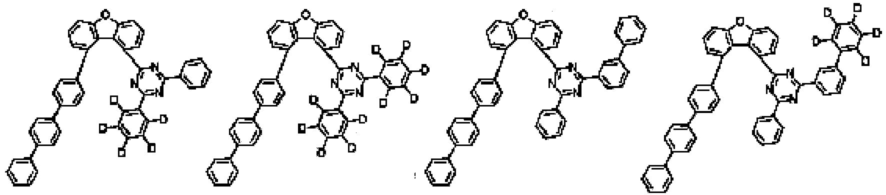

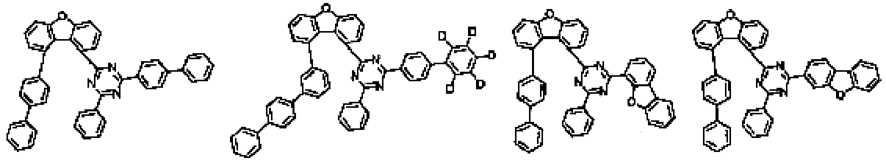

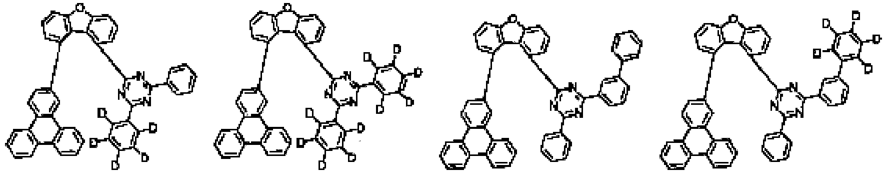

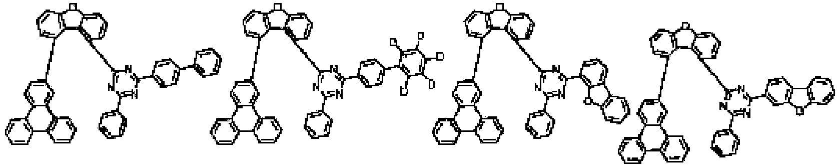

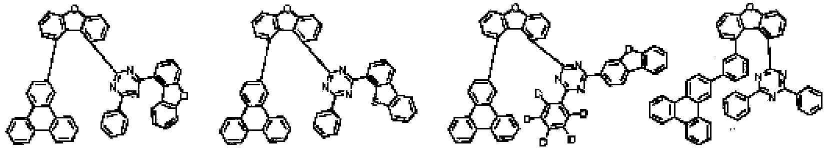

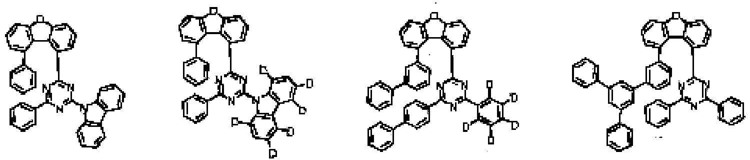

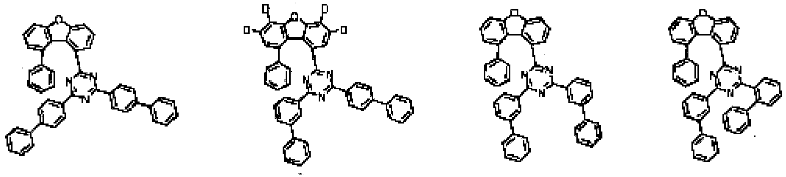

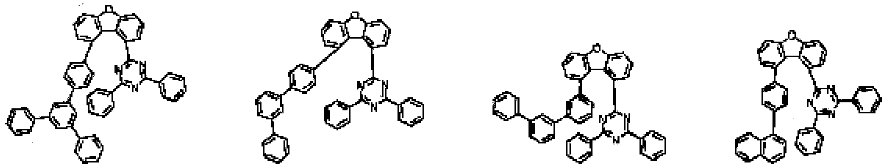

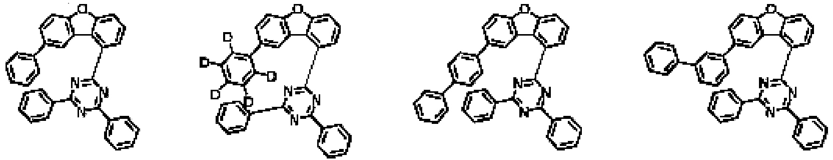

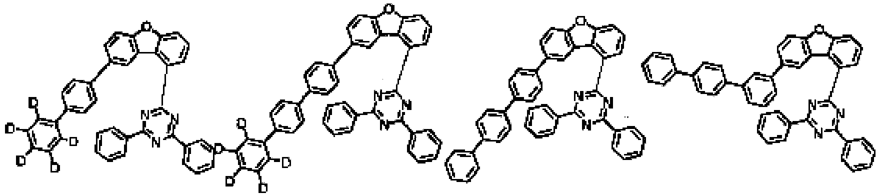

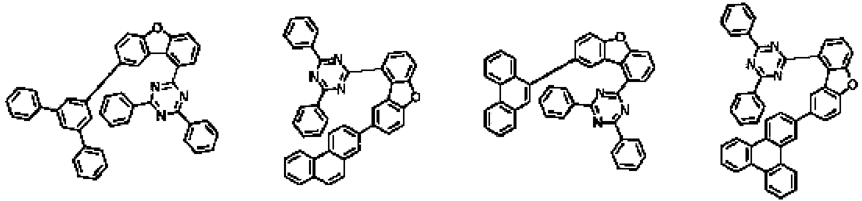

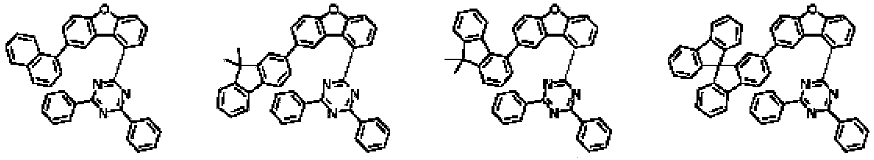

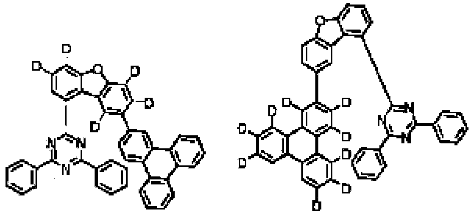

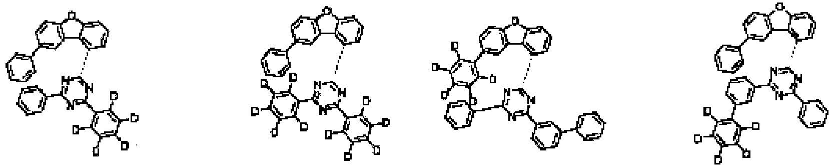

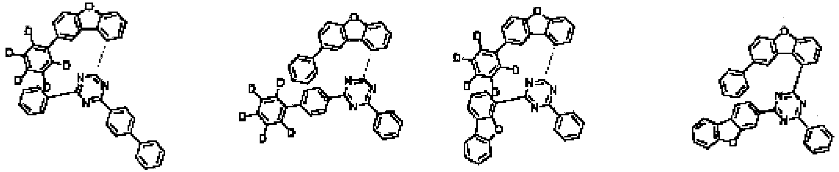

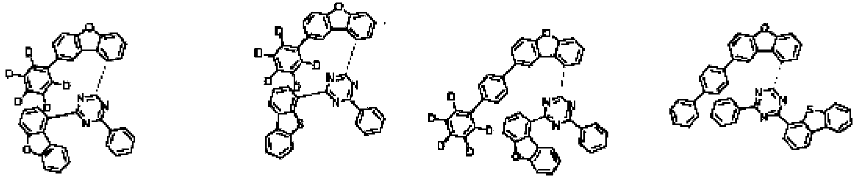

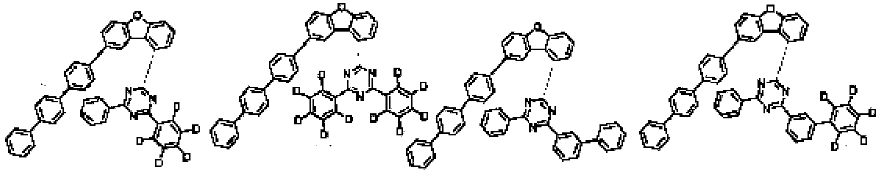

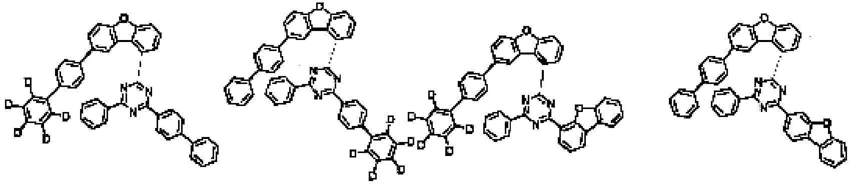

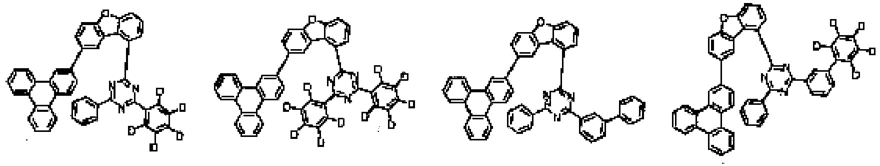

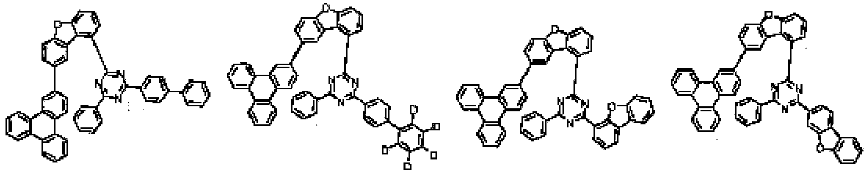

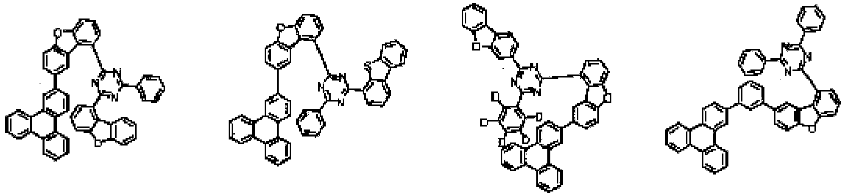

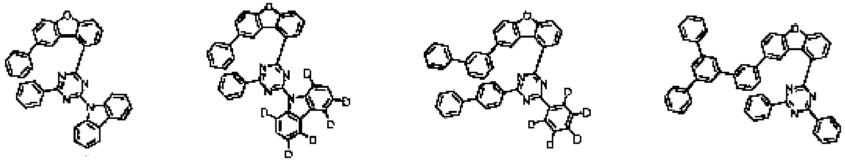

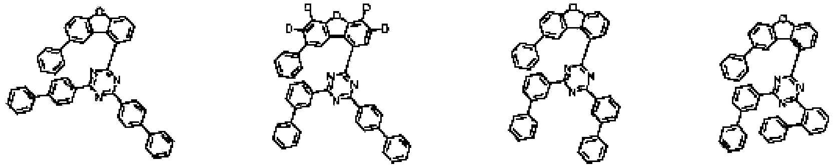

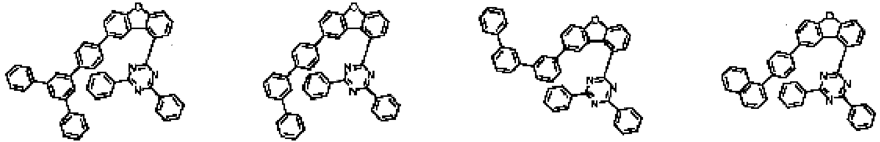

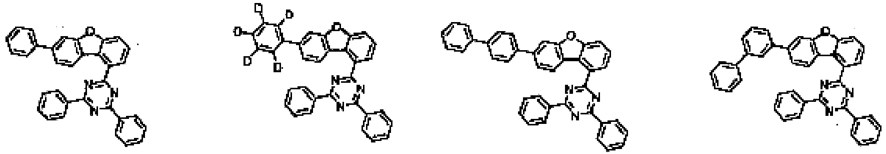

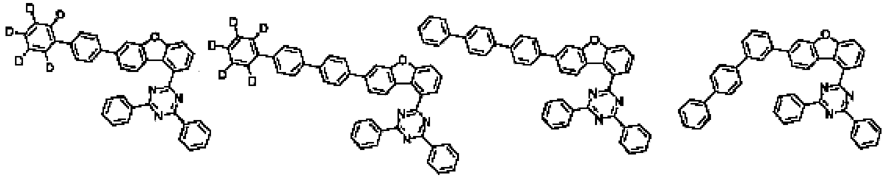

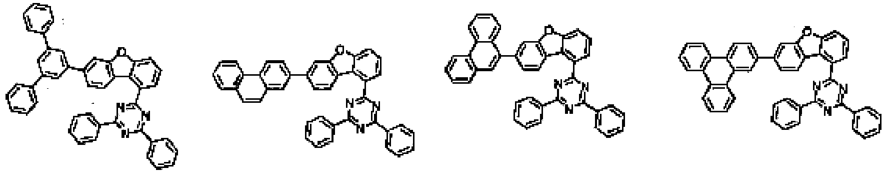

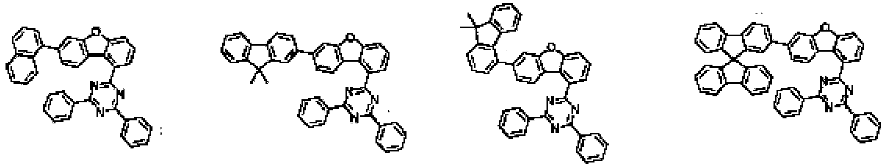

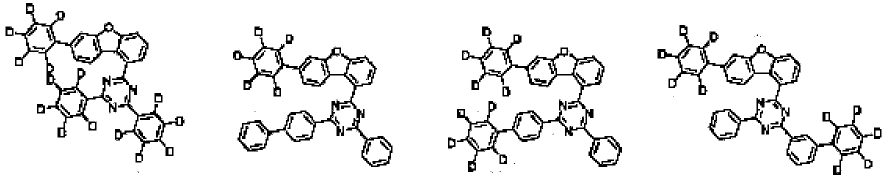

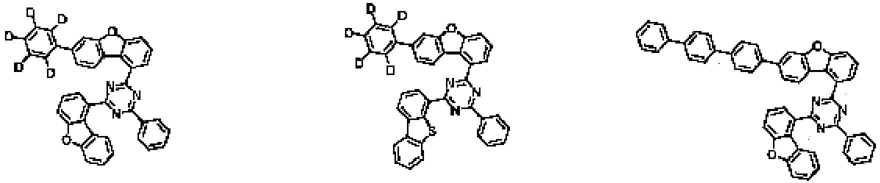

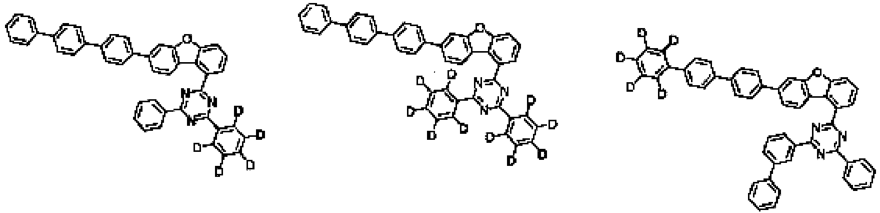

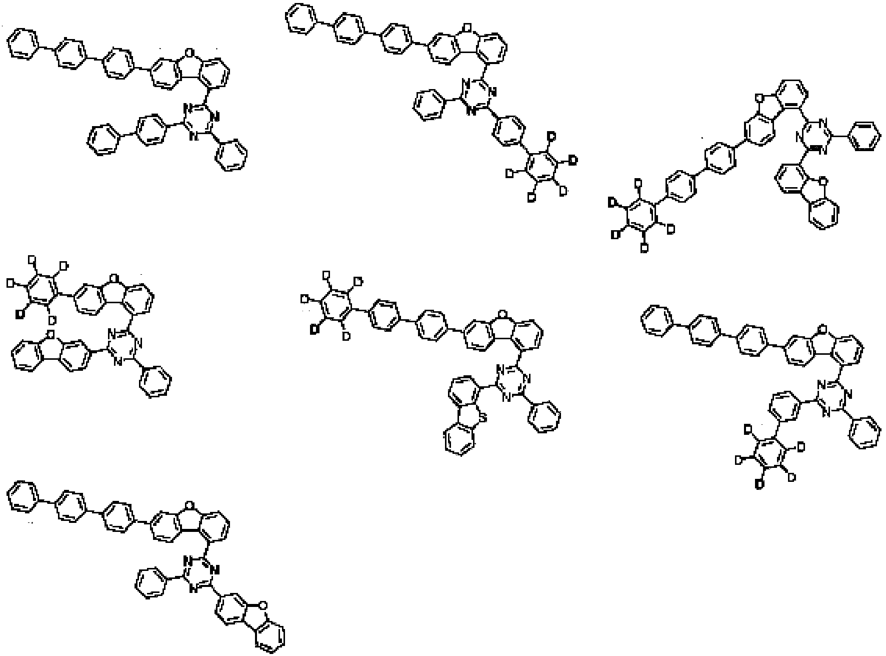

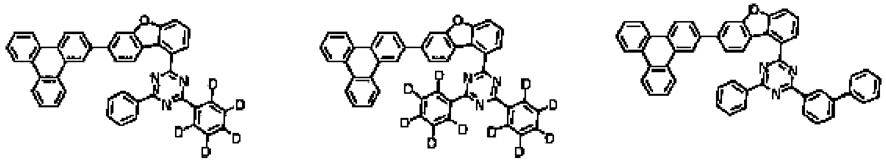

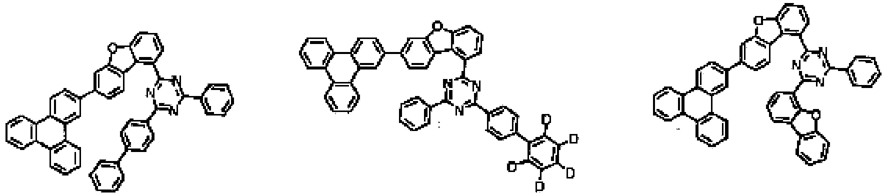

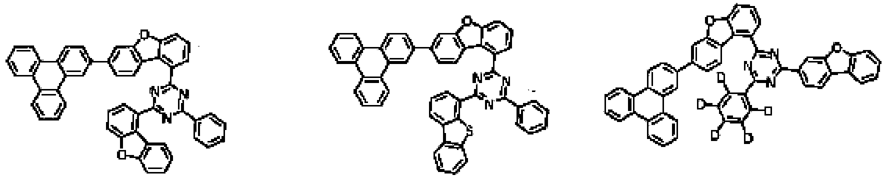

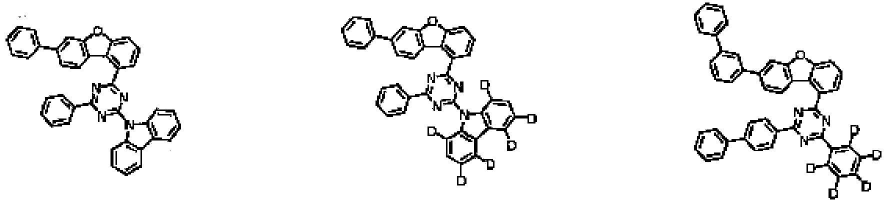

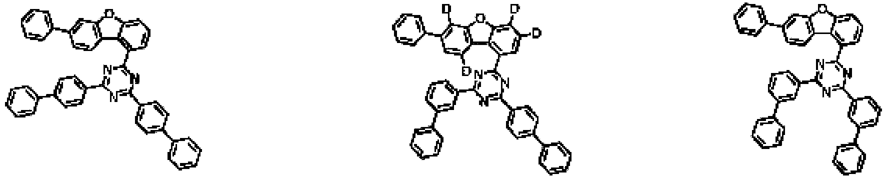

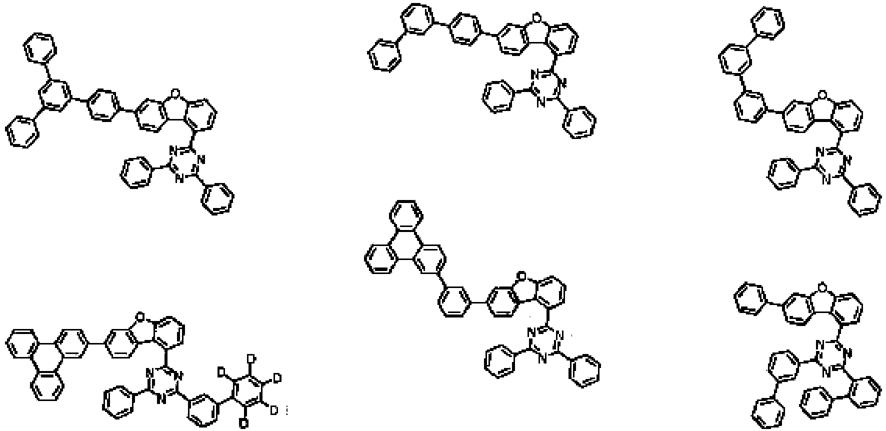

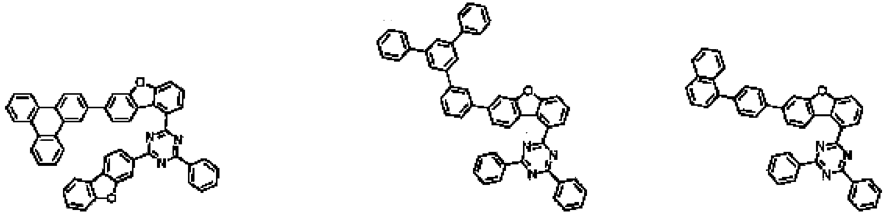

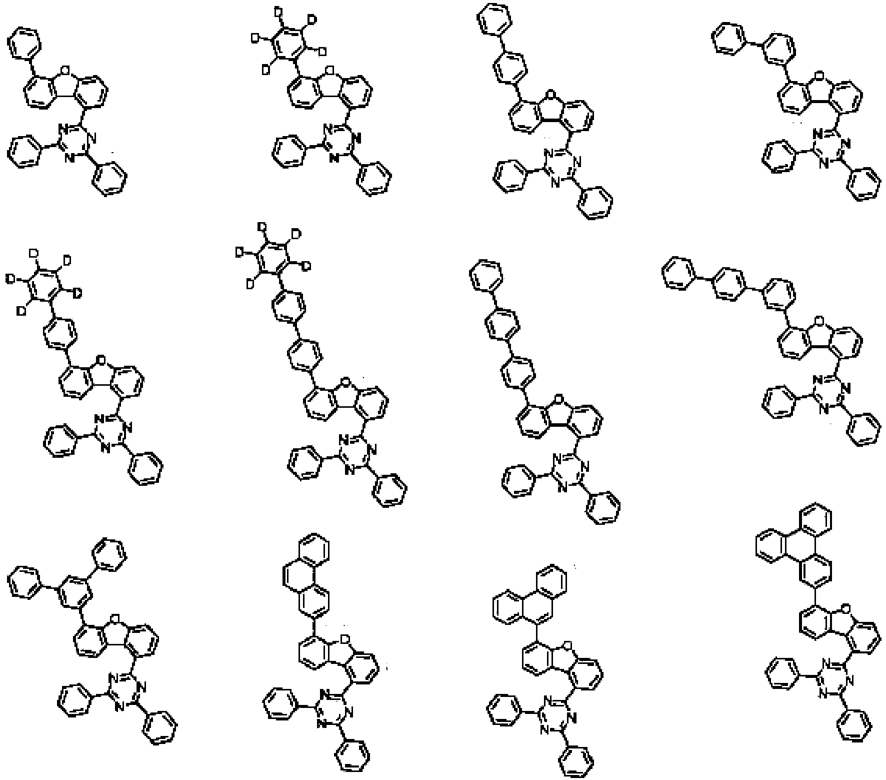

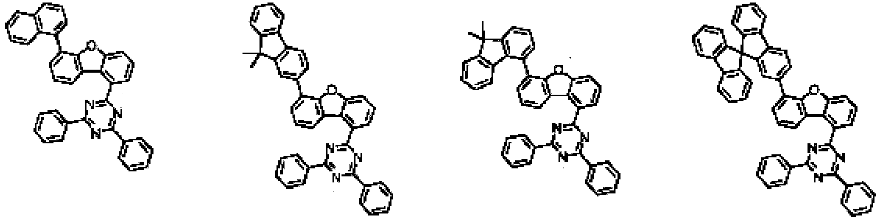

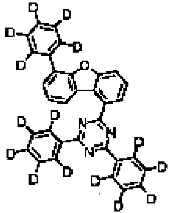

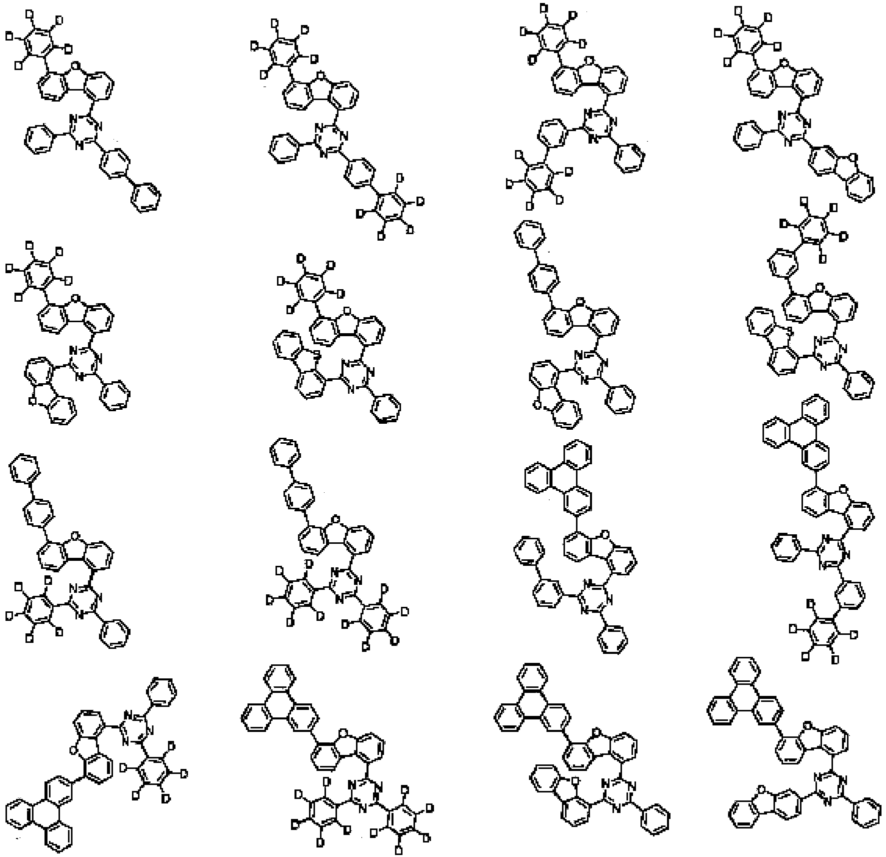

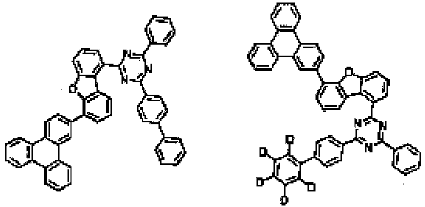

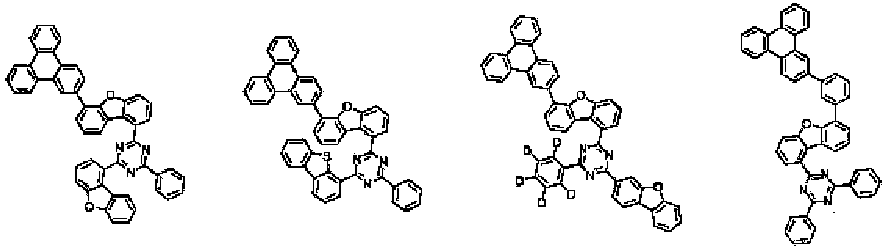

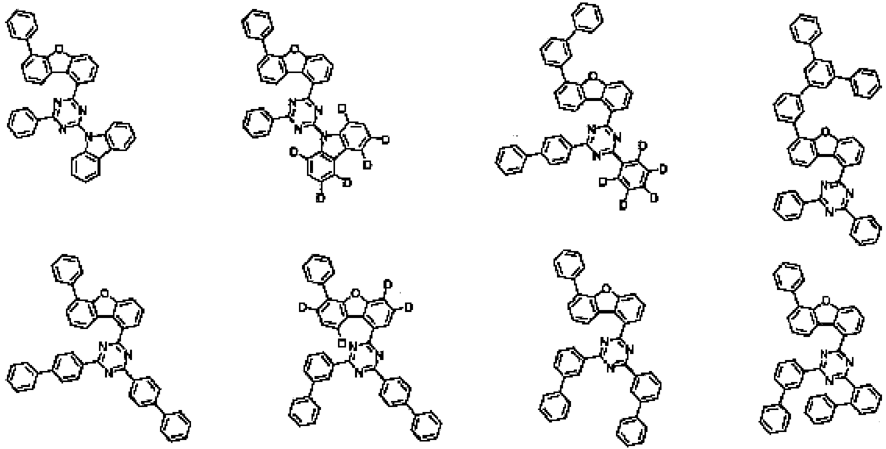

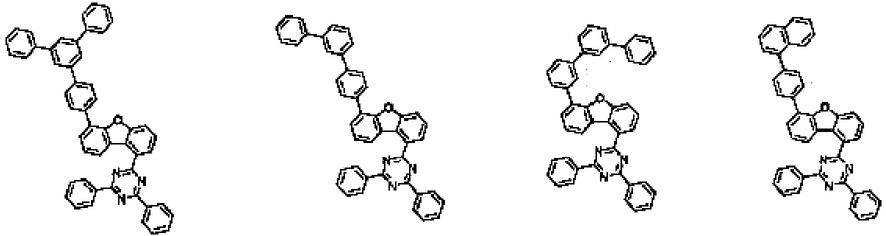

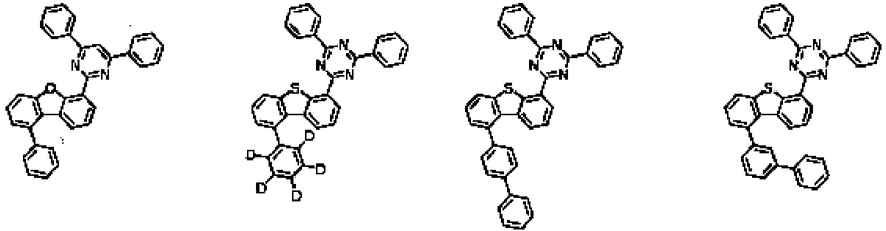

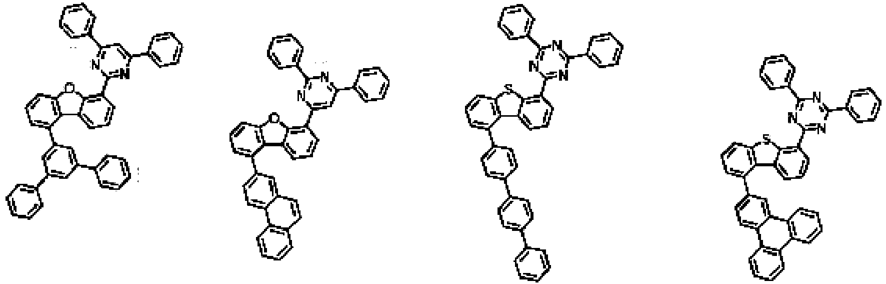

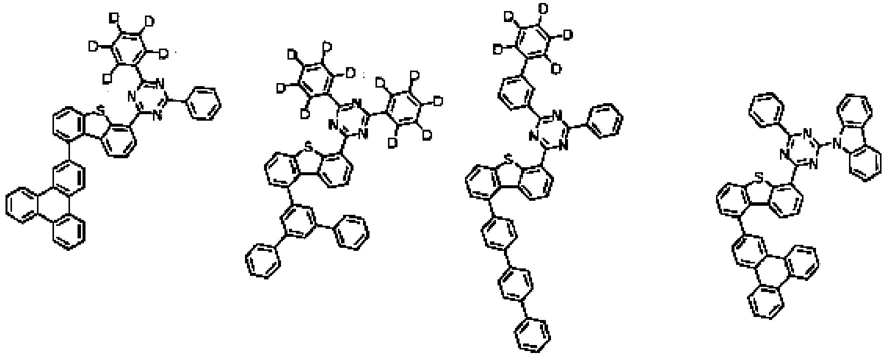

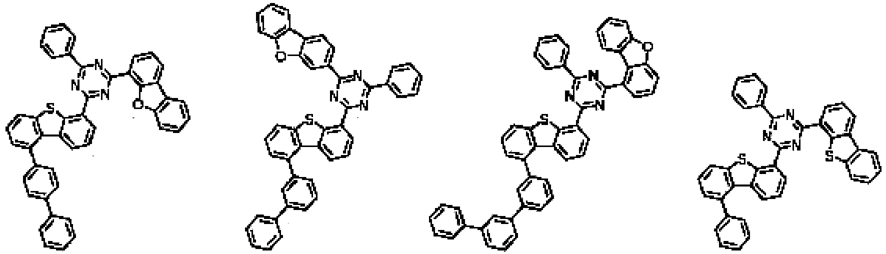

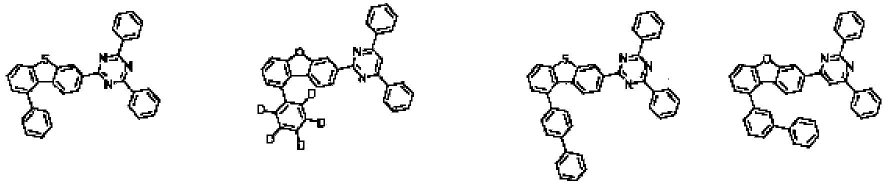

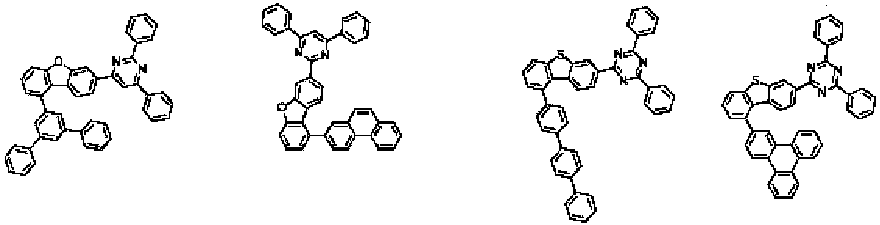

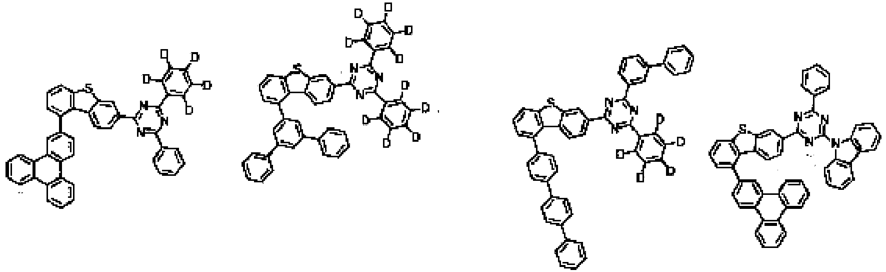

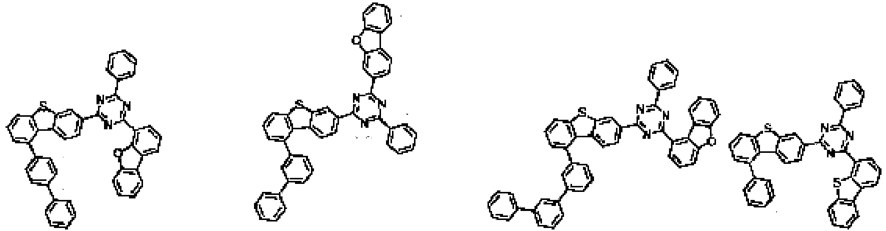

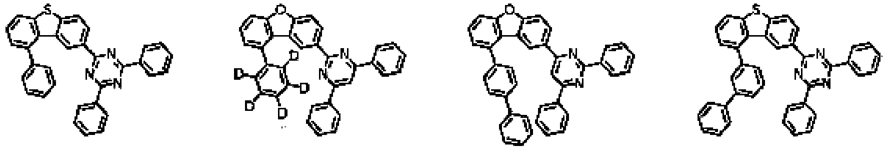

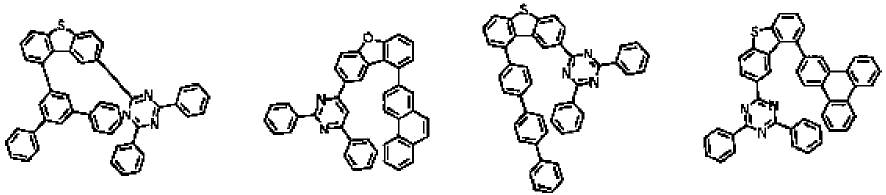

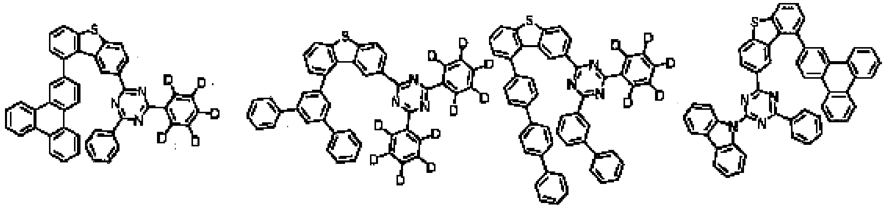

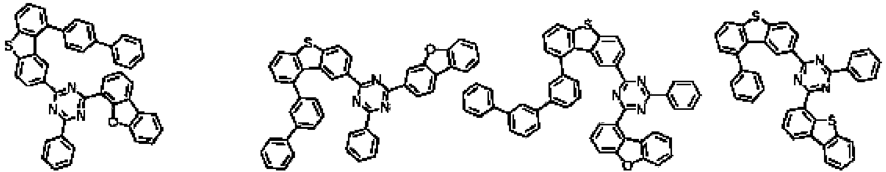

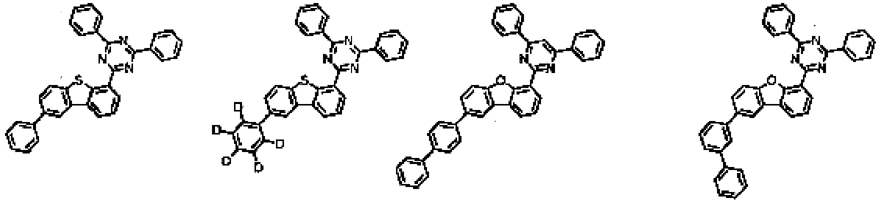

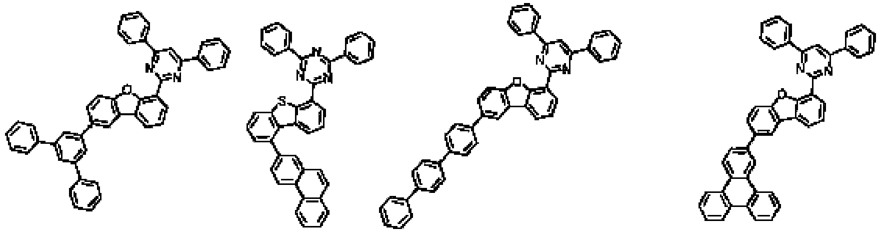

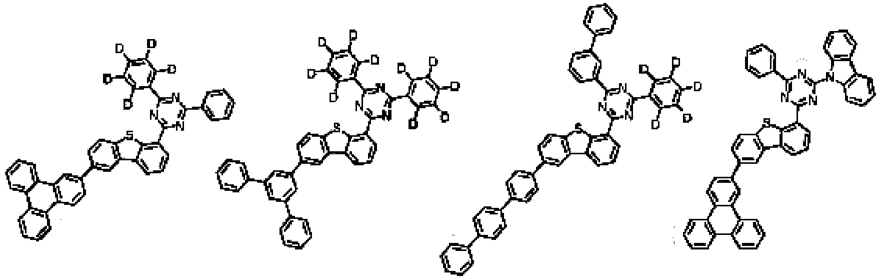

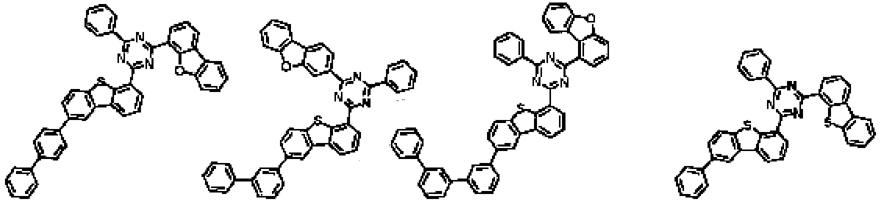

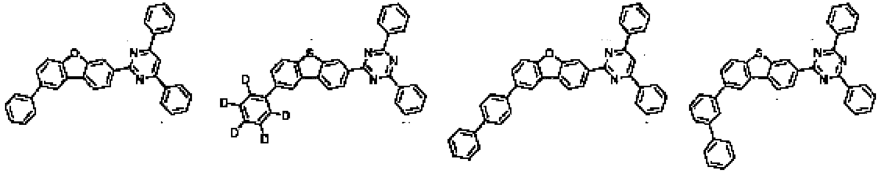

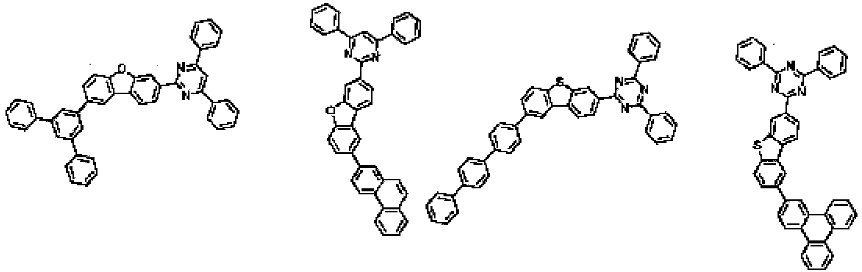

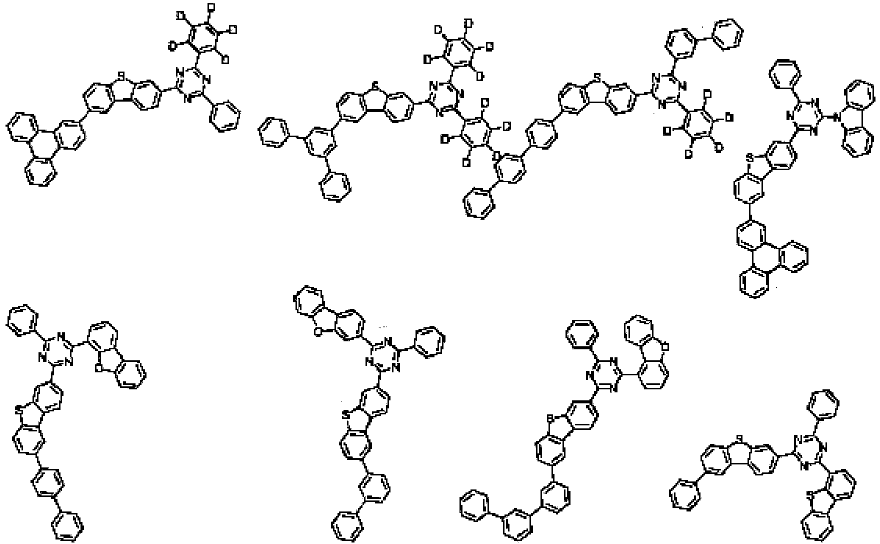

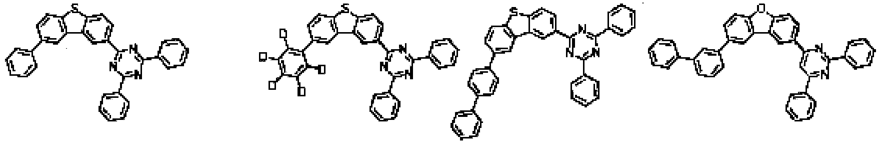

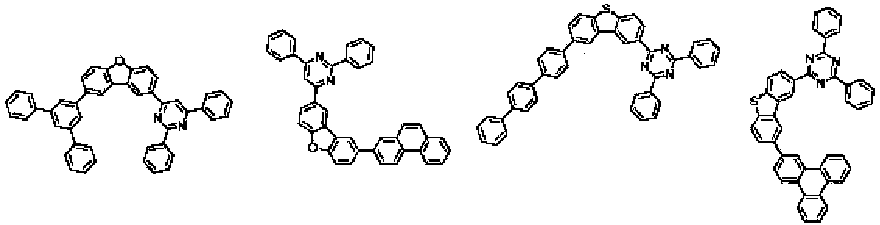

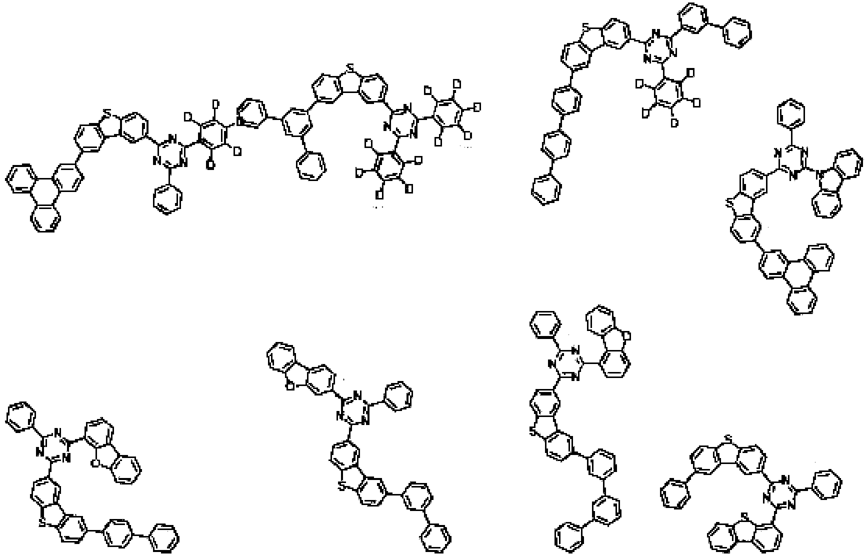

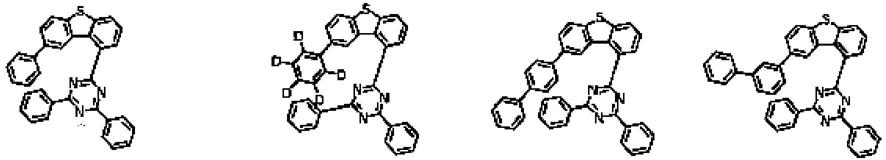

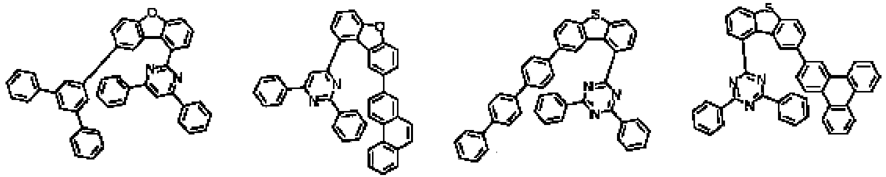

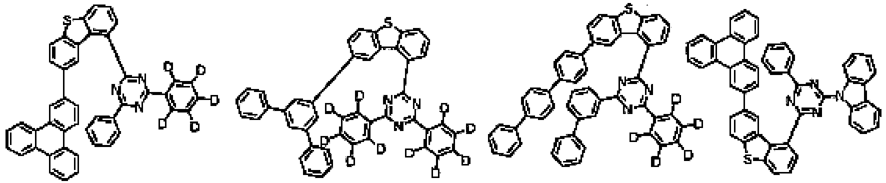

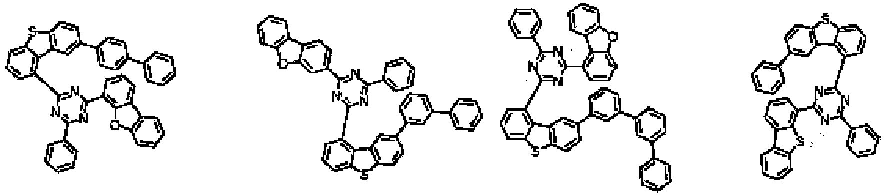

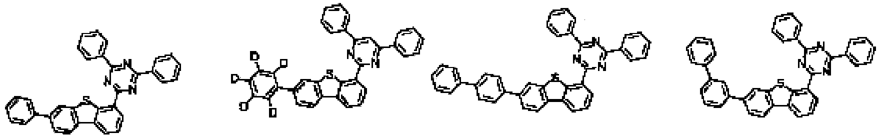

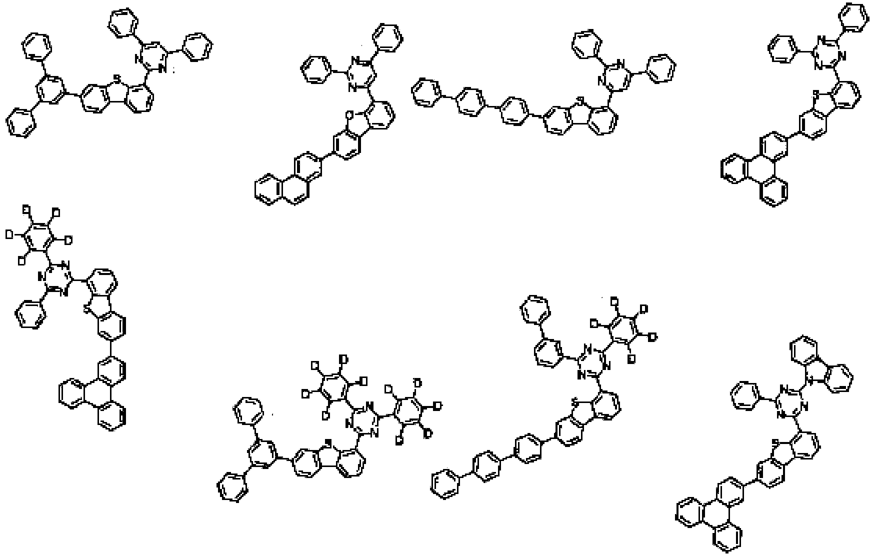

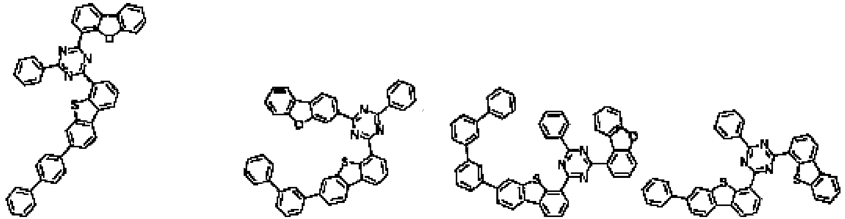

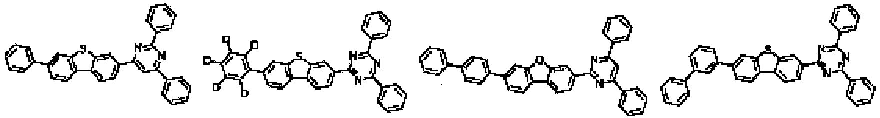

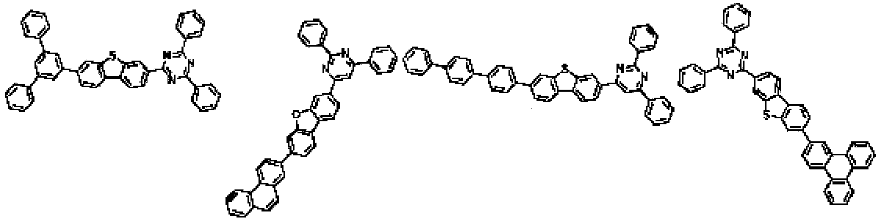

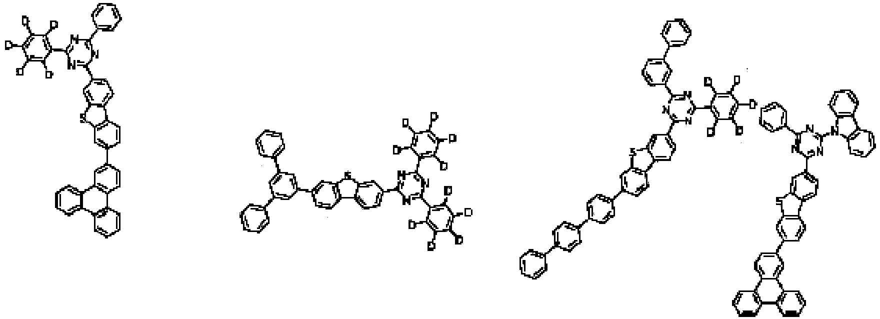

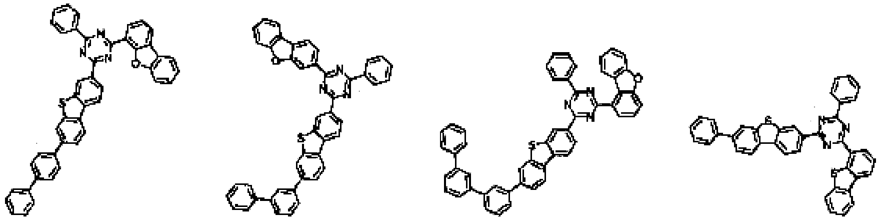

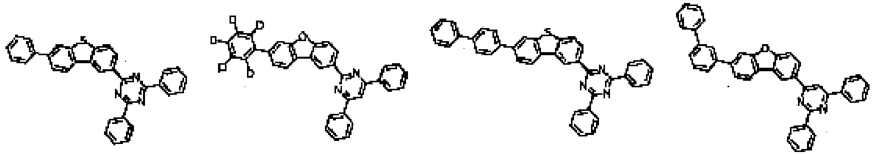

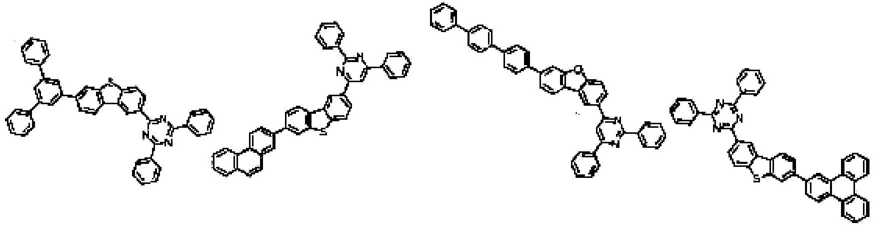

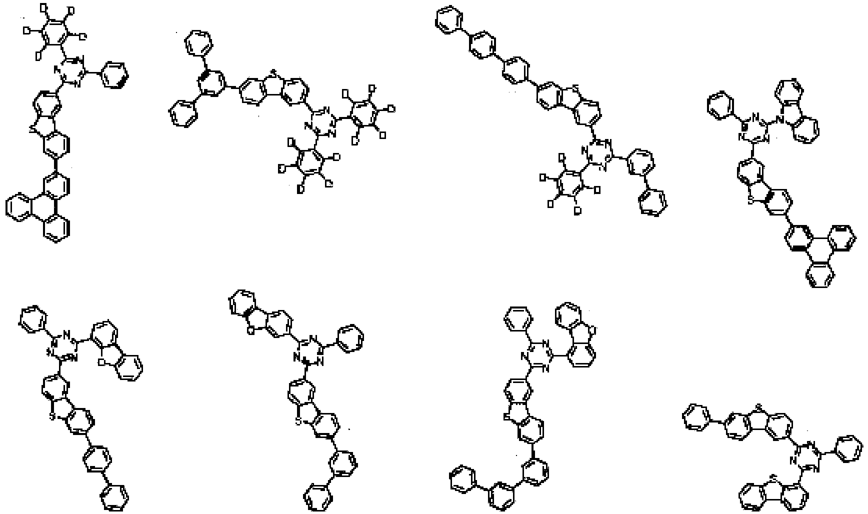

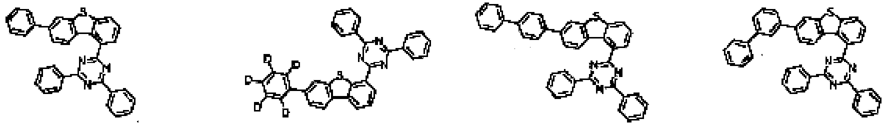

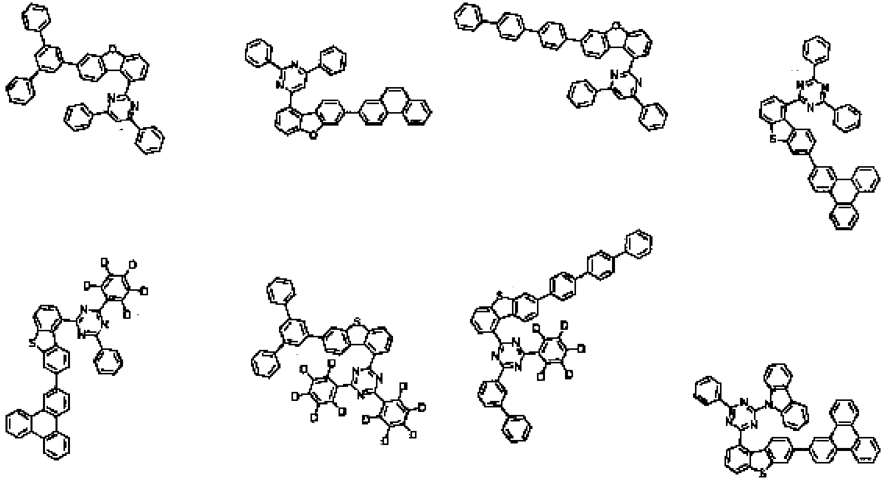

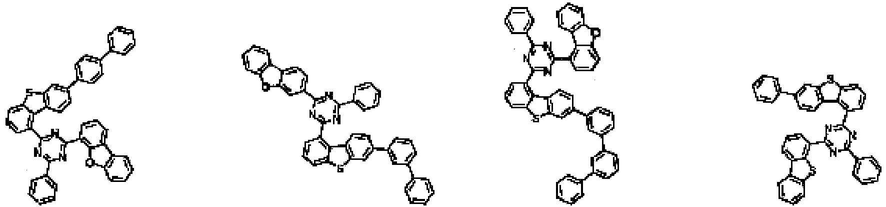

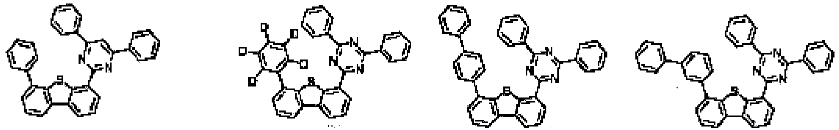

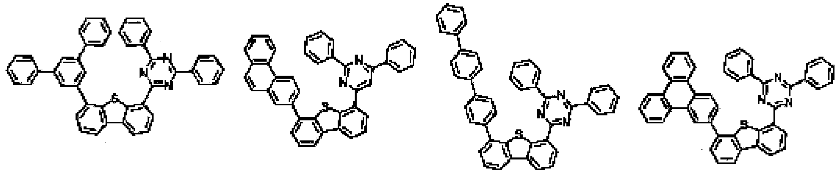

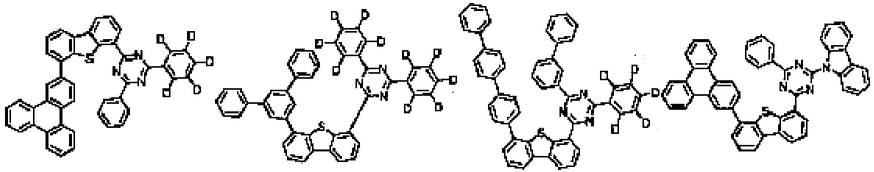

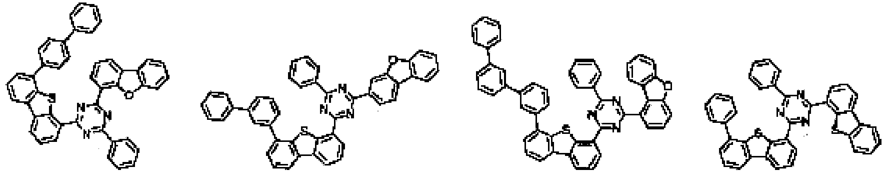

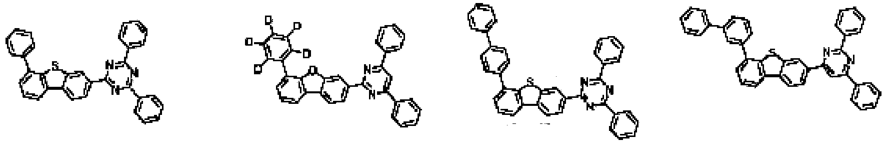

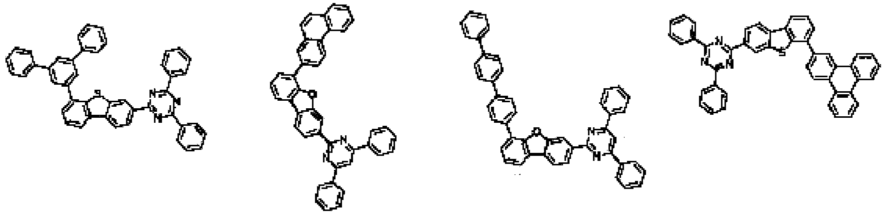

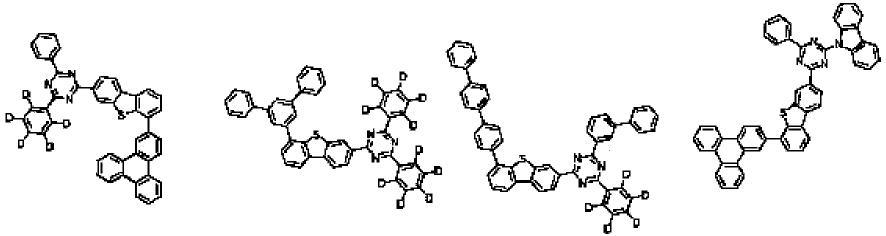

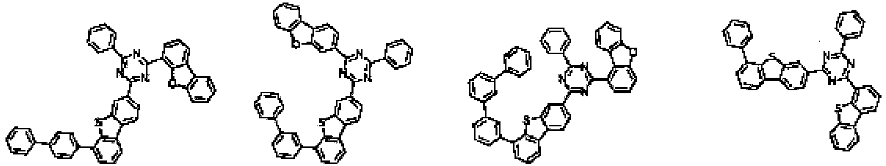

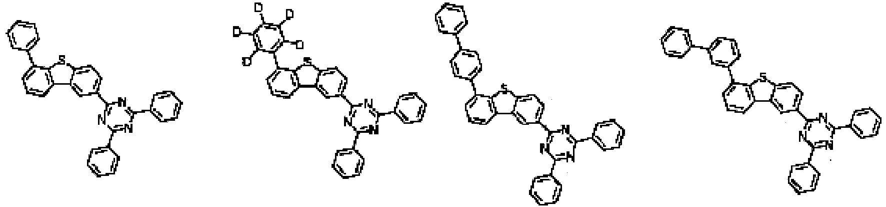

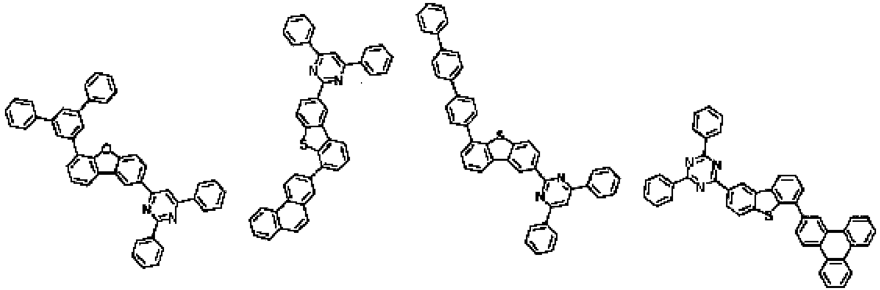

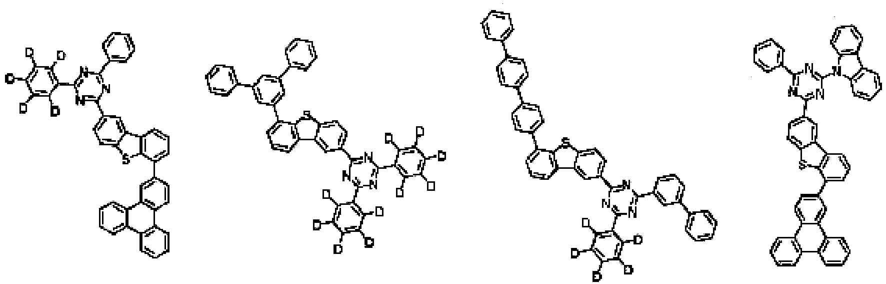

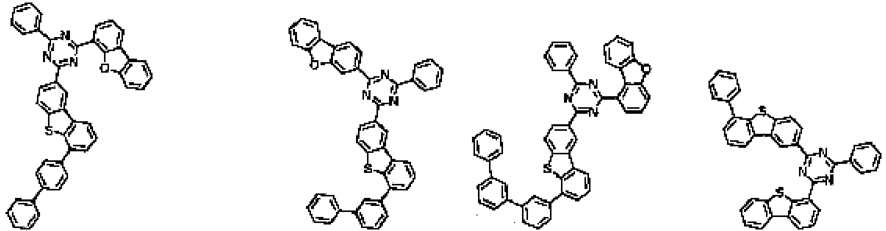

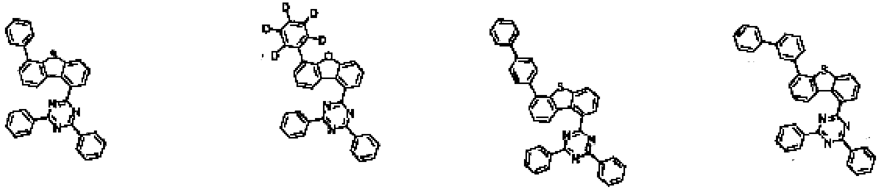

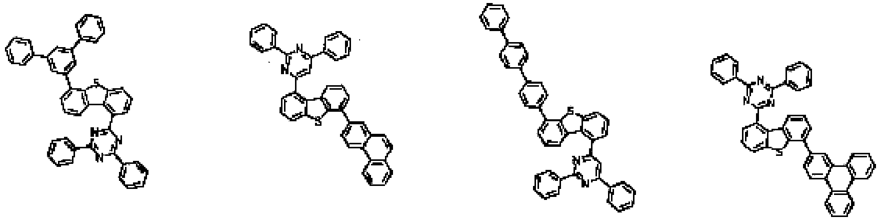

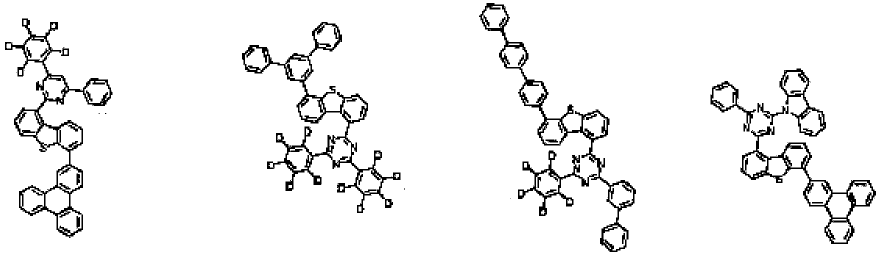

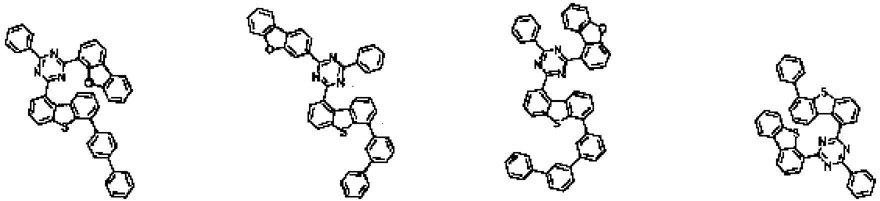

6. Dispositif électroluminescent organique selon la revendication 1, dans lequel :
dans lequel la Formule chimique 2 est représentée par l'une quelconque des formules chimiques 2-1 à 2-4 suivantes : 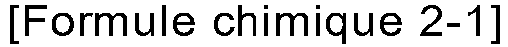 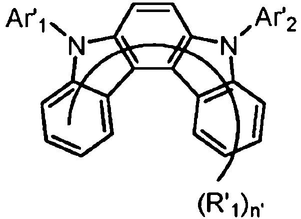 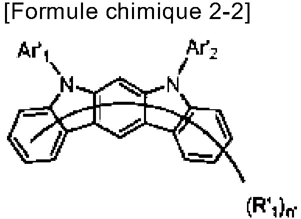 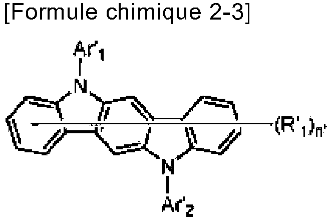 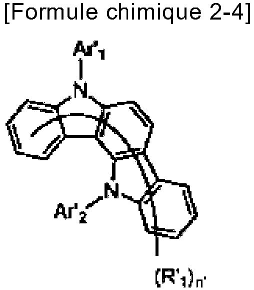
dans lequel, dans les Formules chimiques 2-1 à 2-4 ,
n', R'₁, Ar'₁ et Ar'₂ sont tels que définis dans la revendication 1.

7. Dispositif électroluminescent organique selon la revendication 1, dans lequel :
chaque R'₁ est indépendamment hydrogène ou deutérium.

8. Dispositif électroluminescent organique selon la revendication 1, dans lequel :
Ar'₁ et Ar'₂ sont chacun indépendamment phényle non substitué ou substitué par 1 à 5 deutériums ; biphénylyle non substitué ou substitué par 1 à 9 deutériums ; méthyl-biphénylyle non substitué ou substitué par 1 à 11 deutériums ; diméthyl-biphénylyle non substitué ou substitué par 1 à 13 deutériums ; terphénylyle non substitué ou substitué par 1 à 13 deutériums ; diméthylfluorényle non substitué ou substitué par 1 à 13 deutériums ; dibenzofuranyle non substitué ou substitué par 1 à 7 deutériums ; dibenzothiophényle non substitué ou substitué par 1 à 7 deutériums ; diméthylfluorényl-phényle non substitué ou substitué par 1 à 17 deutériums ; dibenzofuranyl-phényle non substitué ou substitué par 1 à 11 deutériums ; ou dibenzothiophényl-phényle non substitué ou substitué par 1 à 11 deutériums.

9. Dispositif électroluminescent organique selon la revendication 1, dans lequel :
le composé représenté par la Formule chimique 2 est un quelconque sélectionné dans le groupe consistant en : 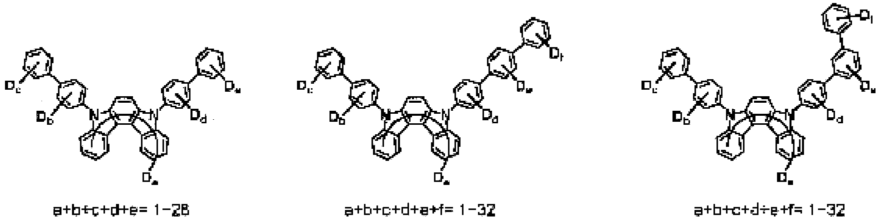 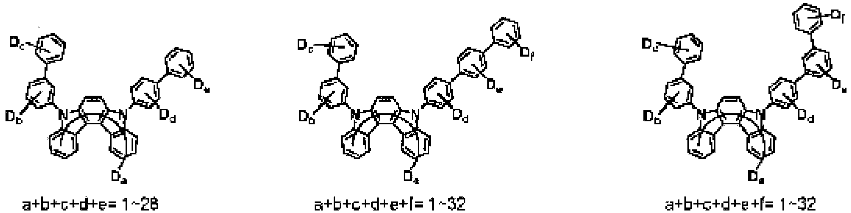 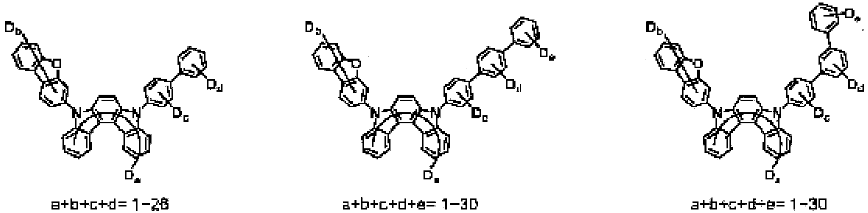 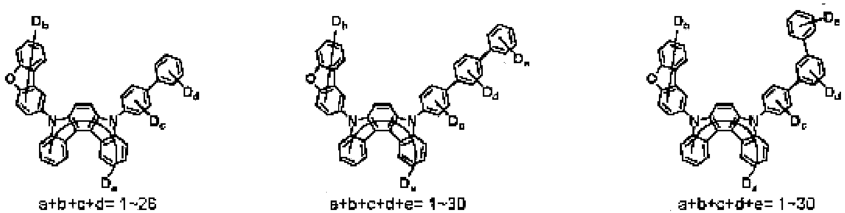 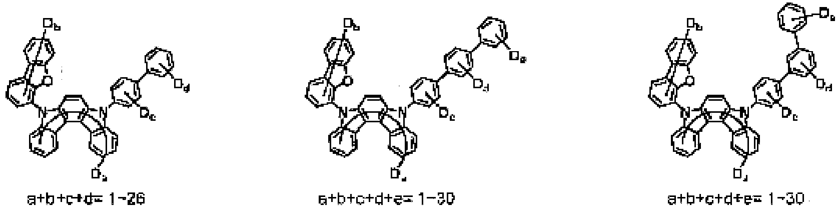 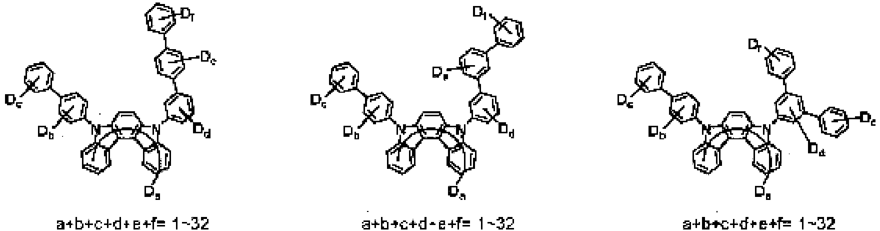 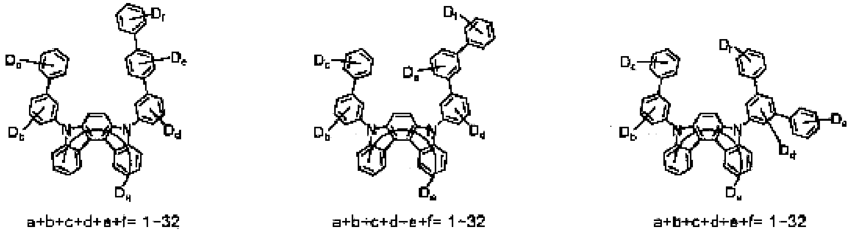 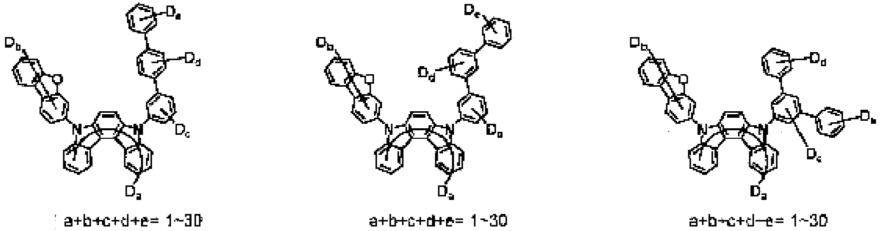 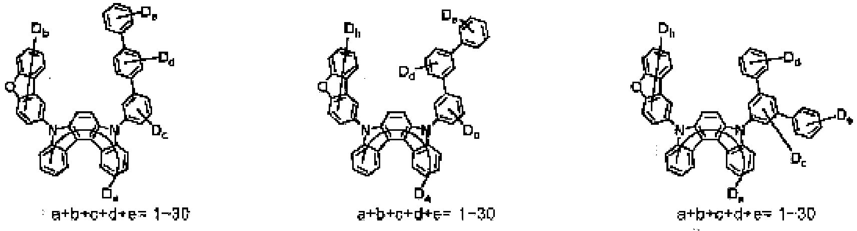 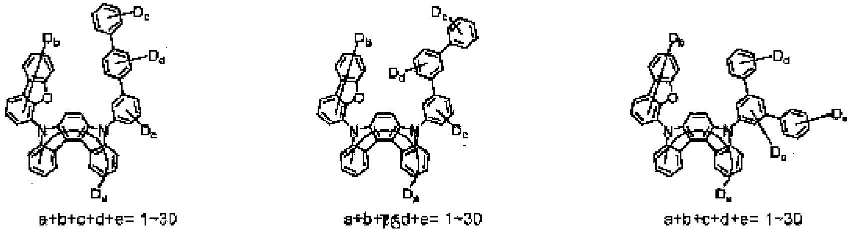 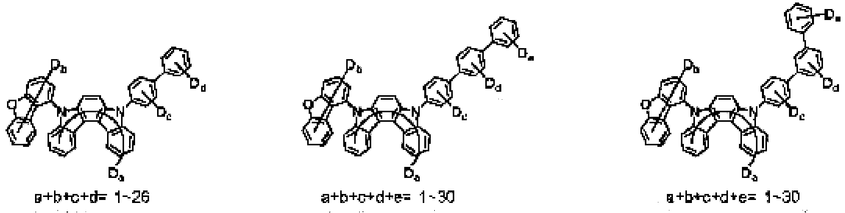 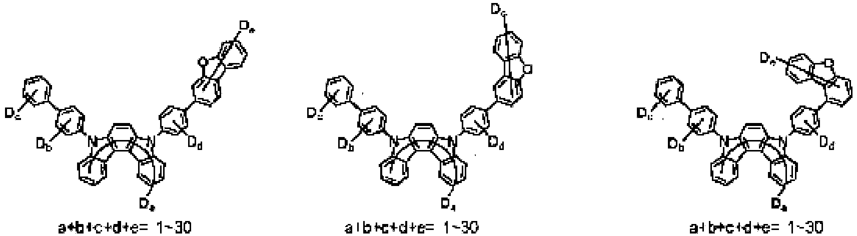 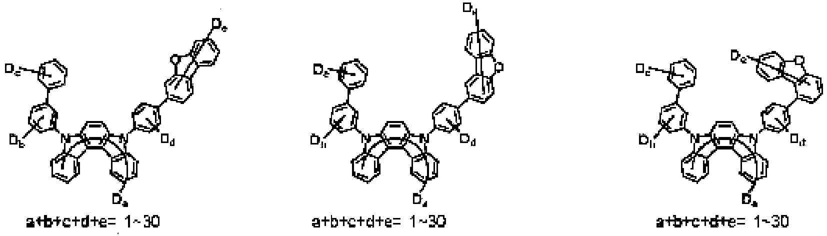 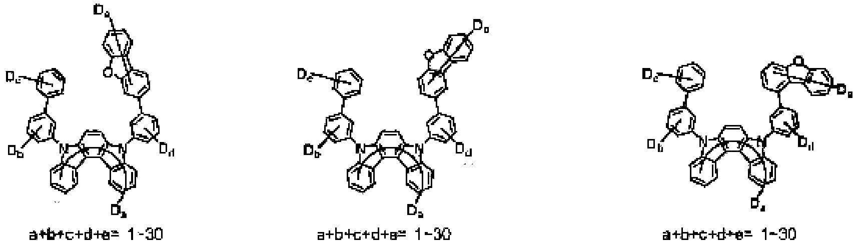 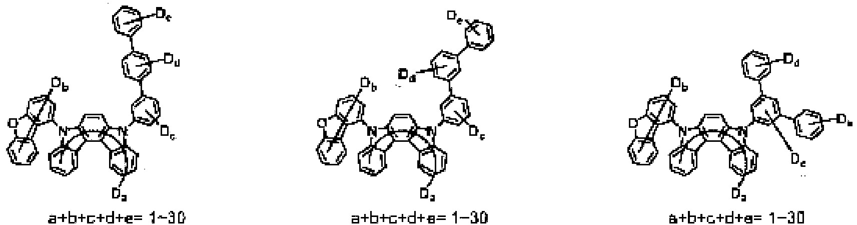 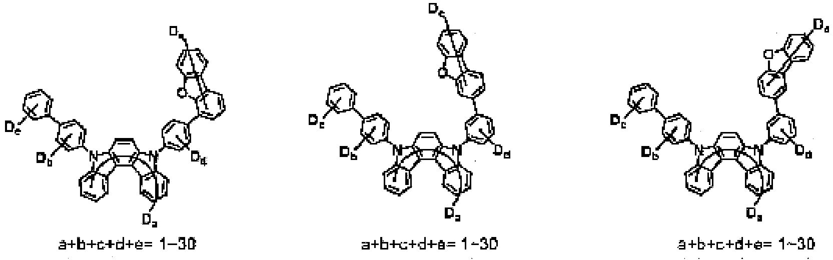 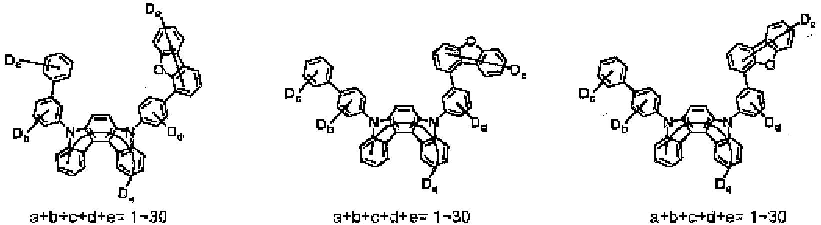 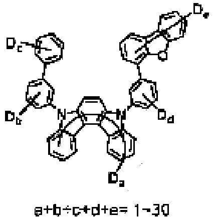 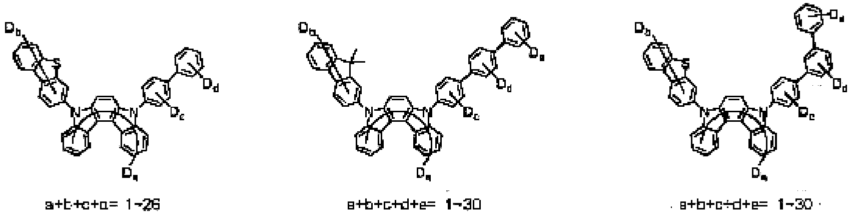 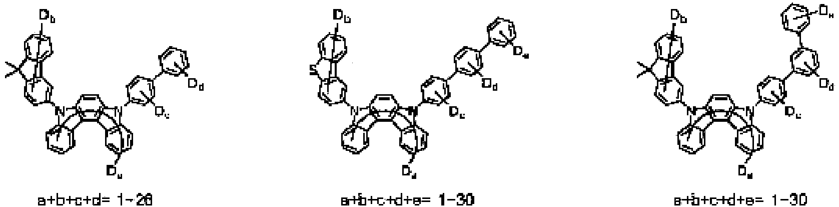 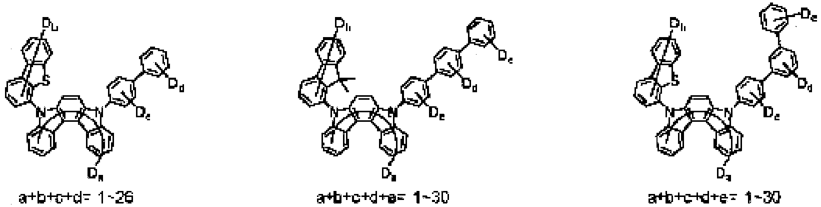 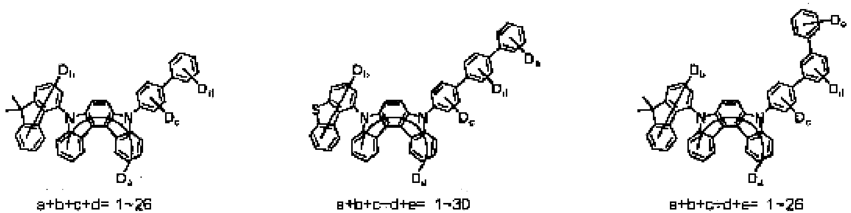 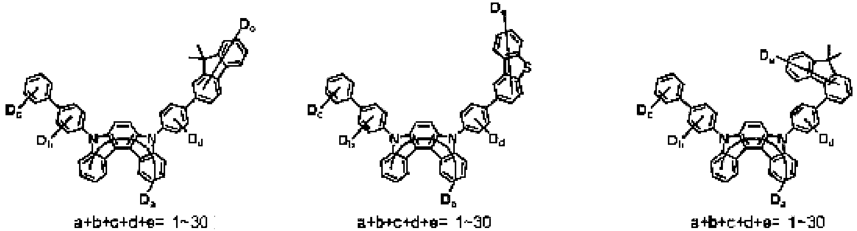 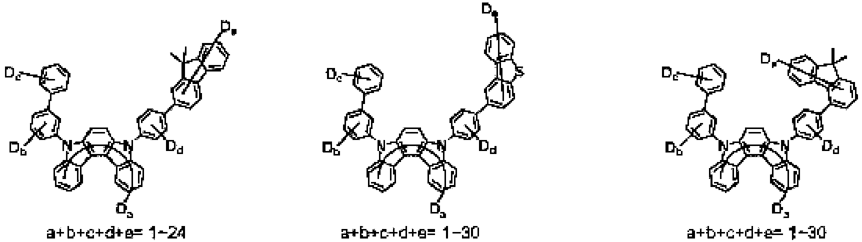 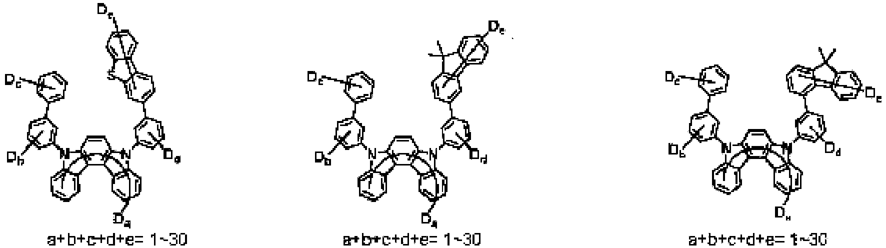 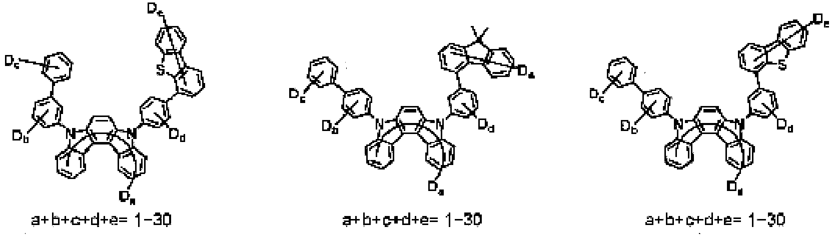 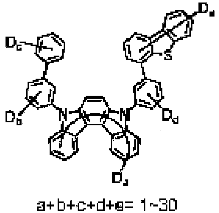 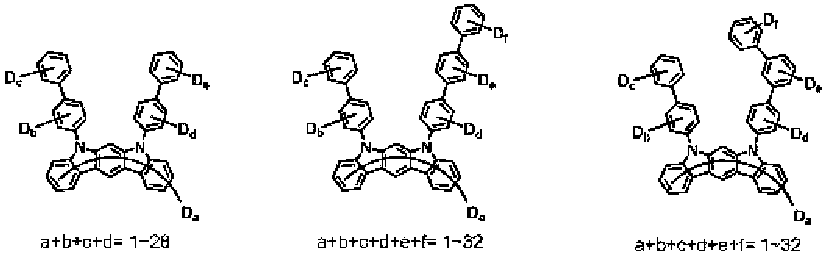 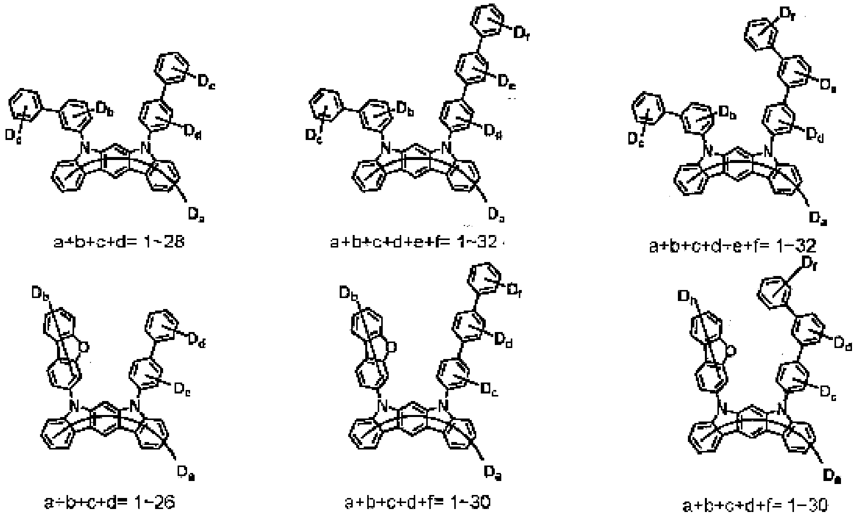 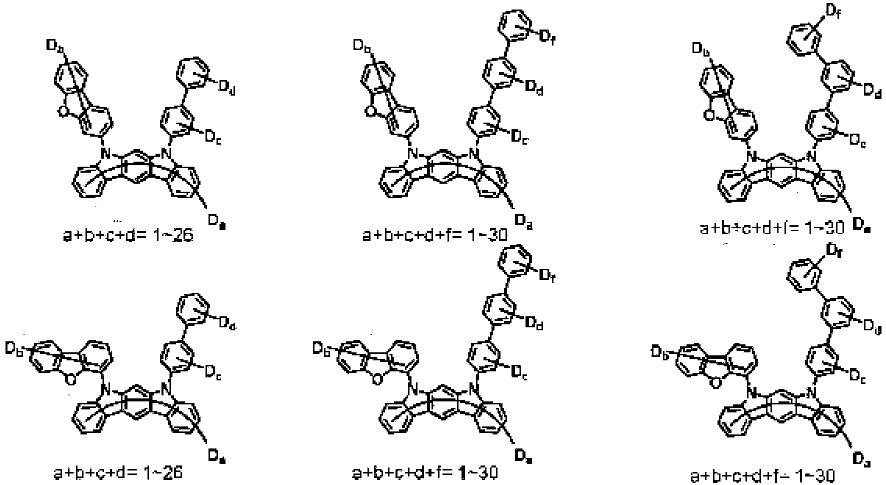 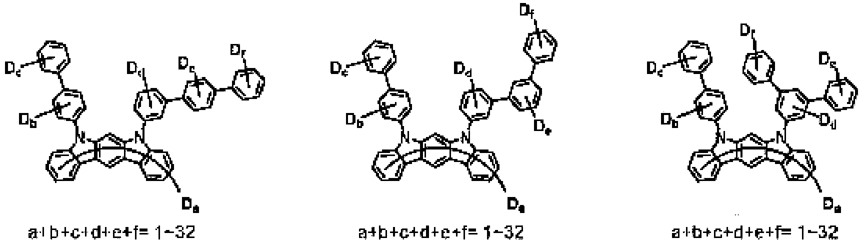 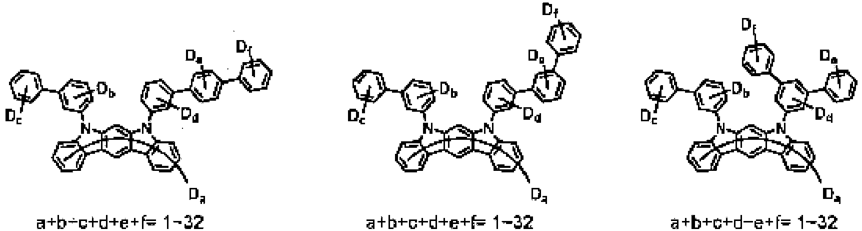 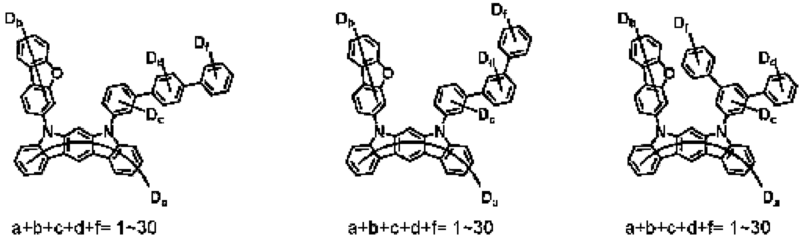 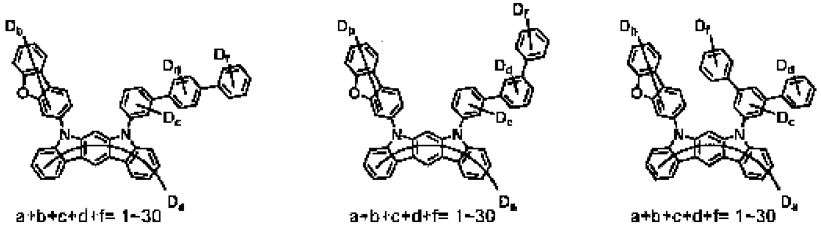 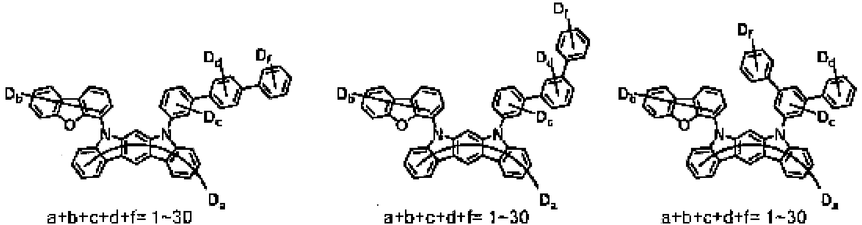 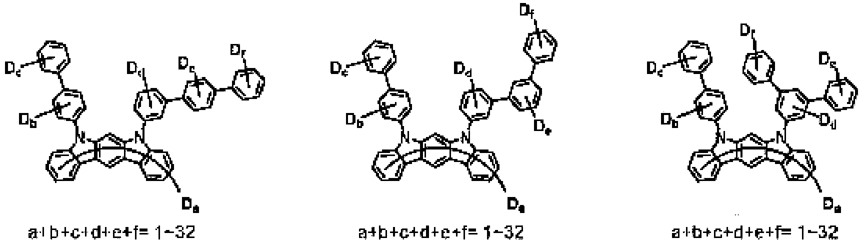 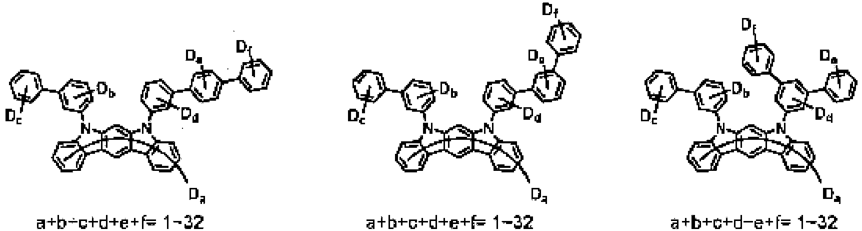 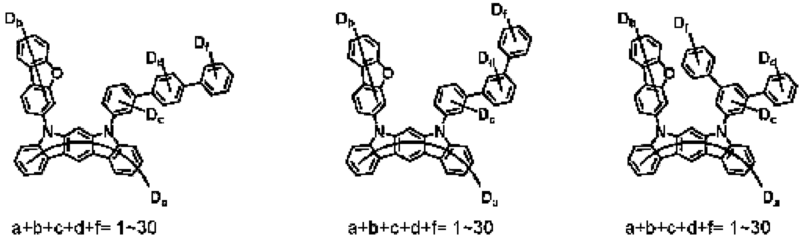 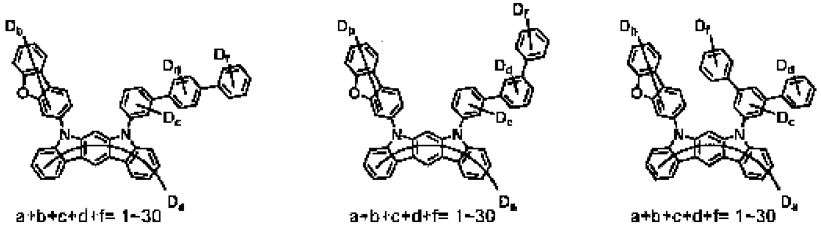 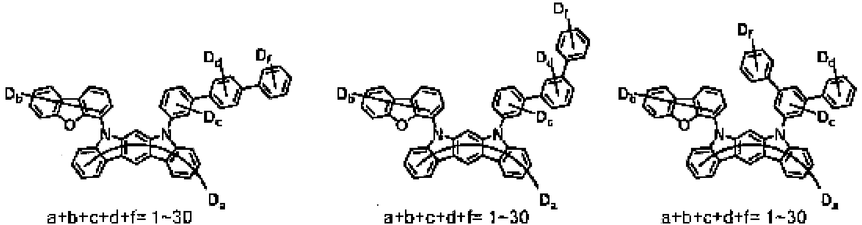 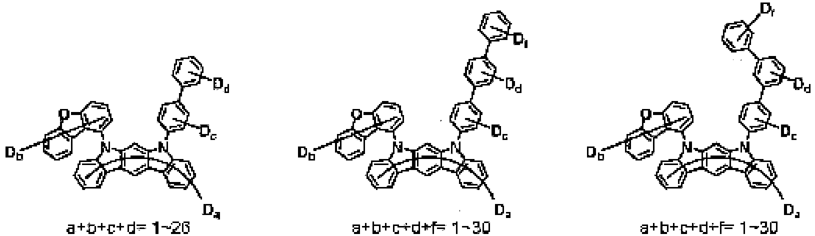 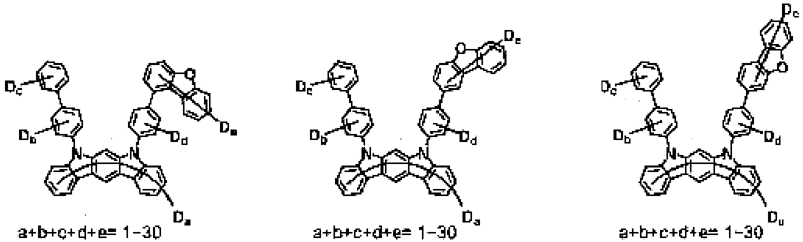 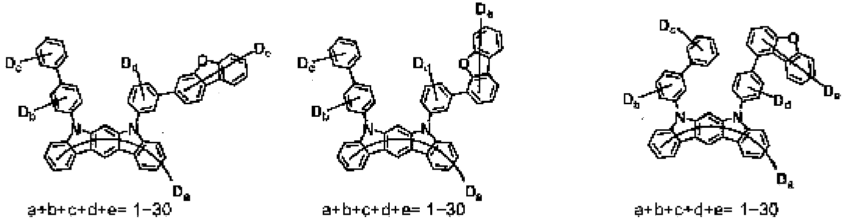 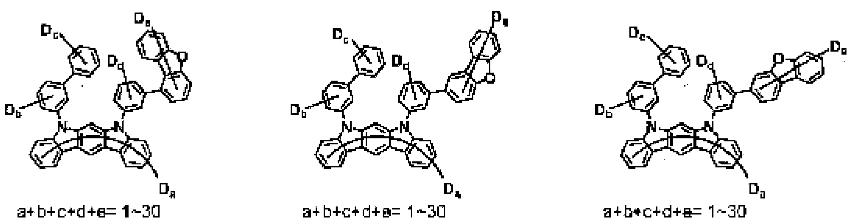 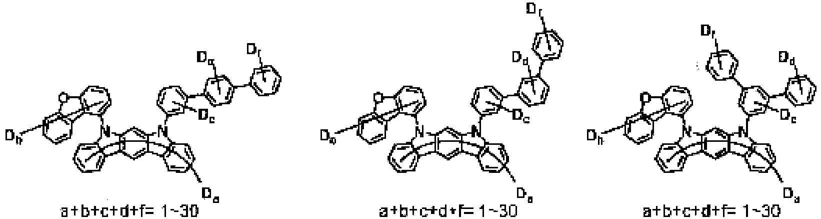 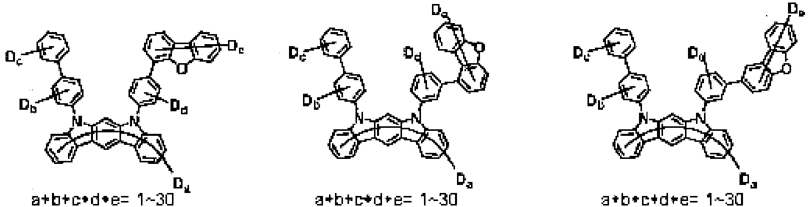 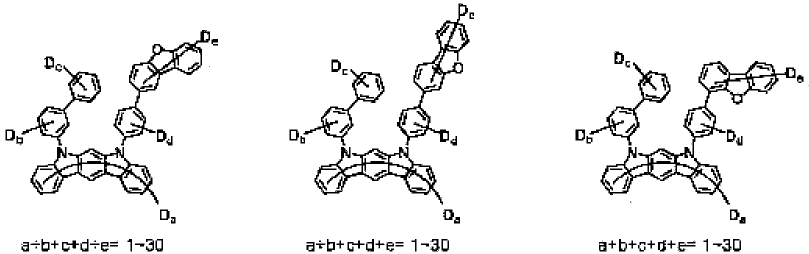 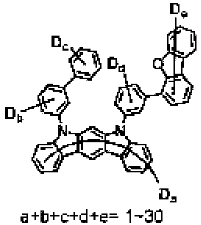 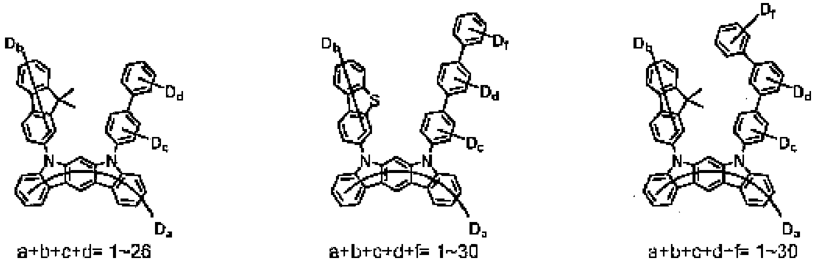 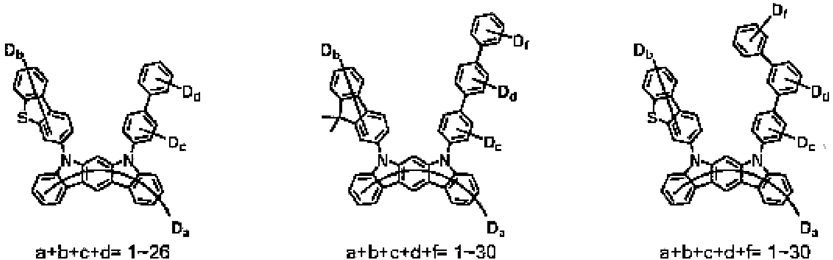 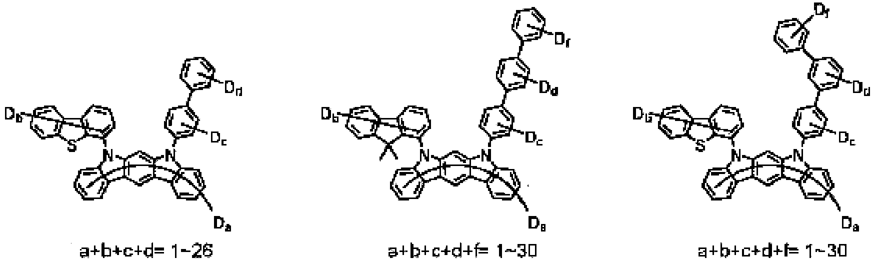 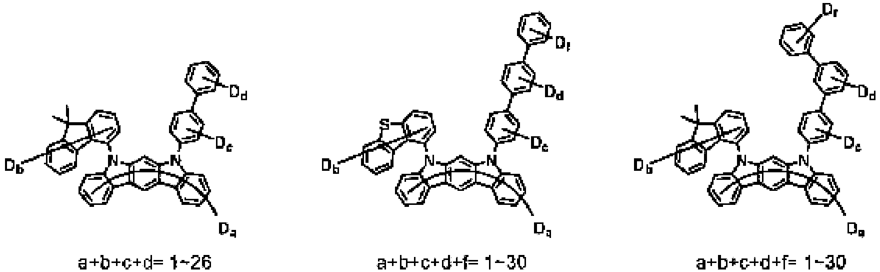 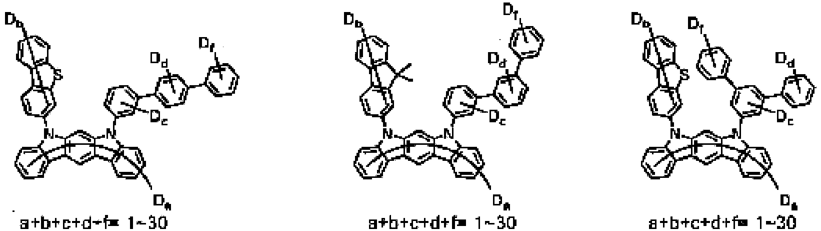 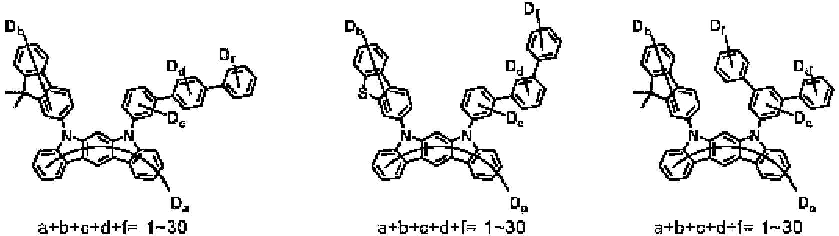 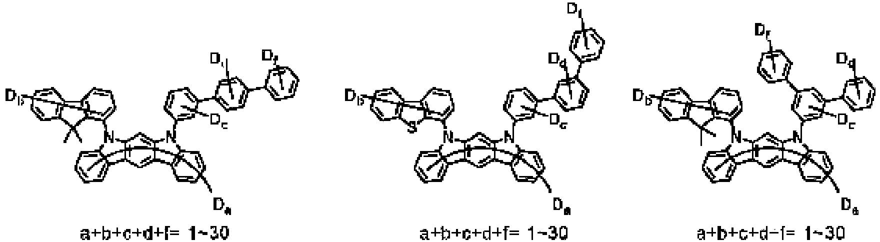 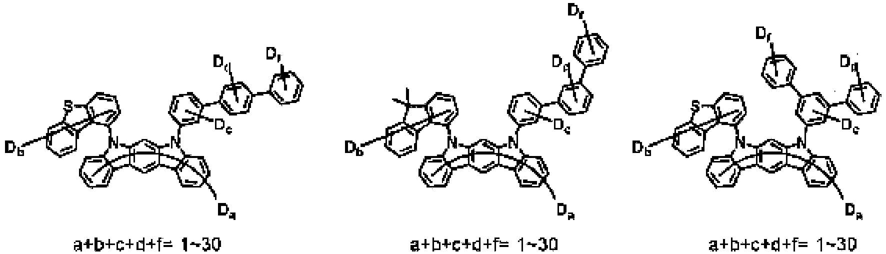 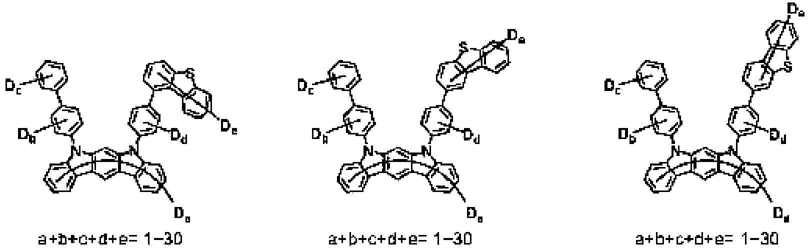 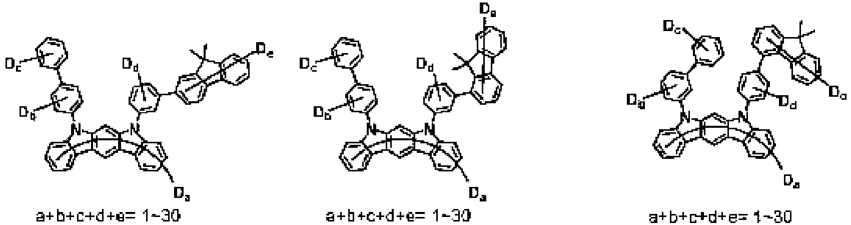 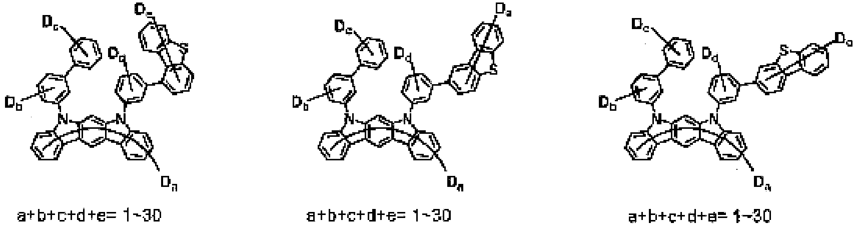 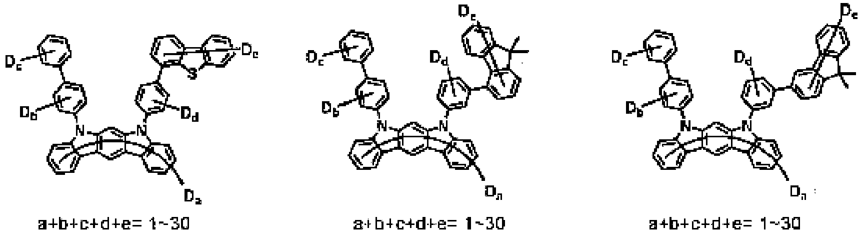 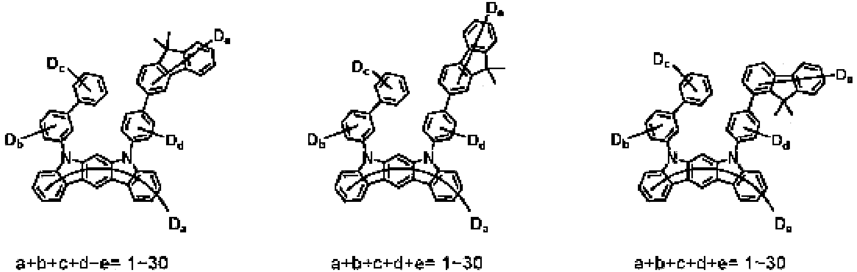 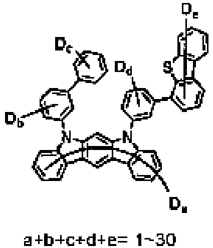 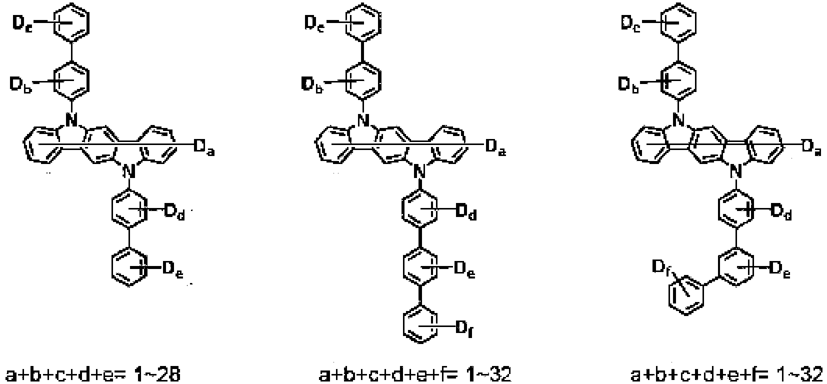 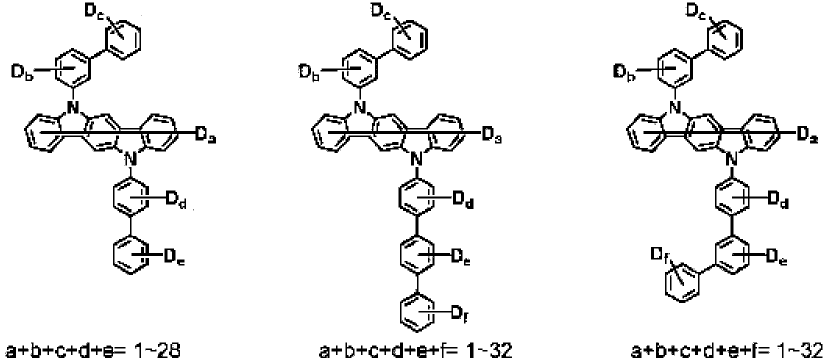 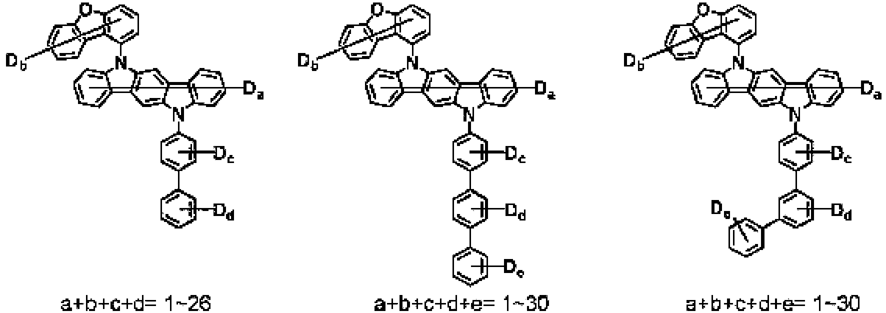 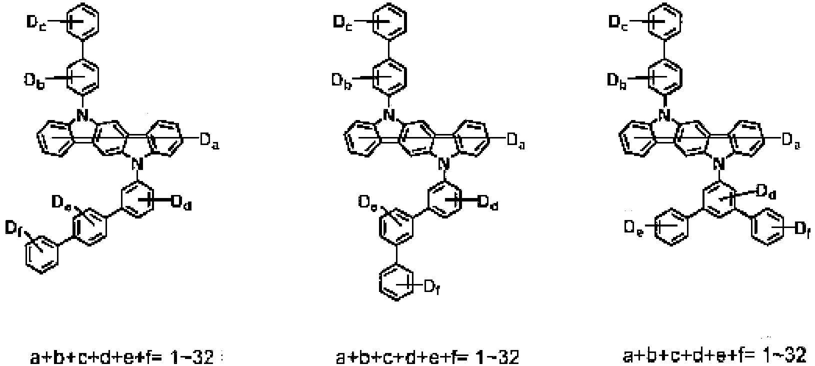 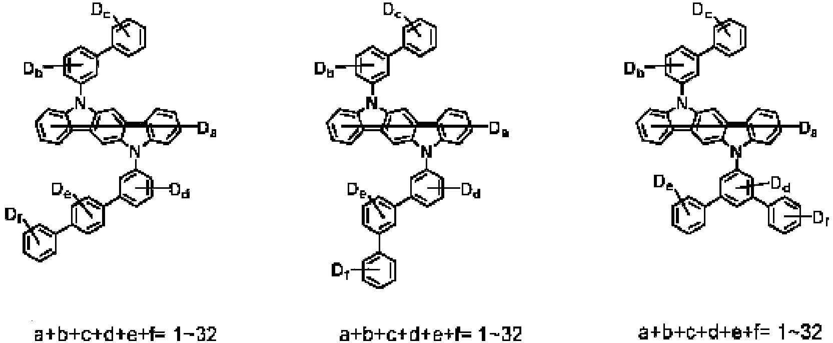 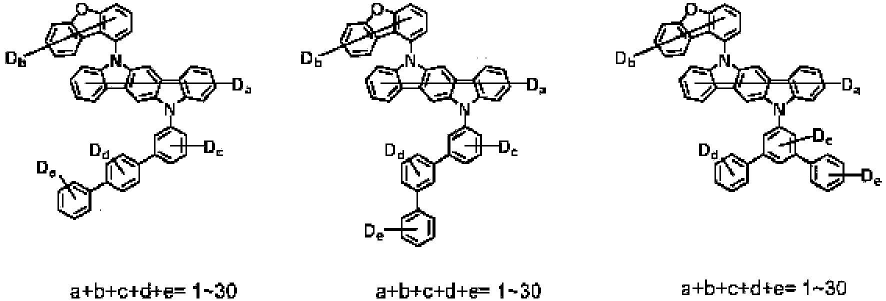 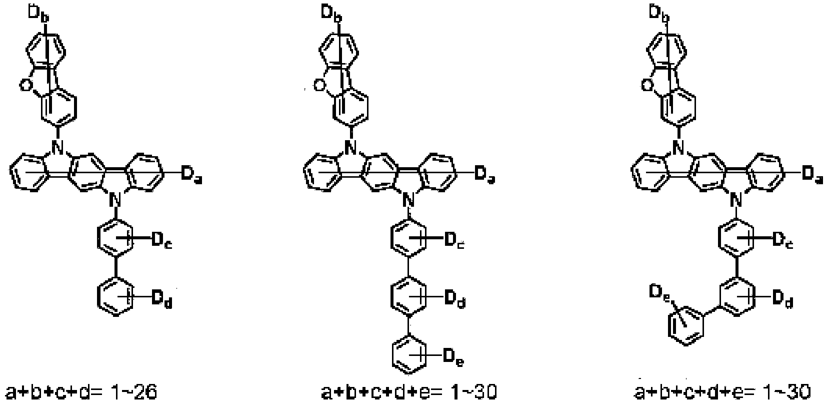 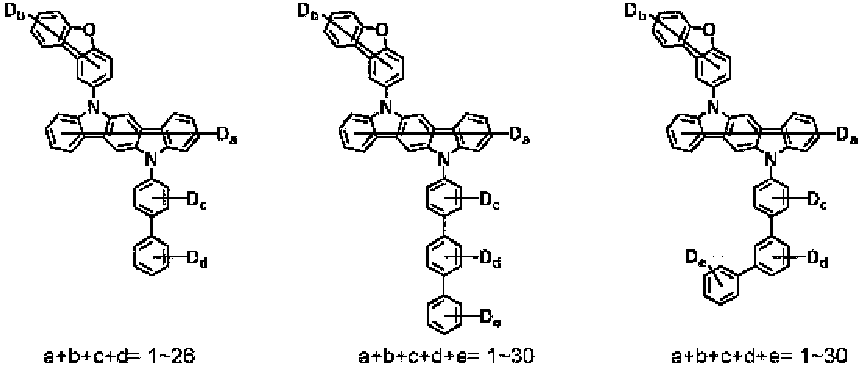 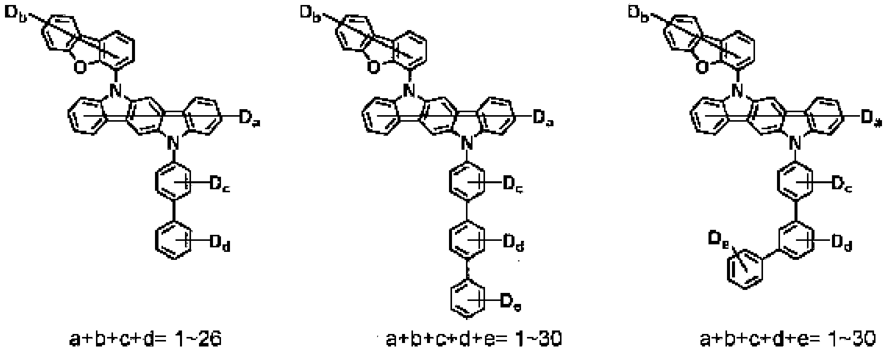 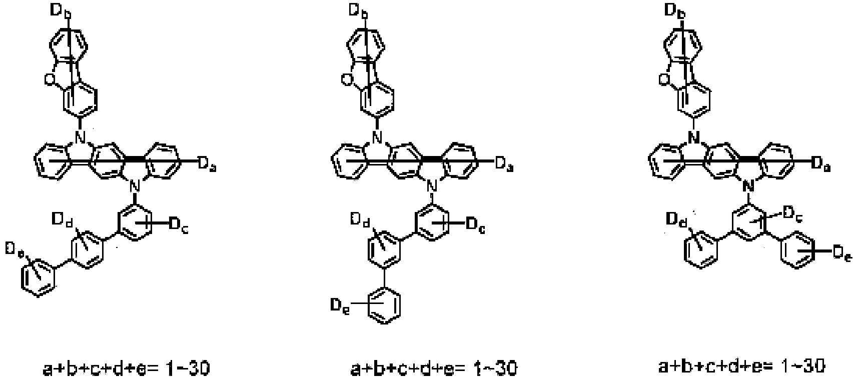 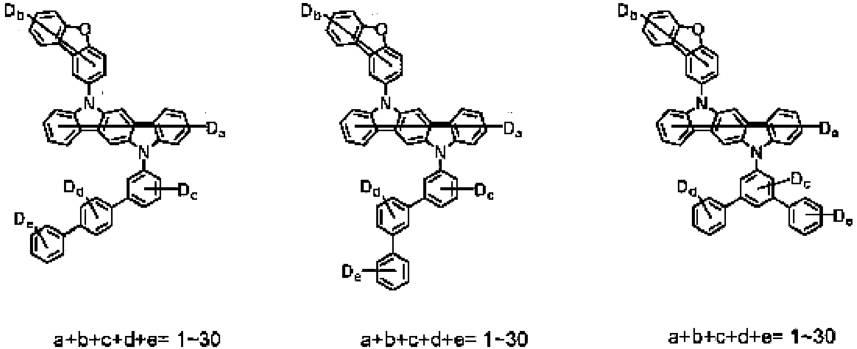 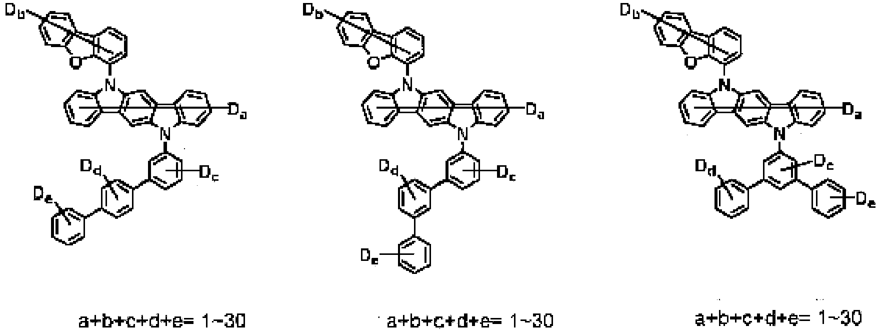 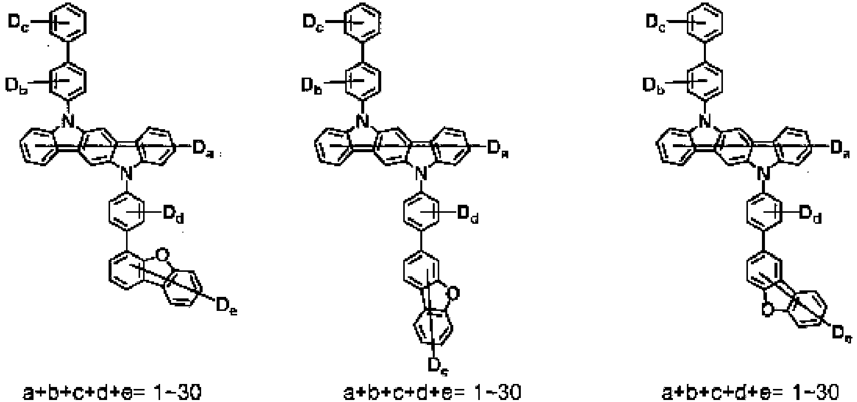 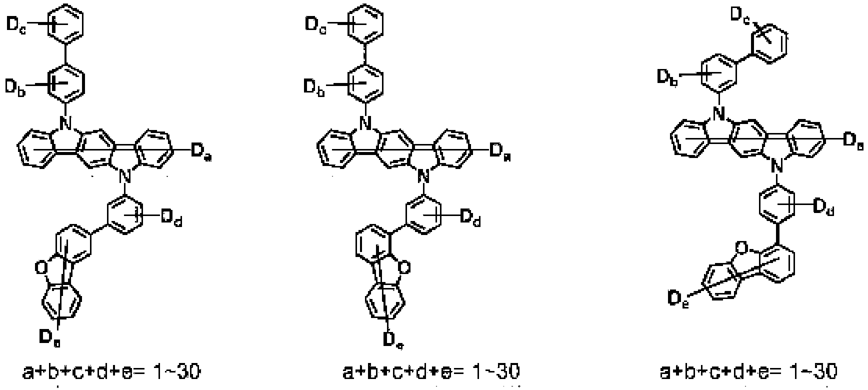 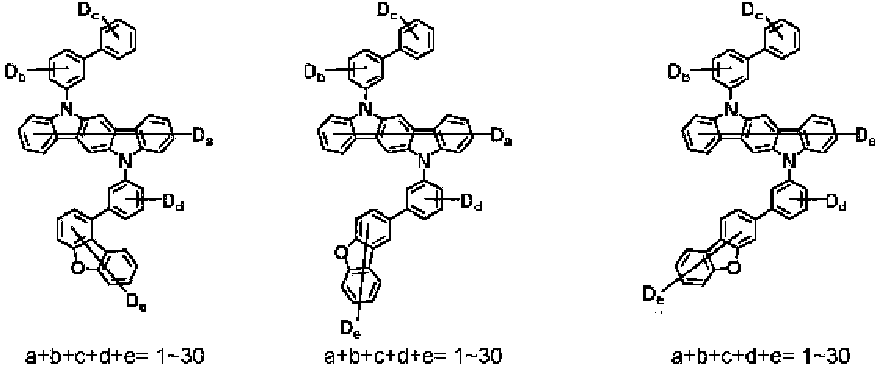 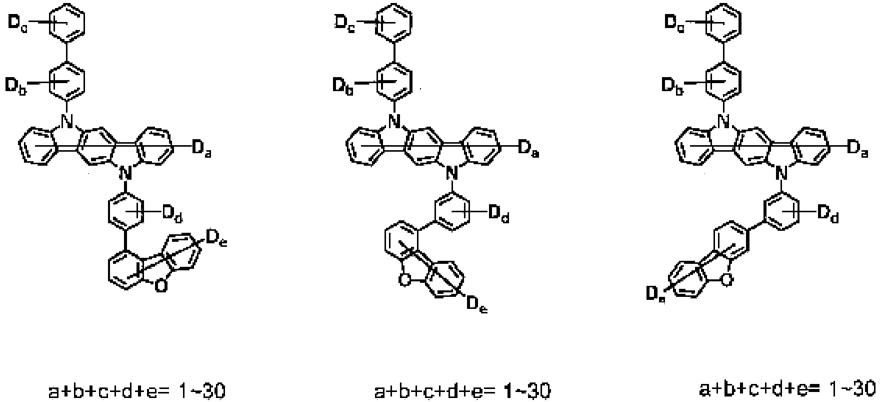 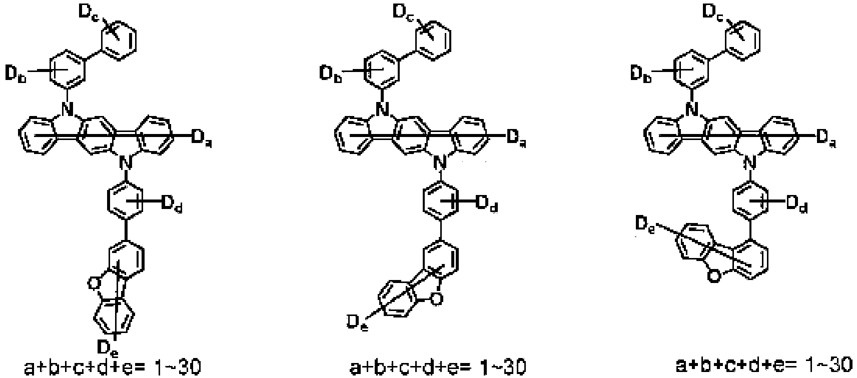 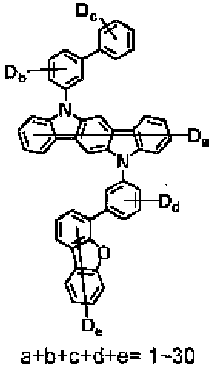 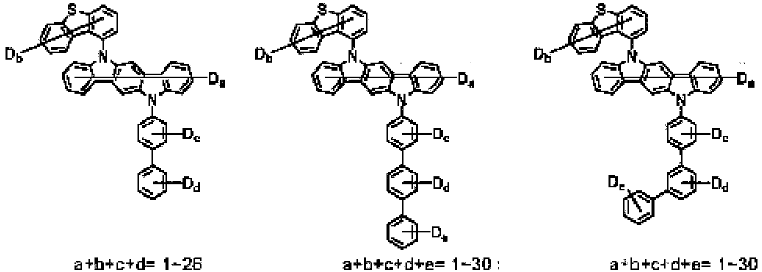 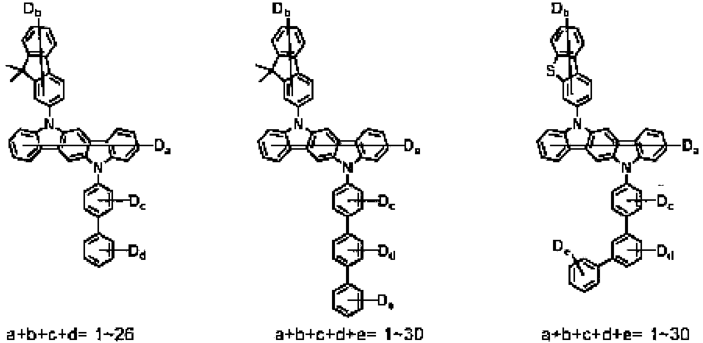 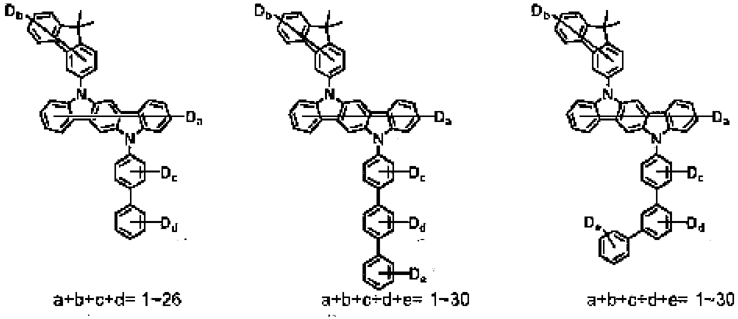 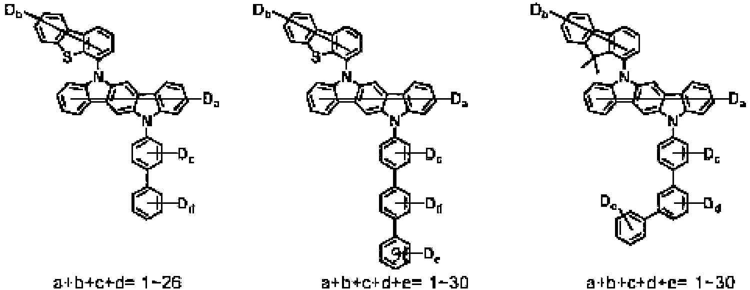 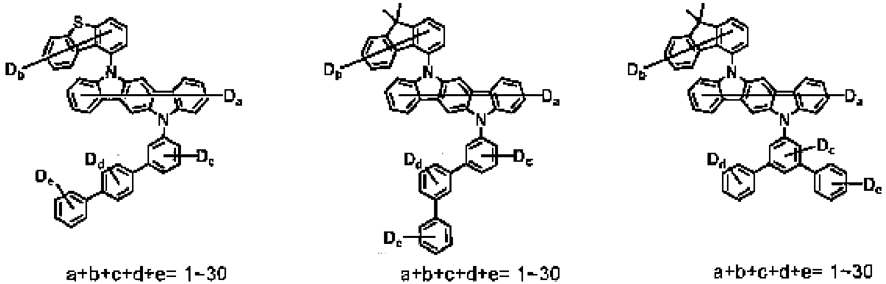 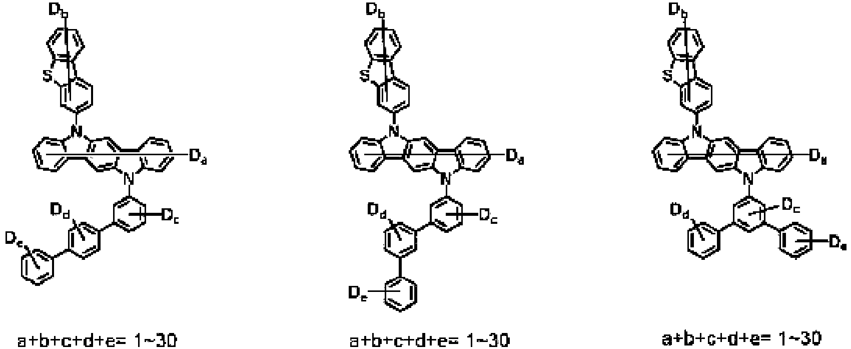 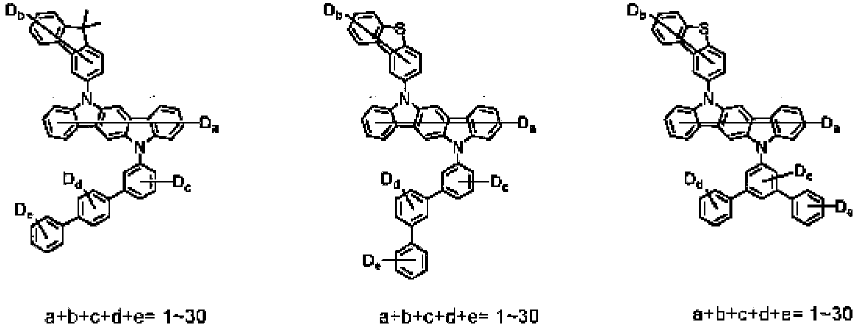 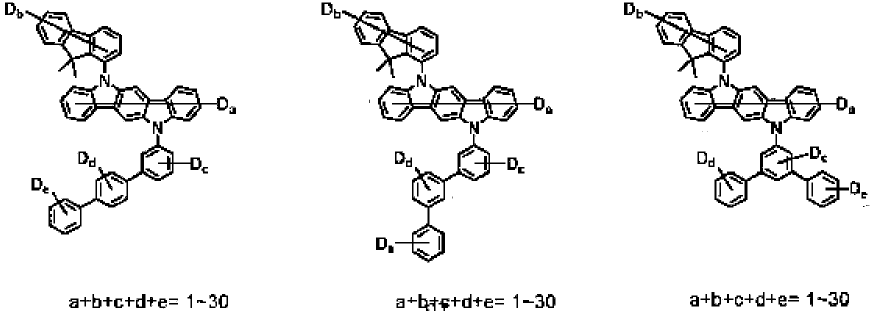 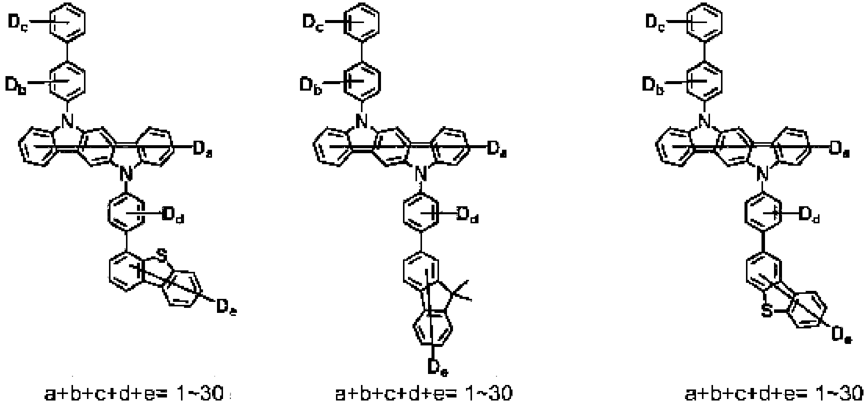 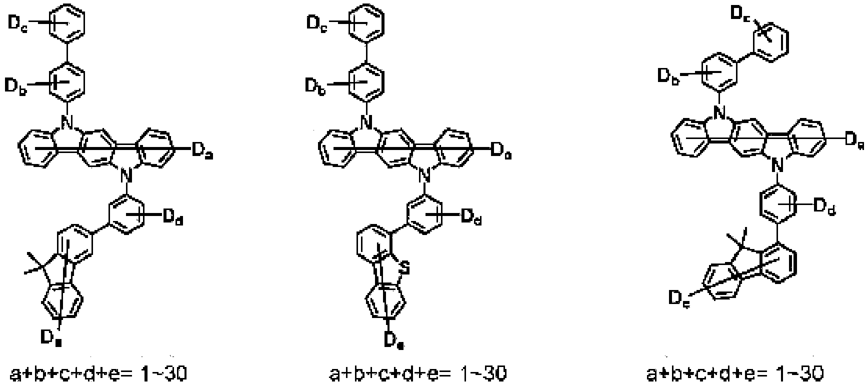 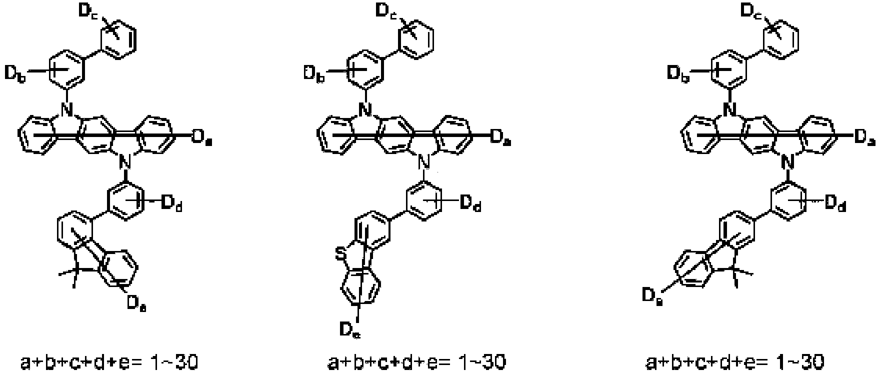 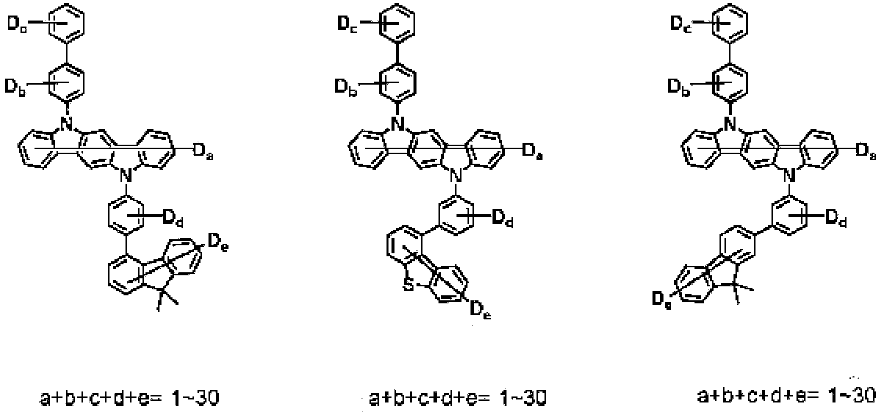 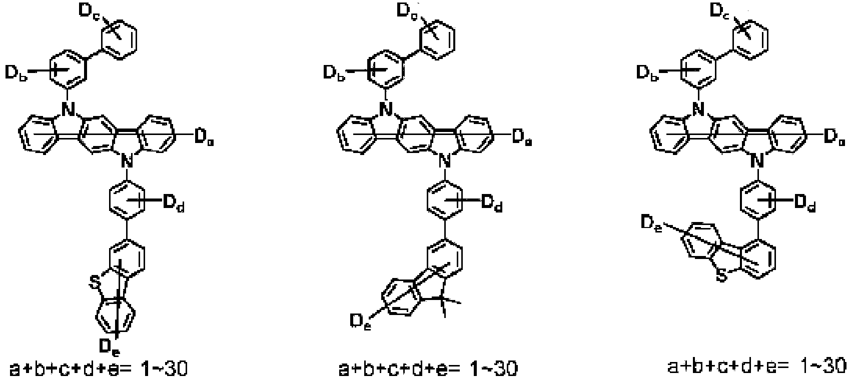 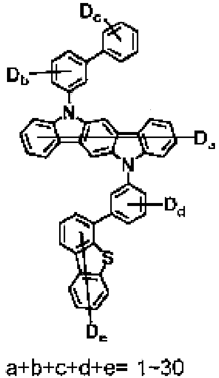 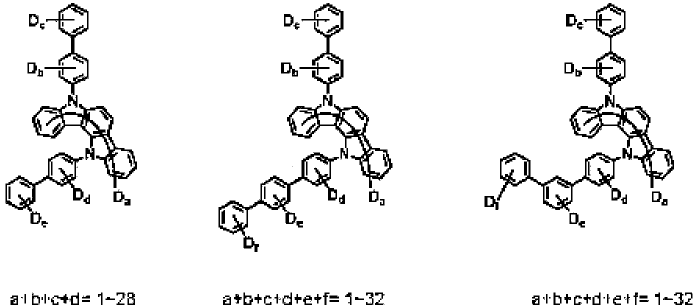 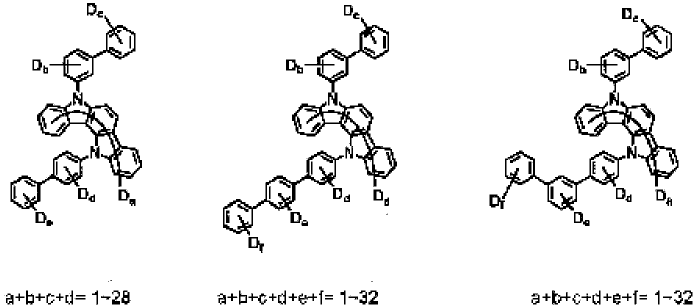 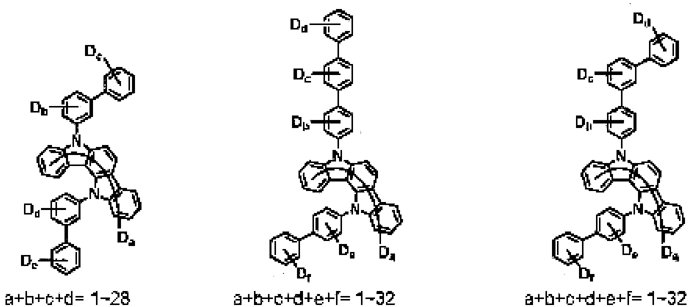 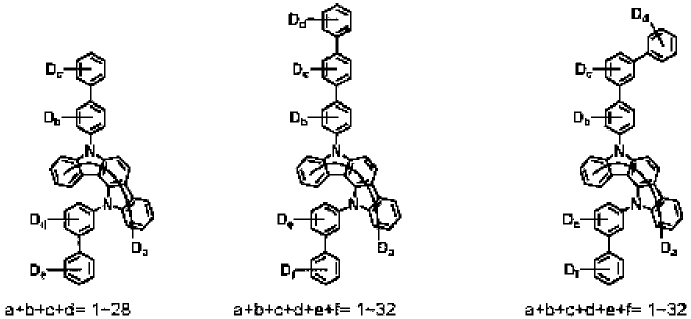 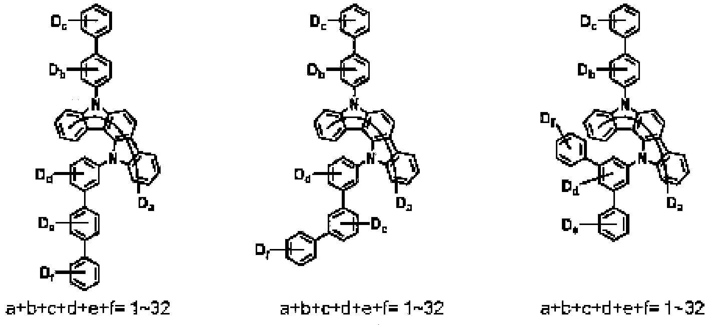 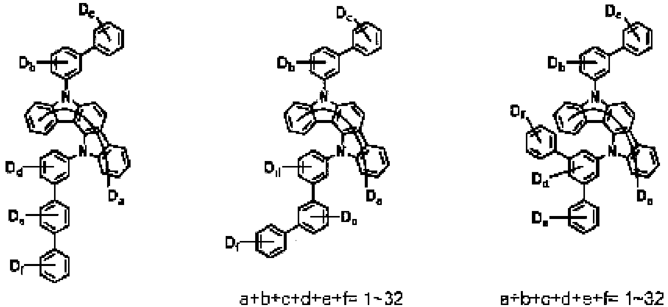 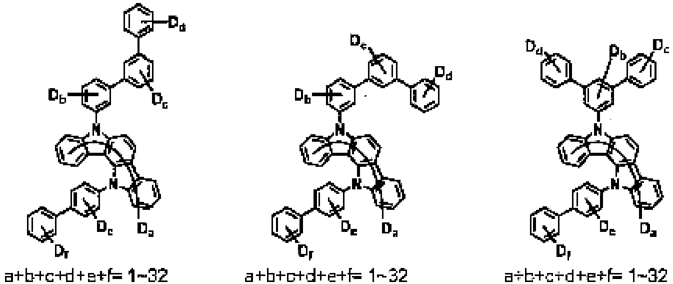 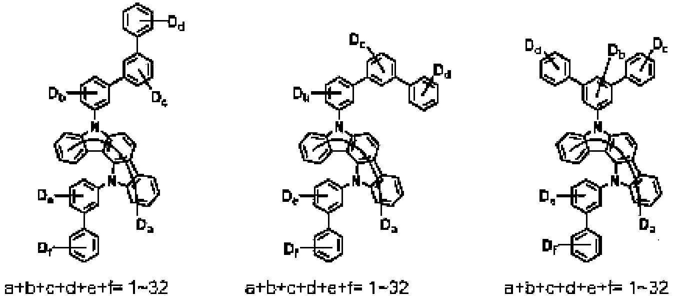 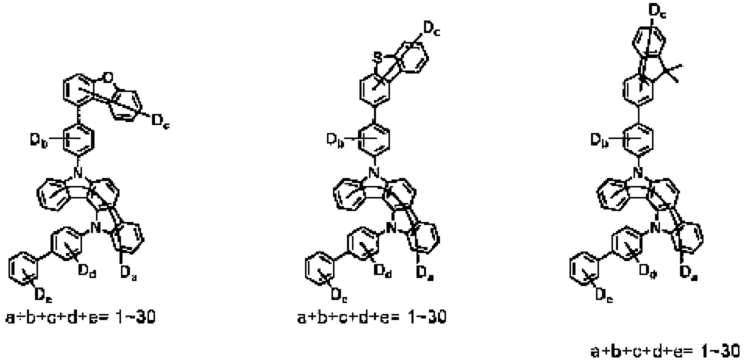 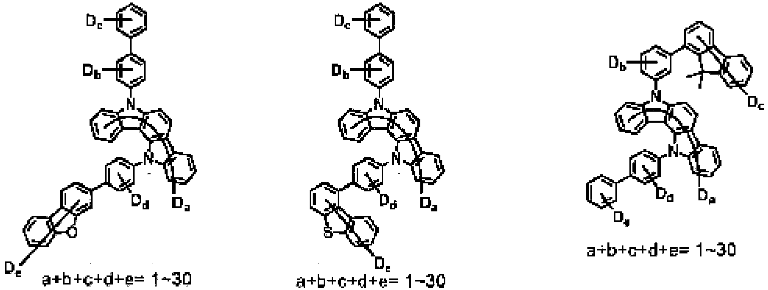 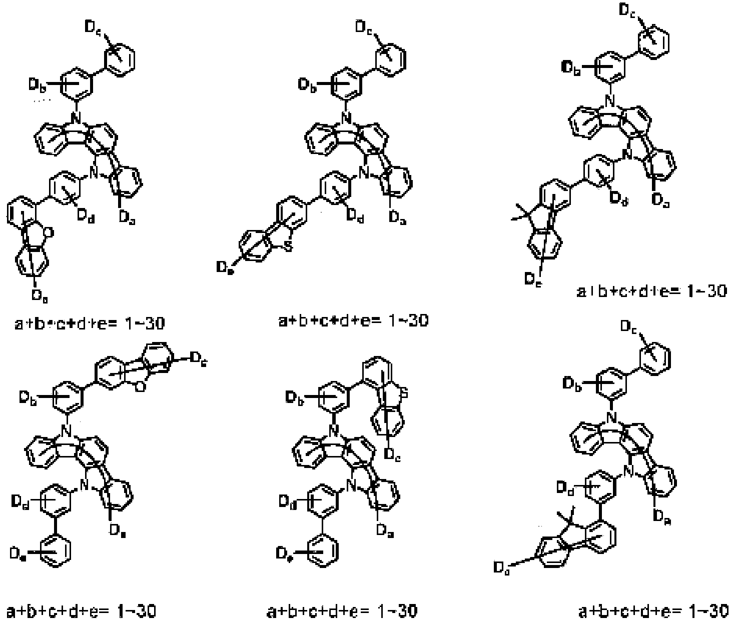 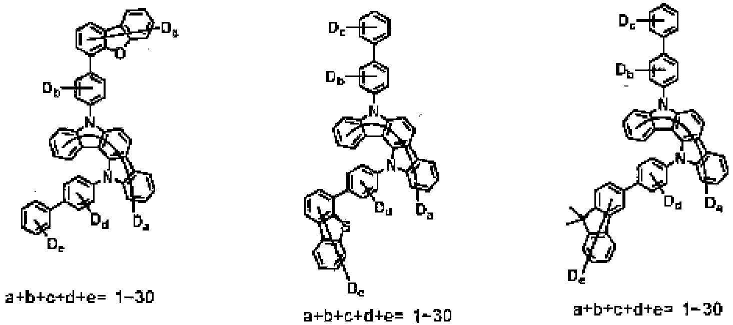 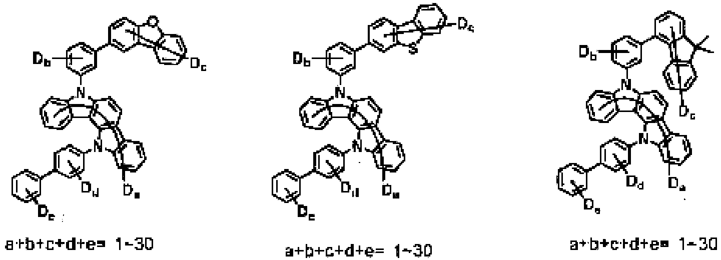 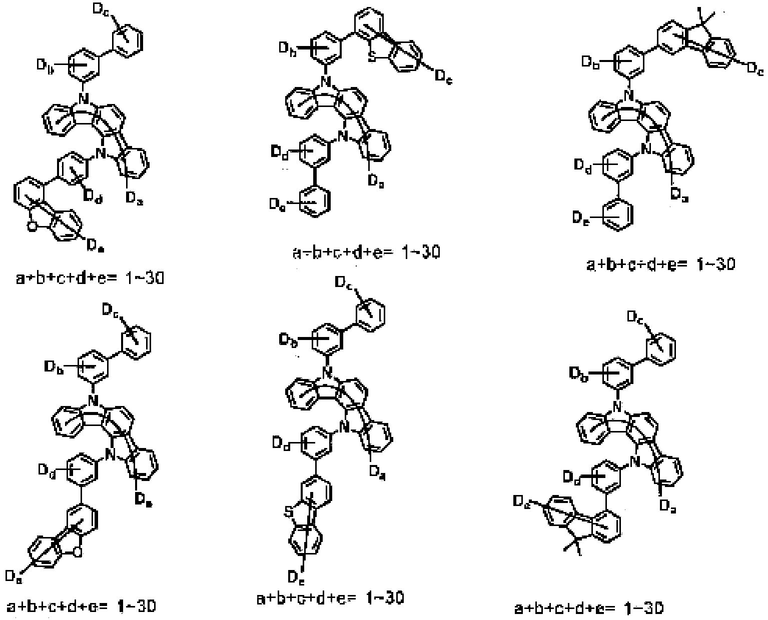 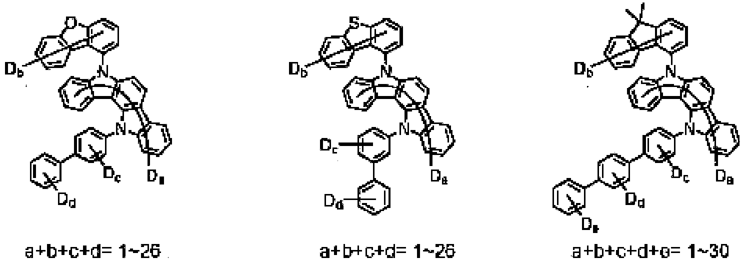 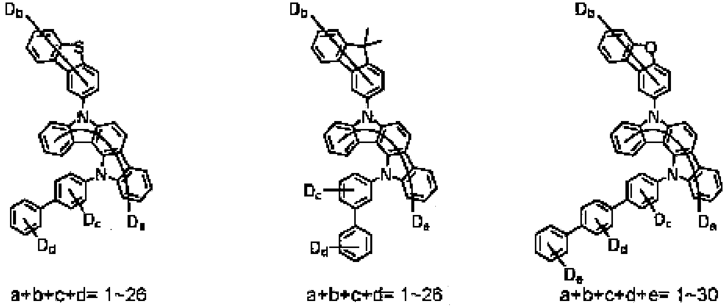 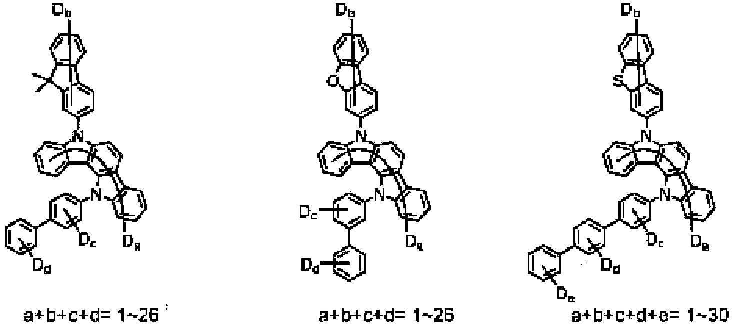 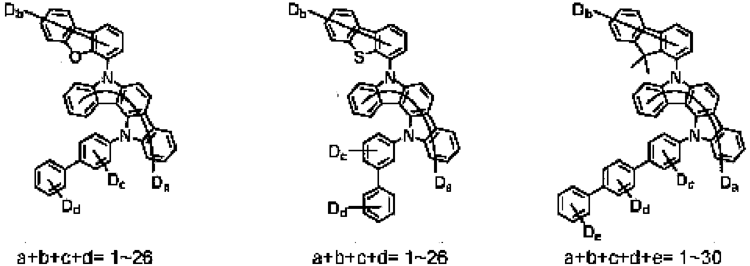 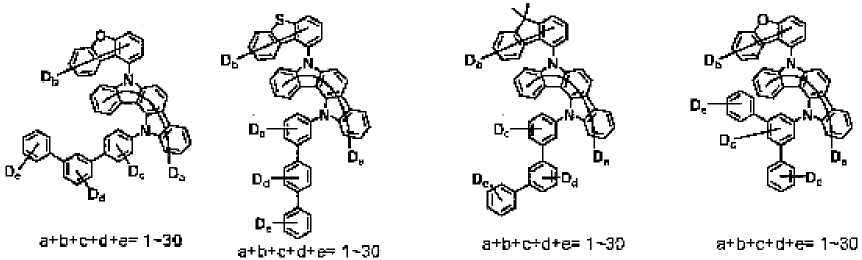 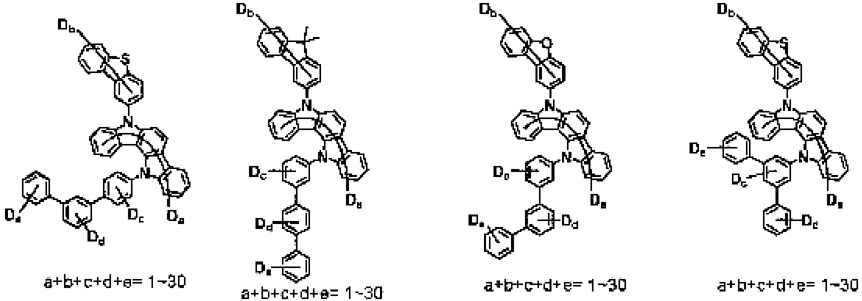 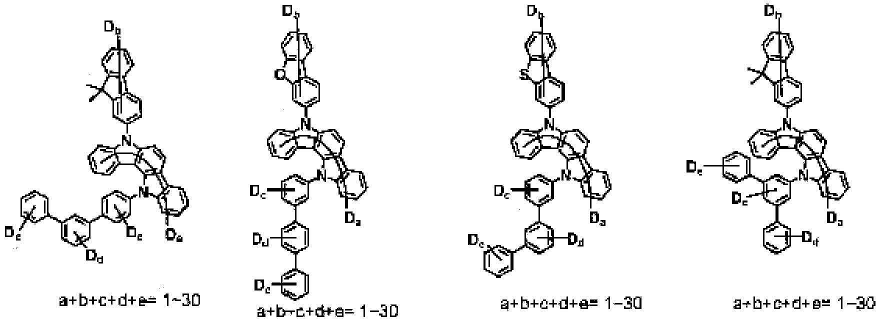 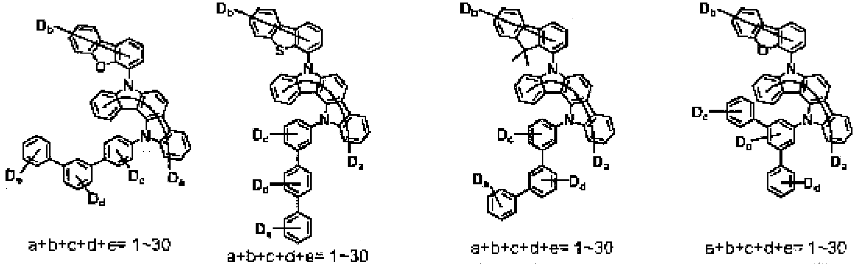 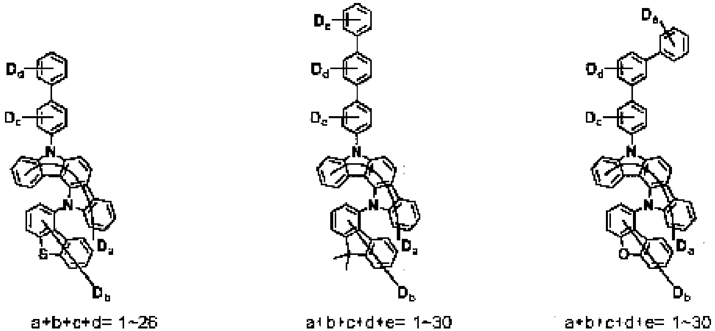 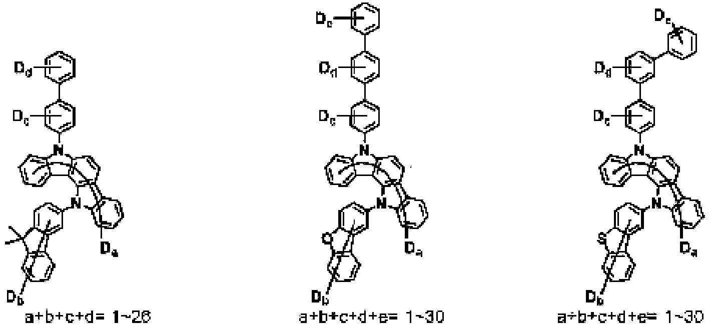 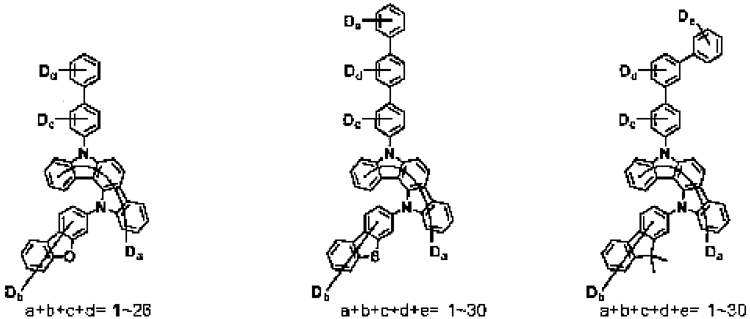 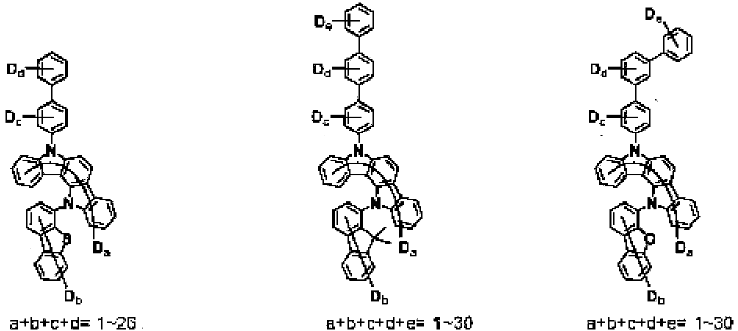 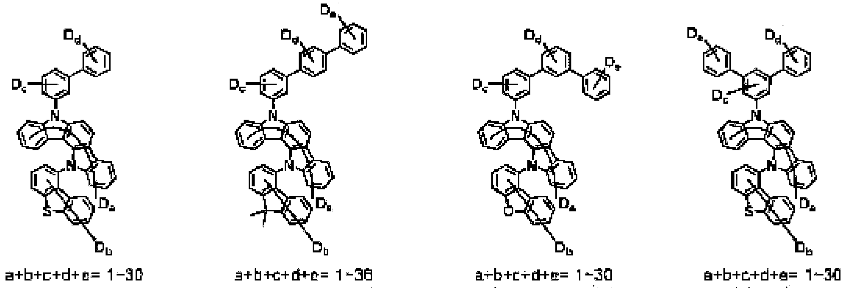 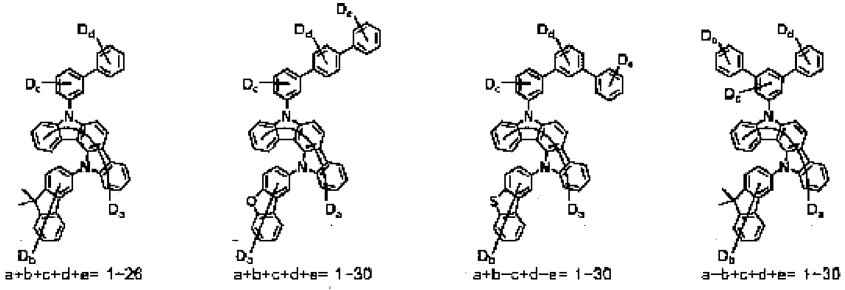 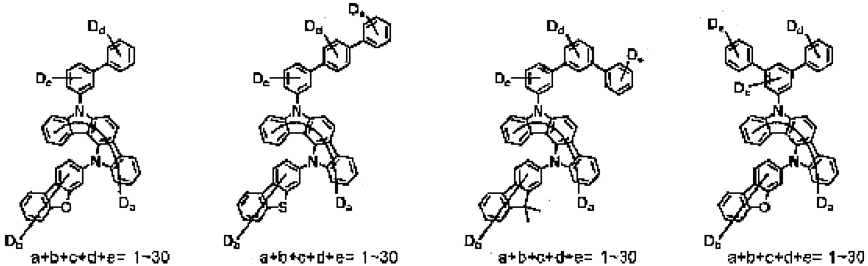 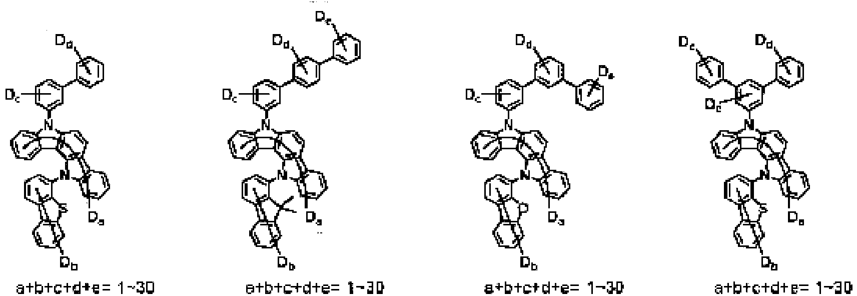 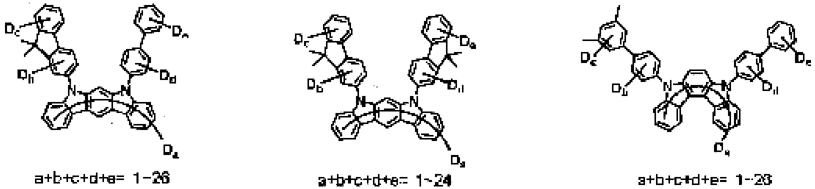 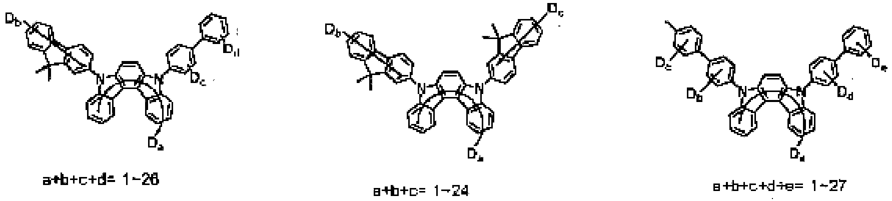
dans lequel les groupes méthyle inclus dans chaque Formule chimique sont chacun indépendamment CH₃, CH₂D, CHD₂ ou CD₃.

10. Dispositif électroluminescent organique selon la revendication 1, dans lequel :
la couche électroluminescente comprend un alliage organique du composé représenté par la Formule chimique 1 et du composé représenté par la Formule chimique 2.
